# EUROPEAN PATENT APPLICATION

(11) **EP 4 553 130 A1**
(43) Date of publication of application: **14.05.2025**
(21) Application number: 24206306.3
(22) Date of filing: 14.10.2024
(51) Int. Cl.: C09K 11/06, H10K 50/11

(54) **COMPOSITION FOR ORGANIC MATERIAL LAYER OF ORGANIC LIGHT EMITTING DEVICE AND ORGANIC LIGHT EMITTING DEVICE COMPRISING SAME**

(30) Priority: 07.11.2023 KR 20230152743
(71) Applicant: LT Materials Co., Ltd., Yongin-City 17118 (KR)
(72) Inventor: LEE, Seung-Woo, 17118 Yongin-City, Gyeonggi-Do (KR); LEE, Yong-Hui, 17118 Yongin-City, Gyeonggi-Do (KR); MO, Jun-Tae, 17118 Yongin-City, Gyeonggi-Do (KR); KIM, Dong-Jun, 17118 Yongin-City, Gyeonggi-Do (KR); CHOI, Dae-Hyuk, 17118 Yongin-City, Gyeonggi-Do (KR)
(74) Representative: Goddar, Heinz J.

(57) **Abstract**

The present specification relates to a composition for an organic material layer of an organic light emitting device and an organic light emitting device including the same.

## Description

### [Technical Field]

This application claims priority to and the benefit of Korean Patent Application No. 10-2023-0152743 filed in the Korean Intellectual Property Office on November 7, 2023, the entire contents of which are incorporated herein by reference.

The present specification relates to a composition for an organic material layer of an organic light emitting device and an organic light emitting device including the same.

### [Background Art]

A light emitting device is a kind of self-emitting type display device, and has an advantage in that the viewing angle is wide, the contrast is excellent, and the response speed is fast.

An organic light emitting device has a structure in which an organic thin film is disposed between two electrodes. When a voltage is applied to an organic light emitting device having the structure, electrons and holes injected from the two electrodes combine with each other in an organic thin film to make a pair, and then, emit light while being extinguished. The organic thin film may be composed of a single layer or multiple layers, if necessary.

A material for the organic thin film may have a light emitting function, if necessary. For example, as the material for the organic thin film, it is also possible to use a compound, which may itself constitute a light emitting layer alone, or it is also possible to use a compound, which may serve as a host or a dopant of a host-dopant-based light emitting layer. In addition, as a material for the organic thin film, it is also possible to use a compound, which may play a role such as a hole injection, hole transport, electron blocking, hole blocking, electron transport or electron injection.

In order to improve the performance, life time, or efficiency of the organic light emitting device, there is a continuous need for developing a material for an organic thin film.

### [Related Art Document]

### [Patent Document]

(Patent Document 1) US Patent No. 4,356,429

### [Disclosure]

### [Technical Problem]

The present specification has been made in an effort to provide a composition for an organic material layer of an organic light emitting device and an organic light emitting device including the same.

### [Technical Solution]

An exemplary embodiment of the present specification provides a composition for an organic material layer of an organic light emitting device, the composition including: a heterocyclic compound represented by the following Chemical Formula a; and a heterocyclic compound represented by the following Chemical Formula B. 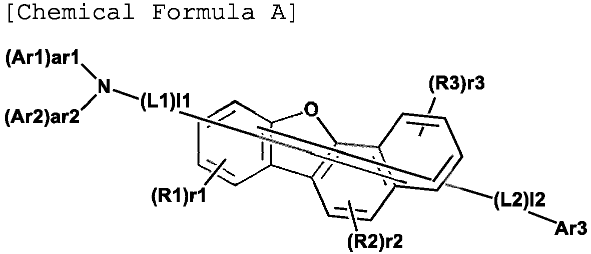 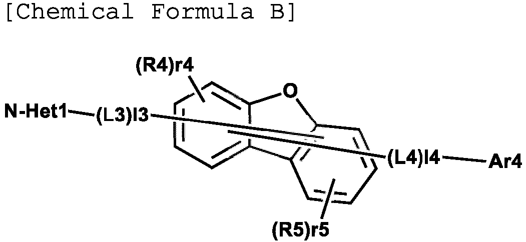 In Chemical Formulae A and B,
L1 to L4 are the same as or different from each other, and are each independently a direct bond; a substituted or unsubstituted C6 to C60 arylene group; or a substituted or unsubstituted C2 to C60 heteroarylene group,
Ar1, Ar2, and Ar4 are the same as or different from each other, and are each independently a substituted or unsubstituted C6 to C60 aryl group; or a substituted or unsubstituted C2 to C60 heteroaryl group,
R1 to R4 are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R5 is hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group, or two or more adjacent R5's are bonded to each other to form a ring,
11 to 14 are the same as or different from each other, and are each independently an integer from 1 to 3, and when each of 11 to 14 is an integer of 2 or higher, substituents in the parenthesis are the same as or different from each other,
r1 and r4 are the same as or different from each other, and are each independently an integer from 0 to 3,
r2 is an integer from 0 to 2,
r3 and r5 are the same as or different from each other, and are each independently an integer from 0 to 4,
when each of r1 to r5 is an integer of 2 or higher, substituents in the parenthesis are the same as or different from each other,
ar1 and ar2 are the same as or different from each other, and are each independently an integer from 1 to 4, and when each of ar1 and ar2 is an integer of 2 or higher, substituents in the parenthesis are the same as or different from each other,
Ar3 is represented by the following Chemical Formula K, 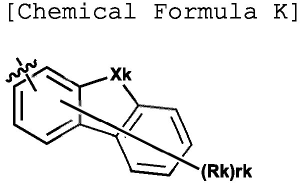 in Chemical Formula K, 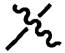 means a moiety linked to L2,
   Xk is O; S; CRk1Rk2; or NRk3,
   Rk and Rk1 to Rk3 are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group,
   rk is an integer from 0 to 7,
   N-Het1 is represented by the following Structural Formula N, 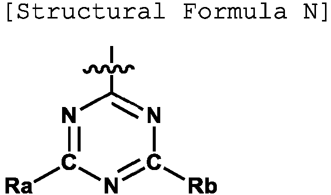
   in Structural Formula N, 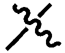 means a moiety linked to L3, and
   Ra and Rb are the same as or different from each other, and are each independently a substituted or unsubstituted C6 to C60 aryl group; a substituted or unsubstituted C2 to C60 heteroaryl group; or a combination thereof.

Another exemplary embodiment of the present specification provides an organic light emitting device including: a first electrode; a second electrode provided to face the first electrode; and an organic material layer having one or more layers provided between the first electrode and the second electrode, in which one or more layers of the organic material layer include the above-described composition for an organic material layer of an organic light emitting device.

### [Advantageous Effects]

The composition for an organic material layer according to an exemplary embodiment of the present application can be used as a material for an organic material layer of an organic light emitting device. In particular, the composition for an organic material layer is characterized by including a combination of a heterocyclic compound represented by Chemical Formula A and a heterocyclic compound represented by Chemical Formula B. More specifically, the composition for an organic material layer is characterized by including a heterocyclic compound represented by Chemical Formula A as a P-type host material and a heterocyclic compound represented by Chemical Formula B as an N-type host material.

It can be confirmed that when a heterocyclic compound represented by Chemical Formula A, which can be used as a unipolar P-type host material with excellent hole mobility, and a compound represented by Chemical Formula B, which can be used as a unipolar N-type host material with excellent electron mobility, are mixed at a suitable ratio and the resulting mixture is used as a material for a device, the efficiency and life time of the device are improved. Such a combination has an effect of improving device characteristics compared to other combinations of compositions such as existing single materials and premixed compositions of two or more materials.

Accordingly, when the composition for an organic material layer is used for an organic light emitting device, the driving voltage of the device can be lowered, the light efficiency of the device can be improved, the thermal stability of the compound can be improved, and the life time characteristics of the device can be improved.

### [Brief Description of Drawings]

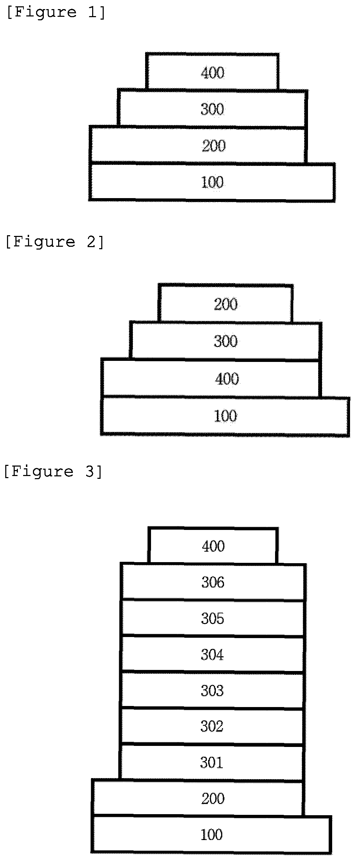

FIGS. 1 to 3 are views each exemplarily illustrating a stacking structure of an organic light emitting device according to an exemplary embodiment of the present specification.

### [Mode for Invention]

Hereinafter, the present specification will be described in more detail.

When one part "includes" one constituent element in the present specification, unless otherwise specifically described, this does not mean that another constituent element is excluded, but means that another constituent element may be further included.

In the present specification, 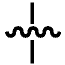 of a chemical formula means a position to be bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "substituted or unsubstituted" means being unsubstituted or substituted with one or more substituents selected from the group consisting of deuterium; a halogen group; a cyano group; a C1 to C60 alkyl group; a C2 to C60 alkenyl group; a C2 to C60 alkynyl group; a C3 to C60 cycloalkyl group; a C2 to C60 heterocycloalkyl group; a C6 to C60 aryl group; a C2 to C60 heteroaryl group; a silyl group; a phosphine oxide group; and an amine group, or with a substituent to which two or more substituents selected among the exemplified substituents are linked.

In the present specification, "when a substituent is not indicated in the structure of a chemical formula or compound" means that a hydrogen atom is bonded to a carbon atom. However, since deuterium (²H) or tritium corresponds to an isotope of hydrogen, it may be interpreted as a concept included in hydrogen, as long as it is not explicitly excluded.

That is, in the present application, deuterium exhibits an effect equivalent to that of hydrogen in terms of driving voltage, light emitting efficiency, and life time, or exhibits improved effects in some evaluation criteria, according to Chem. Commun., 2014, 50, 14870, and since the effect falls within the scope that a person with ordinary skill in the art may predict may have the equivalent effect without conducting specific experiments, deuterium, an isotope of hydrogen, is interpreted as a concept included in hydrogen, as long as it is not explicitly excluded.

According to an exemplary embodiment of the present specification, "when a substituent is not indicated in the structure of a chemical formula or compound" may mean that all the positions that may be reached by the substituent are hydrogen; or deuterium. That is, deuterium is an isotope of hydrogen, and some hydrogen atoms may be deuterium which is an isotope, and in this case, the content of deuterium may be 0% to 100%.

According to an exemplary embodiment of the present specification, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

According to an exemplary embodiment of the present specification, deuterium is one of the isotopes of hydrogen, is an element that has a deuteron composed of one proton and one neutron as a nucleus, and may be represented by hydrogen-2, and the element symbol may also be expressed as D or ²H.

According to an exemplary embodiment of the present specification, the isotope means an atom with the same atomic number (Z), but different mass numbers (A), and may also be interpreted as an element which has the same number of protons, but different number of neutrons.

According to an exemplary embodiment of the present specification, when the total number of substituents of a basic compound is defined as T1 and the number of specific substituents among the substituents is defined as T2, the content T% of the specific substituent may be defined as T2/T1×100 = T%.

That is, when taking a phenyl group represented by 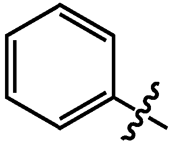 as an example, herein, a deuterium content of 20% may be represented by 20% when the total number of substituents that the phenyl group can have is 5 (T1 in the formula) and the number of deuteriums among the substituents is 1 (T2 in the formula). That is, a deuterium content of 20% in the phenyl group may be represented by the following structural formula.

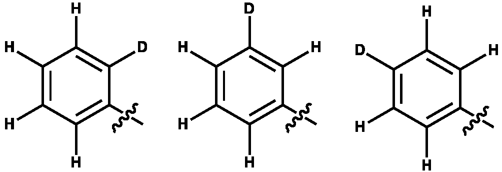

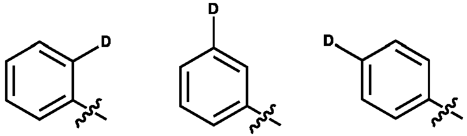

Further, according to an exemplary embodiment of the present specification, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, the alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethyl-butyl group, a pentyl group, an n-pentyl group, an isopentyl group, a neopentyl group, a tertpentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, the alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group; a 2-butenyl group; a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present specification, the alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, an alkoxy group may be straight-chained, branched, or cyclic. The number of carbon atoms of the alkoxy group is not particularly limited, but is preferably 1 to 20. Specific examples thereof include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present specification, the cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, the heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, the aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.

In the present specification, the terphenyl group may be selected from the following structures.

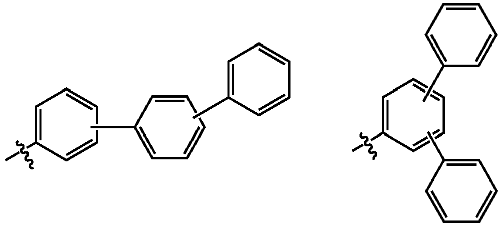

In the present specification, the fluorenyl group may be substituted, and adjacent substituents may be bonded to each other to form a ring.

When the fluorenyl group is substituted, the substituent may be selected from the following structures, but is not limited thereto.

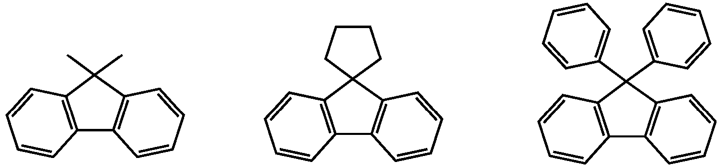

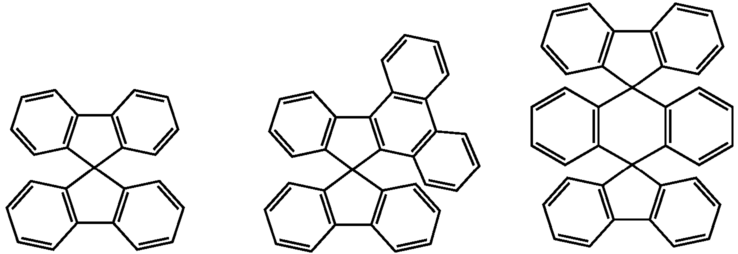

In the present specification, the heteroaryl group includes S, O, Se, N, or Si as a heteroatom, includes a monocycle or a polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridyl group, a pyrrolyl group, a pyrimidyl group, a pyridazinyl group, a furanyl group, a thiophene group, an imidazolyl group, a pyrazolyl group, an oxazolyl group, an isoxazolyl group, a thiazolyl group, an isothiazolyl group, a triazolyl group, a furazanyl group, an oxadiazolyl group, a thiadiazolyl group, a dithiazolyl group, a tetrazolyl group, a pyranyl group, a thiopyranyl group, a diazinyl group, an oxazinyl group, a thiazinyl group, a dioxynyl group, a triazinyl group, a tetrazinyl group, a quinolyl group, an isoquinolyl group, a quinazolinyl group, an isoquinazolinyl group, a quinozolilyl group, a naphthyridyl group, an acridinyl group, a phenanthridinyl group, an imidazopyridinyl group, a diaza naphthalenyl group, a triazaindene group, an indolyl group, an indolizinyl group, a benzothiazolyl group, a benzoxazolyl group, a benzimidazolyl group, a benzothiophene group, a benzofuran group, a dibenzothiophene group, a dibenzofuran group, a carbazolyl group, a benzocarbazolyl group, a dibenzocarbazolyl group, a phenazinyl group, a dibenzosilole group, spirobi (dibenzosilole), a dihydrophenazinyl group, a phenoxazinyl group, a phenanthridyl group, an imidazopyridinyl group, a thienyl group, an indolo[2,3-a]carbazolyl group, an indolo[2,3-b]carbazolyl group, an indolinyl group, a 10,11-dihydro-dibenzo[b,f]azepin group, a 9,10-dihydroacridinyl group, a phenanthrazinyl group, a phenothiathiazinyl group, a phthalazinyl group, a naphthylidinyl group, a phenanthrolinyl group, a benzo[c][1,2,5]thiadiazolyl group, a 2,3-dihydrobenzo[b]thiophene group, a 2,3-dihydrobenzofuran group, a 5,10-dihydrodibenzo[b,e][1,4]azasilinyl group, a pyrazolo[1,5-c]quinazolinyl group, a pyrido[1,2-b]indazolyl group, a pyrido[1,2-a]imidazo[1,2-e]indolinyl group, a 5,11-dihydroindeno[1,2-b]carbazolyl group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole.

In the present specification, a benzocarbazole group may be any one of the following structures.

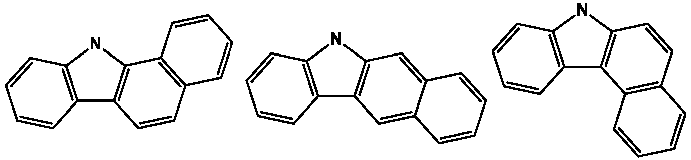

In the present specification, a dibenzocarbazole group may be any one of the following structures.

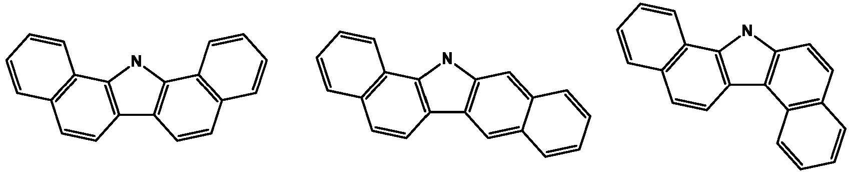

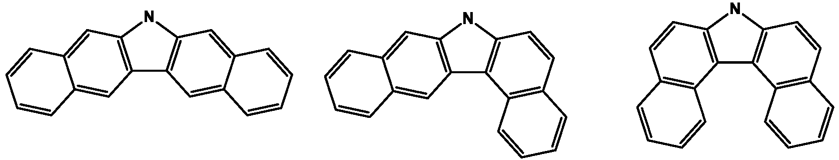

In the present specification, a naphthobenzofuran group may be any one of the following structures.

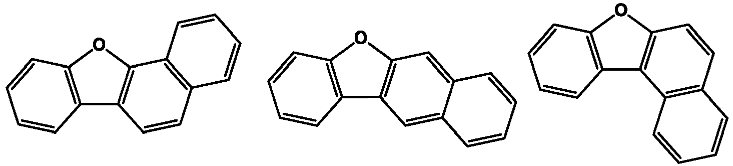

In the present specification, a naphthobenzothiophene group may be any one of the following structures.

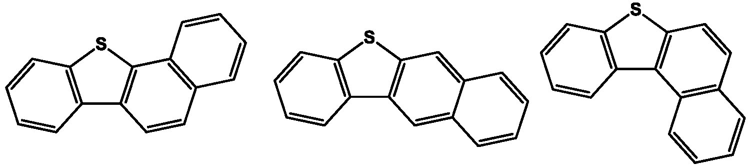

In the present specification, a silyl group includes Si and is a substituent to which the Si atom is directly linked as a radical, and is represented by - Si(R101) (R102) (R103), and R101 to R103 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

Specific examples of the silyl group include 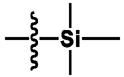 (a trimethylsilyl group), 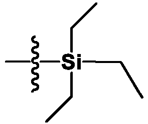 (a triethylsilyl group), 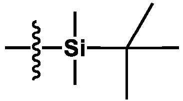 (a t-butyldimethylsilyl group), 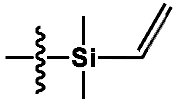 (a vinyldimethylsilyl group), 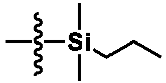 (a propyldimethylsilyl group), 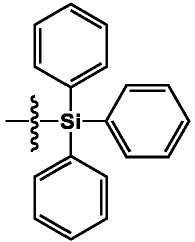 (a triphenylsilyl group), 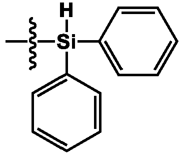 (a diphenylsilyl group), 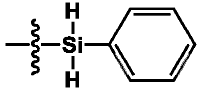 (a phenylsilyl group) and the like, but are not limited thereto.

In the present specification, the phosphine oxide group is represented by -P(=O) (R104) (R105), and R104 and R105 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, a dinaphthylphosphine oxide group, and the like, but are not limited thereto.

In the present specification, the amine group is represented by -N(R106) (R107), and R106 and R107 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituted at the ortho position in a benzene ring and two substituents substituted at the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be each applied to the rings, except for those that are not monovalent groups.

### <Composition for organic material layer of organic light emitting device>

Hereinafter, the composition for an organic material layer of an organic light emitting device according to the present specification will be described.

The composition for an organic material layer of an organic light emitting device according to an exemplary embodiment of the present specification includes a heterocyclic compound represented by the following Chemical Formula A.

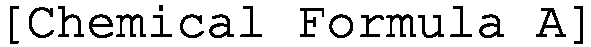

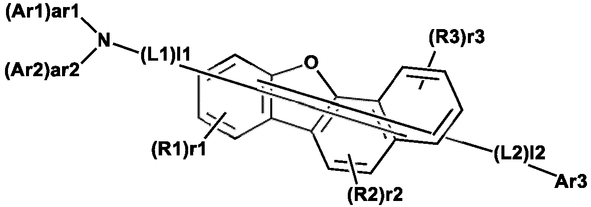

In Chemical Formula A, the description of each substituent is as described above.

The heterocyclic compound represented by Chemical Formula A is a di-substituted naphthobenzofuran, in which a first substituent 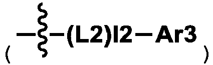 enhances the electron and hole transport properties and a second substituent 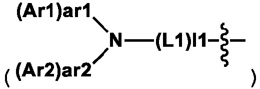 enhances the hole transport properties, so that it is possible to exhibit excellent electron and hole transport properties as a whole.

When a heterocyclic compound represented by Chemical Formula A, which has excellent hole transport properties, is used together with a heterocyclic compound represented by Chemical Formula B, which has fast electron transport properties, the heterocyclic compound may act as a P-type host material to cause charge balance in an organic layer (particularly, a light emitting layer (EML)) and prevent degradation caused by the accumulation of electrons and holes, thereby exhibiting high efficiency and long life time.

The composition for an organic material layer of an organic light emitting device according to an exemplary embodiment of the present specification includes a heterocyclic compound represented by the following Chemical Formula B.

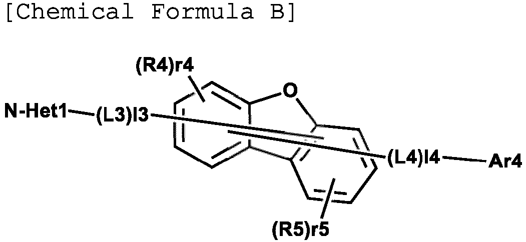

In Chemical Formula B, the description of each substituent is as described above.

The compound represented by Chemical Formula B is di-substituted as a tricyclic or more oxygen-containing fused heterocycle, and N-Het1 (represented by Structural Formula N and corresponding to triazine), a first substituent, enhances the electron transport properties, and Ar4, a second substituent, enhances the hole transport properties, and as a whole, the compound has excellent electron and hole transport properties, and thus, may exhibit high efficiency.

When a heterocyclic compound represented by Chemical Formula B, which has fast electron transport properties, is used together with a heterocyclic compound represented by Chemical Formula A, which has excellent hole transport properties, the heterocyclic compound may act as an N-type host material to cause charge balance in an organic layer (particularly, a light emitting layer (EML)) and prevent degradation caused by the accumulation of electrons and holes, thereby exhibiting high efficiency and long life time.

The compound according to exemplary embodiments may have low driving voltage, high light emitting efficiency, and/or long life time characteristics when used in an organic light emitting device.

According to an exemplary embodiment of the present specification, Chemical Formula A may be represented by any one of the following Chemical Formulae A-1 to A-3.

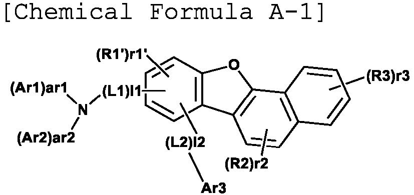

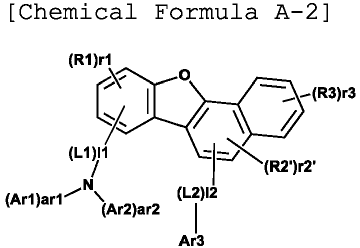

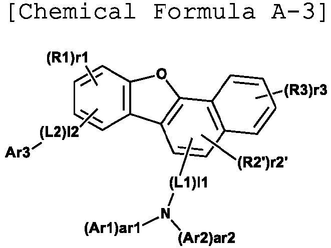

In Chemical Formulae A-1 to A-3,
each of Ar1 to Ar3, L1, L2, R1 to R3, ar1, ar2, 11, 12, and r1 to r3 is as defined in Chemical Formula A,
R1' is as defined for R1 in Chemical Formula A,
R2' is as defined for R2 in Chemical Formula A,
r1' is an integer from 0 to 2, and when r1' is 2, R1"s are the same as or different from each other, and
r2' is 0 or 1.

According to an exemplary embodiment of the present specification, Chemical Formula A may be represented by any one of the following Chemical Formulae A-101 to A-104.

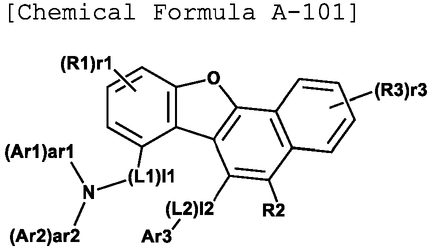

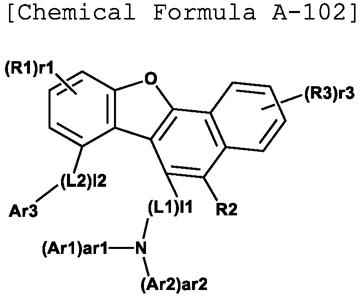

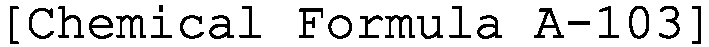

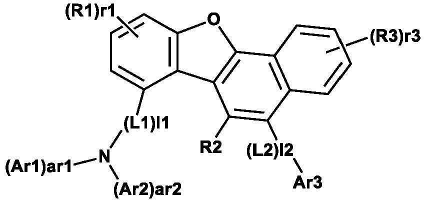

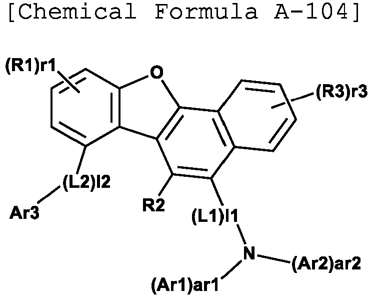

In Chemical Formulae A-101 to A-104,
each of L1, L2, Ar1 to Ar3, R1 to R3, 11, 12, ar1, ar2, r1, and r3 is as defined in Chemical Formula A.

According to an exemplary embodiment of the present specification, Chemical Formula B may be represented by any one of the following Chemical Formulae B-1 to B-11. 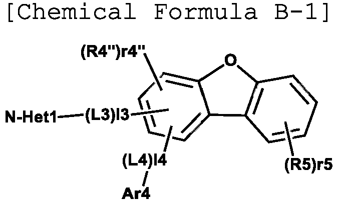 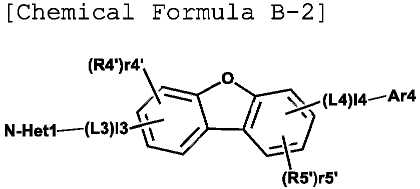 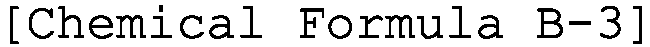 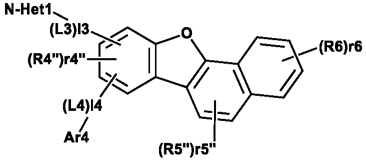 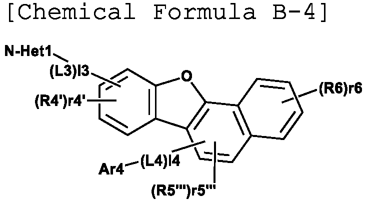 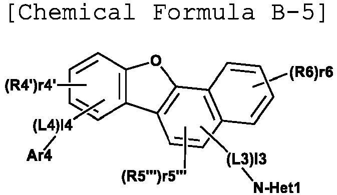 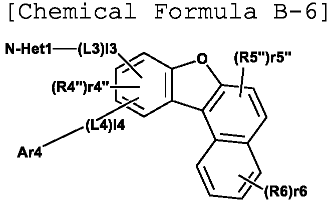 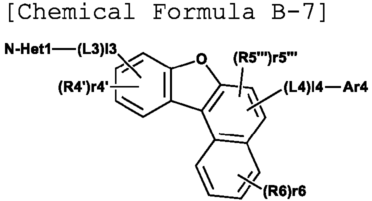 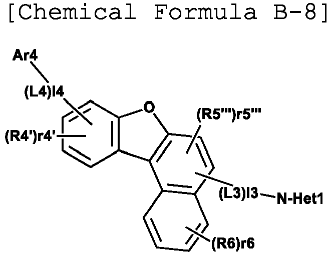 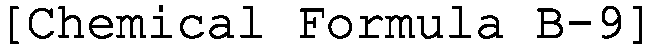 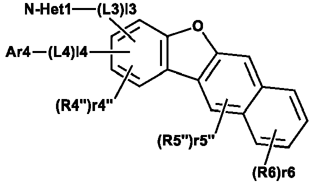 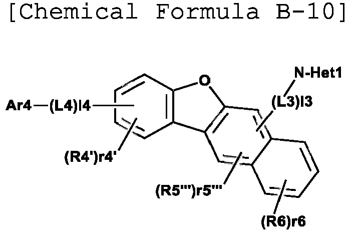 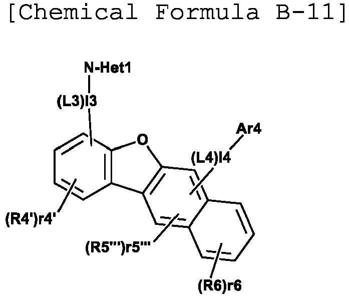 In Chemical Formulae B-1 to B-11,
each of N-Het1, Ar4, L3, L4, R5, 13, 14, and r5 is as defined in Chemical Formula B,
each of R4' and R4" is as defined for R4 in Chemical Formula B,
each of R5', R5", and R5"' is as defined for R5 in Chemical Formula B,
R6's are the same as or different from each other, and are each independently hydrogen; deuterium; a halogen group; a cyano group; a substituted or unsubstituted C1 to C60 alkyl group; a substituted or unsubstituted C3 to C60 cycloalkyl group; or a substituted or unsubstituted C2 to C60 heterocycloalkyl group,
r4' and r5' are the same as or different from each other, and are each independently an integer from 0 to 3,
r4" and r5" are the same as or different from each other, and are each independently an integer from 0 to 2, r5"' is 0 or 1,
r6 is an integer from 0 to 4, and
when each of r4', r4", r5', r5", and r6 is 2 or an integer of 2 or higher, substituents in the parenthesis are the same as or different from each other.

According to an exemplary embodiment of the present specification, Chemical Formula B may be represented by any one of the following Chemical Formulae B-101 to B-132.

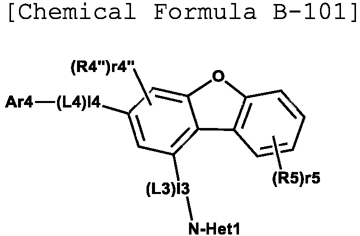

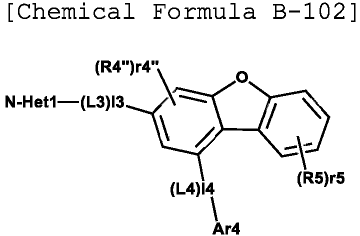

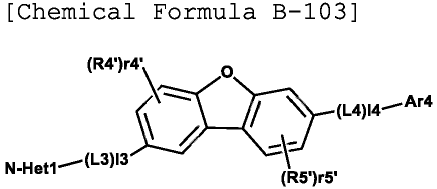

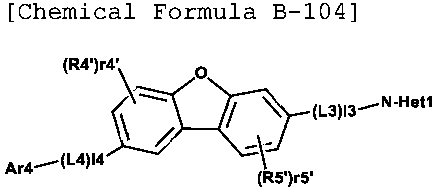

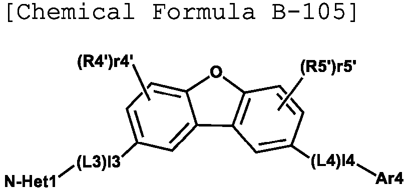

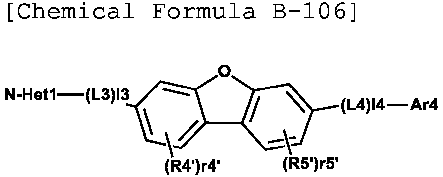

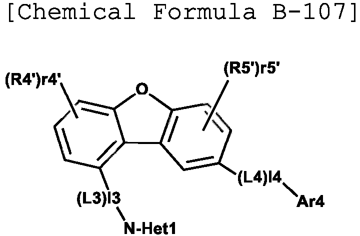

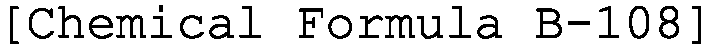

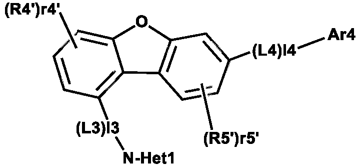

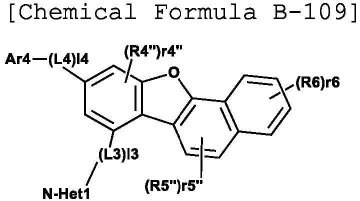

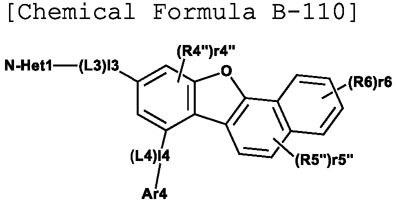

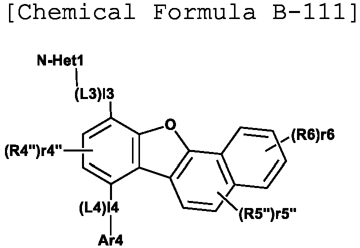

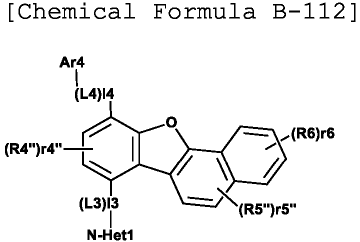

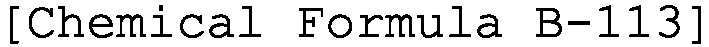

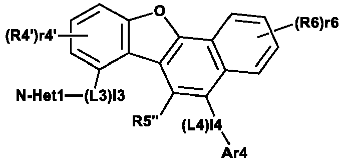

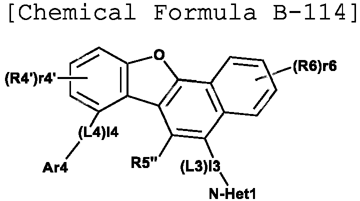

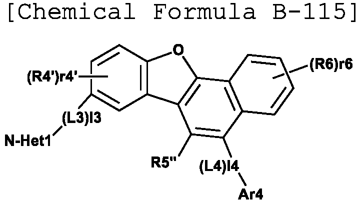

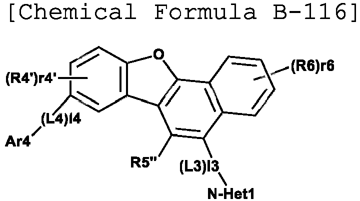

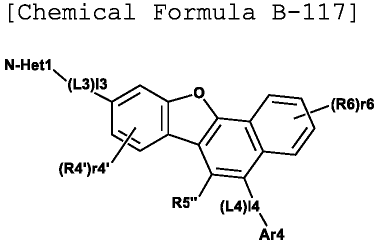

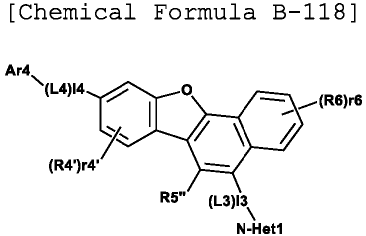

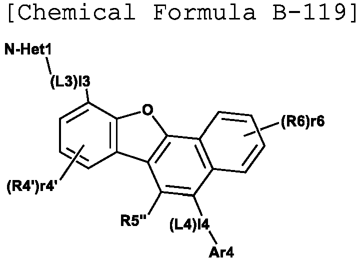

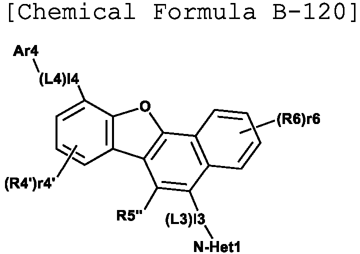

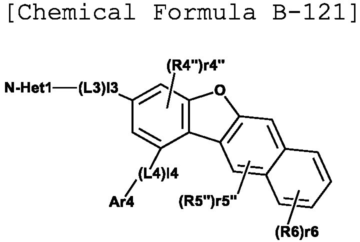

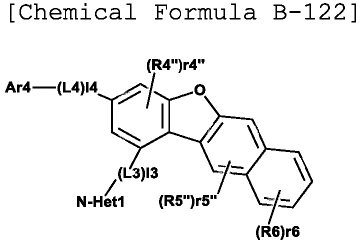

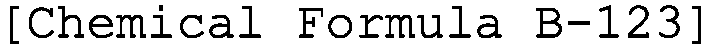

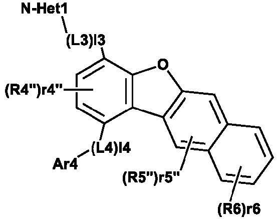

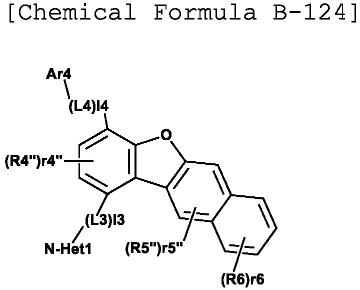

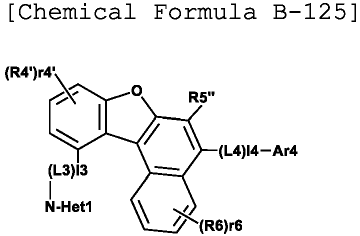

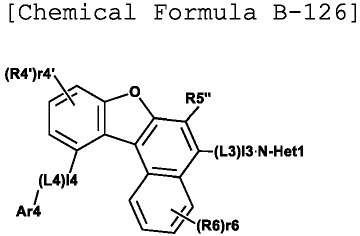

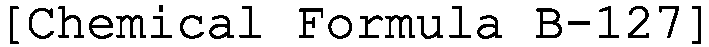

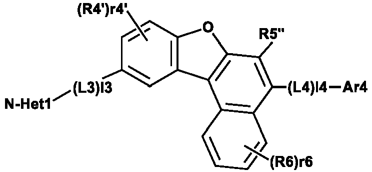

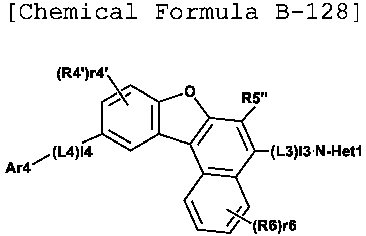

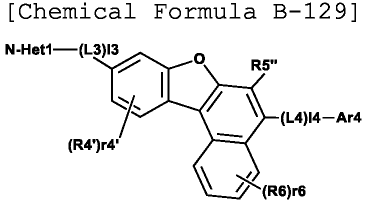

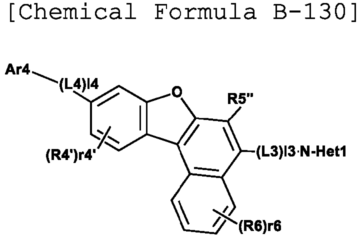

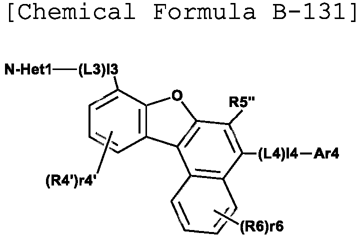

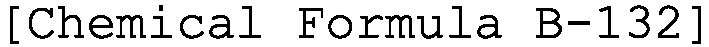

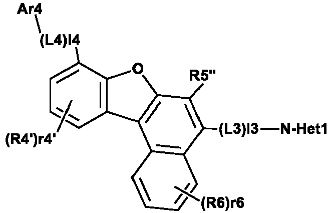

In Chemical Formulae B-101 to B-132,
each of N-Het1, Ar4, L3, L4, R5, 13, 14, and r5 is as defined in Chemical Formula B,
each of R4' and R4" is as defined for R4 in Chemical Formula B,
each of R5', R5", and R5"' is as defined for R5 in Chemical Formula B,
R6's are the same as or different from each other, and are each independently hydrogen; deuterium; a halogen group; a cyano group; a substituted or unsubstituted C1 to C60 alkyl group; a substituted or unsubstituted C3 to C60 cycloalkyl group; or a substituted or unsubstituted C2 to C60 heterocycloalkyl group,
r4' and r5' are the same as or different from each other, and are each independently an integer from 0 to 3,
r4" and r5" are the same as or different from each other, and are each independently an integer from 0 to 2,
r5"' is 0 or 1,
r6 is an integer from 0 to 4, and
when each of r4', r4", r5', r5", and r6 is 2 or an integer of 2 or higher, substituents in the parenthesis are the same as or different from each other.

According to an exemplary embodiment of the present specification, L1 to L4 are the same as or different from each other, and may be each independently a direct bond; a substituted or unsubstituted C6 to C40 arylene group; or a substituted or unsubstituted C2 to C40 heteroarylene group.

According to an exemplary embodiment of the present specification, L1 to L4 are the same as or different from each other, and may be each independently a direct bond; or a substituted or unsubstituted C6 to C30 arylene group.

According to an exemplary embodiment of the present specification, L1 to L4 are the same as or different from each other, and may be each independently a direct bond; or a C6 to C30 arylene group unsubstituted or substituted with deuterium.

According to an exemplary embodiment of the present specification, L1 to L4 are the same as or different from each other, and may be each independently a direct bond; a phenylene group unsubstituted or substituted with deuterium; a biphenylene group unsubstituted or substituted with deuterium; or a naphthylene group unsubstituted or substituted with deuterium.

According to an exemplary embodiment of the present specification, Ar1, Ar2, and Ar4 are the same as or different from each other, and may be each independently a substituted or unsubstituted C6 to C40 aryl group; or a substituted or unsubstituted C2 to C40 heteroaryl group.

According to an exemplary embodiment of the present specification, Ar1, Ar2, and Ar4 are the same as or different from each other, and may be each independently a substituted or unsubstituted C6 to C30 aryl group; or a substituted or unsubstituted C2 to C30 heteroaryl group.

According to an exemplary embodiment of the present specification, Ar1, Ar2, and Ar4 are the same as or different from each other, and may be each independently a C6 to C30 aryl group unsubstituted or substituted with a substituent selected from the group consisting of deuterium, an alkyl group, and an aryl group; or a C2 to C30 heteroaryl group unsubstituted or substituted with a substituent selected from the group consisting of deuterium, an alkyl group, and an aryl group.

According to an exemplary embodiment of the present specification, Ar1, Ar2, and Ar4 are the same as or different from each other, and may be each independently a phenyl group; a biphenyl group; a terphenyl group; a naphthyl group; a fluorenyl group; a phenanthrenyl group; a dibenzofuranyl group; a dibenzothiophenyl group; or a carbazolyl group, which may be each independently unsubstituted or substituted with a substituent selected from the group consisting of deuterium, an alkyl group, and an aryl group.

According to an exemplary embodiment of the present specification, R1 to R4 are the same as or different from each other, and may be each independently hydrogen; deuterium; a halogen group; a cyano group; a substituted or unsubstituted C1 to C40 alkyl group; a substituted or unsubstituted C3 to C40 cycloalkyl group; a substituted or unsubstituted C2 to C40 heterocycloalkyl group; a substituted or unsubstituted C6 to C40 aryl group; or a substituted or unsubstituted C2 to C40 heteroaryl group.

According to an exemplary embodiment of the present specification, R1 to R4 are the same as or different from each other, and may be each independently hydrogen; deuterium; a halogen group; a cyano group; a substituted or unsubstituted C1 to C20 alkyl group; a substituted or unsubstituted C3 to C20 cycloalkyl group; a substituted or unsubstituted C2 to C20 heterocycloalkyl group; a substituted or unsubstituted C6 to C20 aryl group; or a substituted or unsubstituted C2 to C20 heteroaryl group.

According to an exemplary embodiment of the present specification, R1 to R4 are the same as or different from each other, and may be each independently hydrogen; or deuterium.

According to an exemplary embodiment of the present specification, R5 is hydrogen; deuterium; a halogen group; a cyano group; a substituted or unsubstituted C1 to C40 alkyl group; a substituted or unsubstituted C3 to C40 cycloalkyl group; a substituted or unsubstituted C2 to C40 heterocycloalkyl group; a substituted or unsubstituted C6 to C40 aryl group; or a substituted or unsubstituted C2 to C40 heteroaryl group, or two or more adjacent R5's may be bonded to each other to form a substituted or unsubstituted C6 to C40 hydrocarbon ring or a substituted or unsubstituted C2 to C40 hetero ring.

According to an exemplary embodiment of the present specification, R5 is hydrogen; deuterium; a halogen group; a cyano group; a substituted or unsubstituted C1 to C20 alkyl group; a substituted or unsubstituted C3 to C20 cycloalkyl group; a substituted or unsubstituted C2 to C20 heterocycloalkyl group; a substituted or unsubstituted C6 to C20 aryl group; or a substituted or unsubstituted C2 to C20 heteroaryl group, or two or more adjacent R5's may be bonded to each other to form a substituted or unsubstituted C6 to C20 hydrocarbon ring or a substituted or unsubstituted C2 to C20 hetero ring.

According to an exemplary embodiment of the present specification, R5 is hydrogen; or deuterium, or two or more adjacent R5's may be bonded to each other to form a substituted or unsubstituted benzene ring.

According to an exemplary embodiment of the present specification, R5 is hydrogen; or deuterium, or two or more adjacent R5's may be bonded to each other to form a benzene ring unsubstituted or substituted with deuterium.

According to an exemplary embodiment of the present specification, R1 to R4 are the same as or different from each other, and are each independently hydrogen; or deuterium, R5 is hydrogen; or deuterium, or two or more adjacent R5's may be bonded to each other to form a benzene ring unsubstituted or substituted with deuterium.

According to an exemplary embodiment of the present specification, Rk and Rk1 to Rk3 are the same as or different from each other, and may be each independently hydrogen; deuterium; a substituted or unsubstituted C1 to C40 alkyl group; a substituted or unsubstituted C6 to C40 aryl group; or a substituted or unsubstituted C2 to C40 heteroaryl group.

According to an exemplary embodiment of the present specification, Rk and Rk1 to Rk3 are the same as or different from each other, and may be each independently hydrogen; deuterium; a substituted or unsubstituted C1 to C30 alkyl group; a substituted or unsubstituted C6 to C30 aryl group; or a substituted or unsubstituted C2 to C30 heteroaryl group.

According to an exemplary embodiment of the present specification, Rk and Rk1 to Rk3 are the same as or different from each other, and may be each independently hydrogen; deuterium; a substituted or unsubstituted C1 to C20 alkyl group; a substituted or unsubstituted C6 to C20 aryl group; or a substituted or unsubstituted C2 to C20 heteroaryl group.

According to an exemplary embodiment of the present specification, Rk and Rk1 to Rk3 are the same as or different from each other, and may be each independently hydrogen; deuterium; a C1 to C20 alkyl group unsubstituted or substituted with deuterium; a C6 to C20 aryl group unsubstituted or substituted with deuterium; or a C2 to C20 heteroaryl group unsubstituted or substituted with deuterium.

According to an exemplary embodiment of the present specification, Rk and Rk1 to Rk3 are the same as or different from each other, and may be each independently hydrogen; deuterium; a methyl group unsubstituted or substituted with deuterium; an ethyl group unsubstituted or substituted with deuterium; or a phenyl group unsubstituted or substituted with deuterium.

According to an exemplary embodiment of the present specification, Ra and Rb are the same as or different from each other, and may be each independently a substituted or unsubstituted C6 to C40 aryl group; a substituted or unsubstituted C2 to C40 heteroaryl group; or a combination thereof.

According to an exemplary embodiment of the present specification, Ra and Rb are the same as or different from each other, and may be each independently a substituted or unsubstituted C6 to C30 aryl group; a substituted or unsubstituted C2 to C30 heteroaryl group; or a combination thereof.

According to an exemplary embodiment of the present specification, Ra and Rb are the same as or different from each other, and may be each independently a C6 to C30 aryl group unsubstituted or substituted with deuterium, an alkyl group, or an alkenyl group; a C2 to C30 heteroaryl group unsubstituted or substituted with deuterium, an alkyl group, or an alkenyl group; or a combination thereof.

According to an exemplary embodiment of the present specification, Ra and Rb are the same as or different from each other, and may be each independently a phenyl group; a biphenyl group; a terphenyl group; a naphthyl group; a fluorenyl group; a phenanthrenyl group; a dibenzofuranyl group; a dibenzothiophenyl group; or a carbazolyl group, which may be each independently unsubstituted or substituted with a substituent selected from the group consisting of deuterium, an alkyl group, an alkenyl, and an aryl group.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 1% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 10% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 20% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 30% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 60% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 80% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 90% to 100%.

According to an exemplary embodiment of the present specification, Chemical Formula A may be represented by any one of the following heterocyclic compounds.

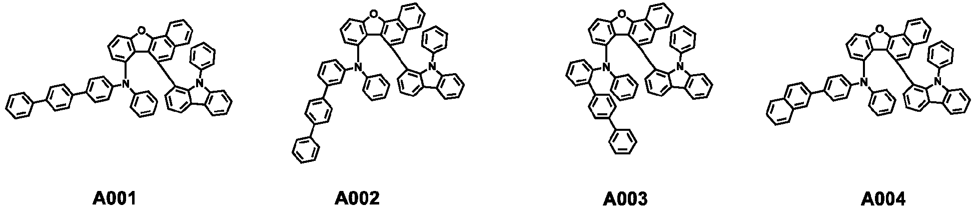

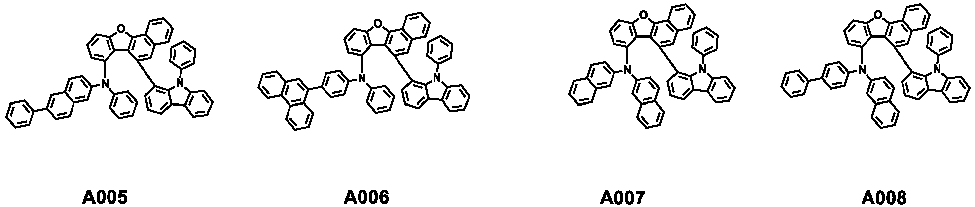

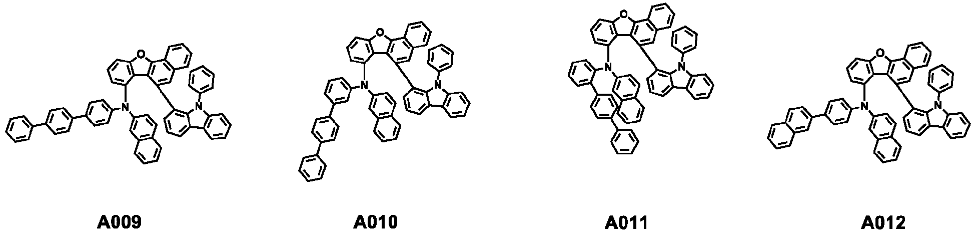

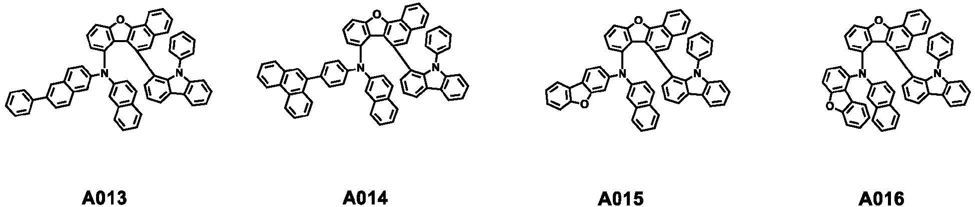

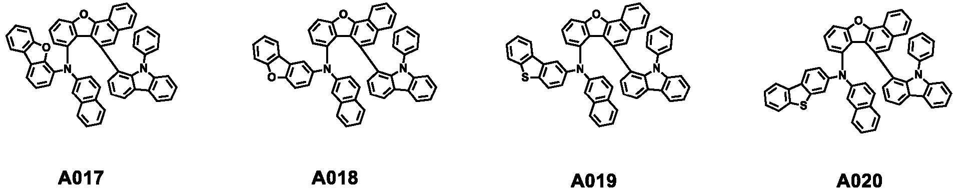

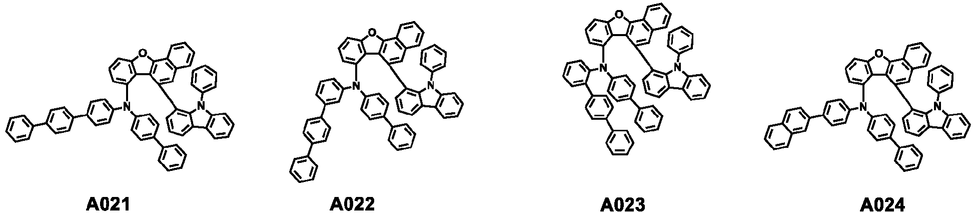

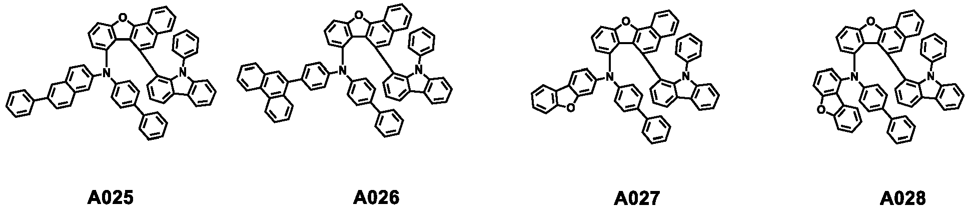

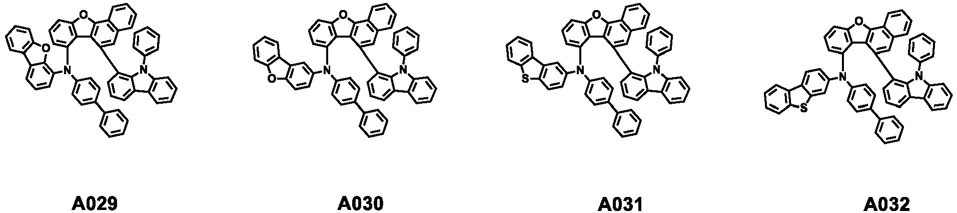

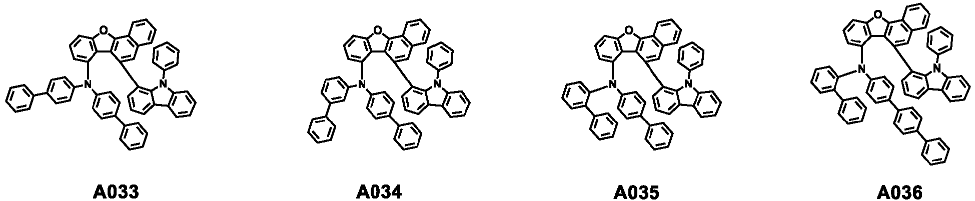

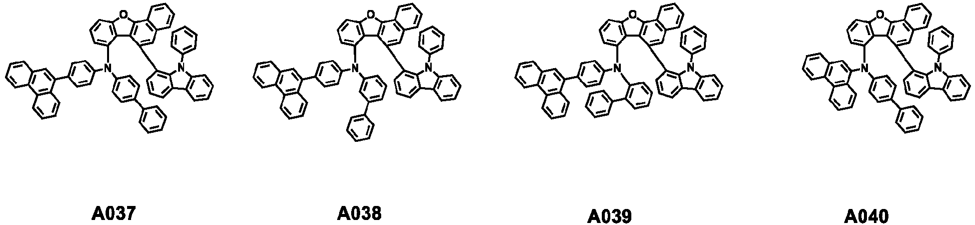

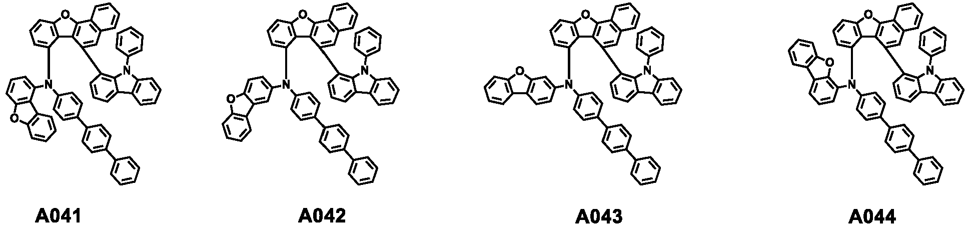

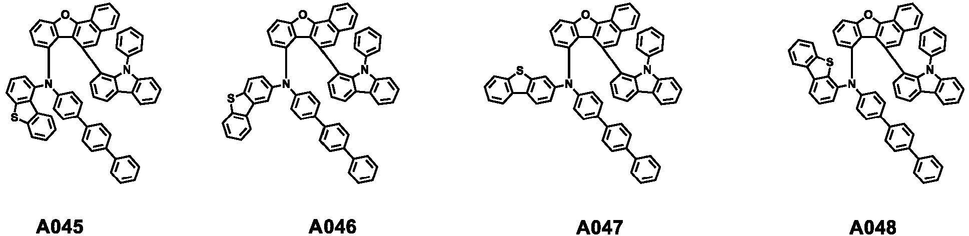

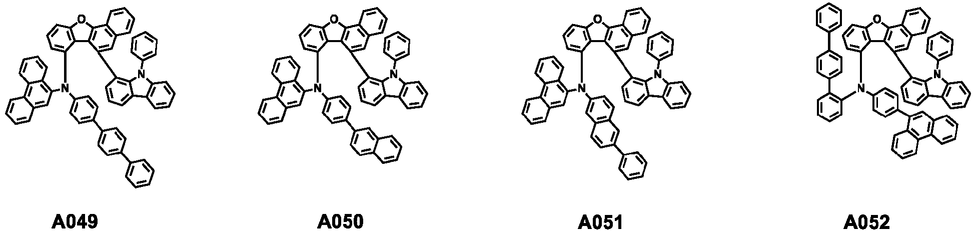

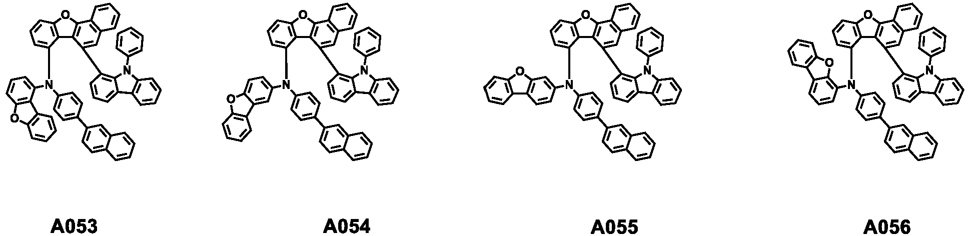

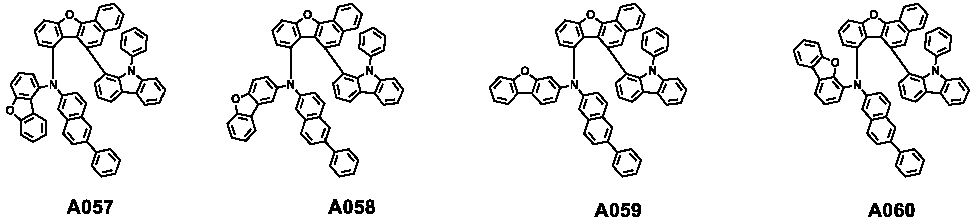

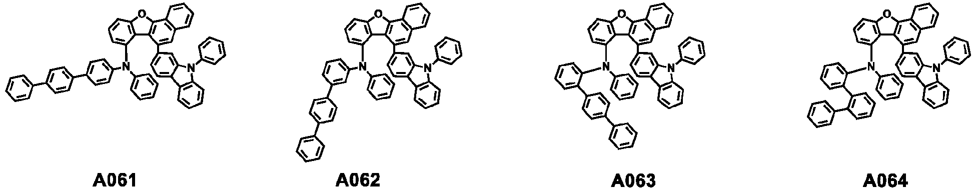

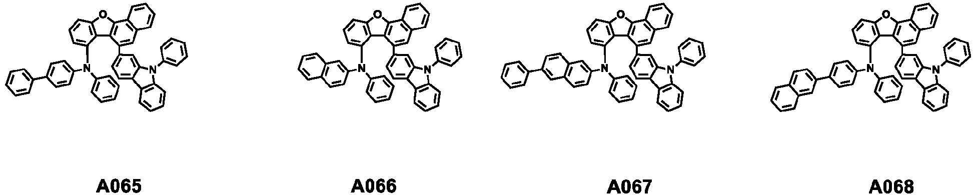

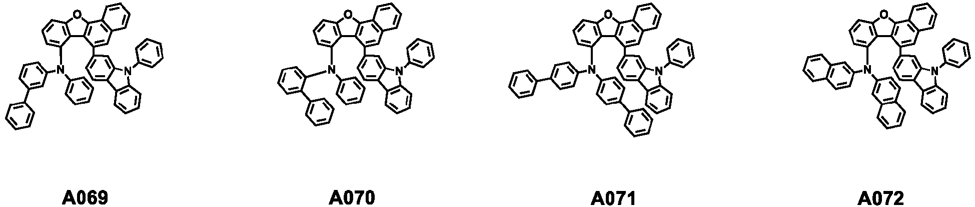

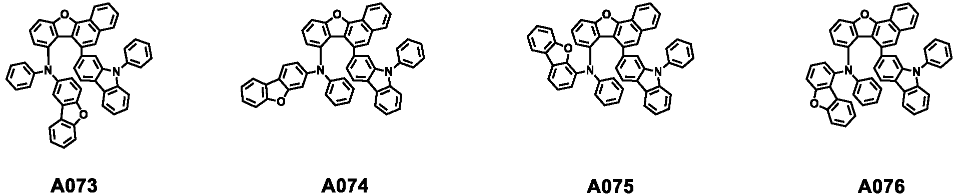

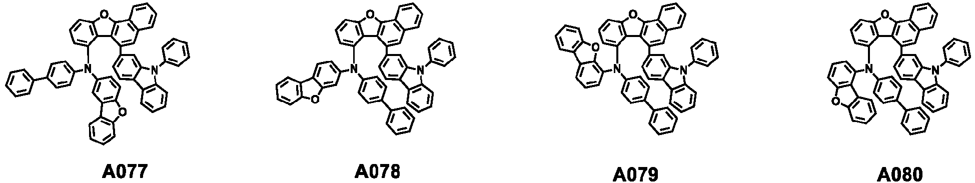

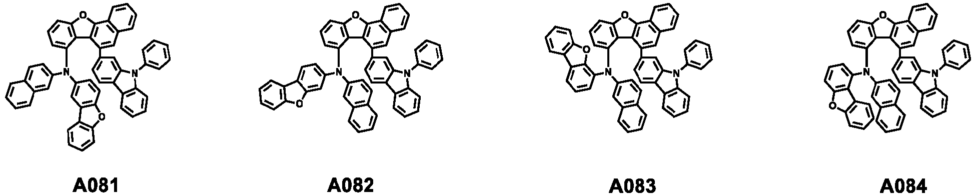

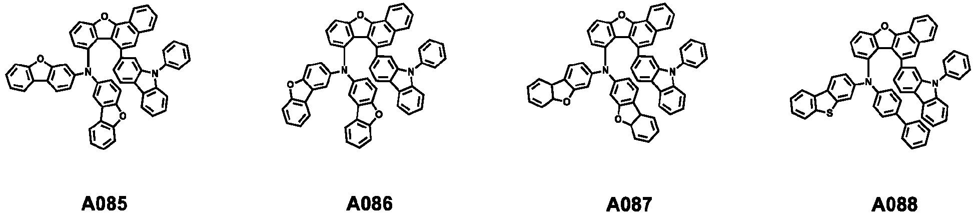

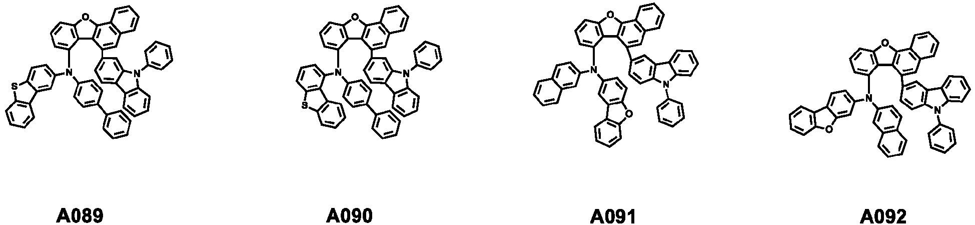

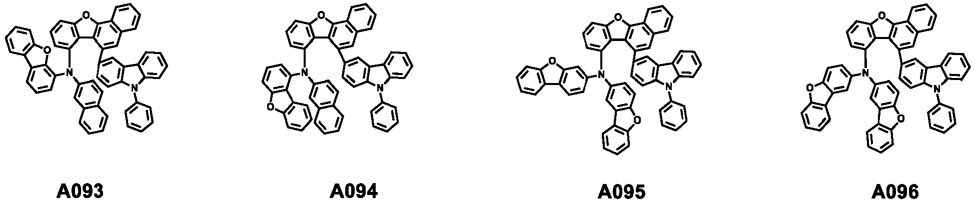

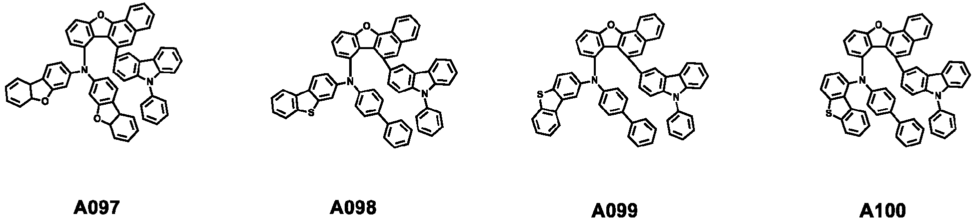

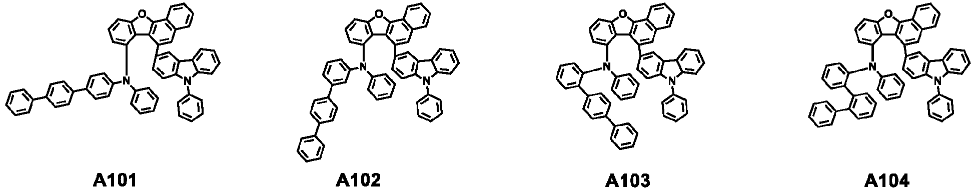

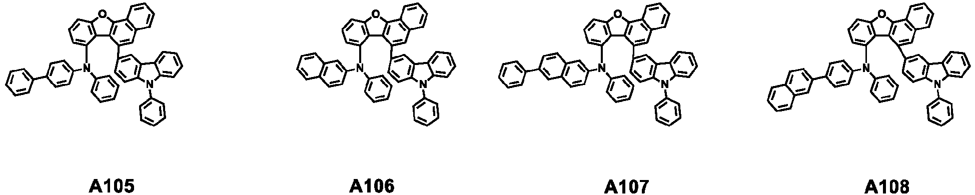

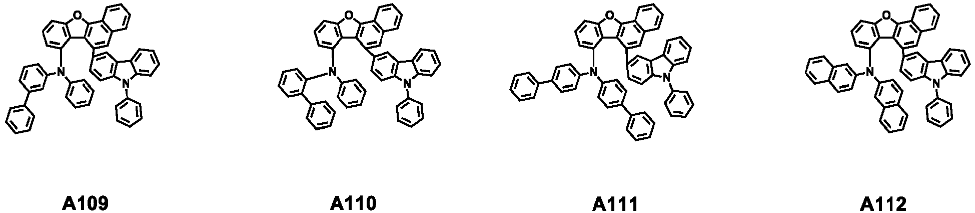

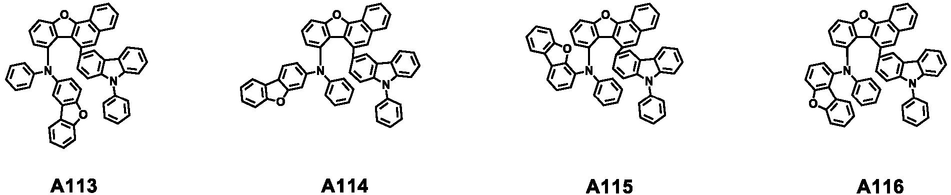

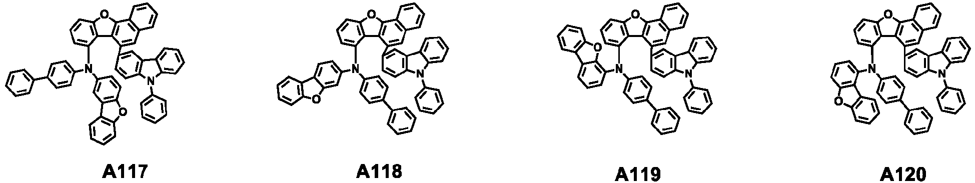

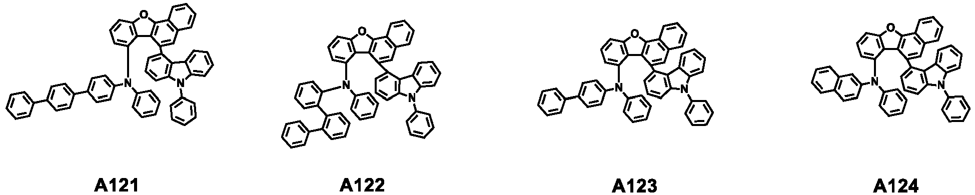

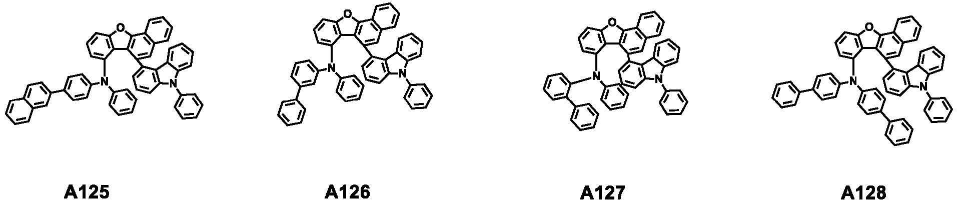

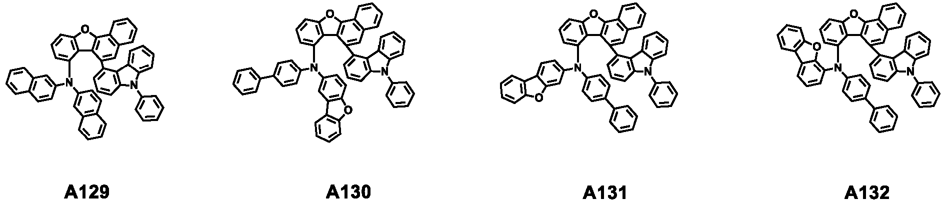

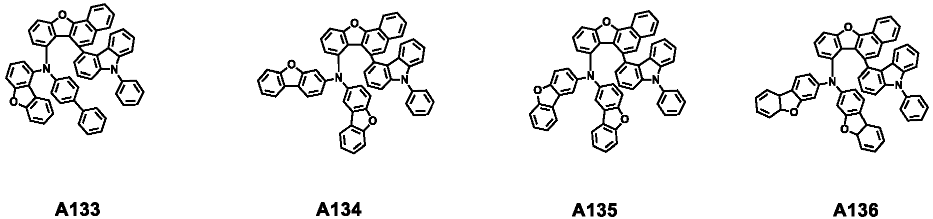

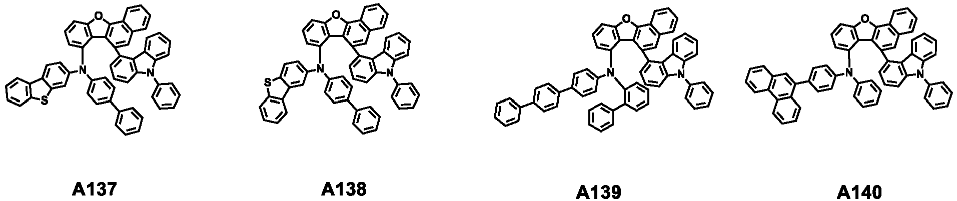

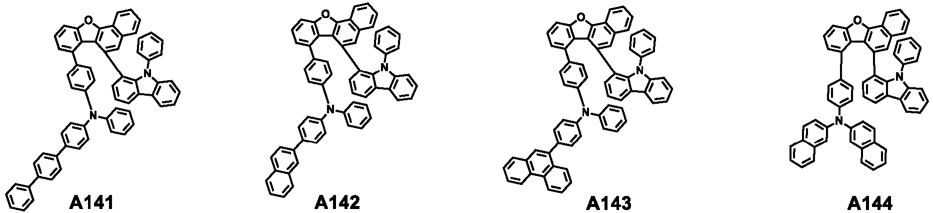

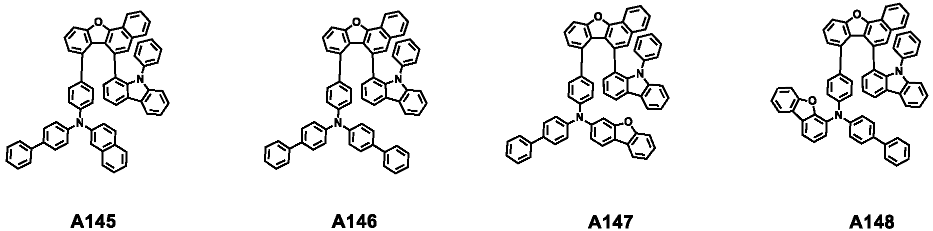

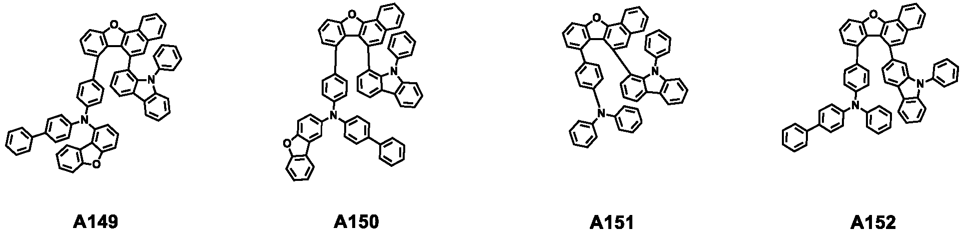

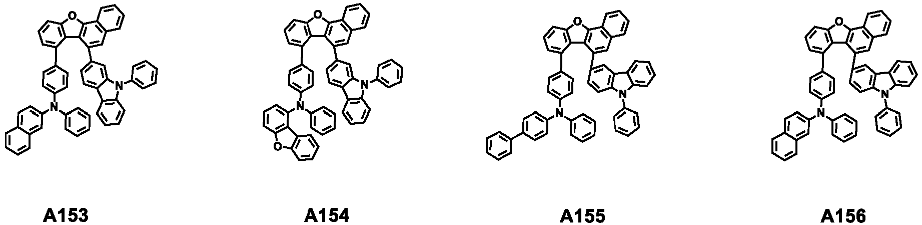

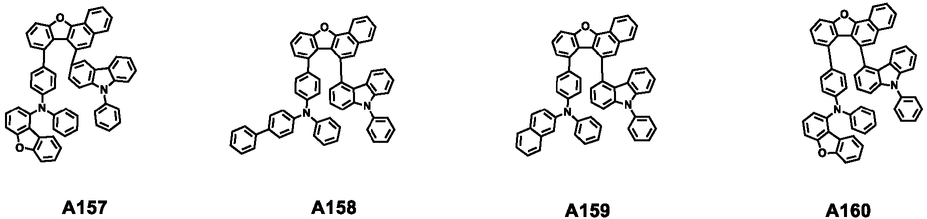

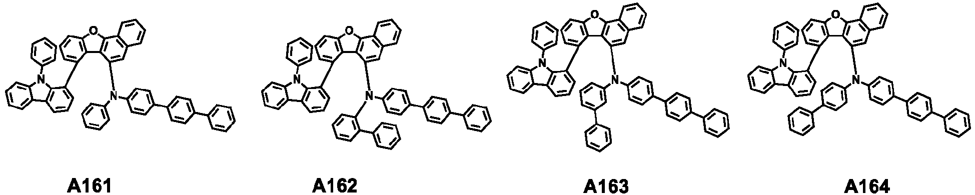

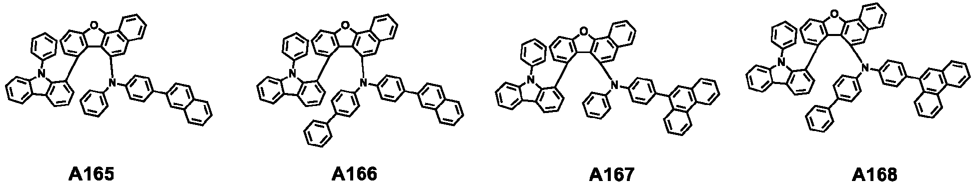

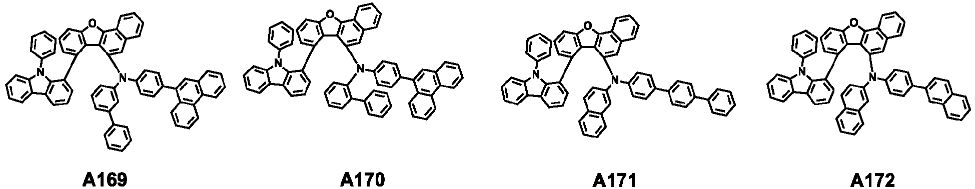

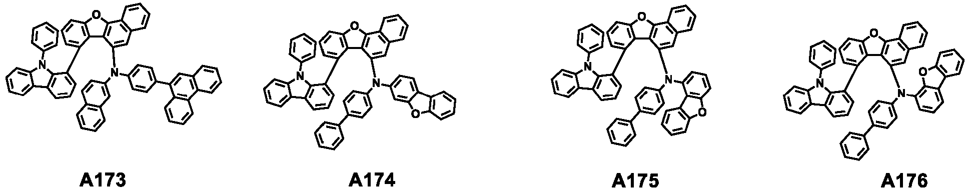

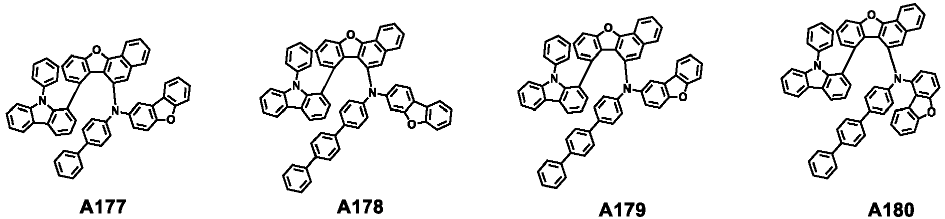

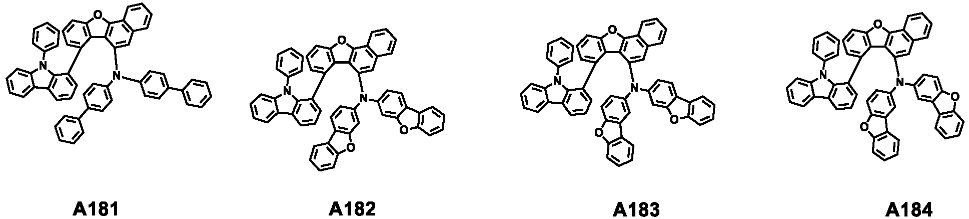

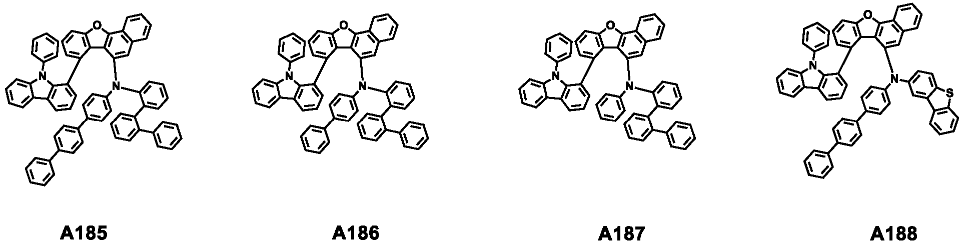

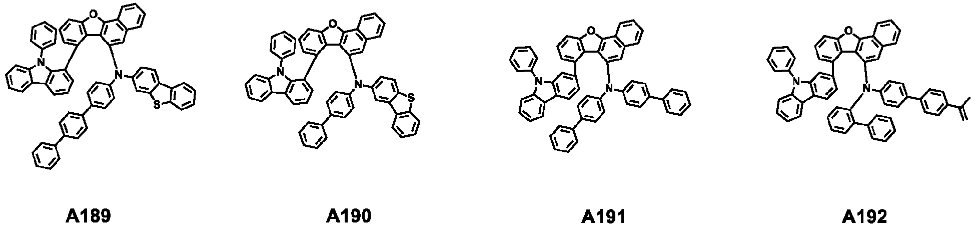

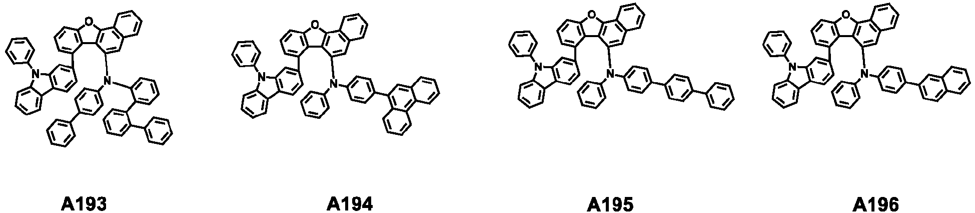

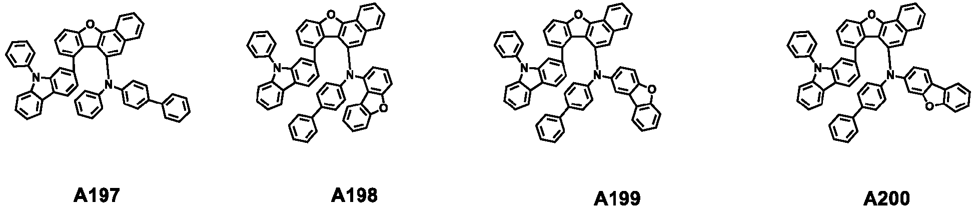

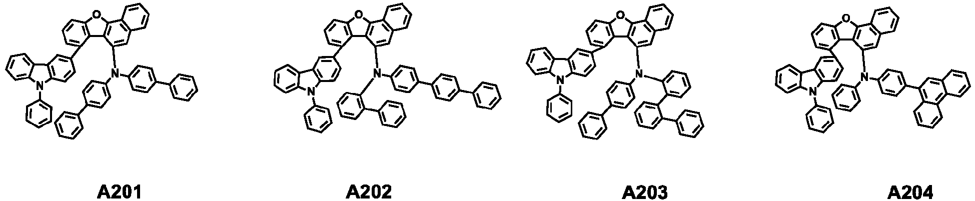

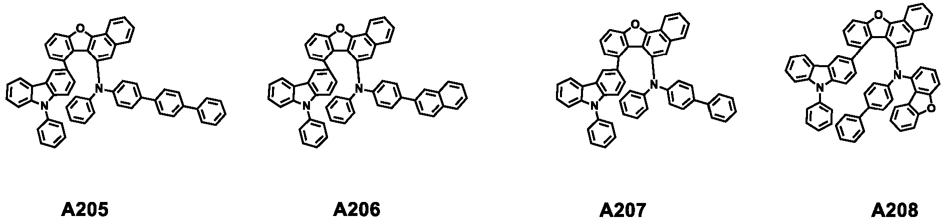

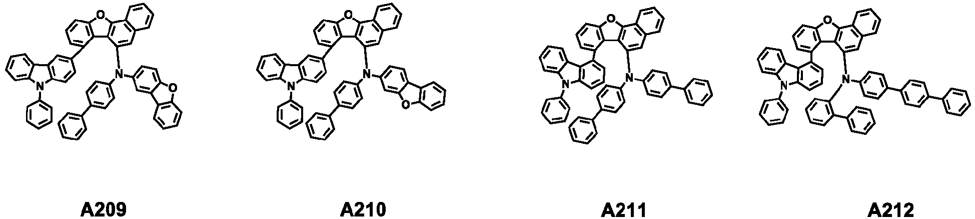

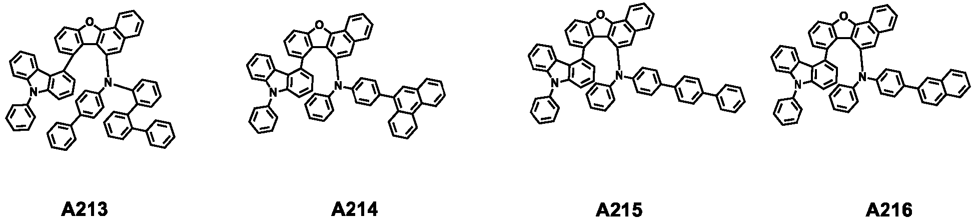

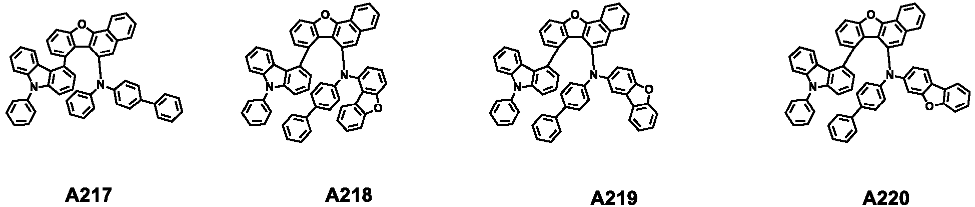

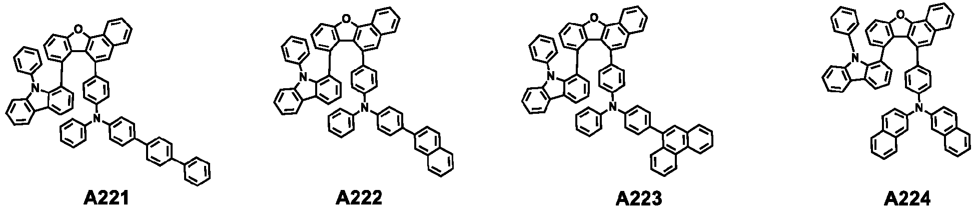

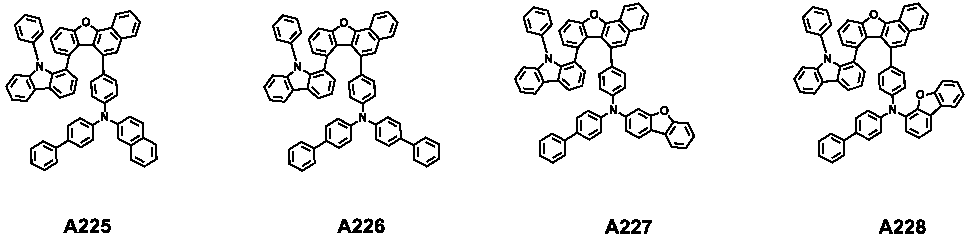

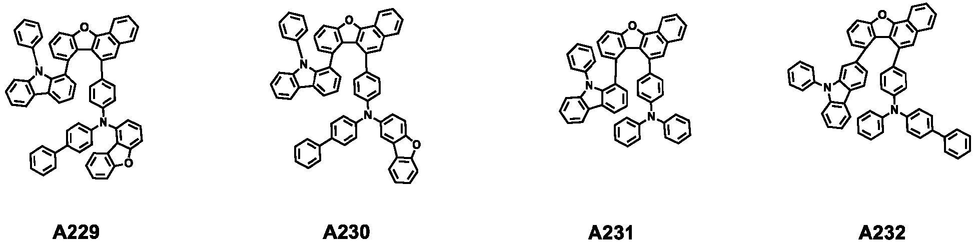

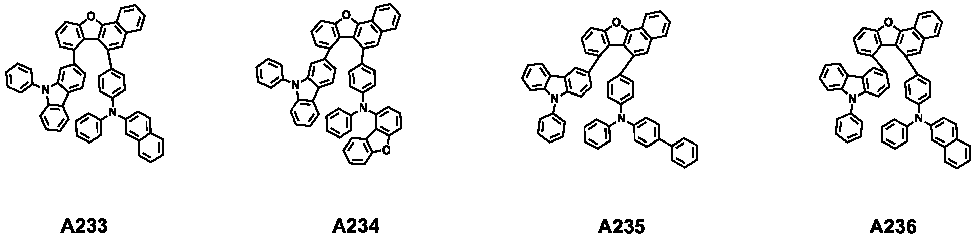

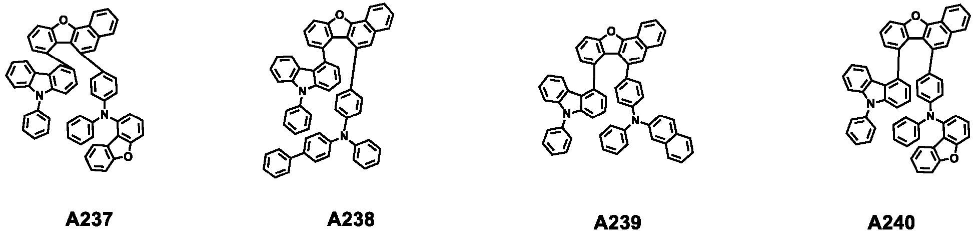

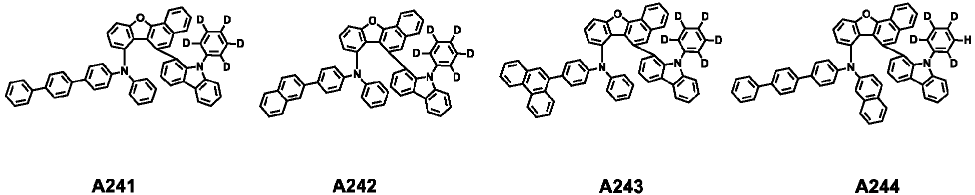

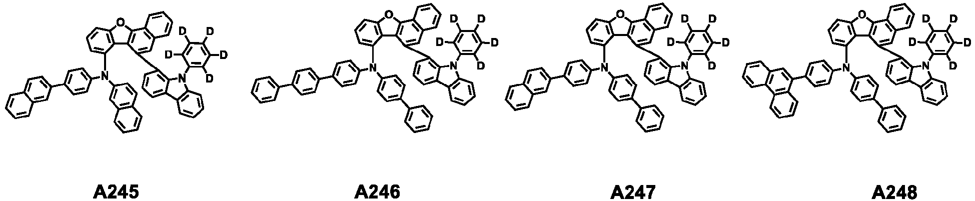

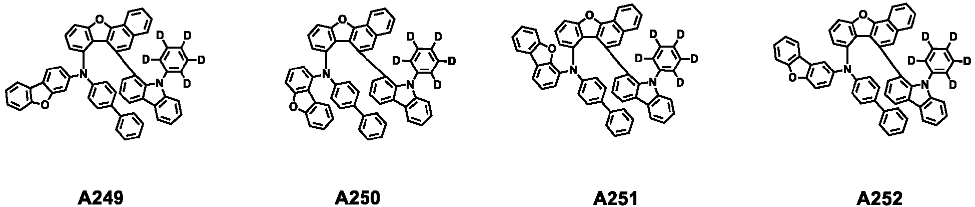

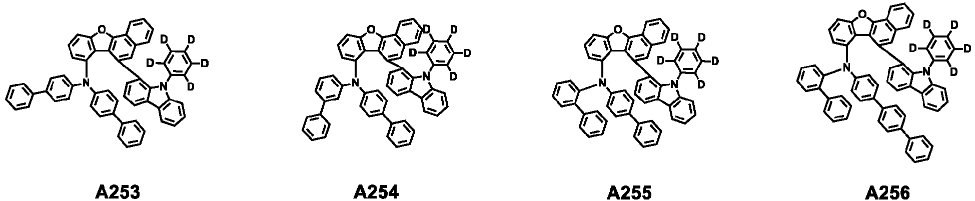

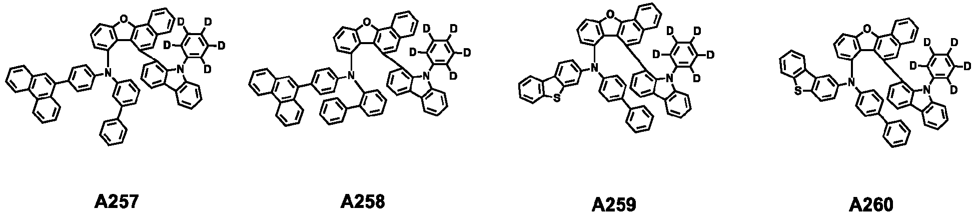

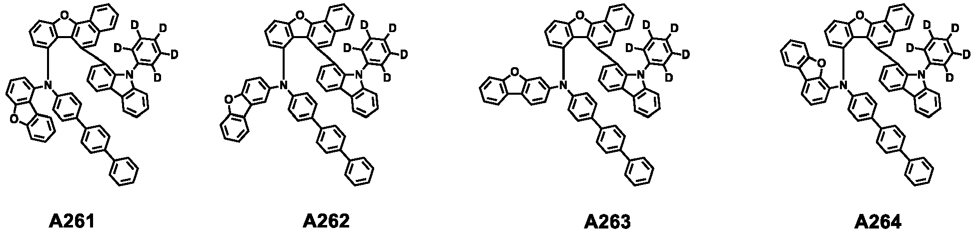

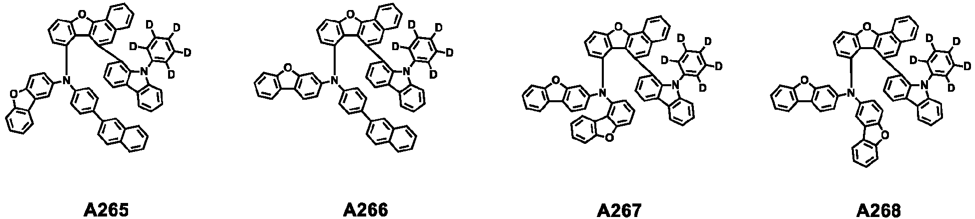

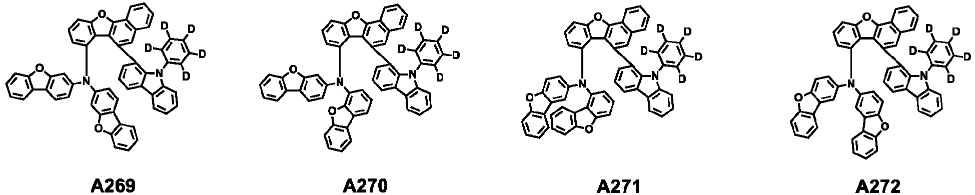

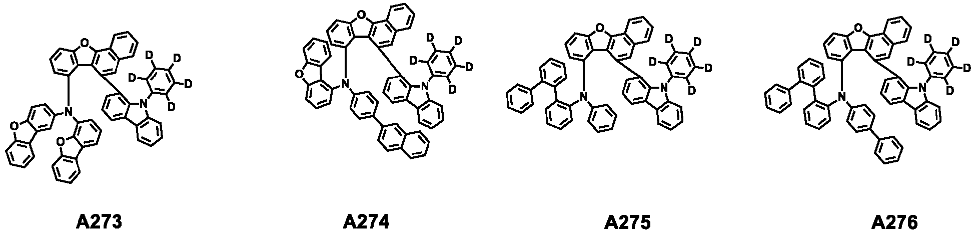

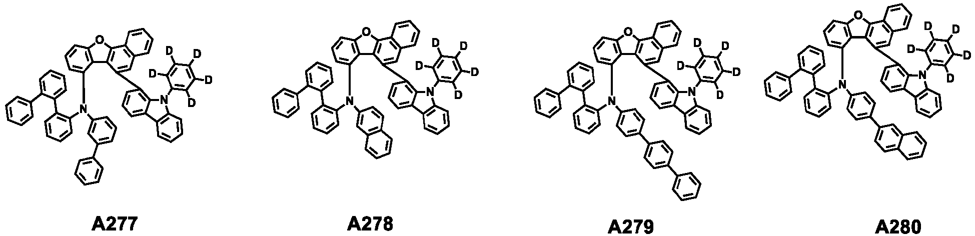

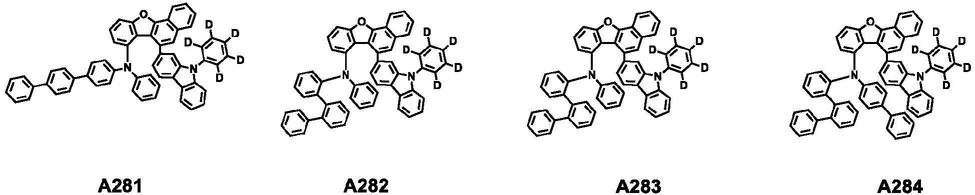

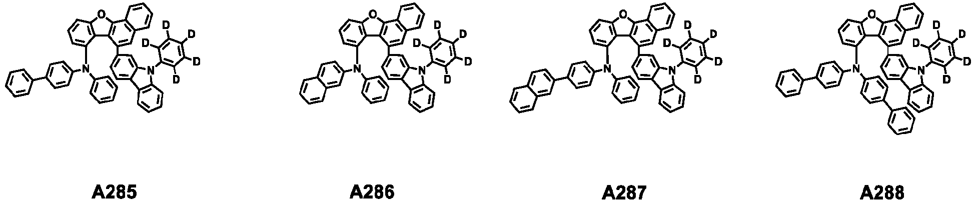

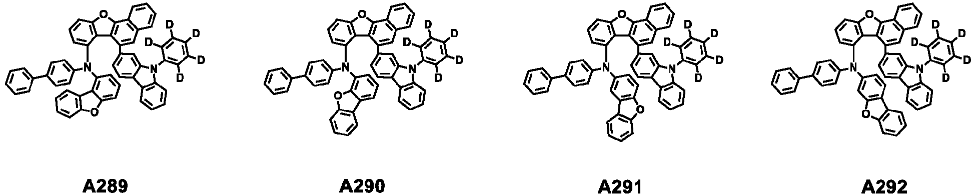

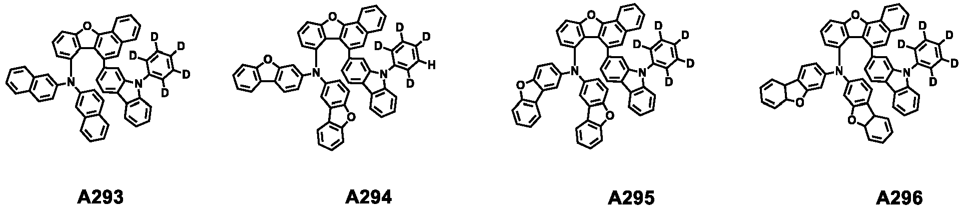

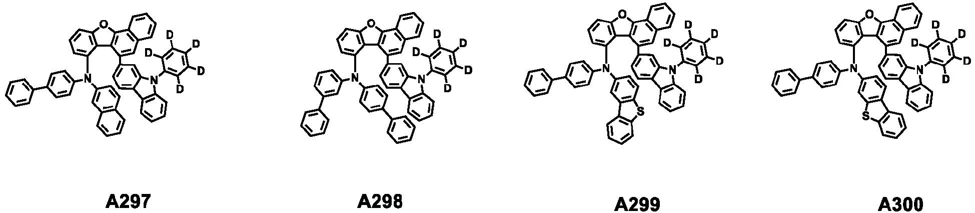

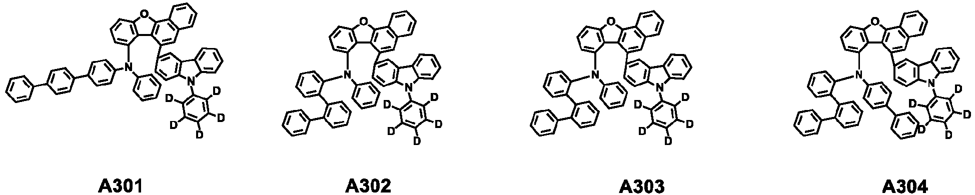

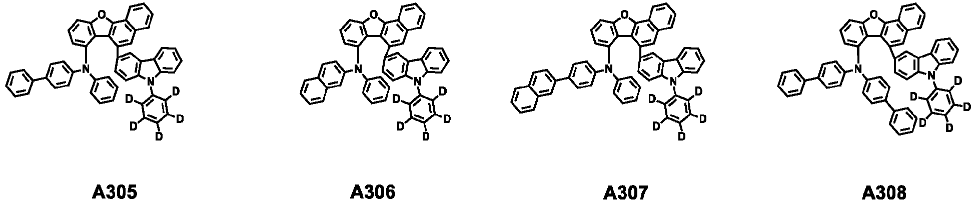

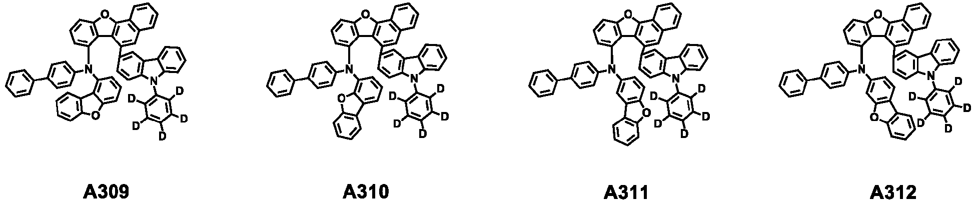

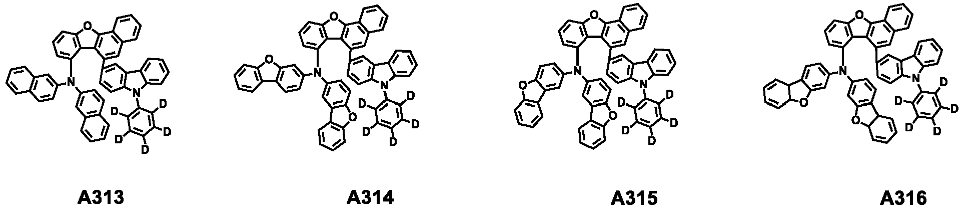

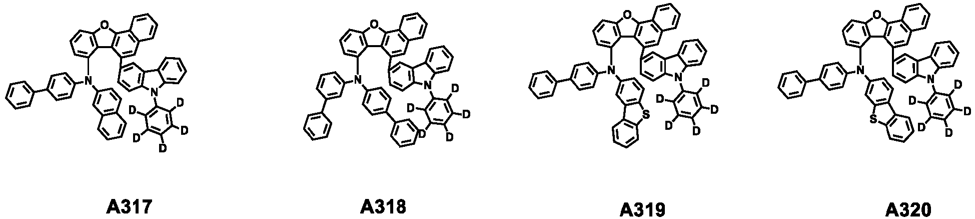

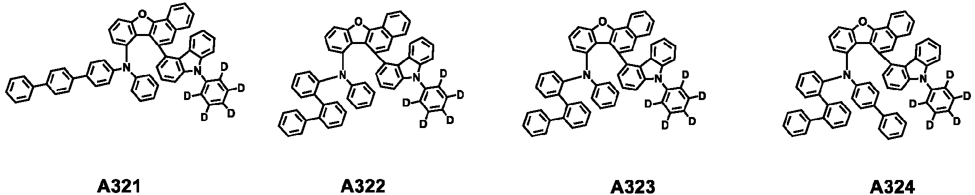

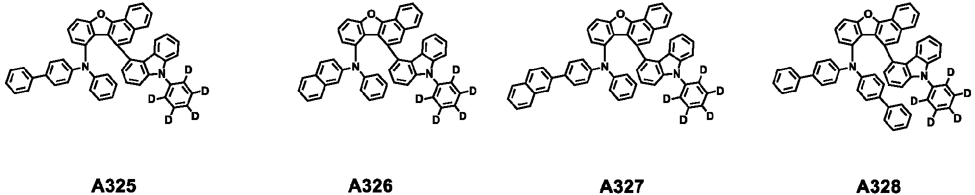

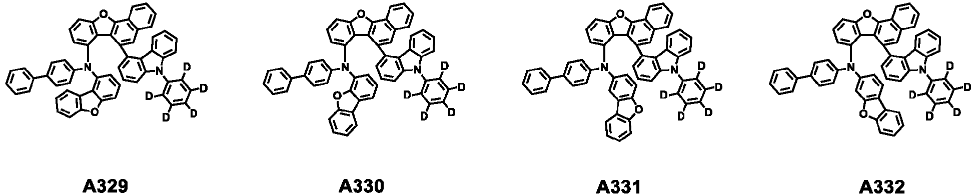

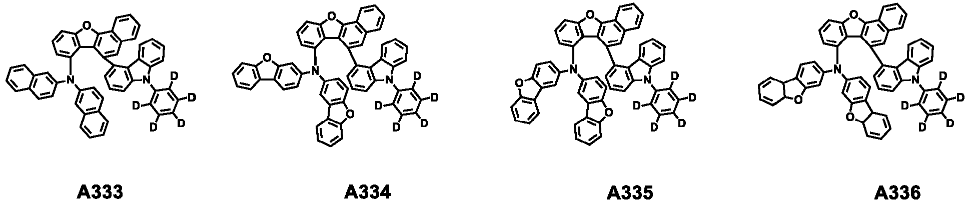

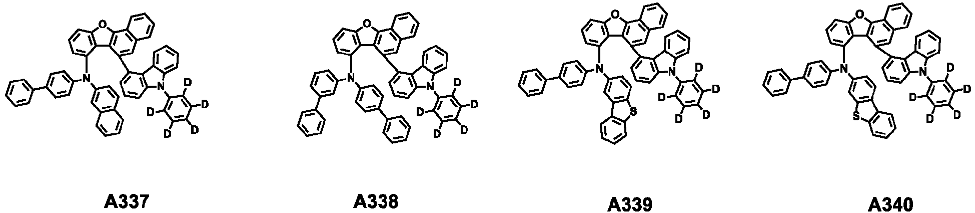

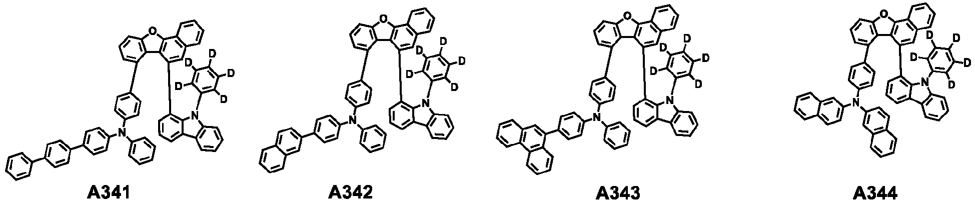

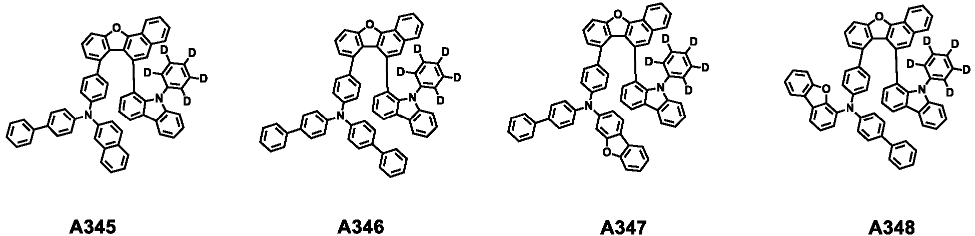

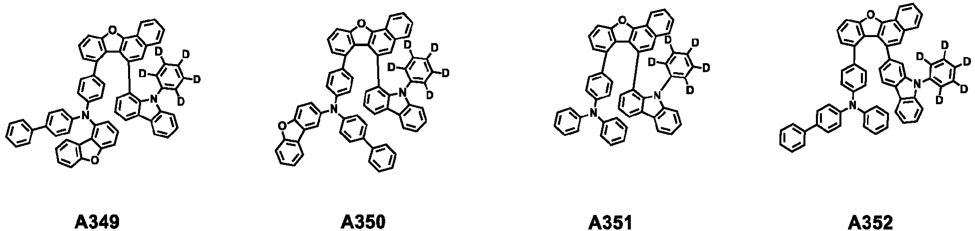

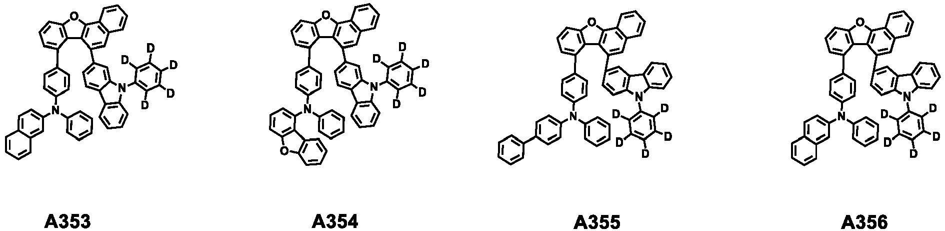

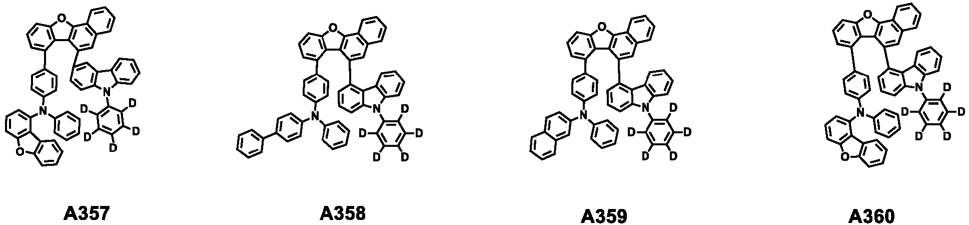

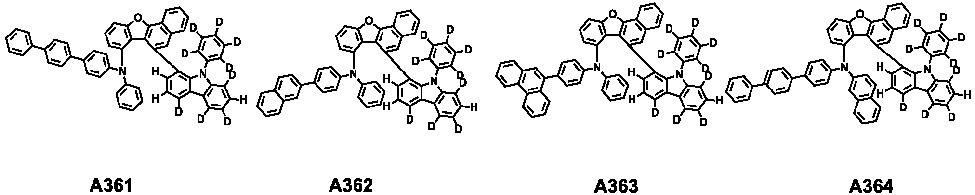

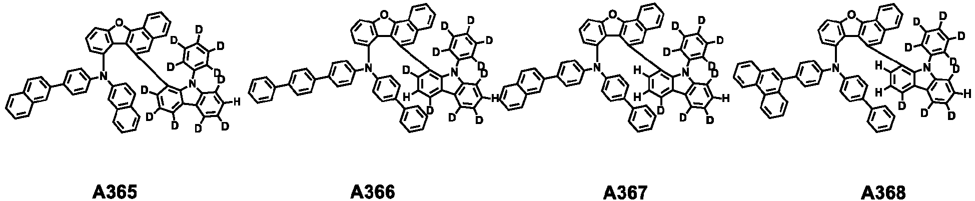

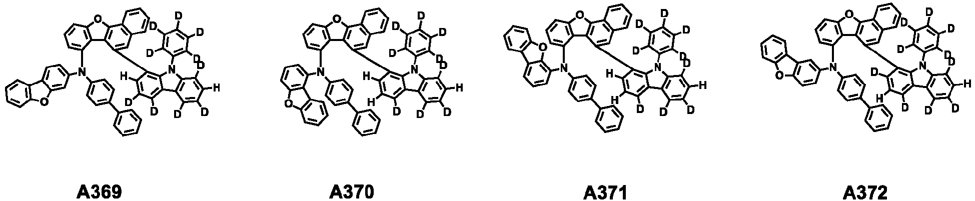

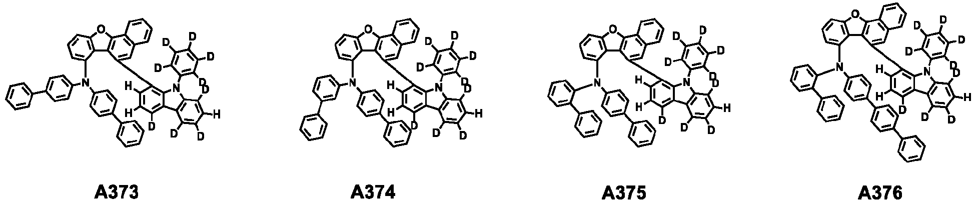

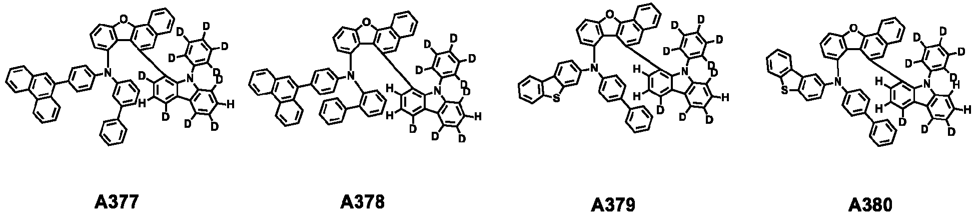

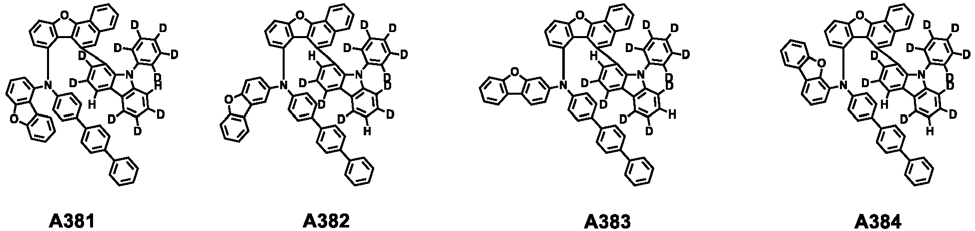

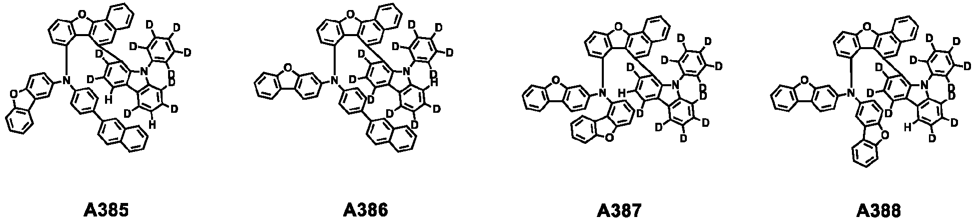

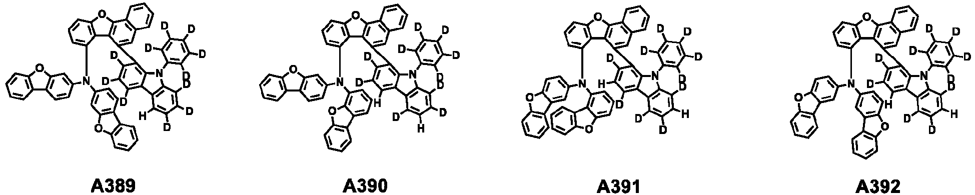

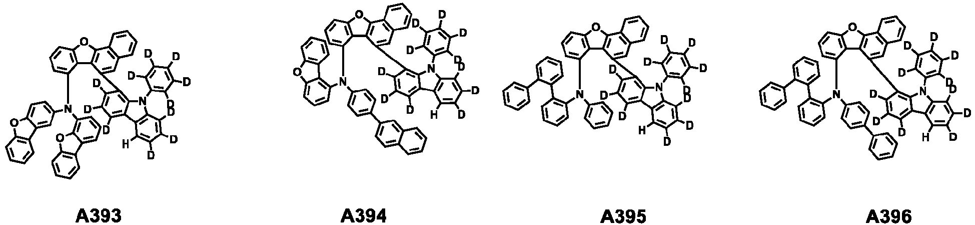

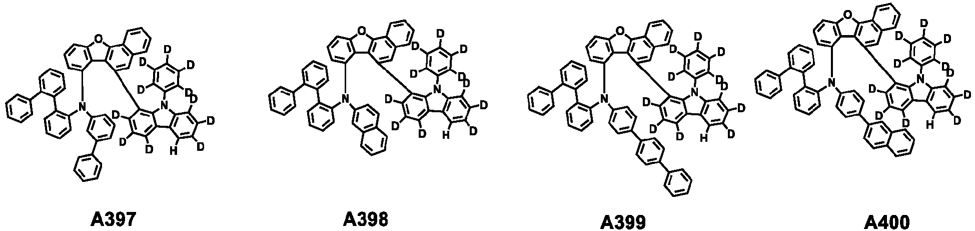

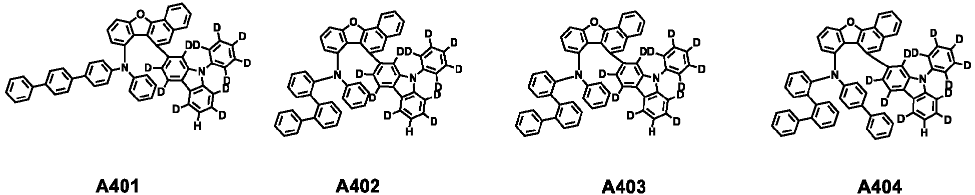

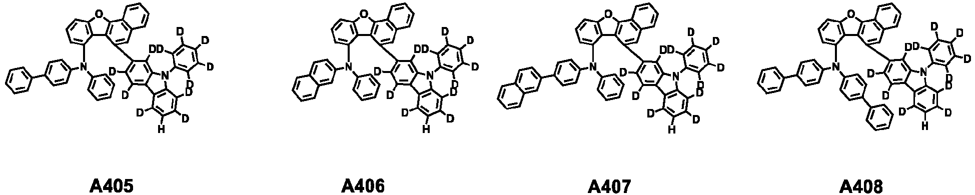

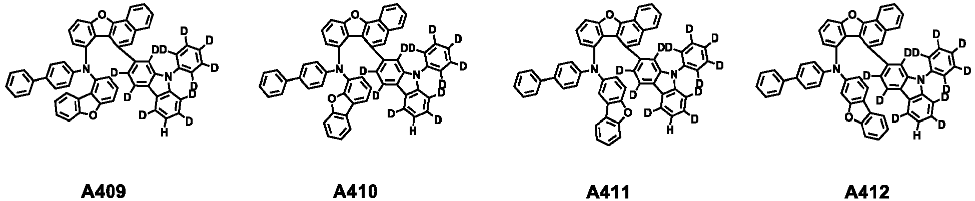

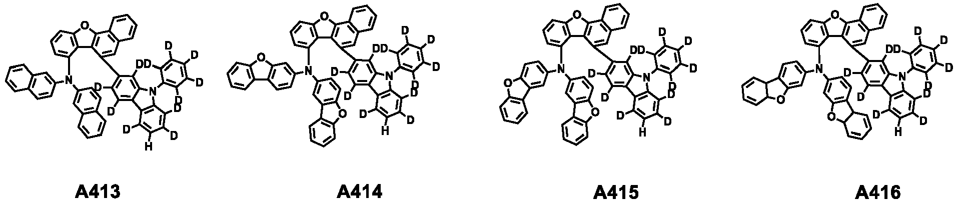

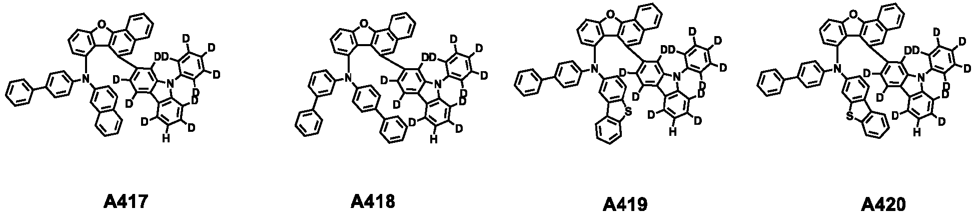

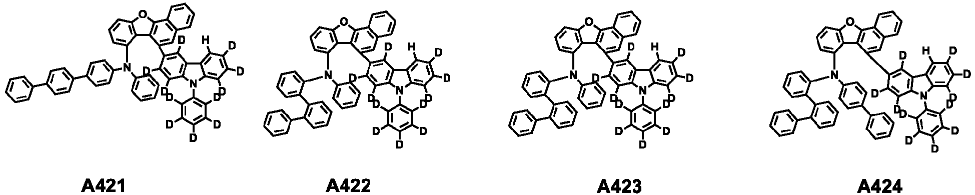

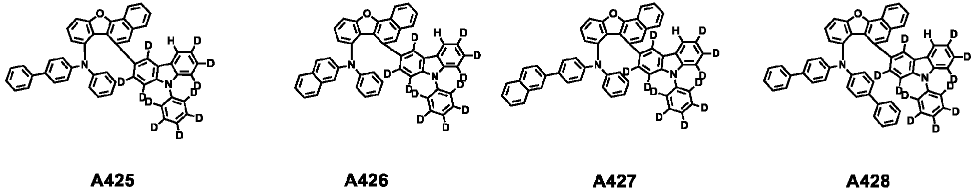

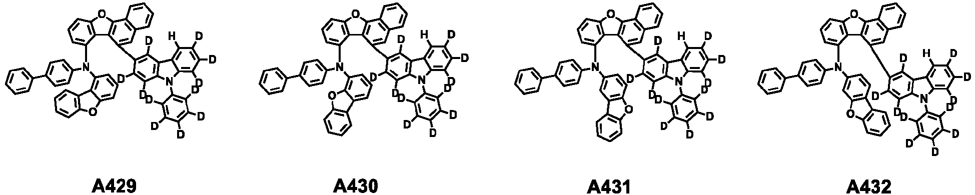

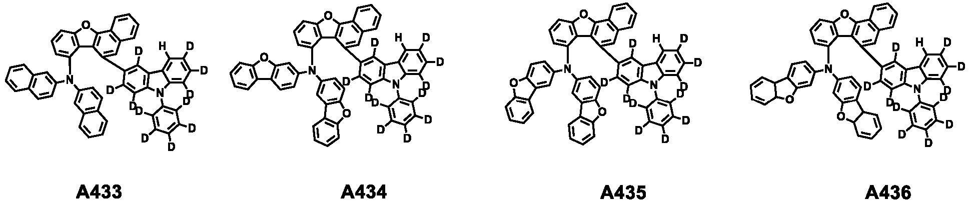

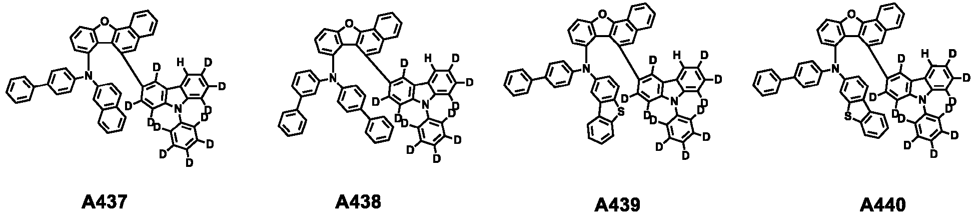

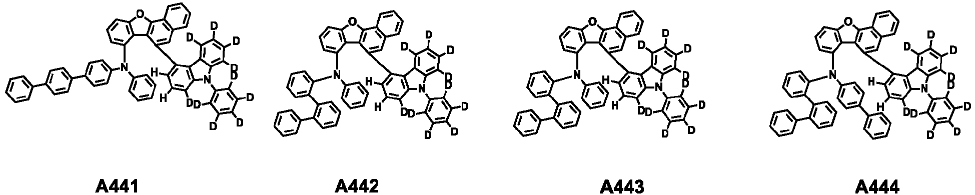

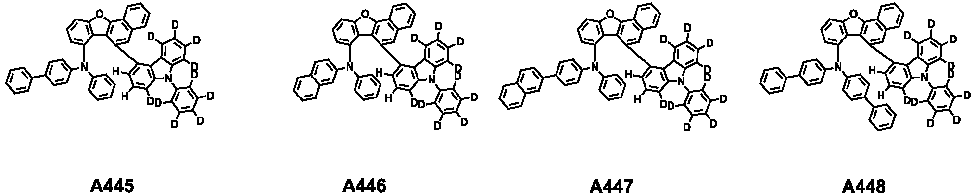

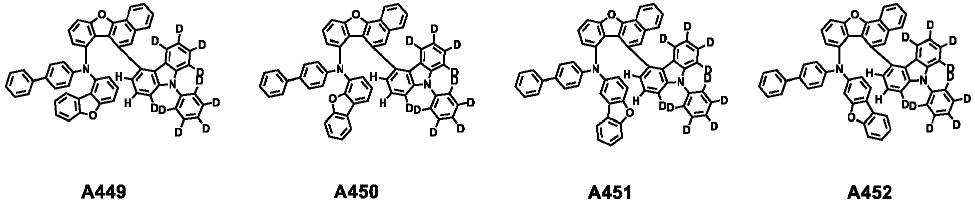

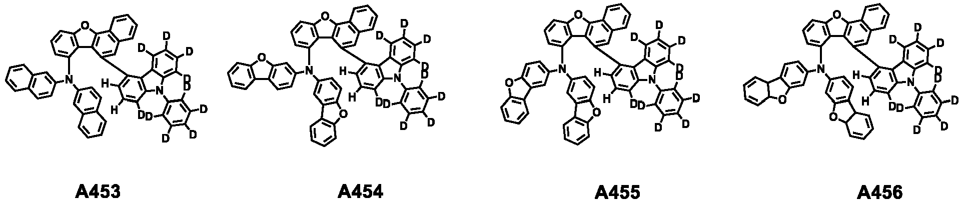

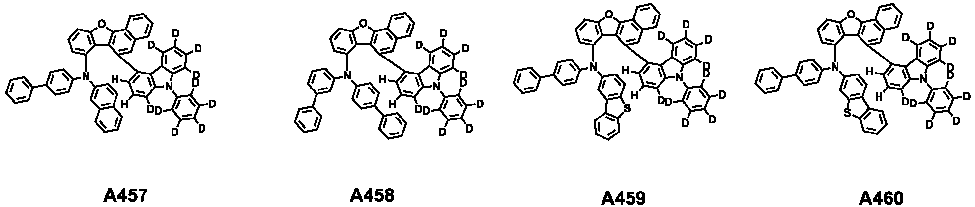

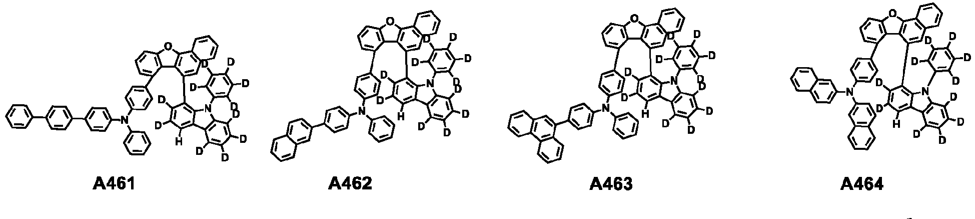

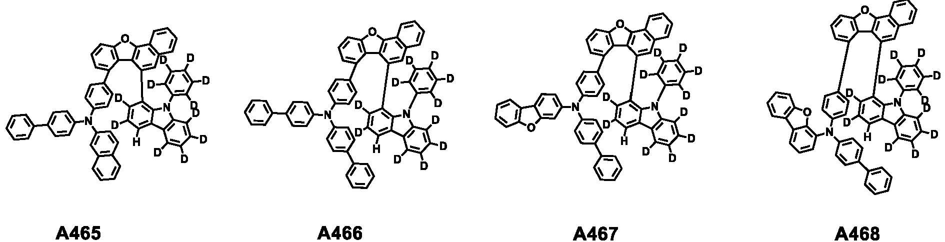

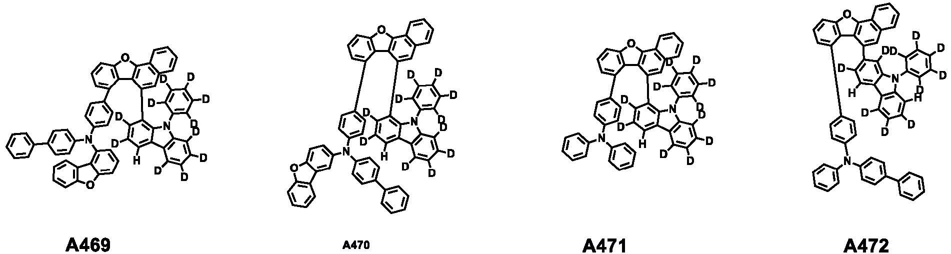

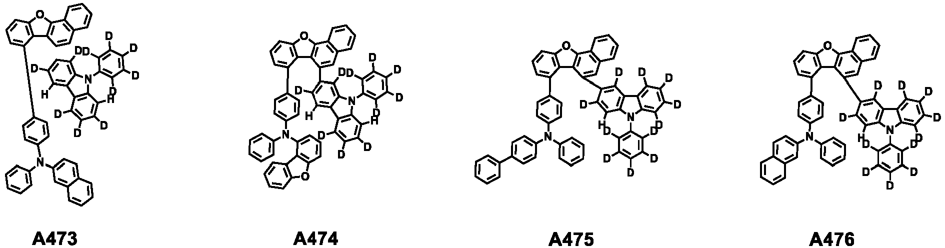

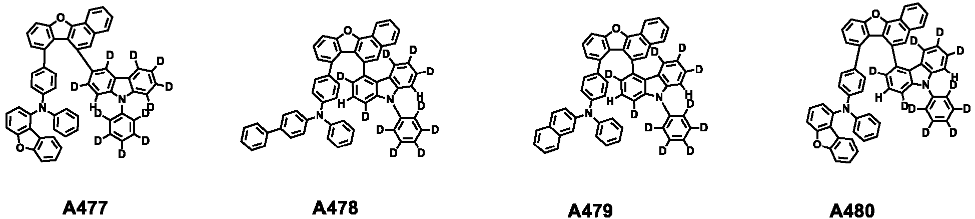

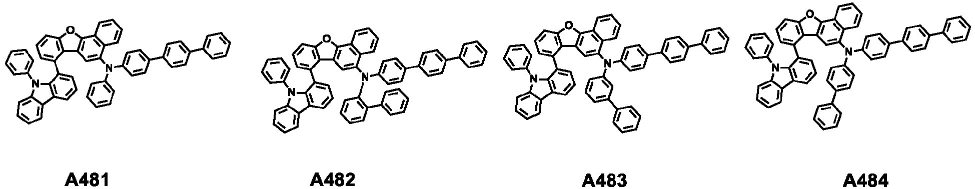

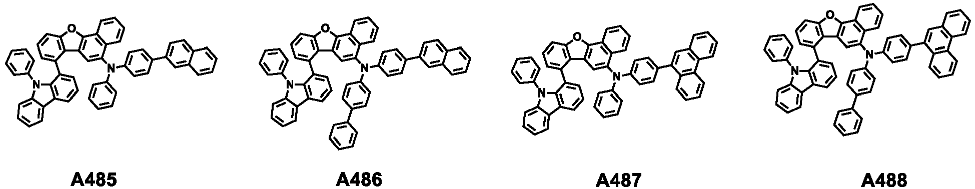

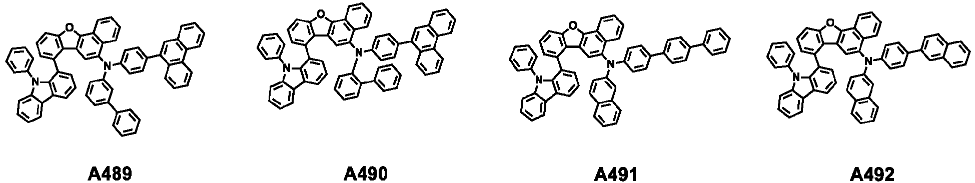

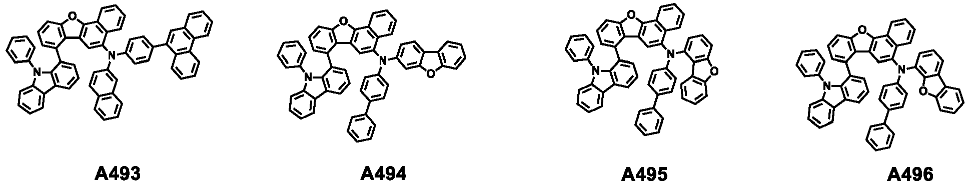

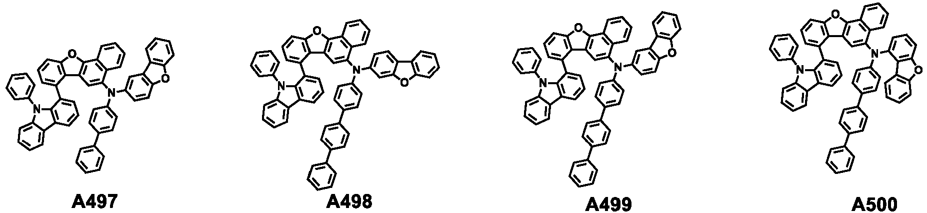

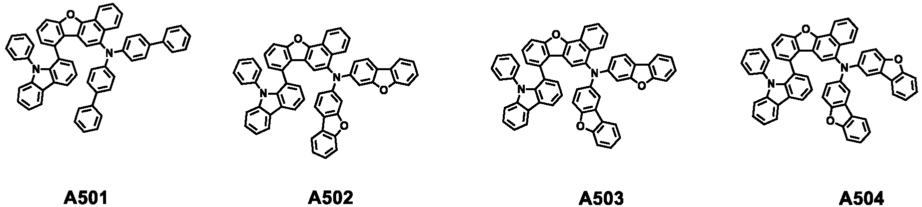

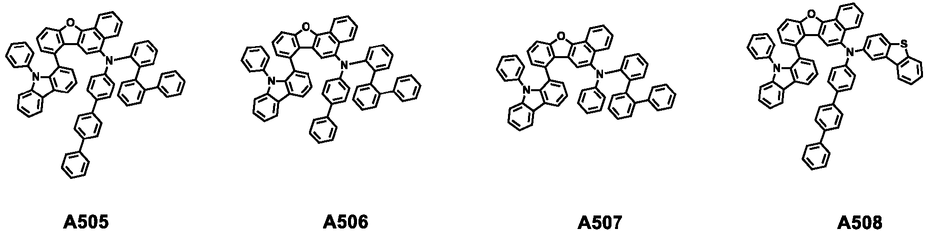

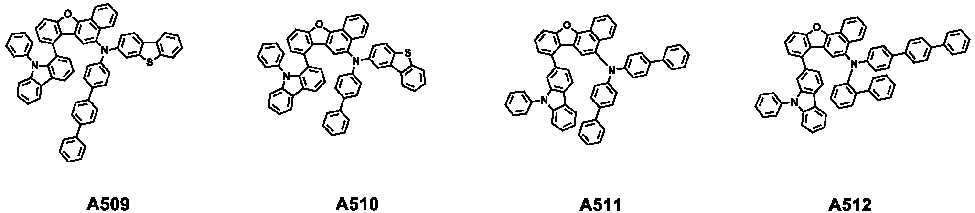

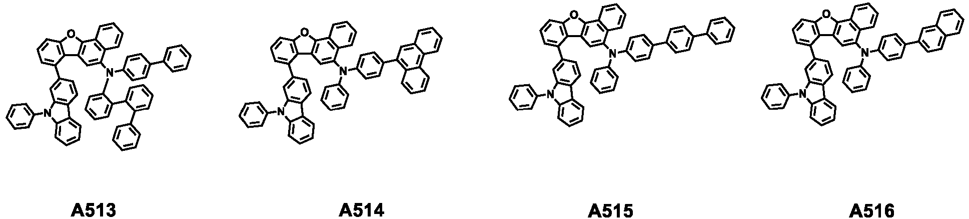

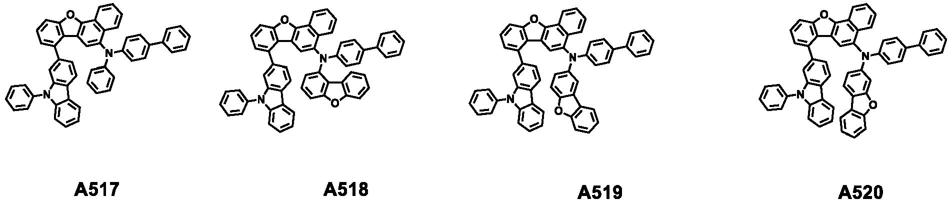

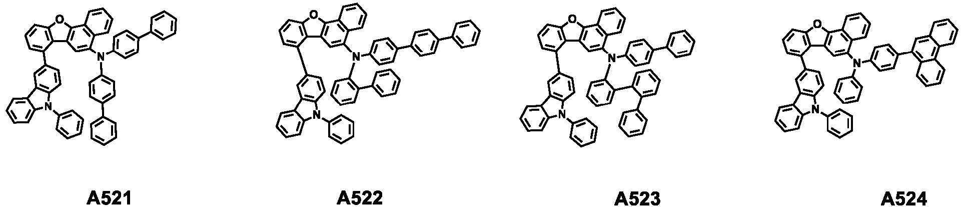

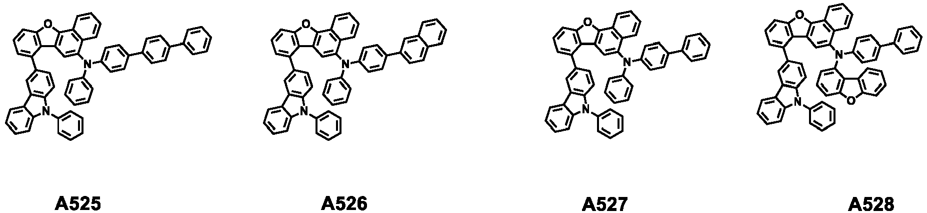

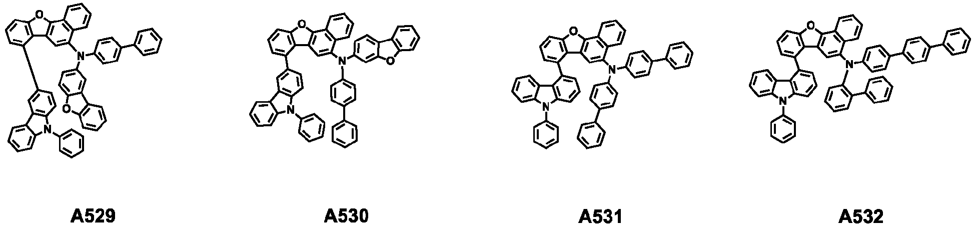

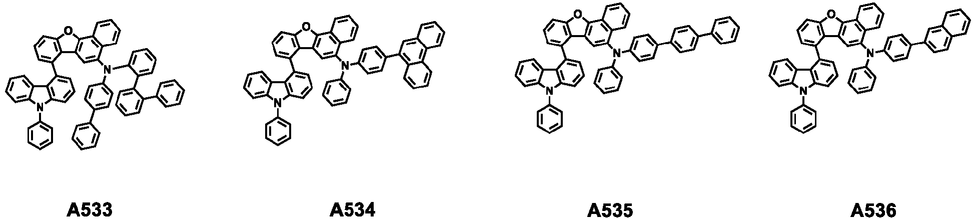

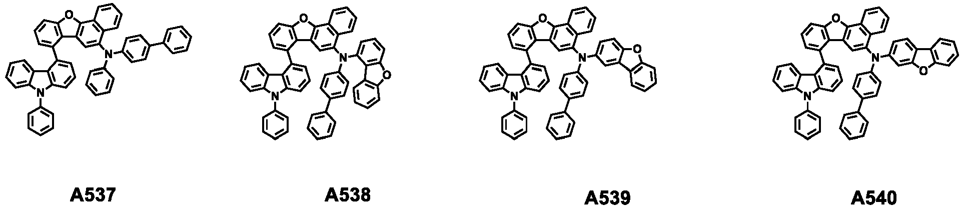

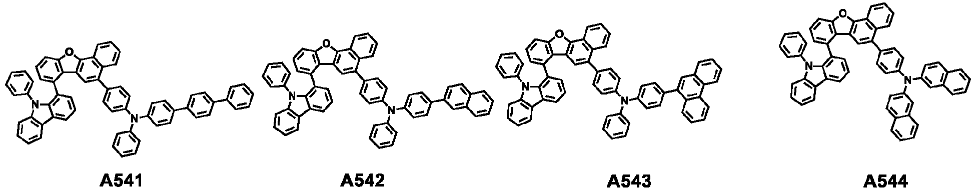

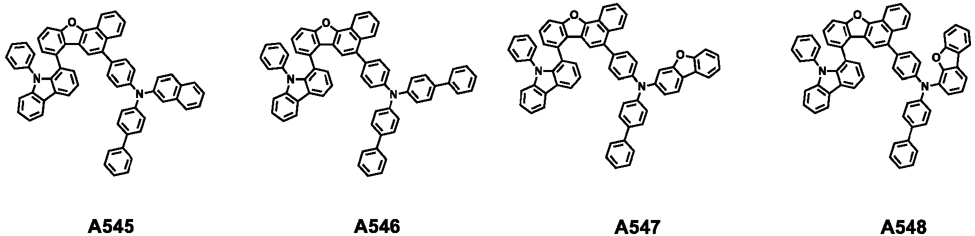

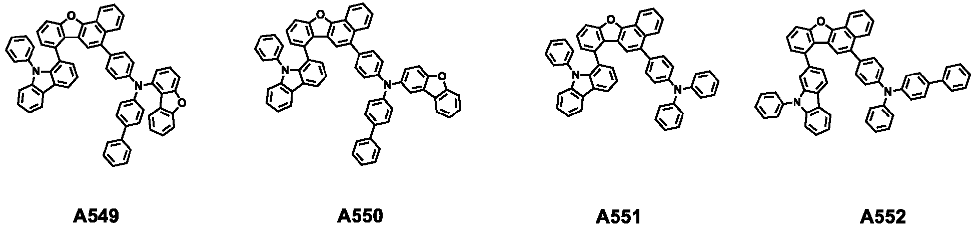

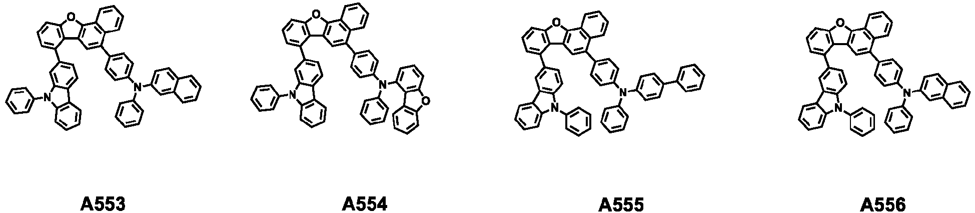

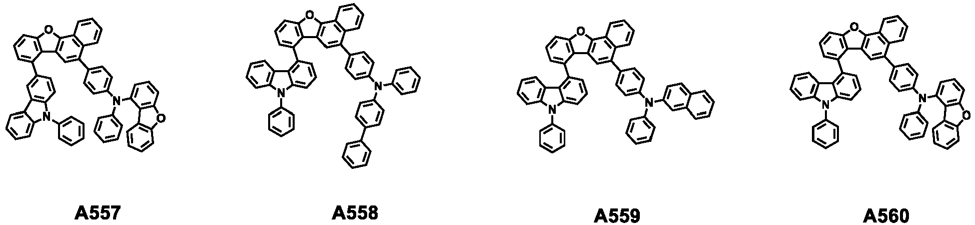

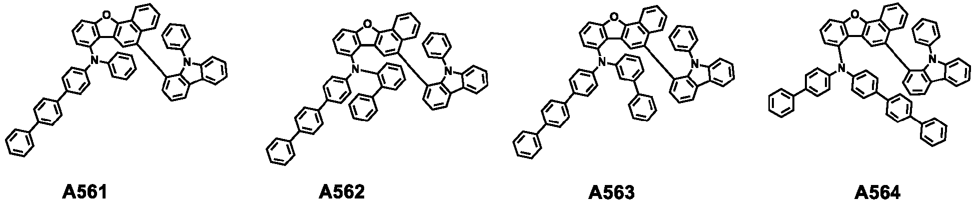

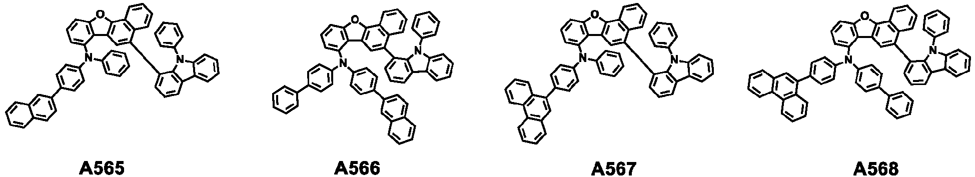

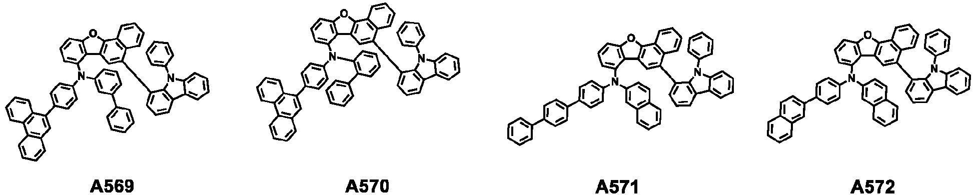

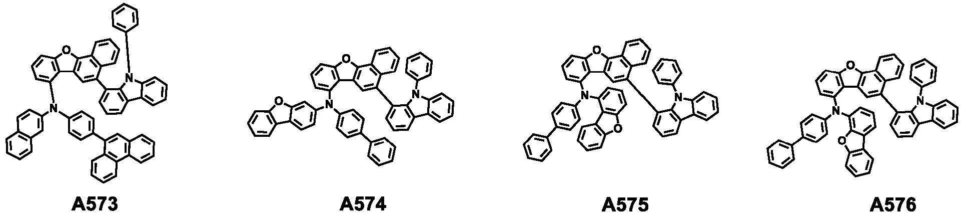

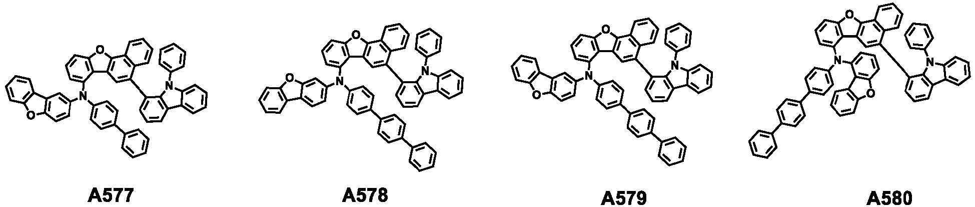

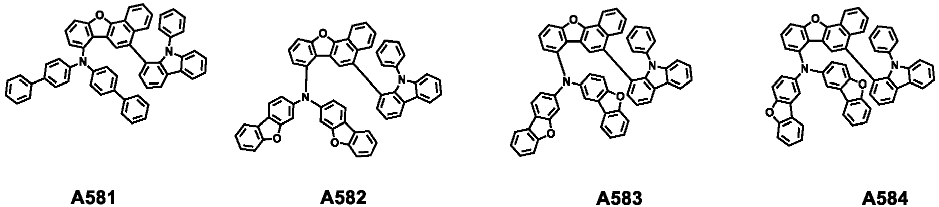

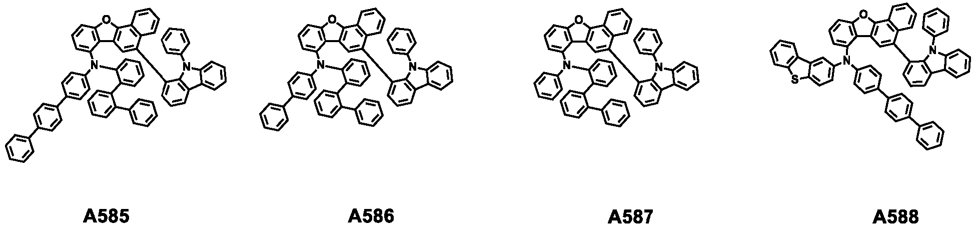

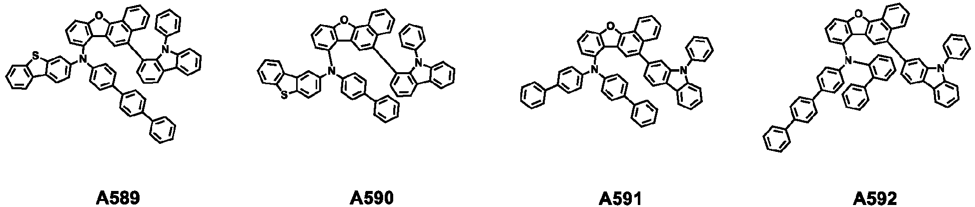

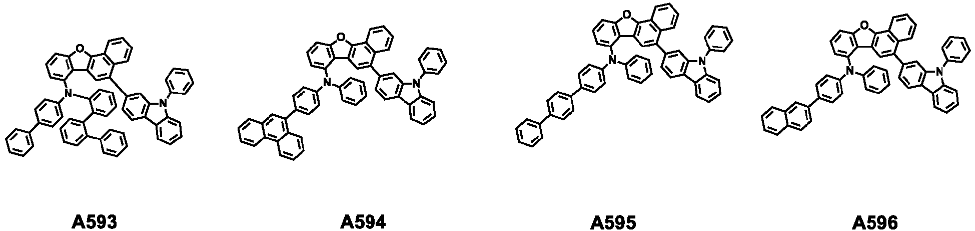

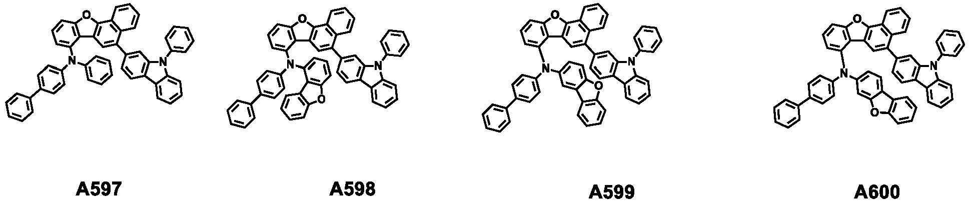

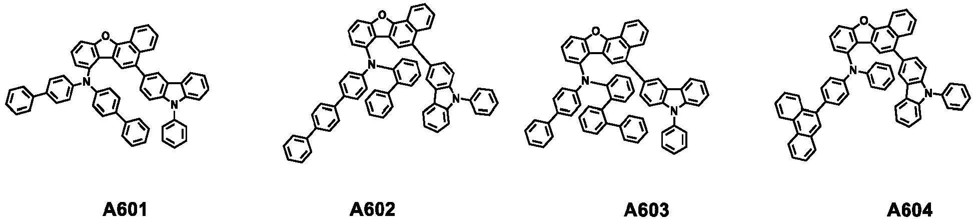

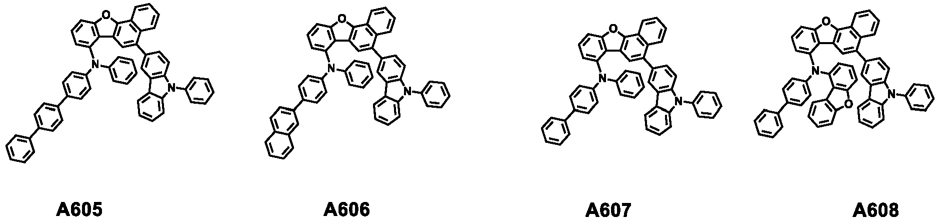

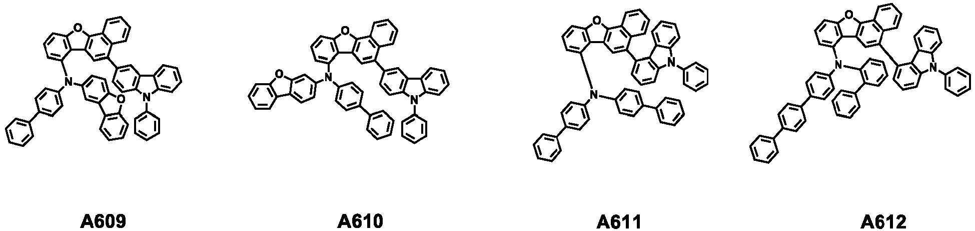

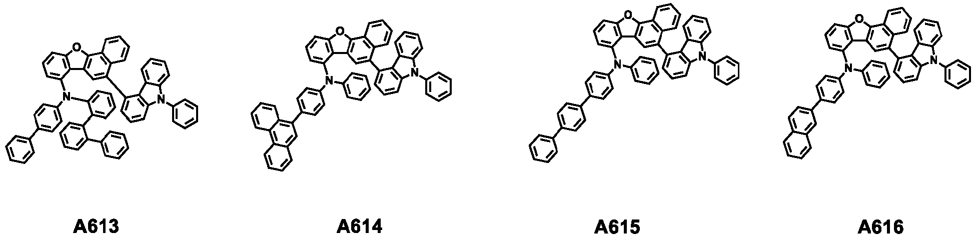

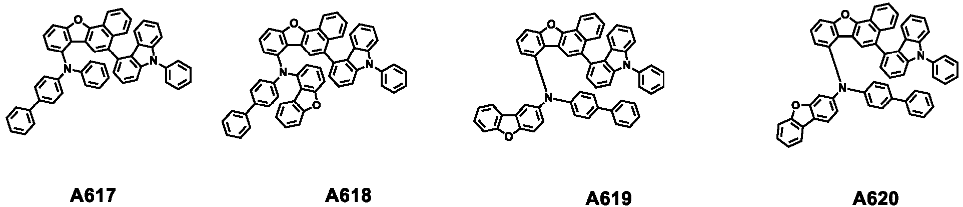

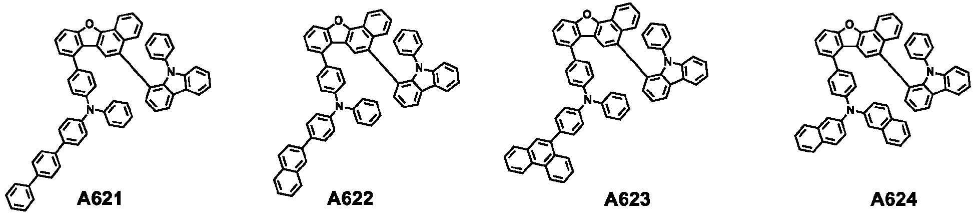

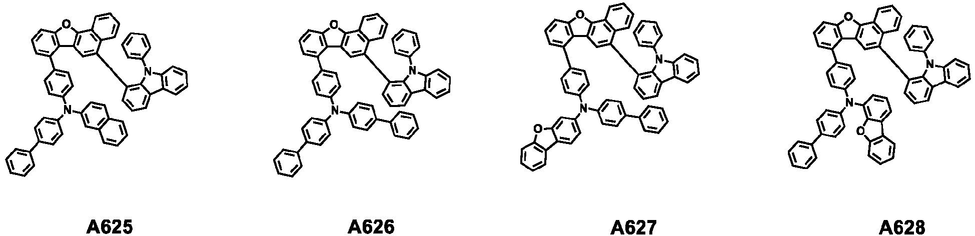

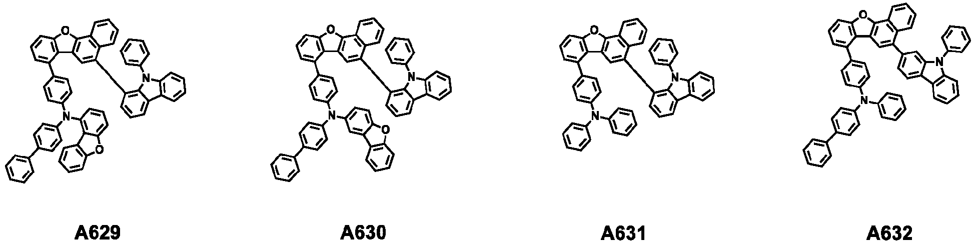

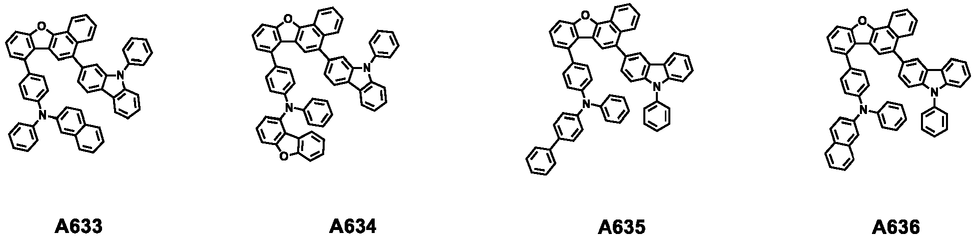

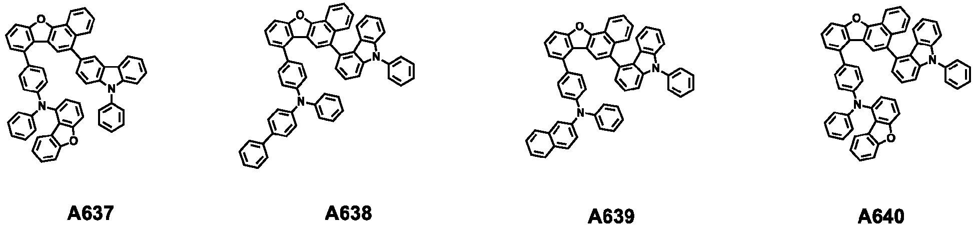

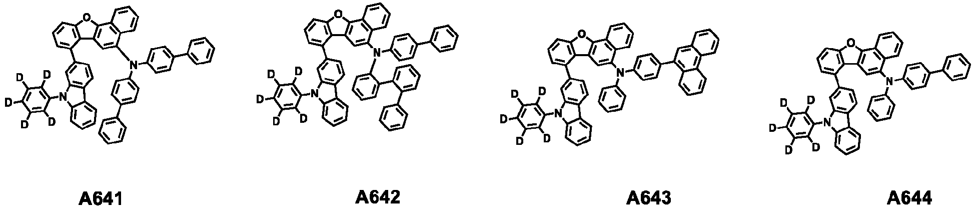

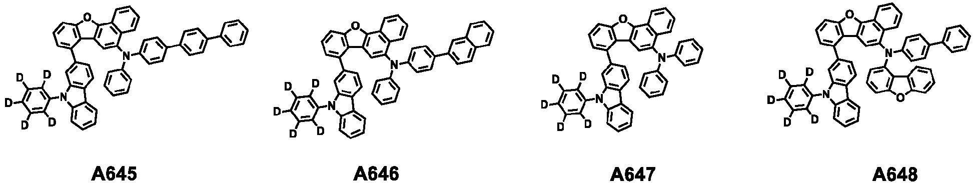

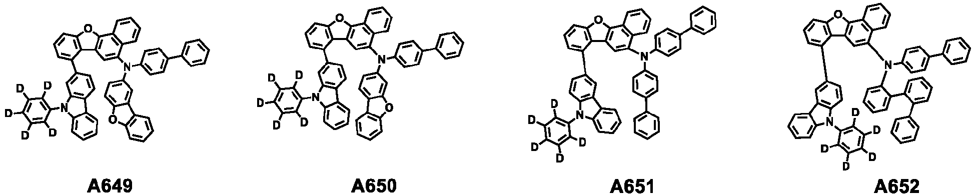

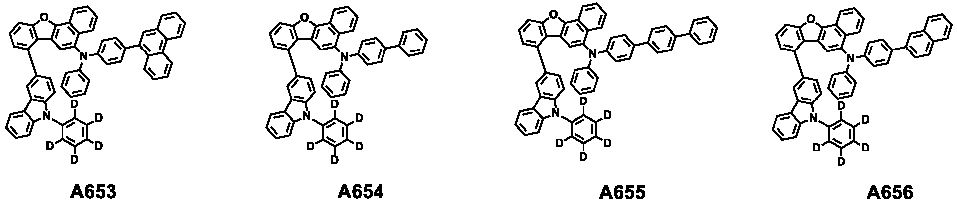

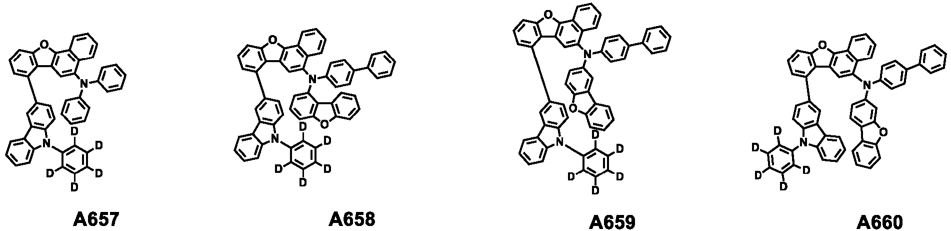

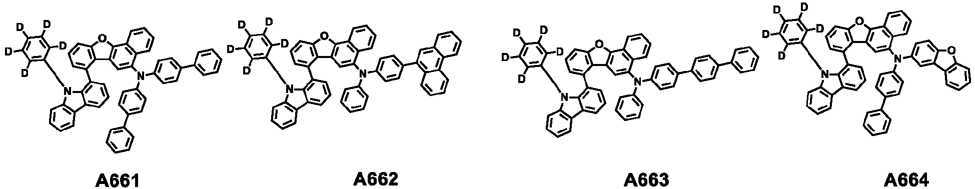

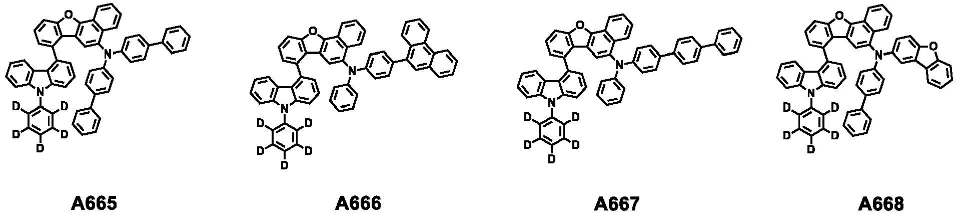

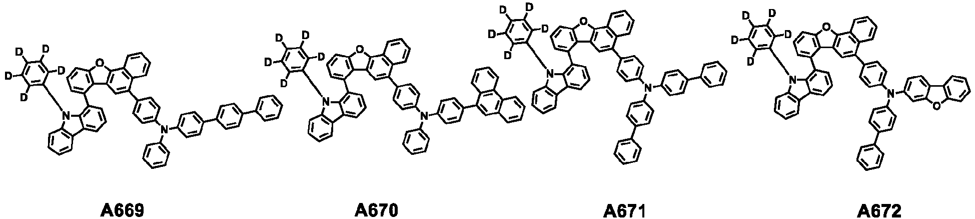

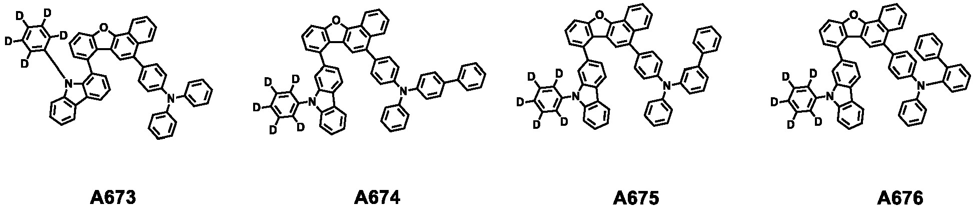

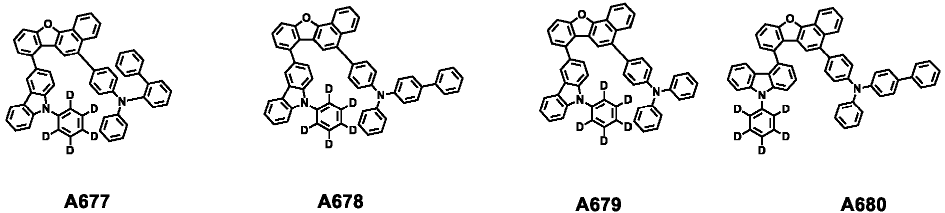

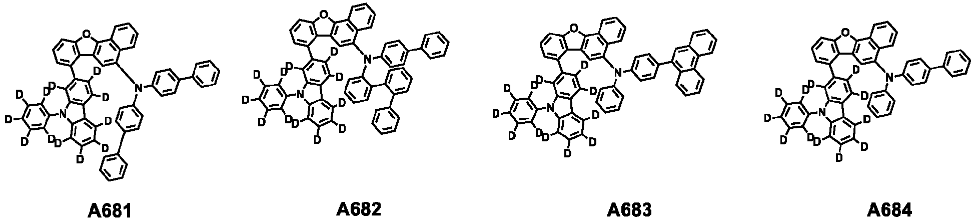

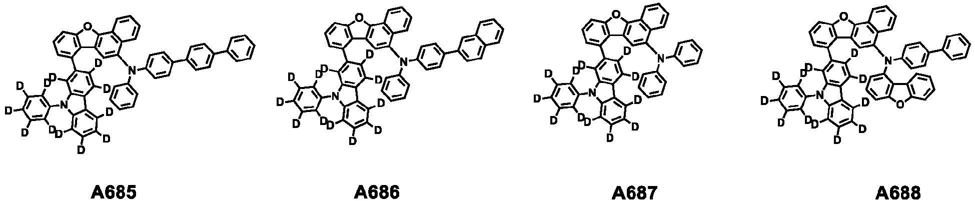

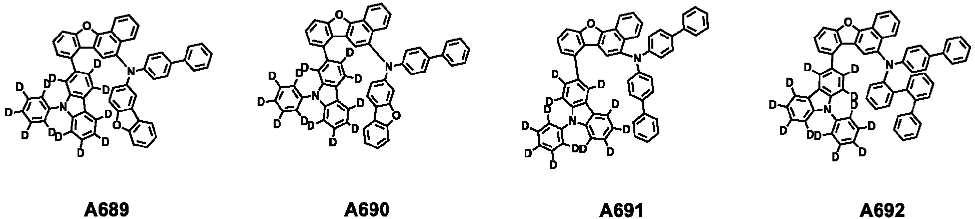

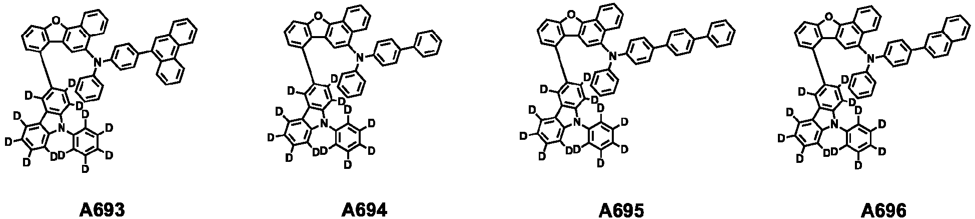

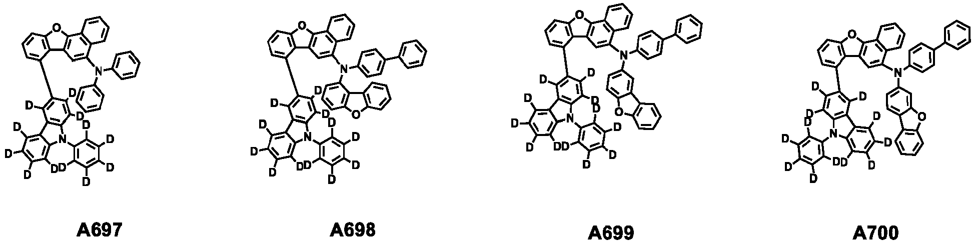

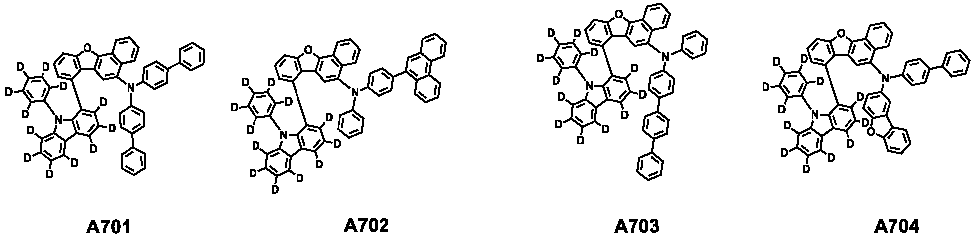

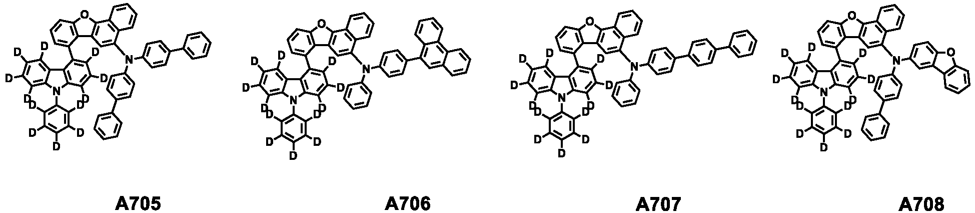

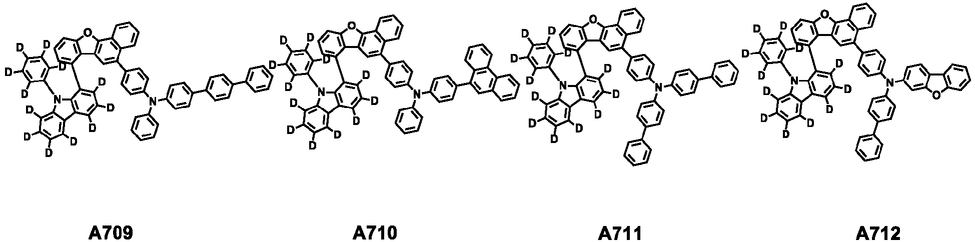

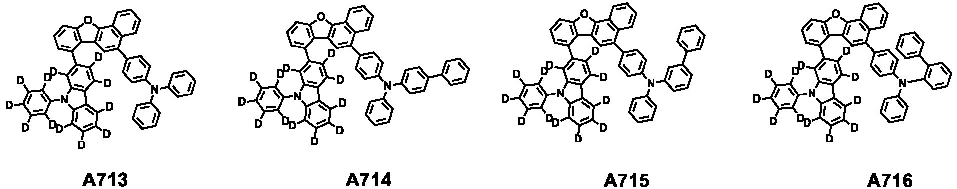

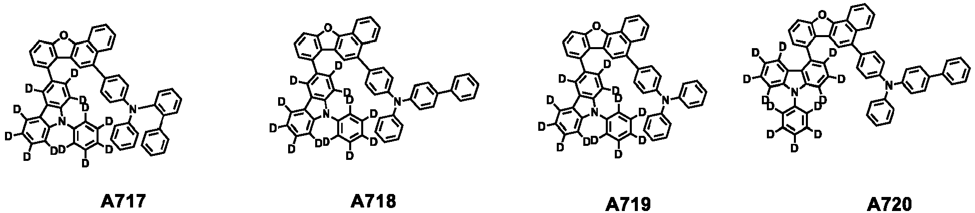

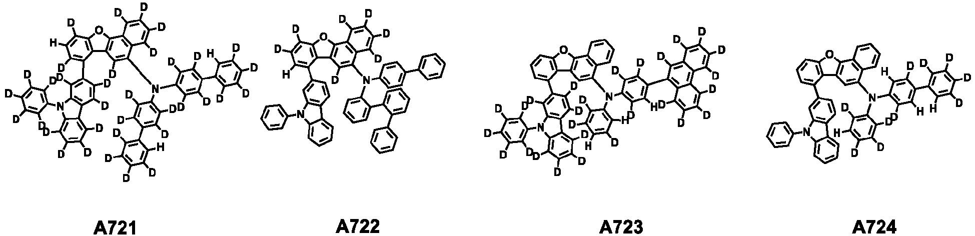

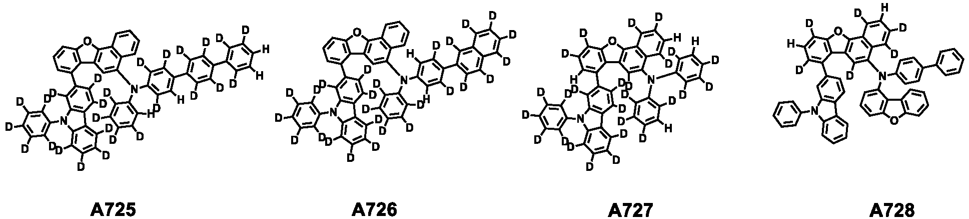

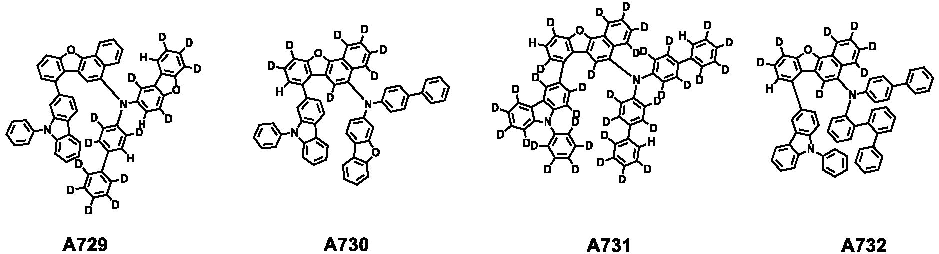

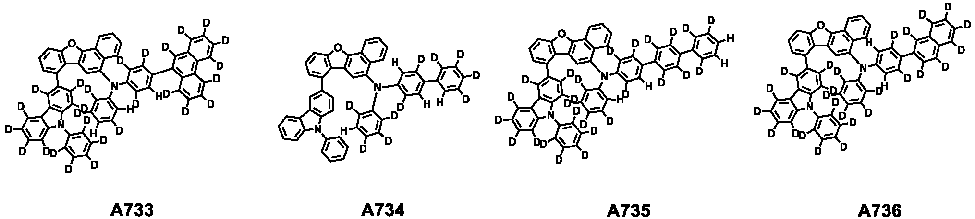

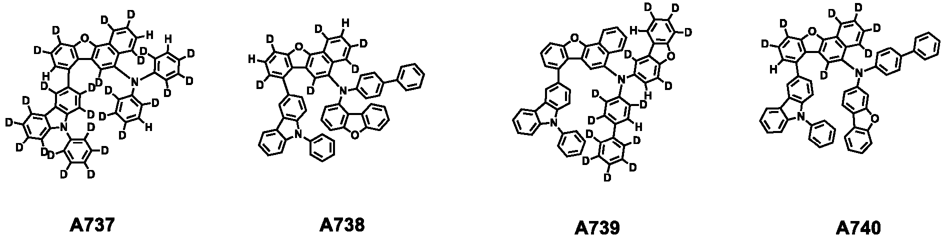

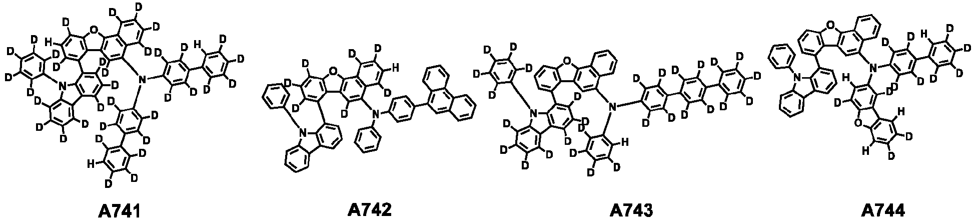

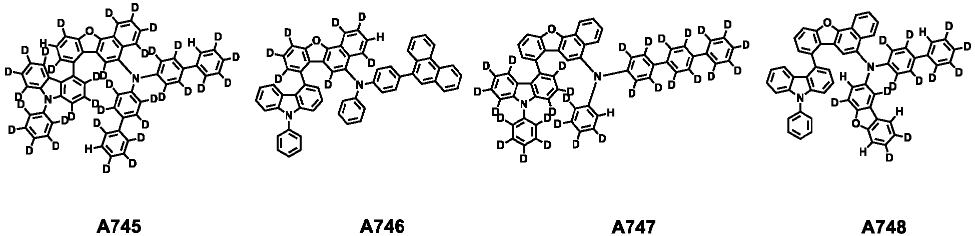

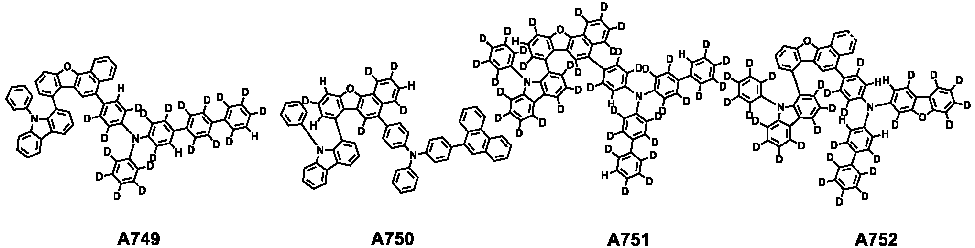

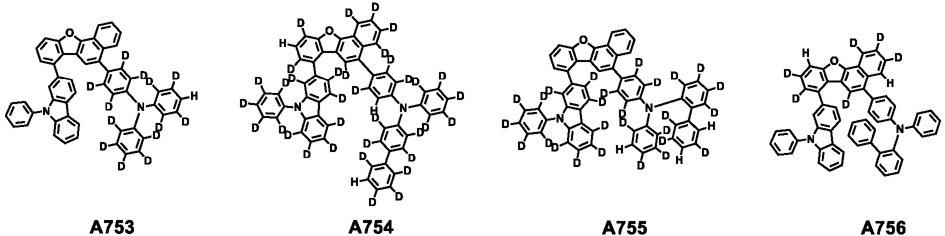

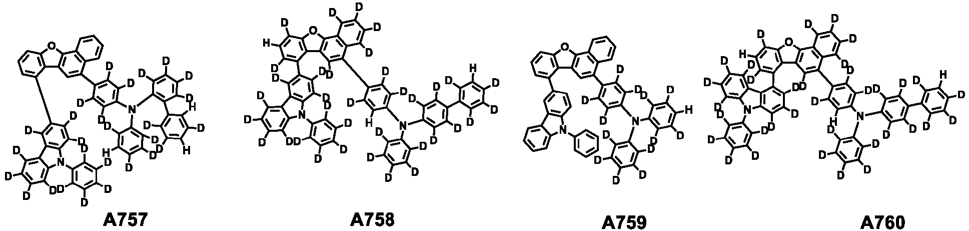

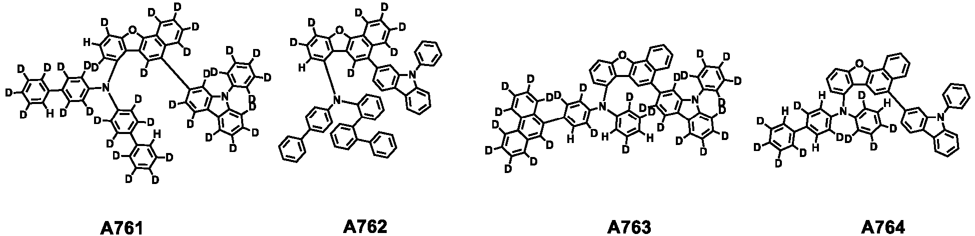

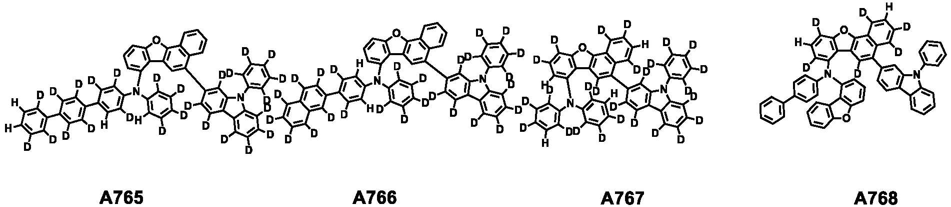

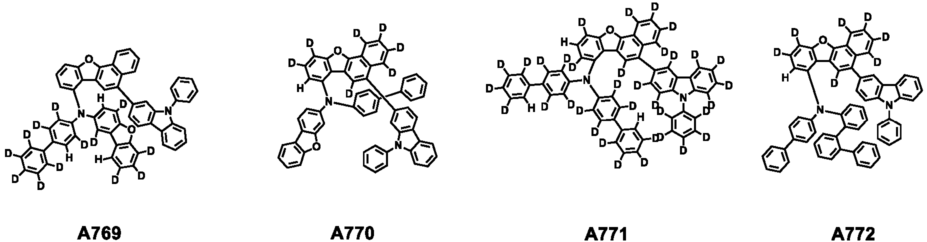

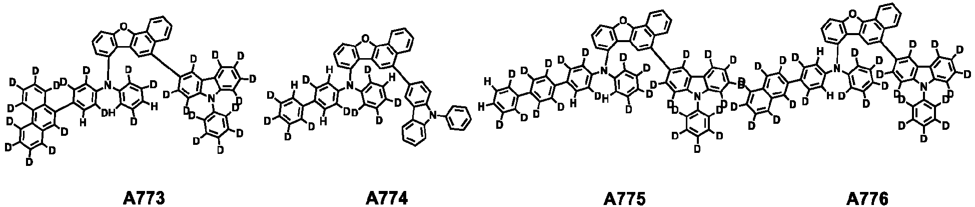

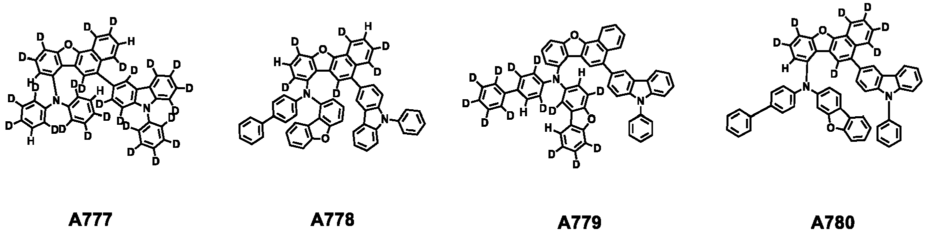

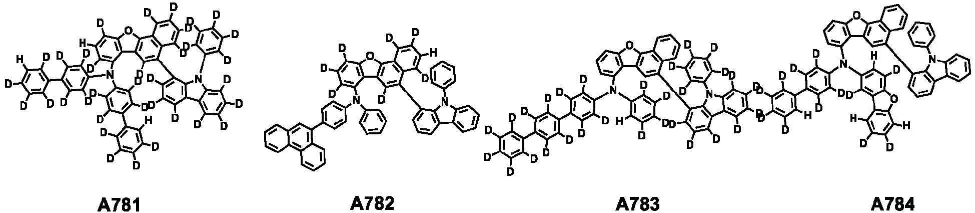

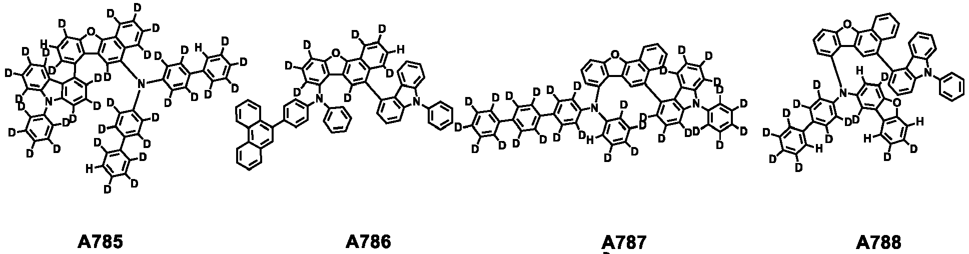

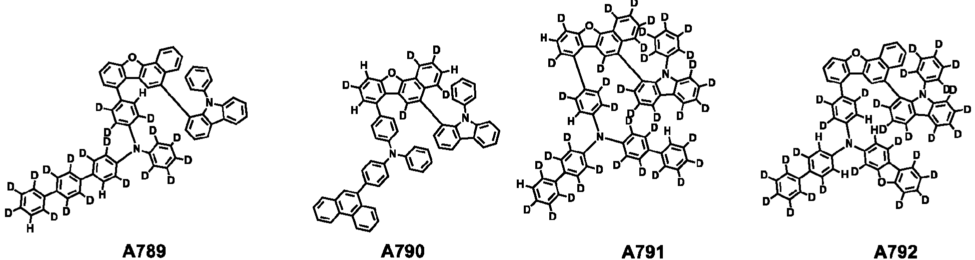

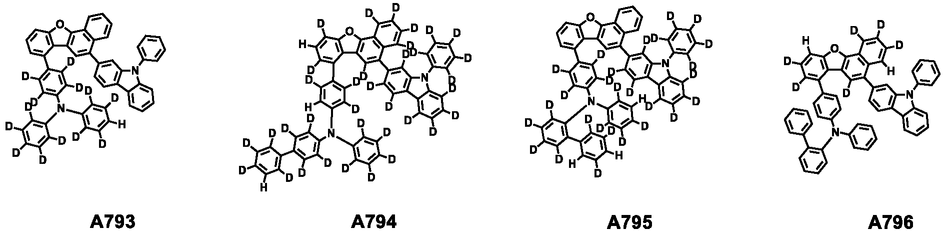

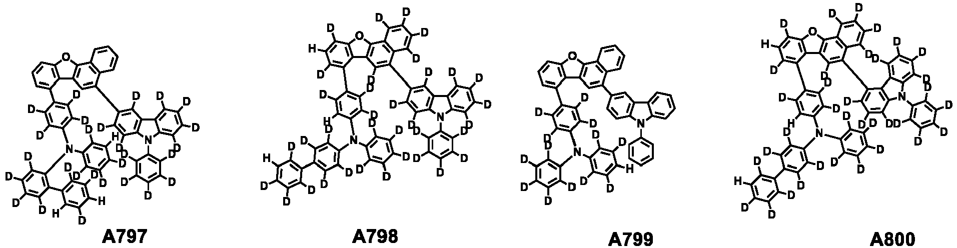

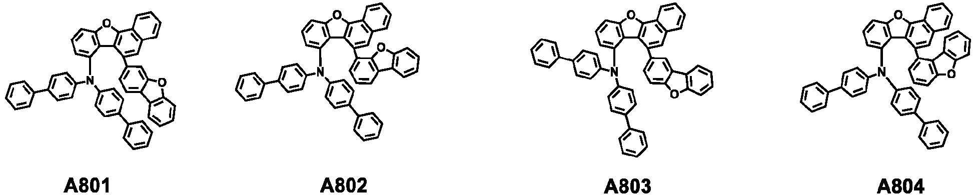

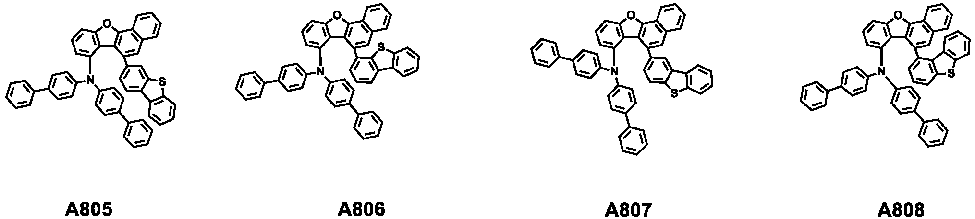

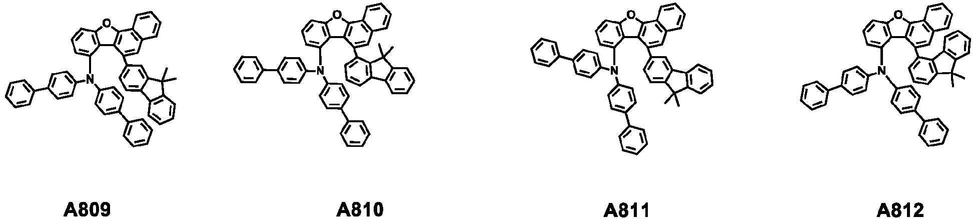

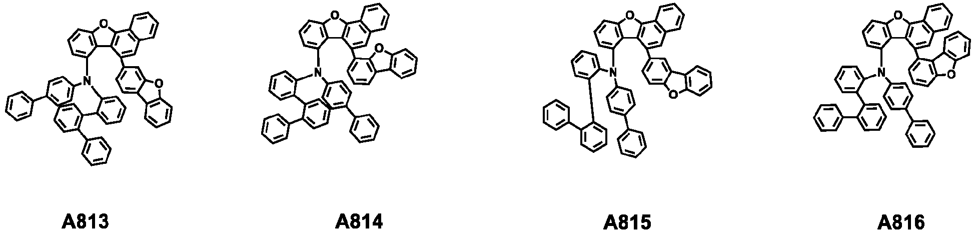

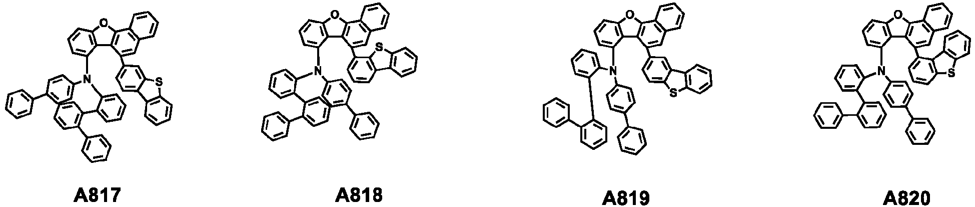

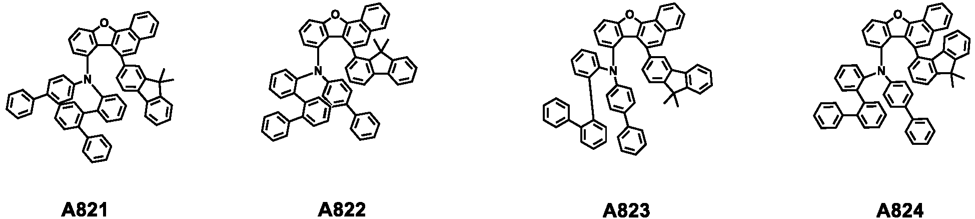

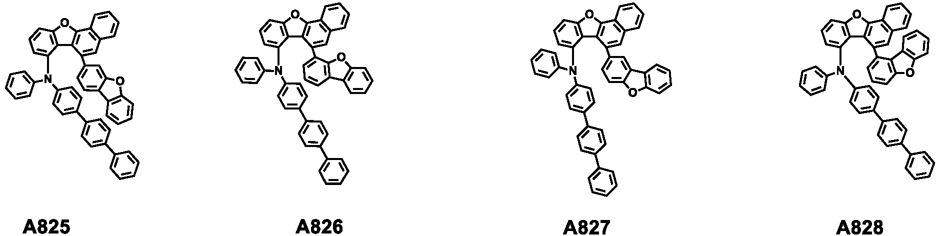

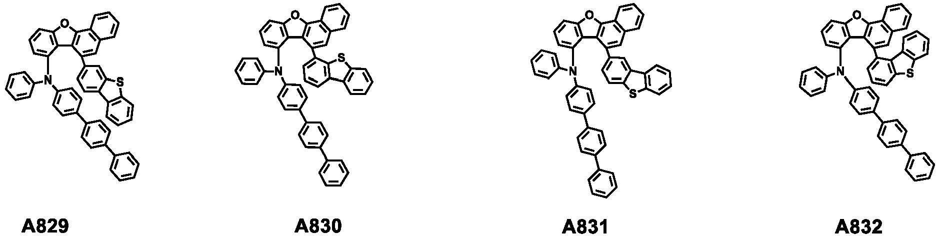

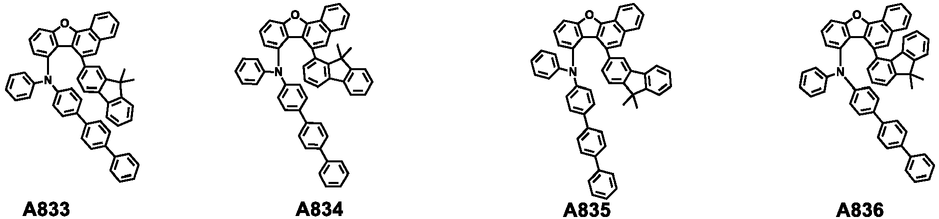

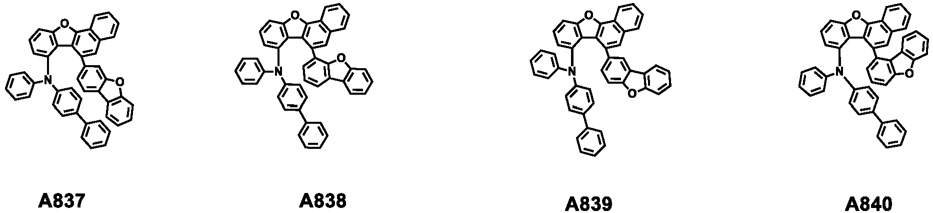

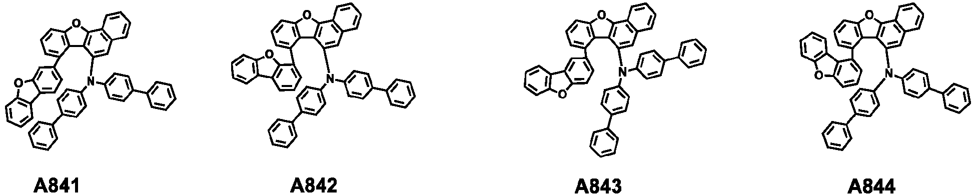

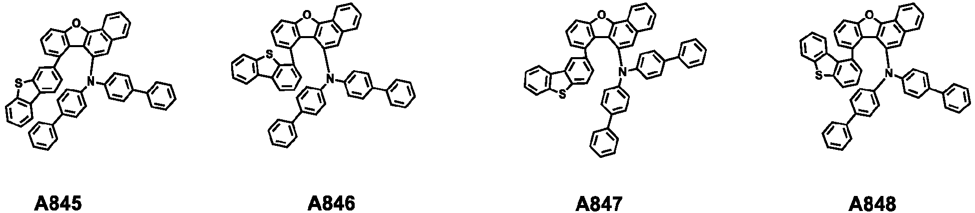

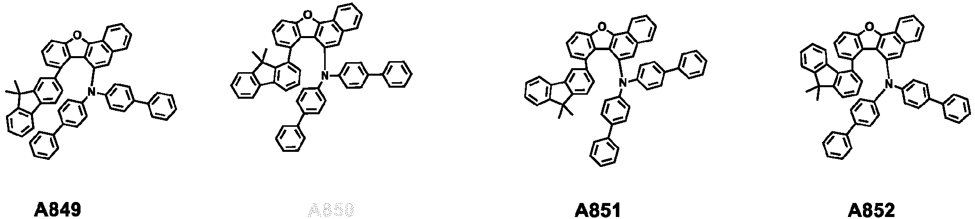

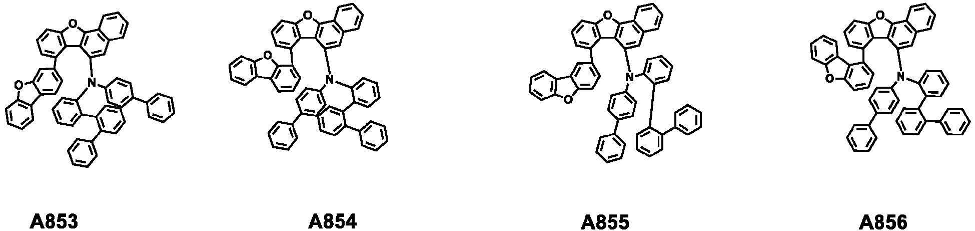

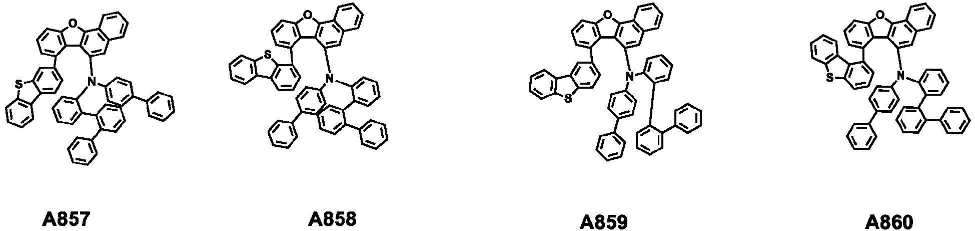

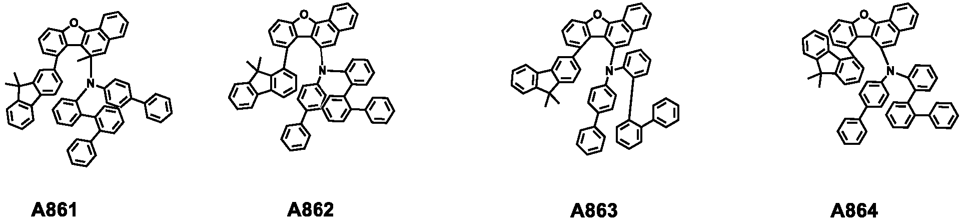

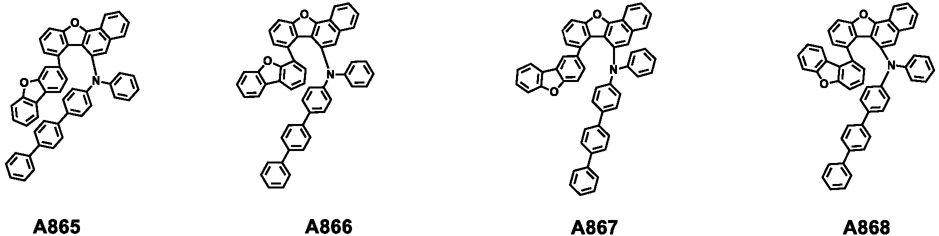

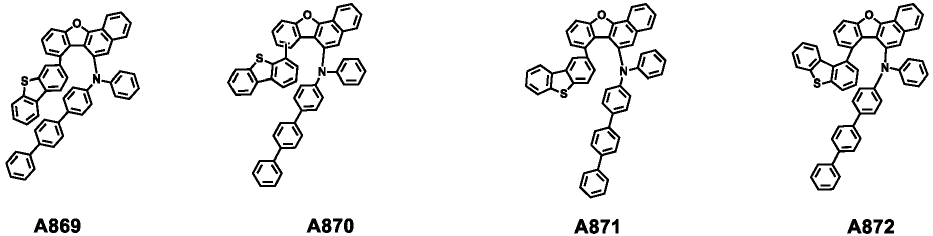

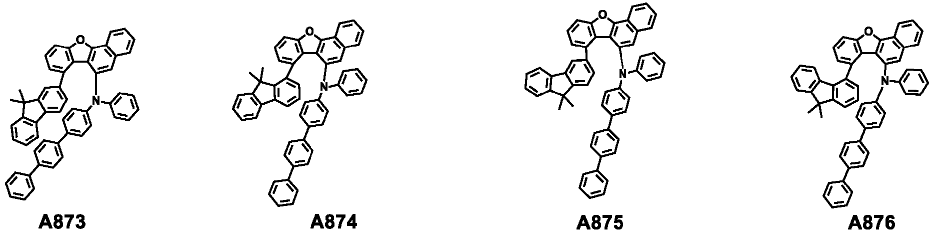

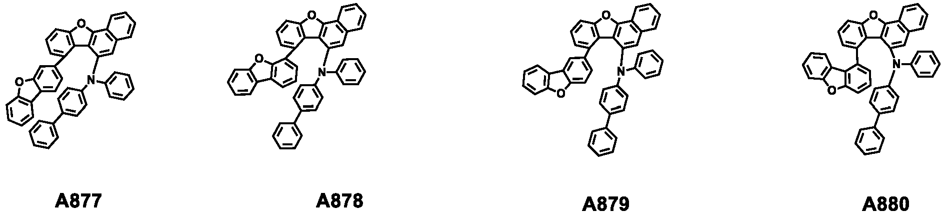

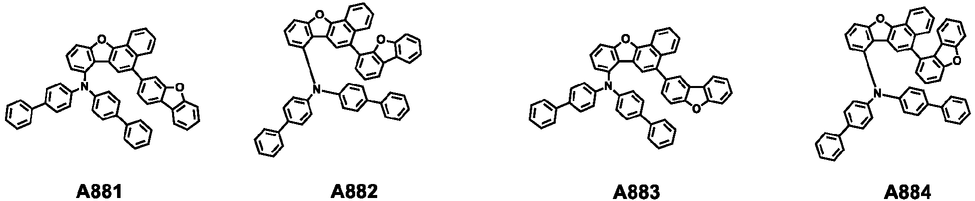

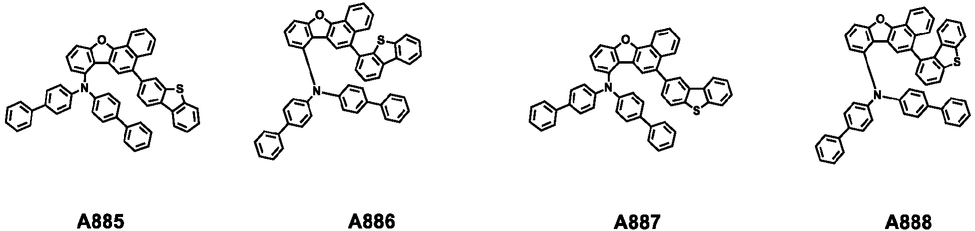

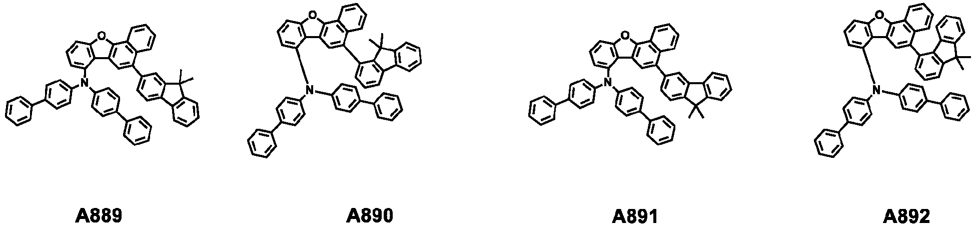

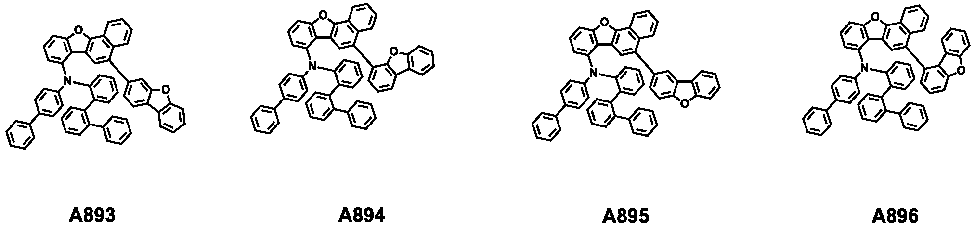

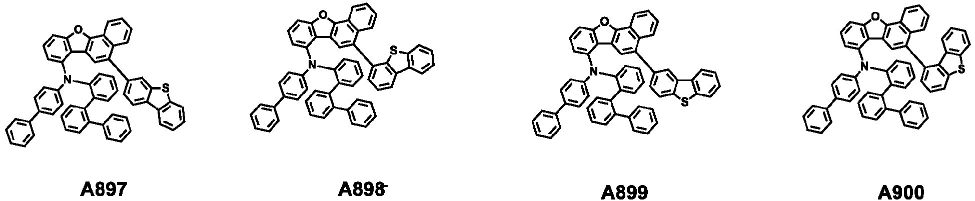

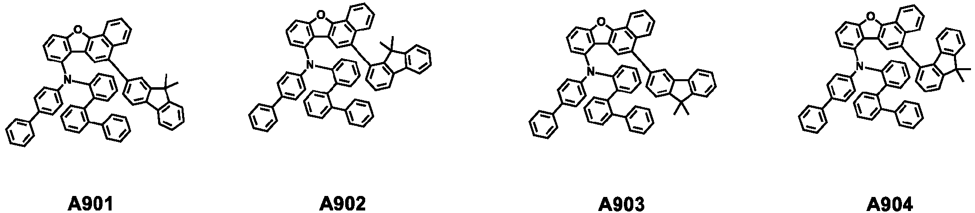

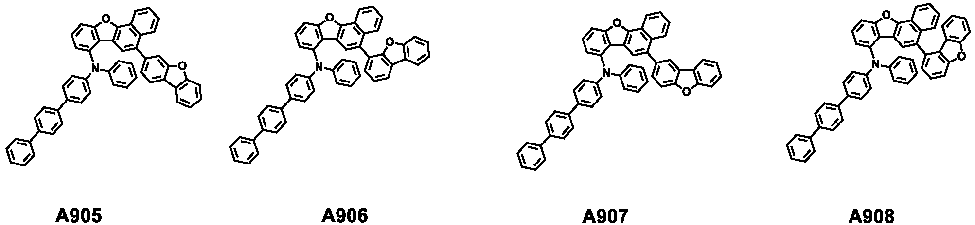

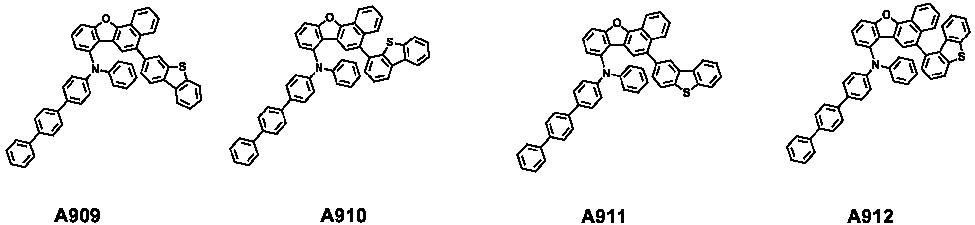

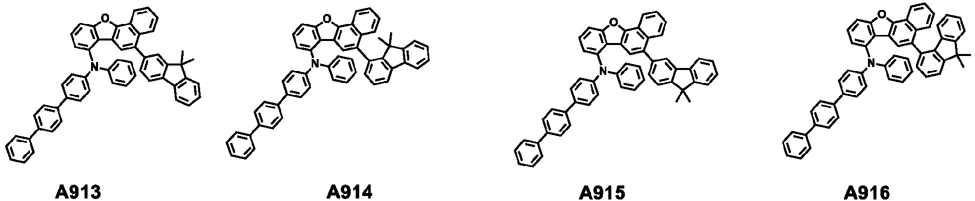

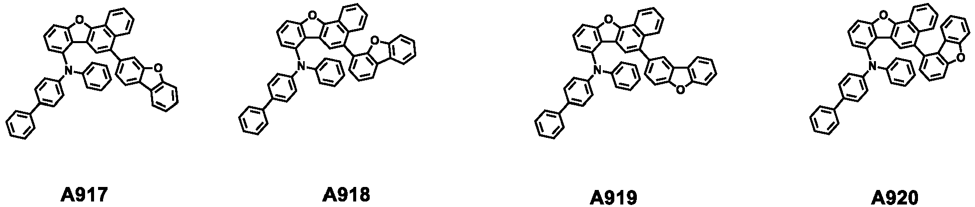

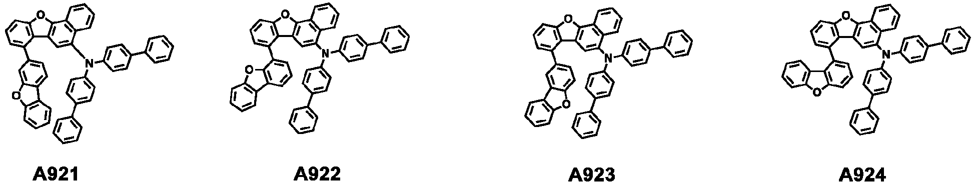

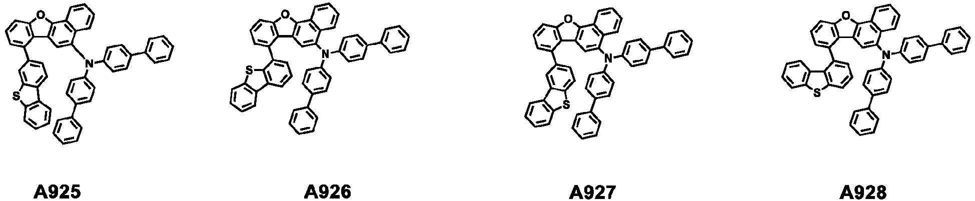

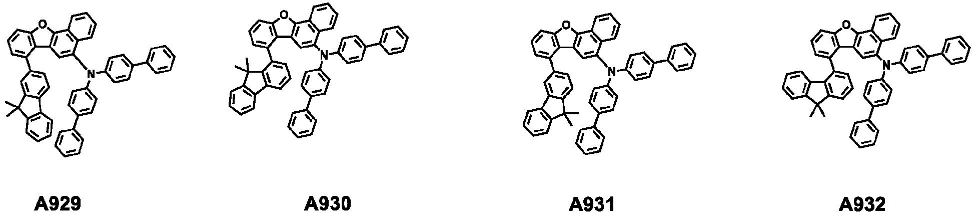

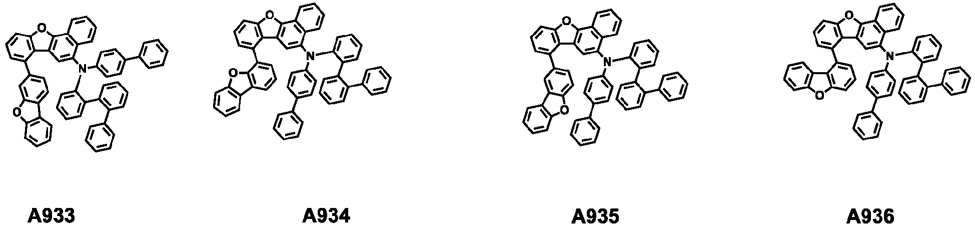

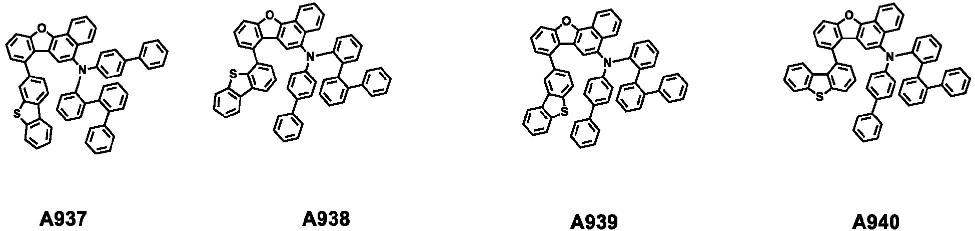

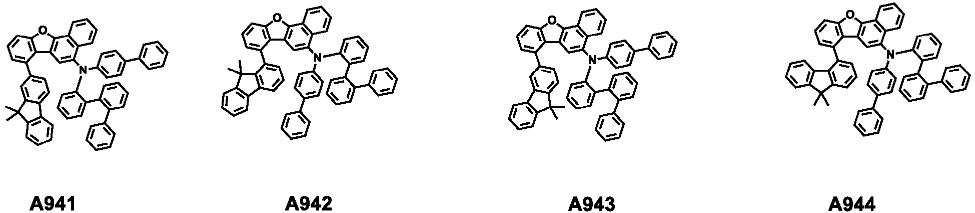

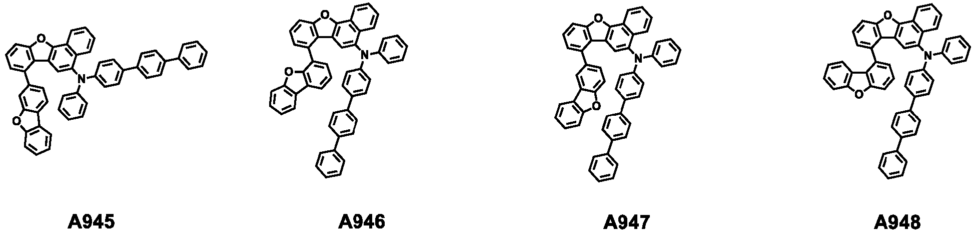

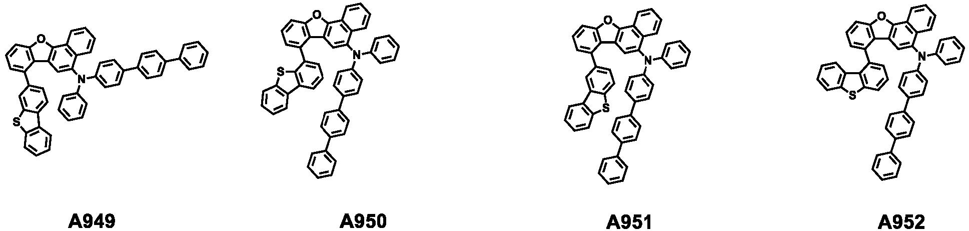

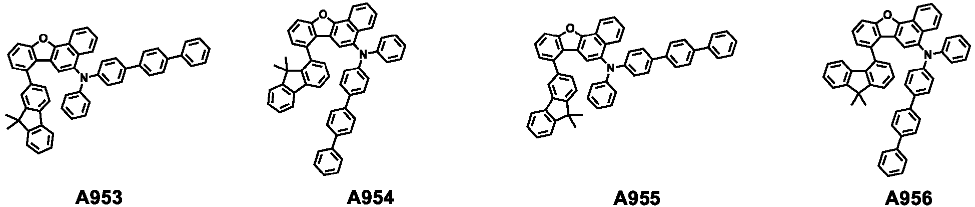

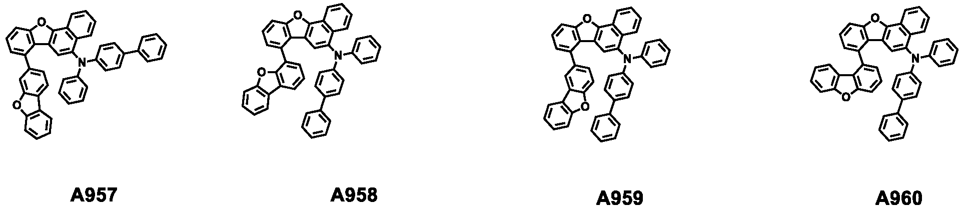

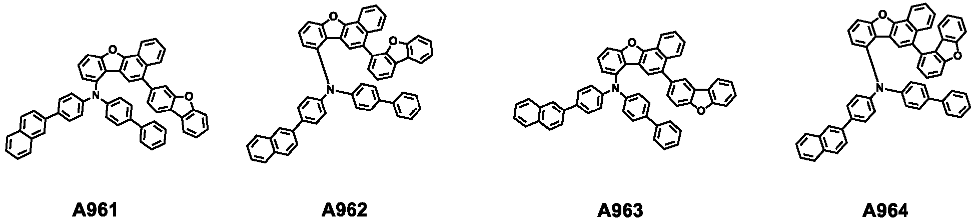

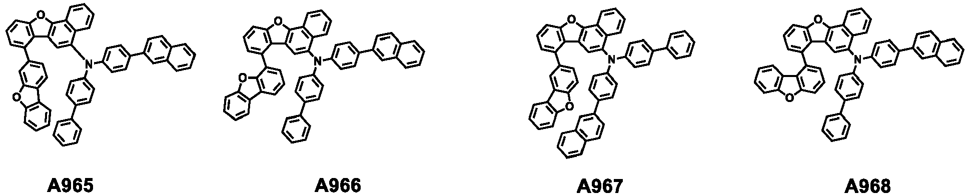

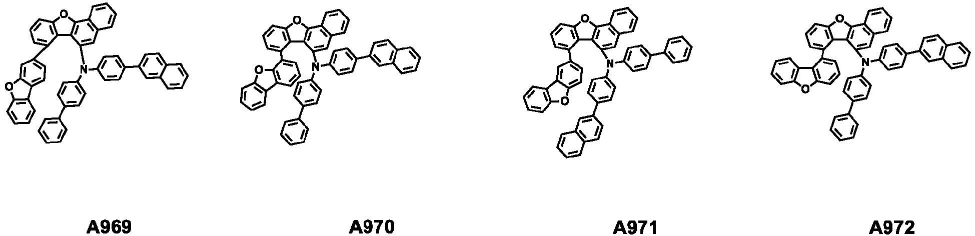

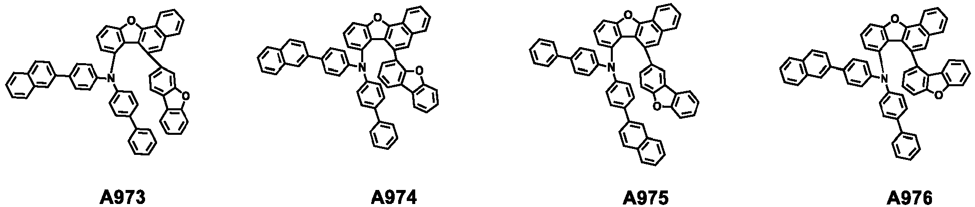

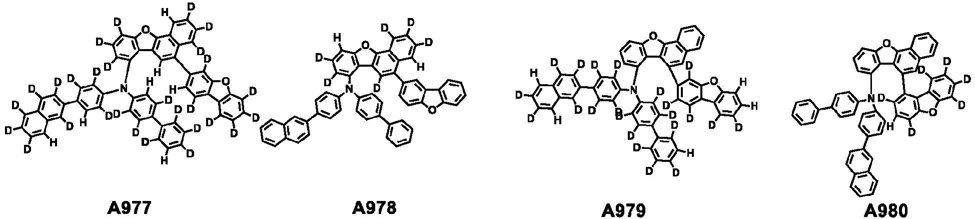

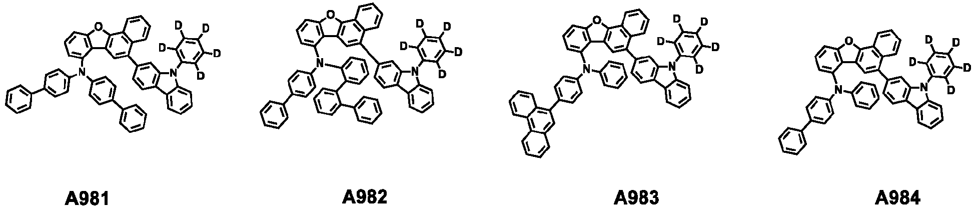

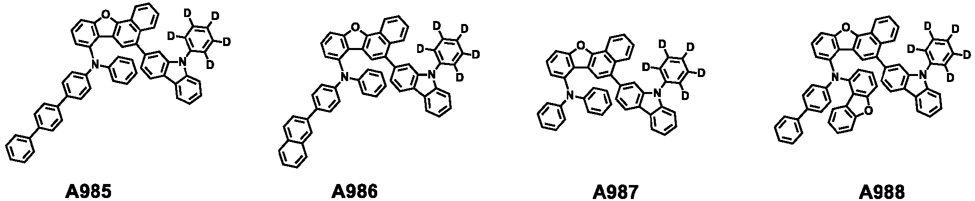

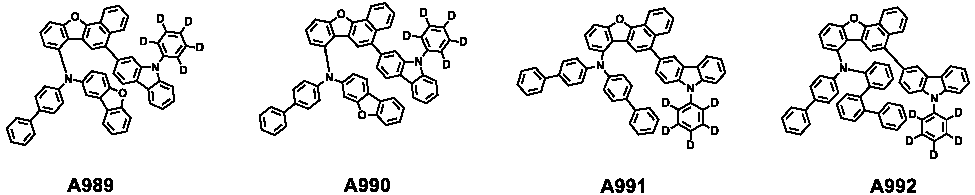

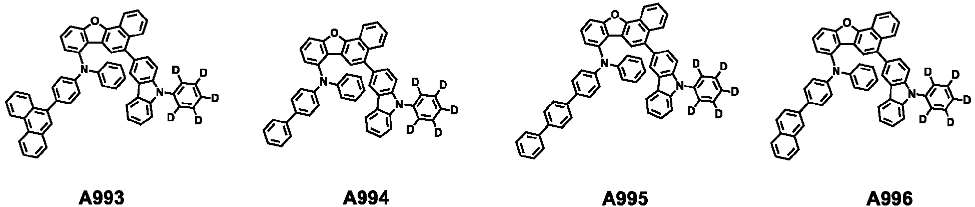

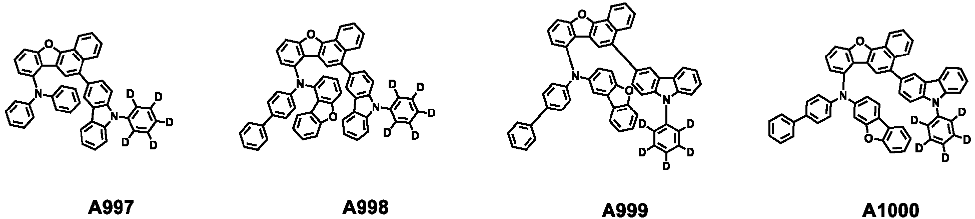

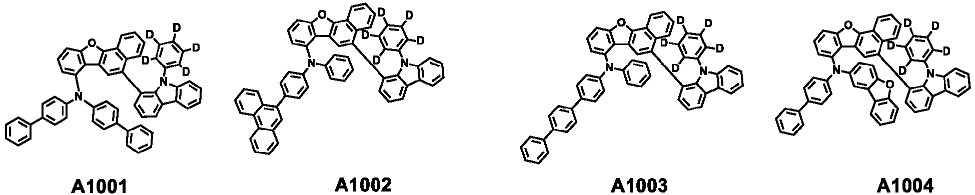

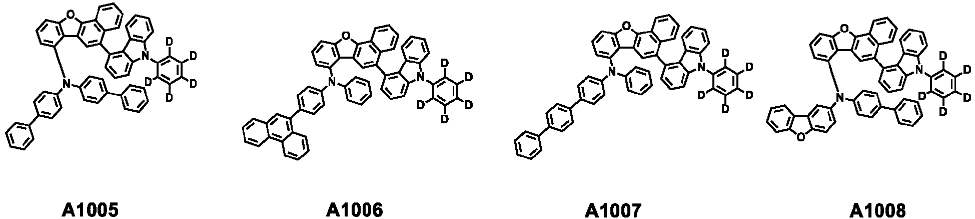

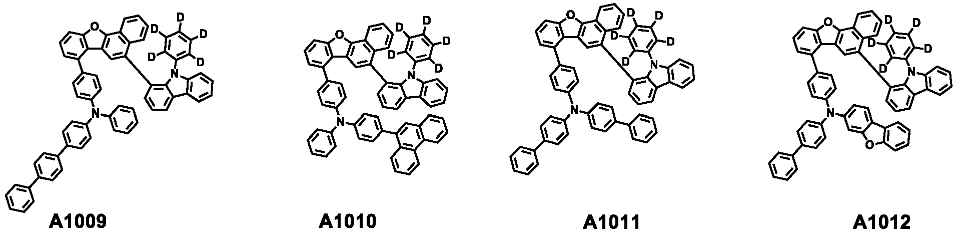

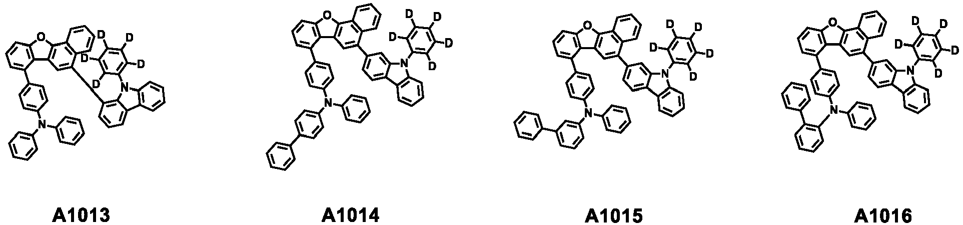

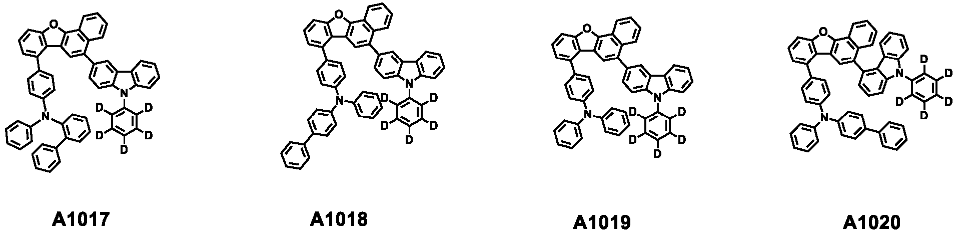

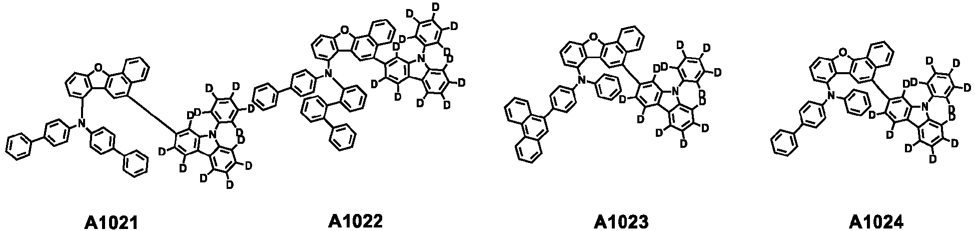

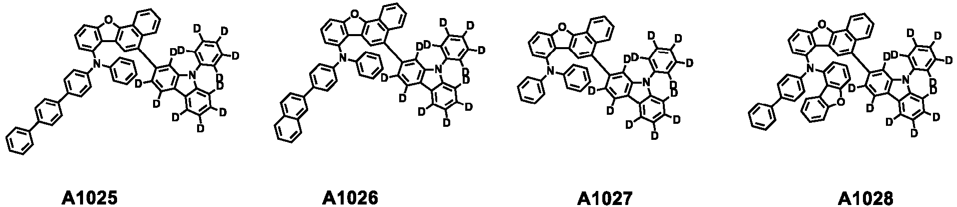

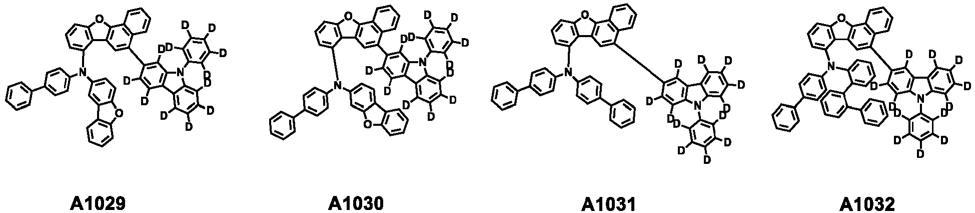

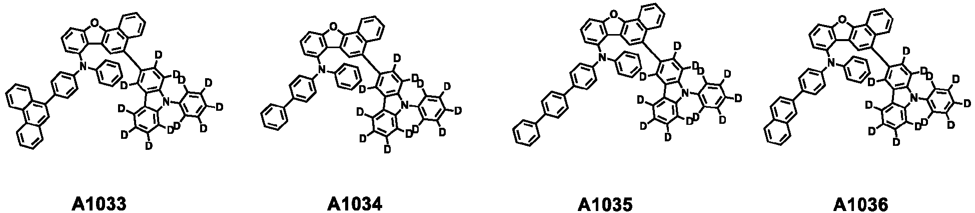

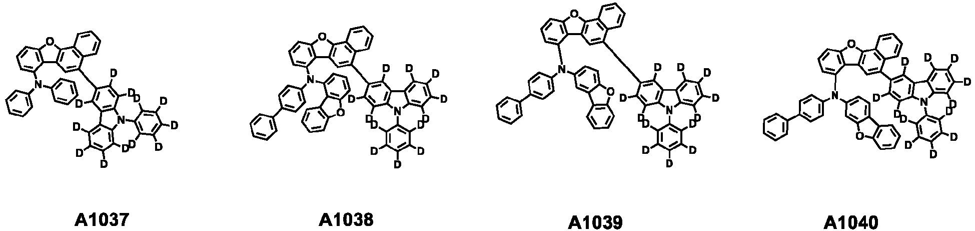

According to an exemplary embodiment of the present specification, Chemical Formula B may be represented by any one of the following heterocyclic compounds.

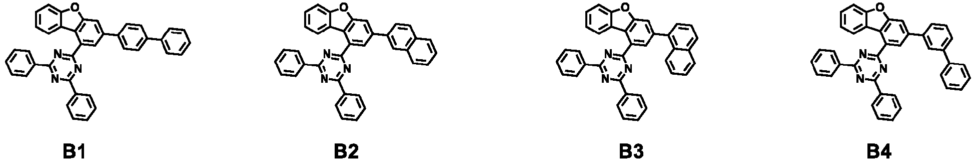

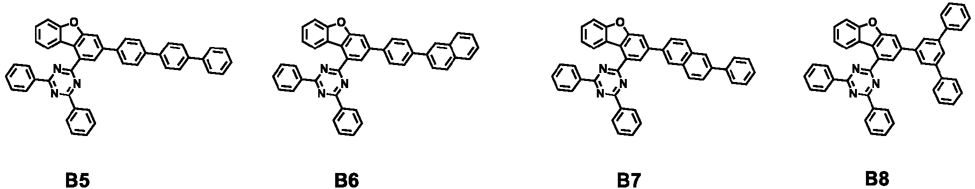

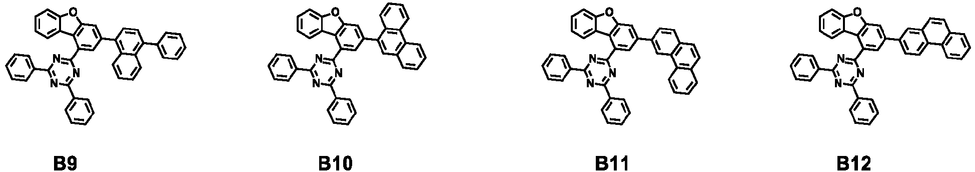

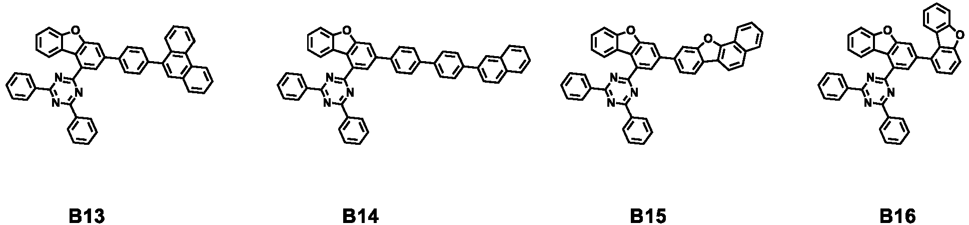

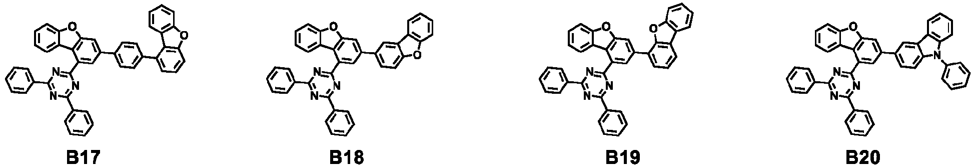

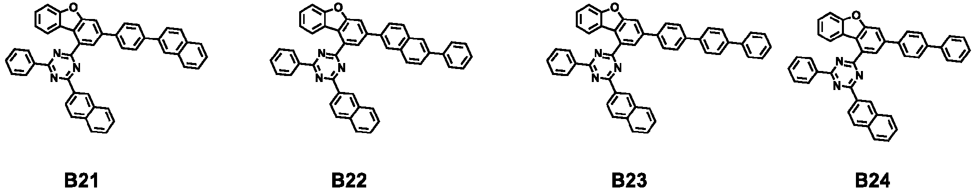

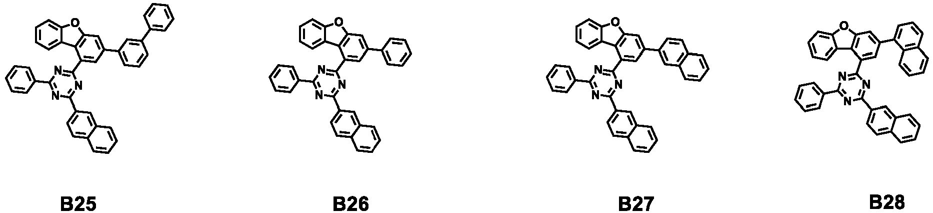

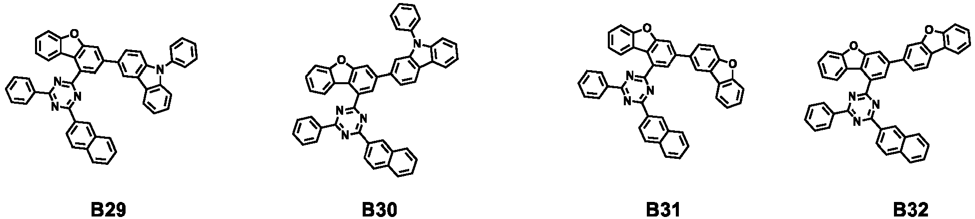

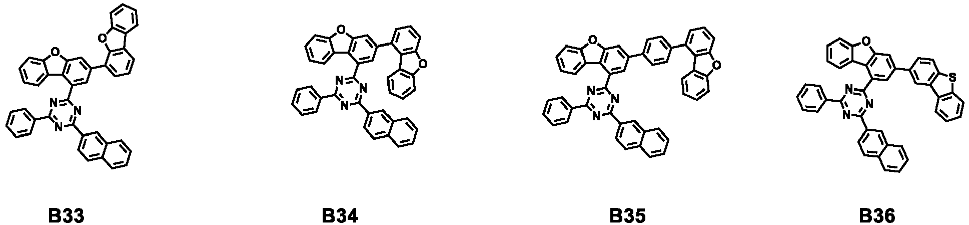

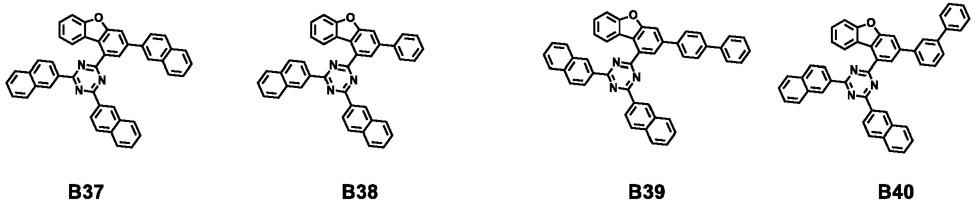

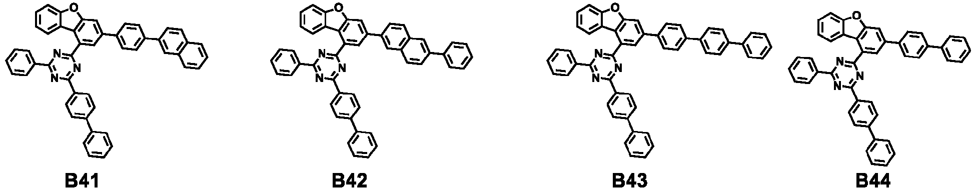

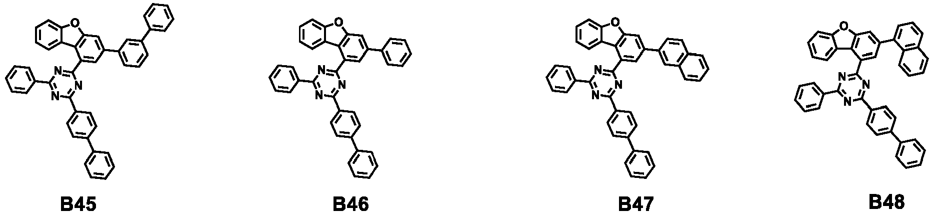

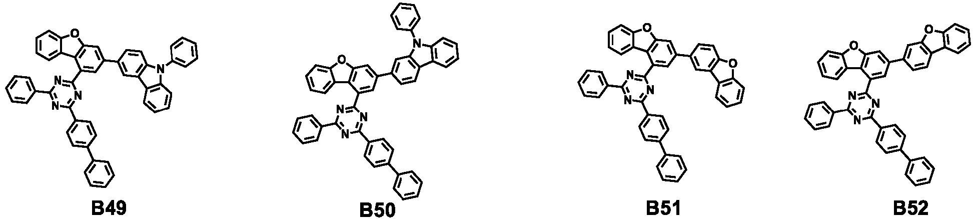

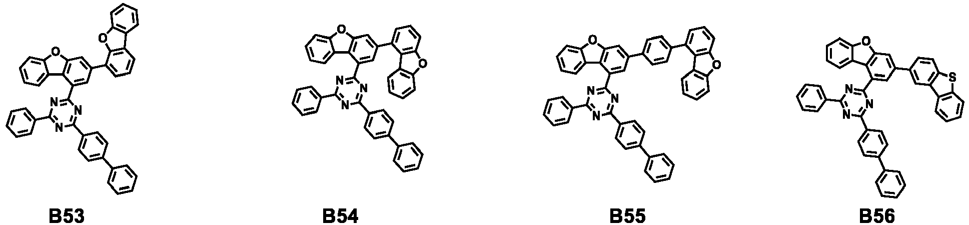

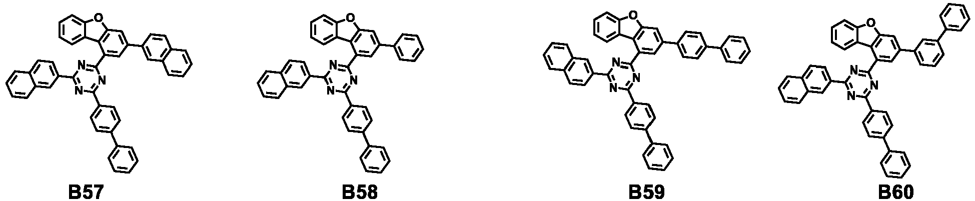

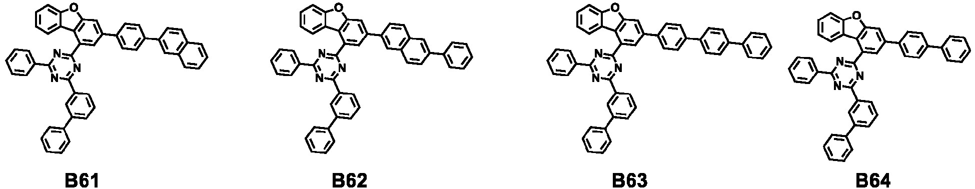

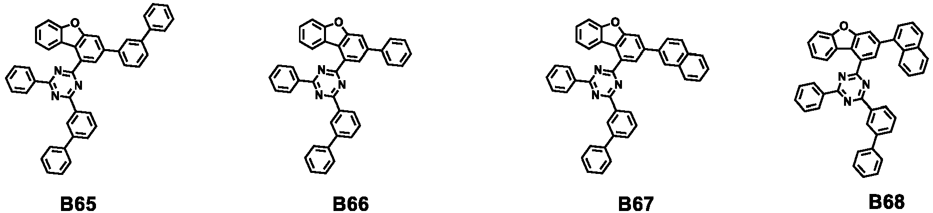

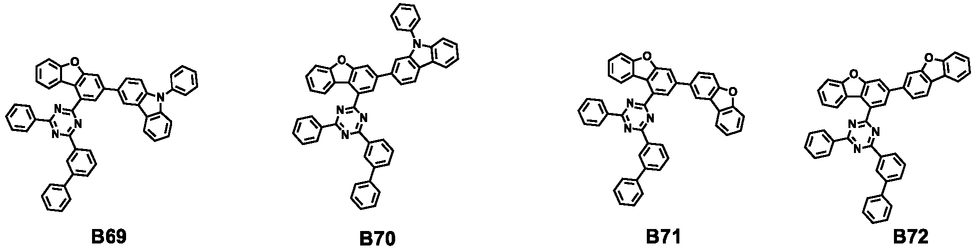

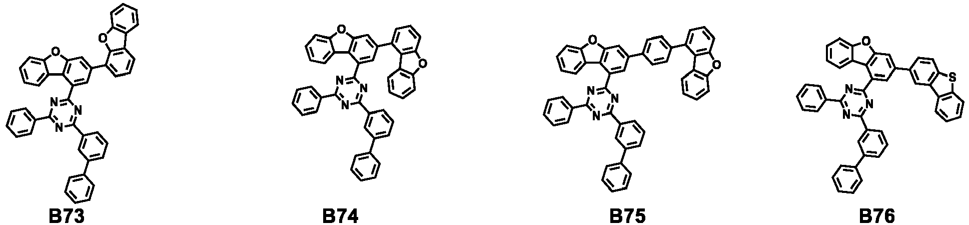

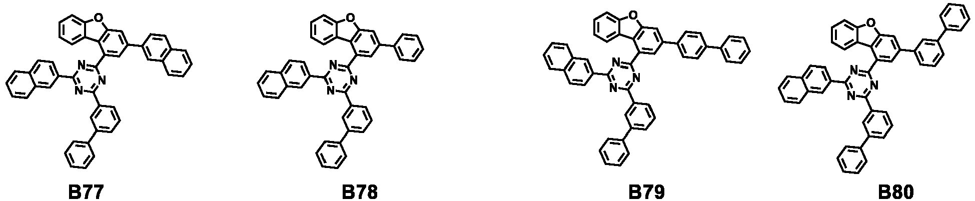

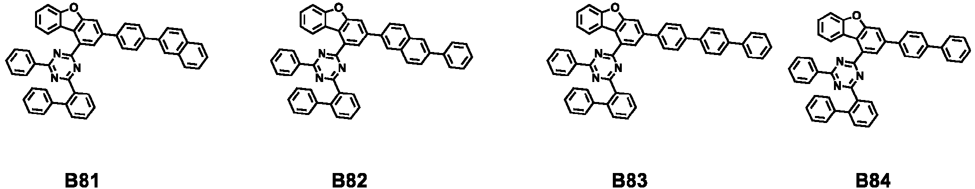

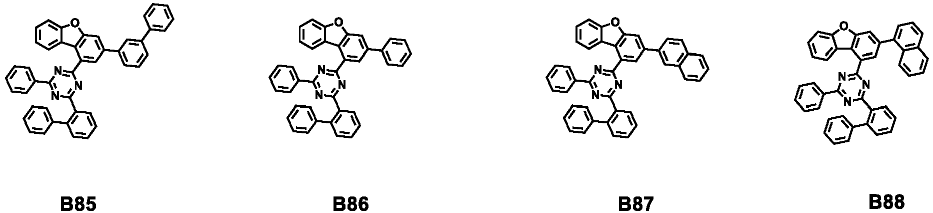

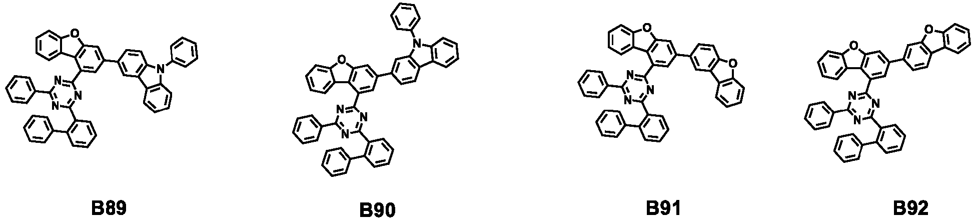

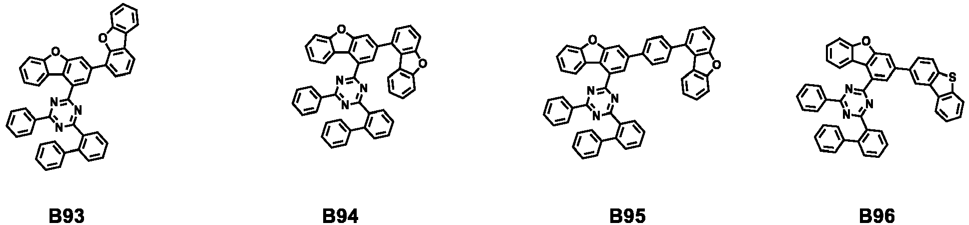

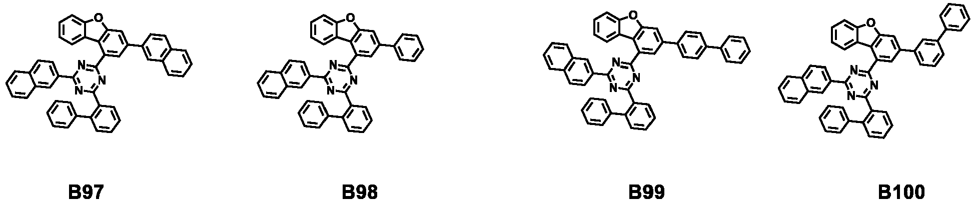

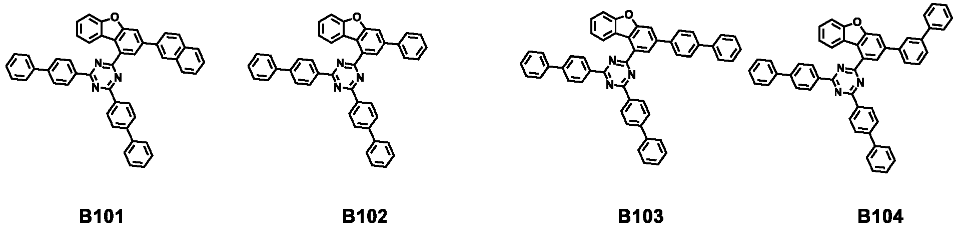

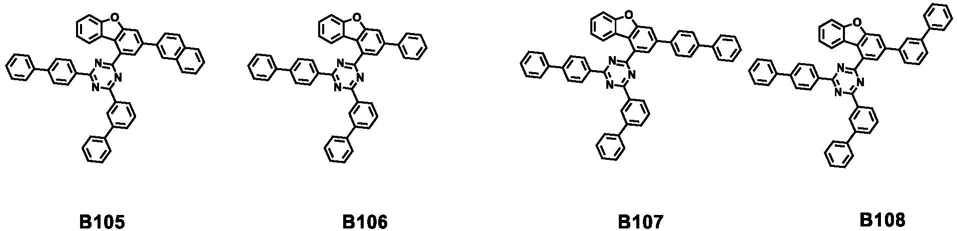

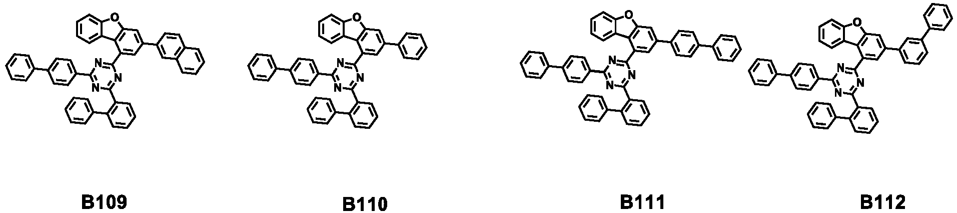

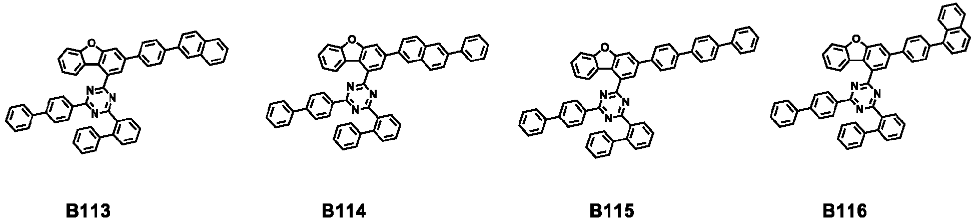

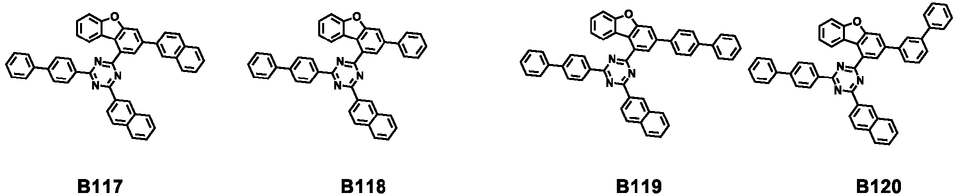

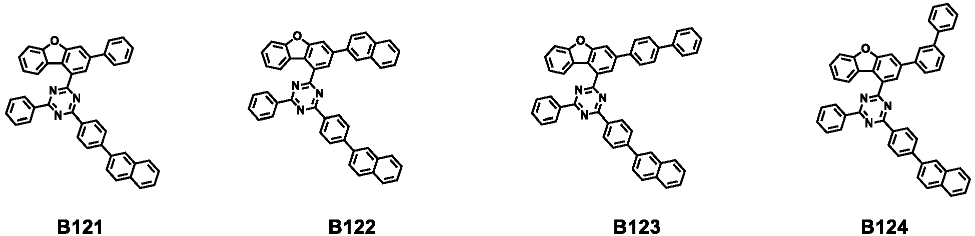

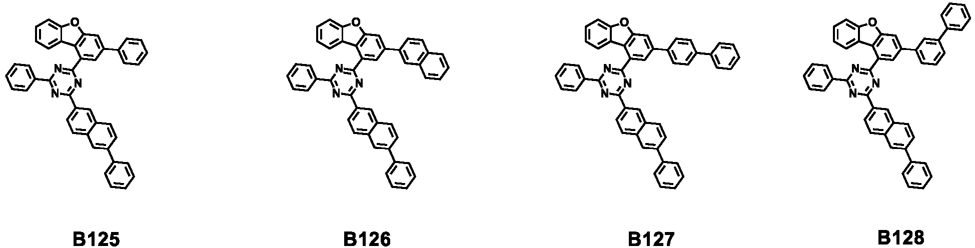

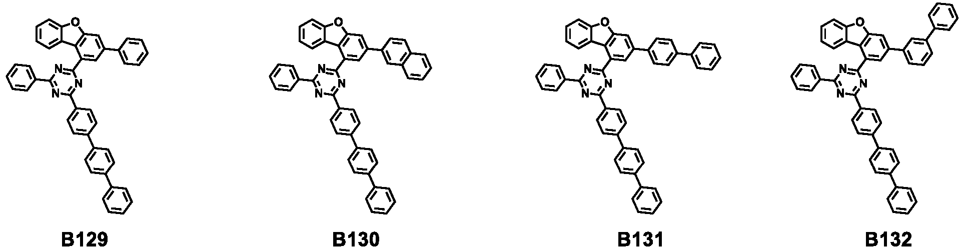

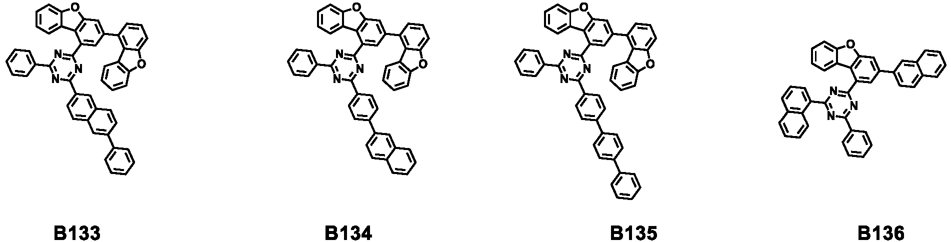

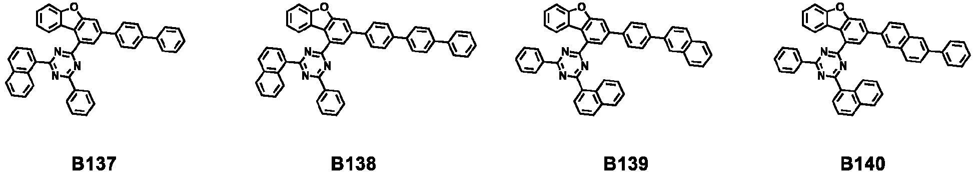

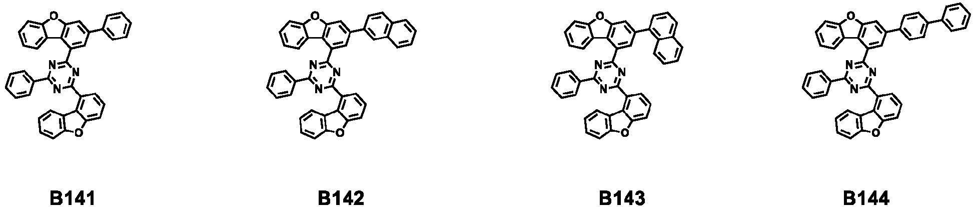

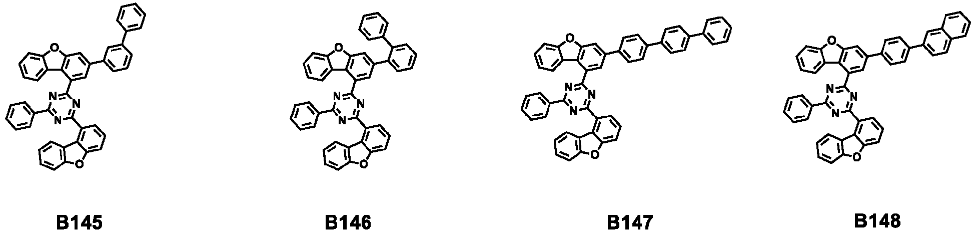

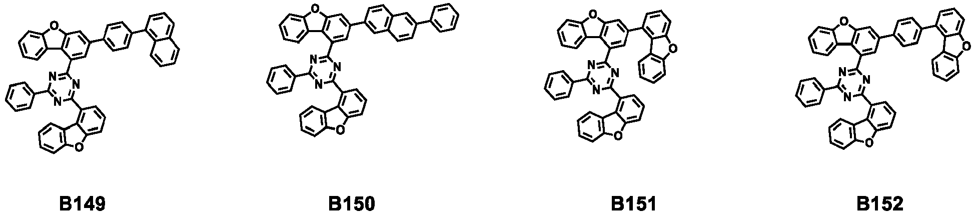

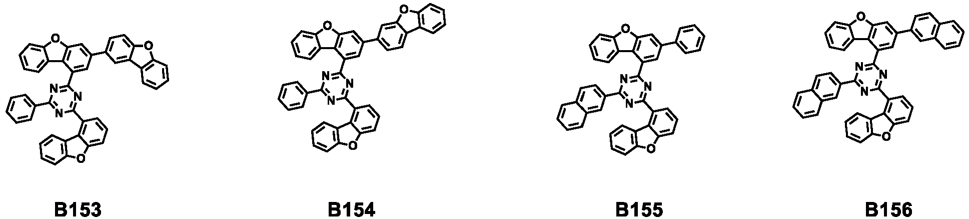

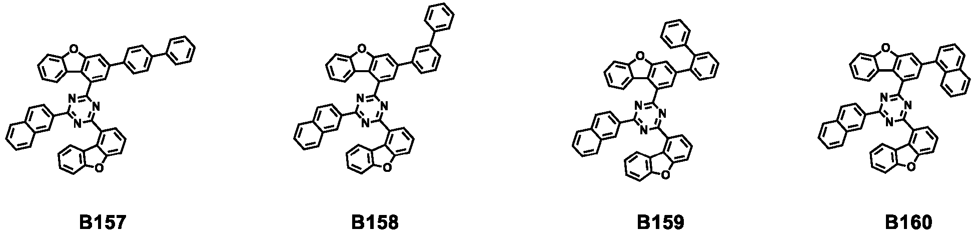

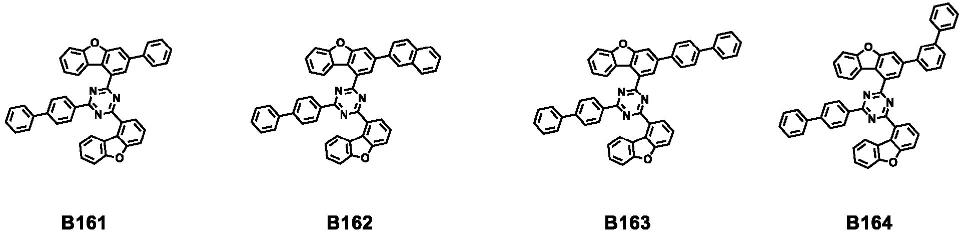

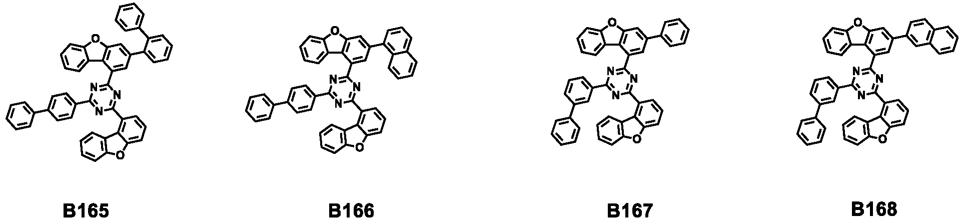

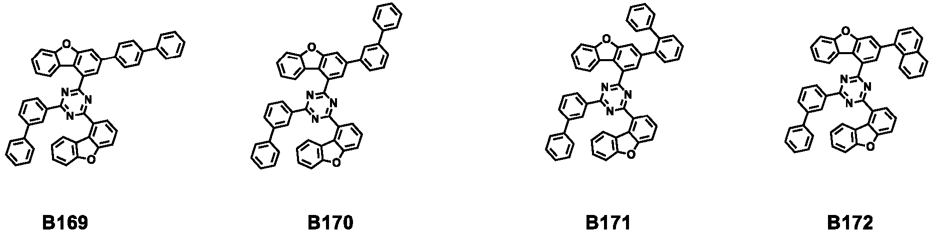

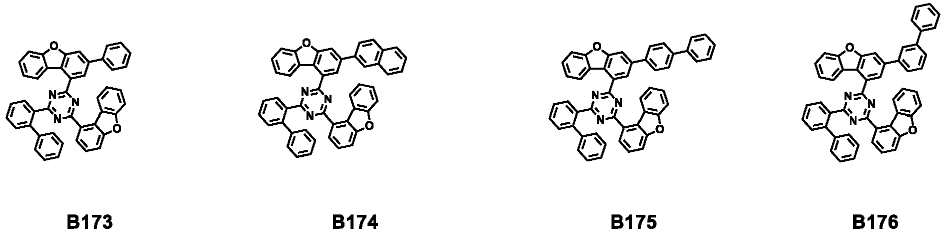

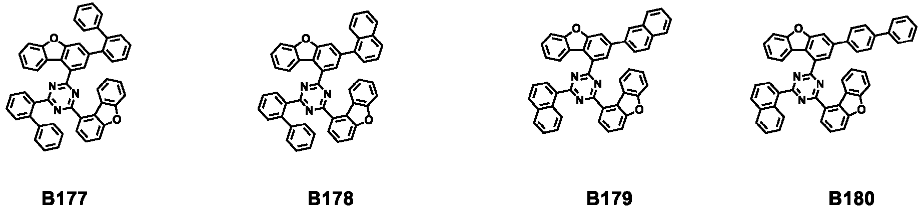

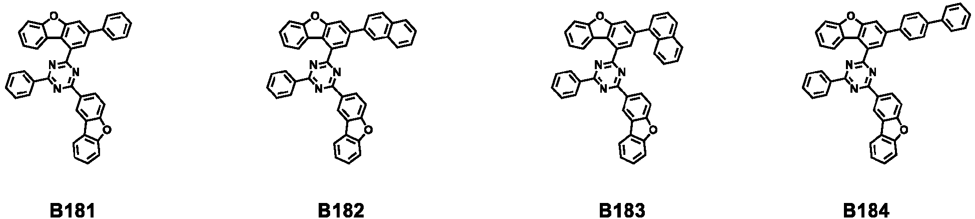

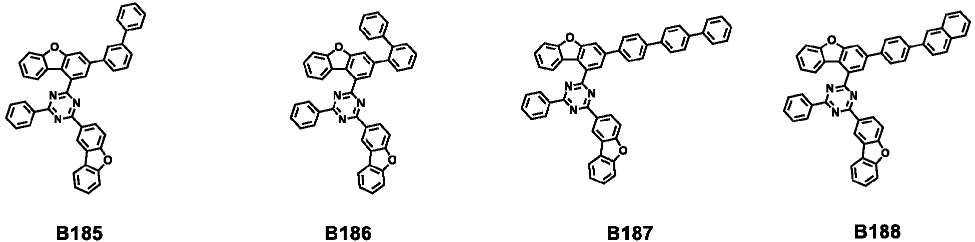

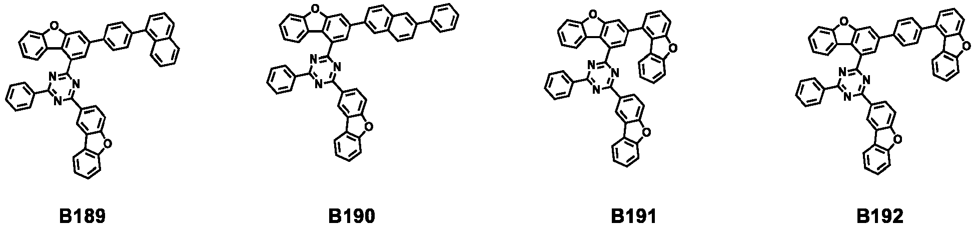

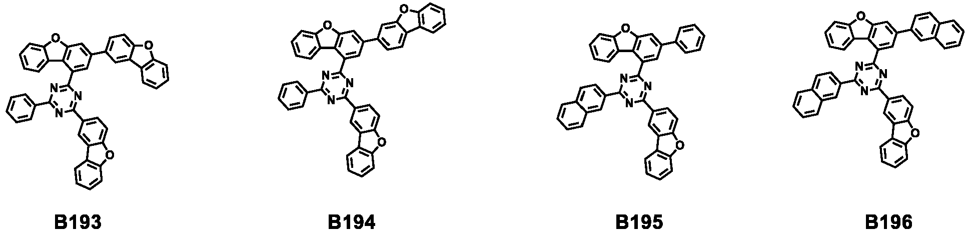

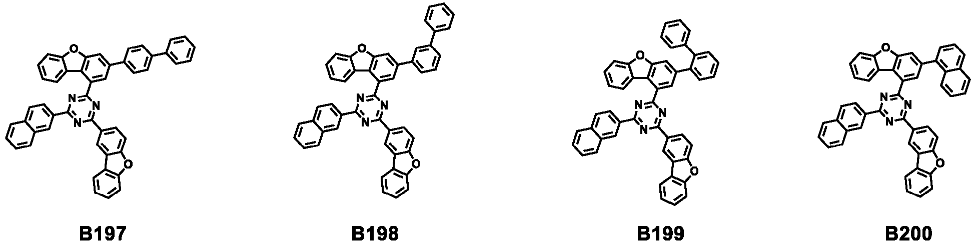

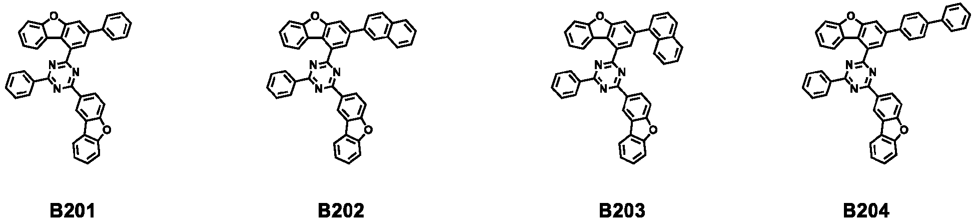

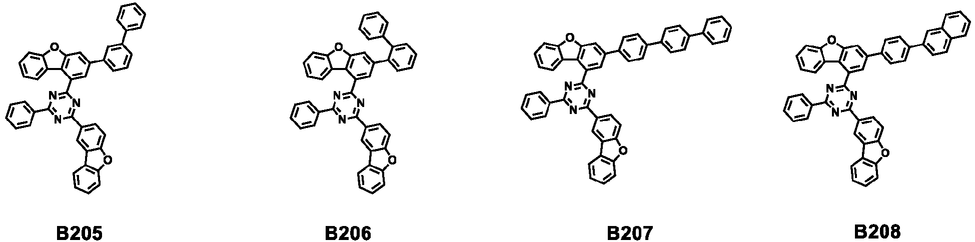

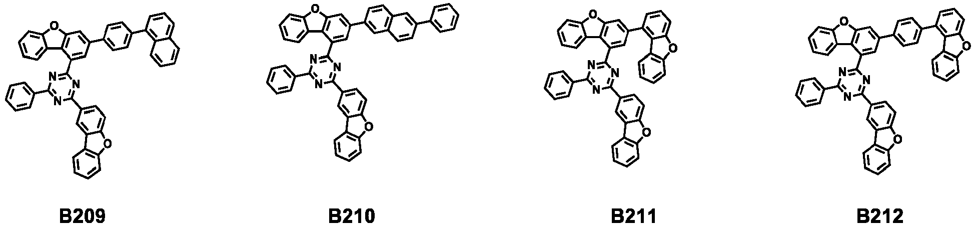

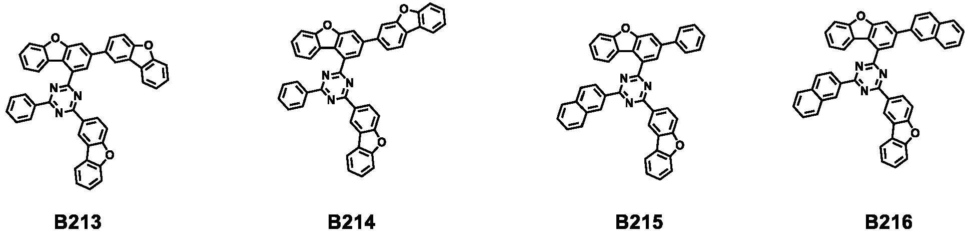

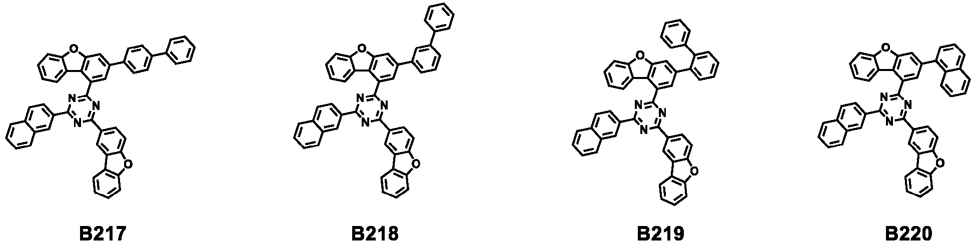

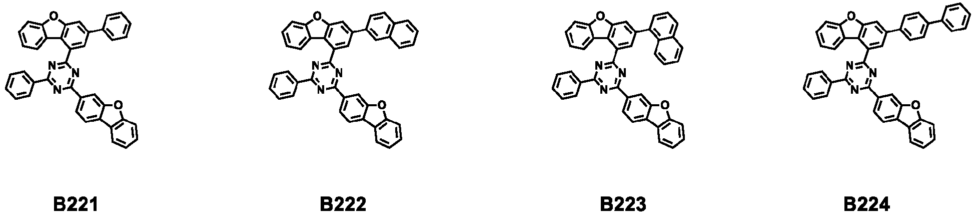

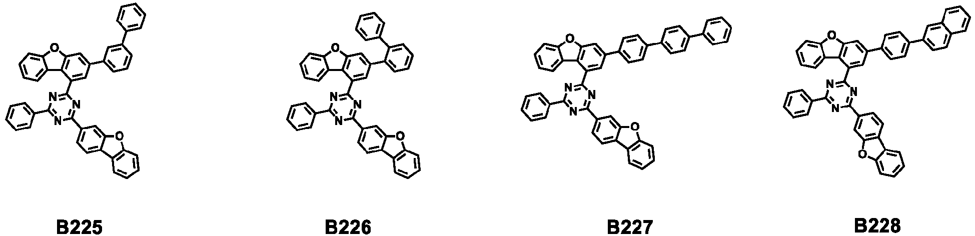

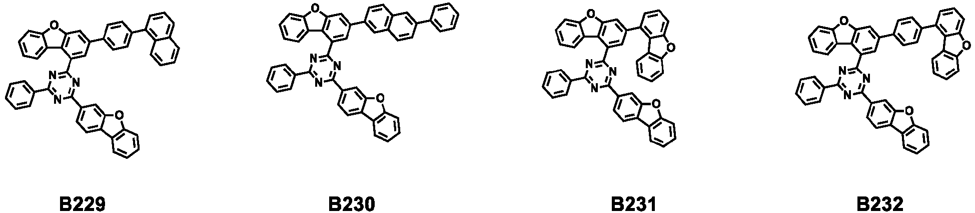

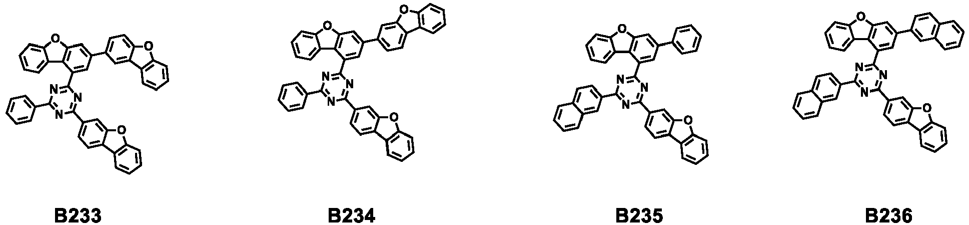

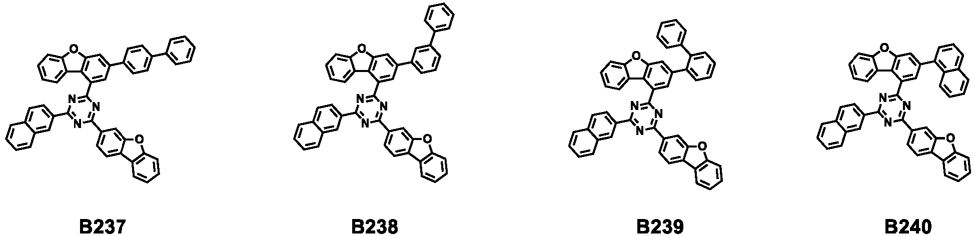

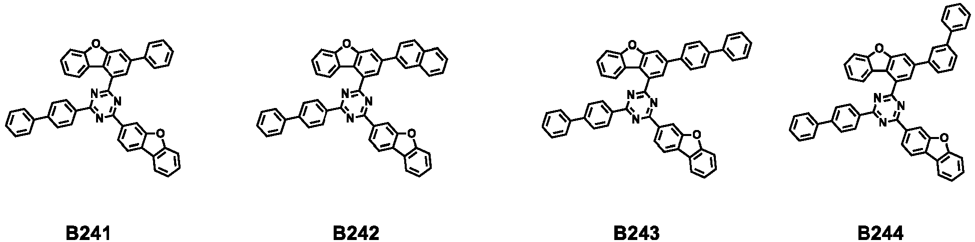

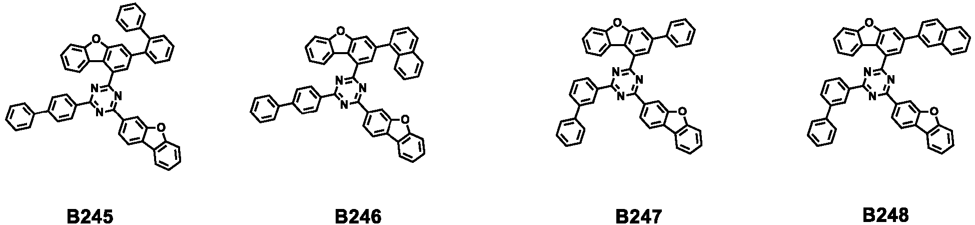

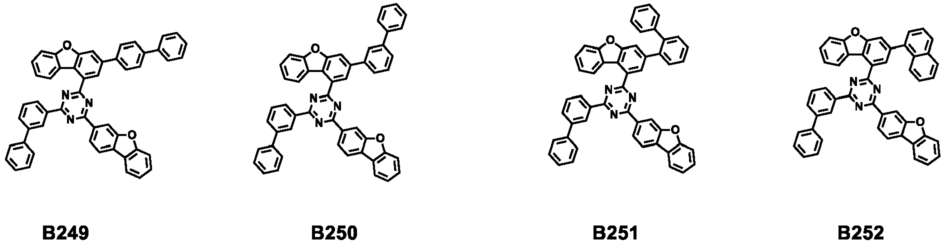

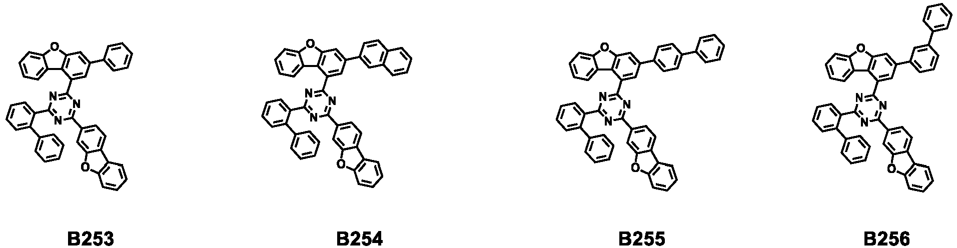

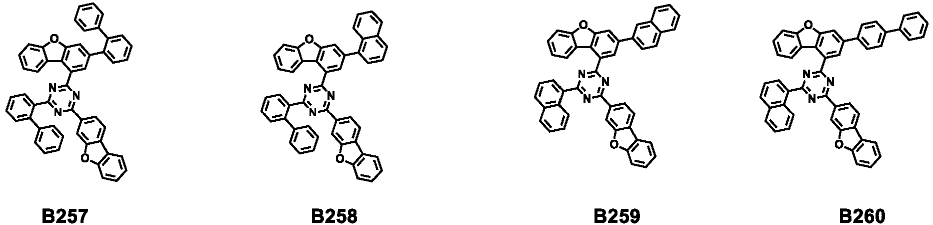

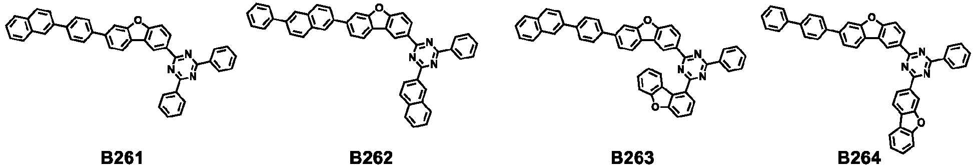

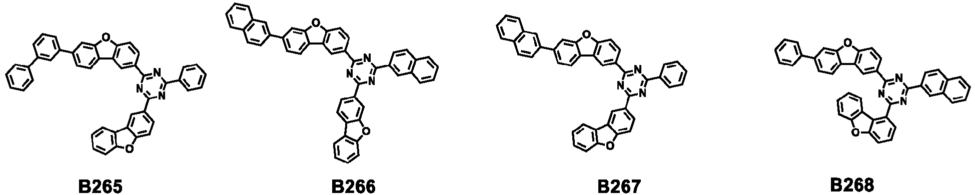

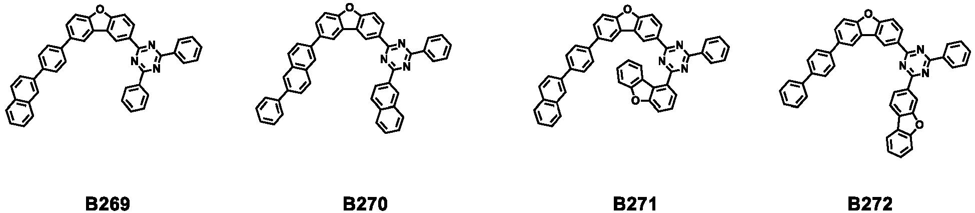

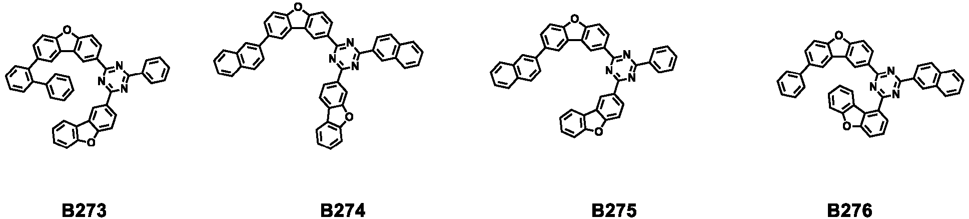

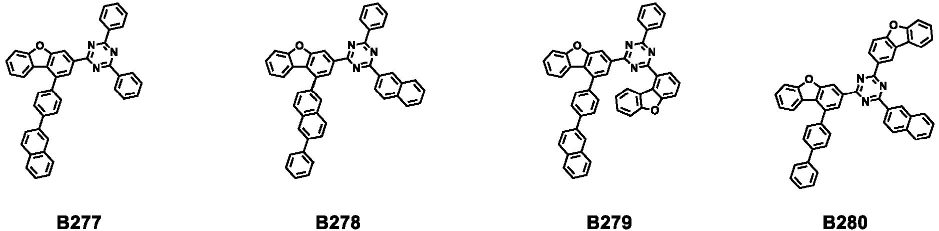

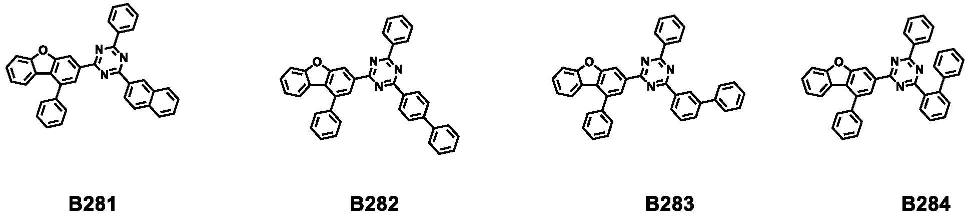

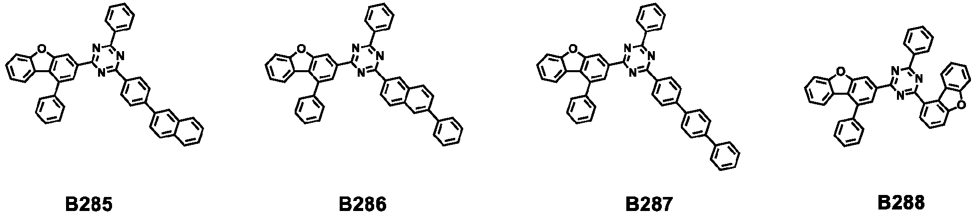

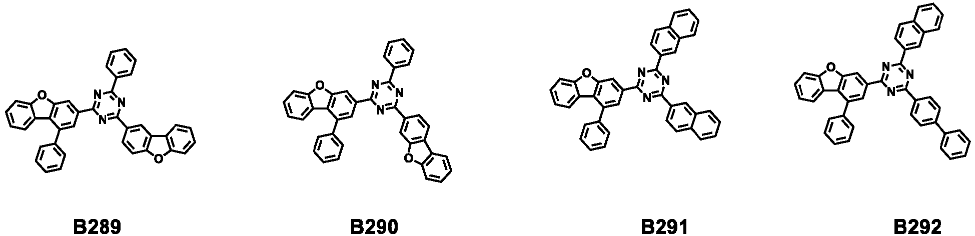

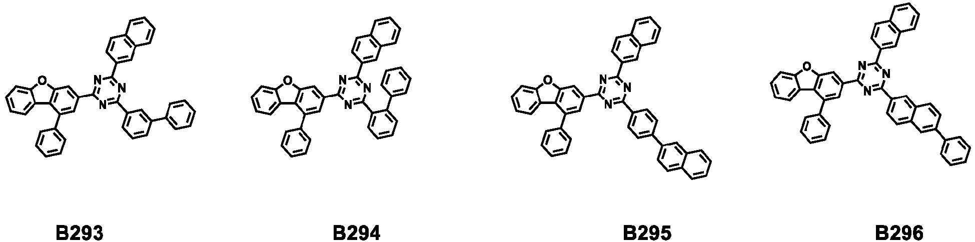

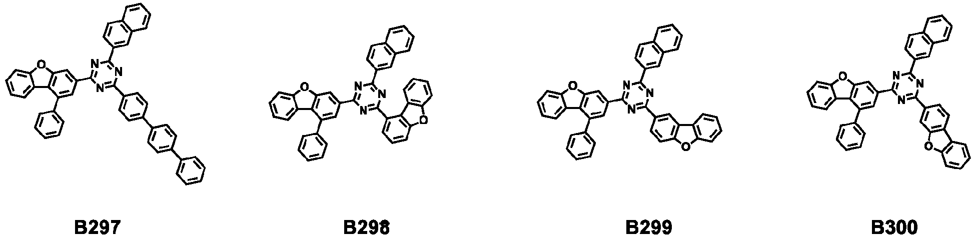

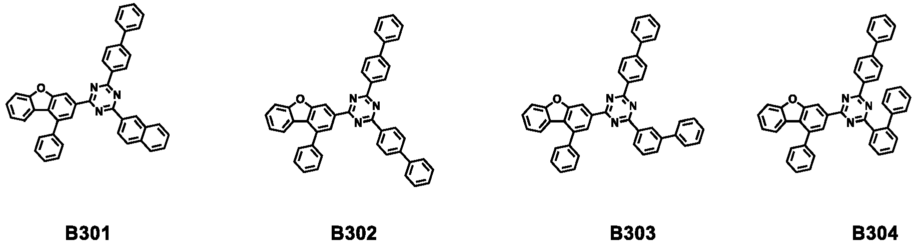

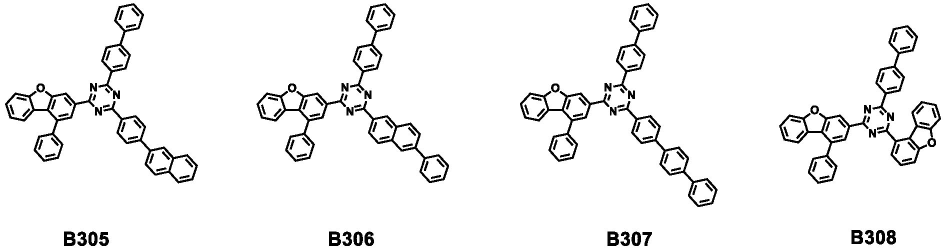

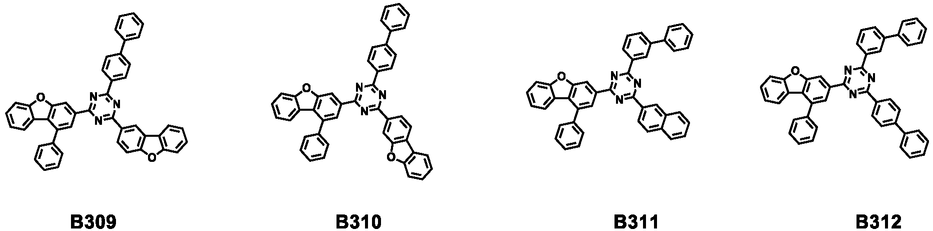

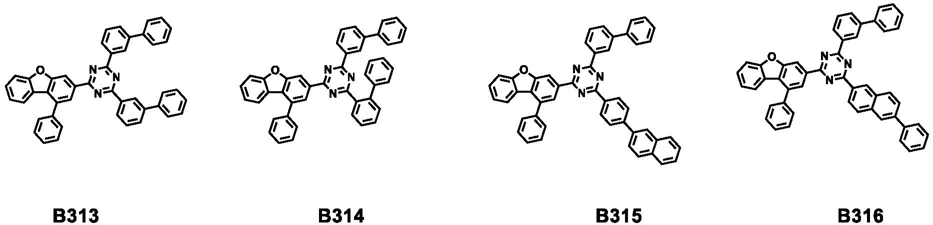

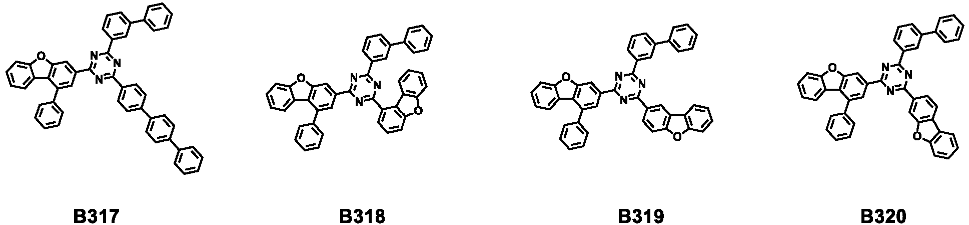

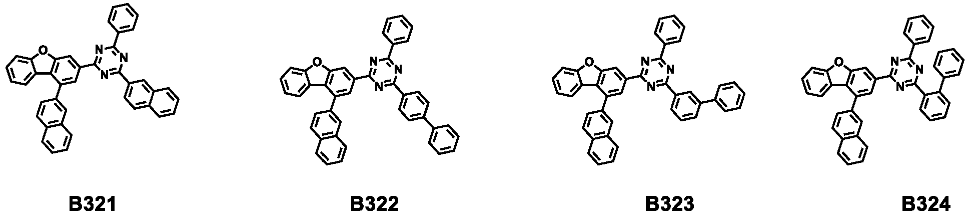

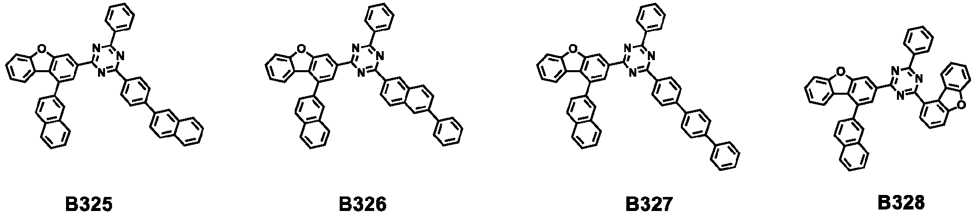

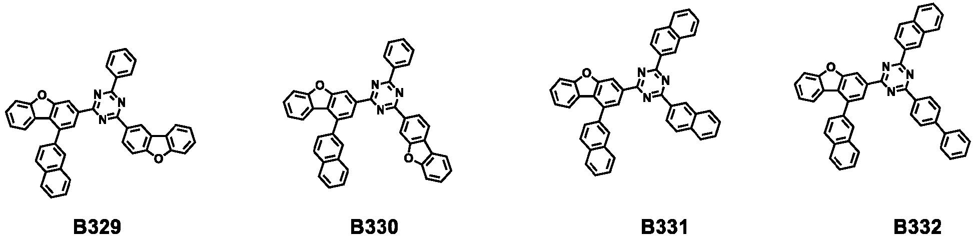

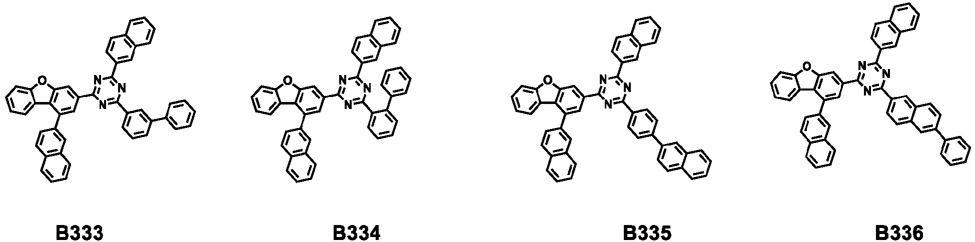

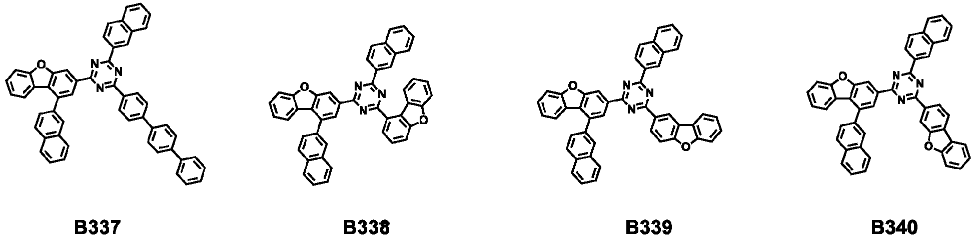

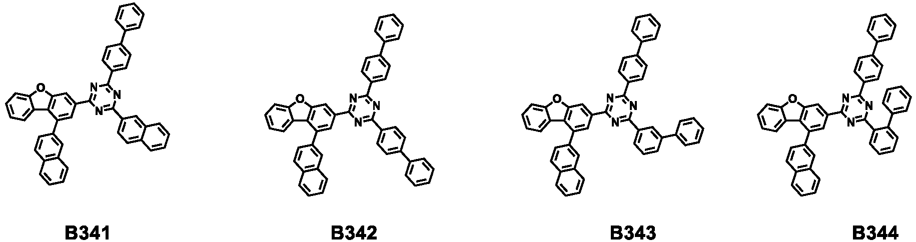

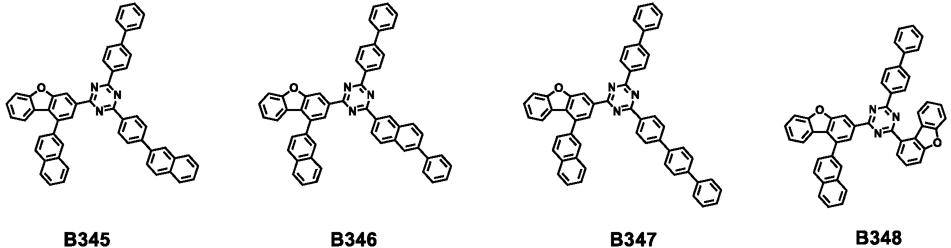

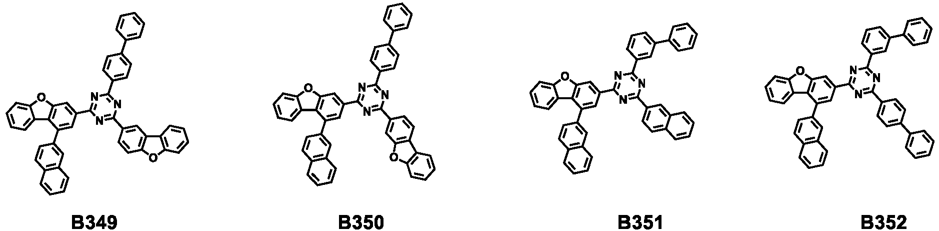

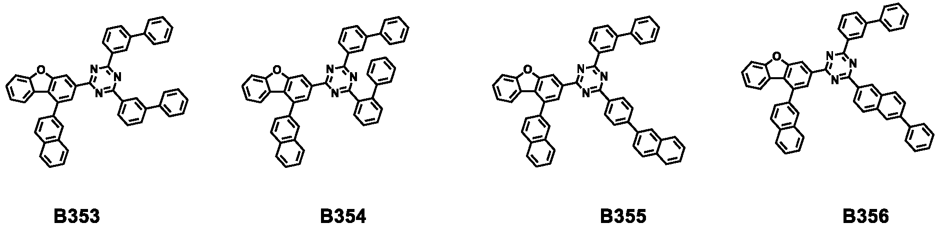

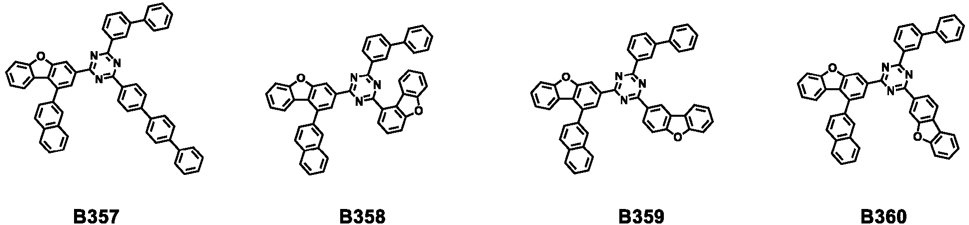

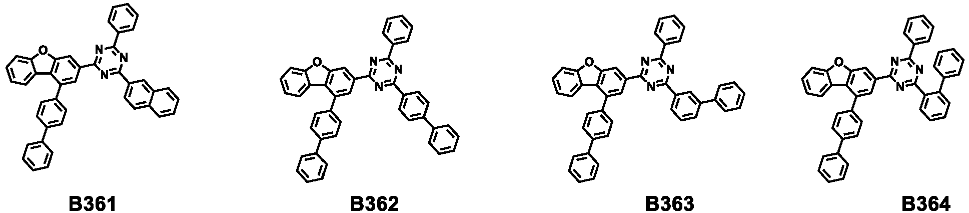

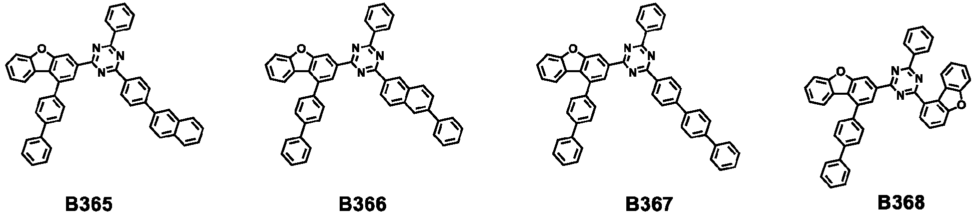

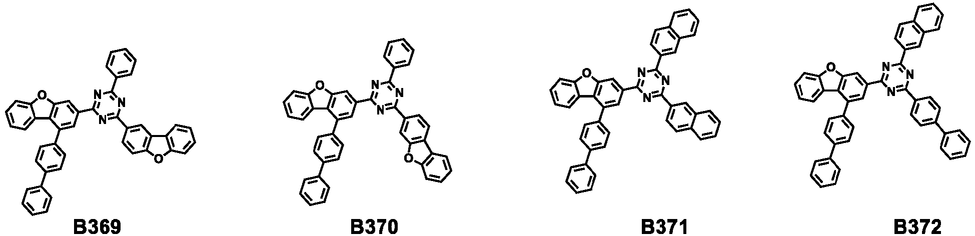

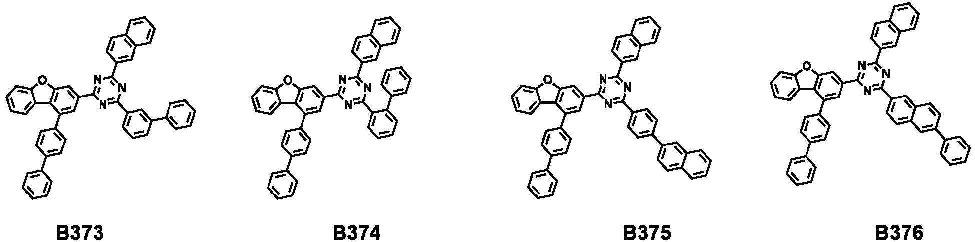

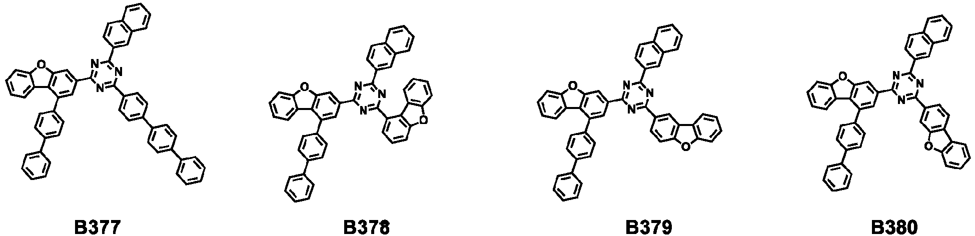

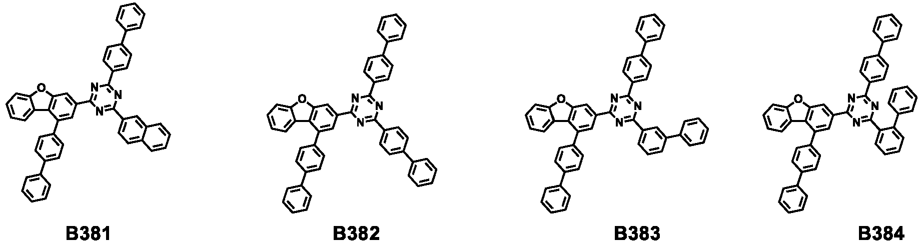

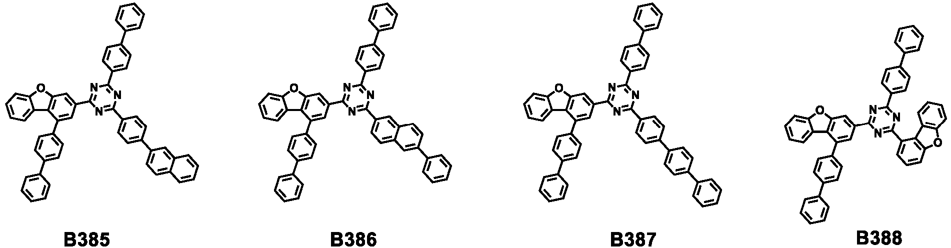

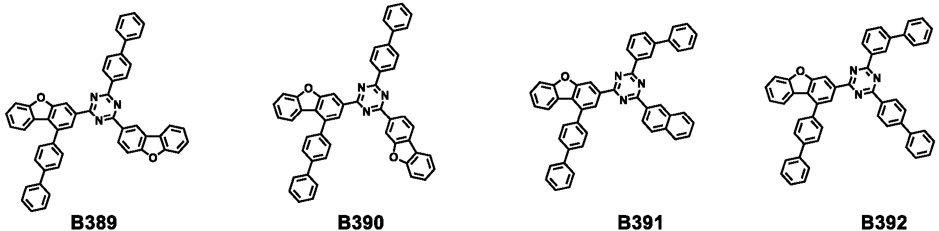

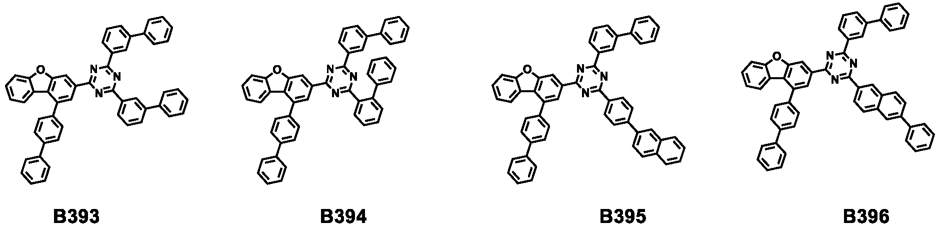

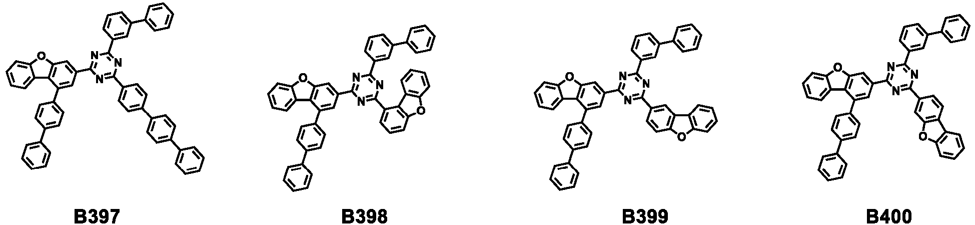

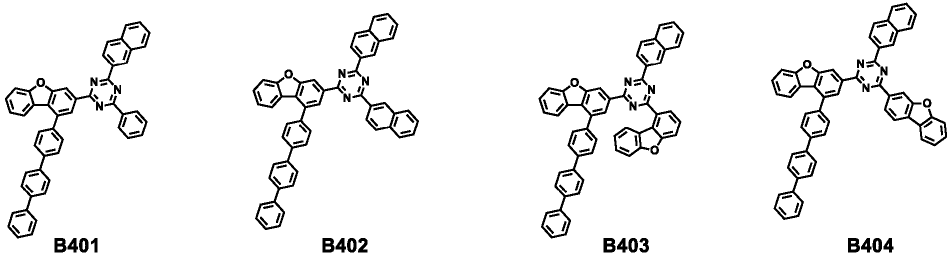

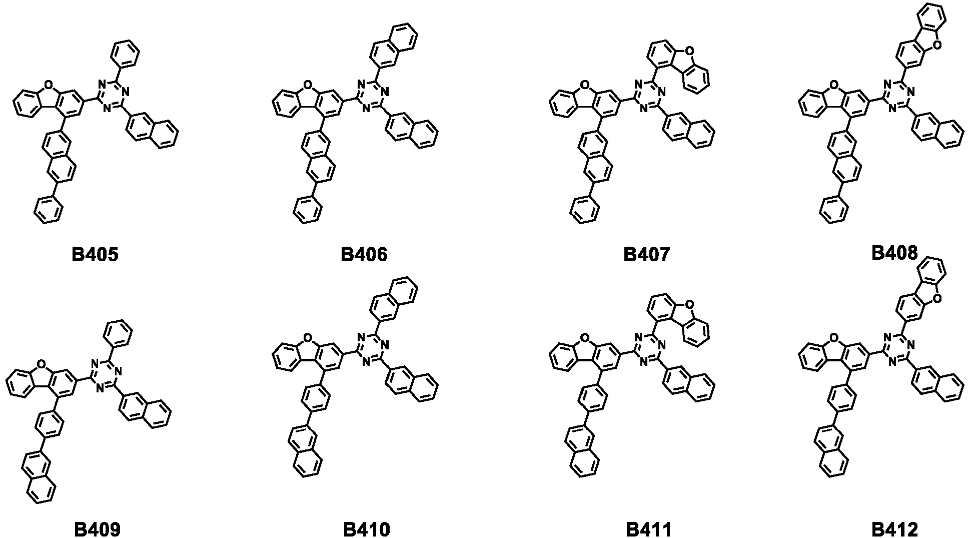

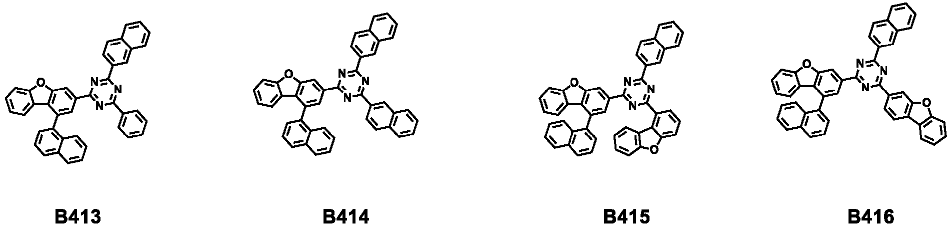

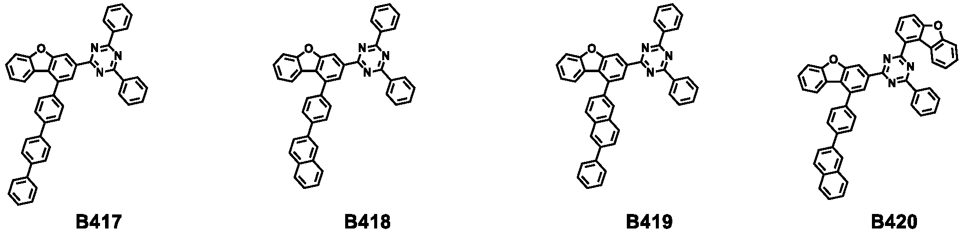

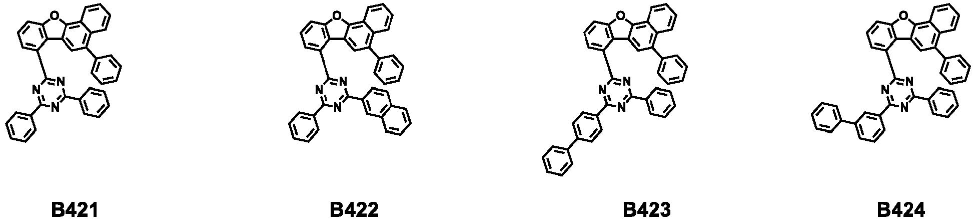

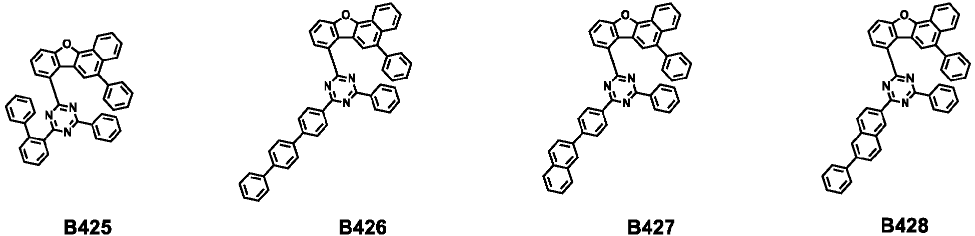

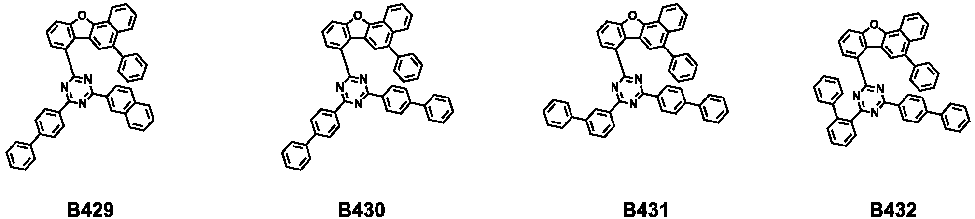

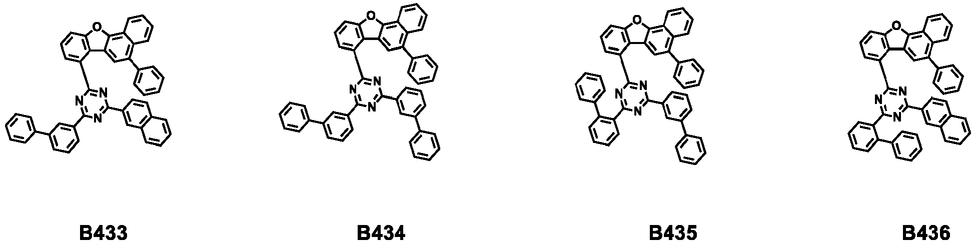

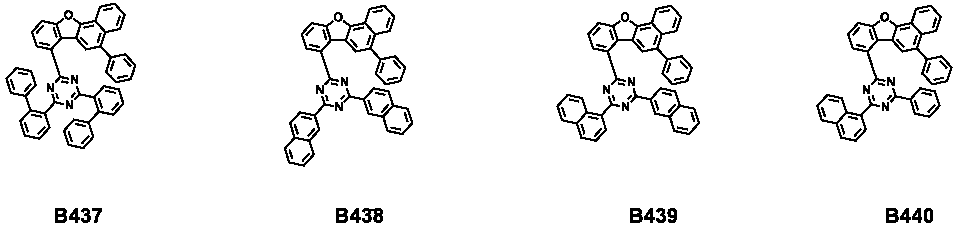

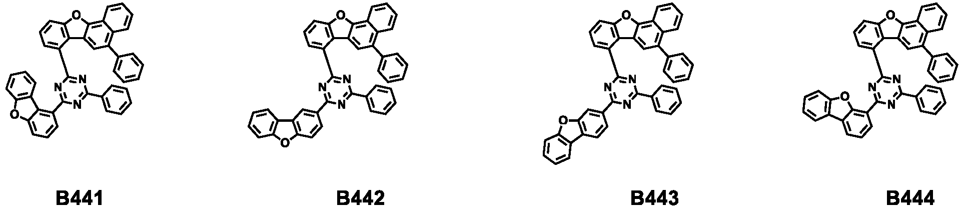

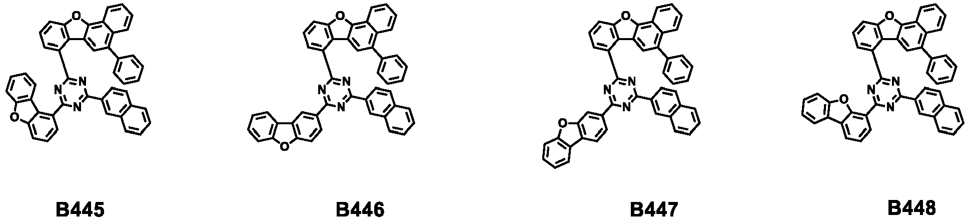

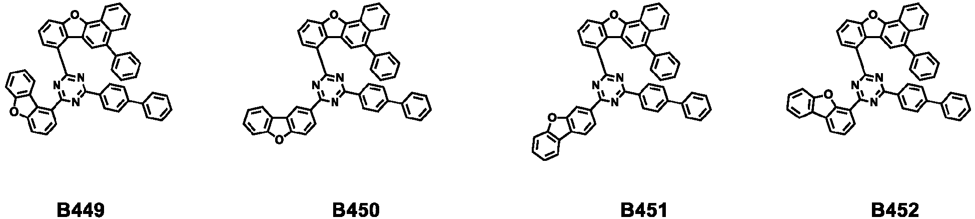

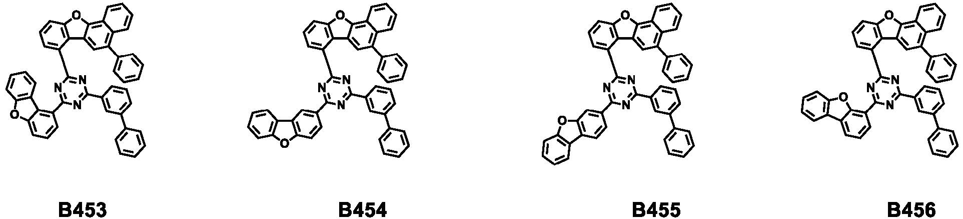

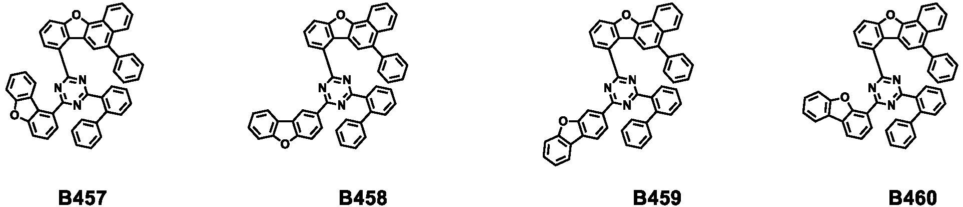

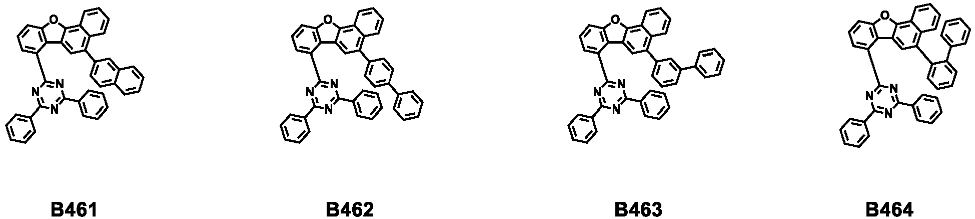

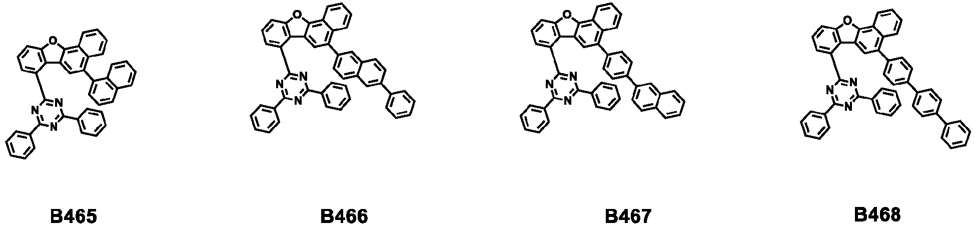

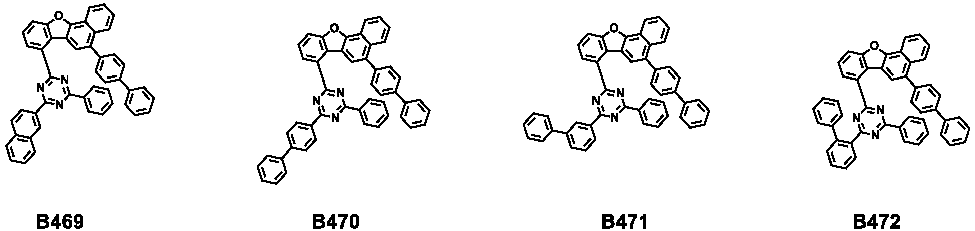

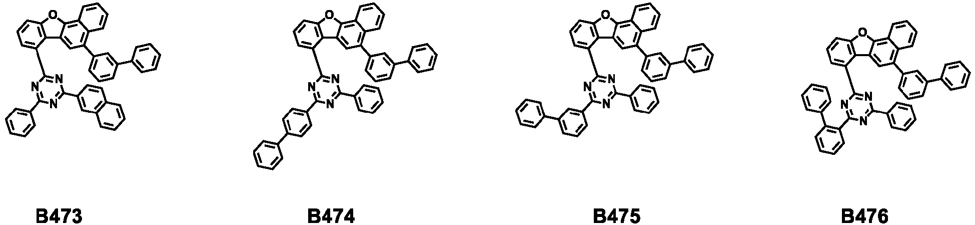

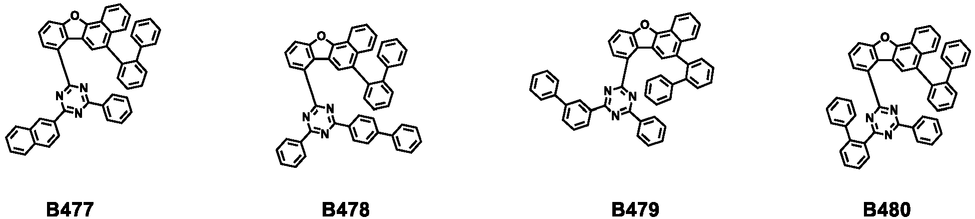

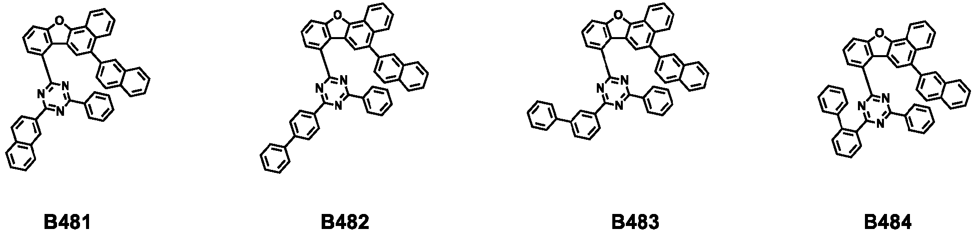

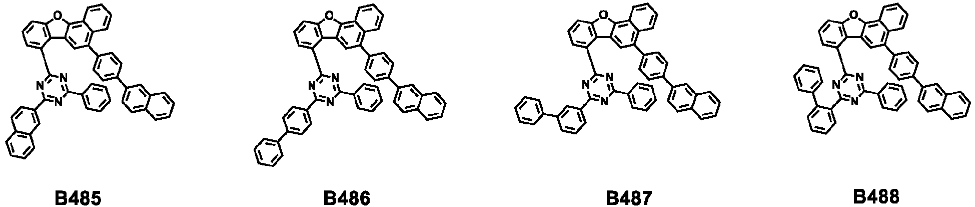

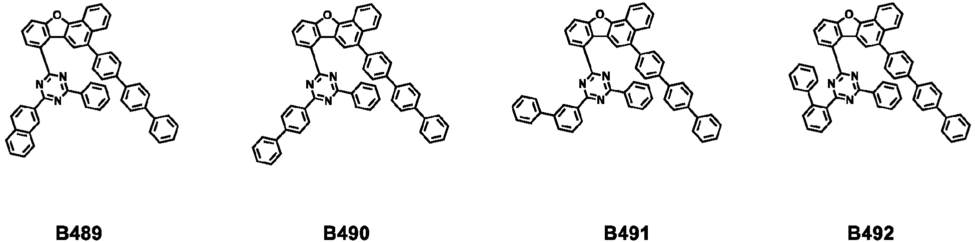

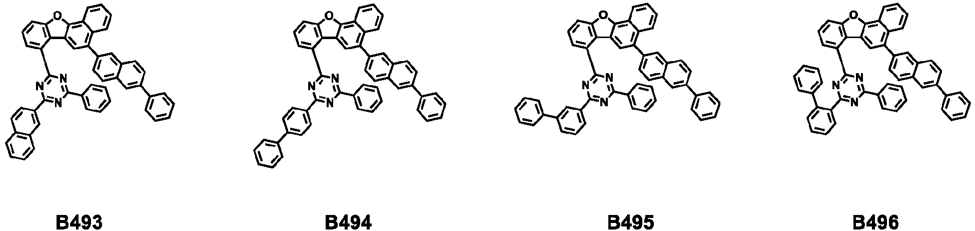

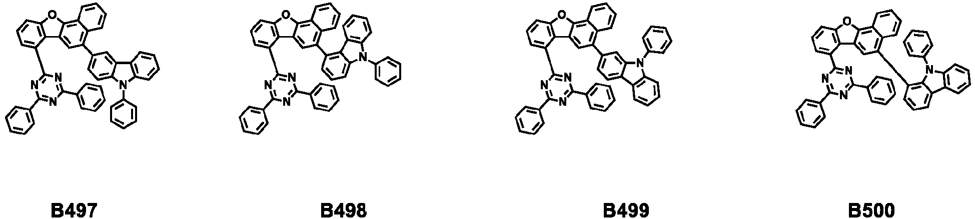

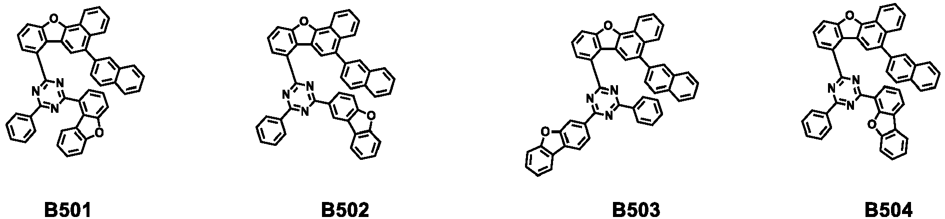

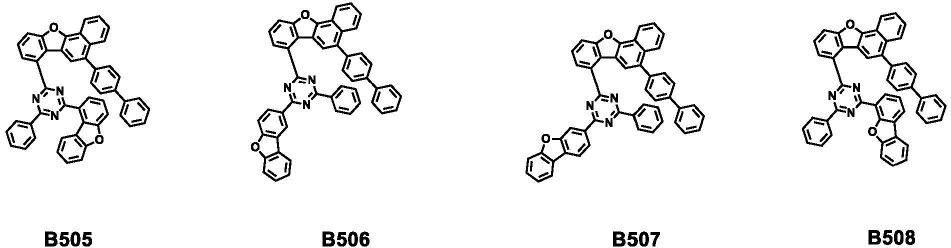

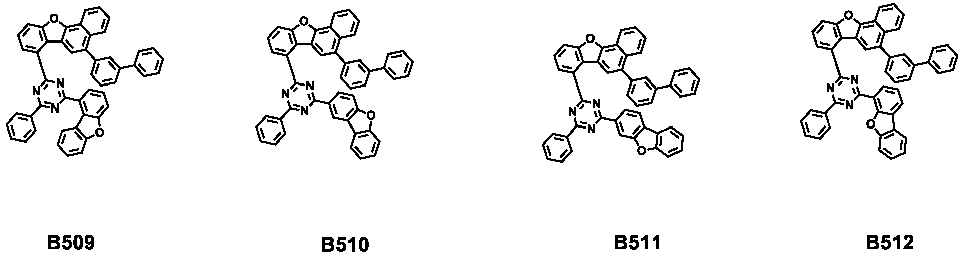

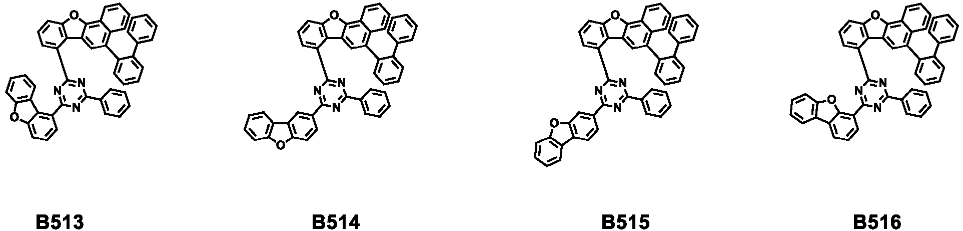

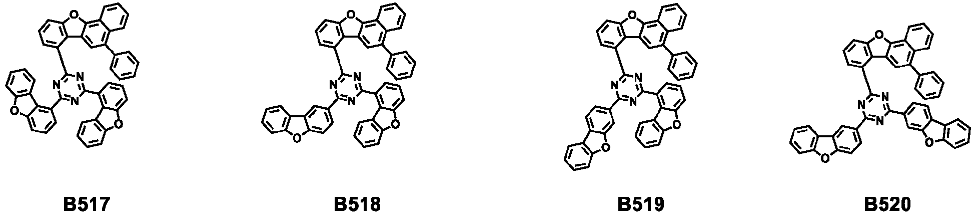

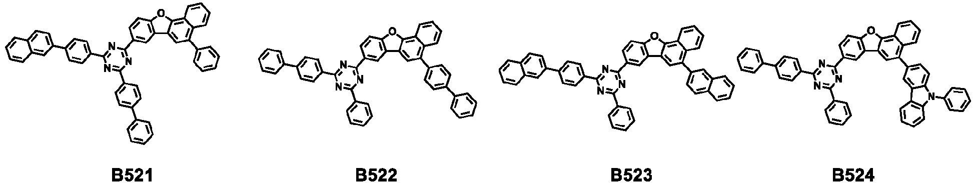

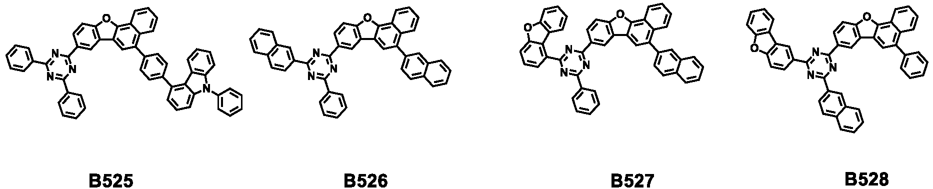

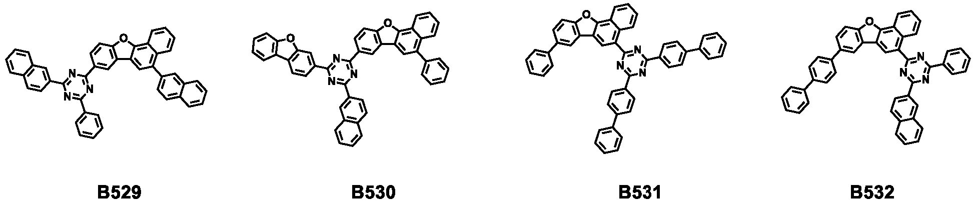

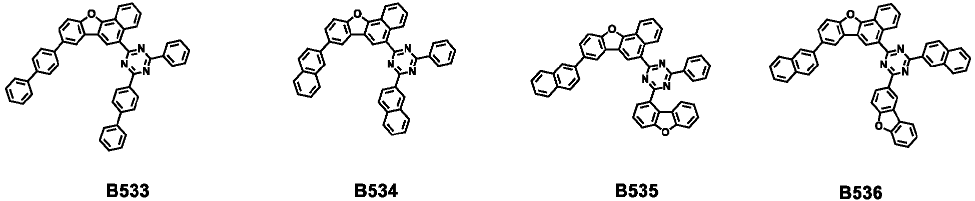

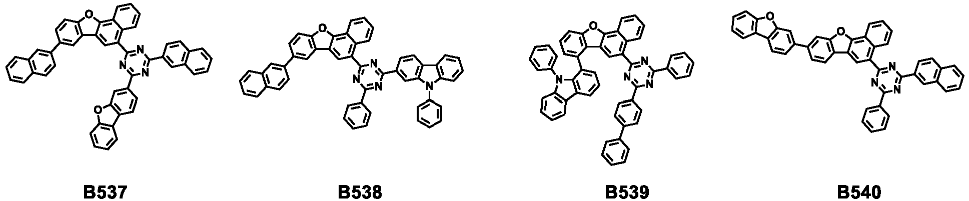

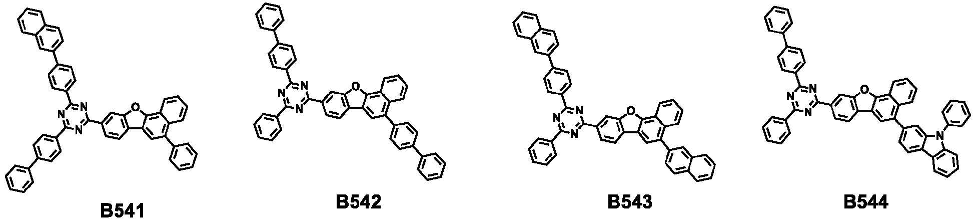

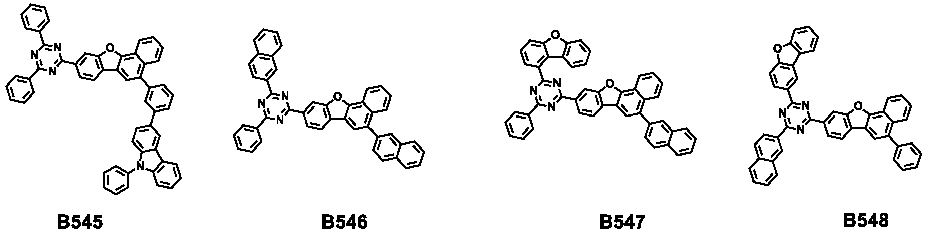

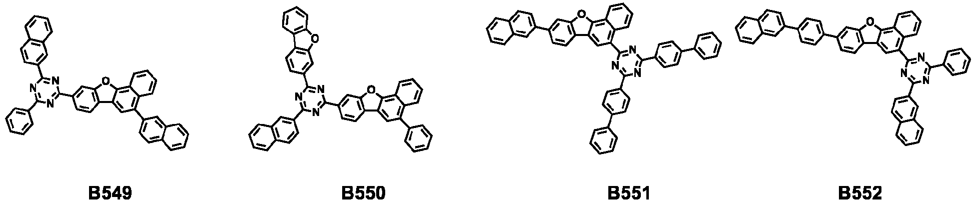

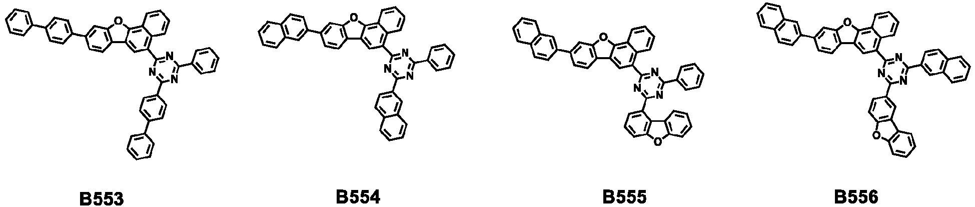

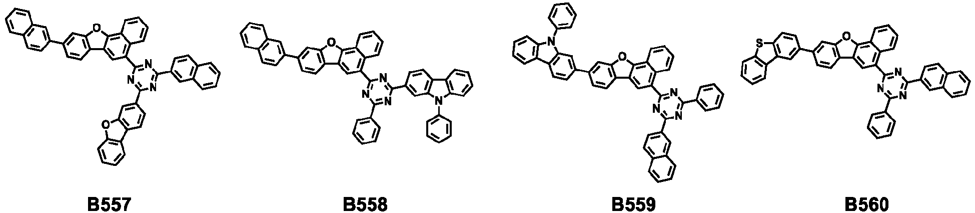

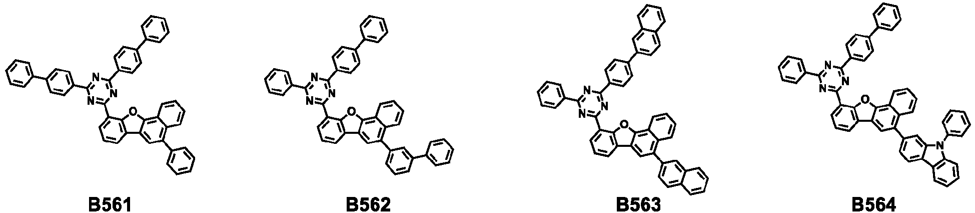

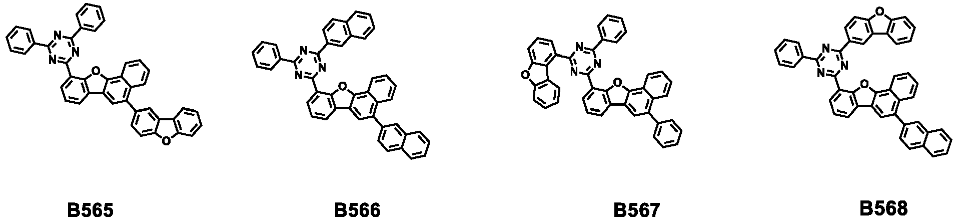

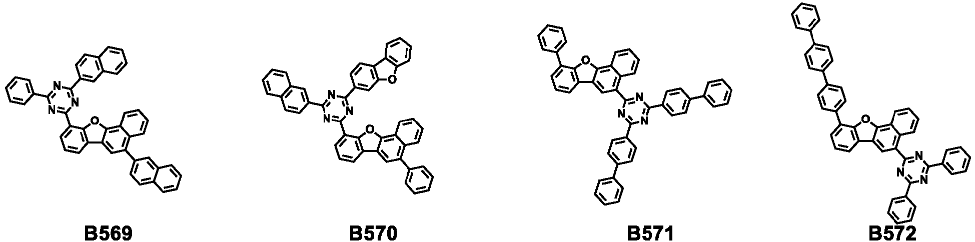

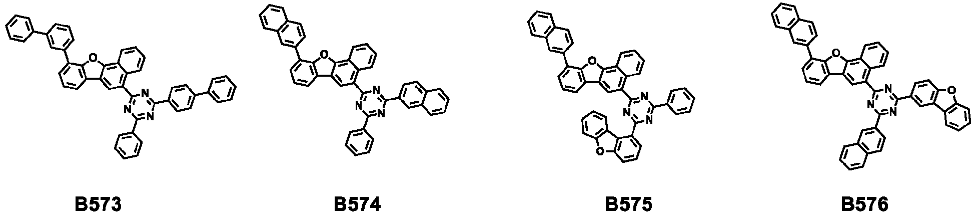

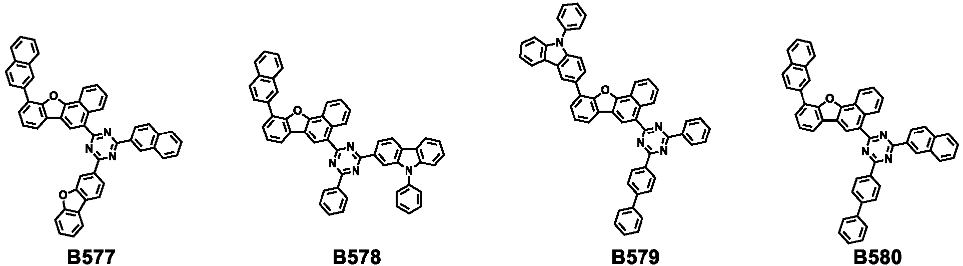

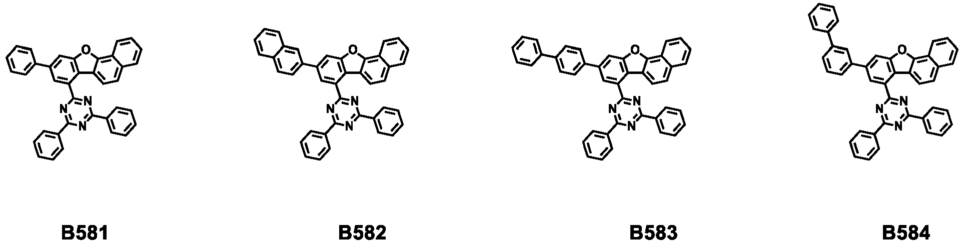

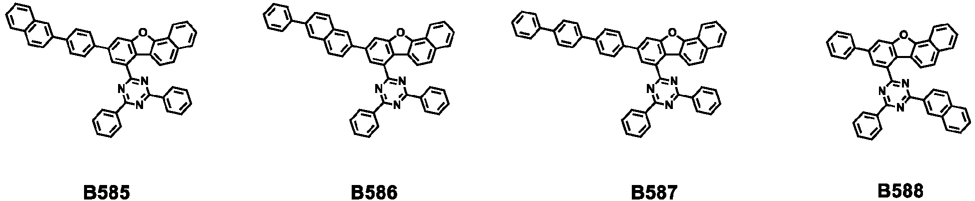

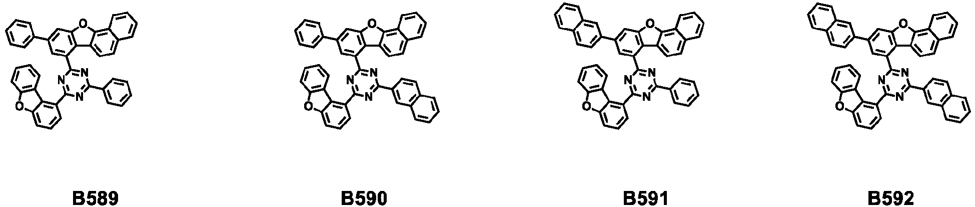

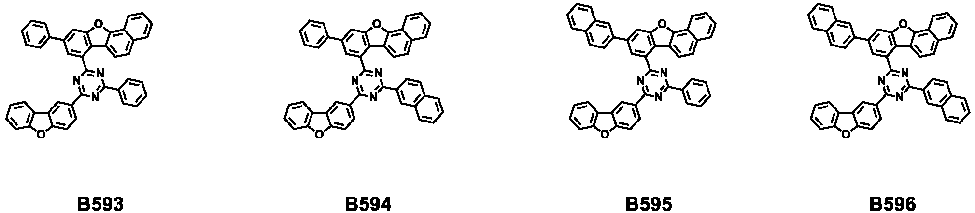

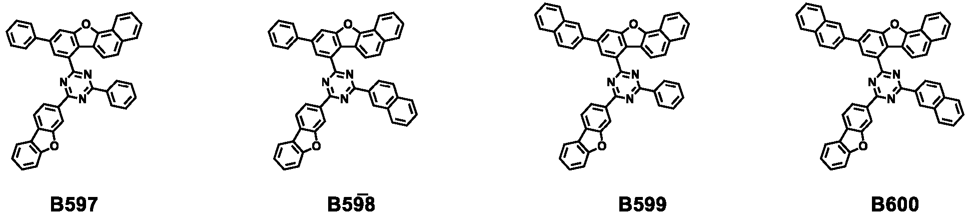

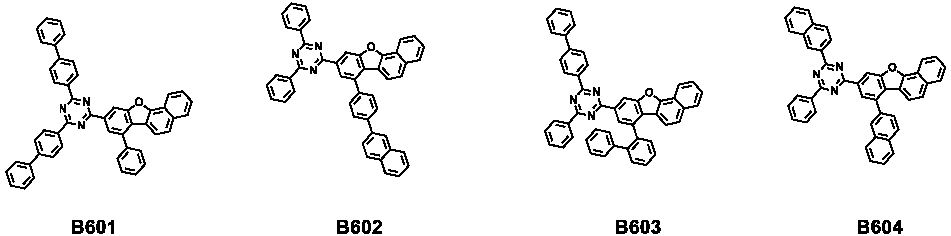

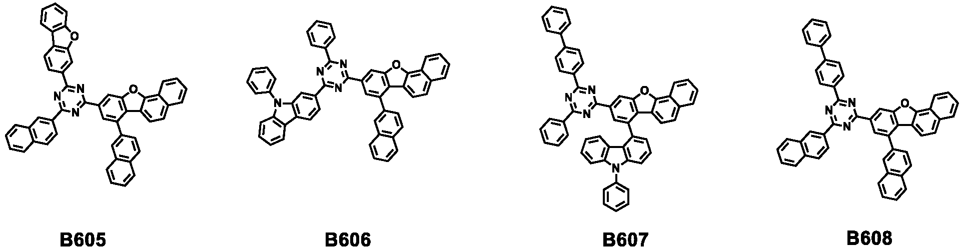

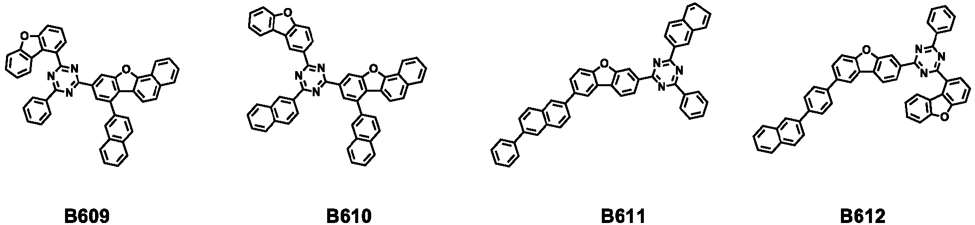

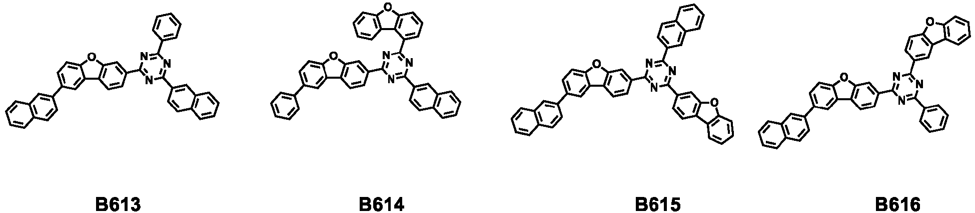

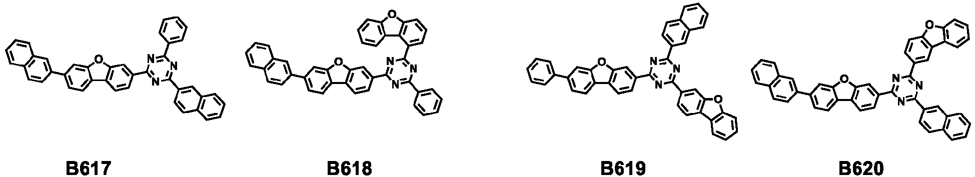

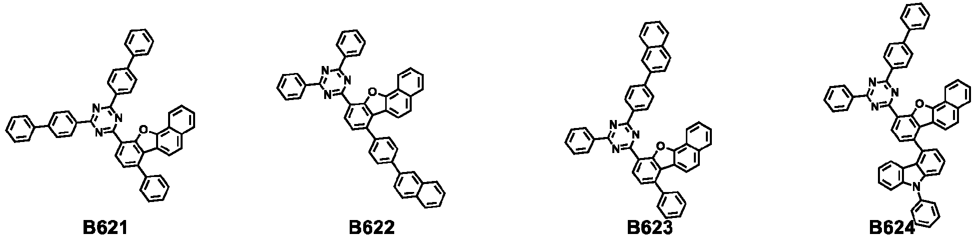

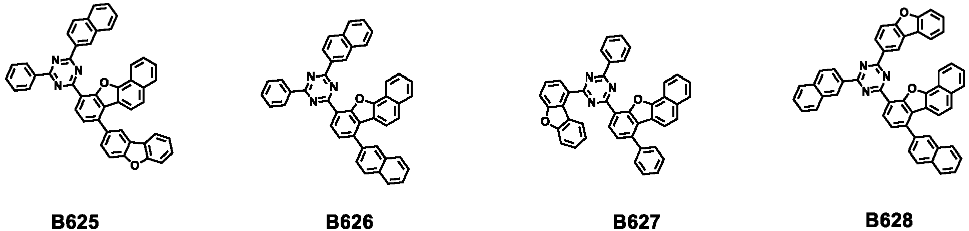

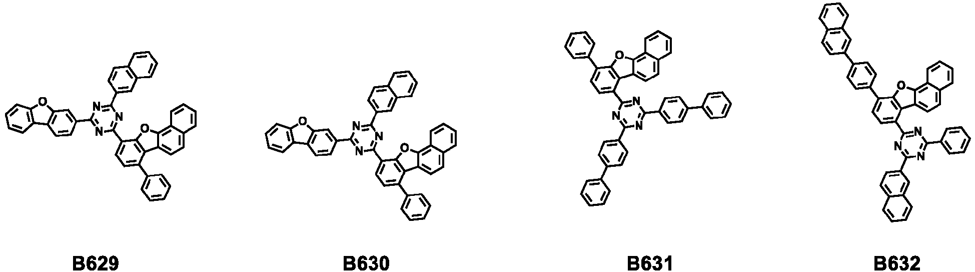

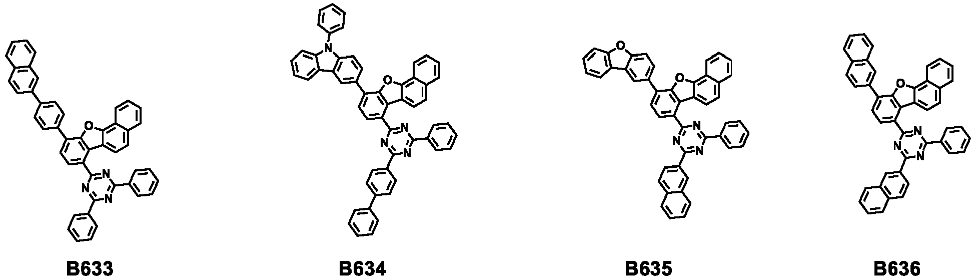

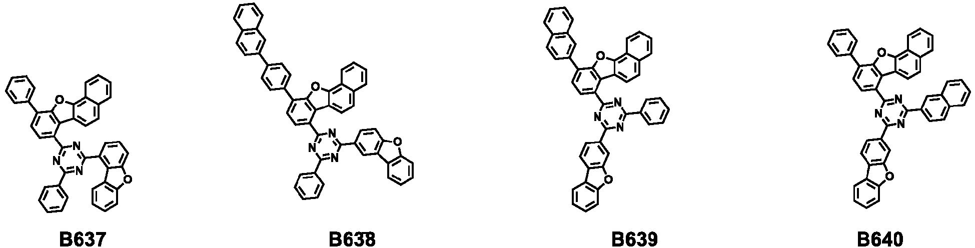

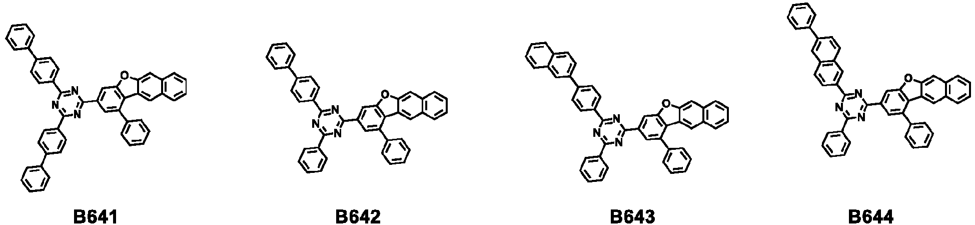

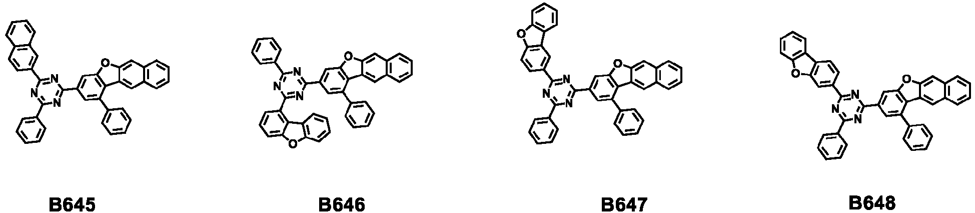

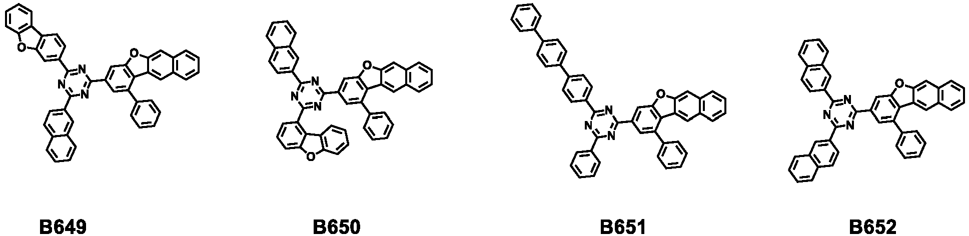

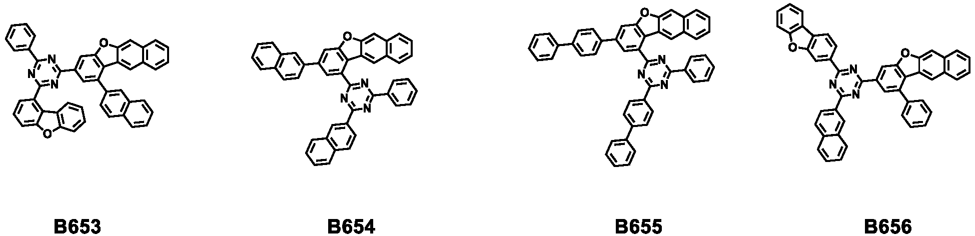

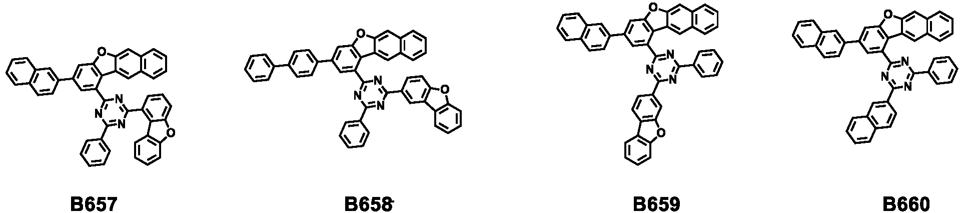

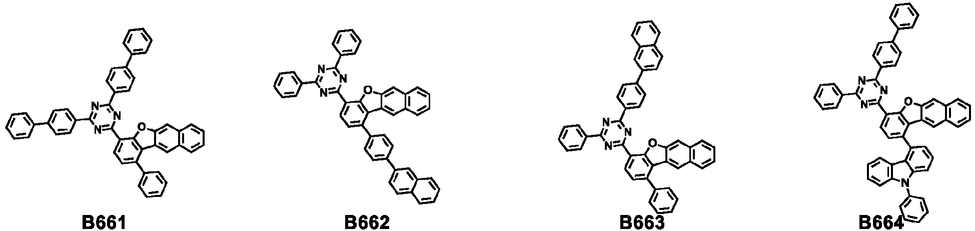

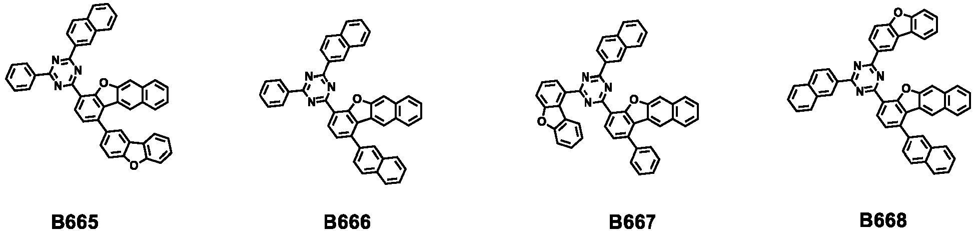

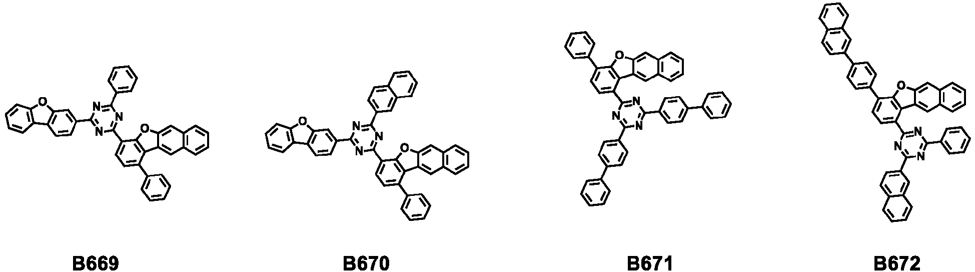

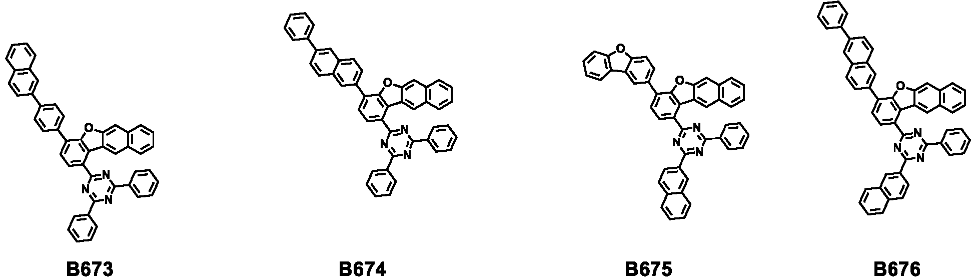

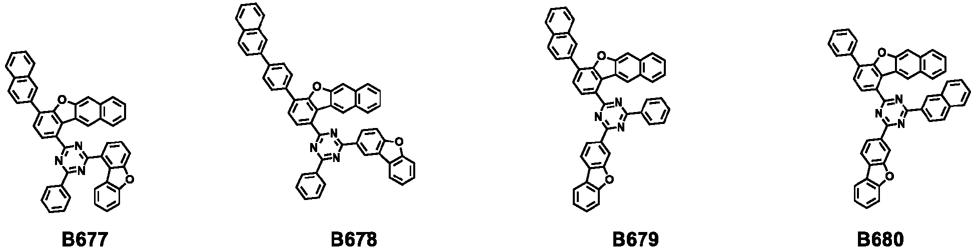

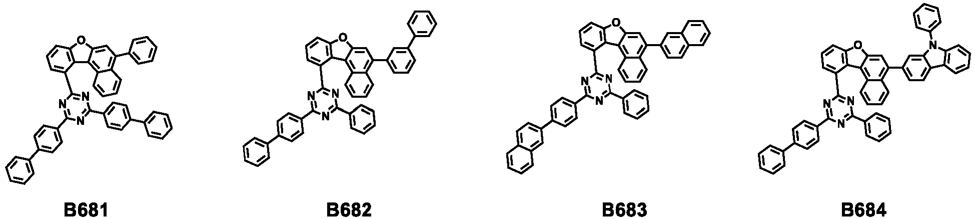

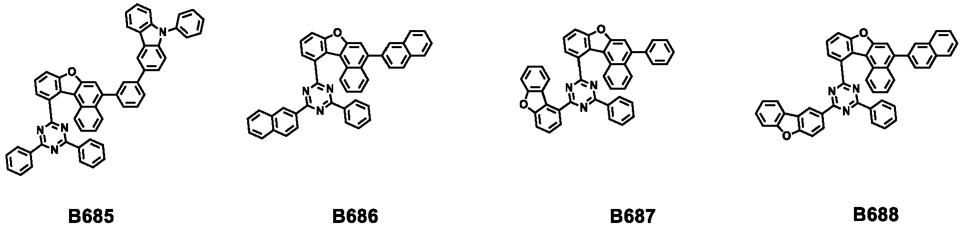

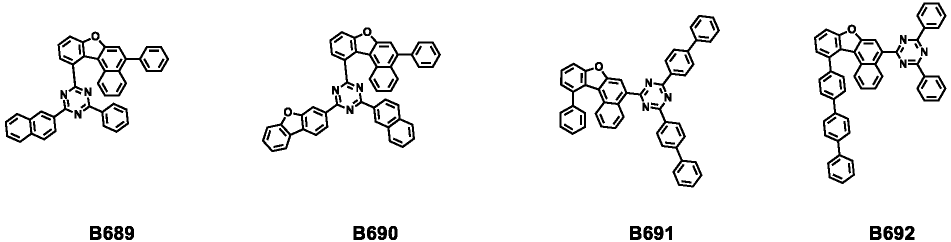

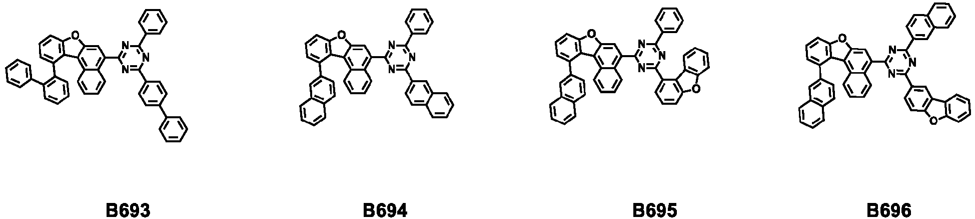

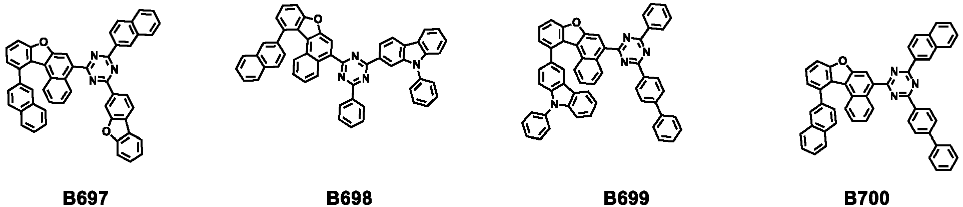

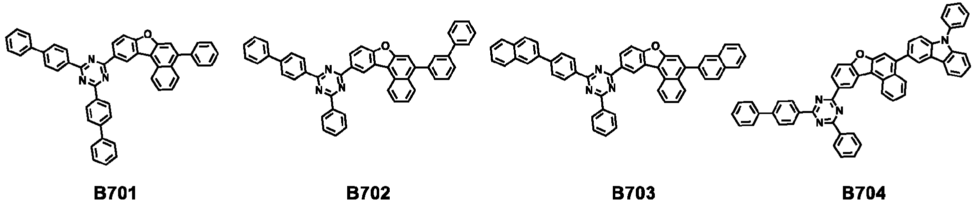

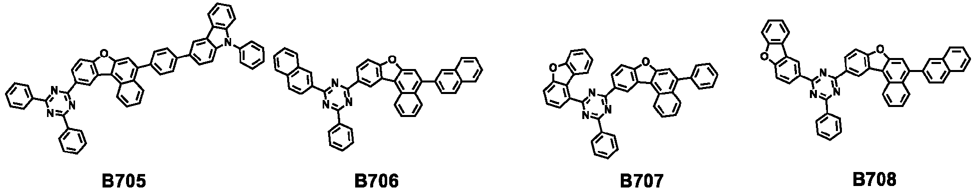

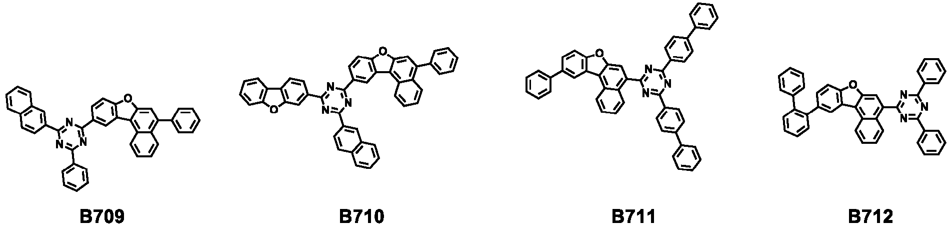

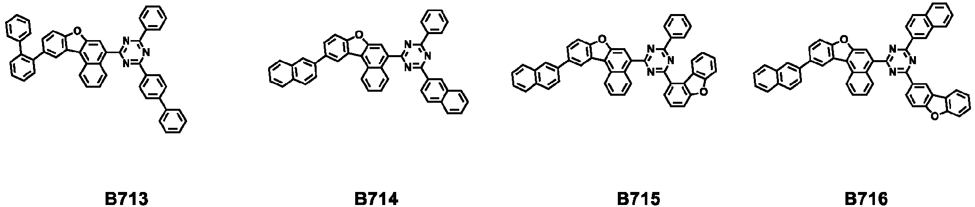

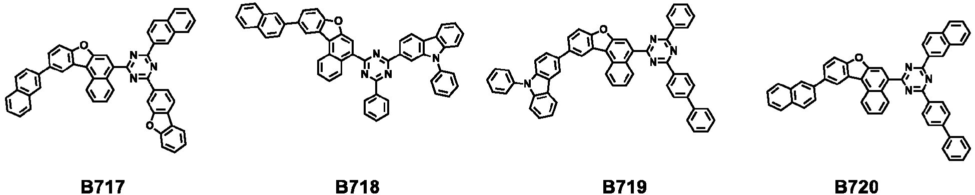

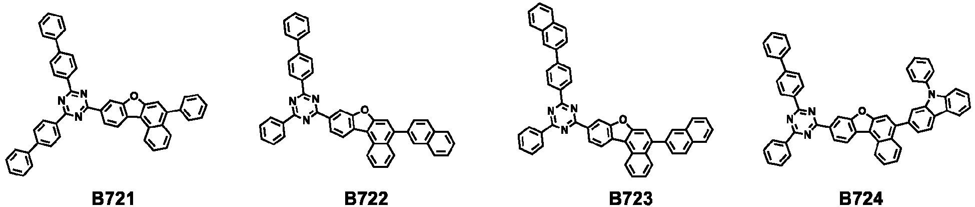

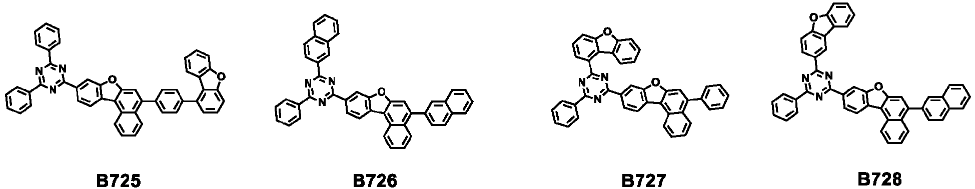

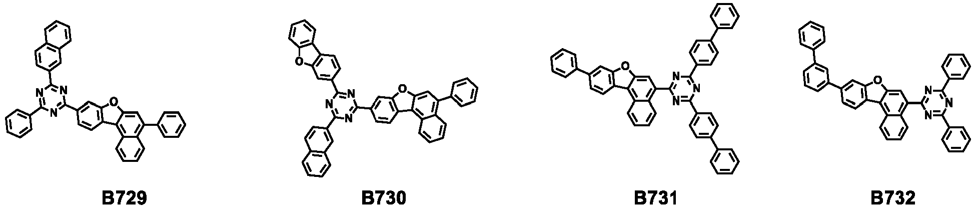

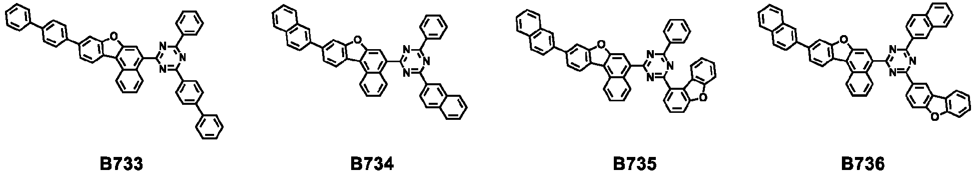

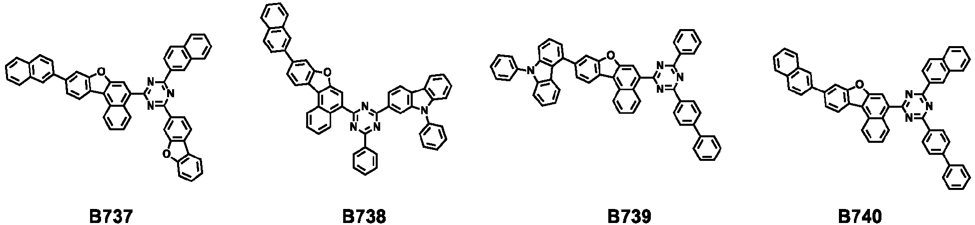

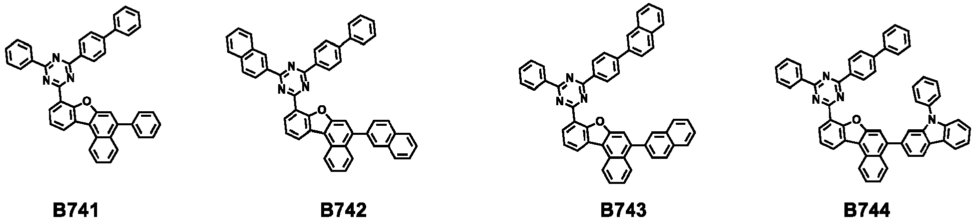

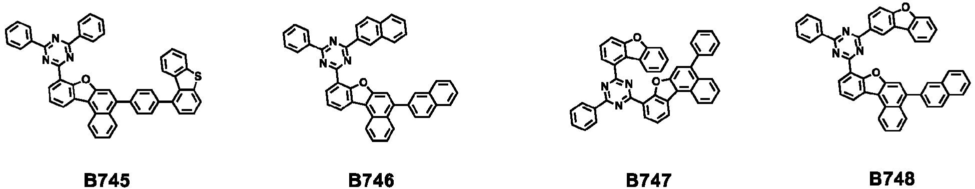

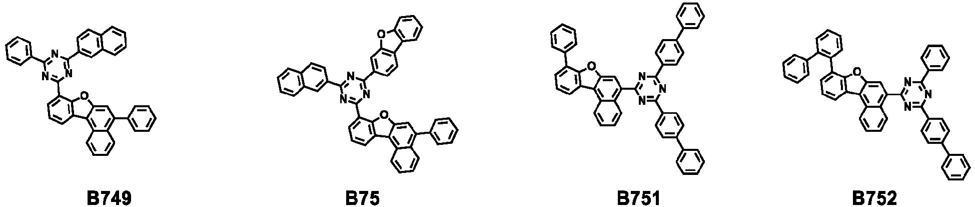

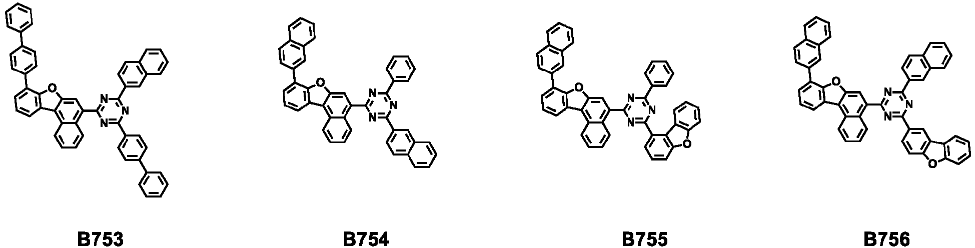

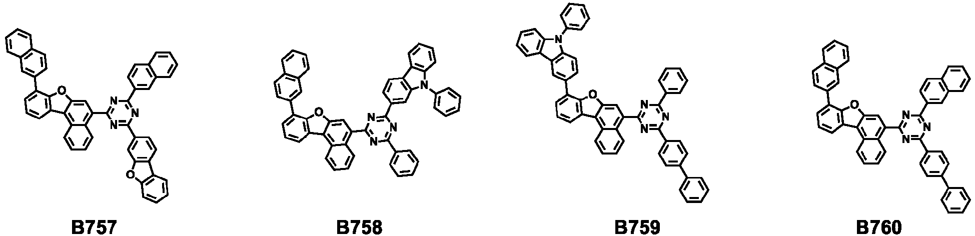

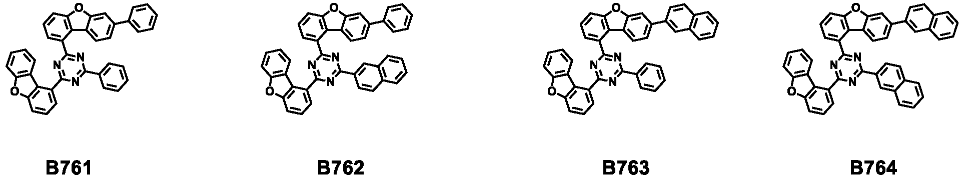

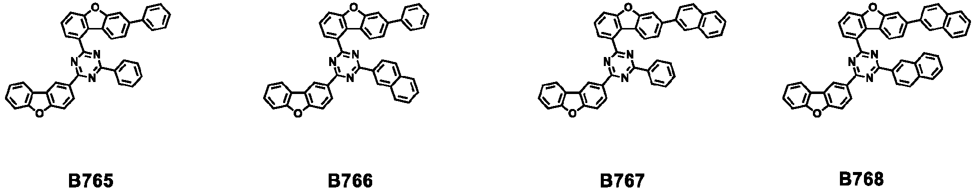

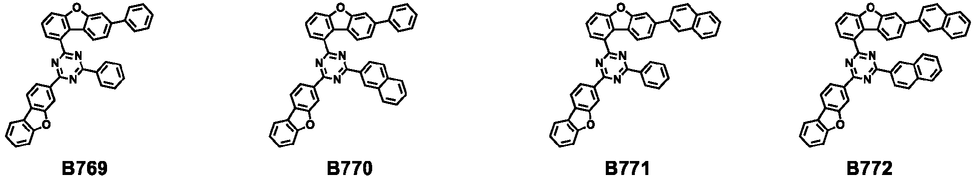

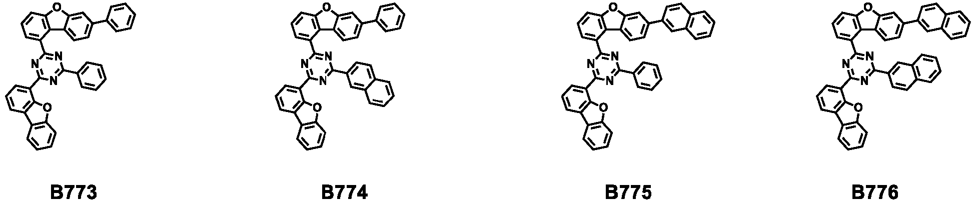

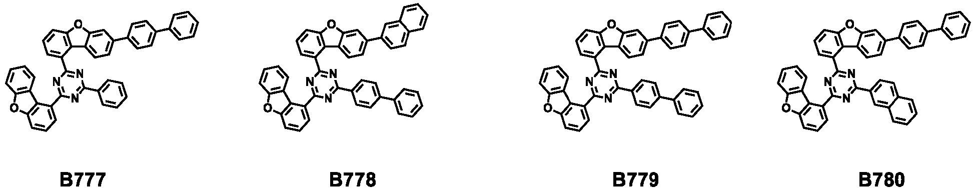

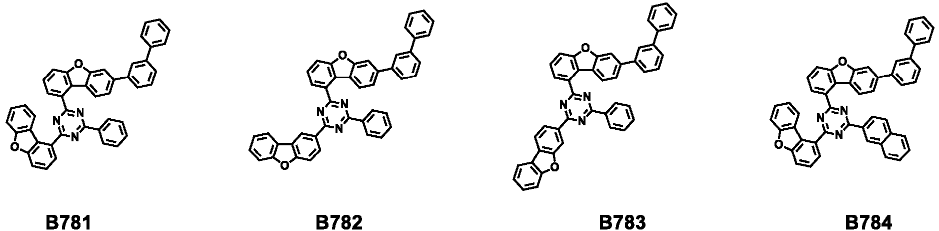

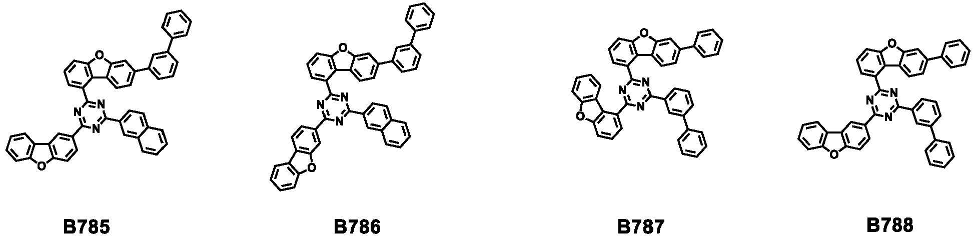

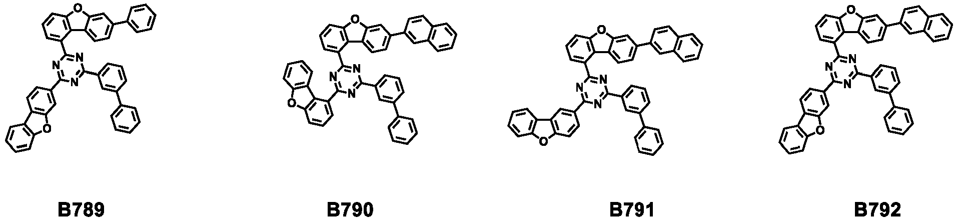

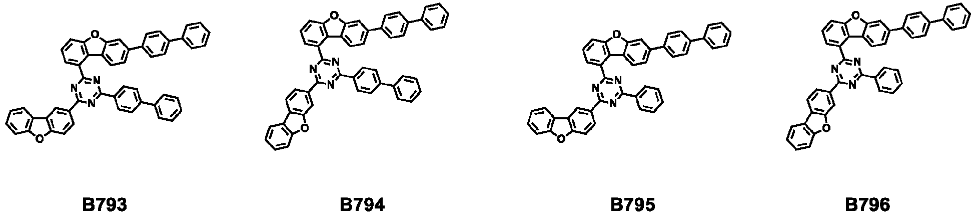

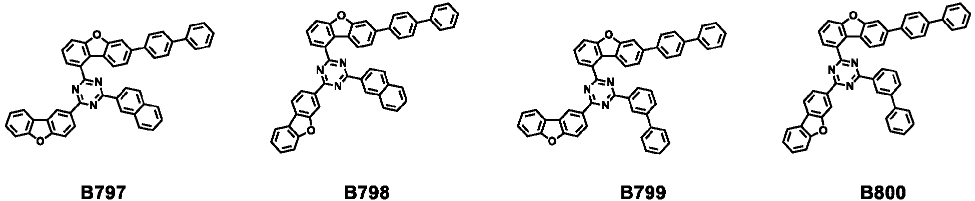

It is possible to synthesize a compound having inherent characteristics of a substituent introduced by introducing various substituents into the structure(s) represented by Chemical Formulae A and/or B. For example, it is possible to synthesize a material which satisfies conditions required for each organic material layer by introducing a substituent usually used for a hole injection layer material, a hole transport layer material, a hole transport auxiliary layer material, a light emitting layer material, an electron transport layer material, an electron transport auxiliary layer material, and a charge generation layer material used during the manufacture of an organic light emitting device into the core structure.

In addition, it is possible to finely adjust an energy band gap by introducing various substituents into the structures of Chemical Formulae A and/or B, and meanwhile, it is possible to improve characteristics at the interface between organic materials and diversify the use of material.

According to an exemplary embodiment of the present specification, the molar ratio of the heterocyclic compound represented by Chemical Formula A to the heterocyclic compound represented by Chemical Formula B may be 0.1 to 3 : 0.1 to 2.

According to an exemplary embodiment of the present specification, the molar ratio of the heterocyclic compound represented by Chemical Formula A to the heterocyclic compound represented by Chemical Formula B may be 1 to 3 : 1 to 2.

In addition, the composition for an organic layer including the heterocyclic compound of Chemical Formula A and the heterocyclic compound of Chemical Formula B provides excellent thermal stability when used in an organic light emitting device, and such thermal stability may provide driving stability to organic light emitting devices in the future as well as improve life time characteristics.

### <Organic light emitting device>

Hereinafter, the organic light emitting device according to the present specification will be described.

Another exemplary embodiment of the present specification provides an organic light emitting device including: a first electrode; a second electrode provided to face the first electrode; and an organic material layer having one or more layers provided between the first electrode and the second electrode, in which one or more layers of the organic material layer include the above-described composition for an organic material layer of an organic light emitting device.

According to an exemplary embodiment of the present specification, the organic material layer further includes a light emitting layer (emission layer), and the light emitting layer may include the composition for an organic light emitting device.

In another exemplary embodiment of the present specification, the light emitting layer may include the composition for an organic light emitting device as a host.

According to an exemplary embodiment of the present specification, the light emitting layer may include the composition for an organic light emitting device as a red host.

According to an exemplary embodiment of the present specification, the first electrode may be a positive electrode, and the second electrode may be a negative electrode.

According to an exemplary embodiment of the present specification, the first electrode may be a negative electrode, and the second electrode may be a positive electrode.

According to an exemplary embodiment of the present specification, the organic light emitting device may be a blue organic light emitting device, and the composition for an organic material layer of an organic light emitting device may be used as a material for the blue organic light emitting device.

According to an exemplary embodiment of the present specification, the organic light emitting device may be a green organic light emitting device, and the composition for an organic material layer of an organic light emitting device may be used as a material for the green organic light emitting device.

According to an exemplary embodiment of the present specification, the organic light emitting device may be a red organic light emitting device, and the composition for an organic material layer of an organic light emitting device may be used as a material for the red organic light emitting device.

The organic material layer of the organic light emitting device of the present specification may also have a single-layered structure, but may have a multi-layered structure in which two or more organic material layers are stacked. For example, the organic light emitting device of the present specification may have a structure including a hole injection layer, a hole transport layer, a light emitting layer, an electron transport layer, an electron injection layer, and the like as organic material layers. However, the structure of the organic light emitting device is not limited thereto, and may include less or more numbers of organic material layers.

According to an exemplary embodiment of the present specification, the organic material layer may include an iridium-based dopant.

According to an exemplary embodiment of the present specification, as the iridium-based dopant, Ir(ppy)₃, which is a green phosphorescent dopant, may be used, but the iridium-based dopant is not limited thereto.

According to an exemplary embodiment of the present specification, as the iridium-based dopant, (piq)₂(Ir) (acac), which is a red phosphorescent dopant, may be used, but the iridium-based dopant is not limited thereto.

In the organic light emitting device of the present specification, as a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer such as poly(3-methyl compound), poly[3,4-(ethylene-1,2-dioxy)thiophene] (PEDOT), polypyrrole, and polyaniline; and the like, but are not limited thereto.

In the organic light emitting device of the present specification, as a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

In the organic light emitting device of the present specification, as a hole injection material, a publiclyknown hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl)amine (TCTA), 4,4',4"-tri[phenyl(m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

In the organic light emitting device of the present specification, as a hole transport material, a pyrazoline derivative, an arylamine-based derivative, a stilbene derivative, a triphenyldiamine derivative, and the like may be used, and a low-molecular weight or polymer material may also be used.

In the organic light emitting device of the present specification, as an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

In the organic light emitting device of the present specification, as an electron injection material, for example, LiF is representatively used in the art, but the present application is not limited thereto.

In the organic light emitting device of the present specification, as a light emitting material, a red, green, or blue light emitting material may be further used, and if necessary, two or more light emitting materials may be mixed and used. In this case, two or more light emitting materials are deposited and used as an individual supply source, or pre-mixed to be deposited and used as one supply source. Further, a fluorescent material may also be used as the light emitting material, but may also be used as a phosphorescent material. As the light emitting material, it is also possible to use alone a material which emits light by combining holes and electrons each injected from a positive electrode and a negative electrode, but materials in which a host material and a dopant material are involved in light emission together may also be used.

When hosts of the light emitting material are mixed and used, the same series of hosts may also be mixed and used, and different series of hosts may also be mixed and used. For example, two or more types of materials selected from N-type host materials or P-type host materials may be used as a host material for a light emitting layer.

The organic light emitting device according to an exemplary embodiment of the present specification may be a top emission type, a bottom emission type, or a dual emission type according to the material to be used.

The heterocyclic compound according to an exemplary embodiment of the present specification may act even in organic electronic devices including organic solar cells, organic photoconductors, organic transistors, and the like, based on the principle similar to those applied to organic light emitting devices.

The organic light emitting device of the present specification may further include one or two or more layers selected from the group consisting of a light emitting layer, a hole injection layer, a hole transport layer, a hole transport auxiliary layer, an electron injection layer, an electron transport layer, an electron blocking layer, and a hole blocking layer.

FIGS. 1 to 3 exemplify the stacking sequence of the electrodes and the organic material layer of the organic light emitting device according to an exemplary embodiment of the present specification. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as in FIG. 2, an organic light emitting device in which a negative electrode, an organic material layer, and a positive electrode are sequentially stacked on a substrate may also be implemented. The composition for an organic light emitting device may be included in the organic material layer 300, and the organic material layer 300 may be one or more layers.

FIG. 3 exemplifies a case where an organic material layer is a multilayer. The organic light emitting device according to FIG. 3 includes a hole injection layer 301, a hole transport layer 302, a light emitting layer 303, a hole blocking layer 304, an electron transport layer 305, and an electron injection layer 306. The composition for an organic light emitting device may be included in the light emitting layer 303. However, the scope of the present application is not limited by the stacking structure as described above, and if necessary, the other layers except for the light emitting layer may be omitted, and another necessary functional layer may be further added.

The organic light emitting device according to an exemplary embodiment of the present specification includes a first electrode; a first stack provided on the first electrode and including a first light emitting layer; a charge generation layer provided on the first stack; a second stack provided on the charge generation layer and including a second light emitting layer; and a second electrode provided on the second stack.

When the organic light emitting device according to an exemplary embodiment of the present specification has a two-stack structure as described above, one or more layers of the first light emitting layer (first stack light emitting layer) and the second light emitting layer (second stack light emitting layer) may include the composition for an organic light emitting device.

Furthermore, the first stack and the second stack may each independently further include one or more of the above-described hole injection layer, hole transport layer, hole blocking layer, electron transport layer, electron injection layer, and the like.

The composition for an organic material layer of an organic light emitting device may be used when an organic material layer of an organic light emitting device is formed, and particularly, may be preferably used as a material for the light emitting layer.

The composition for an organic material layer may be in the form of a premix of the heterocyclic compound of Chemical Formula A and the heterocyclic compound of Chemical Formula B, may be mixed with a material in a powder state before the organic material layer of the organic light emitting device is formed, and may be mixed with a compound in a liquid state at a suitable temperature or higher. The composition is in a solid state at a temperature which is equal to or less than the melting point of each material, and may be maintained as a liquid phase when the temperature is adjusted.

The composition for an organic material layer may additionally include materials publicly known in the art such as solvents and additives.

### <Method for manufacturing organic light emitting device>

In an exemplary embodiment of the present application, provided is a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer of an organic light emitting device according to an exemplary embodiment of the present specification.

According to an exemplary embodiment of the present specification, in the forming of the organic material layer, the heterocyclic compound represented by Chemical Formula A and the heterocyclic compound represented by Chemical Formula B may be formed using a thermal vacuum deposition method.

The organic light emitting device according to an exemplary embodiment of the present specification may be manufactured by typical manufacturing methods and materials of the organic light emitting device, except that the above-described composition for an organic material layer of an organic light emitting device is used to form an organic material layer.

Specifically, in the method of forming an organic material layer, when an organic light emitting device is manufactured, the organic material layer may be formed using the heterocyclic compound of Chemical Formula A and the heterocyclic compound of Chemical Formula B, not only by a vacuum deposition method but also by a solution coating method. Herein, the solution coating method means spin coating, dip coating, inkjet printing, screen printing, a spray method, roll coating, and the like, but is not limited thereto.

Hereinafter, the present specification will be described in more detail through Examples, but these Examples are provided only for exemplifying the present application, and are not intended to limit the scope of the present application.

### Preparation Examples.

### [Preparation Example 1] Preparation of Compound A006 and the like

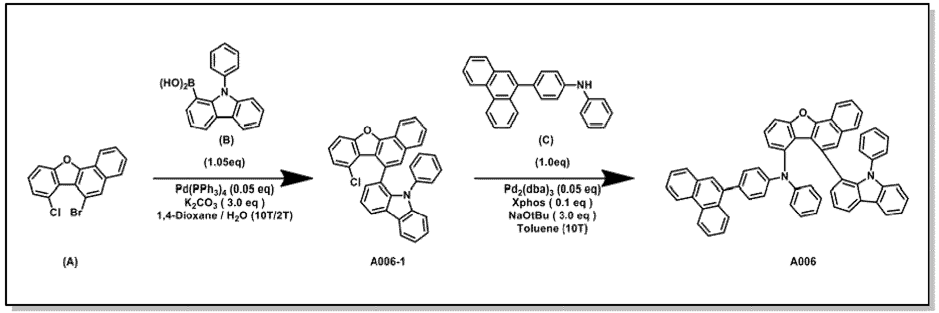

### 1) Preparation of Intermediate A006-1

After 10.0 g (30.16 mmol) of 6-bromo-7-chloronaphtho[1,2-b]benzofuran **(A),** 9.09 g (31.67 mmol) of (9-phenyl-9H-carbazol-1-yl)boronic acid **(B),** 1.74 g (1.51 mmol) of tetrakis(triphenylphosphine)palladium(0) (Pd(PPh₃)₄), and 12.5 g (90.47 mmol) of K₂CO₃ were dissolved in 1,4-dioxane/H₂O (100 ml/20 ml) in a 1 L two-neck flask, the resulting solution was refluxed for 1 hour. The reaction product was purified by recrystallization with methanol, and 14.15 g (yield 95%) of Intermediate A006-1 was obtained.

### 2) Preparation of Compound A006

After 14.15 g (28.5 mmol) of Intermediate A006-1, 9.9 g (28.5 mmol) of 4-(phenanthren-9-yl)-N-phenylaniline **(C),** 1.3 g (1.4 mmol) of tris(dibenzylideneacetone)dipalladium(0) (Pd₂(dba)₃), 1.37 g (2.86 mmol) of 2-dicyclohexylphosphino-2',4',6'-triisopropylbiphenyl (Xphos), and 8.26 g (85.95 mmol) of sodium tert-butoxide (NaOtBu) were put into a 5000 ml two-neck flask and dissolved in toluene (150 ml), the resulting solution was refluxed for 1 hour. The reaction product was purified by recrystallization with methanol, and 20.06 g (yield 87.2%, 83% when calculated based on starting materials) of Target Compound A006 was obtained.

The following target compound was synthesized in the same manner as in the method of preparing Compound A006, except that (A), (B), and (C) in the following Table 1 were used instead of (A), (B), and (C) in Preparation Example 1.

**[Table 1]**

| Target compound No. | (A) | (B) | (C) | Yield |
|---|---|---|---|---|
| A006 | 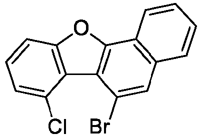 | 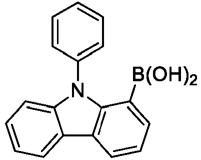 | 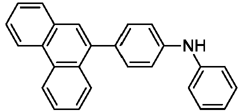 | 83% |
| A033 | 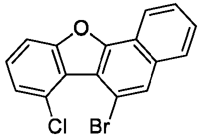 | 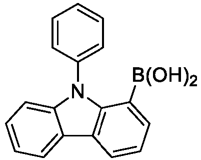 | 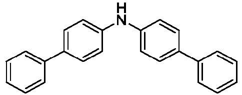 | 81% |
| A104 | 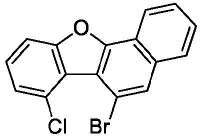 | 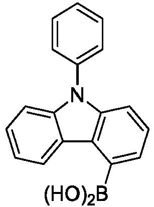 | 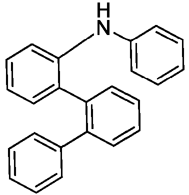 | 85% |
| A135 | 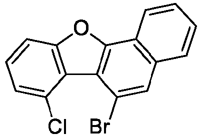 | 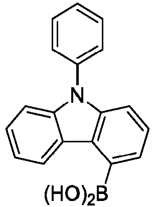 | 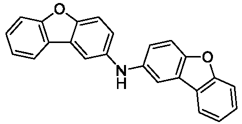 | 87% |
| A248 | 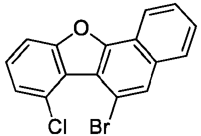 | 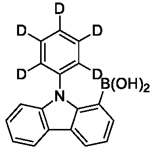 | 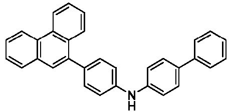 | 88% |
| A288 | 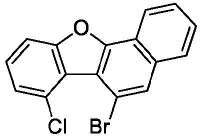 | 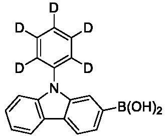 | 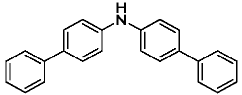 | 81% |
| A308 | 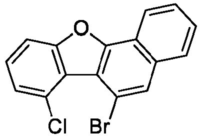 | 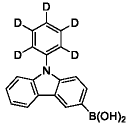 | 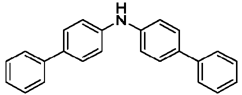 | 795 |
| A325 | 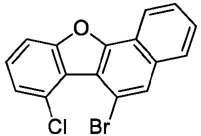 | 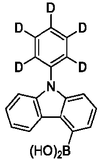 | 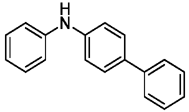 | 88% |
| A367 | 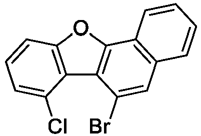 | 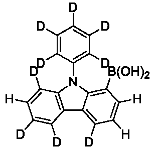 | 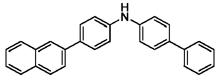 | 89% |
| A402 | 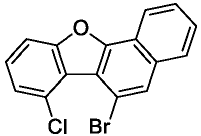 | 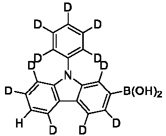 | 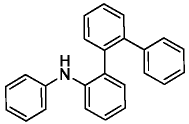 | 81% |
| A436 | 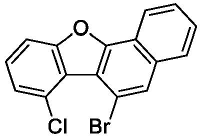 | 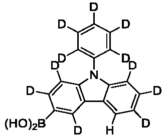 | 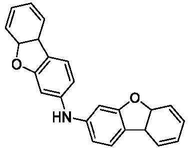 | 85% |
| A451 | 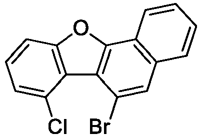 | 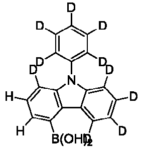 | 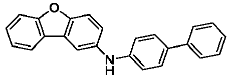 | 84% |
| A7 61 | 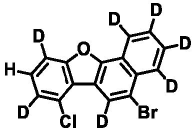 | 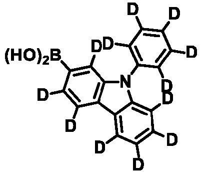 | 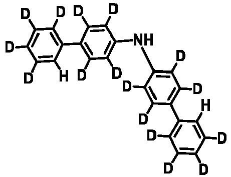 | 81% |
| A762 | 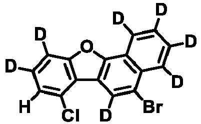 | 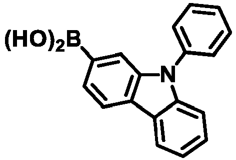 | 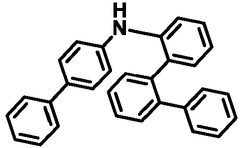 | 79% |
| A763 | 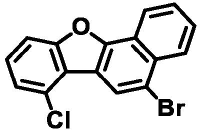 | 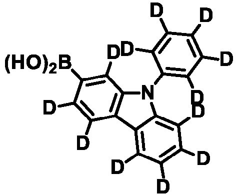 | 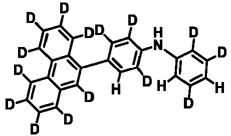 | 83% |
| A803 | 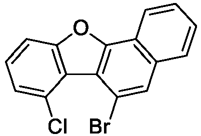 | 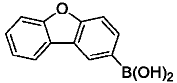 | 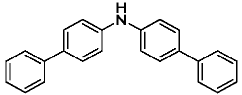 | 82% |
| A812 | 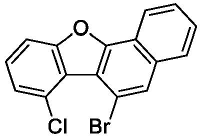 | 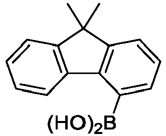 | 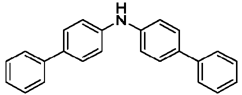 | 87% |
| A814 | 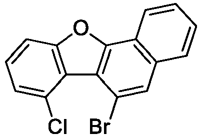 | 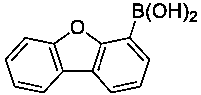 | 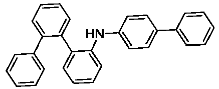 | 81% |
| A818 | 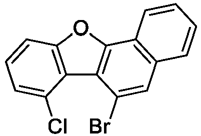 | 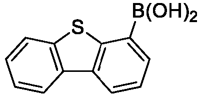 | 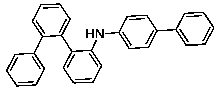 | 82% |
| A827 | 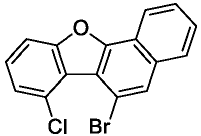 | 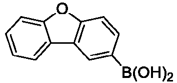 | 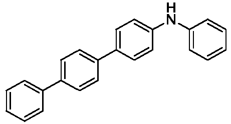 | 88% |
| A839 | 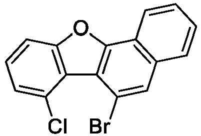 | 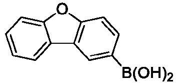 | 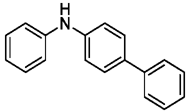 | 86% |
| A881 | 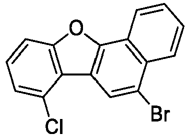 | 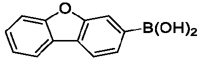 | 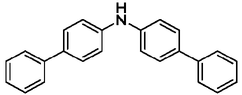 | 82% |
| A919 | 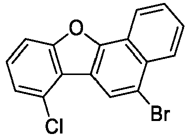 | 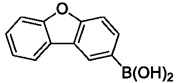 | 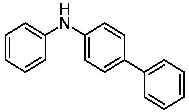 | 86% |
| A963 | 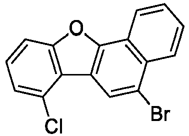 | 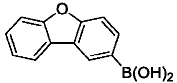 | 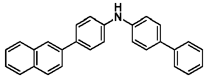 | 88% |
| A977 | 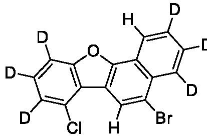 | 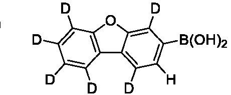 | 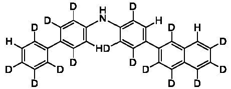 | 78% |
| A979 | 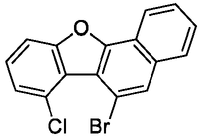 | 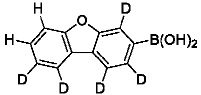 | 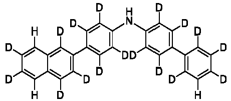 | 76% |
| A980 | 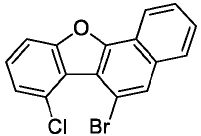 | 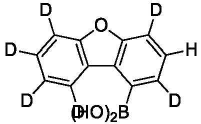 | 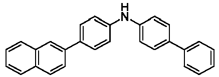 | 82% |
| A981 | 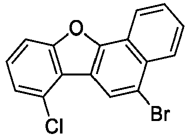 | 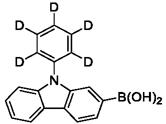 | 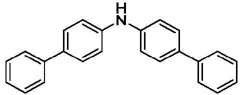 | 81% |
| A982 | 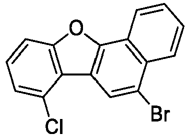 | 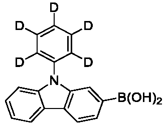 | 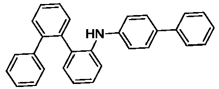 | 80% |
| A983 | 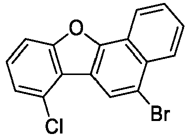 | 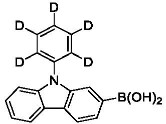 | 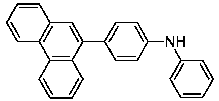 | 85% |
| A991 | 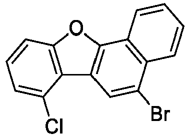 | 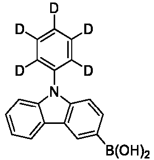 | 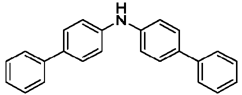 | 86% |
| A995 | 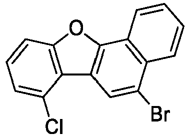 | 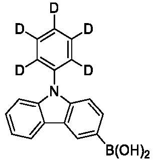 | 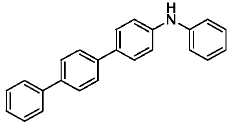 | 88% |
| A1000 | 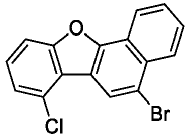 | 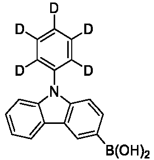 | 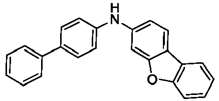 | 81% |
| A1026 | 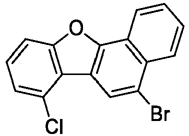 | 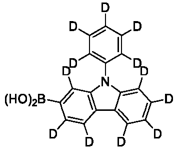 | 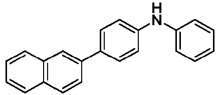 | 83% |
| A1031 | 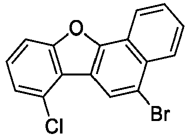 | 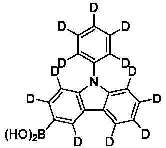 | 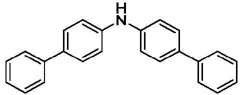 | 88% |

### [Preparation Example 2] Preparation of Compound A161 and the like

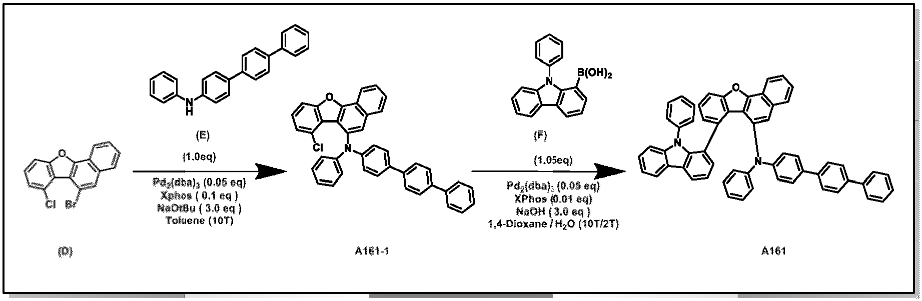

### 1) Preparation of Intermediate A161-1

After 10.0 g (30.16 mmol) of 6-bromo-7-chloronaphtho[1,2-b]benzofuran **(D),** 9.69 g (30.16 mmol) of N-phenyl-[1,1':4',1"-terphenyl]-4-amine **(E),** 1.38 g (1.51 mmol) of tris(dibenzylideneacetone)dipalladium(0) (Pd₂(dba)₃), 1.44 g (3.02 mmol) of 2-dicyclohexylphosphino-2',4',6'-triisopropylbiphenyl (Xphos), and 8.69 g (90.47 mmol) of sodium tert-butoxide (NaOtBu) were dissolved in toluene (100 ml) in a 1 L two-neck flask, the resulting solution was refluxed for 1 hour. The reaction product was purified by recrystallization with methanol, and 15.36 g (yield 89%) of Intermediate A161-1 was obtained.

### 2) Preparation of Compound A161

After 15.36 g (26.84 mmol) of Intermediate A161-1, 8.09 g (28.18 mmol) of (9-phenyl-9H-carbazol-1-yl)boronic acid **(F),** 1.23 g (1.34 mmol) of tris(dibenzylideneacetone)dipalladium(0) (Pd₂(dba)₃), 1.28 g (2.68 mmol) of 2-dicyclohexylphosphino-2',4',6'-triisopropylbiphenyl (Xphos), and 3.2 g (80.52 mmol) of NaOH were put into a 500 ml two-neck flask and dissolved in 1,4-dioxane/H₂O (100 ml/20 ml), the resulting solution was refluxed for 1 hour. The reaction product was purified by recrystallization with methanol, and 17.26 g (yield 82.5%, 73% when calculated based on starting materials) of Target Compound A161 was obtained.

The following compound was synthesized in the same manner as in the method of preparing Compound A161, except that (D), (E), and (F) in the following Table 2 were used instead of (D), (E), and (F) in Preparation Example 2.

**[Table 2]**

| Target compound No. | (D) | (E) | (F) | Yield |
|---|---|---|---|---|
| A161 | 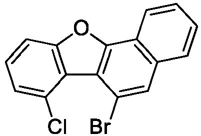 | 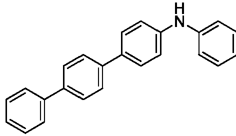 | 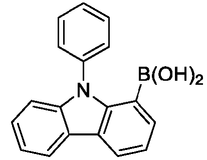 | 73% |
| A193 | 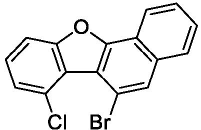 | 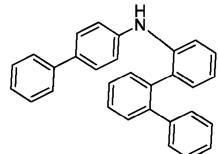 | 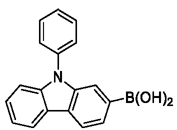 | 76% |
| A207 | 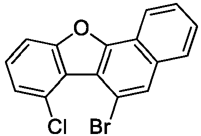 | 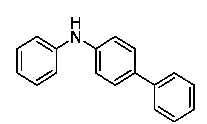 | 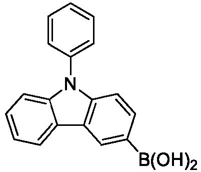 | 77% |
| A215 | 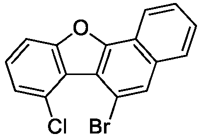 | 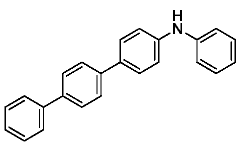 | 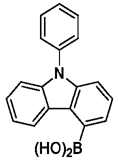 | 78% |
| A488 | 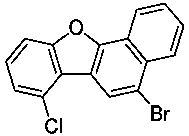 | 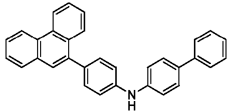 | 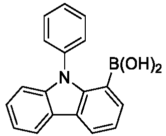 | 72% |
| A511 | 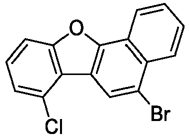 | 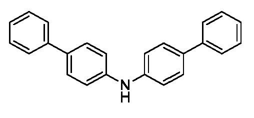 | 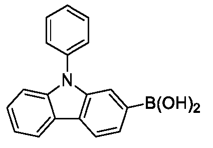 | 71% |
| A523 | 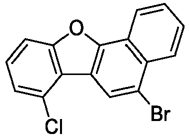 | 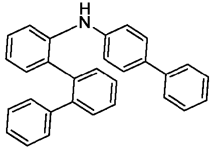 | 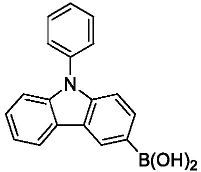 | 70% |
| A535 | 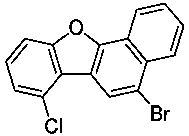 | 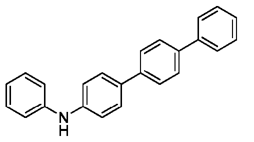 | 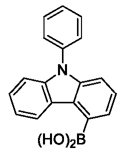 | 82% |
| A566 | 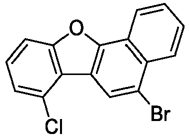 | 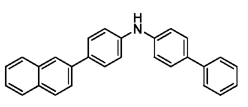 | 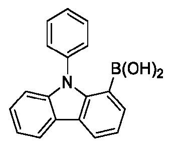 | 70% |
| A591 | 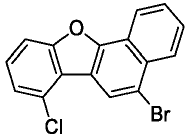 | 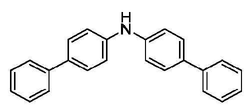 | 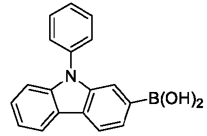 | 72% |
| A602 | 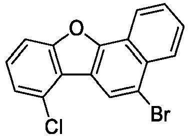 | 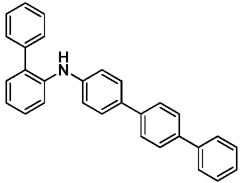 | 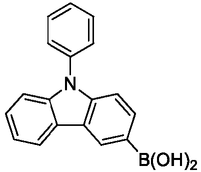 | 71% |
| A615 | 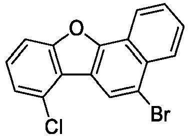 | 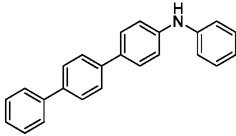 | 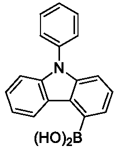 | 76% |
| A641 | 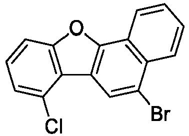 | 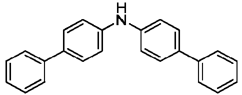 | 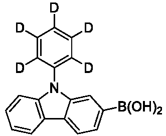 | 77% |
| A642 | 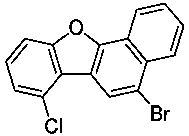 | 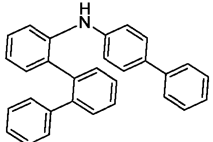 | 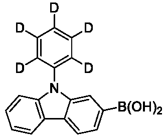 | 78% |
| A653 | 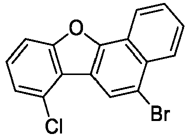 | 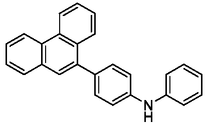 | 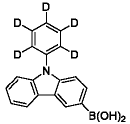 | 76% |
| A660 | 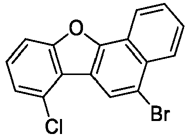 | 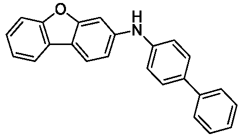 | 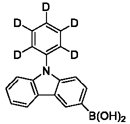 | 74% |
| A663 | 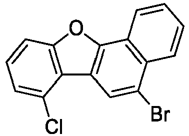 | 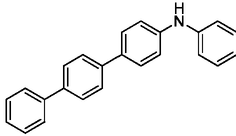 | 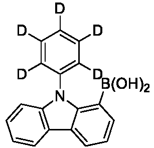 | 71% |
| A666 | 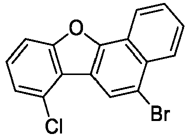 | 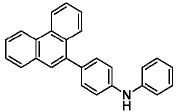 | 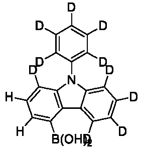 | 75% |
| A681 | 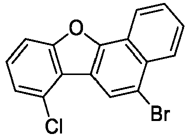 | 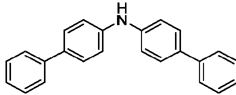 | 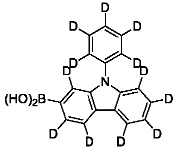 | 74% |
| A686 | 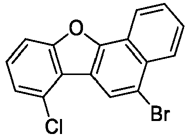 | 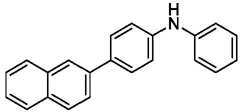 | 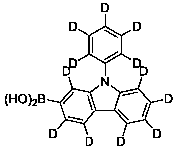 | 77% |
| A721 | 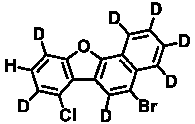 | 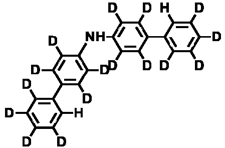 | 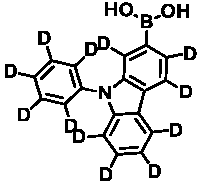 | 82% |
| A722 | 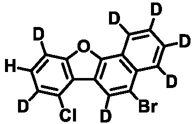 | 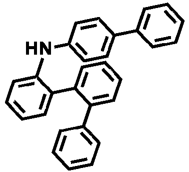 | 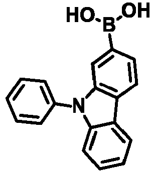 | 81% |
| A734 | 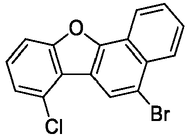 | 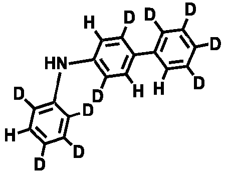 | 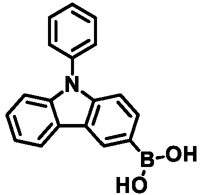 | 80% |
| A735 | 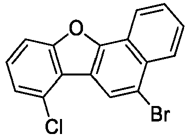 | 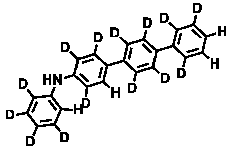 | 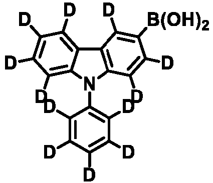 | 83% |
| A842 | 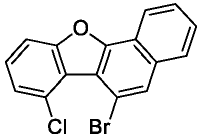 | 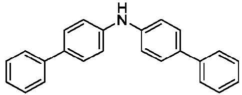 | 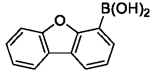 | 79% |
| A852 | 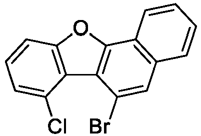 | 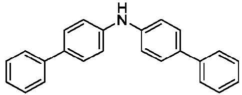 | 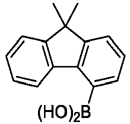 | 74% |
| A867 | 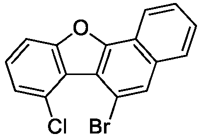 | 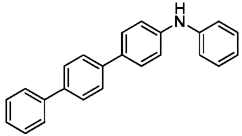 | 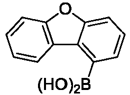 | 71% |
| A923 | 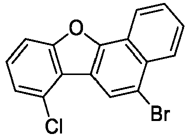 | 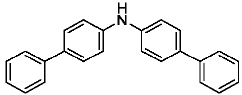 | 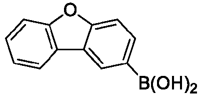 | 76% |
| A952 | 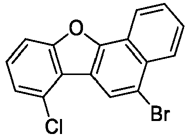 | 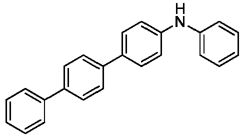 | 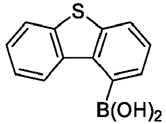 | 74% |
| A959 | 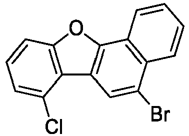 | 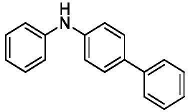 | 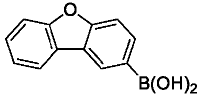 | 71% |

### [Preparation Example 3] Preparation of Compound A226 and the like

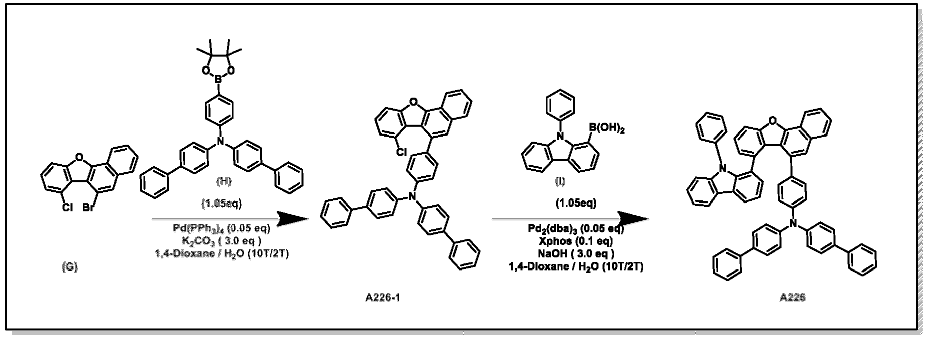

### 1) Preparation of Intermediate A226-1

After 10.0 g (30.16 mmol) of 6-bromo-7-chloronaphtho[1,2-b]benzofuran **(G),** 16.58 g (31.67 mmol) of N-([1,1'-biphenyl]-4-yl)-N-(4-(4,4,5,5-tetramethyl-1,3,2-dioxaborolan-2-yl)phenyl)-[1,1'-biphenyl]-4-amine **(H),** 1.74 g (1.51 mmol) of tetrakis(triphenylphosphine)palladium(0) (Pd(PPh₃)₄), and 12.5 g (90.47 mmol) of K₂CO₃ were dissolved in 1,4-dioxane/H₂O (100 ml/20 ml) in a 1 L two-neck flask, the resulting solution was refluxed for 1 hour. The reaction product was purified by recrystallization with methanol, and 17.87 g (yield 91.4%) of Intermediate A226-1 was obtained.

### 2) Preparation of Compound A226

After 17.87 g (27.56 mmol) of Intermediate A226-1, 7.9 g (27.56 mmol) of (9-phenyl-9H-carbazol-1-yl)boronic acid **(I),** 1.26 g (1.38 mmol) of tris(dibenzylideneacetone)dipalladium(0) (Pd₂(dba)₃), 1.31 g (2.76 mmol) of 2-dicyclohexylphosphino-2',4',6'-triisopropylbiphenyl (Xphos), and 3.31 g (28.69 mmol) of NaOH were put into a 500 ml two-neck flask and dissolved in 1,4-dioxane/H₂O (150 ml/30 ml), the resulting solution was refluxed for 1 hour. The reaction product was purified by recrystallization with methanol, and 19.92g (yield 84.5%, 74% when calculated based on starting materials) of Target Compound A226 was obtained.

The following target compound was synthesized in the same manner as in the method of preparing Compound A226, except that (G), (H), and (I) in the following Table 3 were used instead of (G), (H), and (I) in Preparation Example 3.

**[Table 3]**

| Target compound No. | (G) | (H) | (I) | Yield |
|---|---|---|---|---|
| A147 | 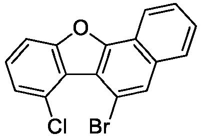 | 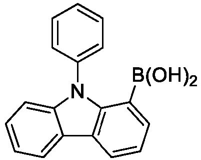 | 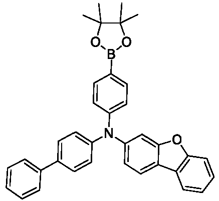 | 77% |
| A152 | 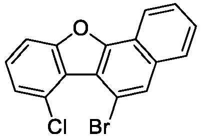 | 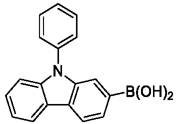 | 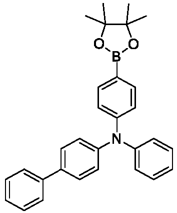 | 76% |
| A155 | 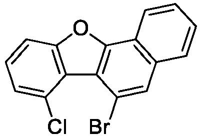 | 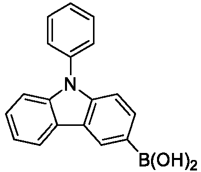 | 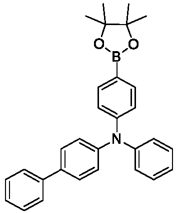 | 82% |
| A159 | 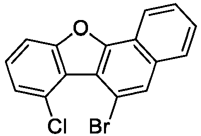 | 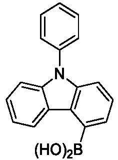 | 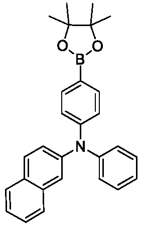 | 81% |
| A226 | 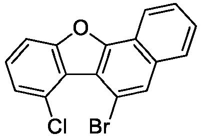 | 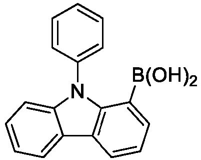 | 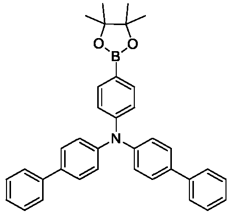 | 74% |
| A232 | 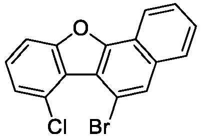 | 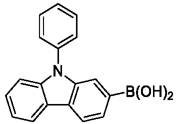 | 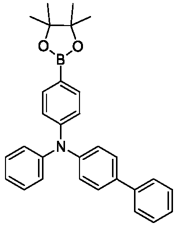 | 76% |
| A235 | 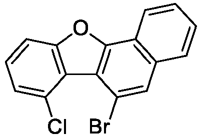 | 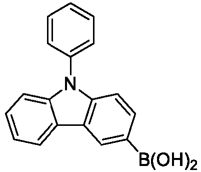 | 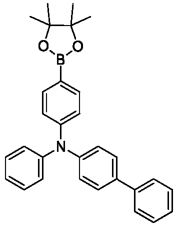 | 75% |
| A240 | 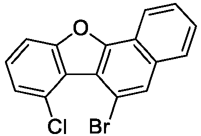 | 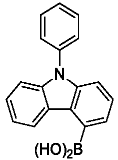 | 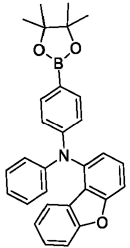 | 70% |
| A347 | 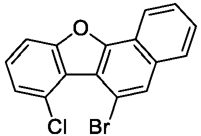 | 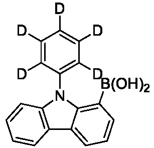 | 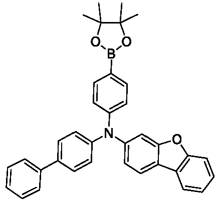 | 79% |
| A352 | 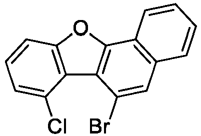 | 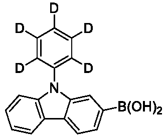 | 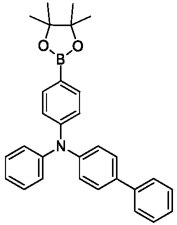 | 71% |
| A356 | 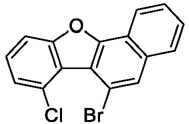 | 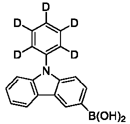 | 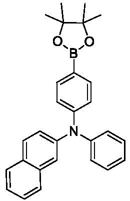 | 72% |
| A358 | 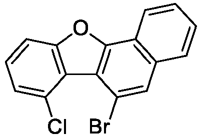 | 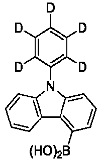 | 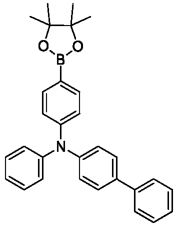 | 73% |
| A461 | 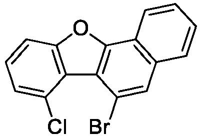 | 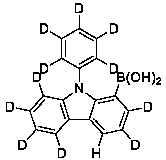 | 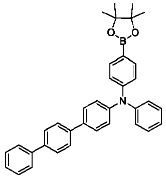 | 73% |
| A472 | 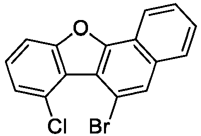 | 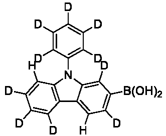 | 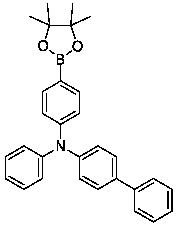 | 78% |
| A475 | 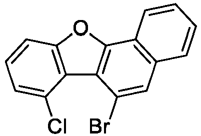 | 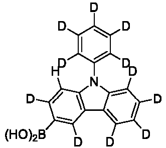 | 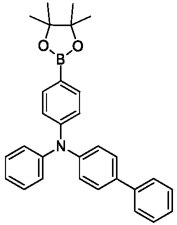 | 79% |
| A547 | 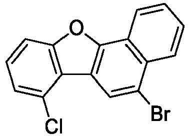 | 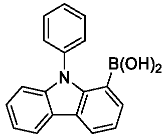 | 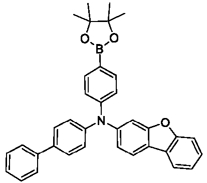 | 74% |
| A557 | 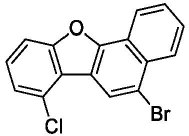 | 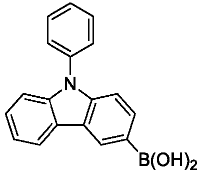 | 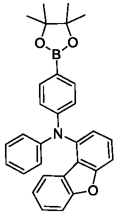 | 72% |
| A624 | 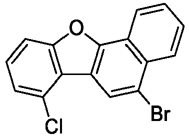 | 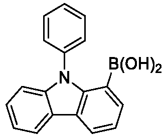 | 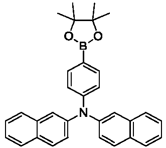 | 71% |
| A634 | 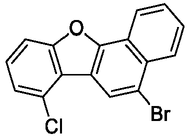 | 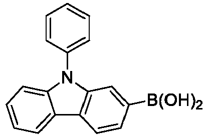 | 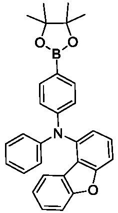 | 75% |
| A635 | 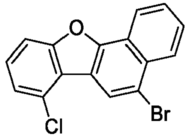 | 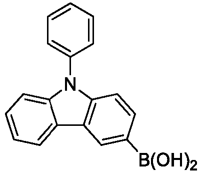 | 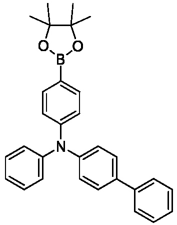 | 83% |
| A638 | 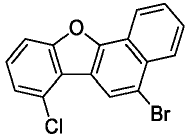 | 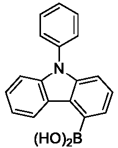 | 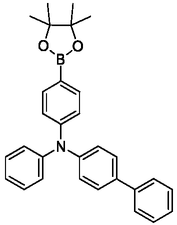 | 70% |
| A675 | 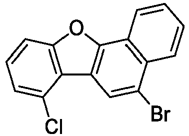 | 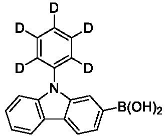 | 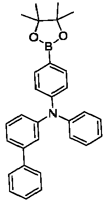 | 82% |
| A676 | 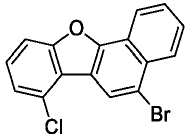 | 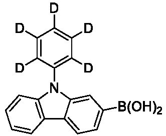 | 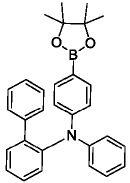 | 80% |
| A679 | 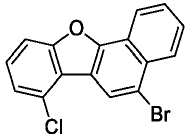 | 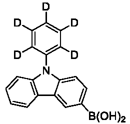 | 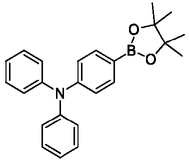 | 74% |
| A719 | 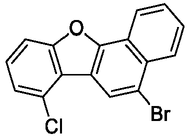 | 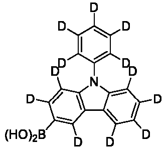 | 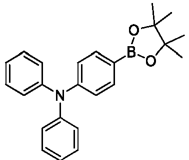 | 76% |
| A1014 | 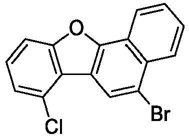 | 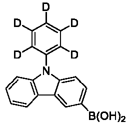 | 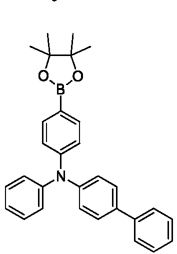 | 74% |
| A1020 | 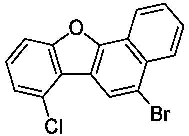 | 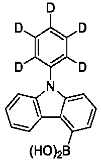 | 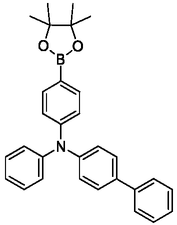 | 73% |

### [Preparation Example 4] Preparation of Compound B5 and the like

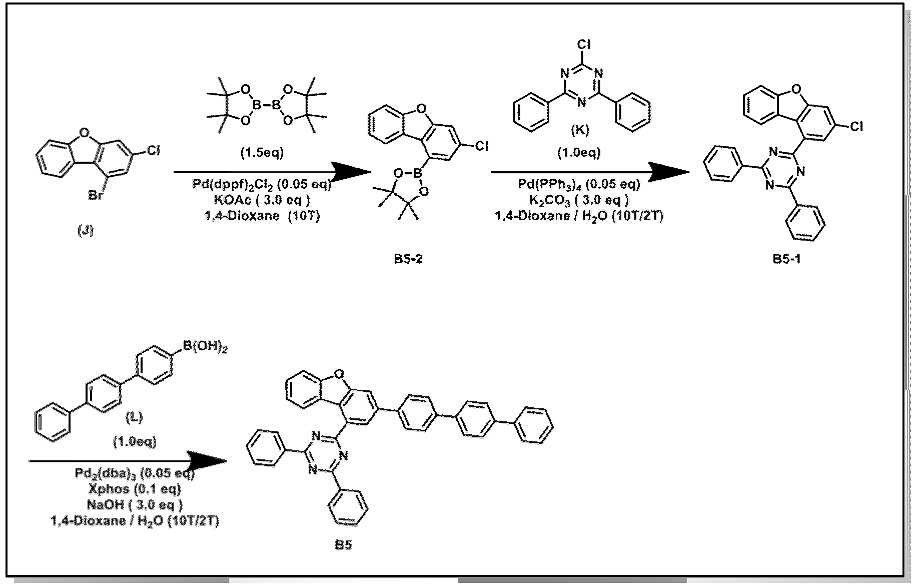

### 1) Preparation of Intermediate B5-2

After 10.0 g (35.52 mM) of 1-bromo-3-chlorodibenzo[b,d]furan **(J),** 9.47 g (37.30 mM) of 4,4,4',4',5,5,5',5'-octamethyl-2,2'-bi(1,3,2-dioxaborolane), 1.3 g (1.78 mmol) of Pd(dppf)Cl₂, and 10.46 g (106.56 mmol) of KOAc were dissolved in 1,4-dioxane (100 ml) in a 1 L two-neck flask, the resulting solution was refluxed for 2 hours. The reaction product was filtered, and then purified, and 10.32 g (yield 88.4%) of Intermediate B5-2 was obtained.

### 2) Preparation of Intermediate B5-1

After 10.32 g (31.40 mmol) of Intermediate B5-2, 8.41 g (31.40 mmol) of (2-chloro-4,6-diphenyl-1,3,5-triazine **(K),** 1.81 g (1.57 mmol) of tetrakis(triphenylphosphine)palladium(0) (Pd(PPh₃)₄), and 13.02 g (94.20 mmol) of K₂CO₃ were dissolved in 1,4-dioxane/H₂O (100 ml/20 ml) in a 500 ml two-neck flask, the resulting solution was refluxed for 1 hour. The reaction product was purified by recrystallization with methanol, and 11.63 g (yield 85.4%) of Target Compound B5-1 was obtained.

### 3) Preparation of Compound B5

After 11.63 g (26.82 mmol) of Intermediate B5-1, 7.35 g (26.82 mmol) of [1,1':4',1''-terphenyl]-4-ylboronic acid **(L),** 1.23 g (1.34 mmol) of tris(dibenzylideneacetone)dipalladium(0) (Pd₂(dba)₃), 1.28 g (2.68 mmol) of 2-dicyclohexylphosphino-2',4',6'-triisopropylbiphenyl (Xphos), and 3.22 g (80.45 mmol) of NaOH were put into a 500 ml two-neck flask and dissolved in 1,4-dioxane/H₂O (100 ml/20 ml), the resulting solution was refluxed for 1 hour. The reaction product was purified by recrystallization with methanol, and 15.32g (yield 91%, 69% when calculated based on starting materials) of Target Compound B5 was obtained.

The following compound was synthesized in the same manner as in the method of preparing Compound A161, except that (J), (K), and (L) in the following Table 4 were used instead of (J), (K), and (L) in Preparation Example 4.

**[Table 4]**

| Target compound No. | (J) | (K) | (L) | Yield |
|---|---|---|---|---|
| B5 | 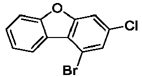 | 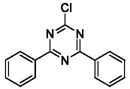 | 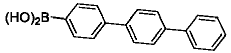 | 69% |
| B6 | 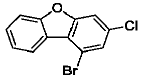 | 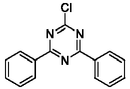 | 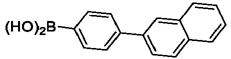 | 70% |
| B7 | 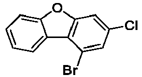 | 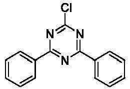 | 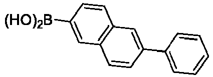 | 72% |
| B15 | 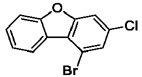 | 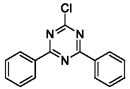 | 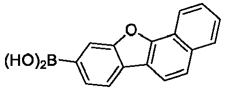 | 70% |
| B17 | 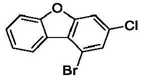 | 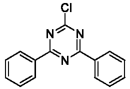 | 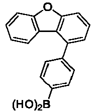 | 73% |
| B25 | 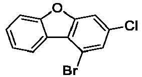 | 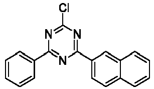 | 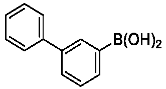 | 77% |
| B26 | 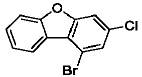 | 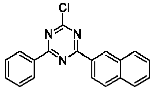 | 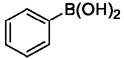 | 72% |
| B41 | 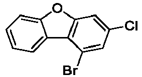 | 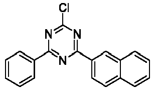 | 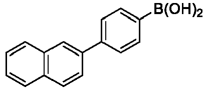 | 71% |
| B42 | 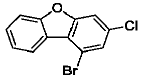 | 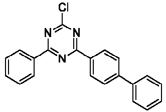 | 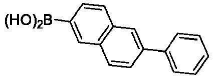 | 70% |
| B46 | 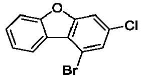 | 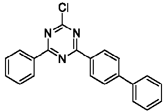 | 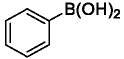 | 72% |
| B67 | 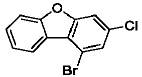 | 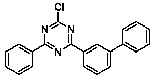 | 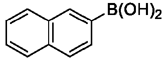 | 74% |
| B68 | 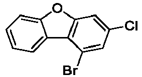 | 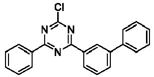 | 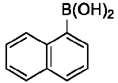 | 75% |
| B90 | 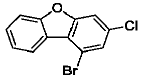 | 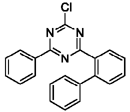 | 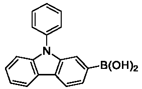 | 72% |
| B101 | 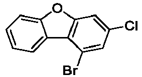 | 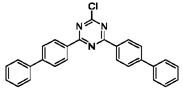 | 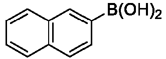 | 71% |
| B114 | 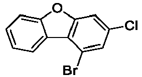 | 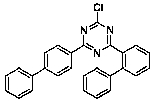 | 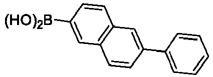 | 70% |
| B117 | 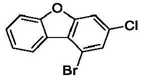 | 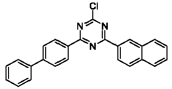 | 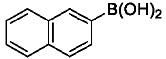 | 79% |
| B136 | 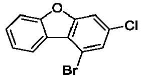 | 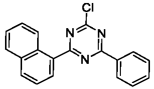 | 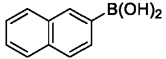 | 74% |
| B139 | 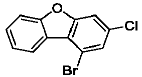 | 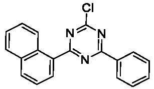 | 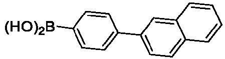 | 75% |
| B140 | 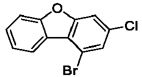 | 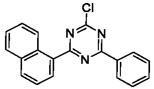 | 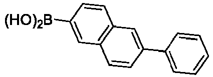 | 70% |
| B142 | 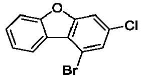 | 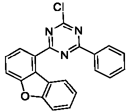 | 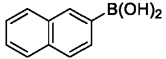 | 68% |
| B145 | 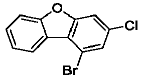 | 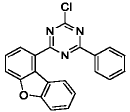 | 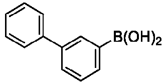 | 69% |
| B147 | 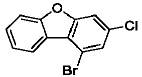 | 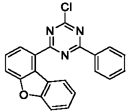 | 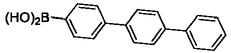 | 75% |
| B148 | 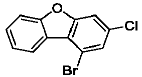 | 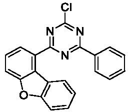 | 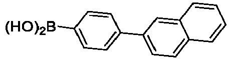 | 68% |
| B150 | 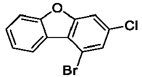 | 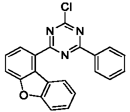 | 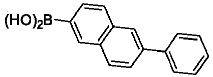 | 72% |
| B156 | 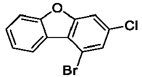 | 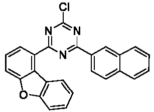 | 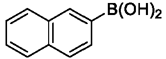 | 76% |
| B168 | 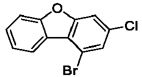 | 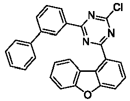 | 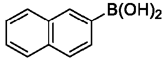 | 73% |
| B175 | 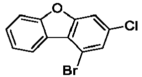 | 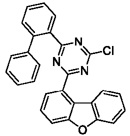 | 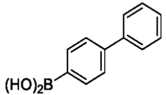 | 69% |
| B177 | 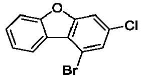 | 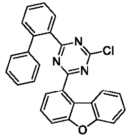 | 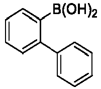 | 70% |
| B188 | 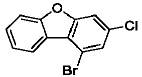 | 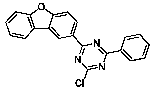 | 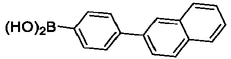 | 67% |
| B191 | 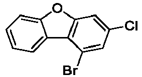 | 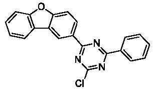 | 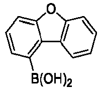 | 70% |
| B196 | 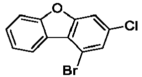 | 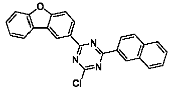 | 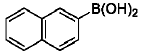 | 71% |
| B208 | 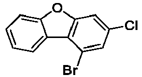 | 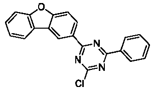 | 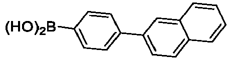 | 72% |
| B215 | 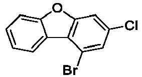 | 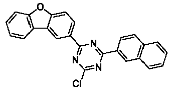 | 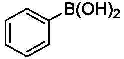 | 74% |
| B216 | 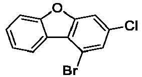 | 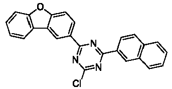 | 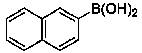 | 68% |
| B229 | 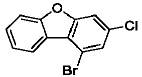 | 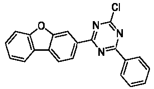 | 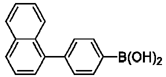 | 69% |
| B230 | 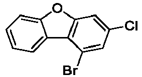 | 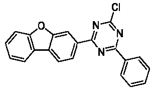 | 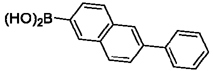 | 68% |
| B258 | 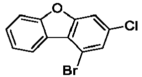 | 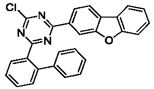 | 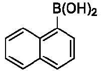 | 72% |
| B259 | 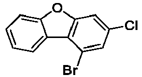 | 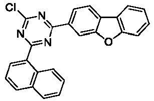 | 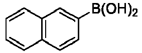 | 74% |
| B261 | 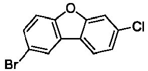 | 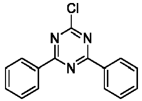 | 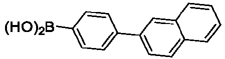 | 75% |
| B266 | 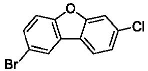 | 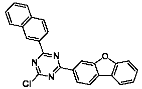 | 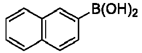 | 74% |
| B288 | 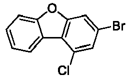 | 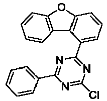 | 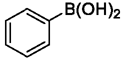 | 76% |
| B289 | 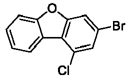 | 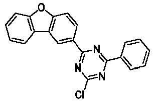 | 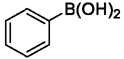 | 69% |
| B290 | 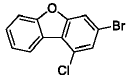 | 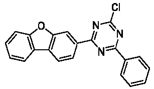 | 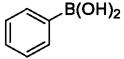 | 70% |
| B298 | 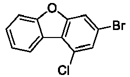 | 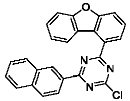 | 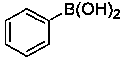 | 71% |
| B299 | 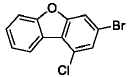 | 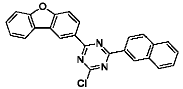 | 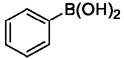 | 77% |
| B308 | 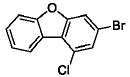 | 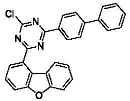 | 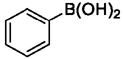 | 72% |
| B311 | 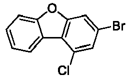 | 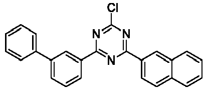 | 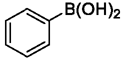 | 71% |
| B312 | 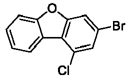 | 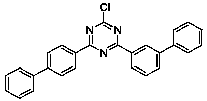 | 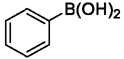 | 70% |
| B327 | 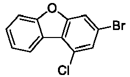 | 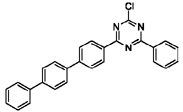 | 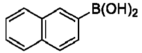 | 69% |
| B330 | 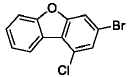 | 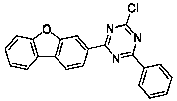 | 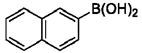 | 70% |
| B336 | 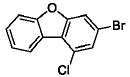 | 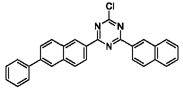 | 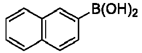 | 72% |
| B348 | 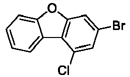 | 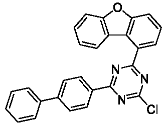 | 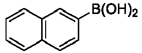 | 70% |
| B353 | 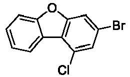 | 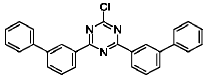 | 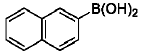 | 73% |
| B371 | 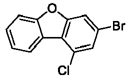 | 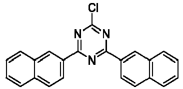 | 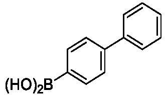 | 77% |
| B379 | 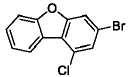 | 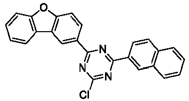 | 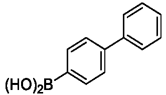 | 72% |
| B385 | 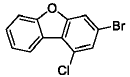 | 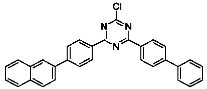 | 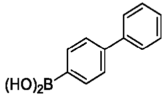 | 71% |
| B386 | 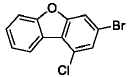 | 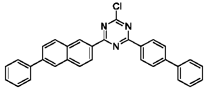 | 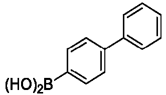 | 70% |
| B387 | 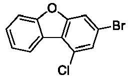 | 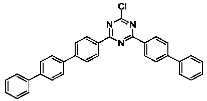 | 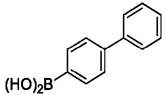 | 72% |
| B411 | 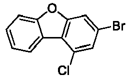 | 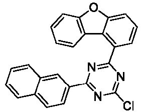 | 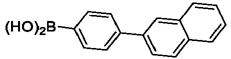 | 74% |
| B412 | 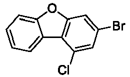 | 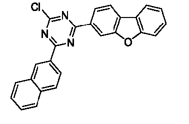 | 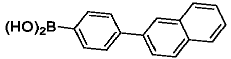 | 75% |
| B540 | 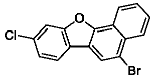 | 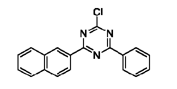 | 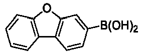 | 70% |
| B557 | 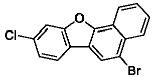 | 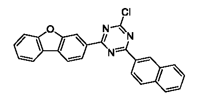 | 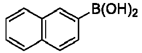 | 74% |
| B571 | 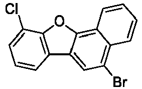 | 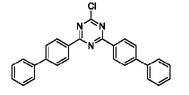 | 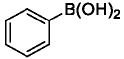 | 68% |
| B572 | 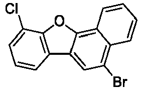 | 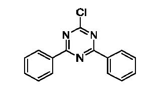 | 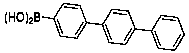 | 69% |
| B573 | 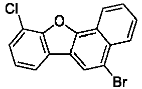 | 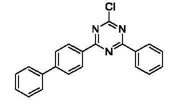 | 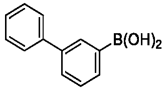 | 68% |
| B575 | 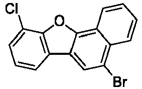 | 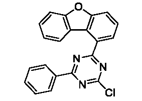 | 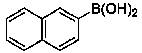 | 72% |
| B576 | 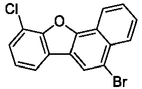 | 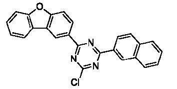 | 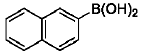 | 74% |
| B577 | 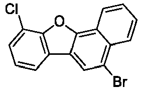 | 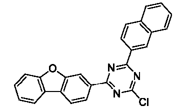 | 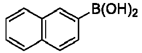 | 73% |
| B580 | 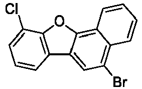 | 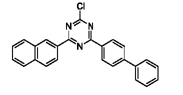 | 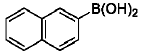 | 75% |
| B585 | 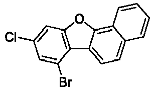 | 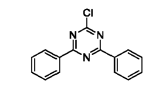 | 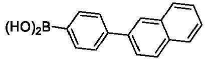 | 74% |
| B586 | 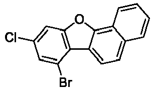 | 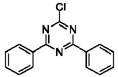 | 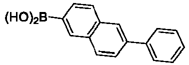 | 76% |
| B588 | 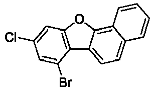 | 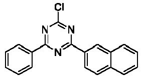 | 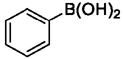 | 69% |
| B592 | 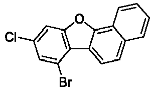 | 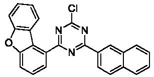 | 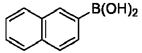 | 70% |
| B601 | 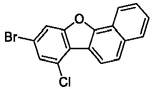 | 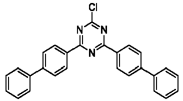 | 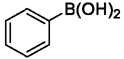 | 71% |
| B605 | 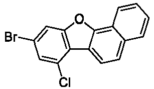 | 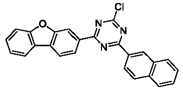 | 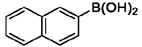 | 77% |
| B611 | 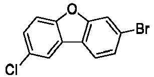 | 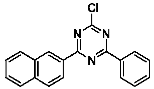 | 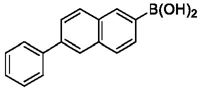 | 78% |
| B613 | 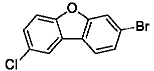 | 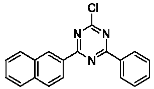 | 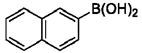 | 72% |
| B614 | 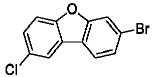 | 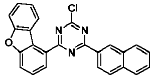 | 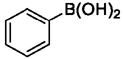 | 71% |
| B622 | 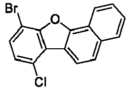 | 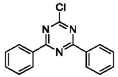 | 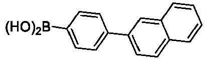 | 70% |
| B628 | 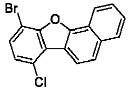 | 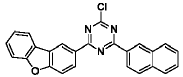 | 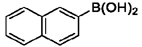 | 69% |
| B632 | 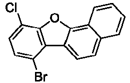 | 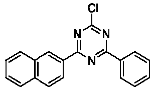 | 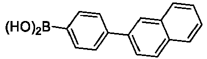 | 70% |
| B633 | 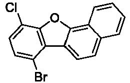 | 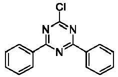 | 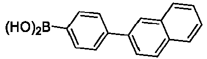 | 72% |
| B637 | 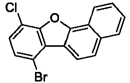 | 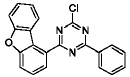 | 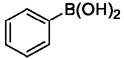 | 70% |
| B643 | 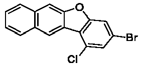 | 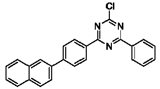 | 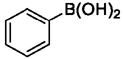 | 73% |
| B644 | 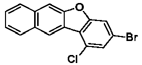 | 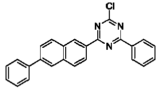 | 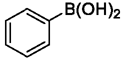 | 77% |
| B646 | 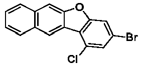 | 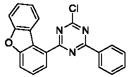 | 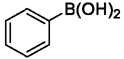 | 72% |
| B650 | 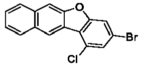 | 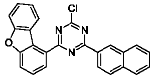 | 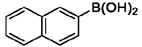 | 71% |
| B654 | 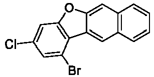 | 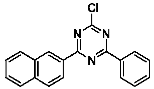 | 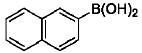 | 70% |
| B661 | 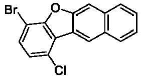 | 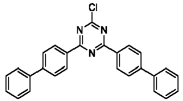 | 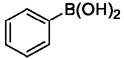 | 72% |
| B671 | 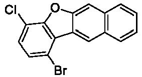 | 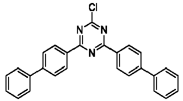 | 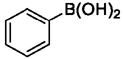 | 74% |
| B672 | 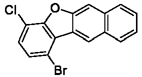 | 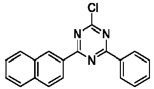 | 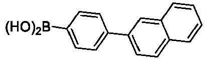 | 75% |
| B674 | 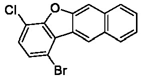 | 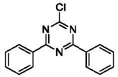 | 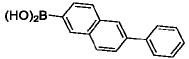 | 72% |
| B686 | 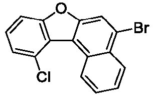 | 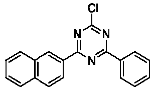 | 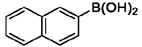 | 71% |
| B711 | 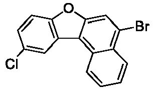 | 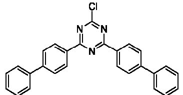 | 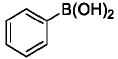 | 75% |
| B751 | 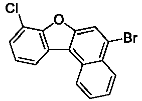 | 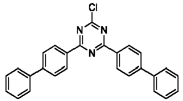 | 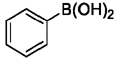 | 68% |
| B752 | 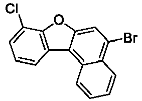 | 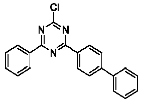 | 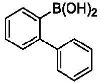 | 72% |
| B763 | 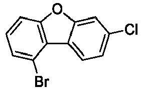 | 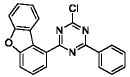 | 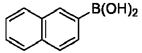 | 76% |
| B764 | 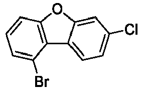 | 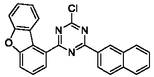 | 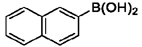 | 73% |
| B772 | 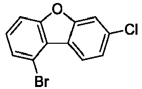 | 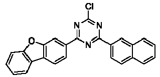 | 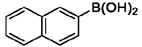 | 69% |
| B784 | 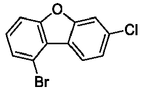 | 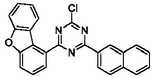 | 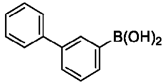 | 70% |
| B791 | 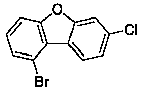 | 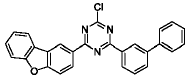 | 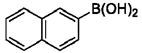 | 67% |
| B795 | 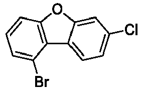 | 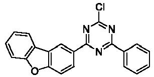 | 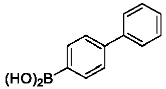 | 70% |

### [Preparation Example 5] Preparation of Compound B422 and the like

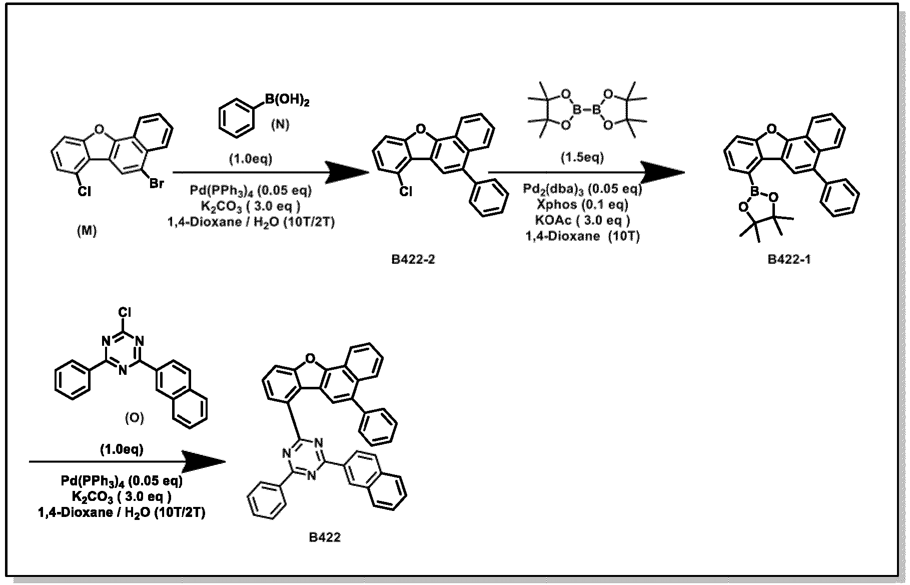

### 1) Preparation of Intermediate B422-2

After 10 g (30.31 mmol) of 5-bromo-7-chloronaphtho[1,2-b]benzofuran **(M),** 3.88 g (31.82 mmol) of phenylboronic acid **(n),** 1.75 g (1.52 mmol) of tetrakis(triphenylphosphine)palladium(0) (Pd(PPh₃)₄), and 12.57 g (90.96 mmol) of K₂CO₃ were put into a 500 mL two-neck flask and dissolved in 1,4-dioxane/H₂O (100 ml/20 ml), the resulting solution was refluxed for 1 hour. The reaction product was purified by recrystallization with methanol, and 9.15 g (92%) of Target Compound B422-2 was obtained.

### 2) Preparation of Intermediate B422-1

After 9.15 g (27.88 mmol) of Intermediate B422-2, 10.62 g (41.83 mmol) of 4,4,4',4',5,5,5',5'-octamethyl-2,2'-bi(1,3,2-dioxaborolane), 1.28 g (1.39 mmol) of Pd₂(dba)₃, 1.33 g (2.79 mmol) of Xphos, and 12.31 g (125.48 mmol) of KOAc were dissolved in 1,4-dioxane (100 ml) in a 1 L two-neck flask, the resulting solution was refluxed for 2 hours. The reaction product was filtered, and then purified, and 10.08 g (yield 86%) of Intermediate B442-1 was obtained.

### 3) Preparation of Compound B422

After 10.08 g (23.98 mmol) of Intermediate B5-1, 7.6 g (23.98 mmol) of 2-chloro-4-(naphthalen-2-yl)-6-phenyl-1,3,5-triazine **(O),** 1.39 g (1.99 mmol) of tetrakis(triphenylphosphine)palladium(0) (Pd(PPh₃)₄), and 9.94 g (71.94 mmol) of K₂CO₃ were dissolved in 1,4-dioxane/H₂O (100 ml/20 ml) in a 500 ml two-neck flask, the resulting solution was refluxed for 1 hour. The reaction product was purified by recrystallization with methanol, and 12.55g (yield 91%, 72% when calculated based on starting materials) of Target Compound B422 was obtained.

The following compound was synthesized in the same manner as in the method of preparing Compound B422, except that (M), (N), and (O) in the following Table 5 were used instead of (M), (N), and (O) in Preparation Example 5.

**[Table 5]**

| Target compound No. | (M) | (N) | (O) | Yield |
|---|---|---|---|---|
| B422 | 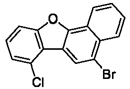 | 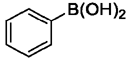 | 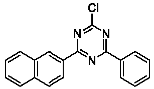 | 72% |
| B423 | 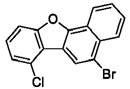 | 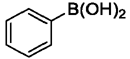 | 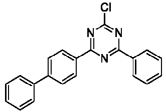 | 71% |
| B424 | 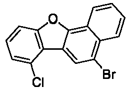 | 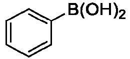 | 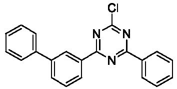 | 70% |
| B441 | 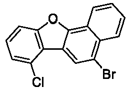 | 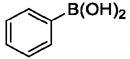 | 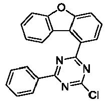 | 79% |
| B442 | 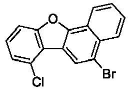 | 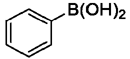 | 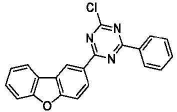 | 74% |
| B445 | 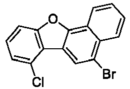 | 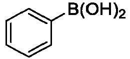 | 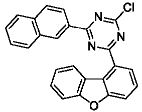 | 75% |
| B451 | 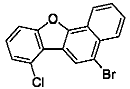 | 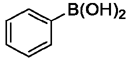 | 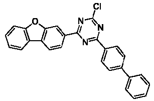 | 70% |
| B457 | 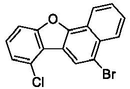 | 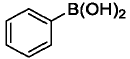 | 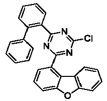 | 68% |
| B461 | 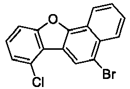 | 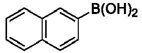 | 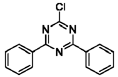 | 69% |
| B470 | 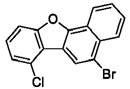 | 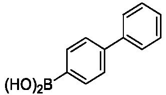 | 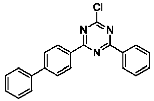 | 75% |
| B485 | 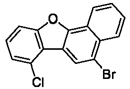 | 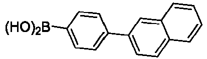 | 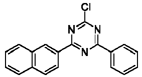 | 68% |
| B490 | 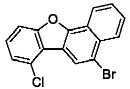 | 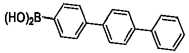 | 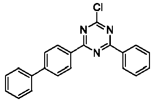 | 72% |
| B495 | 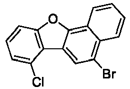 | 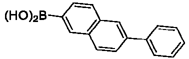 | 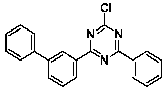 | 76% |
| B497 | 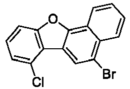 | 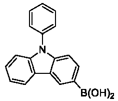 | 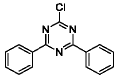 | 73% |
| B507 | 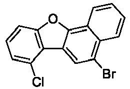 | 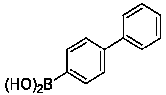 | 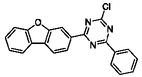 | 69% |
| B524 | 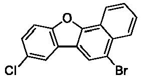 | 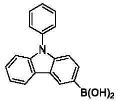 | 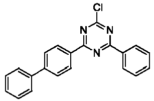 | 70% |
| B526 | 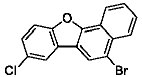 | 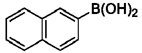 | 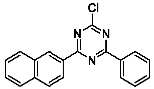 | 67% |
| B541 | 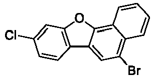 | 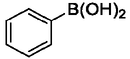 | 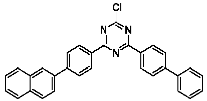 | 71% |
| B543 | 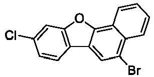 | 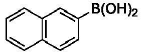 | 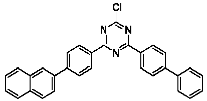 | 72% |
| B687 | 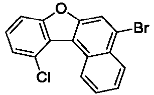 | 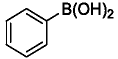 | 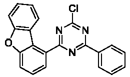 | 70% |
| B697 | 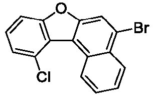 | 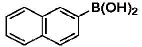 | 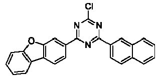 | 79% |
| B703 | 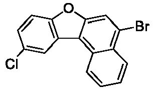 | 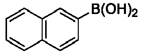 | 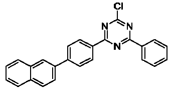 | 74% |
| B721 | 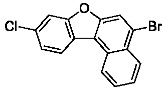 | 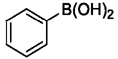 | 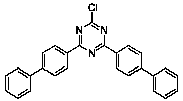 | 70% |
| B722 | 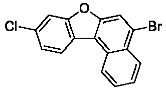 | 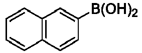 | 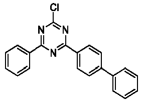 | 68% |
| B742 | 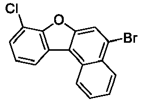 | 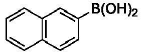 | 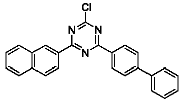 | 69% |
| B747 | 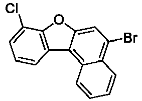 | 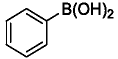 | 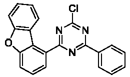 | 75% |

The following Tables 6 and 7 are the ¹H NMR and FD-MS data of the compounds, and it can be confirmed through the following data that the target compound was synthesized.

**[Table 6]**

| Target Compound No. | ¹H NMR(CDCl₃, 400MHz) |
|---|---|
| A6 | 8.93 (2H, s), 8.51 (1H, d), 8.3 (1H, d), 8.12 (3H, d), 8 (2H, d), 7.93 (1H, d), 7.88 (2H, d), 7.82 (2H, d), 7.63 (1H, d), 7.59 (2H, dd), 7.58 (2H, d), 7.54 (2H, d), 7.5 (3H, dd), 7.45 (1H, dd), 7.35 (1H, s), 7.31 (1H, t), 7.29 (1H, t), 7.2 (2H, dd), 7.13 (1H, dd), 7.02 (1H, t), 6.81 (1H, d), 6.69 (2H, d), 6.63 (2H, d) |
| A33 | 8.51 (1H, s), 8.3 (1H, d), 8.12 (1H, d), 8 (2H, d), 7.63 (1H, d), 7.59 (2H, d), 7.58 (2H, d), 7.54 (4H, d), 7.52 (4H, d), 7.51 (4H, dd), 7.5 (3H, d), 7.45 (1H, d), 7.41 (2H, dd), 7.35 (1H, dd), 7.31 (1H, s), 7.29 (1H, t), 7.13 (1H, t), 7.02 (1H, dd), 6.69 (4H, dd), 6.33 (1H, t) |
| A104 | 8.55 (1H, d), 8 (2H, d), 7.94 (1H, t), 7.87 (1H, dd), 7.85 (2H, d), 7.79 (2H, d), 7.77 (1H, s), 7.69 (1H, s), 7.59 (2H, d), 7.58 (2H, d), 7.54 (1H, s), 7.51 (2H, d), 7.5 (2H, d), 7.47 (2H, d), 7.45 (1H, s), 7.41 (1H, s), 7.35 (1H, s), 7.33 (1H, s), 7.25 (1H, s), 7.2 (2H, d), 7.16 (1H, s), 7.13 (1H, s), 7.02 (1H, s), 6.87 (1H, s), 6.81 (1H, s), 6.69 (1H, s), 6.63 (2H, d), 6.33 (1H, s) |
| A135 | 8.55 (1H, s), 8 (2H, d), 7.94 (1H, d), 7.89 (2H, d), 7.79 (1H, d), 7.66 (2H, d), 7.65 (2H, d), 7.59 (3H, d), 7.58 (2H, d), 7.5 (2H, dd), 7.45 (1H, d), 7.43 (1H, d), 7.41 (2H, dd), 7.38 (2H, dd), 7.35 (1H, s), 7.33 (1H, t), 7.32 (2H, t), 7.25 (1H, dd), 7.13 (1H, dd), 7.02 (1H, t), 6.39 (2H, d), 6.33 (1H, d) |
| A147 | 8.51 (1H, s), 8.3 (1H, d), 8.12 (1H, d), 8 (2H, d), 7.89 (1H, d), 7.75 (1H, d), 7.66 (1H, d), 7.64 (1H, d), 7.63 (1H, d), 7.62 (1H, dd), 7.59 (2H, d), 7.58 (2H, d), 7.54 (4H, dd), 7.52 (2H, dd), 7.51 (2H, s), 7.5 (3H, t), 7.45 (1H, t), 7.44 (1H, dd), 7.43 (1H, dd), 7.41 (1H, t), 7.38 (1H, d), 7.35 (1H, d), 7.32 (1H, d), 7.31 (1H, ), 7.29 (1H, s), 6.69 (4H, d), 6.33 (1H, dd) |
| A152 | 8.49 (1H, s), 8.12 (1H, d), 8.1 (1H, d), 8 (2H, d), 7.75 (1H, d), 7.63 (1H, d), 7.62 (2H, d), 7.59 (2H, d), 7.58 (2H, d), 7.54 (4H, dd), 7.52 (2H, d), 7.51 (2H, d), 7.5 (3H, dd), 7.45 (1H, dd), 7.44 (1H, s), 7.41 (1H, t), 7.35 (1H, t), 7.29 (1H, dd), 7.2 (2H, dd), 6.81 (1H, t), 6.69 (4H, d), 6.63 (2H, d) |
| A155 | 8.55 (1H, s), 8 (2H, d), 7.94 (1H, d), 7.87 (1H, d), 7.77 (1H, d), 7.75 (1H, d), 7.69 (1H, d), 7.62 (1H, d), 7.59 (2H, d), 7.58 (2H, dd), 7.54 (4H, d), 7.52 (2H, d), 7.51 (2H, dd), 7.5 (2H, dd), 7.45 (1H, s), 7.44 (1H, t), 7.41 (1H, t), 7.35 (1H, dd), 7.33 (1H, dd), 7.25 (1H, t), 7.2 (2H, d), 6.81 (1H, d), 6.69 (4H, d), 6.63 (2H, dd) |
| A159 | 8.12 (1H, s), 8.1 (1H, d), 8 (2H, d), 7.9 (1H, d), 7.88 (1H, d), 7.84 (1H, d), 7.77 (1H, d), 7.75 (1H, d), 7.74 (1H, d), 7.63 (1H, dd), 7.62 (1H, d), 7.59 (2H, d), 7.58 (2H, dd), 7.54 (2H, dd), 7.5 (4H, s), 7.49 (1H, t), 7.45 (1H, t), 7.44 (1H, dd), 7.39 (1H, dd), 7.36 (1H, t), 7.35 (1H, d), 7.29 (1H, d), 7.2 (2H, d), 6.81 (1H, ), 6.69 (2H, dd), 6.63 (2H, dd) |
| A161 | 8.55 (1H, d), 8.08 (1H, s), 8 (2H, s), 7.94 (1H, d), 7.87 (1H, d), 7.75 (1H, d), 7.62 (1H, d), 7.59 (2H, d), 7.58 (2H, d), 7.54 (2H, dd), 7.52 (2H, d), 7.51 (2H, d), 7.5 (2H, dd), 7.45 (1H, dd), 7.44 (1H, s), 7.41 (1H, t), 7.35 (1H, t), 7.33 (1H, dd), 7.25 (5H, dd), 7.21 (1H, t), 7.2 (2H, d), 6.81 (1H, d), 6.69 (2H, d), 6.63 (2H, s) |
| A193 | 8.55 (1H, d), 8.18 (1H, s), 8 (2H, s), 7.94 (1H, d), 7.85 (2H, d), 7.79 (3H, d), 7.75 (1H, d), 7.62 (2H, d), 7.59 (2H, d), 7.58 (2H, dd), 7.54 (3H, d), 7.52 (2H, d), 7.51 (4H, dd), 7.5 (2H, dd), 7.47 (2H, s), 7.45 (1H, t), 7.44 (1H, t), 7.41 (2H, dd), 7.33 (1H, dd), 7.25 (1H, t), 7.21 (1H, d), 7.16 (1H, d), 6.87 (1H, d), 6.69 (3H, t) |
| A207 | 8.55 (1H, d), 8 (2H, s), 7.94 (1H, s), 7.87 (1H, d), 7.77 (1H, d), 7.75 (1H, d), 7.69 (1H, d), 7.62 (1H, d), 7.59 (2H, d), 7.58 (2H, dd), 7.54 (2H, d), 7.52 (2H, d), 7.51 (2H, dd), 7.5 (2H, dd), 7.45 (1H, s), 7.44 (1H, t), 7.41 (1H, t), 7.33 (1H, dd), 7.25 (1H, dd), 7.21 (1H, t), 7.2 (2H, d), 6.81 (1H, d), 6.69 (2H, d), 6.63 (2H, t) |
| A215 | 8.55 (1H, d), 8 (2H, s), 7.94 (1H, s), 7.79 (1H, d), 7.75 (1H, d), 7.62 (1H, d), 7.59 (3H, d), 7.58 (2H, d), 7.54 (2H, d), 7.52 (2H, dd), 7.51 (2H, d), 7.5 (2H, d), 7.45 (1H, dd), 7.44 (1H, dd), 7.43 (1H, s), 7.41 (1H, t), 7.33 (1H, t), 7.25 (5H, dd), 7.21 (1H, dd), 7.2 (2H, t), 6.81 (1H, d), 6.69 (2H, d), 6.63 (2H, d) |
| A226 | 8.51 (1H, d), 7.62 (1H, s), 7.63 (1H, s), 8.12 (1H, d), 7.5 (3H, d), 6.69 (6H, d), 7.35 (1H, d), 7.75 (1H, d), 7.44 (1H, d), 7.29 (1H, dd), 7.54 (6H, d), 7.52 (4H, d), 8.3 (1H, dd), 7.31 (1H, dd), 8 (2H, s), 7.58 (2H, t), 7.59 (2H, t), 7.51 (4H, dd), 7.45 (1H, dd), 7.41 (2H, t) |
| A232 | 8.49 (1H, d), 8.12 (1H, s), 8.1 (1H, s), 8 (2H, d), 7.75 (1H, d), 7.63 (1H, d), 7.62 (2H, d), 7.59 (2H, d), 7.58 (2H, d), 7.54 (4H, dd), 7.52 (2H, d), 7.51 (2H, d), 7.5 (3H, dd), 7.45 (1H, dd), 7.44 (1H, s), 7.41 (1H, t), 7.35 (1H, t), 7.29 (1H, dd), 7.2 (2H, dd), 6.81 (1H, t), 6.69 (4H, d), 6.63 (2H, d) |
| A235 | 8.55 (1H, d), 8 (2H, s), 7.94 (1H, s), 7.87 (1H, d), 7.77 (1H, d), 7.75 (1H, d), 7.69 (1H, d), 7.62 (1H, d), 7.59 (2H, d), 7.58 (2H, dd), 7.54 (4H, d), 7.52 (2H, d), 7.51 (2H, dd), 7.5 (2H, dd), 7.45 (1H, s), 7.44 (1H, t), 7.41 (1H, t), 7.35 (1H, dd), 7.33 (1H, dd), 7.25 (1H, t), 7.2 (2H, d), 6.81 (1H, d), 6.69 (4H, d), 6.63 (2H, s) |
| A240 | 8.12 (1H, d), 8.1 (1H, s), 8 (2H, s), 7.9 (1H, d), 7.89 (1H, d), 7.75 (1H, d), 7.66 (1H, d), 7.63 (1H, d), 7.62 (1H, d), 7.59 (2H, dd), 7.58 (2H, d), 7.54 (2H, d), 7.5 (3H, dd), 7.45 (1H, dd), 7.44 (1H, s), 7.39 (1H, t), 7.38 (1H, t), 7.35 (1H, dd), 7.32 (1H, dd), 7.29 (1H, t), 7.2 (2H, d), 7.13 (1H, d), 7.02 (1H, d), 6.81 (1H, t), 6.69 (2H, r), 6.63 (2H, m), 6.33 (1H, s) |
| A248 | 8.93 (2H, d), 8.51 (1H, s), 8.3 (1H, s), 8.12 (3H, d), 8 (2H, d), 7.93 (1H, d), 7.88 (2H, d), 7.82 (2H, d), 7.63 (1H, d), 7.59 (2H, dd), 7.54 (4H, d), 7.52 (2H, d), 7.51 (2H, dd), 7.5 (1H, dd), 7.41 (1H, s), 7.35 (1H, t), 7.31 (1H, t), 7.29 (1H, dd), 7.13 (1H, dd), 7.02 (1H, t), 6.69 (4H, d), 6.33 (1H, d) |
| A288 | 8.49 (1H, d), 8.12 (1H, s), 8.1 (1H, s), 8 (2H, d), 7.63 (1H, d), 7.62 (1H, d), 7.59 (2H, d), 7.54 (4H, d), 7.52 (4H, d), 7.51 (4H, dd), 7.5 (1H, d), 7.41 (2H, d), 7.35 (1H, dd), 7.29 (1H, dd), 7.13 (1H, s), 7.02 (1H, t), 6.69 (4H, t), 6.33 (1H, dd) |
| A308 | 8.55 (1H, d), 8 (2H, s), 7.94 (1H, s), 7.87 (1H, d), 7.77 (1H, d), 7.69 (1H, d), 7.59 (2H, d), 7.54 (4H, d), 7.52 (4H, d), 7.51 (4H, dd), 7.41 (2H, d), 7.35 (1H, d), 7.33 (1H, dd), 7.25 (1H, dd), 7.13 (1H, s), 7.02 (1H, t), 6.69 (4H, t), 6.33 (1H, dd) |
| A325 | 8.55 (1H, d), 8 (2H, s), 7.94 (1H, s), 7.79 (1H, d), 7.59 (3H, d), 7.54 (2H, d), 7.52 (2H, d), 7.51 (2H, d), 7.43 (1H, d), 7.41 (1H, dd), 7.35 (1H, d), 7.33 (1H, d), 7.25 (1H, dd), 7.2 (2H, dd), 7.13 (1H, s), 7.02 (1H, t), 6.81 (1H, t), 6.69 (2H, dd), 6.63 (2H, dd), 6.33 (1H, t) |
| A347 | 8.51 (1H, d), 8.3 (1H, s), 8.12 (1H, s), 8 (2H, d), 7.89 (1H, d), 7.75 (1H, d), 7.66 (1H, d), 7.64 (1H, d), 7.63 (1H, d), 7.62 (1H, dd), 7.59 (2H, d), 7.54 (4H, d), 7.52 (2H, dd), 7.51 (2H, dd), 7.5 (1H, s), 7.44 (1H, t), 7.43 (1H, t), 7.41 (1H, dd), 7.38 (1H, dd), 7.35 (1H, t), 7.32 (1H, d), 7.31 (1H, d), 7.29 (1H, d), 6.69 (4H, d), 6.33 (2H, t) |
| A352 | 8.49 (1H, d), 8.12 (1H, s), 8.1 (1H, s), 8 (2H, d), 7.75 (1H, d), 7.63 (1H, d), 7.62 (2H, d), 7.59 (2H, d), 7.54 (4H, d), 7.52 (2H, dd), 7.51 (2H, d), 7.5 (1H, d), 7.44 (1H, dd), 7.41 (1H, dd), 7.35 (1H, s), 7.29 (1H, t), 7.2 (2H, t), 6.81 (1H, dd), 6.69 (4H, dd), 6.63 (2H, t) |
| A356 | 8.55 (1H, d), 8 (2H, s), 7.94 (1H, s), 7.88 (1H, d), 7.87 (1H, d), 7.84 (1H, d), 7.77 (2H, d), 7.75 (1H, d), 7.74 (1H, d), 7.69 (1H, dd), 7.62 (1H, d), 7.59 (2H, d), 7.54 (2H, dd), 7.5 (1H, dd), 7.49 (1H, s), 7.44 (1H, t), 7.36 (1H, t), 7.35 (1H, dd), 7.33 (1H, dd), 7.25 (1H, t), 7.2 (2H, d), 6.81 (1H, d), 6.69 (2H, d), 6.63 (2H, s) |
| A358 | 8.12 (1H, d), 8.1 (1H, s), 8 (2H, s), 7.9 (1H, d), 7.75 (1H, d), 7.63 (1H, d), 7.62 (1H, d), 7.59 (2H, d), 7.54 (4H, d), 7.52 (2H, dd), 7.51 (2H, d), 7.5 (1H, d), 7.44 (1H, dd), 7.41 (1H, dd), 7.39 (1H, s), 7.35 (1H, t), 7.29 (1H, t), 7.2 (2H, dd), 6.81 (1H, dd), 6.69 (4H, t), 6.63 (2H, d) |
| A367 | 8.18 (1H, d), 8 (4H, s), 7.92 (1H, s), 7.73 (1H, d), 7.59 (4H, d), 7.58 (1H, d), 7.54 (4H, d), 7.52 (2H, d), 7.51 (3H, d), 7.49 (1H, dd), 7.41 (1H, d), 7.35 (1H, d), 7.13 (1H, dd), 7.02 (1H, dd), 6.69 (4H, s), 6.33 (1H, t) |
| A402 | 8 (2H, d), 7.85 (2H, s), 7.79 (2H, s), 7.59 (2H, d), 7.54 (1H, d), 7.51 (2H, d), 7.47 (2H, d), 7.43 (1H, d), 7.41 (1H, d), 7.35 (1H, dd), 7.2 (2H, d), 7.16 (1H, d), 7.13 (1H, dd), 7.02 (1H, dd), 6.87 (1H, s), 6.81 (1H, t), 6.69 (1H, t), 6.63 (2H, dd), 6.33 (1H, dd) |
| A356 | 8 (2H, d), 7.98 (1H, s), 7.59 (2H, s), 7.35 (1H, d), 7.13 (1H, d), 7.02 (1H, d), 6.91 (2H, d), 6.33 (1H, d), 6.17 (2H, d), 6.15 (2H, dd), 5.9 (4H, d), 5.8 (4H, d), 4.73 (2H, dd), 3.93 (2H, dd) |
| A451 | 8 (2H, d), 7.89 (1H, s), 7.79 (1H, s), 7.66 (1H, d), 7.65 (1H, d), 7.59 (2H, d), 7.57 (1H, d), 7.54 (2H, d), 7.52 (2H, d), 7.51 (2H, dd), 7.41 (2H, d), 7.38 (1H, d), 7.35 (1H, dd), 7.32 (1H, dd), 7.13 (1H, s), 7.02 (1H, t), 6.69 (2H, t), 6.39 (1H, dd), 6.33 (1H, dd) |
| A461 | 8 (2H, d), 7.94 (1H, s), 7.75 (1H, s), 7.62 (1H, d), 7.59 (2H, d), 7.54 (4H, d), 7.52 (2H, d), 7.51 (2H, d), 7.44 (1H, d), 7.41 (1H, dd), 7.35 (1H, d), 7.25 (4H, d), 7.2 (2H, dd), 6.81 (1H, dd), 6.69 (4H, s), 6.63 (2H, t) |
| A472 | 8.04 (1H, d), 8 (2H, s), 7.83 (1H, s), 7.75 (1H, d), 7.62 (1H, d), 7.59 (2H, d), 7.54 (4H, d), 7.52 (2H, d), 7.51 (2H, d), 7.44 (1H, dd), 7.41 (1H, d), 7.35 (1H, d), 7.2 (2H, dd), 6.81 (1H, dd), 6.69 (4H, s), 6.63 (2H, t) |
| A475 | 8 (2H, d), 7.89 (1H, s), 7.75 (1H, s), 7.62 (1H, d), 7.59 (2H, d), 7.54 (4H, d), 7.52 (2H, d), 7.51 (2H, d), 7.44 (1H, d), 7.41 (1H, dd), 7.35 (1H, d), 7.2 (2H, d), 6.81 (1H, dd), 6.69 (4H, dd), 6.63 (2H, s) |
| A488 | 8.93 (2H, d), 8.55 (1H, s), 8.18 (1H, s), 8.12 (2H, d), 8.08 (2H, d), 7.94 (1H, d), 7.93 (1H, d), 7.88 (2H, d), 7.87 (1H, d), 7.82 (2H, dd), 7.75 (1H, d), 7.68 (1H, d), 7.62 (1H, dd), 7.58 (2H, dd), 7.55 (2H, s), 7.54 (4H, t), 7.52 (2H, t), 7.51 (2H, dd), 7.5 (2H, dd), 7.45 (1H, t), 7.44 (1H, d), 7.41 (1H, d), 7.35 (1H, d), 7.33 (1H, dd), 7.25 (1H, t), 6.69 (4H, d) |
| A511 | 8.55 (1H, d), 8.18 (2H, s), 8.08 (1H, s), 7.94 (1H, d), 7.79 (1H, d), 7.75 (1H, d), 7.68 (1H, d), 7.62 (2H, d), 7.58 (2H, d), 7.55 (2H, dd), 7.54 (4H, d), 7.52 (4H, d), 7.51 (4H, dd), 7.5 (2H, dd), 7.45 (1H, s), 7.44 (1H, t), 7.41 (2H, t), 7.33 (1H, dd), 7.25 (1H, dd), 6.69 (4H, t) |
| A523 | 8.55 (1H, d), 8.18 (1H, s), 8.08 (1H, s), 7.94 (1H, d), 7.87 (1H, d), 7.85 (2H, d), 7.79 (2H, d), 7.77 (1H, d), 7.75 (1H, d), 7.69 (1H, dd), 7.68 (1H, d), 7.62 (1H, d), 7.58 (2H, dd), 7.55 (2H, dd), 7.54 (3H, s), 7.52 (2H, t), 7.51 (4H, t), 7.5 (2H, dd), 7.47 (2H, dd), 7.45 (1H, t), 7.44 (1H, d), 7.41 (2H, d), 7.33 (1H, d), 7.25 (1H, dd), 7.16 (1H, t), 6.87 (1H, d), 6.69 (3H, d) |
| A535 | 8.55 (1H, d), 8.18 (1H, s), 8.08 (1H, s), 7.94 (1H, d), 7.79 (1H, d), 7.75 (1H, d), 7.68 (1H, d), 7.62 (1H, d), 7.59 (1H, d), 7.58 (2H, dd), 7.55 (2H, d), 7.54 (2H, d), 7.52 (2H, dd), 7.51 (2H, dd), 7.5 (2H, s), 7.45 (1H, t), 7.44 (1H, t), 7.43 (1H, dd), 7.41 (1H, dd), 7.33 (1H, t), 7.25 (5H, d), 7.2 (2H, d), 6.81 (1H, d), 6.69 (2H, dd), 6.63 (2H, t) |
| A547 | 8.55 (1H, d), 8.51 (1H, s), 8.3 (1H, s), 8.18 (1H, d), 8.12 (1H, d), 7.89 (1H, d), 7.75 (1H, d), 7.71 (1H, d), 7.66 (1H, d), 7.64 (1H, dd), 7.63 (1H, d), 7.62 (1H, d), 7.58 (2H, dd), 7.55 (2H, dd), 7.54 (4H, s), 7.52 (2H, t), 7.51 (2H, t), 7.5 (3H, dd), 7.45 (1H, dd), 7.44 (1H, t), 7.43 (1H, d), 7.41 (1H, d), 7.38 (1H, d), 7.32 (1H, dd), 7.31 (1H, t), 7.29 (1H, d), 6.69 (4H, d), 6.33 (1H, t) |
| A557 | 8.55 (2H, d), 8.18 (1H, s), 7.94 (1H, s), 7.89 (1H, d), 7.87 (1H, d), 7.77 (1H, d), 7.75 (1H, d), 7.71 (1H, d), 7.69 (1H, d), 7.66 (1H, dd), 7.62 (1H, d), 7.58 (2H, d), 7.55 (2H, dd), 7.54 (2H, dd), 7.5 (2H, s), 7.45 (1H, t), 7.44 (1H, t), 7.38 (1H, dd), 7.33 (1H, dd), 7.32 (1H, t), 7.25 (1H, d), 7.2 (2H, d), 7.13 (1H, d), 7.02 (1H, dd), 6.81 (1H, t), 6.69 (2H, d), 6.63 (2H, d), 6.33 (1H, t) |
| A566 | 8.55 (2H, d), 8.18 (1H, s), 8.08 (1H, s), 8 (2H, d), 7.94 (1H, d), 7.92 (1H, d), 7.87 (1H, d), 7.73 (1H, d), 7.71 (1H, d), 7.59 (2H, dd), 7.58 (3H, d), 7.55 (2H, d), 7.54 (4H, dd), 7.52 (2H, dd), 7.51 (2H, s), 7.5 (2H, t), 7.45 (1H, t), 7.41 (1H, dd), 7.35 (1H, dd), 7.33 (1H, t), 7.25 (1H, d), 7.13 (1H, d), 7.02 (1H, d), 6.69 (4H, dd), 6.33 (1H, t) |
| A591 | 8.55 (2H, d), 8.18 (2H, s), 7.94 (1H, s), 7.79 (1H, d), 7.71 (1H, d), 7.62 (1H, d), 7.58 (2H, d), 7.55 (2H, d), 7.54 (4H, d), 7.52 (4H, dd), 7.51 (4H, d), 7.5 (2H, d), 7.45 (1H, dd), 7.41 (2H, dd), 7.33 (1H, s), 7.25 (1H, t), 7.13 (1H, t), 7.02 (1H, dd), 6.69 (4H, dd), 6.33 (1H, t) |
| A602 | 8.55 (2H, d), 8.18 (1H, s), 7.94 (1H, s), 7.87 (1H, d), 7.77 (1H, d), 7.71 (1H, d), 7.69 (1H, d), 7.58 (2H, d), 7.55 (2H, d), 7.54 (3H, dd), 7.52 (2H, d), 7.51 (4H, d), 7.5 (2H, dd), 7.45 (1H, dd), 7.41 (2H, s), 7.33 (1H, t), 7.25 (5H, t), 7.16 (1H, dd), 7.13 (1H, dd), 7.08 (2H, t), 7.02 (1H, d), 6.87 (1H, d), 6.69 (3H, d), 6.33 (1H, dd) |
| A615 | 8.55 (2H, d), 8.18 (1H, s), 7.94 (1H, s), 7.79 (1H, d), 7.71 (1H, d), 7.59 (1H, d), 7.58 (2H, d), 7.55 (2H, d), 7.54 (2H, d), 7.52 (2H, dd), 7.51 (2H, d), 7.5 (2H, d), 7.45 (1H, dd), 7.43 (1H, dd), 7.41 (1H, s), 7.33 (1H, t), 7.25 (5H, t), 7.2 (2H, dd), 7.13 (1H, dd), 7.02 (1H, t), 6.81 (1H, d), 6.69 (2H, d), 6.63 (2H, d), 6.33 (1H, dd) |
| A624 | 8.55 (1H, d), 8.51 (1H, s), 8.3 (1H, s), 8.18 (1H, d), 8.12 (1H, d), 7.88 (2H, d), 7.84 (2H, d), 7.77 (2H, d), 7.75 (1H, d), 7.74 (2H, dd), 7.71 (1H, d), 7.63 (1H, d), 7.62 (1H, dd), 7.58 (2H, dd), 7.55 (2H, s), 7.54 (2H, t), 7.5 (5H, t), 7.49 (2H, dd), 7.45 (1H, dd), 7.44 (1H, t), 7.36 (2H, d), 7.31 (1H, d), 7.29 (1H, d), 6.69 (2H, dd) |
| A634 | 8.55 (1H, d), 8.49 (1H, s), 8.18 (1H, s), 8.12 (1H, d), 8.1 (1H, d), 7.89 (1H, d), 7.75 (1H, d), 7.71 (1H, d), 7.66 (1H, d), 7.63 (1H, dd), 7.62 (2H, d), 7.58 (2H, d), 7.55 (2H, dd), 7.54 (2H, dd), 7.5 (3H, s), 7.45 (1H, t), 7.44 (1H, t), 7.38 (1H, dd), 7.32 (1H, dd), 7.29 (1H, t), 7.2 (2H, d), 7.13 (1H, d), 7.02 (1H, d), 6.81 (1H, dd), 6.69 (2H, t), 6.63 (2H, d), 6.33 (1H, d) |
| A635 | 8.55 (2H, d), 8.18 (1H, s), 7.94 (1H, s), 7.87 (1H, d), 7.77 (1H, d), 7.75 (1H, d), 7.71 (1H, d), 7.69 (1H, d), 7.62 (1H, d), 7.58 (2H, dd), 7.55 (2H, d), 7.54 (4H, d), 7.52 (2H, dd), 7.51 (2H, dd), 7.5 (2H, s), 7.45 (1H, t), 7.44 (1H, t), 7.41 (1H, dd), 7.33 (1H, dd), 7.25 (1H, t), 7.2 (2H, d), 6.81 (1H, d), 6.69 (4H, d), 6.63 (2H, dd) |
| A638 | 8.55 (1H, d), 8.18 (1H, s), 8.12 (1H, s), 8.1 (1H, d), 7.9 (1H, d), 7.75 (1H, d), 7.71 (1H, d), 7.63 (1H, d), 7.62 (1H, d), 7.58 (2H, dd), 7.55 (2H, d), 7.54 (4H, d), 7.52 (2H, dd), 7.51 (2H, dd), 7.5 (3H, s), 7.45 (1H, t), 7.44 (1H, t), 7.41 (1H, dd), 7.39 (1H, dd), 7.29 (1H, t), 7.2 (2H, d), 6.81 (1H, d), 6.69 (4H, d), 6.63 (2H, dd) |
| A641 | 8.55 (1H, d), 8.18 (2H, s), 8.08 (1H, s), 7.94 (1H, d), 7.79 (1H, d), 7.75 (1H, d), 7.68 (1H, d), 7.62 (2H, d), 7.55 (2H, d), 7.54 (4H, dd), 7.52 (4H, d), 7.51 (4H, d), 7.44 (1H, dd), 7.41 (2H, dd), 7.33 (1H, s), 7.25 (1H, t), 6.69 (4H, t) |
| A642 | 8.55 (1H, d), 8.18 (2H, s), 8.08 (1H, s), 7.94 (1H, d), 7.85 (2H, d), 7.79 (3H, d), 7.75 (1H, d), 7.68 (1H, d), 7.62 (2H, d), 7.55 (2H, dd), 7.54 (3H, d), 7.52 (2H, d), 7.51 (4H, dd), 7.47 (2H, dd), 7.44 (1H, s), 7.41 (2H, t), 7.33 (1H, t), 7.25 (1H, dd), 7.16 (1H, dd), 6.87 (1H, t), 6.69 (3H, d) |
| A653 | 8.93 (2H, d), 8.55 (1H, s), 8.18 (1H, s), 8.12 (2H, d), 8.08 (1H, d), 7.94 (1H, d), 7.93 (1H, d), 7.88 (2H, d), 7.87 (1H, d), 7.82 (2H, dd), 7.77 (1H, d), 7.75 (1H, d), 7.69 (1H, dd), 7.68 (1H, dd), 7.62 (1H, s), 7.55 (2H, t), 7.54 (2H, t), 7.44 (1H, dd), 7.33 (1H, dd), 7.25 (1H, t), 7.2 (2H, d), 6.81 (1H, d), 6.69 (2H, d), 6.63 (2H, dd) |
| A660 | 8.55 (1H, d), 8.18 (1H, s), 8.08 (1H, s), 7.94 (1H, d), 7.89 (1H, d), 7.87 (1H, d), 7.77 (1H, d), 7.75 (1H, d), 7.69 (1H, d), 7.68 (1H, dd), 7.66 (1H, d), 7.64 (1H, d), 7.62 (1H, dd), 7.55 (2H, dd), 7.54 (2H, s), 7.52 (2H, t), 7.51 (2H, t), 7.44 (1H, dd), 7.43 (1H, dd), 7.41 (1H, t), 7.38 (1H, d), 7.33 (1H, d), 7.32 (1H, d), 7.25 (1H, dd), 6.69 (2H, t), 6.33 (1H, d) |
| A663 | 8.51 (1H, d), 8.3 (1H, s), 8.18 (1H, s), 8.12 (1H, d), 8.08 (1H, d), 7.75 (1H, d), 7.68 (1H, d), 7.63 (1H, d), 7.62 (1H, d), 7.55 (2H, dd), 7.54 (2H, d), 7.52 (2H, d), 7.51 (2H, dd), 7.5 (1H, dd), 7.44 (1H, s), 7.41 (1H, t), 7.31 (1H, t), 7.29 (1H, dd), 7.25 (4H, dd), 7.2 (2H, t), 6.81 (1H, d), 6.69 (2H, d), 6.63 (2H, d) |
| A666 | 8.93 (2H, d), 8.18 (1H, s), 8.12 (3H, s), 8.1 (1H, d), 8.08 (1H, d), 7.93 (1H, d), 7.9 (1H, d), 7.88 (2H, d), 7.82 (2H, d), 7.75 (1H, dd), 7.68 (1H, d), 7.63 (1H, d), 7.62 (1H, dd), 7.55 (2H, dd), 7.54 (2H, s), 7.5 (1H, t), 7.44 (1H, t), 7.39 (1H, dd), 7.29 (1H, dd), 7.2 (2H, t), 6.81 (1H, d), 6.69 (2H, d), 6.63 (2H, d) |
| A675 | 8.55 (1H, d), 8.49 (1H, s), 8.18 (1H, s), 8.12 (1H, d), 8.1 (1H, d), 7.75 (1H, d), 7.71 (1H, d), 7.63 (1H, d), 7.62 (2H, d), 7.55 (2H, dd), 7.54 (2H, d), 7.52 (2H, d), 7.51 (2H, dd), 7.5 (1H, dd), 7.44 (2H, s), 7.41 (1H, t), 7.29 (1H, t), 7.2 (2H, dd), 6.89 (1H, dd), 6.88 (1H, t), 6.81 (1H, d), 6.69 (2H, d), 6.63 (2H, d), 6.59 (1H, dd) |
| A676 | 8.55 (1H, d), 8.49 (1H, s), 8.18 (1H, s), 8.12 (1H, d), 8.1 (1H, d), 7.75 (1H, d), 7.71 (1H, d), 7.63 (1H, d), 7.62 (2H, d), 7.55 (2H, dd), 7.54 (3H, d), 7.51 (2H, d), 7.5 (1H, dd), 7.44 (1H, dd), 7.41 (1H, s), 7.29 (1H, t), 7.2 (2H, t), 7.16 (1H, dd), 7.08 (2H, dd), 6.87 (1H, t), 6.81 (1H, d), 6.69 (3H, d), 6.63 (2H, d) |
| A679 | 8.55 (1H, d), 8.18 (2H, s), 8.12 (1H, s), 8 (1H, d), 7.77 (1H, d), 7.75 (1H, d), 7.71 (1H, d), 7.63 (1H, d), 7.62 (1H, d), 7.55 (2H, dd), 7.54 (2H, d), 7.5 (1H, d), 7.44 (1H, dd), 7.29 (1H, dd), 7.2 (4H, s), 6.81 (2H, t), 6.69 (2H, t), 6.63 (4H, dd) |
| A681 | 8.18 (1H, d), 8.08 (1H, s), 7.75 (1H, s), 7.68 (1H, d), 7.62 (1H, d), 7.55 (2H, d), 7.54 (4H, d), 7.52 (4H, d), 7.51 (4H, d), 7.44 (1H, dd), 7.41 (2H, d), 6.69 (4H, d) |
| A686 | 8.18 (1H, d), 8.08 (1H, s), 8 (2H, s), 7.92 (1H, d), 7.75 (1H, d), 7.73 (1H, d), 7.68 (1H, d), 7.62 (1H, d), 7.59 (2H, d), 7.58 (1H, dd), 7.55 (2H, d), 7.54 (2H, d), 7.44 (1H, dd), 7.2 (2H, dd), 6.81 (1H, s), 6.69 (2H, t), 6.63 (2H, t) |
| A719 | 8.55 (1H, d), 8.18 (1H, s), 7.75 (1H, s), 7.71 (1H, d), 7.62 (1H, d), 7.55 (2H, d), 7.54 (2H, d), 7.44 (1H, d), 7.2 (4H, d), 6.81 (2H, dd), 6.69 (2H, d), 6.63 (4H, d) |
| A721 | 7.66 (2H, s), 7.56 (1H, s) |
| A722 | 8.55 (1H, d), 8.18 (1H, s), 7.94 (1H, s), 7.85 (2H, d), 7.79 (3H, d), 7.66 (1H, d), 7.62 (1H, d), 7.58 (2H, d), 7.54 (3H, d), 7.52 (2H, dd), 7.51 (4H, d), 7.5 (2H, d), 7.47 (2H, dd), 7.45 (1H, dd), 7.41 (2H, s), 7.33 (1H, t), 7.25 (1H, t), 7.16 (1H, dd), 6.87 (1H, dd), 6.69 (3H, t) |
| A734 | 8.55 (1H, d), 8.18 (1H, s), 8.08 (1H, s), 7.94 (1H, d), 7.87 (1H, d), 7.77 (1H, d), 7.75 (1H, d), 7.69 (1H, d), 7.68 (1H, d), 7.66 (1H, dd), 7.62 (1H, d), 7.58 (2H, d), 7.55 (2H, dd), 7.5 (2H, dd), 7.45 (1H, s), 7.44 (1H, t), 7.41 (1H, t), 7.33 (1H, dd), 7.25 (1H, dd), 7.19 (1H, t), 6.7 (1H, d) |
| A735 | 8.18 (1H, d), 8.08 (1H, s), 7.75 (1H, s), 7.68 (1H, d), 7.62 (1H, d), 7.55 (2H, d), 7.5 (1H, d), 7.44 (1H, d), 7.41 (1H, d), 7.4 (1H, dd), 6.64 (1H, d) |
| A761 | 7.66 (2H, s), 7.25 (1H, s) |
| A762 | 8.55 (1H, d), 8.18 (1H, s), 7.94 (1H, s), 7.85 (2H, d), 7.79 (3H, d), 7.62 (1H, d), 7.58 (2H, d), 7.54 (3H, d), 7.52 (2H, d), 7.51 (4H, dd), 7.5 (2H, d), 7.47 (2H, d), 7.45 (1H, dd), 7.41 (2H, dd), 7.33 (1H, s), 7.25 (1H, t), 7.16 (1H, t), 6.87 (1H, dd), 6.69 (3H, dd), 6.64 (1H, t) |
| A763 | 8.55 (1H, d), 8.18 (1H, s), 7.71 (1H, s), 7.55 (2H, d), 7.41 (1H, d), 7.13 (1H, d), 7.02 (1H, d), 6.8 (1H, d), 6.64 (1H, d), 6.33 (1H, dd) |
| A803 | 8 (2H, d), 7.89 (1H, s), 7.81 (1H, s), 7.72 (1H, d), 7.71 (1H, d), 7.66 (1H, d), 7.59 (2H, d), 7.54 (4H, d), 7.52 (4H, d), 7.51 (4H, dd), 7.41 (2H, d), 7.38 (1H, d), 7.35 (1H, dd), 7.32 (1H, dd), 7.13 (1H, s), 7.02 (1H, t), 6.69 (4H, t), 6.33 (1H, dd) |
| A812 | 8 (2H, d), 7.87 (1H, s), 7.63 (1H, s), 7.59 (2H, d), 7.55 (1H, d), 7.54 (4H, d), 7.52 (4H, d), 7.51 (5H, d), 7.41 (2H, d), 7.38 (1H, dd), 7.35 (1H, d), 7.34 (1H, d), 7.28 (1H, dd), 7.13 (1H, dd), 7.02 (1H, s), 6.69 (4H, t), 6.33 (1H, t), 1.72 (2H, dd) |
| A814 | 8 (2H, d), 7.89 (1H, s), 7.85 (3H, s), 7.81 (1H, d), 7.79 (2H, d), 7.66 (1H, d), 7.59 (2H, d), 7.54 (3H, d), 7.52 (2H, d), 7.51 (4H, dd), 7.47 (2H, d), 7.41 (2H, d), 7.38 (2H, dd), 7.35 (1H, dd), 7.32 (1H, s), 7.16 (1H, t), 7.13 (1H, t), 7.02 (1H, dd), 6.87 (1H, dd), 6.69 (3H, t), 6.33 (1H, d) |
| A818 | 8.45 (1H, d), 8.41 (1H, s), 8.2 (1H, s), 8 (2H, d), 7.98 (1H, d), 7.85 (2H, d), 7.79 (2H, d), 7.59 (2H, d), 7.58 (1H, d), 7.54 (3H, dd), 7.52 (3H, d), 7.51 (4H, d), 7.5 (1H, dd), 7.47 (2H, dd), 7.41 (2H, s), 7.35 (1H, t), 7.16 (1H, t), 7.13 (1H, dd), 7.02 (1H, dd), 6.87 (1H, t), 6.69 (3H, d), 6.33 (1H, d) |
| A827 | 8 (2H, d), 7.89 (1H, s), 7.81 (1H, s), 7.72 (1H, d), 7.71 (1H, d), 7.66 (1H, d), 7.59 (2H, d), 7.54 (2H, d), 7.52 (2H, d), 7.51 (2H, dd), 7.41 (1H, d), 7.38 (1H, d), 7.35 (1H, dd), 7.32 (1H, dd), 7.25 (4H, s), 7.2 (2H, t), 7.13 (1H, t), 7.02 (1H, dd), 6.81 (1H, dd), 6.69 (2H, t), 6.63 (2H, d), 6.33 (1H, d) |
| A839 | 8 (2H, d), 7.89 (1H, s), 7.81 (1H, s), 7.72 (1H, d), 7.71 (1H, d), 7.66 (1H, d), 7.59 (2H, d), 7.54 (2H, d), 7.52 (2H, d), 7.51 (2H, dd), 7.41 (1H, d), 7.38 (1H, d), 7.35 (1H, dd), 7.32 (1H, dd), 7.2 (2H, s), 7.13 (1H, t), 7.02 (1H, t), 6.81 (1H, dd), 6.69 (2H, dd), 6.63 (2H, t), 6.33 (1H, d) |
| A842 | 8 (2H, d), 7.89 (1H, s), 7.85 (1H, s), 7.81 (1H, d), 7.75 (1H, d), 7.66 (1H, d), 7.62 (1H, d), 7.59 (2H, d), 7.54 (4H, d), 7.52 (4H, dd), 7.51 (4H, d), 7.44 (1H, d), 7.41 (2H, dd), 7.38 (2H, dd), 7.32 (1H, s), 7.21 (1H, t), 6.69 (4H, t) |
| A852 | 8 (2H, d), 7.87 (1H, s), 7.75 (1H, s), 7.63 (1H, d), 7.62 (1H, d), 7.59 (2H, d), 7.55 (1H, d), 7.54 (4H, d), 7.52 (4H, d), 7.51 (5H, dd), 7.44 (1H, d), 7.41 (2H, d), 7.38 (1H, dd), 7.34 (1H, dd), 7.28 (1H, s), 7.21 (1H, t), 6.69 (4H, t), 1.72 (2H, dd) |
| A867 | 8 (2H, d), 7.89 (1H, s), 7.81 (1H, s), 7.75 (1H, d), 7.72 (1H, d), 7.71 (1H, d), 7.66 (1H, d), 7.62 (1H, d), 7.59 (2H, d), 7.54 (2H, dd), 7.52 (2H, d), 7.51 (2H, d), 7.44 (1H, dd), 7.41 (1H, dd), 7.38 (1H, s), 7.32 (1H, t), 7.25 (4H, t), 7.21 (1H, dd), 7.2 (2H, dd), 6.81 (1H, t), 6.69 (2H, d), 6.63 (2H, d) |
| A881 | 8.55 (1H, d), 8.18 (1H, s), 7.95 (1H, s), 7.89 (1H, d), 7.75 (1H, d), 7.71 (1H, d), 7.66 (1H, d), 7.64 (1H, d), 7.55 (2H, d), 7.54 (4H, dd), 7.52 (4H, d), 7.51 (4H, d), 7.41 (2H, dd), 7.38 (1H, dd), 7.32 (1H, s), 7.13 (1H, t), 7.02 (1H, t), 6.69 (4H, dd), 6.33 (1H, dd) |
| A919 | 8.55 (1H, d), 8.18 (1H, s), 7.89 (1H, s), 7.81 (1H, d), 7.72 (1H, d), 7.71 (2H, d), 7.66 (1H, d), 7.55 (2H, d), 7.54 (2H, d), 7.52 (2H, dd), 7.51 (2H, d), 7.41 (1H, d), 7.38 (1H, dd), 7.32 (1H, dd), 7.2 (2H, s), 7.13 (1H, t), 7.02 (1H, t), 6.81 (1H, dd), 6.69 (2H, dd), 6.63 (2H, t), 6.33 (1H, d) |
| A923 | 8.18 (1H, d), 8.08 (1H, s), 7.89 (1H, s), 7.81 (1H, d), 7.75 (1H, d), 7.72 (1H, d), 7.71 (1H, d), 7.68 (1H, d), 7.66 (1H, d), 7.62 (1H, dd), 7.55 (2H, d), 7.54 (4H, d), 7.52 (4H, dd), 7.51 (4H, dd), 7.44 (1H, s), 7.41 (2H, t), 7.38 (1H, t), 7.32 (1H, dd), 6.69 (4H, dd) |
| A952 | 8.45 (1H, d), 8.18 (1H, s), 8.08 (1H, s), 7.98 (1H, d), 7.94 (1H, d), 7.82 (1H, d), 7.75 (1H, d), 7.68 (1H, d), 7.62 (1H, d), 7.56 (1H, dd), 7.55 (2H, d), 7.54 (2H, d), 7.52 (3H, dd), 7.51 (2H, dd), 7.5 (1H, s), 7.44 (1H, t), 7.41 (1H, t), 7.25 (4H, dd), 7.2 (2H, dd), 6.81 (1H, t), 6.69 (2H, d), 6.63 (2H, d) |
| A959 | 8.18 (1H, d), 8.08 (1H, s), 7.89 (1H, s), 7.81 (1H, d), 7.75 (1H, d), 7.72 (1H, d), 7.71 (1H, d), 7.68 (1H, d), 7.66 (1H, d), 7.62 (1H, dd), 7.55 (2H, d), 7.54 (2H, d), 7.52 (2H, dd), 7.51 (2H, dd), 7.44 (1H, s), 7.41 (1H, t), 7.38 (1H, t), 7.32 (1H, dd), 7.2 (2H, dd), 6.81 (1H, t), 6.69 (2H, d), 6.63 (2H, d) |
| A963 | 8.55 (1H, d), 8.18 (1H, s), 8 (2H, s), 7.92 (1H, d), 7.89 (1H, d), 7.81 (1H, d), 7.73 (1H, d), 7.72 (1H, d), 7.71 (2H, d), 7.66 (1H, dd), 7.59 (2H, d), 7.58 (1H, d), 7.55 (2H, dd), 7.54 (4H, dd), 7.52 (2H, s), 7.51 (2H, t), 7.41 (1H, t), 7.38 (1H, dd), 7.32 (1H, dd), 7.13 (1H, t), 7.02 (1H, d), 6.69 (4H, d), 6.33 (1H, d) |
| A977 | 7.95 (2H, s), 7.71 (1H, d), 7.66 (1H, d), 7.5 (1H, s), 7.41 (1H, d), 6.7 (1H, s) |
| A979 | 8 (2H, s), 7.95 (2H, d), 7.66 (1H, d), 7.59 (2H, s), 7.5 (2H, d), 7.35 (1H, s), 7.13 (1H, d), 7.02 (1H, d), 6.33 (1H, d) |
| A980 | 8 (4H, s), 7.92 (1H, d), 7.73 (1H, d), 7.59 (4H, s), 7.58 (1H, d), 7.56 (1H, s), 7.54 (4H, d), 7.52 (2H, d), 7.51 (2H, d), 7.41 (1H, dd), 7.35 (1H, d), 7.13 (1H, d), 7.02 (1H, dd), 6.69 (4H, dd), 6.33 (1H, s) |
| A981 | 8.55 (2H, s), 8.18 (2H, d), 7.94 (1H, d), 7.79 (1H, s), 7.71 (1H, d), 7.62 (1H, s), 7.55 (2H, d), 7.54 (4H, d), 7.52 (4H, d), 7.51 (4H, dd), 7.41 (2H, d), 7.33 (1H, d), 7.25 (1H, dd), 7.13 (1H, dd), 7.02 (1H, s), 6.69 (4H, t), 6.33 (1H, t) |
| A982 | 8.55 (2H, s), 8.18 (2H, d), 7.94 (1H, d), 7.85 (2H, s), 7.79 (3H, d), 7.71 (1H, s), 7.62 (1H, d), 7.55 (2H, d), 7.54 (3H, d), 7.52 (2H, dd), 7.51 (4H, d), 7.47 (2H, d), 7.41 (2H, dd), 7.33 (1H, dd), 7.25 (1H, s), 7.16 (1H, t), 7.13 (1H, t), 7.02 (1H, dd), 6.87 (1H, dd), 6.69 (3H, t), 6.33 (1H, d) |
| A983 | 8.93 (2H, s), 8.55 (2H, d), 8.18 (2H, d), 8.12 (2H, s), 7.94 (1H, d), 7.93 (1H, s), 7.88 (2H, d), 7.82 (2H, d), 7.79 (1H, d), 7.71 (1H, dd), 7.62 (1H, d), 7.55 (2H, d), 7.54 (2H, dd), 7.33 (1H, dd), 7.25 (1H, s), 7.2 (2H, t), 7.13 (1H, t), 7.02 (1H, dd), 6.81 (2H, dd), 6.69 (2H, t), 6.63 (2H, d), 6.33 (1H, d) |
| A991 | 8.55 (2H, s), 8.18 (1H, d), 7.94 (1H, d), 7.87 (1H, s), 7.77 (1H, d), 7.71 (1H, s), 7.69 (1H, d), 7.55 (2H, d), 7.54 (4H, d), 7.52 (4H, dd), 7.51 (4H, d), 7.41 (2H, d), 7.33 (1H, dd), 7.25 (1H, dd), 7.13 (1H, s), 7.02 (1H, t), 6.69 (4H, t), 6.33 (1H, dd) |
| A995 | 8.55 (2H, s), 8.18 (1H, d), 7.94 (1H, d), 7.87 (1H, s), 7.77 (1H, d), 7.71 (1H, s), 7.69 (1H, d), 7.55 (2H, d), 7.54 (2H, d), 7.52 (2H, dd), 7.51 (2H, d), 7.41 (1H, d), 7.33 (1H, dd), 7.25 (5H, dd), 7.2 (2H, s), 7.13 (1H, t), 7.02 (1H, t), 6.81 (1H, dd), 6.69 (2H, dd), 6.63 (2H, t), 6.33 (1H, d) |
| A1000 | 8.55 (2H, s), 8.18 (1H, d), 7.94 (1H, d), 7.89 (1H, s), 7.87 (1H, d), 7.77 (1H, s), 7.71 (1H, d), 7.69 (1H, d), 7.66 (1H, d), 7.64 (1H, dd), 7.55 (2H, d), 7.54 (2H, d), 7.52 (2H, dd), 7.51 (2H, dd), 7.43 (1H, s), 7.41 (1H, t), 7.38 (1H, t), 7.33 (1H, dd), 7.32 (1H, dd), 7.25 (1H, t), 7.13 (1H, d), 7.02 (1H, d), 6.69 (2H, d), 6.33 (2H, dd) |
| A1014 | 8.55 (1H, s), 8.49 (1H, d), 8.18 (1H, d), 8.12 (1H, s), 8.1 (1H, d), 7.75 (1H, s), 7.71 (1H, d), 7.63 (1H, d), 7.62 (2H, d), 7.55 (2H, dd), 7.54 (4H, d), 7.52 (2H, d), 7.51 (2H, dd), 7.5 (1H, dd), 7.44 (1H, s), 7.41 (1H, t), 7.29 (1H, t), 7.2 (2H, dd), 6.81 (1H, dd), 6.69 (4H, t), 6.63 (2H, d) |
| A1020 | 8.55 (1H, s), 8.18 (1H, d), 8.12 (1H, d), 8.1 (1H, s), 7.9 (1H, d), 7.75 (1H, s), 7.71 (1H, d), 7.63 (1H, d), 7.62 (1H, d), 7.55 (2H, dd), 7.54 (4H, d), 7.52 (2H, d), 7.51 (2H, dd), 7.5 (1H, dd), 7.44 (1H, s), 7.41 (1H, t), 7.39 (1H, t), 7.29 (1H, dd), 7.2 (2H, dd), 6.81 (1H, t), 6.69 (4H, d), 6.63 (2H, d) |
| A1026 | 8.55 (1H, s), 8.18 (1H, d), 8 (2H, d), 7.92 (1H, s), 7.73 (1H, d), 7.71 (1H, s), 7.59 (2H, d), 7.58 (1H, d), 7.55 (2H, d), 7.54 (2H, dd), 7.2 (2H, d), 7.13 (1H, d), 7.02 (1H, dd), 6.81 (1H, dd), 6.69 (2H, s), 6.63 (2H, t), 6.33 (1H, t) |
| A1031 | 8.55 (1H, s), 8.18 (1H, d), 7.71 (1H, d), 7.55 (2H, s), 7.54 (4H, d), 7.52 (4H, s), 7.51 (4H, d), 7.41 (2H, d), 7.13 (1H, d), 7.02 (1H, dd), 6.69 (4H, d), 6.33 (1H, d) |
| B5 | 8.28 (4H, s), 7.89 (1H, d), 7.66 (1H, d), 7.6 (1H, s), 7.57 (1H, d), 7.52 (2H, s), 7.51 (6H, d), 7.41 (3H, d), 7.38 (1H, d), 7.32 (1H, dd), 7.25 (8H, d) |
| B6 | 8.28 (4H, s), 8 (2H, d), 7.92 (1H, d), 7.89 (1H, s), 7.73 (1H, d), 7.66 (1H, s), 7.6 (1H, d), 7.59 (2H, d), 7.58 (1H, d), 7.57 (1H, dd), 7.51 (4H, d), 7.41 (2H, d), 7.38 (1H, dd), 7.32 (1H, dd), 7.25 (4H, s) |
| B7 | 8.28 (4H, s), 7.92 (2H, d), 7.89 (1H, d), 7.73 (2H, s), 7.66 (1H, d), 7.6 (1H, s), 7.58 (2H, d), 7.57 (1H, d), 7.52 (2H, d), 7.51 (6H, dd), 7.41 (3H, d), 7.38 (1H, d), 7.32 (1H, dd) |
| B15 | 8.28 (4H, s), 8.16 (2H, d), 7.95 (1H, d), 7.89 (2H, s), 7.75 (1H, d), 7.67 (2H, s), 7.66 (1H, d), 7.64 (1H, d), 7.6 (1H, d), 7.57 (1H, dd), 7.53 (1H, d), 7.51 (4H, d), 7.41 (2H, dd), 7.38 (1H, dd), 7.32 (1H, s) |
| B17 | 8.28 (4H, s), 7.89 (2H, d), 7.75 (1H, d), 7.66 (2H, s), 7.62 (1H, d), 7.6 (1H, s), 7.57 (1H, d), 7.51 (4H, d), 7.44 (1H, d), 7.41 (2H, dd), 7.38 (2H, d), 7.32 (2H, d), 7.25 (4H, dd) |
| B25 | 9.09 (1H, s), 8.49 (1H, d), 8.28 (2H, d), 8 (2H, s), 7.92 (1H, d), 7.89 (1H, s), 7.7 (1H, d), 7.66 (1H, d), 7.6 (1H, d), 7.59 (2H, dd), 7.57 (2H, d), 7.52 (2H, d), 7.51 (4H, dd), 7.48 (2H, dd), 7.41 (2H, s), 7.38 (1H, t), 7.32 (1H, t) |
| B26 | 9.09 (1H, s), 8.49 (1H, d), 8.28 (2H, d), 8 (2H, s), 7.92 (1H, d), 7.89 (1H, s), 7.66 (1H, d), 7.6 (1H, d), 7.59 (2H, d), 7.57 (1H, dd), 7.52 (2H, d), 7.51 (4H, d), 7.41 (2H, dd), 7.38 (1H, dd), 7.32 (1H, s) |
| B41 | 8.28 (2H, s), 8 (2H, d), 7.92 (1H, d), 7.89 (1H, s), 7.85 (2H, d), 7.73 (1H, s), 7.66 (1H, d), 7.6 (1H, d), 7.59 (2H, d), 7.58 (1H, dd), 7.57 (1H, d), 7.52 (2H, d), 7.51 (4H, dd), 7.41 (2H, dd), 7.38 (1H, s), 7.32 (1H, t), 7.25 (6H, t) |
| B42 | 8.28 (2H, s), 7.92 (2H, d), 7.89 (1H, d), 7.85 (2H, s), 7.73 (2H, d), 7.66 (1H, s), 7.6 (1H, d), 7.58 (2H, d), 7.57 (1H, d), 7.52 (4H, dd), 7.51 (6H, d), 7.41 (3H, d), 7.38 (1H, dd), 7.32 (1H, dd), 7.25 (2H, s) |
| B46 | 8.28 (2H, s), 7.89 (1H, d), 7.85 (2H, d), 7.66 (1H, s), 7.6 (1H, d), 7.57 (1H, s), 7.52 (4H, d), 7.51 (6H, d), 7.41 (3H, d), 7.38 (1H, dd), 7.32 (1H, d), 7.25 (2H, d) |
| B67 | 8.28 (2H, s), 8.24 (1H, d), 8 (2H, d), 7.92 (1H, s), 7.89 (1H, d), 7.73 (1H, s), 7.7 (1H, d), 7.66 (1H, d), 7.6 (1H, d), 7.59 (2H, dd), 7.58 (1H, d), 7.57 (2H, d), 7.52 (2H, dd), 7.51 (4H, dd), 7.48 (1H, s), 7.41 (2H, t), 7.38 (1H, t), 7.32 (1H, dd) |
| B68 | 8.55 (1H, s), 8.42 (1H, d), 8.28 (2H, d), 8.24 (1H, s), 8.08 (1H, d), 8.04 (1H, s), 7.89 (1H, d), 7.7 (1H, d), 7.66 (1H, d), 7.61 (1H, dd), 7.6 (1H, d), 7.57 (2H, d), 7.55 (2H, dd), 7.52 (2H, dd), 7.51 (4H, s), 7.48 (1H, t), 7.41 (2H, t), 7.38 (1H, dd), 7.32 (1H, dd) |
| B90 | 8.55 (1H, s), 8.28 (2H, d), 8.18 (1H, d), 7.94 (1H, s), 7.89 (1H, d), 7.85 (2H, s), 7.79 (3H, d), 7.66 (1H, d), 7.62 (1H, d), 7.6 (1H, dd), 7.58 (2H, d), 7.57 (1H, d), 7.51 (4H, dd), 7.5 (2H, dd), 7.47 (2H, s), 7.45 (1H, t), 7.41 (2H, t), 7.38 (1H, dd), 7.33 (1H, dd), 7.32 (1H, t), 7.25 (1H, d) |
| B101 | 8 (2H, s), 7.92 (1H, d), 7.89 (1H, d), 7.85 (4H, s), 7.73 (1H, d), 7.66 (1H, s), 7.6 (1H, d), 7.59 (2H, d), 7.58 (1H, d), 7.57 (1H, dd), 7.52 (4H, d), 7.51 (4H, d), 7.41 (2H, dd), 7.38 (1H, dd), 7.32 (1H, s), 7.25 (4H, t) |
| B114 | 7.92 (2H, s), 7.89 (1H, d), 7.85 (4H, d), 7.79 (2H, s), 7.73 (2H, d), 7.66 (1H, s), 7.6 (1H, d), 7.58 (2H, d), 7.57 (1H, d), 7.52 (4H, dd), 7.51 (6H, d), 7.47 (2H, d), 7.41 (3H, dd), 7.38 (1H, dd), 7.32 (1H, s), 7.25 (2H, t) |
| B117 | 9.09 (1H, s), 8.49 (1H, d), 8 (4H, d), 7.92 (2H, s), 7.89 (1H, d), 7.85 (2H, s), 7.73 (1H, d), 7.66 (1H, d), 7.6 (1H, d), 7.59 (4H, dd), 7.58 (1H, d), 7.57 (1H, d), 7.52 (2H, dd), 7.51 (2H, dd), 7.41 (1H, s), 7.38 (1H, t), 7.32 (1H, t), 7.25 (2H, dd) |
| B136 | 8.55 (1H, s), 8.28 (2H, d), 8.08 (1H, d), 8.04 (1H, s), 8 (2H, d), 7.95 (1H, s), 7.92 (1H, d), 7.89 (1H, d), 7.73 (1H, d), 7.66 (1H, dd), 7.61 (1H, d), 7.6 (1H, d), 7.59 (2H, dd), 7.58 (1H, dd), 7.57 (1H, s), 7.55 (2H, t), 7.51 (2H, t), 7.41 (1H, dd), 7.38 (1H, dd), 7.32 (1H, t) |
| B139 | 8.55 (1H, s), 8.28 (2H, d), 8.08 (1H, d), 8.04 (1H, s), 8 (2H, d), 7.95 (1H, s), 7.92 (1H, d), 7.89 (1H, d), 7.73 (1H, d), 7.66 (1H, dd), 7.61 (1H, d), 7.6 (1H, d), 7.59 (2H, dd), 7.58 (1H, dd), 7.57 (1H, s), 7.55 (2H, t), 7.51 (2H, t), 7.41 (1H, dd), 7.38 (1H, dd), 7.32 (1H, t), 7.25 (4H, d) |
| B140 | 8.55 (1H, s), 8.28 (2H, d), 8.08 (1H, d), 8.04 (1H, s), 7.95 (1H, d), 7.92 (2H, s), 7.89 (1H, d), 7.73 (2H, d), 7.66 (1H, d), 7.61 (1H, dd), 7.6 (1H, d), 7.58 (2H, d), 7.57 (1H, dd), 7.55 (2H, dd), 7.52 (2H, s), 7.51 (4H, t), 7.41 (2H, t), 7.38 (1H, dd), 7.32 (1H, dd) |
| B142 | 8.28 (2H, s), 8 (2H, d), 7.92 (1H, d), 7.89 (2H, s), 7.75 (1H, d), 7.73 (1H, s), 7.66 (2H, d), 7.62 (1H, d), 7.6 (1H, d), 7.59 (2H, dd), 7.58 (1H, d), 7.57 (1H, d), 7.51 (2H, dd), 7.44 (1H, dd), 7.41 (1H, s), 7.38 (2H, t), 7.32 (2H, t) |
| B145 | 8.28 (2H, s), 7.89 (2H, d), 7.75 (1H, d), 7.7 (1H, s), 7.66 (2H, d), 7.62 (1H, s), 7.6 (1H, d), 7.57 (2H, d), 7.52 (2H, d), 7.51 (4H, dd), 7.48 (2H, d), 7.44 (1H, d), 7.41 (2H, dd), 7.38 (2H, dd), 7.32 (2H, s) |
| B147 | 8.28 (2H, s), 7.89 (2H, d), 7.75 (1H, d), 7.66 (2H, s), 7.62 (1H, d), 7.6 (1H, s), 7.57 (1H, d), 7.52 (2H, d), 7.51 (4H, d), 7.44 (1H, dd), 7.41 (2H, d), 7.38 (2H, d), 7.32 (2H, dd), 7.25 (8H, dd) |
| B148 | 8.28 (2H, s), 8 (2H, d), 7.92 (1H, d), 7.89 (2H, s), 7.75 (1H, d), 7.73 (1H, s), 7.66 (2H, d), 7.62 (1H, d), 7.6 (1H, d), 7.59 (2H, dd), 7.58 (1H, d), 7.57 (1H, d), 7.51 (2H, dd), 7.44 (1H, dd), 7.41 (1H, s), 7.38 (2H, t), 7.32 (2H, t), 7.25 (4H, dd) |
| B150 | 8.28 (2H, s), 7.92 (2H, d), 7.89 (2H, d), 7.75 (1H, s), 7.73 (2H, d), 7.66 (2H, s), 7.62 (1H, d), 7.6 (1H, d), 7.58 (2H, d), 7.57 (1H, dd), 7.52 (2H, d), 7.51 (4H, d), 7.44 (1H, dd), 7.41 (2H, dd), 7.38 (2H, s), 7.32 (2H, t) |
| B156 | 9.09 (1H, s), 8.49 (1H, d), 8 (4H, d), 7.92 (2H, s), 7.89 (2H, d), 7.75 (1H, s), 7.73 (1H, d), 7.66 (2H, d), 7.62 (1H, d), 7.6 (1H, dd), 7.59 (4H, d), 7.58 (1H, d), 7.57 (1H, dd), 7.44 (1H, dd), 7.38 (2H, s), 7.32 (2H, t) |
| B168 | 8.24 (1H, s), 8 (2H, d), 7.92 (1H, d), 7.89 (2H, s), 7.75 (1H, d), 7.73 (1H, s), 7.7 (1H, d), 7.66 (2H, d), 7.62 (1H, d), 7.6 (1H, dd), 7.59 (2H, d), 7.58 (1H, d), 7.57 (2H, dd), 7.52 (2H, dd), 7.51 (2H, s), 7.48 (1H, t), 7.44 (1H, t), 7.41 (1H, dd), 7.38 (2H, dd), 7.32 (2H, t) |
| B175 | 7.89 (2H, s), 7.85 (2H, d), 7.79 (2H, d), 7.75 (1H, s), 7.66 (2H, d), 7.62 (1H, s), 7.6 (1H, d), 7.57 (1H, d), 7.52 (2H, d), 7.51 (4H, dd), 7.47 (2H, d), 7.44 (1H, d), 7.41 (2H, dd), 7.38 (2H, dd), 7.32 (2H, s), 7.25 (4H, t) |
| B177 | 7.89 (2H, s), 7.85 (4H, d), 7.79 (4H, d), 7.75 (1H, s), 7.66 (2H, d), 7.62 (1H, s), 7.6 (1H, d), 7.57 (1H, d), 7.51 (4H, d), 7.47 (4H, dd), 7.44 (1H, d), 7.41 (2H, d), 7.38 (2H, dd), 7.32 (2H, dd) |
| B188 | 8.28 (2H, s), 8 (2H, d), 7.92 (1H, d), 7.89 (2H, s), 7.81 (1H, d), 7.73 (1H, s), 7.72 (1H, d), 7.71 (1H, d), 7.66 (2H, d), 7.6 (1H, dd), 7.59 (2H, d), 7.58 (1H, d), 7.57 (1H, dd), 7.51 (2H, dd), 7.41 (1H, s), 7.38 (2H, t), 7.32 (2H, t), 7.25 (4H, dd) |
| B191 | 8.28 (2H, s), 7.89 (3H, d), 7.81 (1H, d), 7.75 (1H, s), 7.72 (1H, d), 7.71 (1H, s), 7.66 (3H, d), 7.62 (1H, d), 7.6 (1H, d), 7.57 (1H, dd), 7.51 (2H, d), 7.44 (1H, d), 7.41 (1H, dd), 7.38 (3H, dd), 7.32 (3H, s) |
| B196 | 9.09 (1H, s), 8.49 (1H, d), 8 (4H, d), 7.92 (2H, s), 7.89 (2H, d), 7.81 (1H, s), 7.73 (1H, d), 7.72 (1H, d), 7.71 (1H, d), 7.66 (2H, dd), 7.6 (1H, d), 7.59 (4H, d), 7.58 (1H, dd), 7.57 (1H, dd), 7.38 (2H, s), 7.32 (2H, t) |
| B208 | 8.28 (2H, s), 8 (2H, d), 7.92 (1H, d), 7.89 (2H, s), 7.81 (1H, d), 7.73 (1H, s), 7.72 (1H, d), 7.71 (1H, d), 7.66 (2H, d), 7.6 (1H, dd), 7.59 (2H, d), 7.58 (1H, d), 7.57 (1H, dd), 7.51 (2H, dd), 7.41 (1H, s), 7.38 (2H, t), 7.32 (2H, t), 7.25 (4H, dd) |
| B215 | 9.09 (1H, s), 8.49 (1H, d), 8 (2H, d), 7.92 (1H, s), 7.89 (2H, d), 7.81 (1H, s), 7.72 (1H, d), 7.71 (1H, d), 7.66 (2H, d), 7.6 (1H, dd), 7.59 (2H, d), 7.57 (1H, d), 7.52 (2H, dd), 7.51 (2H, dd), 7.41 (1H, s), 7.38 (2H, t), 7.32 (2H, t) |
| B216 | 9.09 (1H, s), 8.49 (1H, d), 8 (4H, d), 7.92 (2H, s), 7.89 (2H, d), 7.81 (1H, s), 7.73 (1H, d), 7.72 (1H, d), 7.71 (1H, d), 7.66 (2H, dd), 7.6 (1H, d), 7.59 (4H, d), 7.58 (1H, dd), 7.57 (1H, dd), 7.38 (2H, s), 7.32 (2H, t) |
| B229 | 8.55 (1H, s), 8.42 (1H, d), 8.28 (2H, d), 8.08 (1H, s), 8.04 (1H, d), 7.95 (1H, s), 7.89 (2H, d), 7.75 (1H, d), 7.66 (2H, d), 7.64 (1H, dd), 7.61 (1H, d), 7.6 (1H, d), 7.57 (1H, dd), 7.55 (2H, dd), 7.51 (2H, s), 7.41 (1H, t), 7.38 (2H, t), 7.32 (2H, dd), 7.25 (4H, dd) |
| B230 | 8.28 (2H, s), 7.95 (1H, d), 7.92 (2H, d), 7.89 (2H, s), 7.75 (1H, d), 7.73 (2H, s), 7.66 (2H, d), 7.64 (1H, d), 7.6 (1H, d), 7.58 (2H, dd), 7.57 (1H, d), 7.52 (2H, d), 7.51 (4H, dd), 7.41 (2H, dd), 7.38 (2H, s), 7.32 (2H, t) |
| B258 | 8.55 (1H, s), 8.42 (1H, d), 8.08 (1H, d), 8.04 (1H, s), 7.95 (1H, d), 7.89 (2H, s), 7.85 (2H, d), 7.79 (2H, d), 7.75 (1H, d), 7.66 (2H, dd), 7.64 (1H, d), 7.61 (1H, d), 7.6 (1H, dd), 7.57 (1H, dd), 7.55 (2H, s), 7.51 (2H, t), 7.47 (2H, t), 7.41 (1H, dd), 7.38 (2H, dd), 7.32 (2H, t) |
| B259 | 8.55 (1H, s), 8.08 (1H, d), 8.04 (1H, d), 8 (2H, s), 7.95 (2H, d), 7.92 (1H, s), 7.89 (2H, d), 7.75 (1H, d), 7.73 (1H, d), 7.66 (2H, dd), 7.64 (1H, d), 7.61 (1H, d), 7.6 (1H, dd), 7.59 (2H, dd), 7.58 (1H, s), 7.57 (1H, t), 7.55 (2H, t), 7.38 (2H, dd), 7.32 (2H, dd) |
| B261 | 8.28 (4H, s), 8 (2H, d), 7.95 (1H, d), 7.92 (1H, s), 7.81 (1H, d), 7.75 (1H, s), 7.73 (1H, d), 7.72 (1H, d), 7.71 (1H, d), 7.64 (1H, dd), 7.59 (2H, d), 7.58 (1H, d), 7.51 (4H, dd), 7.41 (2H, dd), 7.25 (4H, s) |
| B266 | 9.09 (1H, s), 8.49 (1H, d), 8 (4H, d), 7.95 (2H, s), 7.92 (2H, d), 7.89 (1H, s), 7.81 (1H, d), 7.75 (2H, d), 7.73 (1H, d), 7.72 (1H, dd), 7.71 (1H, d), 7.66 (1H, d), 7.64 (2H, dd), 7.59 (4H, dd), 7.58 (1H, s), 7.38 (1H, t), 7.32 (1H, t) |
| B288 | 8.28 (2H, s), 7.89 (2H, d), 7.79 (2H, d), 7.75 (1H, s), 7.66 (2H, d), 7.62 (1H, s), 7.6 (1H, d), 7.57 (1H, d), 7.51 (4H, d), 7.44 (1H, dd), 7.41 (2H, d), 7.38 (2H, d), 7.32 (2H, dd) |
| B289 | 8.28 (2H, s), 7.89 (2H, d), 7.81 (1H, d), 7.79 (2H, s), 7.72 (1H, d), 7.71 (1H, s), 7.66 (2H, d), 7.6 (1H, d), 7.57 (1H, d), 7.51 (4H, dd), 7.41 (2H, d), 7.38 (2H, d), 7.32 (2H, dd) |
| B290 | 8.28 (2H, s), 7.95 (1H, d), 7.89 (2H, d), 7.79 (2H, s), 7.75 (1H, d), 7.66 (2H, s), 7.64 (1H, d), 7.6 (1H, d), 7.57 (1H, d), 7.51 (4H, dd), 7.41 (2H, d), 7.38 (2H, d), 7.32 (2H, dd) |
| B298 | 9.09 (1H, s), 8.49 (1H, d), 8 (2H, d), 7.92 (1H, s), 7.89 (2H, d), 7.79 (2H, s), 7.75 (1H, d), 7.66 (2H, d), 7.62 (1H, d), 7.6 (1H, dd), 7.59 (2H, d), 7.57 (1H, d), 7.51 (2H, dd), 7.44 (1H, dd), 7.41 (1H, s), 7.38 (2H, t), 7.32 (2H, t) |
| B299 | 9.09 (1H, s), 8.49 (1H, d), 8 (2H, d), 7.92 (1H, s), 7.89 (2H, d), 7.81 (1H, s), 7.79 (2H, d), 7.72 (1H, d), 7.71 (1H, d), 7.66 (2H, dd), 7.6 (1H, d), 7.59 (2H, d), 7.57 (1H, dd), 7.51 (2H, dd), 7.41 (1H, s), 7.38 (2H, t), 7.32 (2H, t) |
| B308 | 7.89 (2H, s), 7.85 (2H, d), 7.79 (2H, d), 7.75 (1H, s), 7.66 (2H, d), 7.62 (1H, s), 7.6 (1H, d), 7.57 (1H, d), 7.52 (2H, d), 7.51 (4H, dd), 7.44 (1H, d), 7.41 (2H, d), 7.38 (2H, dd), 7.32 (2H, dd), 7.25 (2H, s) |
| B311 | 9.09 (1H, s), 8.49 (1H, d), 8.24 (1H, d), 8 (2H, s), 7.92 (1H, d), 7.89 (1H, s), 7.79 (2H, d), 7.7 (1H, d), 7.66 (1H, d), 7.6 (1H, dd), 7.59 (2H, d), 7.57 (2H, d), 7.52 (2H, dd), 7.51 (4H, dd), 7.48 (1H, s), 7.41 (2H, t), 7.38 (1H, t), 7.32 (1H, dd) |
| B312 | 8.24 (1H, s), 7.89 (1H, d), 7.85 (2H, d), 7.79 (2H, s), 7.7 (1H, d), 7.66 (1H, s), 7.6 (1H, d), 7.57 (2H, d), 7.52 (4H, d), 7.51 (6H, dd), 7.48 (1H, d), 7.41 (3H, d), 7.38 (1H, dd), 7.32 (1H, dd), 7.25 (2H, s) |
| B327 | 8.28 (2H, s), 8 (2H, d), 7.92 (1H, d), 7.89 (1H, s), 7.85 (2H, d), 7.73 (1H, s), 7.66 (1H, d), 7.6 (1H, d), 7.59 (2H, d), 7.58 (1H, dd), 7.57 (1H, d), 7.52 (2H, d), 7.51 (4H, dd), 7.41 (2H, dd), 7.38 (1H, s), 7.32 (1H, t), 7.25 (6H, t) |
| B330 | 8.28 (2H, s), 8 (2H, d), 7.95 (1H, d), 7.92 (1H, s), 7.89 (2H, d), 7.75 (1H, s), 7.73 (1H, d), 7.66 (2H, d), 7.64 (1H, d), 7.6 (1H, dd), 7.59 (2H, d), 7.58 (1H, d), 7.57 (1H, dd), 7.51 (2H, dd), 7.41 (1H, s), 7.38 (2H, t), 7.32 (2H, t) |
| B336 | 9.09 (2H, s), 8.49 (2H, d), 8 (4H, d), 7.92 (4H, s), 7.89 (1H, d), 7.73 (2H, s), 7.66 (1H, d), 7.6 (1H, d), 7.59 (4H, d), 7.58 (2H, dd), 7.57 (1H, d), 7.52 (2H, d), 7.51 (2H, dd), 7.41 (1H, dd), 7.38 (1H, s), 7.32 (1H, t) |
| B348 | 8 (2H, s), 7.92 (1H, d), 7.89 (2H, d), 7.85 (2H, s), 7.75 (1H, d), 7.73 (1H, s), 7.66 (2H, d), 7.62 (1H, d), 7.6 (1H, d), 7.59 (2H, dd), 7.58 (1H, d), 7.57 (1H, d), 7.52 (2H, dd), 7.51 (2H, dd), 7.44 (1H, s), 7.41 (1H, t), 7.38 (2H, t), 7.32 (2H, dd), 7.25 (2H, dd) |
| B353 | 8.24 (2H, s), 8 (2H, d), 7.92 (1H, d), 7.89 (1H, s), 7.73 (1H, d), 7.7 (2H, s), 7.66 (1H, d), 7.6 (1H, d), 7.59 (2H, d), 7.58 (1H, dd), 7.57 (3H, d), 7.52 (4H, d), 7.51 (4H, dd), 7.48 (2H, dd), 7.41 (2H, s), 7.38 (1H, t), 7.32 (1H, t) |
| B371 | 9.09 (2H, s), 8.49 (2H, d), 8 (4H, d), 7.92 (2H, s), 7.89 (1H, d), 7.66 (1H, s), 7.6 (1H, d), 7.59 (4H, d), 7.57 (1H, d), 7.52 (2H, dd), 7.51 (2H, d), 7.41 (1H, d), 7.38 (1H, dd), 7.32 (1H, dd), 7.25 (4H, s) |
| B379 | 9.09 (1H, s), 8.49 (1H, d), 8 (2H, d), 7.92 (1H, s), 7.89 (2H, d), 7.81 (1H, s), 7.72 (1H, d), 7.71 (1H, d), 7.66 (2H, d), 7.6 (1H, dd), 7.59 (2H, d), 7.57 (1H, d), 7.52 (2H, dd), 7.51 (2H, dd), 7.41 (1H, s), 7.38 (2H, t), 7.32 (2H, t), 7.25 (4H, dd) |
| B385 | 8 (2H, s), 7.92 (1H, d), 7.89 (1H, d), 7.85 (4H, s), 7.73 (1H, d), 7.66 (1H, s), 7.6 (1H, d), 7.59 (2H, d), 7.58 (1H, d), 7.57 (1H, dd), 7.52 (4H, d), 7.51 (4H, d), 7.38 (1H, dd), 7.32 (1H, dd), 7.25 (8H, s) |
| B386 | 9.09 (1H, s), 8.49 (1H, d), 7.92 (2H, d), 7.89 (1H, s), 7.85 (2H, d), 7.73 (1H, s), 7.66 (1H, d), 7.6 (1H, d), 7.58 (1H, d), 7.57 (1H, dd), 7.52 (6H, d), 7.51 (6H, d), 7.38 (1H, dd), 7.32 (1H, dd), 7.25 (6H, s) |
| B387 | 7.89 (1H, s), 7.85 (4H, d), 7.66 (1H, d), 7.6 (1H, s), 7.57 (1H, d), 7.52 (6H, s), 7.51 (6H, d), 7.38 (1H, d), 7.32 (1H, d), 7.25 (12H, dd) |
| B411 | 9.09 (1H, s), 8.49 (1H, d), 8 (4H, d), 7.92 (2H, s), 7.89 (2H, d), 7.75 (1H, s), 7.73 (1H, d), 7.66 (2H, d), 7.62 (1H, d), 7.6 (1H, dd), 7.59 (4H, d), 7.58 (1H, d), 7.57 (1H, dd), 7.44 (1H, dd), 7.38 (2H, s), 7.32 (2H, t), 7.25 (4H, t) |
| B412 | 9.09 (1H, s), 8.49 (1H, d), 8 (4H, d), 7.95 (1H, s), 7.92 (2H, d), 7.89 (2H, s), 7.75 (1H, d), 7.73 (1H, d), 7.66 (2H, d), 7.64 (1H, dd), 7.6 (1H, d), 7.59 (4H, d), 7.58 (1H, dd), 7.57 (1H, dd), 7.38 (2H, s), 7.32 (2H, t), 7.25 (4H, t) |
| B422 | 9.09 (1H, s), 8.55 (1H, d), 8.49 (1H, d), 8.28 (2H, s), 8.18 (1H, d), 8 (2H, s), 7.92 (1H, d), 7.79 (2H, d), 7.75 (1H, d), 7.71 (1H, dd), 7.62 (1H, d), 7.59 (2H, d), 7.55 (2H, dd), 7.51 (4H, dd), 7.44 (1H, s), 7.41 (2H, t) |
| B423 | 8.55 (1H, s), 8.28 (2H, d), 8.18 (1H, d), 7.85 (2H, s), 7.79 (2H, d), 7.75 (1H, s), 7.71 (1H, d), 7.62 (1H, d), 7.55 (2H, d), 7.52 (2H, dd), 7.51 (6H, d), 7.44 (1H, d), 7.41 (3H, dd), 7.25 (2H, dd) |
| B424 | 8.55 (1H, s), 8.28 (2H, d), 8.24 (1H, d), 8.18 (1H, s), 7.79 (2H, d), 7.75 (1H, s), 7.71 (1H, d), 7.7 (1H, d), 7.62 (1H, d), 7.57 (1H, dd), 7.55 (2H, d), 7.52 (2H, d), 7.51 (6H, dd), 7.48 (1H, dd), 7.44 (1H, s), 7.41 (3H, t) |
| B441 | 8.55 (1H, s), 8.28 (2H, d), 8.18 (1H, d), 7.89 (1H, s), 7.79 (2H, d), 7.75 (2H, s), 7.71 (1H, d), 7.66 (1H, d), 7.62 (2H, d), 7.55 (2H, dd), 7.51 (4H, d), 7.44 (2H, d), 7.41 (2H, dd), 7.38 (1H, dd), 7.32 (1H, s) |
| B442 | 8.55 (1H, s), 8.28 (2H, d), 8.18 (1H, d), 7.89 (1H, s), 7.81 (1H, d), 7.79 (2H, s), 7.75 (1H, d), 7.72 (1H, d), 7.71 (2H, d), 7.66 (1H, dd), 7.62 (1H, d), 7.55 (2H, d), 7.51 (4H, dd), 7.44 (1H, dd), 7.41 (2H, s), 7.38 (1H, t), 7.32 (1H, t) |
| B445 | 9.09 (1H, s), 8.55 (1H, d), 8.49 (1H, d), 8.18 (1H, s), 8 (2H, d), 7.92 (1H, s), 7.89 (1H, d), 7.79 (2H, d), 7.75 (2H, d), 7.71 (1H, dd), 7.66 (1H, d), 7.62 (2H, d), 7.59 (2H, dd), 7.55 (2H, dd), 7.51 (2H, s), 7.44 (2H, t), 7.41 (1H, t), 7.38 (1H, dd), 7.32 (1H, dd) |
| B451 | 8.55 (1H, s), 8.18 (1H, d), 7.95 (1H, d), 7.89 (1H, s), 7.85 (2H, d), 7.79 (2H, s), 7.75 (2H, d), 7.71 (1H, d), 7.66 (1H, d), 7.64 (1H, dd), 7.62 (1H, d), 7.55 (2H, d), 7.52 (2H, dd), 7.51 (4H, dd), 7.44 (1H, s), 7.41 (2H, t), 7.38 (1H, t), 7.32 (1H, dd), 7.25 (2H, dd) |
| B457 | 8.55 (1H, s), 8.18 (1H, d), 7.89 (1H, d), 7.85 (2H, s), 7.79 (4H, d), 7.75 (2H, s), 7.71 (1H, d), 7.66 (1H, d), 7.62 (2H, d), 7.55 (2H, dd), 7.51 (4H, d), 7.47 (2H, d), 7.44 (2H, dd), 7.41 (2H, dd), 7.38 (1H, s), 7.32 (1H, t) |
| B461 | 8.55 (1H, s), 8.28 (4H, d), 8.18 (1H, d), 8 (2H, s), 7.92 (1H, d), 7.75 (1H, s), 7.73 (1H, d), 7.71 (1H, d), 7.62 (1H, d), 7.59 (2H, dd), 7.58 (1H, d), 7.55 (2H, d), 7.51 (4H, dd), 7.44 (1H, dd), 7.41 (2H, s) |
| B470 | 8.55 (1H, s), 8.28 (2H, d), 8.18 (1H, d), 7.85 (2H, s), 7.75 (1H, d), 7.71 (1H, s), 7.62 (1H, d), 7.55 (2H, d), 7.52 (4H, d), 7.51 (6H, dd), 7.44 (1H, d), 7.41 (3H, d), 7.25 (6H, dd) |
| B485 | 9.09 (1H, s), 8.55 (1H, d), 8.49 (1H, d), 8.28 (2H, s), 8.18 (1H, d), 8 (4H, s), 7.92 (2H, d), 7.75 (1H, d), 7.73 (1H, d), 7.71 (1H, dd), 7.62 (1H, d), 7.59 (4H, d), 7.58 (1H, dd), 7.55 (2H, dd), 7.51 (2H, s), 7.44 (1H, t), 7.41 (1H, t), 7.25 (4H, dd) |
| B490 | 8.55 (1H, s), 8.28 (2H, d), 8.18 (1H, d), 7.85 (2H, s), 7.75 (1H, d), 7.71 (1H, s), 7.62 (1H, d), 7.55 (2H, d), 7.52 (4H, d), 7.51 (6H, dd), 7.44 (1H, d), 7.25 (10H, d) |
| B495 | 8.55 (1H, s), 8.28 (2H, d), 8.24 (1H, d), 8.18 (1H, s), 7.92 (2H, d), 7.75 (1H, s), 7.73 (2H, d), 7.71 (1H, d), 7.7 (1H, d), 7.62 (1H, dd), 7.58 (2H, d), 7.57 (1H, d), 7.55 (2H, dd), 7.52 (4H, dd), 7.51 (6H, s), 7.48 (1H, t), 7.44 (1H, t), 7.41 (3H, dd) |
| B497 | 8.55 (1H, s), 8.28 (4H, d), 8.18 (2H, d), 8.12 (1H, s), 8 (1H, d), 7.77 (1H, s), 7.75 (1H, d), 7.71 (1H, d), 7.63 (1H, d), 7.62 (1H, dd), 7.58 (2H, d), 7.55 (2H, d), 7.51 (4H, dd), 7.5 (3H, dd), 7.45 (1H, s), 7.44 (1H, t), 7.41 (2H, t), 7.29 (1H, dd) |
| B507 | 8.55 (1H, s), 8.28 (2H, d), 8.18 (1H, d), 7.95 (1H, s), 7.89 (1H, d), 7.75 (2H, s), 7.71 (1H, d), 7.66 (1H, d), 7.64 (1H, d), 7.62 (1H, dd), 7.55 (2H, d), 7.52 (2H, d), 7.51 (4H, dd), 7.44 (1H, dd), 7.41 (2H, s), 7.38 (1H, t), 7.32 (1H, t), 7.25 (4H, dd) |
| B524 | 8.55 (1H, s), 8.28 (2H, d), 8.18 (2H, d), 8.12 (1H, s), 8 (1H, d), 7.85 (2H, s), 7.81 (1H, d), 7.77 (1H, d), 7.72 (1H, d), 7.71 (2H, dd), 7.63 (1H, d), 7.58 (2H, d), 7.55 (2H, dd), 7.52 (2H, dd), 7.51 (4H, s), 7.5 (3H, t), 7.29 (1H, t), 7.25 (2H, dd) |
| B526 | 9.09 (1H, s), 8.55 (1H, d), 8.49 (1H, d), 8.28 (2H, s), 8.18 (1H, d), 8 (4H, s), 7.92 (2H, d), 7.81 (1H, d), 7.73 (1H, d), 7.72 (1H, dd), 7.71 (2H, d), 7.59 (4H, d), 7.58 (1H, dd), 7.55 (2H, dd), 7.51 (2H, s), 7.41 (1H, t) |
| B540 | 9.09 (1H, s), 8.55 (1H, d), 8.49 (1H, d), 8.28 (2H, s), 8.18 (1H, d), 8 (2H, s), 7.95 (2H, d), 7.92 (1H, d), 7.89 (1H, d), 7.75 (2H, dd), 7.71 (1H, d), 7.66 (1H, d), 7.64 (2H, dd), 7.59 (2H, dd), 7.55 (2H, s), 7.51 (2H, t), 7.41 (1H, t), 7.38 (1H, dd), 7.32 (1H, dd) |
| B541 | 8.55 (1H, s), 8.18 (1H, d), 8 (2H, d), 7.95 (1H, s), 7.92 (1H, d), 7.85 (4H, s), 7.79 (2H, d), 7.75 (1H, d), 7.73 (1H, d), 7.71 (1H, dd), 7.64 (1H, d), 7.59 (2H, d), 7.58 (1H, dd), 7.55 (2H, dd), 7.52 (2H, s), 7.51 (4H, t), 7.25 (4H, t) |
| B543 | 8.55 (1H, s), 8.28 (2H, d), 8.18 (1H, d), 8 (4H, s), 7.95 (1H, d), 7.92 (2H, s), 7.85 (2H, d), 7.75 (1H, d), 7.73 (2H, d), 7.71 (1H, dd), 7.64 (1H, d), 7.59 (4H, d), 7.58 (2H, dd), 7.55 (2H, dd), 7.51 (2H, s), 7.41 (1H, t), 7.25 (2H, t) |
| B557 | 9.09 (1H, s), 8.55 (1H, d), 8.49 (1H, d), 8.18 (1H, s), 8 (4H, d), 7.95 (2H, s), 7.92 (2H, d), 7.89 (1H, d), 7.75 (2H, d), 7.73 (1H, dd), 7.71 (1H, d), 7.66 (1H, d), 7.64 (2H, dd), 7.59 (4H, dd), 7.58 (1H, s), 7.55 (2H, t), 7.38 (1H, t), 7.32 (1H, dd) |
| B571 | 8.55 (1H, s), 8.18 (1H, d), 7.85 (5H, d), 7.81 (1H, s), 7.71 (1H, d), 7.55 (2H, s), 7.52 (6H, d), 7.51 (6H, d), 7.41 (3H, d), 7.38 (1H, dd), 7.25 (4H, d) |
| B572 | 8.55 (1H, s), 8.28 (4H, d), 8.18 (1H, d), 7.85 (1H, s), 7.81 (1H, d), 7.71 (1H, s), 7.55 (2H, d), 7.52 (2H, d), 7.51 (6H, d), 7.41 (3H, dd), 7.38 (1H, d), 7.25 (8H, d) |
| B573 | 8.55 (1H, s), 8.28 (2H, d), 8.18 (1H, d), 7.85 (3H, s), 7.81 (1H, d), 7.71 (1H, s), 7.7 (1H, d), 7.57 (1H, d), 7.55 (2H, d), 7.52 (4H, dd), 7.51 (6H, d), 7.48 (2H, d), 7.41 (3H, dd), 7.38 (1H, dd), 7.25 (2H, s) |
| B575 | 8.55 (1H, s), 8.28 (2H, d), 8.18 (1H, d), 8 (2H, s), 7.92 (1H, d), 7.89 (1H, s), 7.85 (1H, d), 7.81 (1H, d), 7.75 (1H, d), 7.73 (1H, dd), 7.71 (1H, d), 7.66 (1H, d), 7.62 (1H, dd), 7.59 (2H, dd), 7.58 (1H, s), 7.55 (2H, t), 7.51 (2H, t), 7.44 (1H, dd), 7.41 (1H, dd), 7.38 (2H, t), 7.32 (1H, d) |
| B576 | 9.09 (1H, s), 8.55 (1H, d), 8.49 (1H, d), 8.18 (1H, s), 8 (4H, d), 7.92 (2H, s), 7.89 (1H, d), 7.85 (1H, d), 7.81 (2H, d), 7.73 (1H, dd), 7.72 (1H, d), 7.71 (2H, d), 7.66 (1H, dd), 7.59 (4H, dd), 7.58 (1H, s), 7.55 (2H, t), 7.38 (2H, t), 7.32 (1H, dd) |
| B580 | 9.09 (1H, s), 8.55 (1H, d), 8.49 (1H, d), 8.18 (1H, s), 8 (4H, d), 7.92 (2H, s), 7.85 (3H, d), 7.81 (1H, d), 7.73 (1H, d), 7.71 (1H, dd), 7.59 (4H, d), 7.58 (1H, d), 7.55 (2H, dd), 7.52 (2H, dd), 7.51 (2H, s), 7.41 (1H, t), 7.38 (1H, t), 7.25 (2H, dd) |
| B585 | 8.28 (4H, s), 8.16 (2H, d), 8 (2H, d), 7.92 (1H, s), 7.89 (1H, d), 7.73 (1H, s), 7.67 (2H, d), 7.6 (1H, d), 7.59 (2H, d), 7.58 (1H, dd), 7.57 (1H, d), 7.53 (1H, d), 7.51 (4H, dd), 7.41 (2H, dd), 7.25 (4H, s) |
| B586 | 8.28 (4H, s), 8.16 (2H, d), 7.92 (2H, d), 7.89 (1H, s), 7.73 (2H, d), 7.67 (2H, s), 7.6 (1H, d), 7.58 (2H, d), 7.57 (1H, d), 7.53 (1H, dd), 7.52 (2H, d), 7.51 (6H, d), 7.41 (3H, dd) |
| B588 | 9.09 (1H, s), 8.49 (1H, d), 8.28 (2H, d), 8.16 (2H, s), 8 (2H, d), 7.92 (1H, s), 7.89 (1H, d), 7.67 (2H, d), 7.6 (1H, d), 7.59 (2H, dd), 7.57 (1H, d), 7.53 (1H, d), 7.52 (2H, dd), 7.51 (4H, dd), 7.41 (2H, s) |
| B592 | 9.09 (1H, s), 8.49 (1H, d), 8.16 (2H, d), 8 (4H, s), 7.92 (2H, d), 7.89 (2H, s), 7.75 (1H, d), 7.73 (1H, d), 7.67 (2H, d), 7.66 (1H, dd), 7.62 (1H, d), 7.6 (1H, d), 7.59 (4H, dd), 7.58 (1H, dd), 7.57 (1H, s), 7.53 (1H, t), 7.44 (1H, t), 7.38 (1H, dd), 7.32 (1H, dd) |
| B601 | 8.16 (2H, s), 7.89 (1H, d), 7.85 (4H, d), 7.79 (2H, s), 7.67 (2H, d), 7.6 (1H, s), 7.57 (1H, d), 7.53 (1H, d), 7.52 (4H, d), 7.51 (6H, dd), 7.41 (3H, d), 7.25 (4H, d) |
| B605 | 9.09 (1H, s), 8.49 (1H, d), 8.16 (2H, d), 8 (4H, s), 7.95 (1H, d), 7.92 (2H, s), 7.89 (2H, d), 7.75 (1H, d), 7.73 (1H, d), 7.67 (2H, dd), 7.66 (1H, d), 7.64 (1H, d), 7.6 (1H, dd), 7.59 (4H, dd), 7.58 (1H, s), 7.57 (1H, t), 7.53 (1H, t), 7.38 (1H, dd), 7.32 (1H, dd) |
| B613 | 9.09 (1H, s), 8.49 (1H, d), 8.28 (2H, d), 8 (4H, s), 7.95 (1H, d), 7.92 (2H, s), 7.81 (1H, d), 7.75 (1H, d), 7.73 (1H, d), 7.72 (1H, dd), 7.71 (1H, d), 7.64 (1H, d), 7.59 (4H, dd), 7.58 (1H, dd), 7.51 (2H, s), 7.41 (1H, t) |
| B614 | 9.09 (1H, s), 8.49 (1H, d), 8 (2H, d), 7.95 (1H, s), 7.92 (1H, d), 7.89 (1H, s), 7.81 (1H, d), 7.75 (2H, d), 7.72 (1H, d), 7.71 (1H, dd), 7.66 (1H, d), 7.64 (1H, d), 7.62 (1H, dd), 7.59 (2H, dd), 7.52 (2H, s), 7.51 (2H, t), 7.44 (1H, t), 7.41 (1H, dd), 7.38 (1H, dd), 7.32 (1H, t) |
| B622 | 8.28 (4H, s), 8.16 (2H, d), 8 (2H, d), 7.92 (1H, s), 7.89 (1H, d), 7.87 (1H, s), 7.81 (1H, d), 7.73 (1H, d), 7.67 (2H, d), 7.59 (2H, dd), 7.58 (1H, d), 7.53 (1H, d), 7.51 (4H, dd), 7.41 (2H, dd), 7.25 (4H, s) |
| B628 | 9.09 (1H, s), 8.49 (1H, d), 8.16 (2H, d), 8 (4H, s), 7.92 (2H, d), 7.89 (2H, s), 7.87 (1H, d), 7.81 (2H, d), 7.73 (1H, d), 7.72 (1H, dd), 7.71 (1H, d), 7.67 (2H, d), 7.66 (1H, dd), 7.59 (4H, dd), 7.58 (1H, s), 7.53 (1H, t), 7.38 (1H, t), 7.32 (1H, dd) |
| B632 | 9.09 (1H, s), 8.49 (1H, d), 8.28 (2H, d), 8.16 (2H, s), 8 (4H, d), 7.92 (2H, s), 7.89 (1H, d), 7.87 (1H, d), 7.81 (1H, d), 7.73 (1H, dd), 7.67 (2H, d), 7.59 (4H, d), 7.58 (1H, dd), 7.53 (1H, dd), 7.51 (2H, s), 7.41 (1H, t), 7.25 (4H, t) |
| B633 | 8.28 (4H, s), 8.16 (2H, d), 8 (2H, d), 7.92 (1H, s), 7.89 (1H, d), 7.87 (1H, s), 7.81 (1H, d), 7.73 (1H, d), 7.67 (2H, d), 7.59 (2H, dd), 7.58 (1H, d), 7.53 (1H, d), 7.51 (4H, dd), 7.41 (2H, dd), 7.25 (4H, s) |
| B637 | 8.28 (2H, s), 8.16 (2H, d), 7.89 (2H, d), 7.87 (1H, s), 7.81 (1H, d), 7.75 (1H, s), 7.67 (2H, d), 7.66 (1H, d), 7.62 (1H, d), 7.53 (1H, dd), 7.52 (2H, d), 7.51 (4H, d), 7.44 (1H, dd), 7.41 (2H, dd), 7.38 (1H, s), 7.32 (1H, t) |
| B643 | 8.28 (2H, s), 8.16 (2H, d), 8 (2H, d), 7.92 (1H, s), 7.85 (2H, d), 7.79 (2H, s), 7.73 (1H, d), 7.67 (2H, d), 7.6 (1H, d), 7.59 (2H, dd), 7.58 (1H, d), 7.57 (1H, d), 7.51 (4H, dd), 7.49 (1H, dd), 7.42 (1H, s), 7.41 (2H, t), 7.25 (2H, t) |
| B644 | 9.09 (1H, s), 8.49 (1H, d), 8.28 (2H, d), 8.16 (2H, s), 7.92 (2H, d), 7.79 (2H, s), 7.73 (1H, d), 7.67 (2H, d), 7.6 (1H, d), 7.58 (1H, dd), 7.57 (1H, d), 7.52 (2H, d), 7.51 (6H, dd), 7.49 (1H, dd), 7.42 (1H, s), 7.41 (3H, t) |
| B646 | 8.28 (2H, s), 8.16 (2H, d), 7.89 (1H, d), 7.79 (2H, s), 7.75 (1H, d), 7.67 (2H, s), 7.66 (1H, d), 7.62 (1H, d), 7.6 (1H, d), 7.57 (1H, dd), 7.51 (4H, d), 7.49 (1H, d), 7.44 (1H, dd), 7.42 (1H, dd), 7.41 (2H, s), 7.38 (1H, t), 7.32 (1H, t) |
| B650 | 9.09 (1H, s), 8.49 (1H, d), 8.16 (2H, d), 8 (2H, s), 7.92 (1H, d), 7.89 (1H, s), 7.79 (2H, d), 7.75 (1H, d), 7.67 (2H, d), 7.66 (1H, dd), 7.62 (1H, d), 7.6 (1H, d), 7.59 (2H, dd), 7.57 (1H, dd), 7.51 (2H, s), 7.49 (1H, t), 7.44 (1H, t), 7.42 (1H, dd), 7.41 (1H, dd), 7.38 (1H, t), 7.32 (1H, d) |
| B654 | 9.09 (1H, s), 8.49 (1H, d), 8.28 (2H, d), 8.16 (2H, s), 8 (4H, d), 7.92 (2H, s), 7.73 (1H, d), 7.67 (2H, d), 7.6 (1H, d), 7.59 (4H, dd), 7.58 (1H, d), 7.57 (1H, d), 7.51 (2H, dd), 7.49 (1H, dd), 7.42 (1H, s), 7.41 (1H, t) |
| B661 | 8.16 (2H, s), 7.87 (1H, d), 7.85 (4H, d), 7.81 (1H, s), 7.79 (2H, d), 7.67 (2H, s), 7.52 (4H, d), 7.51 (6H, d), 7.49 (1H, d), 7.42 (1H, dd), 7.41 (3H, d), 7.25 (4H, d) |
| B671 | 8.16 (2H, s), 7.87 (1H, d), 7.85 (4H, d), 7.81 (1H, s), 7.67 (2H, d), 7.52 (6H, s), 7.51 (6H, d), 7.49 (1H, d), 7.42 (1H, d), 7.41 (3H, dd), 7.25 (4H, d) |
| B672 | 9.09 (1H, s), 8.49 (1H, d), 8.28 (2H, d), 8.16 (2H, s), 8 (4H, d), 7.92 (2H, s), 7.87 (1H, d), 7.81 (1H, d), 7.73 (1H, d), 7.67 (2H, dd), 7.59 (4H, d), 7.58 (1H, d), 7.51 (2H, dd), 7.49 (1H, dd), 7.42 (1H, s), 7.41 (1H, t), 7.25 (4H, t) |
| B674 | 8.28 (4H, s), 8.16 (2H, d), 7.92 (2H, d), 7.87 (1H, s), 7.81 (1H, d), 7.73 (2H, s), 7.67 (2H, d), 7.58 (2H, d), 7.52 (2H, d), 7.51 (6H, dd), 7.49 (1H, d), 7.42 (1H, d), 7.41 (3H, dd) |
| B686 | 9.09 (1H, s), 8.55 (2H, d), 8.49 (1H, d), 8.28 (2H, s), 8 (4H, d), 7.92 (2H, s), 7.75 (1H, d), 7.73 (1H, d), 7.64 (1H, d), 7.62 (1H, dd), 7.59 (4H, d), 7.58 (1H, d), 7.55 (2H, dd), 7.51 (2H, dd), 7.44 (1H, s), 7.41 (1H, t) |
| B687 | 8.55 (2H, s), 8.28 (2H, d), 7.89 (1H, d), 7.79 (2H, s), 7.75 (2H, d), 7.66 (1H, s), 7.64 (1H, d), 7.62 (2H, d), 7.55 (2H, d), 7.51 (4H, dd), 7.44 (2H, d), 7.41 (2H, d), 7.38 (1H, dd), 7.32 (1H, dd) |
| B697 | 9.09 (1H, s), 8.55 (2H, d), 8.49 (1H, d), 8 (4H, s), 7.95 (1H, d), 7.92 (2H, s), 7.89 (1H, d), 7.75 (2H, d), 7.73 (1H, d), 7.66 (1H, dd), 7.64 (2H, d), 7.62 (1H, d), 7.59 (4H, dd), 7.58 (1H, dd), 7.55 (2H, s), 7.44 (1H, t), 7.38 (1H, t), 7.32 (1H, dd) |
| B703 | 8.55 (2H, s), 8.28 (2H, d), 8 (4H, d), 7.92 (2H, s), 7.85 (2H, d), 7.81 (1H, s), 7.73 (2H, d), 7.72 (1H, d), 7.71 (1H, d), 7.64 (1H, dd), 7.59 (4H, d), 7.58 (2H, d), 7.55 (2H, dd), 7.51 (2H, dd), 7.41 (1H, s), 7.25 (2H, t) |
| B711 | 8.55 (2H, s), 7.85 (4H, d), 7.81 (1H, d), 7.72 (1H, s), 7.71 (1H, d), 7.64 (1H, s), 7.55 (2H, d), 7.52 (6H, d), 7.51 (6H, d), 7.41 (3H, dd), 7.25 (4H, d) |
| B721 | 8.55 (2H, s), 7.95 (1H, d), 7.85 (4H, d), 7.79 (2H, s), 7.75 (1H, d), 7.64 (2H, s), 7.55 (2H, d), 7.52 (4H, d), 7.51 (6H, d), 7.41 (3H, dd), 7.25 (4H, d) |
| B722 | 8.55 (2H, s), 8.28 (2H, d), 8 (2H, d), 7.95 (1H, s), 7.92 (1H, d), 7.85 (2H, s), 7.75 (1H, d), 7.73 (1H, d), 7.64 (2H, d), 7.59 (2H, dd), 7.58 (1H, d), 7.55 (2H, d), 7.52 (2H, dd), 7.51 (4H, dd), 7.41 (2H, s), 7.25 (2H, t) |
| B742 | 9.09 (1H, s), 8.55 (2H, d), 8.49 (1H, d), 8 (4H, s), 7.92 (2H, d), 7.85 (3H, s), 7.81 (1H, d), 7.73 (1H, d), 7.64 (1H, d), 7.59 (4H, dd), 7.58 (1H, d), 7.55 (2H, d), 7.52 (2H, dd), 7.51 (2H, dd), 7.41 (1H, s), 7.38 (1H, t), 7.25 (2H, t) |
| B747 | 8.55 (2H, s), 8.28 (2H, d), 7.89 (1H, d), 7.85 (1H, s), 7.81 (1H, d), 7.79 (2H, s), 7.75 (1H, d), 7.66 (1H, d), 7.64 (1H, d), 7.62 (1H, dd), 7.55 (2H, d), 7.51 (4H, d), 7.44 (1H, dd), 7.41 (2H, dd), 7.38 (2H, s), 7.32 (1H, t) |
| B751 | 8.55 (2H, s), 7.85 (5H, d), 7.81 (1H, d), 7.64 (1H, s), 7.55 (2H, d), 7.52 (6H, s), 7.51 (6H, d), 7.41 (3H, d), 7.38 (1H, d), 7.25 (4H, dd) |
| B752 | 8.55 (2H, s), 8.28 (2H, d), 7.85 (5H, d), 7.81 (1H, s), 7.79 (2H, d), 7.64 (1H, s), 7.55 (2H, d), 7.52 (2H, d), 7.51 (6H, d), 7.47 (2H, dd), 7.41 (3H, d), 7.38 (1H, d), 7.25 (2H, dd) |
| B763 | 8.28 (2H, s), 8 (2H, d), 7.95 (1H, d), 7.92 (1H, s), 7.89 (1H, d), 7.75 (3H, s), 7.73 (1H, d), 7.66 (1H, d), 7.64 (1H, d), 7.62 (2H, dd), 7.59 (2H, d), 7.58 (1H, d), 7.51 (2H, dd), 7.44 (2H, dd), 7.41 (1H, s), 7.38 (1H, t), 7.32 (1H, t) |
| B764 | 9.09 (1H, s), 8.49 (1H, d), 8 (4H, d), 7.95 (1H, s), 7.92 (2H, d), 7.89 (1H, s), 7.75 (3H, d), 7.73 (1H, d), 7.66 (1H, d), 7.64 (1H, dd), 7.62 (2H, d), 7.59 (4H, d), 7.58 (1H, dd), 7.44 (2H, dd), 7.38 (1H, s), 7.32 (1H, t) |
| B772 | 9.09 (1H, s), 8.49 (1H, d), 8 (4H, d), 7.95 (2H, s), 7.92 (2H, d), 7.89 (1H, s), 7.75 (3H, d), 7.73 (1H, d), 7.66 (1H, d), 7.64 (2H, dd), 7.62 (1H, d), 7.59 (4H, d), 7.58 (1H, dd), 7.44 (1H, dd), 7.38 (1H, s), 7.32 (1H, t) |
| B784 | 9.09 (1H, s), 8.49 (1H, d), 8 (2H, d), 7.95 (1H, s), 7.92 (1H, d), 7.89 (1H, s), 7.75 (3H, d), 7.7 (1H, d), 7.66 (1H, d), 7.64 (1H, dd), 7.62 (2H, d), 7.59 (2H, d), 7.57 (1H, dd), 7.52 (2H, dd), 7.51 (2H, s), 7.48 (2H, t), 7.44 (2H, t), 7.41 (1H, dd), 7.38 (1H, dd), 7.32 (1H, t) |
| B791 | 8.24 (1H, s), 8 (2H, d), 7.95 (1H, d), 7.92 (1H, s), 7.89 (1H, d), 7.81 (1H, s), 7.75 (2H, d), 7.73 (1H, d), 7.72 (1H, d), 7.71 (1H, dd), 7.7 (1H, d), 7.66 (1H, d), 7.64 (1H, dd), 7.62 (1H, dd), 7.59 (2H, s), 7.58 (1H, t), 7.57 (1H, t), 7.52 (2H, dd), 7.51 (2H, dd), 7.48 (1H, t), 7.44 (1H, d), 7.41 (1H, d), 7.38 (1H, d), 7.32 (1H, dd) |
| B795 | 8.28 (2H, s), 7.95 (1H, d), 7.89 (1H, d), 7.81 (1H, s), 7.75 (2H, d), 7.72 (1H, s), 7.71 (1H, d), 7.66 (1H, d), 7.64 (1H, d), 7.62 (1H, dd), 7.52 (2H, d), 7.51 (4H, d), 7.44 (1H, dd), 7.41 (2H, dd), 7.38 (1H, s), 7.32 (1H, t), 7.25 (4H, t) |

**[Table 7]**

| Target Compound No. | FD-MS | Target Compound No. | FD-MS |
|---|---|---|---|
| A6 | m/z = 802.30 (C60H38N2O, 802.96) | A642 | m/z = 2.859 (C64H37D5N2O, 860.06) |
| A33 | m/z = 778.30 (C58H38N2O, 778.94) | A653 | m/z = 2.807 (C60H33D5N2O, 807.99) |
| A104 | m/z = 778.30 (C58H38N2O, 778.94) | A660 | m/z = 2.2 (C58H31D5N2O2, 797.95) |
| A135 | m/z = 3.806 (C58H34N2O3, 806.90) | A663 | m/z = 2.783 (C58H33D5N2O, 783.97) |
| A147 | m/z = 2.868 (C64H40N2O2, 869.01) | A666 | m/z = 2.807 (C60H33D5N2O, 807.99) |
| A152 | m/z = 778.30 (C58H38N2O, 778.94) | A675 | m/z = 2.783 (C58H33D5N2O, 783.97) |
| A155 | m/z = 778.30 (C58H38N2O, 778.94) | A676 | m/z = 2.783 (C58H33D5N2O, 783.97) |
| A159 | m/z = 752.28 (C56H36N2O, 752.90) | A679 | m/z = 2.707 (C52H29D5N2O, 707.87) |
| A161 | m/z = 778.30 (C58H38N2O, 778.94) | A681 | m/z = 2.790 (C58H26D12N2O, 791.01) |
| A193 | m/z = 854.33 (C64H42N2O, 855.03) | A686 | m/z = 2.764 (C56H24D12N2O, 764.97) |
| A207 | m/z = 702.27 (C52H34N2O, 702.84) | A719 | m/z = 2.714 (C52H22D12N2O, 714.91) |
| A215 | m/z = 778.30 (C58H38N2O, 778.94) | A721 | m/z = 2.813 (C58H3D35N2O, 814.15) |
| A226 | m/z = 854.33 (C64H42N2O, 855.03) | A722 | m/z = 2.861 (C64H35D7N2O, 862.07) |
| A232 | m/z = 778.30 (C58H38N2O, 778.94) | A734 | m/z = 2.712 (C52H24D10N2O, 712.90) |
| A235 | m/z = 778.30 (C58H38N2O, 778.94) | A735 | m/z = 2.804 (C58H12D26N2O, 805.10) |
| A240 | m/z = 2.792 (C58H36N2O2, 792.92) | A761 | m/z = 2.813 (C58H3D35N2O, 814.15) |
| A248 | m/z = 2.883 (C66H37D5N2O, 884.08) | A762 | m/z = 2.861 (C64H35D7N2O, 862.07) |
| A288 | m/z = 2.783 (C58H33D5N2O, 783.97) | A763 | m/z = 2.829 (C60H11D27N2O, 830.12) |
| A308 | m/z = 2.783 (C58H33D5N2O, 783.97) | A803 | m/z = 703.25 (C52H33NO2, 703.82) |
| A325 | m/z = 2.707 (C52H29D5N2O, 707.87) | A812 | m/z = 30 (C55H39NO, 729.90) |
| A347 | m/z = 2.2 (C64H35D5N2O2, 874.05) | A814 | m/z = 779.28 (C58H37NO2, 779.92) |
| A352 | m/z = 2.783 (C58H33D5N2O, 783.97) | A818 | m/z = 26 (C58H37NOS, 795.99) |
| A356 | m/z = 2.757 (C56H31D5N2O, 757.93) | A827 | m/z = 703.25 (C52H33NO2, 703.82) |
| A358 | m/z = 2.783 (C58H33D5N2O, 783.97) | A839 | m/z = 627.22 (C46H29NO2, 627.73) |
| A367 | m/z = 2.837 (C62H31D9N2O, 838.05) | A842 | m/z = 703.25 (C52H33NO2, 703.82) |
| A402 | m/z = 2.789 (C58H27D11N2O, 790.00) | A852 | m/z = 30 (C55H39NO, 729.90) |
| A356 | m/z = 2.3 (C58H27D11N2O3, 822.00) | A867 | m/z = 703.25 (C52H33NO2, 703.82) |
| A451 | m/z = 2.2 (C58H26D10N2O2, 802.98) | A881 | m/z = 703.25 (C52H33NO2, 703.82) |
| A461 | m/z = 2.865 (C64H31D11N2O, 866.10) | A919 | m/z = 627.22 (C46H29NO2, 627.73) |
| A472 | m/z = 2.788 (C58H28D10N2O, 789.00) | A923 | m/z = 703.25 (C52H33NO2, 703.82) |
| A475 | m/z = 2.789 (C58H27D11N2O, 790.00) | A952 | m/z = 23 (C52H33NOS, 719.89) |
| A488 | m/z = 878.33 (C66H42N2O, 879.05) | A959 | m/z = 627.22 (C46H29NO2, 627.73) |
| A511 | m/z = 778.30 (C58H38N2O, 778.94) | A963 | m/z = 753.27 (C56H35NO2, 753.88) |
| A523 | m/z = 854.33 (C64H42N2O, 855.03) | A977 | m/z = 2.781 (C56H7D28NO2, 782.06) |
| A535 | m/z = 778.30 (C58H38N2O, 778.94) | A979 | m/z = 2.775 (C56H13D22NO2, 776.02) |
| A547 | m/z = 2.868 (C64H4ON202, 869.01) | A980 | m/z = 2.759 (C56H29D6NO2, 759.92) |
| A557 | m/z = 2.792 (C58H36N2O2, 792.92) | A981 | m/z = 2.783 (C58H33D5N2O, 783.97) |
| A566 | m/z = 828.31 (C62H40N2O, 828.99) | A982 | m/z = 2.859 (C64H37D5N2O, 860.06) |
| A591 | m/z = 778.30 (C58H38N2O, 778.94) | A983 | m/z = 2.807 (C60H33D5N2O, 807.99) |
| A602 | m/z = 854.33 (C64H42N2O, 855.03) | A991 | m/z = 2.783 (C58H33D5N2O, 783.97) |
| A615 | m/z = 778.30 (C58H38N2O, 778.94) | A995 | m/z = 2.783 (C58H33D5N2O, 783.97) |
| A624 | m/z = 802.30 (C60H38N2O, 802.96) | A1000 | m/z = 2.2 (C58H31D5N2O2, 797.95) |
| A634 | m/z = 2.792 (C58H36N2O2, 792.92) | A1014 | m/z = 2.783 (C58H33D5N2O, 783.97) |
| A635 | m/z = 778.30 (C58H38N2O, 778.94) | A1020 | m/z = 2.783 (C58H33D5N2O, 783.97) |
| A638 | m/z = 778.30 (C58H38N2O, 778.94) | A1026 | m/z = 2.764 (C56H24D12N2O, 764.97) |
| A641 | m/z = 2.783 (C58H33D5N2O, 783.97) | A1031 | m/z = 2.790 (C58H26D12N2O, 791.01) |
| B5 | m/z = 627.23 (C45H29N3O, 627.73) | B441 | m/z = 2.615 (C43H25N3O2, 615.68) |
| B6 | m/z = 601.22 (C43H27N3O, 601.69) | B442 | m/z = 2.615 (C43H25N3O2, 615.68) |
| B7 | m/z = 601.22 (C43H27N3O, 601.69) | B445 | m/z = 2.665 (C47H27N3O2, 665.74) |
| B15 | m/z = 2.615 (C43H25N3O2, 615.68) | B451 | m/z = 2.691 (C49H29N3O2, 691.77) |
| B17 | m/z = 2.641 (C45H27N3O2, 641.71) | B457 | m/z = 2.691 (C49H29N3O2, 691.77) |
| B25 | m/z = 601.22 (C43H27N3O, 601.69) | B461 | m/z = 575.20 (C41H25N3O, 575.66) |
| B26 | m/z = 525.18 (C37H23N3O, 525.60) | B470 | m/z = 677.25 (C49H31N3O, 677.79) |
| B41 | m/z = 677.25 (C49H31N3O, 677.79) | B485 | m/z = 701.25 (C51H31N3O, 701.81) |
| B42 | m/z = 677.25 (C49H31N3O, 677.79) | B490 | m/z = 753.28 (C55H35N3O, 753.89) |
| B46 | m/z = 551.20 (C39H25N3O, 551.64) | B495 | m/z = 727.26 (C53H33N3O, 727.85) |
| B67 | m/z = 601.22 (C43H27N3O, 601.69) | B497 | m/z = 690.24 (C49H30N4O, 690.79) |
| B68 | m/z = 601.22 (C43H27N3O, 601.69) | B507 | m/z = 2.691 (C49H29N3O2, 691.77) |
| B90 | m/z = 716.26 (C51H32N4O, 716.83) | B524 | m/z = 766.27 (C55H34N4O, 766.88) |
| B101 | m/z = 677.25 (C49H31N3O, 677.79) | B526 | m/z = 625.22 (C45H27N3O, 625.72) |
| B114 | m/z = 753.28 (C55H35N3O, 753.89) | B540 | m/z = 2.665 (C47H27N3O2, 665.74) |
| B117 | m/z = 651.23 (C47H29N3O, 651.75) | B541 | m/z = 727.26 (C53H33N3O, 727.85) |
| B136 | m/z = 575.20 (C41H25N3O, 575.66) | B543 | m/z = 701.25 (C51H31N3O, 701.81) |
| B139 | m/z = 651.23 (C47H29N3O, 651.75) | B557 | m/z = 2.715 (C51H29N3O2, 715.79) |
| B140 | m/z = 651.23 (C47H29N3O, 651.75) | B571 | m/z = 677.25 (C49H31N3O, 677.79) |
| B142 | m/z = 2.615 (C43H25N3O2, 615.68) | B572 | m/z = 677.25 (C49H31N3O, 677.79) |
| B145 | m/z = 2.641 (C45H27N3O2, 641.71) | B573 | m/z = 677.25 (C49H31N3O, 677.79) |
| B147 | m/z = 2.717 (C51H31N3O2, 717.81) | B575 | m/z = 2.665 (C47H27N3O2, 665.74) |
| B148 | m/z = 2.691 (C49H29N3O2, 691.77) | B576 | m/z = 2.715 (: C51H29N3O2, 715.79) |
| B150 | m/z = 2.691 (C49H29N3O2, 691.77) | B580 | m/z = 701.25 (C51H31N3O, 701.81) |
| B156 | m/z = 2.665 (C47H27N3O2, 665.74) | B585 | m/z = 651.23 (C47H29N3O, 651.75) |
| B168 | m/z = 2.691 (C49H29N3O2, 691.77) | B586 | m/z = 651.23 (C47H29N3O, 651.75) |
| B175 | m/z = 2.717 (C51H31N3O2, 717.81) | B588 | m/z = 575.20 (C41H25N3O, 575.66) |
| B177 | m/z = 2.717 (C51H31N3O2, 717.81) | B592 | m/z = 2.715 (C51H29N3O2, 715.79) |
| B188 | m/z = 2.691 (C49H29N3O2, 691.77) | B601 | m/z = 677.25 (C49H31N3O, 677.79) |
| B191 | m/z = 3.655 (C45H25N3O3, 655.70) | B605 | m/z = 2.715 (C51H29N3O2, 715.79) |
| B196 | m/z = 2.665 (C47H27N3O2, 665.74) | B613 | m/z = 575.20 (C41H25N3O, 575.66) |
| B208 | m/z = 2.691 (C49H29N3O2, 691.77) | B614 | m/z = 2.615 (C43H25N3O2, 615.68) |
| B215 | m/z = 2.615 (C43H25N3O2, 615.68) | B622 | m/z = 651.23 (C47H29N3O, 651.75) |
| B216 | m/z = 2.665 (C47H27N3O2, 665.74) | B628 | m/z = 2.715 (C51H29N3O2, 715.79) |
| B229 | m/z = 2.691 (C49H29N3O2, 691.77) | B632 | m/z = 701.25 (C51H31N3O, 701.81) |
| B230 | m/z = 2.691 (C49H29N3O2, 691.77) | B633 | m/z = 651.23 (C47H29N3O, 651.75) |
| B258 | m/z = 2.691 (C49H29N3O2, 691.77) | B637 | m/z = 2.615 (C43H25N3O2, 615.68) |
| B259 | m/z = 2.665 (C47H27N3O2, 665.74) | B643 | m/z = 651.23 (C47H29N3O, 651.75) |
| B261 | m/z = 601.22 (C43H27N3O, 601.69) | B644 | m/z = 651.23 (C47H29N3O, 651.75) |
| B266 | m/z = 2.665 (C47H27N3O2, 665.74) | B646 | m/z = 2.615 (C43H25N3O2, 615.68) |
| B288 | m/z = 2.565 (C39H23N3O2, 565.62) | B650 | m/z = 2.665 (C47H27N3O2, 665.74) |
| B289 | m/z = 2.565 (C39H23N3O2, 565.62) | B654 | m/z = 625.22 (C45H27N3O, 625.72) |
| B290 | m/z = 2.565 (C39H23N3O2, 565.62) | B661 | m/z = 677.25 (C49H31N3O, 677.79) |
| B298 | m/z = 2.615 (C43H25N3O2, 615.68) | B671 | m/z = 677.25 (C49H31N3O, 677.79) |
| B299 | m/z = 2.615 (C43H25N3O2, 615.68) | B672 | m/z = 701.25 (C51H31N3O, 701.81) |
| B308 | m/z = 2.641 (C45H27N3O2, 641.71) | B674 | m/z = 651.23 (C47H29N3O, 651.75) |
| B311 | m/z = 601.22 (C43H27N3O, 601.69) | B686 | m/z = 625.22 (C45H27N3O, 625.72) |
| B312 | m/z = 627.23 (C45H29N3O, 627.73) | B687 | m/z = 2.615 (C43H25N3O2, 615.68) |
| B327 | m/z = 677.25 (C49H31N3O, 677.79) | B697 | m/z = 2.715 (C51H29N3O2, 715.79) |
| B330 | m/z = 2.615 (C43H25N3O2, 615.68) | B703 | m/z = 701.25 (C51H31N3O, 701.81) |
| B336 | m/z = 701.25 (C51H31N3O, 701.81) | B711 | m/z = 677.25 (C49H31N3O, 677.79) |
| B348 | m/z = 2.691 (C49H29N3O2, 691.77) | B721 | m/z = 677.25 (C49H31N3O, 677.79) |
| B353 | m/z = 677.25 (C49H31N3O, 677.79) | B722 | m/z = 651.23 (C47H29N3O, 651.75) |
| B371 | m/z = 651.23 (C47H29N3O, 651.75) | B742 | m/z = 701.25 (C51H31N3O, 701.81) |
| B379 | m/z = 2.691 (C49H29N3O2, 691.77) | B747 | m/z = 2.615 (C43H25N3O2, 615.68) |
| B385 | m/z = 753.28 (C55H35N3O, 753.89) | B751 | m/z = 677.25 (C49H31N3O, 677.79) |
| B386 | m/z = 753.28 (C55H35N3O, 753.89) | B752 | m/z = 677.25 (C49H31N3O, 677.79) |
| B387 | m/z = 779.29 (C57H37N3O, 779.92) | B763 | m/z = 2.615 (C43H25N3O2, 615.68) |
| B411 | m/z = 2.741 (C53H31N3O2, 741.83) | B764 | m/z = 2.665 (C47H27N3O2, 665.74) |
| B412 | m/z = 2.741 (C53H31N3O2, 741.83) | B772 | m/z = 2.665 (C47H27N3O2, 665.74) |
| B422 | m/z = 575.20 (C41H25N3O, 575.66) | B784 | m/z = 2.691 (C49H29N3O2, 691.77) |
| B423 | m/z = 601.22 (C43H27N3O, 601.69) | B791 | m/z = 2.691 (C49H29N3O2, 691.77) |
| B424 | m/z = 601.22 (C43H27N3O, 601.69) | B795 | m/z = 2.641 (C45H27N3O2, 641.71) |

### Experimental Examples.

### <Experimental Example 1> Manufacture of Organic Light Emitting Device

A glass substrate, in which indium tin oxide (ITO) was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then subjected to ultraviolet ozone (UVO) treatment for 5 minutes using UV in an ultraviolet (UV) washing machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

As the common layers, the hole injection layer 4,4',4"-tris[2-naphthyl(phenyl)amino]triphenylamine (2-TNATA) and the hole transport layer N,N'-di(1-naphthyl)-N,N'-diphenyl-(1,1'-biphenyl)-4,4'-diamine (NPB) were formed on the ITO transparent electrode (positive electrode).

A light emitting layer was thermally vacuum deposited thereon as follows. The light emitting layer was deposited to have a thickness of 500 Å by using a compound (premixed when two or more compounds were used) shown in the following

Table 8 as a red host and (piq)₂(Ir) (acac) as a red phosphorescent dopant to dope the host with (piq)₂(Ir) (acac) in an amount of 3%.

Thereafter, BCP was deposited as a hole blocking layer to have a thickness of 60 Å, and Alq₃ was deposited as an electron transport layer to have a thickness of 200 Å thereon. Finally, lithium fluoride (LiF) was deposited to have a thickness of 10 Å on the electron transport layer to form an electron injection layer, and then an aluminum (Al) negative electrode was deposited to have a thickness of 1,200 Å on the electron injection layer to form a negative electrode, thereby manufacturing an organic light emitting device.

Meanwhile, all the organic compounds required for manufacturing an OLED device were subjected to vacuum sublimed purification under 10⁻⁸ to 10⁻⁶ torr for each material, and used for the manufacture of OLED.

For the organic light emitting device manufactured as described above, electroluminescence (EL) characteristics were measured by M7000 manufactured by McScience Inc., and based on the measurement result thereof, T₉₀ was measured by a life time measurement device (M6000) manufactured by McScience Inc., when the reference luminance was 6,000 cd/m². T₉₀ means the life time (unit: hour) that is the time it takes for the luminance to reach 90% relative to the initial luminance.

The characteristics of the organic light emitting device of the present invention are as shown in the following Table 8. The comparative compounds shown in the following Table 8 are as follows.

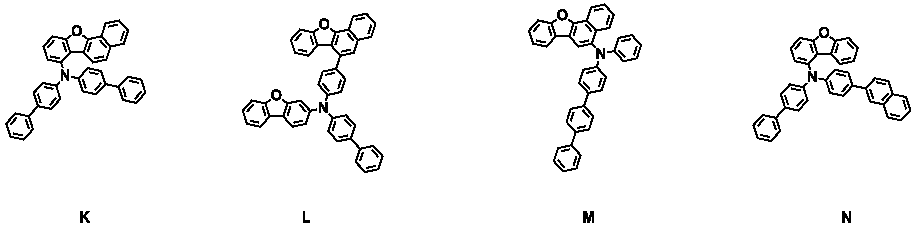

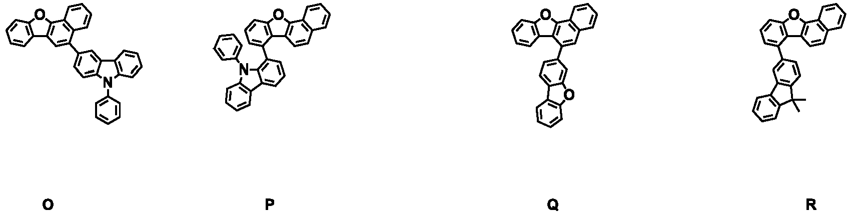

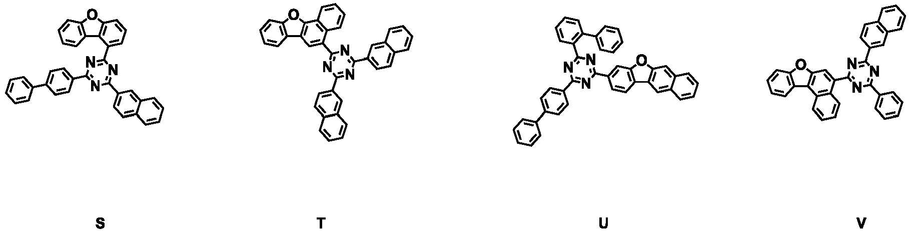

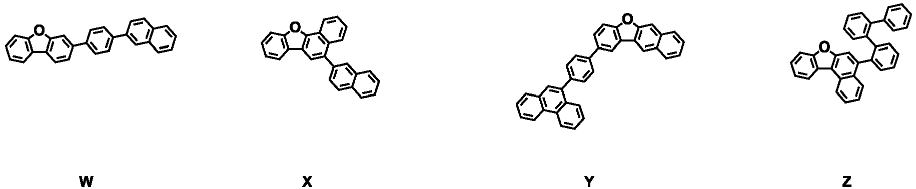

**[Table 8]**

| No. | Compound | | Ratio (P:N) | Threshold voltage (Vₒₙ) | Driving voltage (Vₒₚ) | Efficiency (cd/A) | Color coordinate (x, y) | Life time (T₉₀) |
|---|---|---|---|---|---|---|---|---|
| | First host (P) | Second host (N) | | | | | | |
| Comparative Example 1 | A6 | | - | 3.2 | 7.1 | 16.49 | (0.684, 0.316) | 3 |
| Comparative Example 2 | A33 | | - | 3.2 | 7.1 | 17.03 | (0.685, 0.314) | 3 |
| Comparative Example 3 | A104 | | - | 2.9 | 6.8 | 18.32 | (0.684, 0.315) | 6 |
| Comparative Example 4 | A135 | | - | 3.1 | 7.0 | 17.04 | (0.684, 0.316) | 4 |
| Comparative Example 5 | A147 | | - | 3.1 | 7.0 | 16.32 | (0.684, 0.316) | 4 |
| Comparative Example 6 | A152 | | - | 2.9 | 6.8 | 17.58 | (0.684, 0.316) | 6 |
| Comparative Example 7 | A155 | | - | 2.8 | 6.7 | 17.32 | (0.684, 0.316) | 7 |
| Comparative Example 8 | A159 | | - | 3 | 6.9 | 16.55 | (0.684, 0.315) | 5 |
| Comparative Example 9 | A161 | | - | 3.3 | 7.2 | 16.23 | (0.683, 0.317) | 2 |
| Comparative Example 10 | A193 | | - | 3.1 | 7.0 | 16.5 | (0.684, 0.316) | 4 |
| Comparative Example 11 | A207 | | - | 3 | 6.9 | 17.21 | (0.683, 0.318) | 5 |
| Comparative Example 12 | A215 | | - | 3.2 | 7.1 | 16.6 | (0.685, 0.314) | 3 |
| Comparative Example 13 | A226 | | - | 3.2 | 7.1 | 16.12 | (0.684, 0315) | 3 |
| Comparative Example 14 | A232 | | - | 3 | 6.9 | 16.6 | (0.685, 0.315) | 5 |
| Comparative Example 15 | A235 | | - | 2.9 | 6.8 | 17.04 | (0.683, 0.318) | 6 |
| Comparative Example 16 | A240 | | - | 3.1 | 7.0 | 16.21 | (0.684, 0315) | 4 |
| Comparative Example 17 | A248 | | - | 3.1 | 7.0 | 17.66 | (0.683, 0.318) | 4 |
| Comparative Example 18 | A288 | | - | 2.9 | 6.8 | 20.22 | (0.680, 0.319) | 6 |
| Comparative Example 19 | A308 | | - | 2.8 | 6.7 | 19.76 | (0.684, 0.316) | 7 |
| Comparative Example 20 | A325 | | - | 3 | 6.9 | 18.23 | (0.685, 0.315) | 5 |
| Comparative Example 21 | A347 | | - | 3 | 6.9 | 17.2 | (0.683, 0.317) | 5 |
| Comparative Example 22 | A352 | | - | 2.9 | 6.8 | 19.34 | (0.684, 0.315) | 6 |
| Comparative Example 23 | A356 | | - | 2.8 | 6.7 | 18.21 | (0.684, 0.316) | 7 |
| Comparative Example 24 | A358 | | - | 2.9 | 6.8 | 17.22 | (0.683, 0.318) | 6 |
| Comparative Example 25 | A367 | | - | 3 | 6.9 | 16.98 | (0.685, 0.314) | 5 |
| Comparative Example 26 | A402 | | - | 2.8 | 6.7 | 18.32 | (0.684, 0315) | 7 |
| Comparative Example 27 | A356 | | - | 2.7 | 6.6 | 17.14 | (0.685, 0.315) | 8 |
| Comparative Example 28 | A451 | | - | 2.9 | 6.8 | 16.62 | (0.683, 0.318) | 6 |
| Comparative Example 29 | A461 | | - | 2.9 | 6.8 | 16.62 | (0.684, 0.316) | 6 |
| Comparative Example 30 | A472 | | - | 2.7 | 6.6 | 18.02 | (0.684, 0.316) | 8 |
| Comparative Example 31 | A475 | | - | 2.6 | 6.5 | 17.14 | (0.685, 0.314) | 9 |
| Comparative Example 32 | A488 | | - | 2.9 | 6.8 | 16.89 | (0.684, 0.315) | 6 |
| Comparative Example 33 | A511 | | - | 2.7 | 6.6 | 17.88 | (0.684, 0.316) | 8 |
| Comparative Example 34 | A523 | | - | 2.6 | 6.5 | 18.64 | (0.684, 0.316) | 9 |
| Comparative Example 35 | A535 | | - | 2.8 | 6.7 | 17.11 | (0.684, 0.316) | 7 |
| Comparative Example 36 | A547 | | - | 3 | 6.9 | 16.64 | (0.684, 0.316) | 5 |
| Comparative Example 37 | A557 | | - | 2.7 | 6.6 | 17.88 | (0.684, 0.315) | 8 |
| Comparative Example 38 | A566 | | - | 2.8 | 6.7 | 17.46 | (0.683, 0.317) | 7 |
| Comparative Example 39 | A591 | | - | 2.6 | 6.5 | 18.89 | (0.684, 0.316) | 9 |
| Comparative Example 40 | A602 | | - | 2.5 | 6.4 | 19.32 | (0.683, 0.318) | 10 |
| Comparative Example 41 | A615 | | - | 2.7 | 6.6 | 17.89 | (0.685, 0.314) | 8 |
| Comparative Example 42 | A624 | | - | 2.7 | 6.6 | 17.11 | (0.684, 0315) | 8 |
| Comparative Example 43 | A634 | | - | 2.5 | 6.4 | 18.01 | (0.685, 0.315) | 10 |
| Comparative Example 44 | A635 | | - | 2.4 | 6.3 | 18.65 | (0.683, 0.318) | 11 |
| Comparative Example 45 | A638 | | - | 2.6 | 6.5 | 17.03 | (0.684, 0315) | 9 |
| Comparative Example 46 | A641 | | - | 2.6 | 6.5 | 18.55 | (0.683, 0.318) | 9 |
| Comparative Example 47 | A642 | | - | 2.6 | 6.5 | 18.02 | (0.680, 0.319) | 9 |
| Comparative Example 48 | A653 | | - | 2.5 | 6.4 | 19.01 | (0.684, 0.316) | 10 |
| Comparative Example 49 | A660 | | - | 2.5 | 6.4 | 19.42 | (0.685, 0.315) | 10 |
| Comparative Example 50 | A663 | | - | 2.8 | 6.7 | 17.54 | (0.683, 0.317) | 7 |
| Comparative Example 51 | A666 | | - | 2.7 | 6.6 | 17.79 | (0.684, 0.315) | 8 |
| Comparative Example 52 | A675 | | - | 2.7 | 6.6 | 18.12 | (0.684, 0.316) | 8 |
| Comparative Example 53 | A676 | | - | 2.7 | 6.6 | 18.22 | (0.683, 0.318) | 8 |
| Comparative Example 54 | A679 | | - | 2.6 | 6.5 | 18.77 | (0.685, 0.314) | 9 |
| Comparative Example 55 | A681 | | - | 2.7 | 6.6 | 17.52 | (0.684, 0315) | 8 |
| Comparative Example 56 | A686 | | - | 2.7 | 6.6 | 17.34 | (0.685, 0.315) | 8 |
| Comparative Example 57 | A719 | | - | 2.5 | 6.4 | 18 | (0.683, 0.318) | 10 |
| Comparative Example 58 | A721 | | - | 2.9 | 6.8 | 16.89 | (0.684, 0.316) | 6 |
| Comparative Example 59 | A722 | | - | 2.9 | 6.8 | 16.32 | (0.684, 0.316) | 6 |
| Comparative Example 60 | A734 | | - | 2.8 | 6.7 | 17.01 | (0.685, 0.314) | 7 |
| Comparative Example 61 | A735 | | - | 2.8 | 6.7 | 16.88 | (0.684, 0.315) | 7 |
| Comparative Example 62 | A761 | | - | 2.6 | 6.5 | 17.76 | (0.684, 0.316) | 9 |
| Comparative Example 63 | A762 | | - | 2.6 | 6.5 | 17.32 | (0.684, 0.316) | 9 |
| Comparative Example 64 | A763 | | - | 2.6 | 6.5 | 17.54 | (0.684, 0.316) | 9 |
| Comparative Example 65 | A803 | | - | 2.5 | 6.4 | 18.21 | (0.684, 0.316) | 5 |
| Comparative Example 66 | A812 | | - | 2.4 | 6.3 | 15.62 | (0.684, 0.315) | 2 |
| Comparative Example 67 | A814 | | - | 2.8 | 6.7 | 15.89 | (0.683, 0.317) | 2 |
| Comparative Example 68 | A818 | | - | 2.7 | 6.6 | 15.73 | (0.684, 0.316) | 1 |
| Comparative Example 69 | A827 | | - | 2.5 | 6.4 | 18.08 | (0.683, 0.318) | 5 |
| Comparative Example 70 | A839 | | - | 2.5 | 6.4 | 17.98 | (0.685, 0.314) | 5 |
| Comparative Example 71 | A842 | | - | 2.9 | 6.8 | 15.52 | (0.684, 0315) | 1 |
| Comparative Example 72 | A852 | | - | 2.5 | 6.4 | 14.89 | (0.685, 0.315) | 1 |
| Comparative Example 73 | A867 | | - | 2.5 | 6.4 | 17.54 | (0.683, 0.318) | 5 |
| Comparative Example 74 | A881 | | - | 2.4 | 6.3 | 18.32 | (0.684, 0315) | 6 |
| Comparative Example 75 | A919 | | - | 2.3 | 6.2 | 19.08 | (0.683, 0.318) | 7 |
| Comparative Example 76 | A923 | | - | 2.4 | 6.3 | 18.71 | (0.680, 0.319) | 6 |
| Comparative Example 77 | A952 | | - | 2.6 | 6.5 | 15.89 | (0.684, 0.316) | 2 |
| Comparative Example 78 | A959 | | - | 2.5 | 6.4 | 18.24 | (0.685, 0.315) | 5 |
| Comparative Example 79 | A963 | | - | 2.3 | 6.2 | 18.96 | (0.683, 0.317) | 7 |
| Comparative Example 80 | A977 | | - | 2.2 | 6.1 | 17.44 | (0.684, 0.315) | 8 |
| Comparative Example 81 | A979 | | - | 2.2 | 6.1 | 16.42 | (0.684, 0.316) | 8 |
| Comparative Example 82 | A980 | | - | 2.3 | 6.2 | 16.05 | (0.683, 0.318) | 7 |
| Comparative Example 83 | A981 | | - | 2.7 | 6.6 | 19.23 | (0.684, 0315) | 8 |
| Comparative Example 84 | A982 | | - | 2.7 | 6.6 | 19.02 | (0.683, 0.318) | 8 |
| Comparative Example 85 | A983 | | - | 2.7 | 6.6 | 19.12 | (0.680, 0.319) | 8 |
| Comparative Example 86 | A991 | | - | 2.6 | 6.5 | 20.21 | (0.684, 0.316) | 9 |
| Comparative Example 87 | A995 | | - | 2.6 | 6.5 | 20.03 | (0.684, 0.316) | 9 |
| Comparative Example 88 | A1000 | | - | 2.6 | 6.5 | 19.89 | (0.685, 0.314) | 9 |
| Comparative Example 89 | A1014 | | - | 2.6 | 6.5 | 18.89 | (0.684, 0.315) | 9 |
| Comparative Example 90 | A1020 | | - | 2.7 | 6.6 | 17.92 | (0.684, 0.316) | 8 |
| Comparative Example 91 | A1026 | | - | 2.6 | 6.5 | 18.21 | (0.684, 0.316) | 9 |
| Comparative Example 92 | A1031 | | - | 2.5 | 6.4 | 18.37 | (0.684, 0.316) | 10 |
| Comparative Example 93 | K | | - | 3.8 | 7.53 | 10.52 | (0.684, 0.316) | 6 |
| Comparative Example 94 | L | | - | 3.8 | 7.53 | 10.52 | (0.684, 0.315) | 3 |
| Comparative Example 95 | M | | - | 4 | 7.73 | 12.26 | (0.683, 0.317) | 3 |
| Comparative Example 96 | N | | - | 3.6 | 7.33 | 8.78 | (0.684, 0.316) | 4 |
| Comparative Example 97 | O | | - | 2.15 | 5.68 | 13.24 | (0.683, 0.318) | 16 |
| Comparative Example 98 | P | | - | 2.35 | 5.88 | 16.72 | (0.685, 0.314) | 20 |
| Comparative Example 99 | Q | | - | 2.25 | 5.78 | 14.98 | (0.684, 0315) | 18 |
| Comparative Example 100 | R | | - | 2.35 | 5.88 | 16.72 | (0.685, 0.315) | 20 |
| Comparative Example 101 | B5 | | - | 2.31 | 3.90 | 54.43 | (0.684, 0.316) | 58 |
| Comparative Example 102 | B6 | | - | 2.35 | 3.98 | 56.46 | (0.685, 0.314) | 62 |
| Comparative Example 103 | B7 | | - | 2.38 | 4.04 | 55.89 | (0.684, 0.315) | 68 |
| Comparative Example 104 | B17 | | - | 2.42 | 4.12 | 54.71 | (0.684, 0.316) | 52 |
| Comparative Example 105 | B25 | | - | 2.4 | 4.08 | 53.42 | (0.684, 0.316) | 51 |
| Comparative Example 106 | B41 | | - | 2.29 | 3.86 | 53.81 | (0.684, 0.315) | 54 |
| Comparative Example 107 | B42 | | - | 2.31 | 3.90 | 52.38 | (0.683, 0.317) | 58 |
| Comparative Example 108 | B67 | | - | 2.35 | 3.98 | 51.43 | (0.683, 0.318) | 53 |
| Comparative Example 109 | B68 | | - | 2.39 | 4.06 | 52.44 | (0.685, 0.314) | 47 |
| Comparative Example 110 | B90 | | - | 2.38 | 4.04 | 48.41 | (0.684, 0315) | 48 |
| Comparative Example 111 | B114 | | - | 2.33 | 3.94 | 51.44 | (0.683, 0.318) | 55 |
| Comparative Example 112 | B117 | | - | 2.31 | 3.90 | 50.12 | (0.684, 0315) | 53 |
| Comparative Example 113 | B136 | | - | 2.38 | 4.04 | 53.33 | (0.683, 0.318) | 43 |
| Comparative Example 114 | B140 | | - | 2.39 | 4.06 | 53.74 | (0.684, 0.316) | 48 |
| Comparative Example 115 | B142 | | - | 2.35 | 3.98 | 55.61 | (0.685, 0.315) | 54 |
| Comparative Example 116 | B147 | | - | 2.33 | 3.94 | 55.71 | (0.684, 0.315) | 62 |
| Comparative Example 117 | B148 | | - | 2.34 | 3.96 | 58.41 | (0.684, 0.316) | 63 |
| Comparative Example 118 | B150 | | - | 2.36 | 4.00 | 57.14 | (0.683, 0.318) | 68 |
| Comparative Example 119 | B156 | | - | 2.34 | 3.96 | 56.43 | (0.685, 0.314) | 63 |
| Comparative Example 120 | B175 | | - | 2.39 | 4.06 | 53.11 | (0.685, 0.315) | 57 |
| Comparative Example 121 | B177 | | - | 2.41 | 4.10 | 52.94 | (0.683, 0.318) | 54 |
| Comparative Example 122 | B188 | | - | 2.32 | 3.92 | 54.91 | (0.684, 0.316) | 59 |
| Comparative Example 123 | B208 | | - | 2.32 | 3.92 | 53.86 | (0.684, 0.315) | 54 |
| Comparative Example 124 | B215 | | - | 2.33 | 3.94 | 52.37 | (0.684, 0.316) | 51 |
| Comparative Example 125 | B216 | | - | 2.33 | 3.94 | 56.18 | (0.684, 0.316) | 53 |
| Comparative Example 126 | B230 | | - | 2.32 | 3.92 | 52.12 | (0.684, 0.316) | 59 |
| Comparative Example 127 | B259 | | - | 2.39 | 4.06 | 53.74 | (0.683, 0.317) | 50 |
| Comparative Example 128 | B261 | | - | 2.28 | 3.84 | 47.41 | (0.684, 0.316) | 41 |
| Comparative Example 129 | B266 | | - | 2.29 | 3.86 | 48.14 | (0.683, 0.318) | 42 |
| Comparative Example 130 | B288 | | - | 2.37 | 4.02 | 50.49 | (0.685, 0.314) | 53 |
| Comparative Example 131 | B290 | | - | 2.33 | 3.94 | 50.1 | (0.685, 0.315) | 52 |
| Comparative Example 132 | B298 | | - | 2.36 | 4.00 | 53.02 | (0.683, 0.318) | 54 |
| Comparative Example 133 | B299 | | - | 2.33 | 3.94 | 51.92 | (0.684, 0315) | 53 |
| Comparative Example 134 | B308 | | - | 2.39 | 4.06 | 48.22 | (0.683, 0.318) | 53 |
| Comparative Example 135 | B312 | | - | 2.37 | 4.02 | 47.71 | (0.684, 0.316) | 51 |
| Comparative Example 136 | B327 | | - | 2.31 | 3.90 | 47.8 | (0.685, 0.315) | 54 |
| Comparative Example 137 | B330 | | - | 2.32 | 3.92 | 49.14 | (0.683, 0.317) | 53 |
| Comparative Example 138 | B336 | | - | 2.32 | 3.92 | 47.31 | (0.684, 0.315) | 55 |
| Comparative Example 139 | B353 | | - | 2.34 | 3.96 | 46.98 | (0.683, 0.318) | 49 |
| Comparative Example 140 | B371 | | - | 2.3 | 3.88 | 49.29 | (0.685, 0.314) | 52 |
| Comparative Example 141 | B379 | | - | 2.31 | 3.90 | 50.41 | (0.684, 0315) | 51 |
| Comparative Example 142 | B386 | | - | 2.26 | 3.80 | 50.07 | (0.683, 0.318) | 50 |
| Comparative Example 143 | B387 | | - | 2.28 | 3.84 | 50.82 | (0.684, 0.316) | 49 |
| Comparative Example 144 | B412 | | - | 2.3 | 3.88 | 48.16 | (0.685, 0.314) | 51 |
| Comparative Example 145 | B422 | | - | 2.17 | 3.62 | 56.71 | (0.684, 0.315) | 58 |
| Comparative Example 146 | B424 | | - | 2.18 | 3.64 | 54.55 | (0.684, 0.316) | 57 |
| Comparative Example 147 | B441 | | - | 2.2 | 3.68 | 57.75 | (0.684, 0.316) | 58 |
| Comparative Example 148 | B442 | | - | 2.16 | 3.60 | 55.82 | (0.684, 0.316) | 58 |
| Comparative Example 149 | B445 | | - | 2.23 | 3.74 | 58.42 | (0.684, 0.315) | 60 |
| Comparative Example 150 | B451 | | - | 2.21 | 3.70 | 54.31 | (0.683, 0.317) | 59 |
| Comparative Example 151 | B461 | | - | 2.14 | 3.56 | 56.5 | (0.683, 0.318) | 61 |
| Comparative Example 152 | B470 | | - | 2.12 | 3.52 | 57.43 | (0.685, 0.314) | 63 |
| Comparative Example 153 | B490 | | - | 2.11 | 3.50 | 57.12 | (0.685, 0.315) | 62 |
| Comparative Example 154 | B495 | | - | 2.2 | 3.68 | 55.13 | (0.683, 0.318) | 57 |
| Comparative Example 155 | B497 | | - | 2.24 | 3.76 | 54.91 | (0.684, 0315) | 58 |
| Comparative Example 156 | B507 | | - | 2.13 | 3.54 | 55.72 | (0.683, 0.318) | 60 |
| Comparative Example 157 | B540 | | - | 2.3 | 3.88 | 46.43 | (0.685, 0.315) | 42 |
| Comparative Example 158 | B541 | | - | 2.28 | 3.84 | 47.25 | (0.683, 0.317) | 46 |
| Comparative Example 159 | B557 | | - | 2.31 | 3.90 | 48.73 | (0.684, 0.316) | 51 |
| Comparative Example 160 | B571 | | - | 2.3 | 3.88 | 46.25 | (0.683, 0.318) | 48 |
| Comparative Example 161 | B572 | | - | 2.34 | 3.96 | 45.98 | (0.684, 0315) | 46 |
| Comparative Example 162 | B576 | | - | 2.39 | 4.06 | 44.32 | (0.684, 0.316) | 43 |
| Comparative Example 163 | B580 | | - | 2.38 | 4.04 | 43.98 | (0.684, 0.316) | 43 |
| Comparative Example 164 | B585 | | - | 2.25 | 3.78 | 51.43 | (0.685, 0.314) | 58 |
| Comparative Example 165 | B588 | | - | 2.28 | 3.84 | 50.45 | (0.684, 0.316) | 54 |
| Comparative Example 166 | B592 | | - | 2.27 | 3.82 | 54.77 | (0.684, 0.316) | 56 |
| Comparative Example 167 | B605 | | - | 2.36 | 4.00 | 47.52 | (0.684, 0.316) | 47 |
| Comparative Example 168 | B613 | | - | 2.37 | 4.02 | 46.44 | (0.684, 0.315) | 43 |
| Comparative Example 169 | B622 | | - | 2.31 | 3.90 | 47.22 | (0.684, 0.316) | 40 |
| Comparative Example 170 | B628 | | - | 2.3 | 3.88 | 46.82 | (0.683, 0.318) | 41 |
| Comparative Example 171 | B632 | | - | 2.27 | 3.82 | 51.34 | (0.685, 0.314) | 54 |
| Comparative Example 172 | B633 | | - | 2.28 | 3.84 | 54.25 | (0.684, 0315) | 56 |
| Comparative Example 173 | B643 | | - | 2.11 | 3.50 | 52.44 | (0.685, 0.314) | 72 |
| Comparative Example 174 | B644 | | - | 2.12 | 3.52 | 51.79 | (0.684, 0315) | 78 |
| Comparative Example 175 | B646 | | - | 2.04 | 3.36 | 53.89 | (0.685, 0.315) | 80 |
| Comparative Example 176 | B650 | | - | 2.06 | 3.40 | 53.54 | (0.683, 0.318) | 81 |
| Comparative Example 177 | B661 | | - | 2.29 | 3.86 | 48.08 | (0.684, 0.316) | 45 |
| Comparative Example 178 | B672 | | - | 2.25 | 3.78 | 52.92 | (0.684, 0.315) | 54 |
| Comparative Example 179 | B674 | | - | 2.26 | 3.80 | 53.3 | (0.684, 0.316) | 58 |
| Comparative Example 180 | B686 | | - | 2.34 | 3.96 | 44.72 | (0.684, 0.316) | 50 |
| Comparative Example 181 | B687 | | - | 2.35 | 3.98 | 45.92 | (0.684, 0.316) | 51 |
| Comparative Example 182 | B703 | | - | 2.27 | 3.82 | 44.22 | (0.684, 0.315) | 47 |
| Comparative Example 183 | B721 | | - | 2.3 | 3.88 | 46.25 | (0.684, 0.316) | 50 |
| Comparative Example 184 | B722 | | - | 2.31 | 3.90 | 46.81 | (0.684, 0.316) | 52 |
| Comparative Example 185 | B742 | | - | 2.38 | 4.04 | 44.2 | (0.685, 0.314) | 47 |
| Comparative Example 186 | B747 | | - | 2.41 | 4.10 | 43.3 | (0.684, 0.315) | 46 |
| Comparative Example 187 | B752 | | - | 2.44 | 4.16 | 43.42 | (0.683, 0.318) | 42 |
| Comparative Example 188 | B763 | | - | 2.6 | 4.48 | 56.8 | (0.685, 0.314) | 59 |
| Comparative Example 189 | B764 | | - | 2.59 | 4.46 | 57.5 | (0.684, 0315) | 61 |
| Comparative Example 190 | B772 | | - | 2.54 | 4.36 | 56.92 | (0.685, 0.315) | 60 |
| Comparative Example 191 | B791 | | - | 2.62 | 4.52 | 55.86 | (0.684, 0315) | 59 |
| Comparative Example 192 | B795 | | - | 2.56 | 4.40 | 56.5 | (0.683, 0.318) | 62 |
| Comparative Example 193 | S | | - | 3.2 | 5.68 | 40.21 | (0.680, 0.319) | 34 |
| Comparative Example 194 | T | | - | 3.14 | 5.56 | 42.37 | (0.684, 0.316) | 33 |
| Comparative Example 195 | U | | - | 3.22 | 5.72 | 38.21 | (0.685, 0.315) | 28 |
| Comparative Example 196 | V | | - | 3.12 | 5.52 | 43.04 | (0.683, 0.317) | 31 |
| Comparative Example 197 | W | | - | 2.1 | 3.48 | 18.21 | (0.684, 0.315) | 18 |
| Comparative Example 198 | X | | - | 2.15 | 3.58 | 19.67 | (0.684, 0.316) | 21 |
| Comparative Example 199 | Y | | - | 2.18 | 3.64 | 15.42 | (0.683, 0.318) | 20 |
| Comparative Example 200 | Z | | - | 2.24 | 3.76 | 13.92 | (0.684, 0315) | 15 |
| Comparative Example 201 | K | B42 | 1:1 | 2.41 | 4.81 | 54.73 | (0.683, 0.318) | 93 |
| Comparative Example 202 | K | B177 | 1:1 | 2.42 | 4.99 | 55.10 | (0.685, 0.315) | 88 |
| Comparative Example 203 | K | B261 | 1:1 | 2.40 | 4.75 | 51.45 | (0.683, 0.318) | 74 |
| Comparative Example 204 | K | B411 | 1:1 | 2.41 | 4.82 | 53.07 | (0.684, 0.316) | 84 |
| Comparative Example 205 | K | B386 | 1:1 | 2.40 | 4.72 | 53.21 | (0.683, 0.317) | 84 |
| Comparative Example 206 | L | B497 | 1:1 | 2.40 | 4.68 | 56.40 | (0.685, 0.315) | 89 |
| Comparative Example 207 | L | B445 | 1:1 | 2.40 | 4.66 | 58.72 | (0.683, 0.318) | 92 |
| Comparative Example 208 | L | B540 | 1:1 | 2.41 | 4.79 | 50.80 | (0.684, 0.316) | 72 |
| Comparative Example 209 | L | B577 | 1:1 | 2.41 | 4.81 | 52.32 | (0.684, 0315) | 82 |
| Comparative Example 210 | L | B573 | 1:1 | 2.41 | 4.93 | 49.57 | (0.683, 0.318) | 74 |
| Comparative Example 211 | M | B588 | 1:1 | 2.42 | 4.93 | 54.60 | (0.684, 0.316) | 85 |
| Comparative Example 212 | M | B613 | 1:1 | 2.43 | 5.09 | 51.96 | (0.680, 0.319) | 73 |
| Comparative Example 213 | M | B622 | 1:1 | 2.43 | 4.99 | 52.47 | (0.685, 0.314) | 69 |
| Comparative Example 214 | M | B650 | 1:1 | 2.40 | 4.54 | 56.64 | (0.684, 0.316) | 115 |
| Comparative Example 215 | M | B671 | 1:1 | 2.43 | 4.97 | 54.56 | (0.683, 0.318) | 82 |
| Comparative Example 216 | N | B686 | 1:1 | 2.39 | 4.68 | 48.53 | (0.685, 0.315) | 82 |
| Comparative Example 217 | N | B711 | 1:1 | 2.38 | 4.57 | 49.15 | (0.680, 0.319) | 77 |
| Comparative Example 218 | N | B742 | 1:1 | 2.39 | 4.75 | 48.18 | (0.684, 0.316) | 78 |
| Comparative Example 219 | N | B772 | 1:1 | 2.41 | 5.04 | 56.58 | (0.684, 0.316) | 93 |
| Comparative Example 220 | O | B46 | 1:1 | 2.24 | 3.18 | 54.85 | (0.684, 0.316) | 97 |
| Comparative Example 221 | O | B188 | 1:1 | 2.24 | 3.16 | 58.19 | (0.685, 0.314) | 105 |
| Comparative Example 222 | O | B266 | 1:1 | 2.24 | 3.11 | 53.73 | (0.684, 0315) | 86 |
| Comparative Example 223 | O | B412 | 1:1 | 2.24 | 3.12 | 53.74 | (0.684, 0315) | 96 |
| Comparative Example 224 | O | B387 | 1:1 | 2.24 | 3.09 | 55.50 | (0.680, 0.319) | 94 |
| Comparative Example 225 | P | B422 | 1:1 | 2.25 | 3.07 | 61.68 | (0.683, 0.318) | 109 |
| Comparative Example 226 | P | B451 | 1:1 | 2.25 | 3.14 | 60.10 | (0.683, 0.318) | 110 |
| Comparative Example 227 | P | B524 | 1:1 | 2.26 | 3.29 | 55.41 | (0.684, 0.316) | 92 |
| Comparative Example 228 | P | B541 | 1:1 | 2.26 | 3.27 | 55.44 | (0.684, 0.316) | 95 |
| Comparative Example 229 | P | B575 | 1:1 | 2.27 | 3.48 | 53.78 | (0.684, 0.316) | 92 |
| Comparative Example 230 | Q | B592 | 1:1 | 2.25 | 3.16 | 59.25 | (0.685, 0.314) | 104 |
| Comparative Example 231 | Q | B614 | 1:1 | 2.26 | 3.36 | 55.03 | (0.684, 0.316) | 88 |
| Comparative Example 232 | Q | B628 | 1:1 | 2.25 | 3.21 | 54.00 | (0.684, 0.315) | 87 |
| Comparative Example 233 | Q | B654 | 1:1 | 2.25 | 3.18 | 56.14 | (0.684, 0.315) | 89 |
| Comparative Example 234 | Q | B672 | 1:1 | 2.25 | 3.12 | 58.03 | (0.684, 0315) | 102 |
| Comparative Example 235 | R | B687 | 1:1 | 2.27 | 3.39 | 54.56 | (0.684, 0.315) | 101 |
| Comparative Example 236 | R | B721 | 1:1 | 2.26 | 3.30 | 54.78 | (0.685, 0.315) | 100 |
| Comparative Example 237 | R | B747 | 1:1 | 2.27 | 3.50 | 52.83 | (0.685, 0.315) | 95 |
| Comparative Example 238 | R | B784 | 1:1 | 2.29 | 3.86 | 61.44 | (0.684, 0315) | 110 |
| Comparative Example 239 | A6 | S | 1:1 | 2.44 | 6.02 | 50.64 | (0.684, 0.316) | 63 |
| Comparative Example 240 | A147 | T | 1:1 | 2.42 | 5.82 | 51.95 | (0.684, 0.316) | 63 |
| Comparative Example 241 | A161 | U | 1:1 | 2.45 | 6.15 | 49.15 | (0.683, 0.318) | 55 |
| Comparative Example 242 | A226 | V | 1:1 | 2.43 | 5.88 | 52.26 | (0.683, 0.317) | 59 |
| Comparative Example 243 | A566 | S | 1:1 | 2.40 | 5.66 | 51.28 | (0.684, 0315) | 67 |
| Comparative Example 244 | A624 | T | 1:1 | 2.38 | 5.46 | 52.47 | (0.684, 0.316) | 67 |
| Comparative Example 245 | A488 | U | 1:1 | 2.41 | 5.79 | 49.58 | (0.683, 0.317) | 59 |
| Comparative Example 246 | A547 | V | 1:1 | 2.41 | 5.70 | 52.60 | (0.683, 0.317) | 61 |
| Comparative Example 247 | A803 | S | 1:1 | 2.37 | 5.39 | 51.77 | (0.684, 0.316) | 65 |
| Comparative Example 248 | A248 | T | 1:1 | 2.42 | 5.82 | 52.84 | (0.684, 0.316) | 63 |
| Comparative Example 249 | A347 | U | 1:1 | 2.42 | 5.88 | 49.79 | (0.685, 0.314) | 58 |
| Comparative Example 250 | A981 | V | 1:1 | 2.38 | 5.43 | 55.30 | (0.684, 0.315) | 65 |
| Comparative Example 251 | A1014 | S | 1:1 | 2.38 | 5.48 | 52.22 | (0.683, 0.318) | 69 |
| Comparative Example 252 | A641 | T | 1:1 | 2.37 | 5.37 | 53.42 | (0.680, 0.319) | 68 |
| Comparative Example 253 | A675 | U | 1:1 | 2.39 | 5.61 | 50.39 | (0.684, 0.315) | 61 |
| Comparative Example 254 | A803 | V | 1:1 | 2.36 | 5.25 | 53.64 | (0.680, 0.319) | 61 |
| Comparative Example 255 | A33 | W | 1:1 | 2.33 | 4.04 | 36.47 | (0.684, 0.315) | 45 |
| Comparative Example 256 | A152 | X | 1:1 | 2.30 | 3.86 | 37.80 | (0.684, 0315) | 51 |
| Comparative Example 257 | A193 | Y | 1:1 | 2.32 | 4.10 | 34.28 | (0.684, 0.316) | 48 |
| Comparative Example 258 | A232 | Z | 1:1 | 2.32 | 4.11 | 33.36 | (0.683, 0.318) | 44 |
| Comparative Example 259 | A591 | W | 1:1 | 2.27 | 3.50 | 38.03 | (0.683, 0.318) | 51 |
| Comparative Example 260 | A634 | X | 1:1 | 2.26 | 3.50 | 38.08 | (0.684, 0.315) | 56 |
| Comparative Example 261 | A511 | Y | 1:1 | 2.28 | 3.74 | 35.19 | (0.684, 0.316) | 53 |
| Comparative Example 262 | A557 | Z | 1:1 | 2.29 | 3.84 | 34.20 | (0.683, 0.318) | 47 |
| Comparative Example 263 | A288 | W | 1:1 | 2.30 | 3.77 | 38.58 | (0.684, 0.316) | 48 |
| Comparative Example 264 | A352 | X | 1:1 | 2.30 | 3.86 | 38.96 | (0.684, 0.316) | 51 |
| Comparative Example 265 | A982 | Y | 1:1 | 2.28 | 3.74 | 36.94 | (0.685, 0.315) | 53 |
| Comparative Example 266 | A1020 | Z | 1:1 | 2.29 | 3.84 | 34.23 | (0.685, 0.315) | 47 |
| Comparative Example 267 | A642 | W | 1:1 | 2.27 | 3.50 | 37.13 | (0.684, 0.316) | 51 |
| Comparative Example 268 | A676 | X | 1:1 | 2.28 | 3.68 | 38.22 | (0.683, 0.318) | 54 |
| Comparative Example 269 | A814 | Y | 1:1 | 2.29 | 3.83 | 33.88 | (0.685, 0.314) | 46 |
| Example 1 | A6 | B5 | 1:1 | 2.35 | 3.93 | 88.69 | (0.683, 0.318) | 155 |
| Example 2 | A248 | B142 | 1:1 | 2.34 | 3.91 | 92.58 | (0.683, 0.318) | 149 |
| Example 3 | A367 | B261 | 1:1 | 2.32 | 3.72 | 79.88 | (0.683, 0.317) | 126 |
| Example 4 | A33 | B288 | 1:1 | 2.35 | 4.02 | 84.35 | (0.685, 0.314) | 146 |
| Example 5 | A288 | B311 | 1:1 | 2.32 | 3.80 | 85.63 | (0.684, 0.316) | 148 |
| Example 6 | A402 | B422 | 1:1 | 2.29 | 3.38 | 95.09 | (0.685, 0.315) | 163 |
| Example 7 | A104 | B441 | 1:1 | 2.31 | 3.51 | 96.58 | (0.684, 0.315) | 161 |
| Example 8 | | | 1:1.5 | 2.28 | 3.44 | 94.65 | (0.683, 0.318) | 158 |
| Example 9 | | | 1.5:1 | 2.35 | 3.58 | 98.51 | (0.683, 0.318) | 164 |
| Example 10 | | | 2:1 | 2.38 | 3.65 | 100.48 | (0.683, 0.317) | 168 |
| Example 11 | | | 3:1 | 2.32 | 3.53 | 96.97 | (0.685, 0.314) | 162 |
| Example 12 | A308 | B524 | 1:1 | 2.30 | 3.58 | 83.57 | (0.683, 0.318) | 134 |
| Example 13 | A356 | B541 | 1:1 | 2.30 | 3.56 | 81.41 | (0.684, 0.316) | 140 |
| Example 14 | A135 | B571 | 1:1 | 2.34 | 3.83 | 78.31 | (0.684, 0.316) | 138 |
| Example 15 | A325 | B585 | 1:1 | 2.32 | 3.67 | 87.41 | (0.684, 0.316) | 159 |
| Example 16 | A451 | B613 | 1:1 | 2.32 | 3.78 | 77.98 | (0.684, 0315) | 132 |
| Example 17 | A6 | B632 | 1:1 | 2.34 | 3.86 | 84.80 | (0.685, 0.314) | 148 |
| Example 18 | A803 | B643 | 1:1 | 2.26 | 3.05 | 88.83 | (0.685, 0.314) | 187 |
| Example 19 | A812 | B671 | 1:1 | 2.27 | 3.27 | 82.18 | (0.684, 0.316) | 140 |
| Example 20 | A818 | B686 | 1:1 | 2.30 | 3.58 | 74.24 | (0.684, 0315) | 136 |
| Example 21 | A980 | B721 | 1:1 | 2.26 | 3.19 | 76.89 | (0.683, 0.317) | 148 |
| Example 22 | A979 | B742 | 1:1 | 2.25 | 3.24 | 74.49 | (0.683, 0.317) | 144 |
| Example 23 | A104 | B763 | 1:1 | 2.35 | 4.15 | 95.22 | (0.684, 0.316) | 163 |
| Example 24 | A147 | B6 | 1:1 | 2.34 | 3.91 | 91.88 | (0.684, 0.315) | 165 |
| Example 25 | A347 | B145 | 1:1 | 2.33 | 3.86 | 89.20 | (0.684, 0.316) | 155 |
| Example 26 | A461 | B266 | 1:1 | 2.31 | 3.66 | 80.41 | (0.684, 0315) | 130 |
| Example 27 | A152 | B289 | 1:1 | 2.32 | 3.74 | 83.22 | (0.685, 0.315) | 149 |
| Example 28 | A352 | B312 | 1:1 | 2.32 | 3.78 | 83.68 | (0.683, 0.318) | 148 |
| Example 29 | A472 | B423 | 1:1 | 2.28 | 3.27 | 92.91 | (0.685, 0.315) | 167 |
| Example 30 | A155 | B442 | 1:1 | 2.29 | 3.37 | 92.39 | (0.683, 0.318) | 163 |
| Example 31 | A356 | B526 | 1:1 | 2.30 | 3.56 | 82.25 | (0.684, 0.316) | 138 |
| Example 32 | A475 | B543 | 1:1 | 2.28 | 3.40 | 81.14 | (0.683, 0.317) | 146 |
| Example 33 | A159 | B572 | 1:1 | 2.33 | 3.82 | 77.22 | (0.685, 0.315) | 136 |
| Example 34 | A358 | B586 | 1:1 | 2.31 | 3.61 | 85.08 | (0.683, 0.318) | 163 |
| Example 35 | A147 | B614 | 1:1 | 2.34 | 3.96 | 80.31 | (0.684, 0.316) | 126 |
| Example 36 | A347 | B633 | 1:1 | 2.32 | 3.72 | 89.97 | (0.684, 0315) | 155 |
| Example 37 | A461 | B644 | 1:1 | 2.30 | 3.38 | 85.63 | (0.683, 0.318) | 200 |
| Example 38 | | | 1:1.5 | 2.27 | 3.32 | 83.91 | (0.685, 0.315) | 196 |
| Example 39 | | | 1.5:1 | 2.34 | 3.45 | 87.34 | (0.683, 0.318) | 204 |
| Example 40 | | | 2:1 | 2.37 | 3.52 | 89.09 | (0.684, 0.316) | 209 |
| Example 41 | | | 3:1 | 2.31 | 3.40 | 85.97 | (0.683, 0.317) | 201 |
| Example 42 | A152 | B672 | 1:1 | 2.31 | 3.59 | 88.62 | (0.684, 0.316) | 153 |
| Example 43 | A352 | B687 | 1:1 | 2.32 | 3.75 | 81.12 | (0.680, 0.319) | 148 |
| Example 44 | A472 | B722 | 1:1 | 2.30 | 3.53 | 80.51 | (0.685, 0.314) | 153 |
| Example 45 | A155 | B747 | 1:1 | 2.32 | 3.77 | 74.49 | (0.684, 0.316) | 140 |
| Example 46 | A356 | B764 | 1:1 | 2.33 | 4.06 | 96.07 | (0.683, 0.318) | 169 |
| Example 47 | A161 | B7 | 1:1 | 2.36 | 4.12 | 90.93 | (0.685, 0.315) | 173 |
| Example 48 | A193 | B147 | 1:1 | 2.34 | 3.88 | 91.06 | (0.680, 0.319) | 165 |
| Example 49 | A207 | B261 | 1:1 | 2.32 | 3.72 | 80.21 | (0.684, 0.316) | 126 |
| Example 50 | A215 | B290 | 1:1 | 2.35 | 3.96 | 83.18 | (0.684, 0.316) | 144 |
| Example 51 | A842 | B327 | 1:1 | 2.32 | 3.69 | 78.35 | (0.684, 0.316) | 144 |
| Example 52 | A867 | B424 | 1:1 | 2.26 | 3.16 | 90.89 | (0.685, 0.314) | 157 |
| Example 53 | A852 | B445 | 1:1 | 2.27 | 3.24 | 92.63 | (0.684, 0315) | 155 |
| Example 54 | A161 | B540 | 1:1 | 2.36 | 3.99 | 77.40 | (0.684, 0315) | 122 |
| Example 55 | A193 | B577 | 1:1 | 2.34 | 3.85 | 81.08 | (0.680, 0.319) | 144 |
| Example 56 | A207 | B573 | 1:1 | 2.33 | 3.88 | 76.13 | (0.683, 0.318) | 132 |
| Example 57 | A215 | B588 | 1:1 | 2.34 | 3.88 | 83.68 | (0.683, 0.318) | 148 |
| Example 58 | A842 | B613 | 1:1 | 2.32 | 3.78 | 76.40 | (0.684, 0.316) | 122 |
| Example 59 | A867 | B637 | 1:1 | 2.28 | 3.42 | 89.79 | (0.684, 0.316) | 157 |
| Example 60 | A852 | B646 | 1:1 | 2.25 | 2.94 | 86.16 | (0.684, 0.316) | 195 |
| Example 61 | A161 | B674 | 1:1 | 2.35 | 3.93 | 87.23 | (0.685, 0.314) | 153 |
| Example 62 | A193 | B697 | 1:1 | 2.33 | 3.82 | 73.33 | (0.684, 0.316) | 138 |
| Example 63 | A193 | B711 | 1:1 | 2.33 | 3.80 | 76.70 | (0.684, 0.315) | 134 |
| Example 64 | A207 | B751 | 1:1 | 2.34 | 3.94 | 76.55 | (0.684, 0.315) | 132 |
| Example 65 | A215 | B772 | 1:1 | 2.37 | 4.30 | 92.93 | (0.684, 0315) | 159 |
| Example 66 | A226 | B15 | 1:1 | 2.36 | 4.07 | 86.96 | (0.684, 0.315) | 148 |
| Example 67 | A232 | B148 | 1:1 | 2.33 | 3.82 | 95.07 | (0.685, 0.315) | 169 |
| Example 68 | A235 | B266 | 1:1 | 2.31 | 3.66 | 81.01 | (0.685, 0.315) | 130 |
| Example 69 | A240 | B298 | 1:1 | 2.34 | 3.93 | 86.80 | (0.684, 0315) | 149 |
| Example 70 | A226 | B336 | 1:1 | 2.35 | 3.94 | 78.51 | (0.684, 0.316) | 149 |
| Example 71 | A232 | B461 | 1:1 | 2.31 | 3.50 | 92.33 | (0.684, 0.316) | 165 |
| Example 72 | A235 | B451 | 1:1 | 2.31 | 3.53 | 89.83 | (0.683, 0.318) | 163 |
| Example 73 | A240 | B524 | 1:1 | 2.33 | 3.82 | 78.49 | (0.683, 0.317) | 128 |
| Example 74 | A226 | B541 | 1:1 | 2.34 | 3.88 | 78.42 | (0.684, 0315) | 132 |
| Example 75 | A232 | B575 | 1:1 | 2.34 | 3.91 | 75.52 | (0.684, 0.316) | 130 |
| Example 76 | A235 | B592 | 1:1 | 2.31 | 3.62 | 90.49 | (0.683, 0.317) | 157 |
| Example 77 | A240 | B614 | 1:1 | 2.34 | 3.96 | 80.15 | (0.683, 0.317) | 126 |
| Example 78 | A226 | B622 | 1:1 | 2.35 | 3.93 | 78.38 | (0.684, 0.316) | 120 |
| Example 79 | A232 | B650 | 1:1 | 2.30 | 3.37 | 88.10 | (0.684, 0.316) | 204 |
| Example 80 | | | 1:1.5 | 2.27 | 3.30 | 86.34 | (0.685, 0.315) | 200 |
| Example 81 | | | 1.5:1 | 2.34 | 3.44 | 89.86 | (0.683, 0.318) | 208 |
| Example 82 | | | 2:1 | 2.35 | 3.47 | 90.76 | (0.684, 0.316) | 211 |
| Example 83 | | | 3:1 | 2.39 | 3.54 | 92.58 | (0.683, 0.317) | 215 |
| Example 84 | A235 | B661 | 1:1 | 2.31 | 3.66 | 80.92 | (0.685, 0.314) | 136 |
| Example 85 | A240 | B703 | 1:1 | 2.33 | 3.78 | 74.22 | (0.684, 0.315) | 136 |
| Example 86 | A226 | B721 | 1:1 | 2.35 | 3.91 | 76.99 | (0.683, 0.318) | 140 |
| Example 87 | A232 | B752 | 1:1 | 2.34 | 3.98 | 73.63 | (0.680, 0.319) | 128 |
| Example 88 | A235 | B784 | 1:1 | 2.35 | 4.17 | 92.75 | (0.684, 0.315) | 163 |
| Example 89 | A566 | B17 | 1:1 | 2.32 | 3.78 | 91.00 | (0.680, 0.319) | 151 |
| Example 90 | A981 | B150 | 1:1 | 2.30 | 3.61 | 99.16 | (0.684, 0.315) | 185 |
| Example 91 | | | 1:1.5 | 2.27 | 3.54 | 97.17 | (0.685, 0.315) | 181 |
| Example 92 | | | 1:2 | 2.23 | 3.47 | 95.23 | (0.685, 0.315) | 177 |
| Example 93 | | | 1.5:1 | 2.34 | 3.68 | 101.14 | (0.683, 0.318) | 188 |
| Example 94 | | | 2:1 | 2.37 | 3.75 | 103.16 | (0.684, 0.316) | 192 |
| Example 95 | | | 3:1 | 2.31 | 3.62 | 99.55 | (0.683, 0.317) | 185 |
| Example 96 | A1026 | B261 | 1:1 | 2.28 | 3.40 | 81.64 | (0.684, 0315) | 134 |
| Example 97 | A761 | B299 | 1:1 | 2.29 | 3.48 | 87.44 | (0.684, 0.316) | 157 |
| Example 98 | A591 | B353 | 1:1 | 2.29 | 3.50 | 82.71 | (0.683, 0.318) | 149 |
| Example 99 | A982 | B470 | 1:1 | 2.28 | 3.22 | 99.27 | (0.683, 0.318) | 175 |
| Example 100 | | | 1:1.5 | 2.25 | 3.16 | 97.28 | (0.685, 0.315) | 171. 45 |
| Example 101 | | | 1:2 | 2.22 | 3.10 | 95.34 | (0.685, 0.315) | 168. 02 |
| Example 102 | | | 1.5:1 | 2.32 | 3.29 | 101.25 | (0.683, 0.318) | 178. 44 |
| Example 103 | | | 2:1 | 2.35 | 3.35 | 103.28 | (0.684, 0.316) | 182 |
| Example 104 | | | 3:1 | 2.29 | 3.24 | 99.67 | (0.683, 0.317) | 176 |
| Example 105 | A1031 | B457 | 1:1 | 2.28 | 3.35 | 88.70 | (0.684, 0.315) | 167 |
| Example 106 | A762 | B526 | 1:1 | 2.28 | 3.40 | 80.98 | (0.684, 0.316) | 142 |
| Example 107 | A602 | B543 | 1:1 | 2.27 | 3.32 | 84.97 | (0.683, 0.318) | 148 |
| Example 108 | A983 | B576 | 1:1 | 2.30 | 3.66 | 80.67 | (0.684, 0.316) | 136 |
| Example 109 | A763 | B601 | 1:1 | 2.29 | 3.46 | 81.95 | (0.684, 0.316) | 148 |
| Example 110 | A1000 | B613 | 1:1 | 2.29 | 3.54 | 84.80 | (0.685, 0.315) | 138 |
| Example 111 | A615 | B628 | 1:1 | 2.30 | 3.51 | 80.34 | (0.685, 0.315) | 132 |
| Example 112 | A991 | B654 | 1:1 | 2.28 | 3.40 | 90.43 | (0.684, 0.316) | 138 |
| Example 113 | A977 | B671 | 1:1 | 2.25 | 3.11 | 84.78 | (0.683, 0.318) | 151 |
| Example 114 | A981 | B686 | 1:1 | 2.30 | 3.58 | 81.39 | (0.685, 0.314) | 149 |
| Example 115 | A881 | B722 | 1:1 | 2.27 | 3.29 | 80.94 | (0.683, 0.318) | 149 |
| Example 116 | A919 | B742 | 1:1 | 2.26 | 3.32 | 78.29 | (0.683, 0.318) | 142 |
| Example 117 | A963 | B791 | 1:1 | 2.29 | 3.70 | 94.79 | (0.683, 0.317) | 165 |
| Example 118 | A624 | B25 | 1:1 | 2.31 | 3.67 | 88.66 | (0.685, 0.314) | 151 |
| Example 119 | A1014 | B156 | 1:1 | 2.29 | 3.50 | 95.51 | (0.684, 0.316) | 177 |
| Example 120 | A634 | B266 | 1:1 | 2.27 | 3.34 | 82.40 | (0.685, 0.315) | 138 |
| Example 121 | A1020 | B308 | 1:1 | 2.30 | 3.66 | 82.38 | (0.684, 0.315) | 155 |
| Example 122 | A635 | B371 | 1:1 | 2.27 | 3.27 | 84.96 | (0.683, 0.318) | 159 |
| Example 123 | A1014 | B485 | 1:1 | 2.27 | 3.18 | 97.54 | (0.684, 0.316) | 175 |
| Example 124 | | | 1:1.5 | 2.24 | 3.11 | 95.59 | (0.685, 0.315) | 171 |
| Example 125 | | | 1.5:1 | 2.30 | 3.24 | 99.49 | (0.683, 0.318) | 178 |
| Example 126 | | | 2:1 | 2.25 | 3.14 | 96.51 | (0.684, 0.316) | 173 |
| Example 127 | | | 3:1 | 2.22 | 3.08 | 94.58 | (0.683, 0.317) | 170 |
| Example 128 | A638 | B507 | 1:1 | 2.27 | 3.16 | 91.83 | (0.684, 0.316) | 171 |
| Example 129 | A1020 | B540 | 1:1 | 2.30 | 3.51 | 79.82 | (0.684, 0.316) | 134 |
| Example 130 | A624 | B577 | 1:1 | 2.30 | 3.53 | 81.95 | (0.684, 0315) | 151 |
| Example 131 | A1014 | B580 | 1:1 | 2.29 | 3.56 | 77.71 | (0.685, 0.314) | 138 |
| Example 132 | A634 | B605 | 1:1 | 2.28 | 3.45 | 81.51 | (0.685, 0.314) | 148 |
| Example 133 | A1020 | B614 | 1:1 | 2.30 | 3.64 | 82.60 | (0.684, 0.316) | 134 |
| Example 134 | A635 | B632 | 1:1 | 2.26 | 3.22 | 87.89 | (0.684, 0315) | 163 |
| Example 135 | A1014 | B643 | 1:1 | 2.27 | 3.13 | 89.80 | (0.683, 0.317) | 195 |
| Example 136 | A638 | B672 | 1:1 | 2.28 | 3.35 | 87.83 | (0.683, 0.317) | 159 |
| Example 137 | A1020 | B687 | 1:1 | 2.30 | 3.59 | 79.09 | (0.684, 0.316) | 151 |
| Example 138 | A624 | B711 | 1:1 | 2.29 | 3.48 | 77.58 | (0.684, 0.315) | 142 |
| Example 139 | A1014 | B747 | 1:1 | 2.30 | 3.61 | 76.73 | (0.684, 0.316) | 144 |
| Example 140 | A634 | B795 | 1:1 | 2.30 | 3.77 | 94.35 | (0.684, 0315) | 177 |
| Example 141 | A488 | B26 | 1:1 | 2.32 | 3.74 | 85.36 | (0.685, 0.315) | 151 |
| Example 142 | A641 | B168 | 1:1 | 2.29 | 3.54 | 93.71 | (0.684, 0.316) | 171 |
| Example 143 | A681 | B261 | 1:1 | 2.29 | 3.48 | 80.65 | (0.684, 0.316) | 132 |
| Example 144 | A721 | B330 | 1:1 | 2.32 | 3.70 | 82.22 | (0.685, 0.315) | 151 |
| Example 145 | A923 | B379 | 1:1 | 2.27 | 3.29 | 86.64 | (0.685, 0.315) | 148 |
| Example 146 | A511 | B490 | 1:1 | 2.28 | 3.21 | 95.05 | (0.684, 0.316) | 173 |
| Example 147 | A642 | B441 | 1:1 | 2.28 | 3.27 | 96.15 | (0.683, 0.318) | 167 |
| Example 148 | A686 | B524 | 1:1 | 2.29 | 3.50 | 80.11 | (0.685, 0.314) | 136 |
| Example 149 | A722 | B541 | 1:1 | 2.31 | 3.64 | 78.71 | (0.683, 0.318) | 138 |
| Example 150 | A952 | B571 | 1:1 | 2.29 | 3.43 | 76.66 | (0.683, 0.318) | 134 |
| Example 151 | A523 | B585 | 1:1 | 2.28 | 3.35 | 88.00 | (0.683, 0.317) | 167 |
| Example 152 | A653 | B613 | 1:1 | 2.28 | 3.46 | 81.39 | (0.685, 0.314) | 140 |
| Example 153 | A719 | B633 | 1:1 | 2.27 | 3.32 | 91.12 | (0.684, 0.316) | 165 |
| Example 154 | A734 | B644 | 1:1 | 2.29 | 3.30 | 86.19 | (0.685, 0.315) | 202 |
| Example 155 | | | 1:1.5 | 2.26 | 3.24 | 84.46 | (0.685, 0.315) | 198 |
| Example 156 | | | 1.5:1 | 2.33 | 3.37 | 87.91 | (0.683, 0.318) | 206 |
| Example 157 | | | 2:1 | 2.36 | 3.44 | 89.67 | (0.684, 0.316) | 211 |
| Example 158 | | | 3:1 | 2.30 | 3.32 | 86.53 | (0.683, 0.317) | 203 |
| Example 159 | A959 | B674 | 1:1 | 2.27 | 3.29 | 90.10 | (0.684, 0.315) | 159 |
| Example 160 | A666 | B697 | 1:1 | 2.29 | 3.50 | 75.17 | (0.683, 0.318) | 146 |
| Example 161 | A535 | B721 | 1:1 | 2.31 | 3.59 | 78.41 | (0.684, 0.316) | 148 |
| Example 162 | A660 | B751 | 1:1 | 2.29 | 3.54 | 79.71 | (0.684, 0.316) | 142 |
| Example 163 | A735 | B763 | 1:1 | 2.34 | 4.07 | 93.16 | (0.684, 0.316) | 165 |
| Example 164 | A547 | B41 | 1:1 | 2.32 | 3.74 | 88.54 | (0.684, 0315) | 151 |
| Example 165 | A557 | B175 | 1:1 | 2.30 | 3.66 | 89.32 | (0.685, 0.314) | 163 |
| Example 166 | A675 | B266 | 1:1 | 2.29 | 3.50 | 82.55 | (0.685, 0.314) | 134 |
| Example 167 | A676 | B348 | 1:1 | 2.29 | 3.50 | 84.87 | (0.684, 0.316) | 157 |
| Example 168 | A679 | B385 | 1:1 | 2.28 | 3.38 | 86.74 | (0.684, 0315) | 151 |
| Example 169 | A547 | B495 | 1:1 | 2.32 | 3.59 | 90.43 | (0.683, 0.317) | 157 |
| Example 170 | A557 | B442 | 1:1 | 2.28 | 3.29 | 93.19 | (0.683, 0.317) | 165 |
| Example 171 | A675 | B526 | 1:1 | 2.29 | 3.48 | 82.12 | (0.684, 0.316) | 140 |
| Example 172 | A676 | B543 | 1:1 | 2.29 | 3.48 | 82.68 | (0.684, 0.315) | 144 |
| Example 173 | A679 | B572 | 1:1 | 2.29 | 3.50 | 80.39 | (0.684, 0.316) | 144 |
| Example 174 | A547 | B586 | 1:1 | 2.32 | 3.69 | 84.25 | (0.684, 0315) | 161 |
| Example 175 | A557 | B614 | 1:1 | 2.30 | 3.64 | 82.54 | (0.685, 0.315) | 134 |
| Example 176 | A675 | B637 | 1:1 | 2.30 | 3.58 | 90.62 | (0.684, 0.316) | 163 |
| Example 177 | A676 | B646 | 1:1 | 2.27 | 3.10 | 90.92 | (0.684, 0.316) | 208 |
| Example 178 | | | 1:1.5 | 2.24 | 3.03 | 89.10 | (0.685, 0.315) | 204 |
| Example 179 | | | 1.5:1 | 2.30 | 3.16 | 92.74 | (0.683, 0.318) | 212 |
| Example 180 | | | 2:1 | 2.32 | 3.19 | 93.66 | (0.684, 0.316) | 215 |
| Example 181 | | | 3:1 | 2.35 | 3.25 | 95.54 | (0.683, 0.317) | 219 |
| Example 182 | A679 | B611 | 1:1 | 2.28 | 3.42 | 83.40 | (0.685, 0.315) | 142 |
| Example 183 | A547 | B703 | 1:1 | 2.32 | 3.70 | 74.83 | (0.685, 0.315) | 138 |
| Example 184 | A557 | B722 | 1:1 | 2.30 | 3.53 | 80.31 | (0.684, 0.316) | 153 |
| Example 185 | A675 | B752 | 1:1 | 2.31 | 3.74 | 75.80 | (0.683, 0.318) | 134 |
| Example 186 | A676 | B764 | 1:1 | 2.32 | 3.98 | 96.08 | (0.685, 0.314) | 171 |
| Example 187 | A991 | B445 | 1:1 | 2.28 | 3.32 | 102.39 | (0.684, 0315) | 171 |
| Example 188 | | | 1:1.5 | 2.25 | 3.25 | 100.34 | (0.685, 0.315) | 168 |
| Example 189 | | | 1.5:1 | 2.32 | 3.39 | 104.43 | (0.683, 0.318) | 174 |
| Example 190 | | | 2:1 | 2.35 | 3.45 | 106.52 | (0.684, 0.316) | 178 |
| Example 191 | | | 3:1 | 2.29 | 3.33 | 102.80 | (0.683, 0.317) | 172 |
| Example 192 | A995 | B148 | 1:1 | 2.29 | 3.50 | 102.12 | (0.683, 0.317) | 177 |
| Example 193 | | | 1:1.5 | 2.26 | 3.43 | 100.07 | (0.685, 0.315) | 173 |
| Example 194 | | | 1.5:1 | 2.33 | 3.57 | 104.16 | (0.683, 0.318) | 180 |
| Example 195 | | | 2:1 | 2.36 | 3.64 | 106.24 | (0.684, 0.316) | 184 |
| Example 196 | | | 3:1 | 2.30 | 3.51 | 102.52 | (0.683, 0.317) | 178 |
| Example 197 | A1000 | B485 | 1:1 | 2.27 | 3.18 | 101.11 | (0.683, 0.317) | 175 |
| Example 198 | | | 1:1.5 | 2.24 | 3.11 | 99.09 | (0.685, 0.315) | 171 |
| Example 199 | | | 1.5:1 | 2.30 | 3.24 | 103.14 | (0.683, 0.318) | 178 |
| Example 200 | | | 2:1 | 2.25 | 3.14 | 100.04 | (0.684, 0.316) | 173 |
| Example 201 | | | 3:1 | 2.22 | 3.08 | 98.04 | (0.683, 0.317) | 170 |
| Example 202 | A288 | B764 | 1:1 | 2.34 | 4.14 | 98.94 | (0.684, 0.316) | 167 |
| Example 203 | | | 1:1.5 | 2.30 | 4.05 | 96.96 | (0.685, 0.315) | 164 |
| Example 204 | | | 1.5:1 | 2.38 | 4.22 | 100.92 | (0.683, 0.318) | 170 |
| Example 205 | | | 2:1 | 2.42 | 4.30 | 102.94 | (0.684, 0.316) | 174 |
| Example 206 | | | 3:1 | 2.35 | 4.15 | 99.33 | (0.683, 0.317) | 168 |

As can be seen from the results of Table 8 above, it could be confirmed that when the organic material layer of an organic light emitting device is deposited by mixing two types of heterocyclic compounds according to the present application (specifically, a heterocyclic compound of Chemical Formula A and a heterocyclic compound of Chemical Formula B), the efficiency or life time effect of the organic light emitting device is improved.

Specifically, according to Comparative Examples 1 to 92, when the heterocyclic compound of Chemical Formula A was used alone, a low efficiency of about 7 cd/A and a short life time of 11 or less hours were shown, and according to Comparative Examples 101 to 192, when the heterocyclic compound of Chemical Formula B was used alone, an efficiency of about 59 cd/A and a life time of 81 or less hours were shown.

Referring to Examples 1 to 206 in which a heterocyclic compound of Chemical Formula A was used in combination with a heterocyclic compound of Chemical Formula B, it can be confirmed that charge balance was achieved, and the device exhibited high efficiency and long life time characteristics, and in particular, the life time was increased by approximately 10-fold compared to Comparative Examples 1 to 92. These results suggest that the heterocyclic compound of Chemical Formula A has fast electron supply, and when combined with the heterocyclic compound of Chemical Formula B, it also balances the hole supply, thereby balancing the charge in the device and improving the life time and efficiency.

Meanwhile, in the case of Compounds K to N in Comparative Examples 93 to 96, only an arylamine group is substituted as a mono-substituted dibenzofuran or naphthobenzofuran, and such structures have smaller electronic properties than the heterocyclic compound of Chemical Formula A of the present application, so that when the compounds are combined with the heterocyclic compound of Chemical Formula B, low efficiency and short life time are observed as in Comparative Examples 201 to 219, suggesting that device characteristics deteriorate due to charge imbalance.

In the case of Compounds 0 to R in Comparative Examples 97 to 100, only an aryl group or a heteroaryl group is substituted as a mono-substituted naphthobenzofuran, and such a structure has weaker hole characteristics than the heterocyclic compound of Chemical Formula A, so that when the compounds are combined with the heterocyclic compound of Chemical Formula B, low efficiency and short life time are exhibited as in Comparative Examples 220 to 238, suggesting that device characteristics deteriorate due to charge imbalance.

Further, in the case of Compounds S to V in Comparative Examples 193 to 196, only triazine is substituted as mono-substituted dibenzofuran or naphthobenzofuran, and such structures have very high electron transport properties compared to the heterocyclic compound of Chemical Formula B, so that when the compounds are combined with the compound of Chemical Formula A, low efficiency and short life time are exhibited as in Comparative Examples 239 to 254, suggesting that device characteristics deteriorate due to charge imbalance because the electron mobility is too high compared to the hole mobility.

In addition, in the case of Compounds W to Z in Comparative Examples 197 to 200, only an aryl group or a heteroaryl group is substituted as a mono-substituted dibenzofuran or naphthobenzofuran, and such structures have remarkably lower electron transport properties than the heterocyclic compound of Chemical Formula B, so that when the compounds are combined with the heterocyclic compound of Chemical Formula A, low efficiency and short life time are exhibited as in Comparative Examples 255 to 269, suggesting that device characteristics deteriorate due to charge imbalance because the electron mobility is too low compared to the hole mobility.

Furthermore, since Compound B has high electronic properties, when the proportion of the heterocyclic compound of Chemical Formula B is higher than that of the heterocyclic compound of Chemical Formula A, the charge balance is further improved, so that the efficiency and life time characteristics may be further improved. As a result of the experiment, it can be confirmed that excellent efficiency and life time were obtained when the molar ratio of the heterocyclic compound of Chemical Formula A to the heterocyclic compound of Chemical Formula B was 3:1, 2:1, or 1.5:1.

The present invention is not limited to the Examples, but may be prepared in various forms, and a person with ordinary skill in the art to which the present invention pertains will understand that the present invention can be implemented in another specific form without changing the technical spirit or essential feature of the present invention. Therefore, it should be understood that the above-described Examples are illustrative only in all aspects and are not restrictive.

### [Explanation of Reference Numerals and Symbols]

- 100:: Substrate
- 200:: Positive electrode
- 300:: Organic material layer
- 301:: Hole injection layer
- 302:: Hole Transport layer
- 303:: Electron blocking layer
- 304:: Light Emitting Layer
- 305:: Electron transport layer
- 306:: Electron injection layer
- 400:: Negative electrode

## Claims

1. A composition for an organic material layer of an organic light emitting device, the composition comprising a heterocyclic compound represented by the following Chemical Formula A and a heterocyclic compound represented by the following Chemical Formula B: 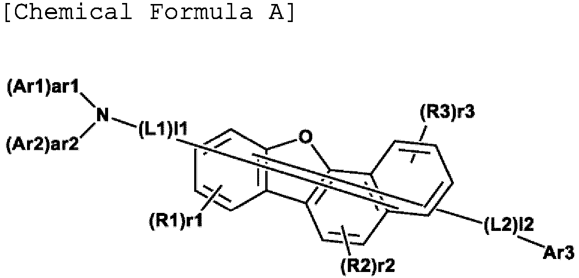 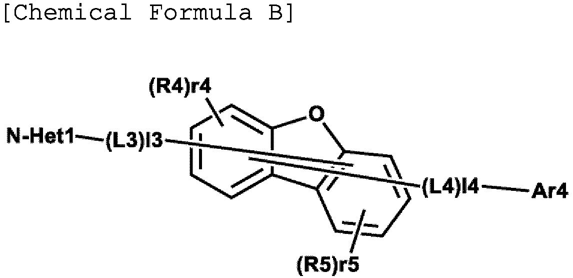 wherein, in Chemical Formulae A and B,
L1 to L4 are the same as or different from each other, and are each independently a direct bond; a substituted or unsubstituted C6 to C60 arylene group; or a substituted or unsubstituted C2 to C60 heteroarylene group,
Ar1, Ar2, and Ar4 are the same as or different from each other, and are each independently a substituted or unsubstituted C6 to C60 aryl group; or a substituted or unsubstituted C2 to C60 heteroaryl group,
R1 to R4 are the same as or different from each other, and are each independently hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R5 is hydrogen; deuterium; a halogen group; a cyano group; a substituted or unsubstituted C1 to C60 alkyl group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group, or two or more adjacent R5's are bonded to each other to form a ring,
11 to 14 are the same as or different from each other, and are each independently an integer from 1 to 3, and when each of 11 to l4 is an integer of 2 or higher, substituents in the parenthesis are the same as or different from each other,
r1 and r4 are the same as or different from each other, and are each independently an integer from 0 to 3,
r2 is an integer from 0 to 2,
r3 and r5 are the same as or different from each other, and are each independently an integer from 0 to 4,
when each of r1 to r5 is an integer of 2 or higher, substituents in the parenthesis are the same as or different from each other,
ar1 and ar2 are the same as or different from each other, and are each independently an integer from 1 to 4, and when each of ar1 and ar2 is an integer of 2 or higher, substituents in the parenthesis are the same as or different from each other,
Ar3 is represented by the following Chemical Formula K, 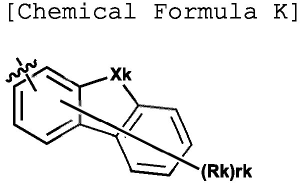 in Chemical Formula K, 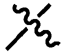
means a moiety linked to L2,
Xk is O; S; CRk1Rk2; or NRk3,
Rk and Rk1 to Rk3 are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group,
rk is an integer from 0 to 7,
N-Het1 is represented by the following Structural Formula N, 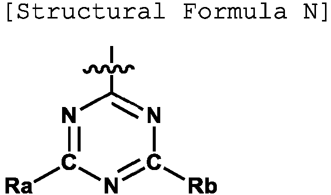 in Structural Formula N, 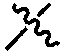
means a moiety linked to L3, and
Ra and Rb are the same as or different from each other, and are each independently a substituted or unsubstituted C6 to C60 aryl group; a substituted or unsubstituted C2 to C60 heteroaryl group; or a combination thereof,

2. The composition of claim 1, wherein Chemical Formula A is represented by any one of the following Chemical Formulae A-1 to A-3: 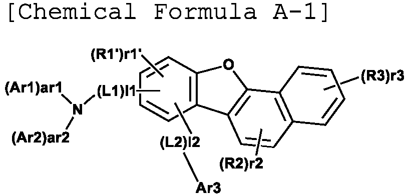 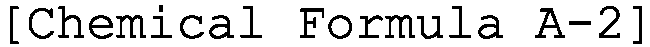 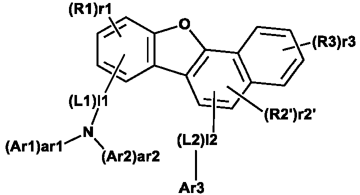 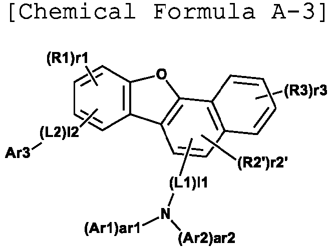 in Chemical Formulae A-1 to A-3,
each of Ar1 to Ar3, L1, L2, R1 to R3, ar1, ar2, 11, 12, and r1 to r3 is as defined in Chemical Formula A,
R1' is as defined for R1 in Chemical Formula A,
R2' is as defined for R2 in Chemical Formula A,
r1' is an integer from 0 to 2, and when r1' is 2, R1"s are the same as or different from each other, and
r2' is 0 or 1.

3. The composition of claim 1, wherein Chemical Formula B is represented by any one of the following Chemical Formulae B-1 to B-11: 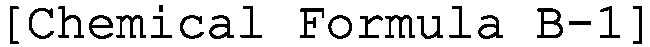 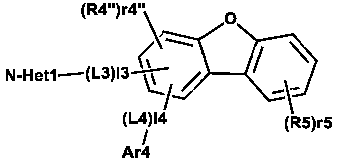 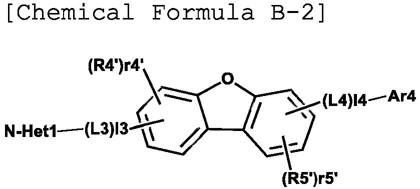 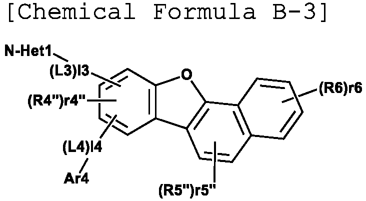 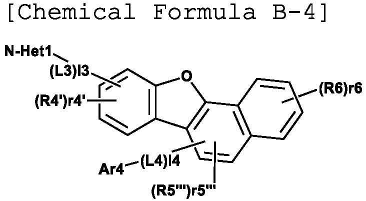 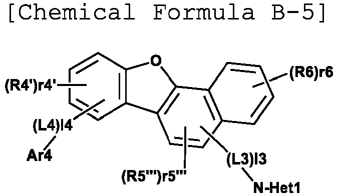 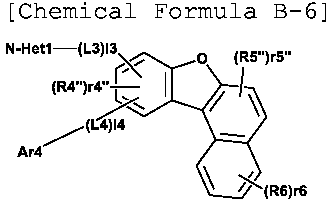 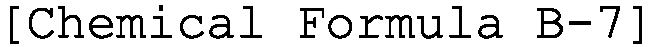 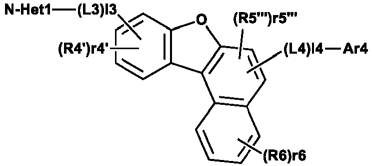 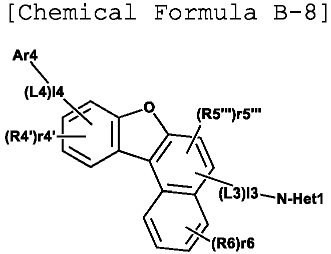 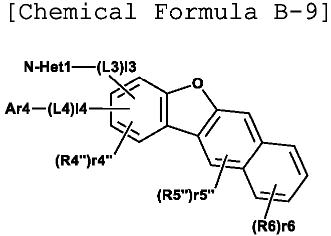 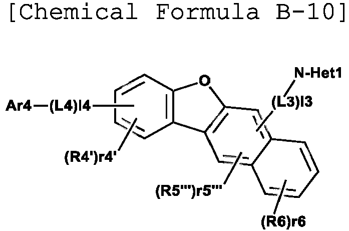 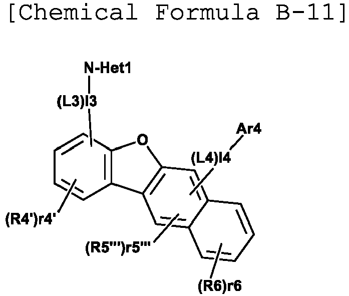 in Chemical Formulae B-1 to B-11,
each of N-Het1, Ar4, L3, L4, R5, 13, 14, and r5 is as defined in Chemical Formula B,
each of R4' and R4" is as defined for R4 in Chemical Formula B,
each of R5', R5", and R5"' is as defined for R5 in Chemical Formula B,
R6's are the same as or different from each other, and are each independently hydrogen; deuterium; a halogen group; a cyano group; a substituted or unsubstituted C1 to C60 alkyl group; a substituted or unsubstituted C3 to C60 cycloalkyl group; or a substituted or unsubstituted C2 to C60 heterocycloalkyl group,
r4' and r5' are the same as or different from each other, and are each independently an integer from 0 to 3,
r4" and r5" are the same as or different from each other, and are each independently an integer from 0 to 2,
r5"' is 0 or 1,
r6 is an integer from 0 to 4, and
when each of r4', r4", r5', r5", and r6 is 2 or an integer of 2 or higher, substituents in the parenthesis are the same as or different from each other.

4. The composition of claim 1, wherein Chemical Formula A is represented by any one of the following Chemical Formulae A-101 to A-104: 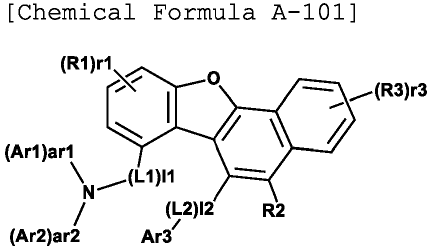 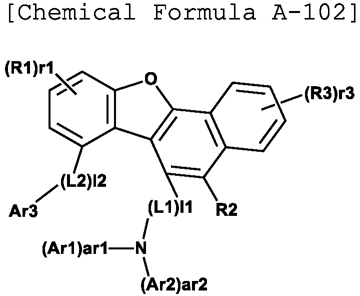 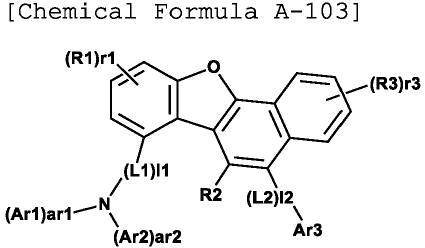 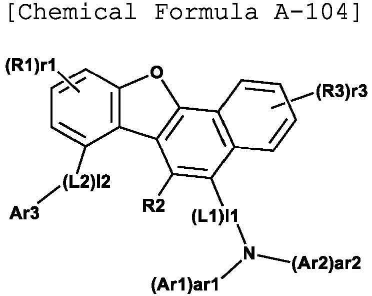 in Chemical Formulae A-101 to A-104,
each of L1, L2, Ar1 to Ar3, R1 to R3, 11, 12, ar1, ar2, r1, and r3 is as defined in Chemical Formula A.

5. The composition of claim 1, wherein Chemical Formula B is represented by any one of the following Chemical Formulae B-101 to B-132: 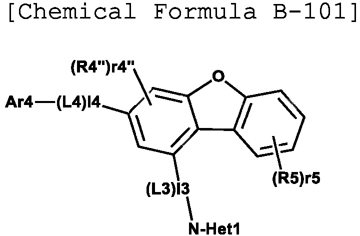 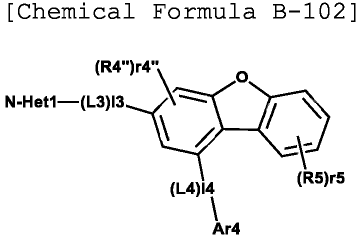 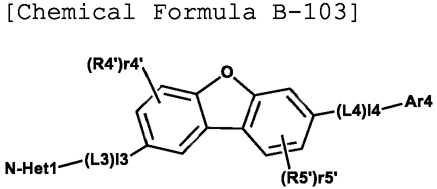 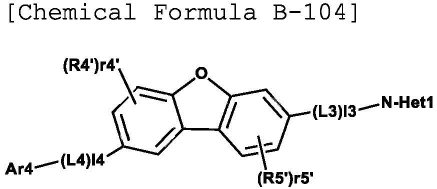 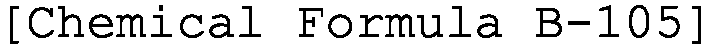 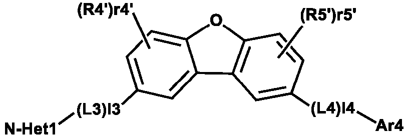 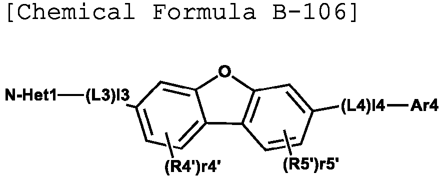 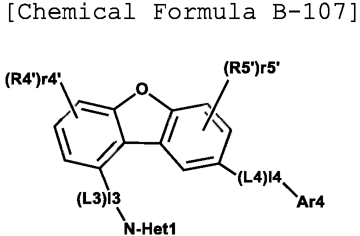 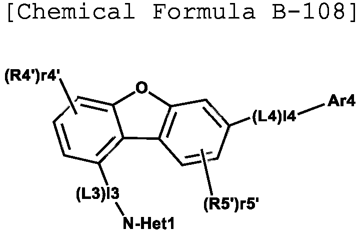 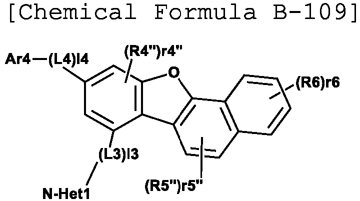 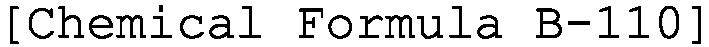 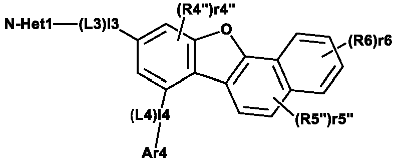 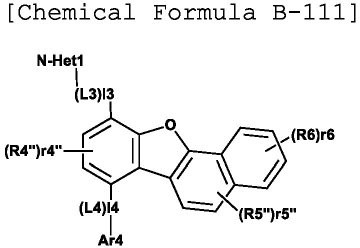 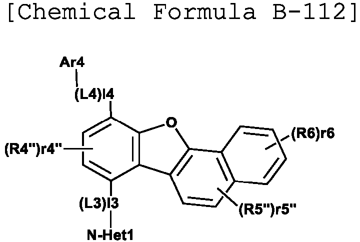 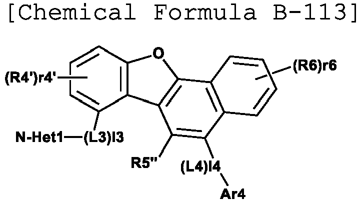 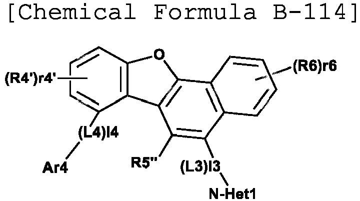 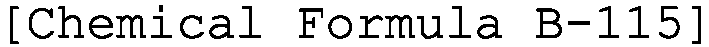 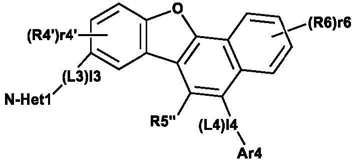 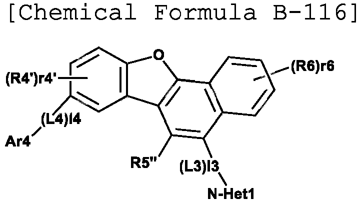 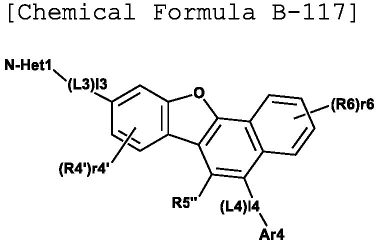 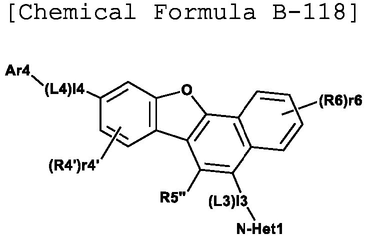 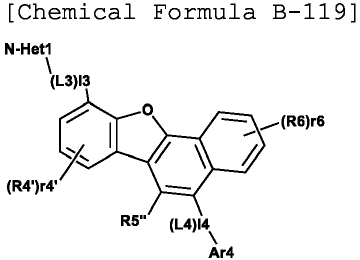 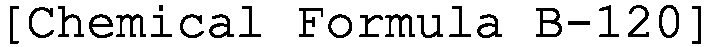 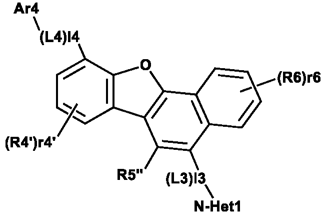 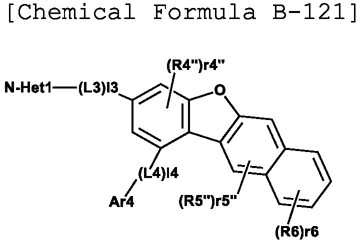 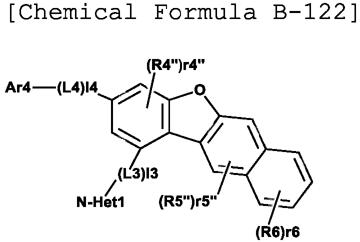 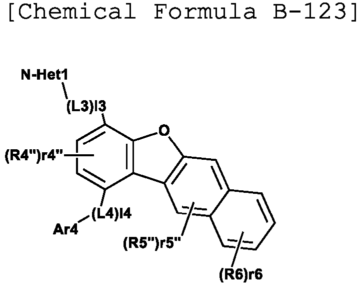 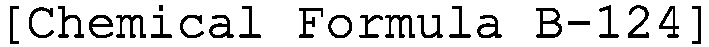 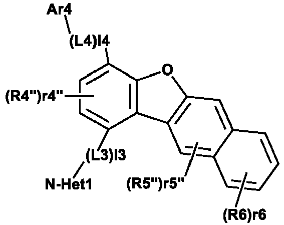 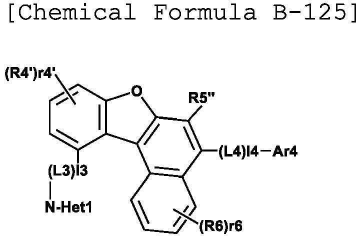 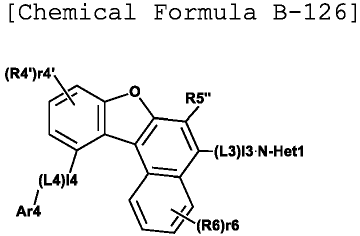 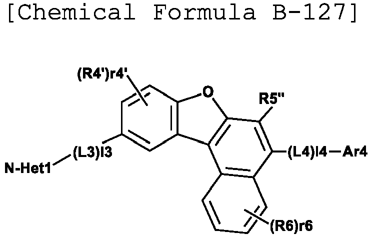 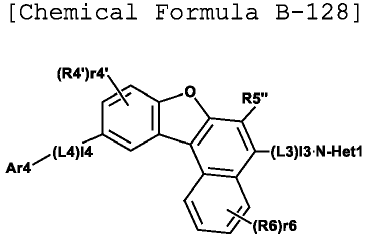 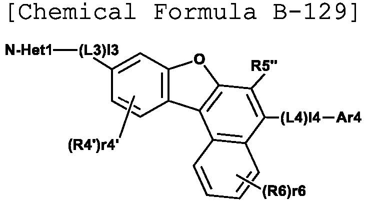 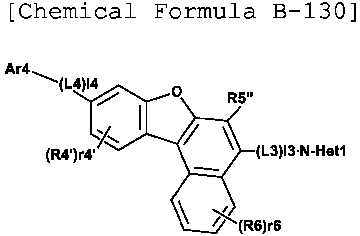 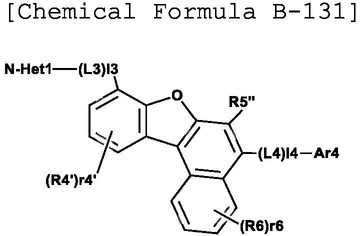 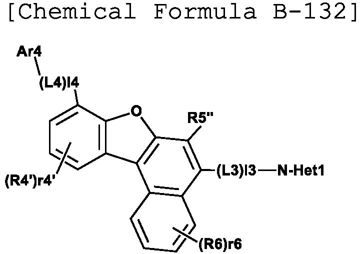 in Chemical Formulae B-101 to B-132,
each of N-Het1, Ar4, L3, L4, R5, 13, 14, and r5 is as defined in Chemical Formula B,
each of R4' and R4" is as defined for R4 in Chemical Formula B,
each of R5', R5", and R5"' is as defined for R5 in Chemical Formula B,
R6's are the same as or different from each other, and are each independently hydrogen; deuterium; a halogen group; a cyano group; a substituted or unsubstituted C1 to C60 alkyl group; a substituted or unsubstituted C3 to C60 cycloalkyl group; or a substituted or unsubstituted C2 to C60 heterocycloalkyl group,
r4' and r5' are the same as or different from each other, and are each independently an integer from 0 to 3,
r4" and r5" are the same as or different from each other, and are each independently an integer from 0 to 2,
r5"' is 0 or 1,
r6 is an integer from 0 to 4, and
when each of r4', r4", r5', r5", and r6 is 2 or an integer of 2 or higher, substituents in the parenthesis are the same as or different from each other.

6. The composition of claim 1, wherein Ar1, Ar2, and Ar4 are the same as or different from each other, and are each independently a substituted or unsubstituted C6 to C30 aryl group; or a substituted or unsubstituted C2 to C30 heteroaryl group.

7. The composition of claim 1, wherein R1 to R4 are the same as or different from each other, and are each independently hydrogen; or deuterium, and
R5 is hydrogen; or deuterium, or two or more adjacent R5's are bonded to each other to form a benzene ring unsubstituted or substituted with deuterium.

8. The composition of claim 1, wherein Rk and Rk1 to Rk3 are the same as or different from each other, and are each independently hydrogen; deuterium; a substituted or unsubstituted C1 to C30 alkyl group; a substituted or unsubstituted C6 to C30 aryl group; or a substituted or unsubstituted C2 to C30 heteroaryl group.

9. The composition of claim 1, wherein the deuterium contents of the heterocyclic compound represented by Chemical Formula A and the heterocyclic compound represented by Chemical Formula B are the same as or different from each other, and are each independently 0% or 1% to 100%.

10. The composition of claim 1, wherein Chemical Formula A is represented by any one of the following heterocyclic compounds:

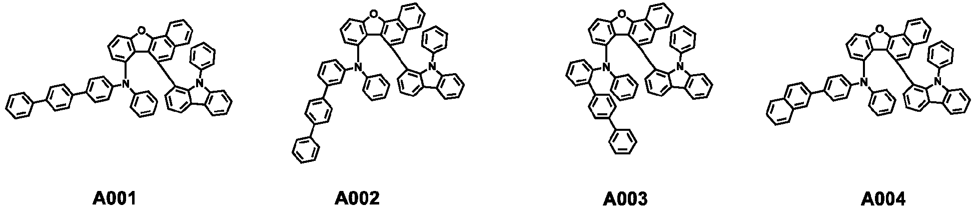

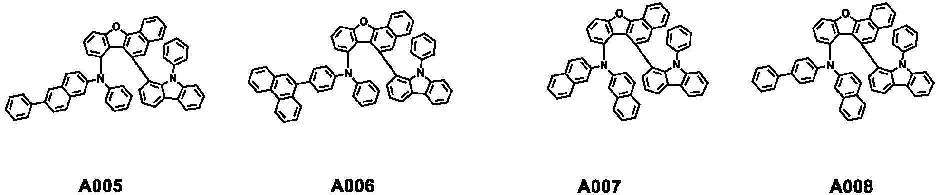

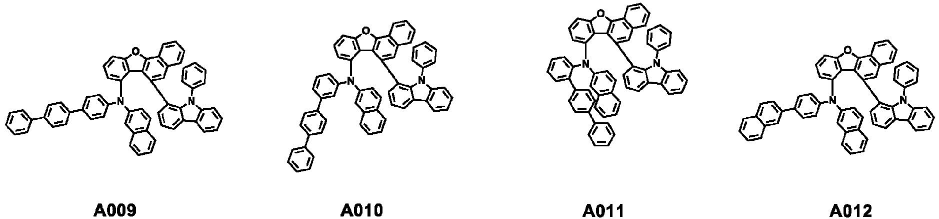

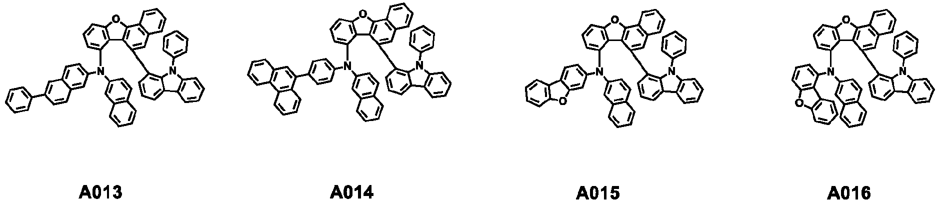

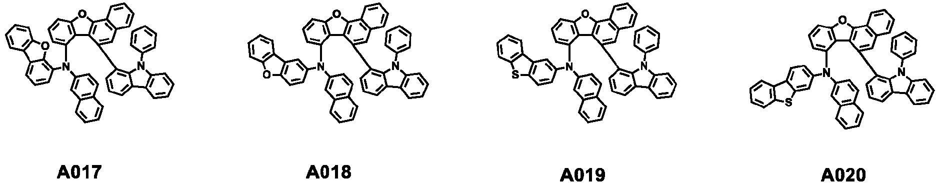

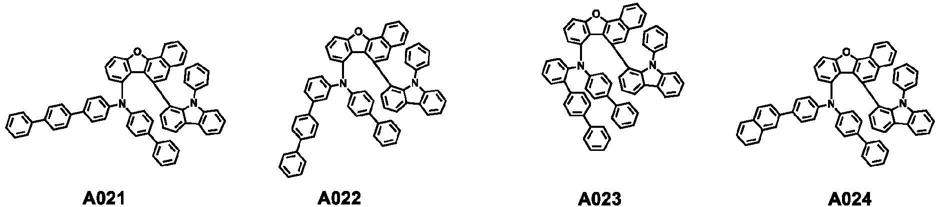

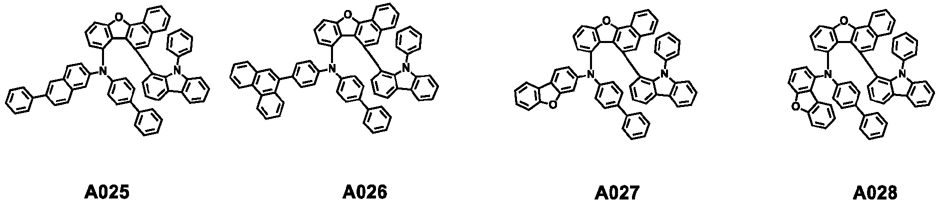

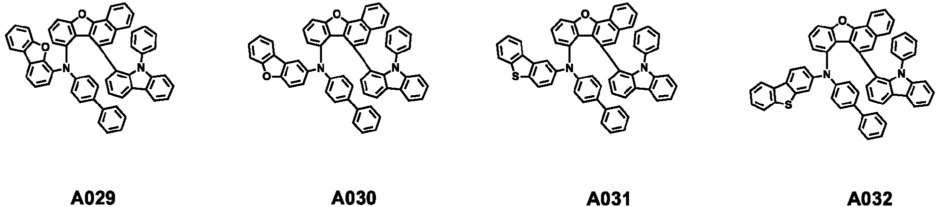

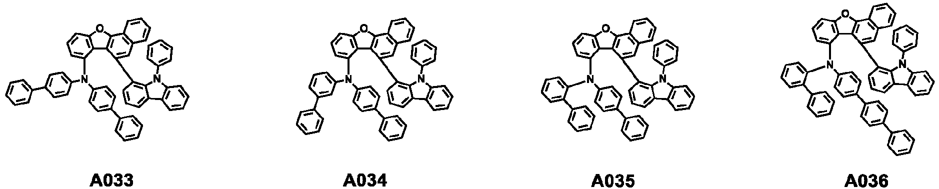

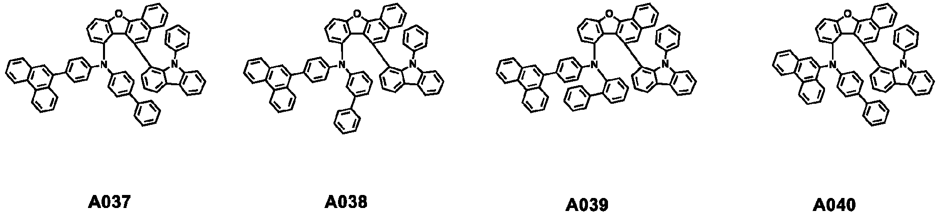

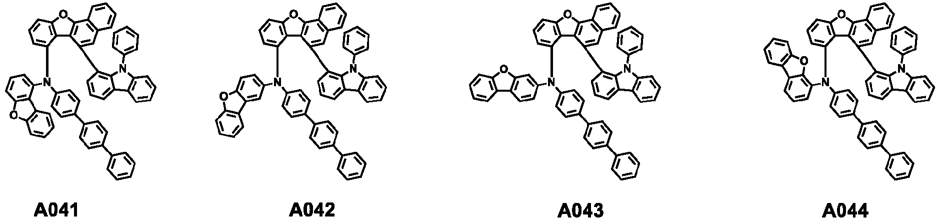

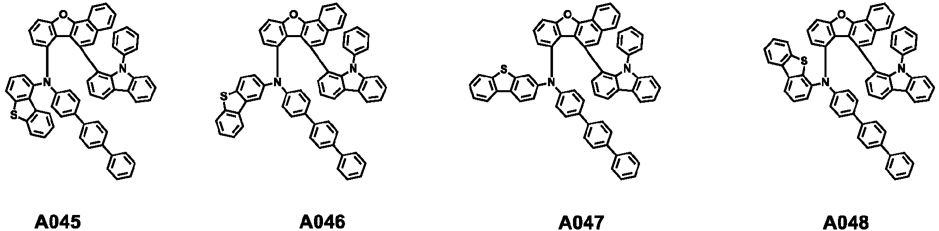

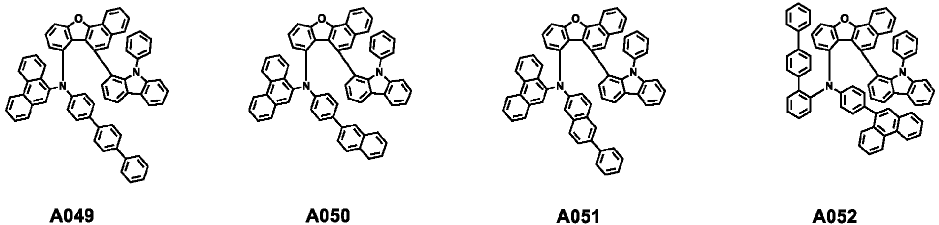

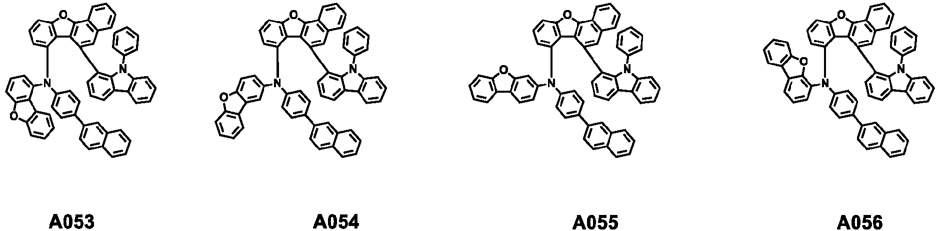

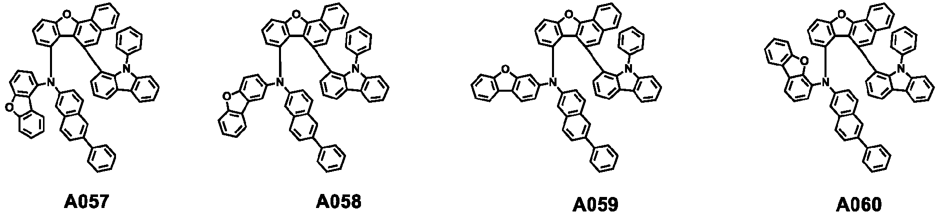

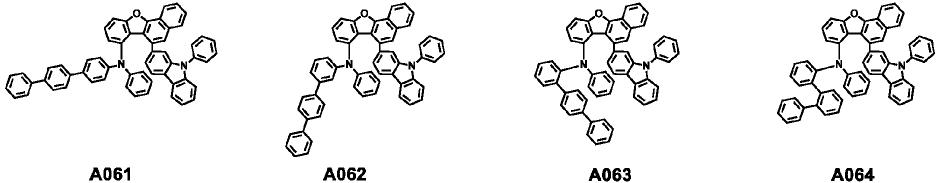

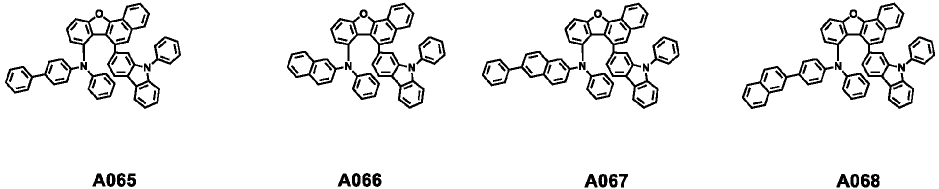

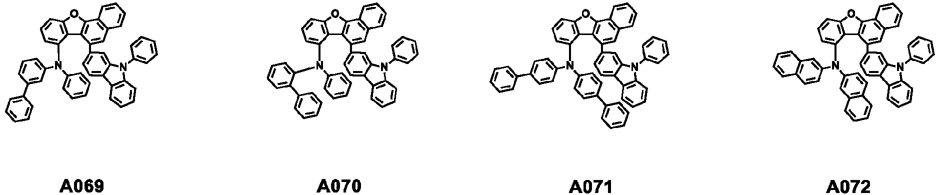

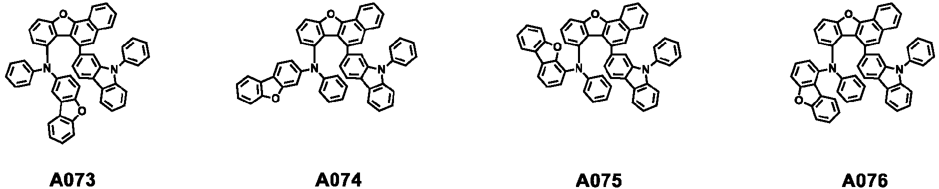

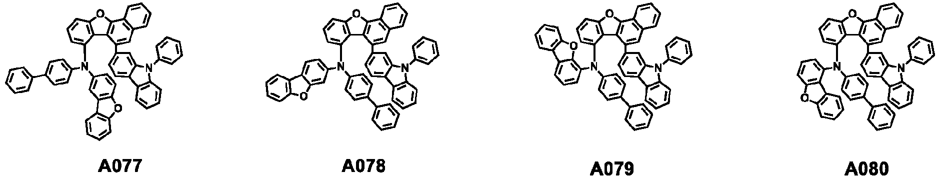

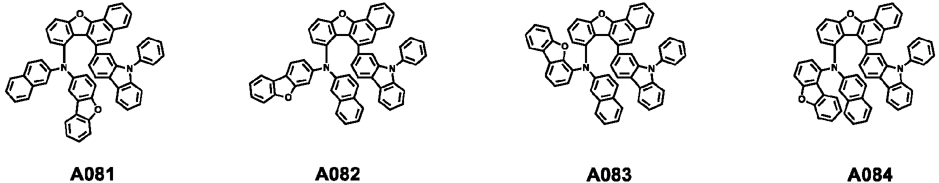

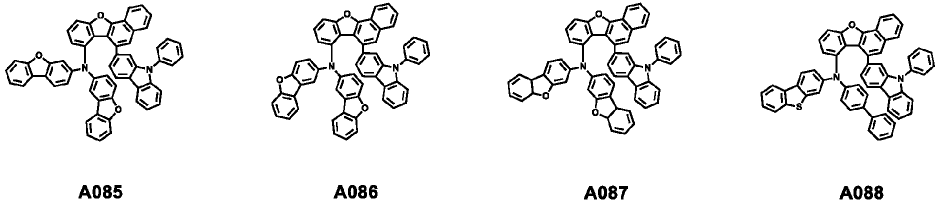

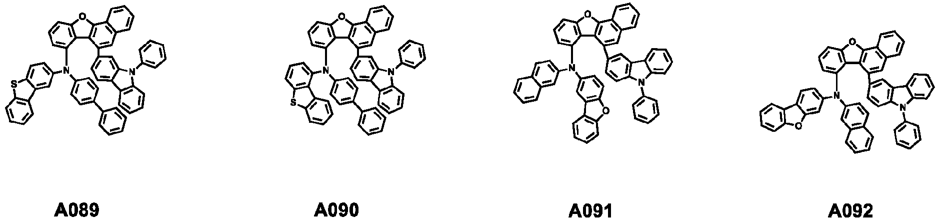

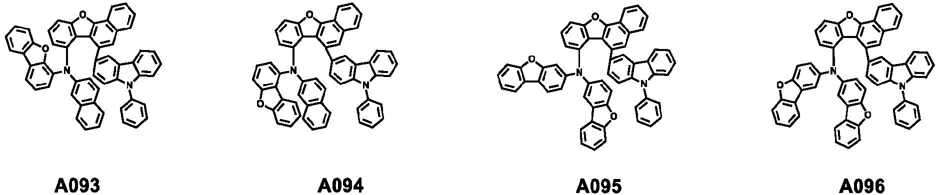

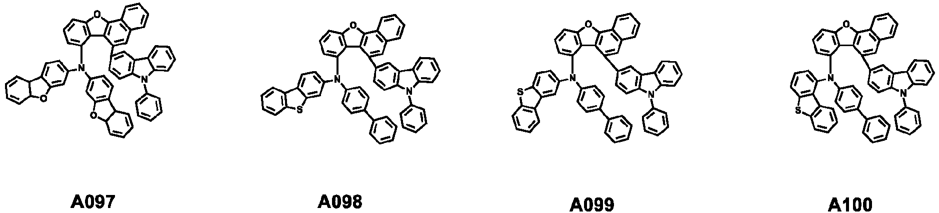

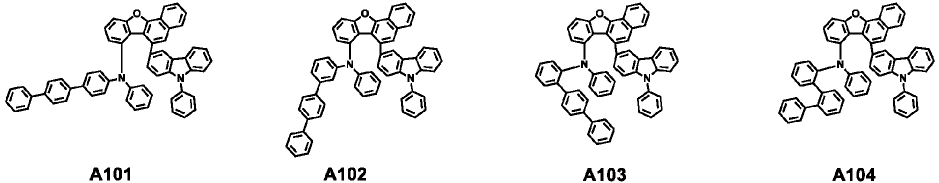

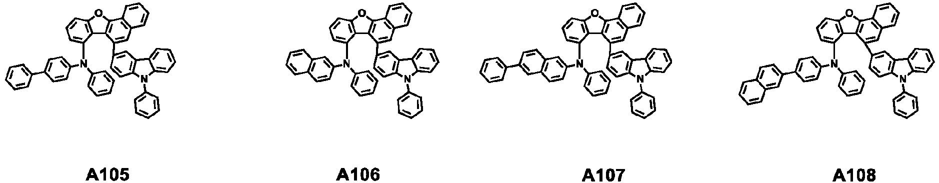

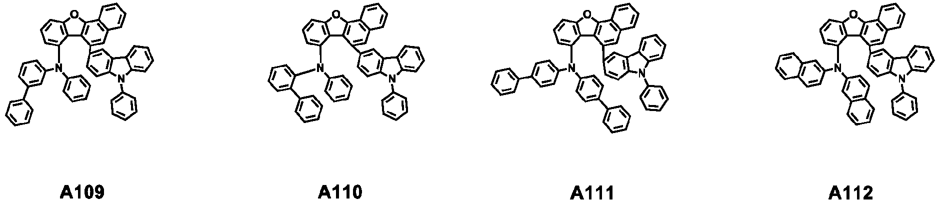

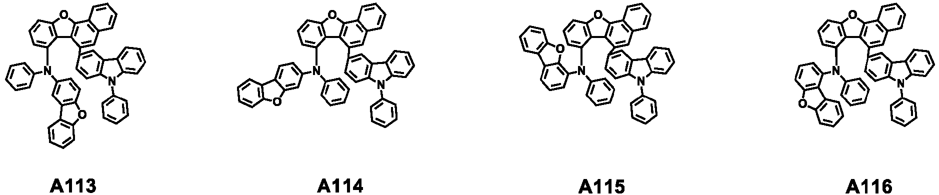

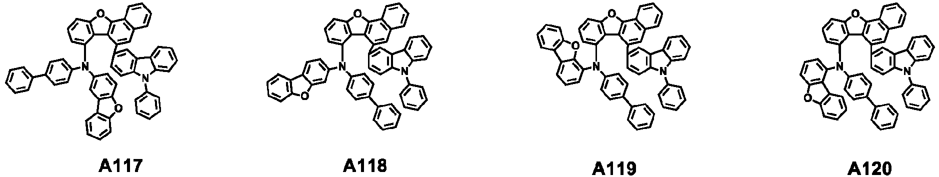

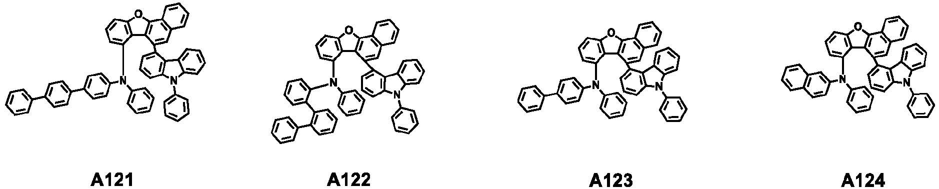

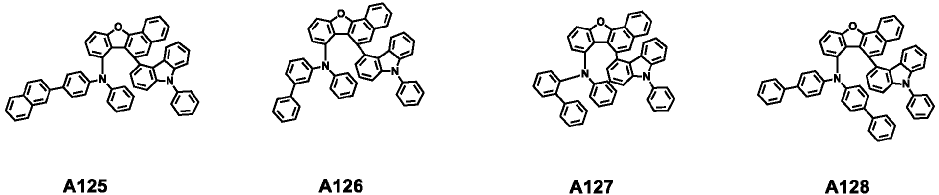

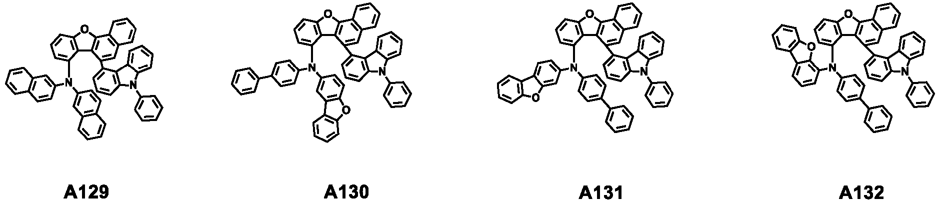

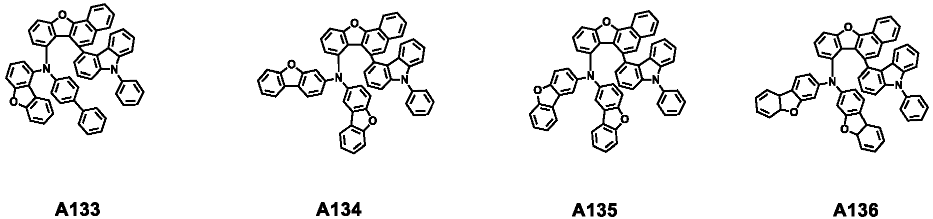

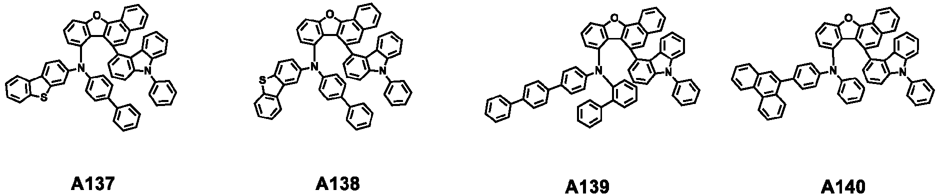

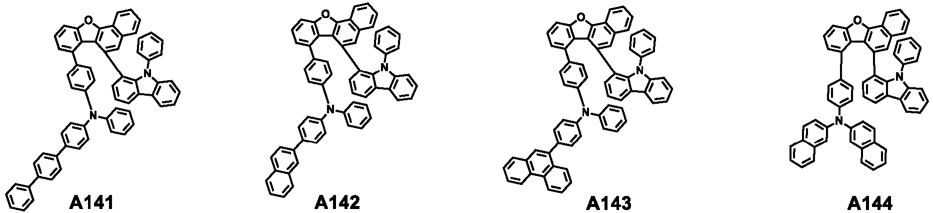

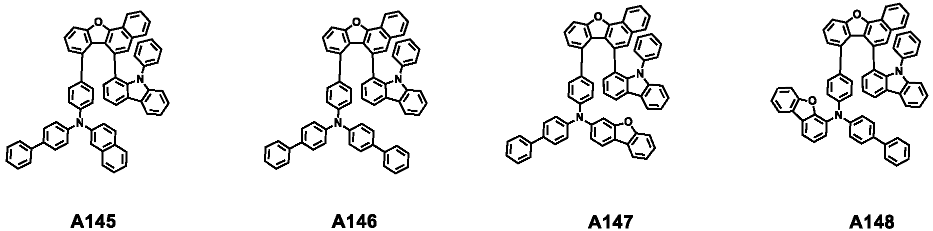

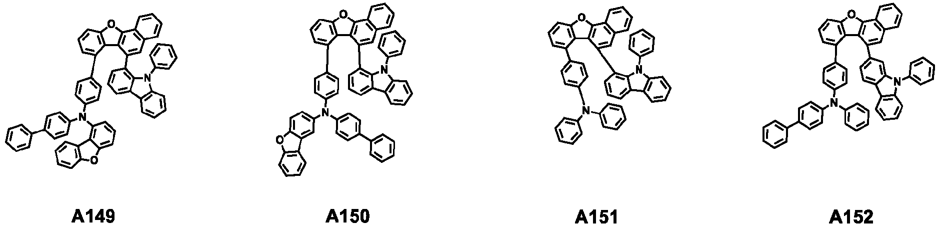

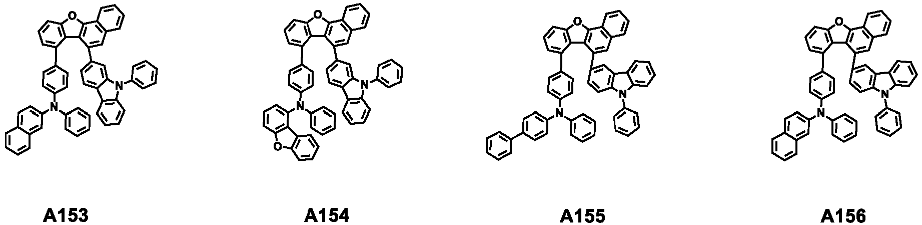

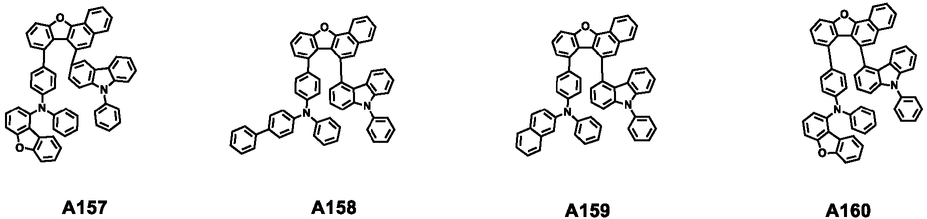

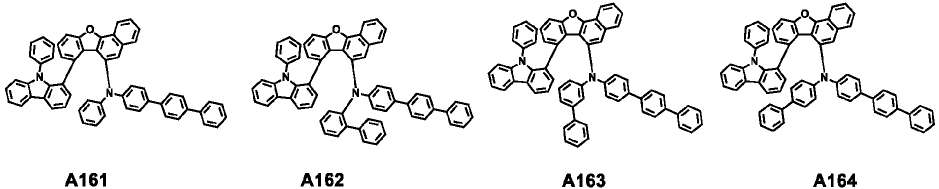

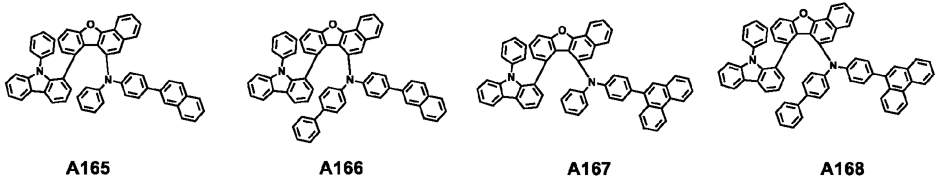

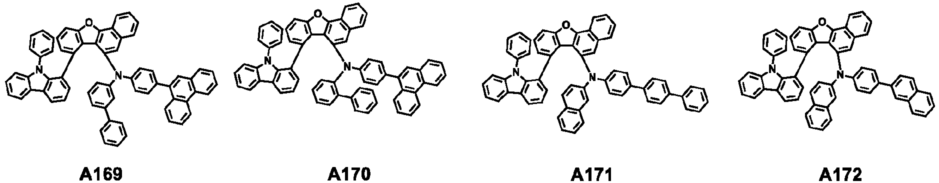

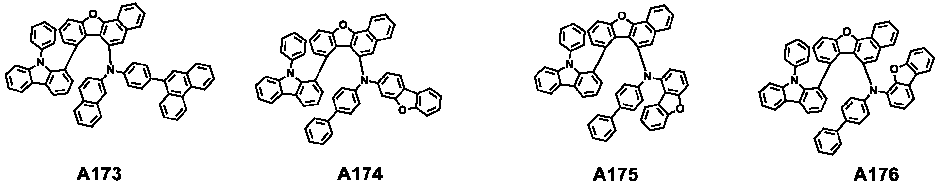

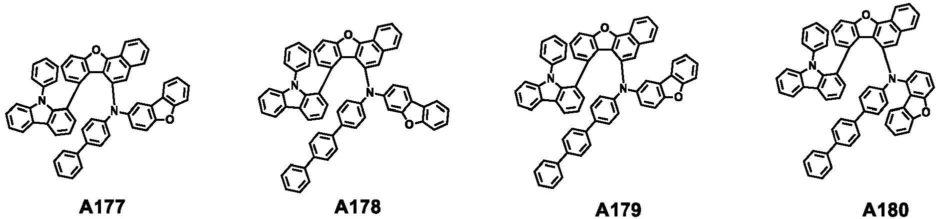

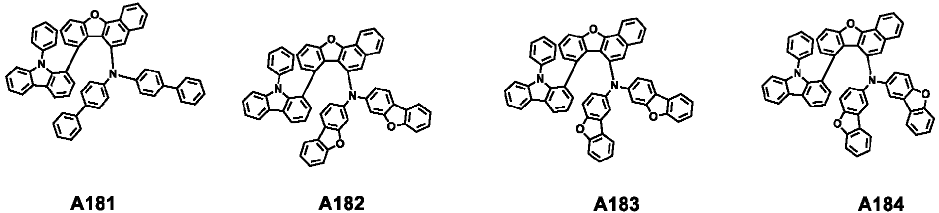

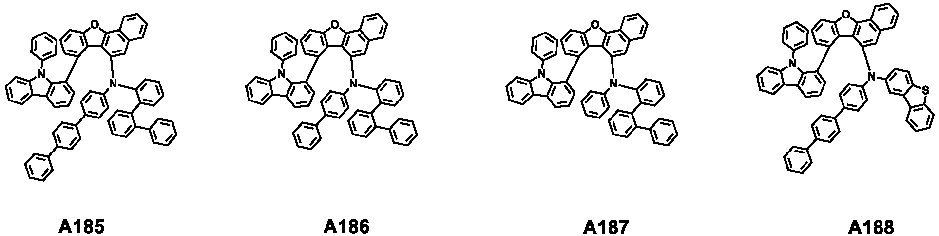

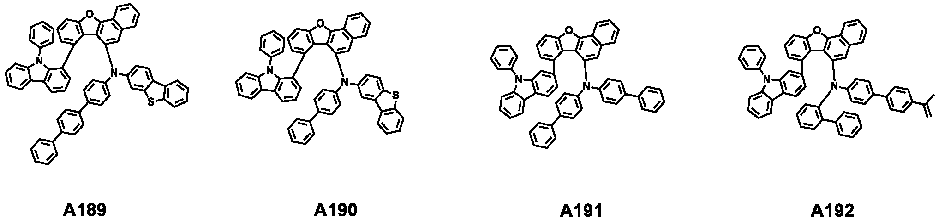

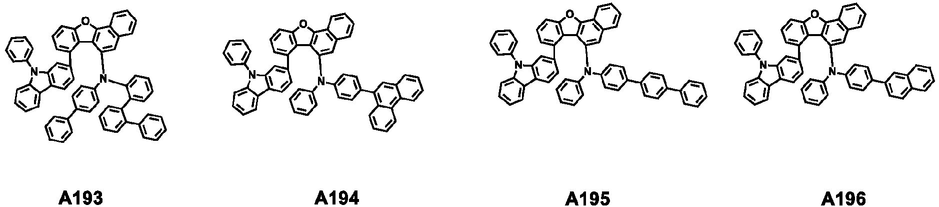

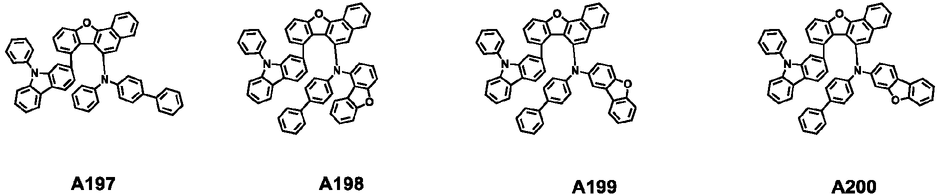

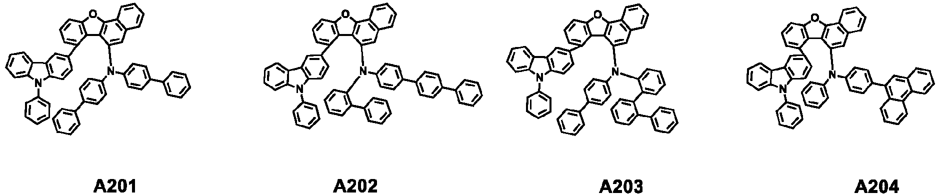

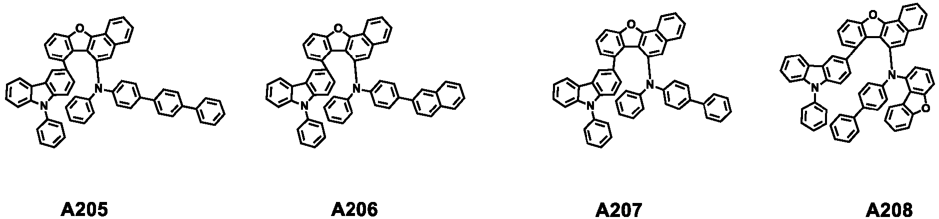

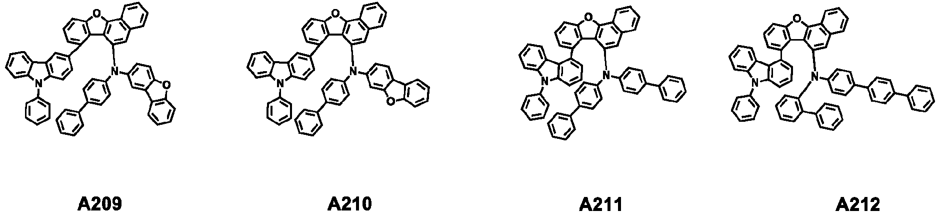

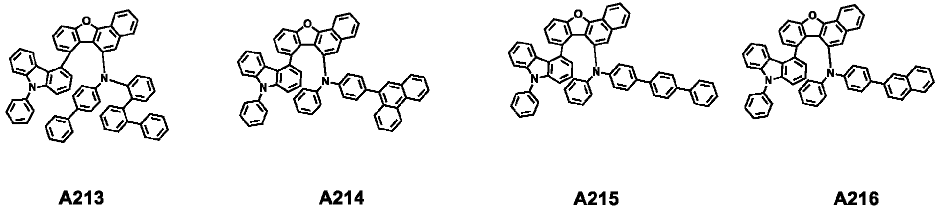

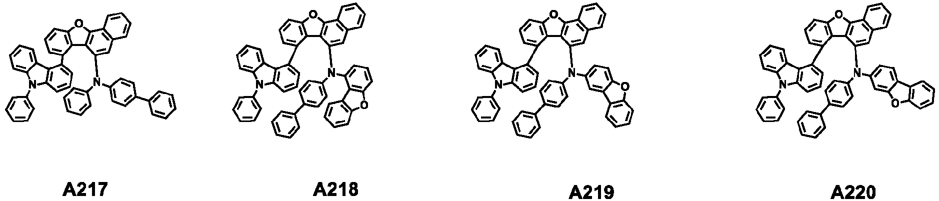

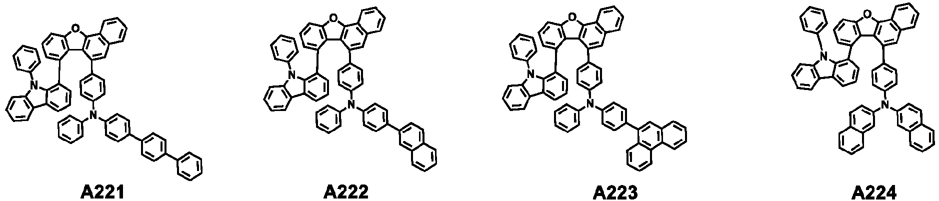

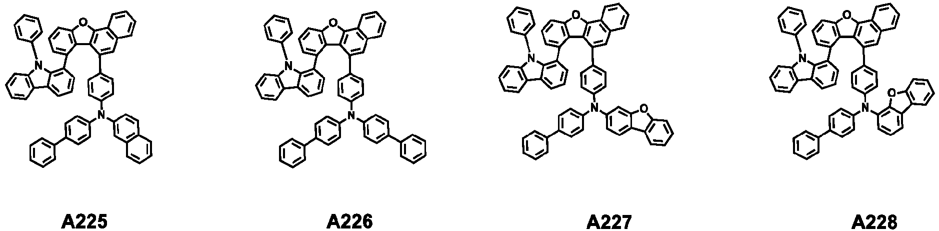

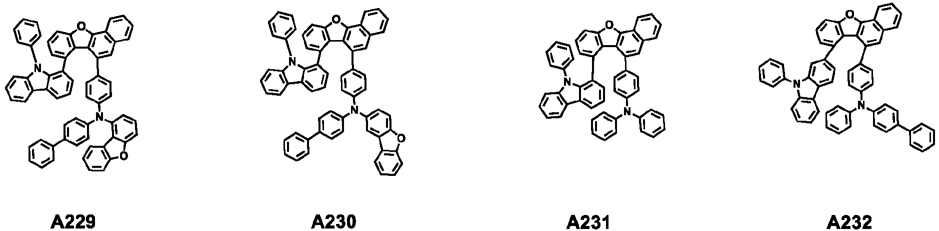

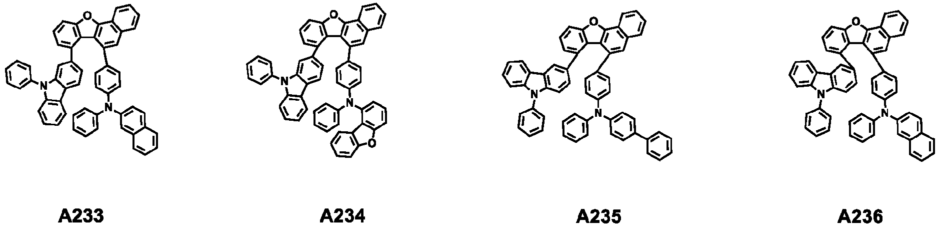

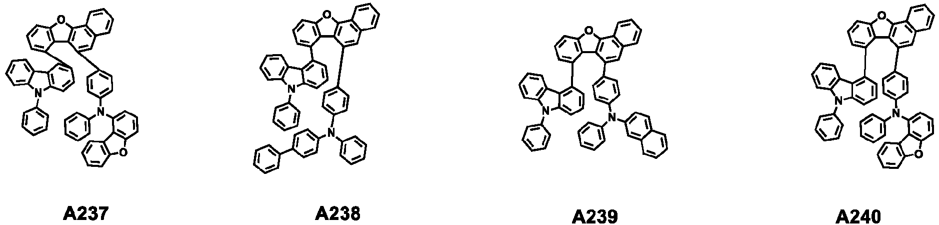

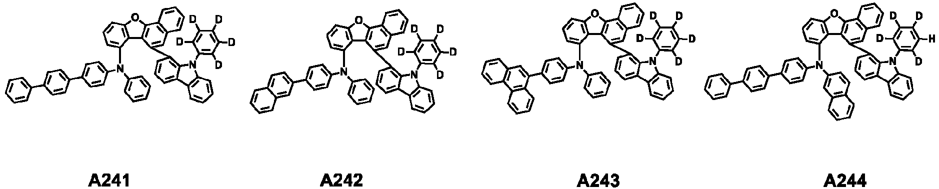

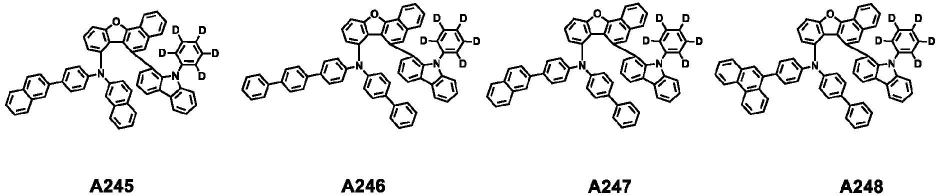

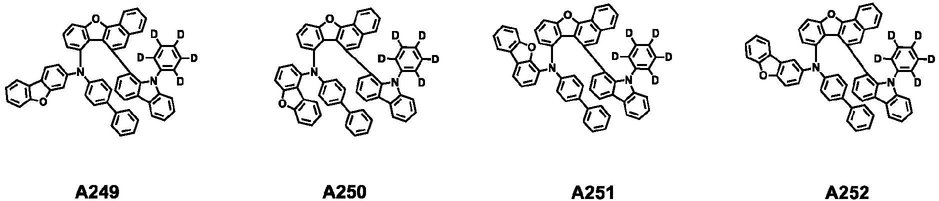

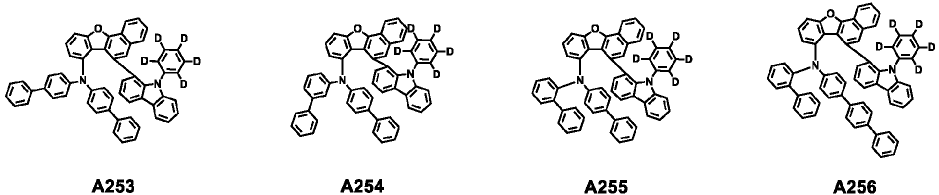

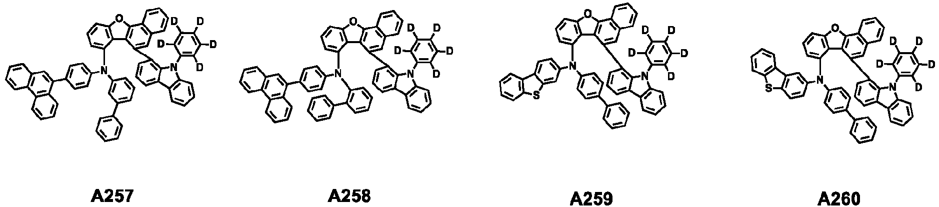

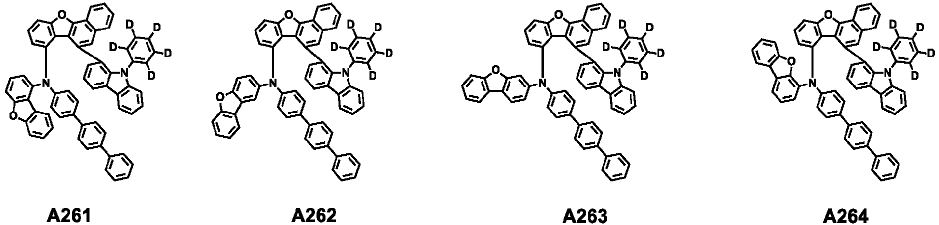

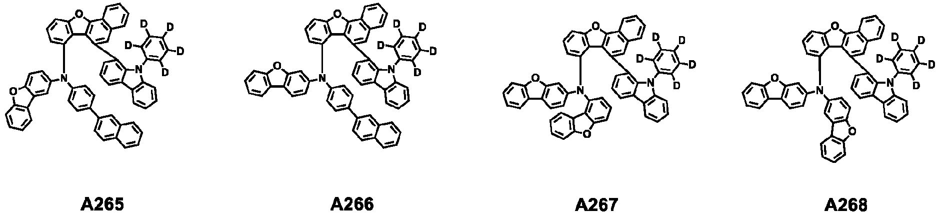

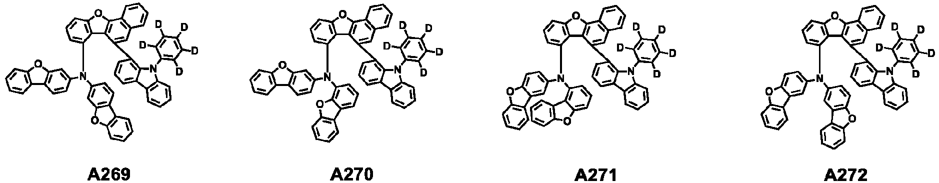

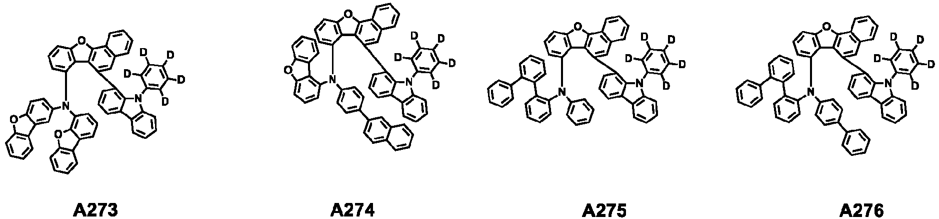

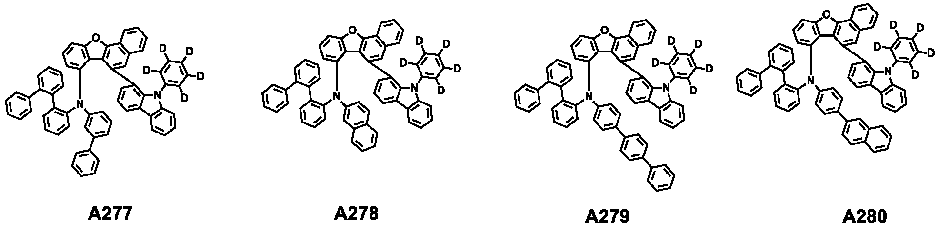

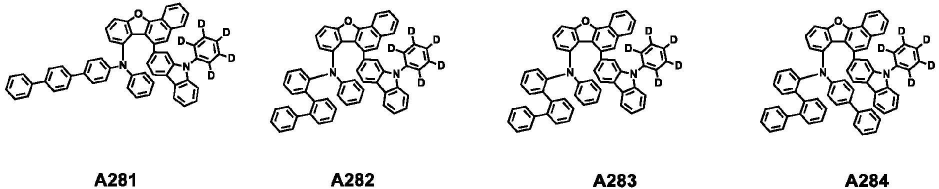

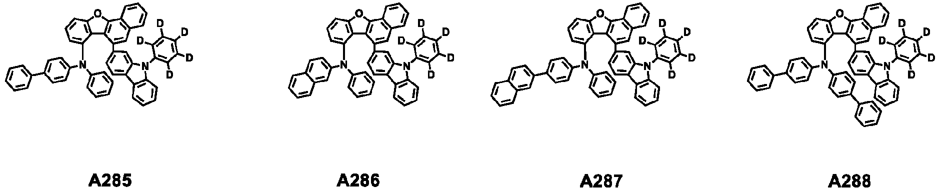

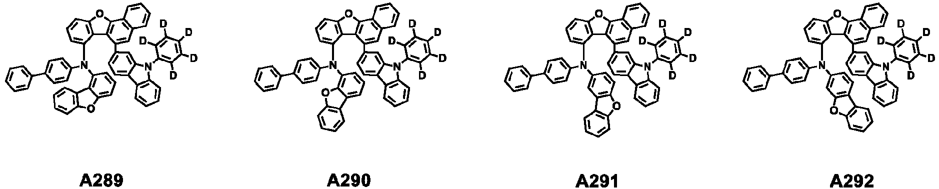

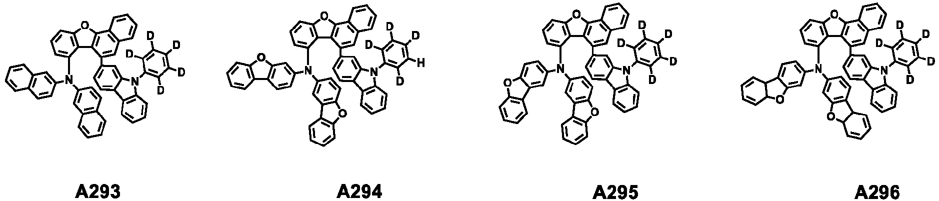

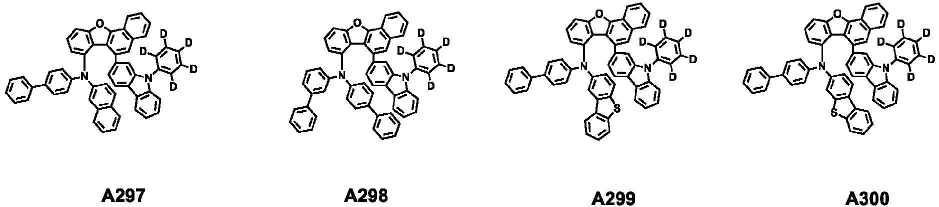

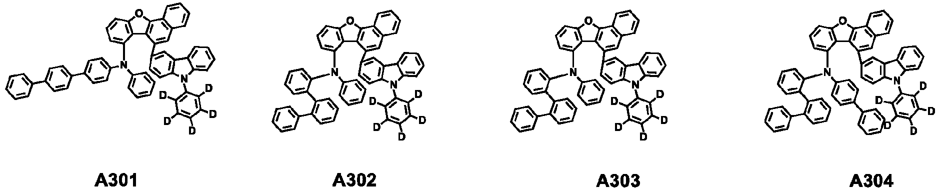

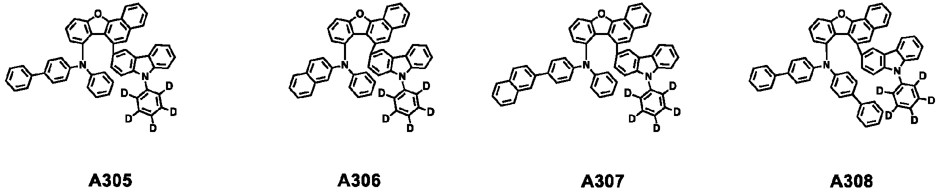

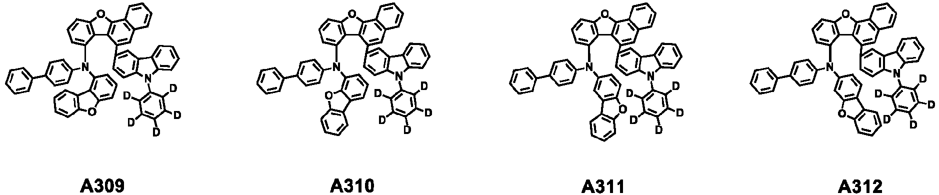

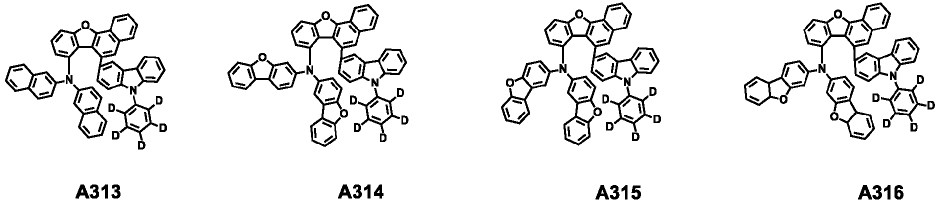

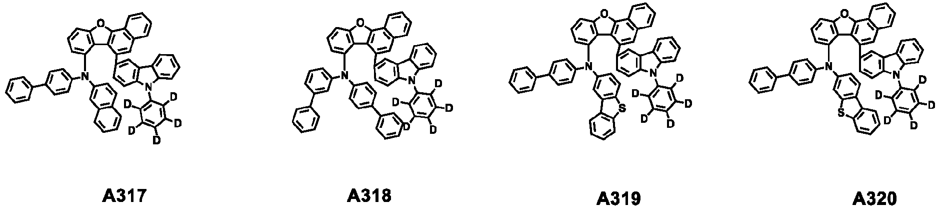

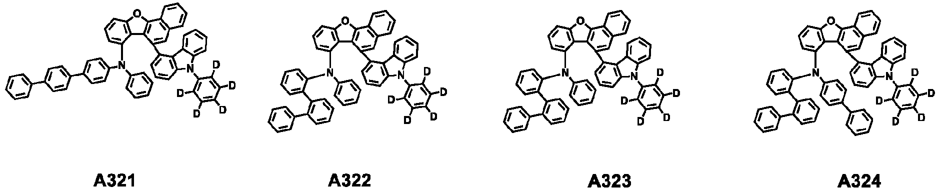

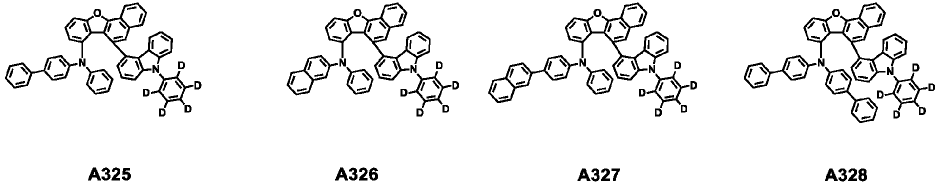

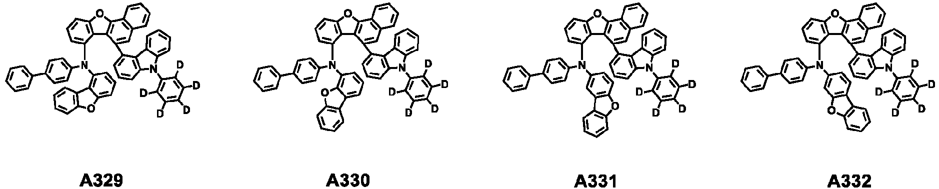

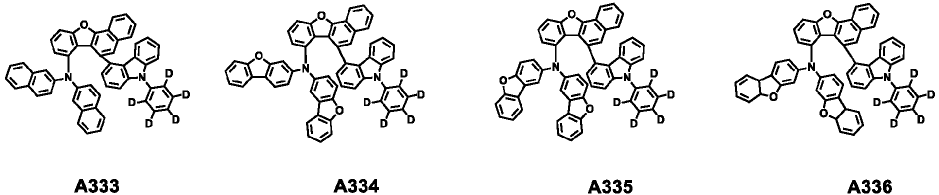

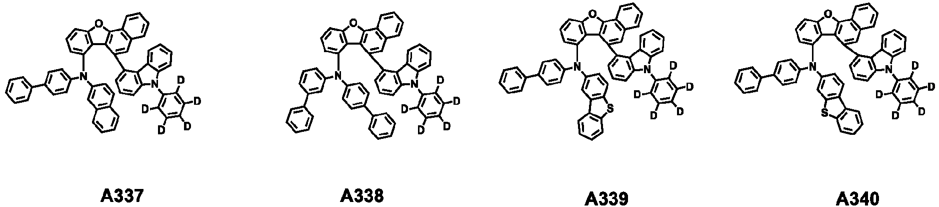

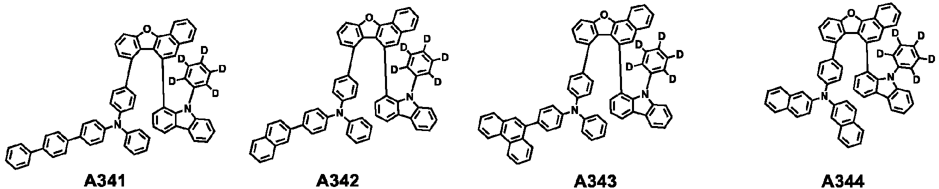

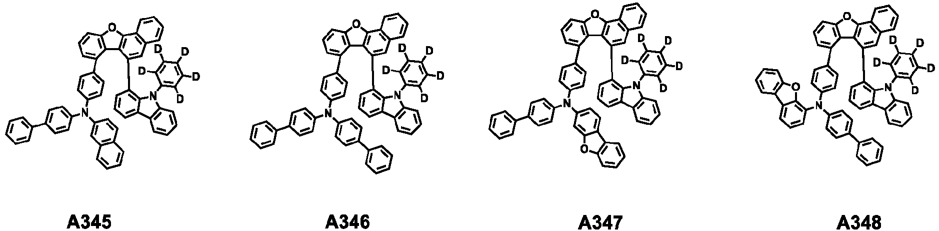

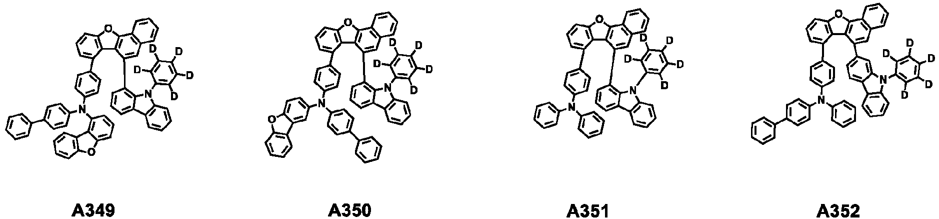

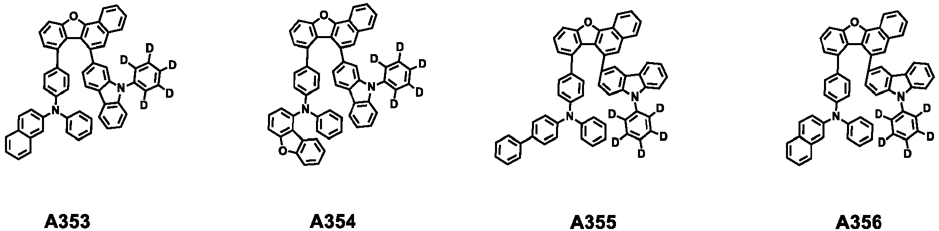

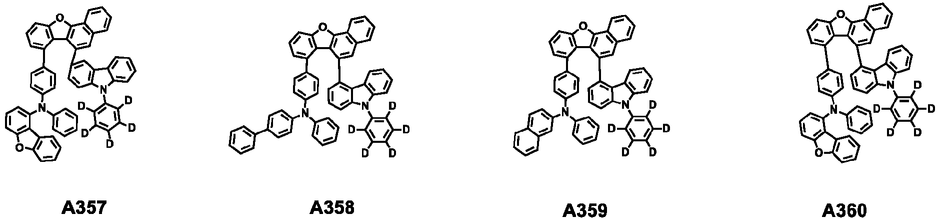

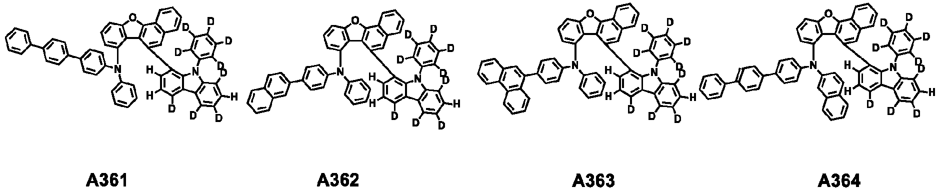

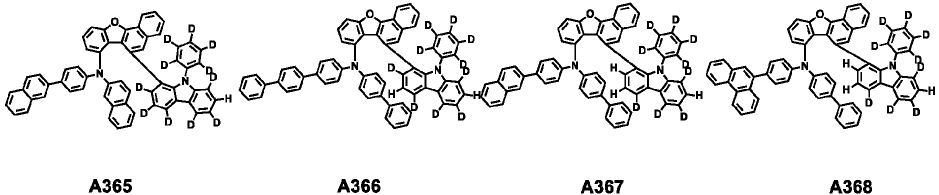

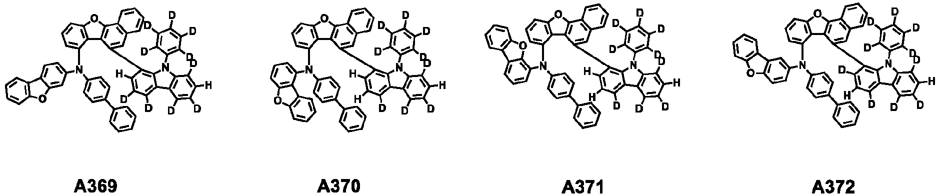

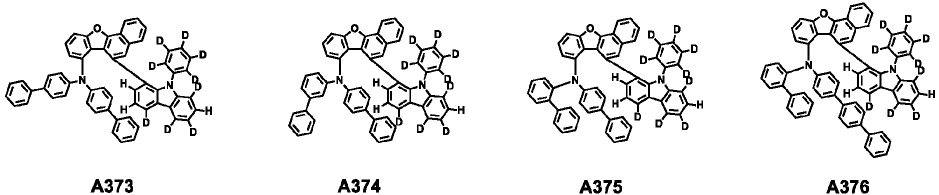

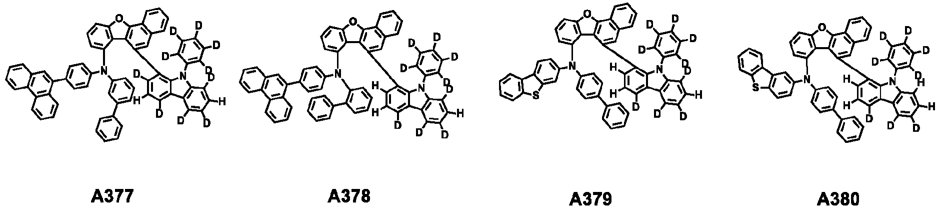

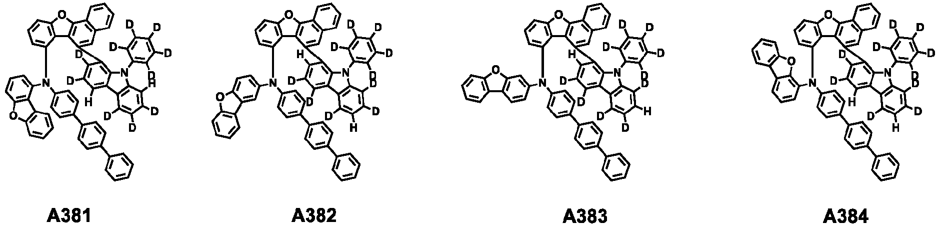

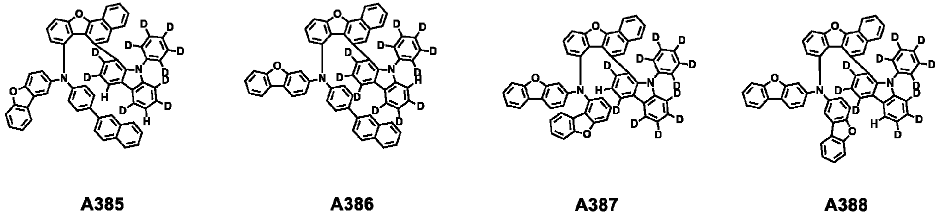

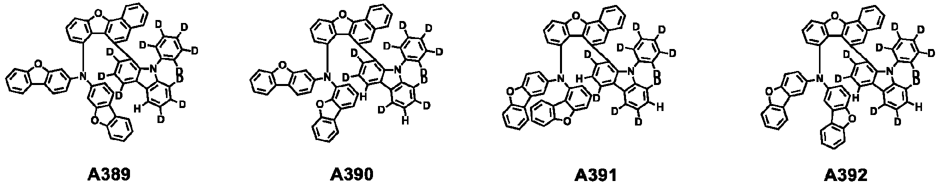

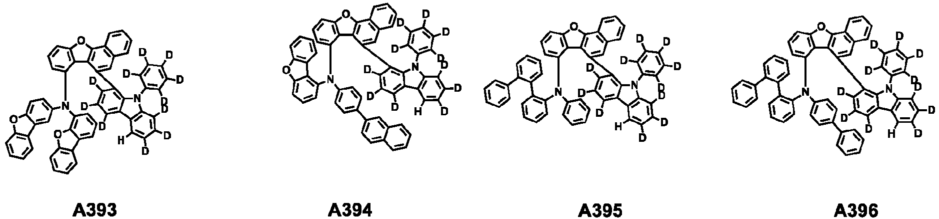

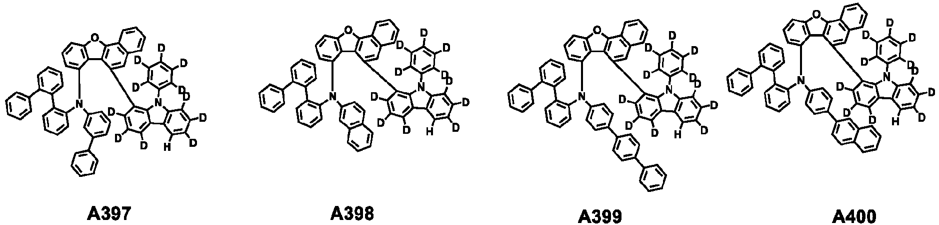

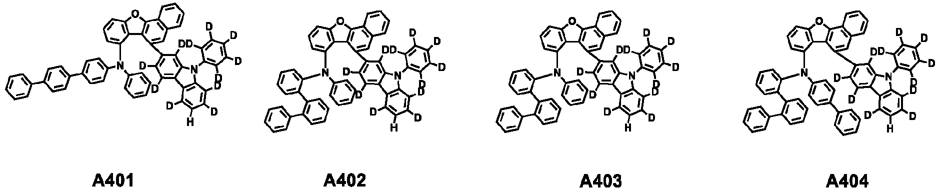

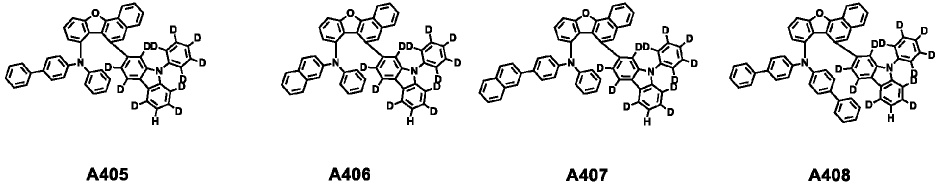

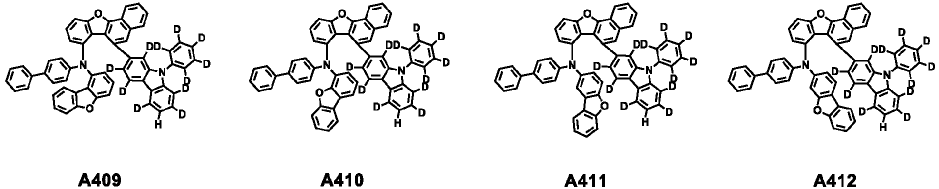

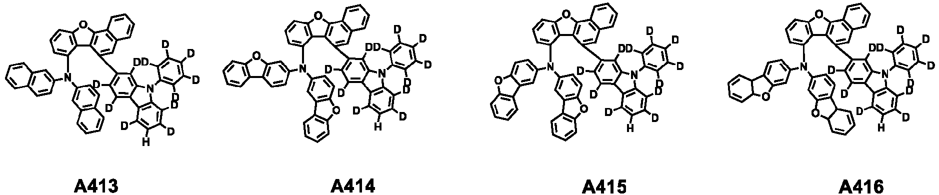

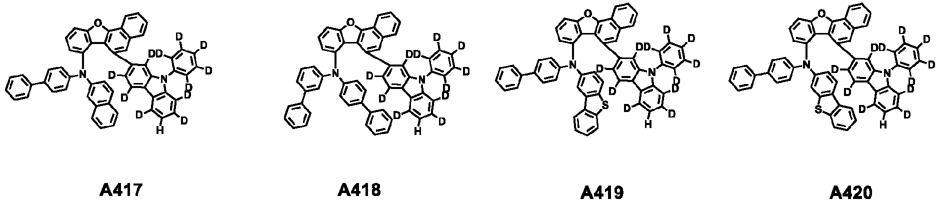

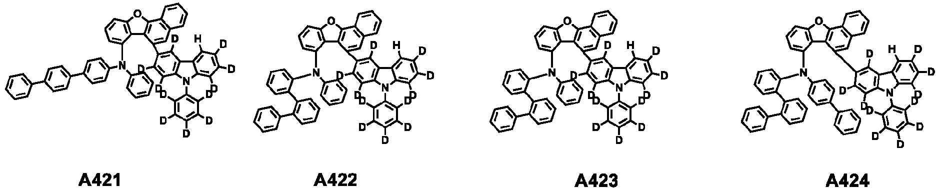

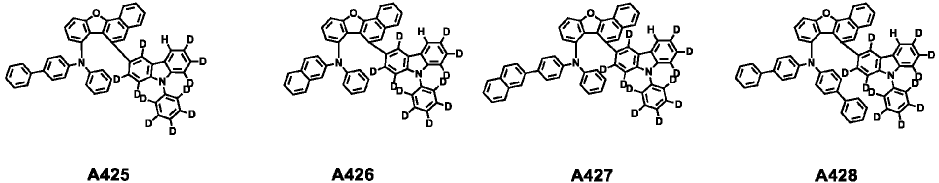

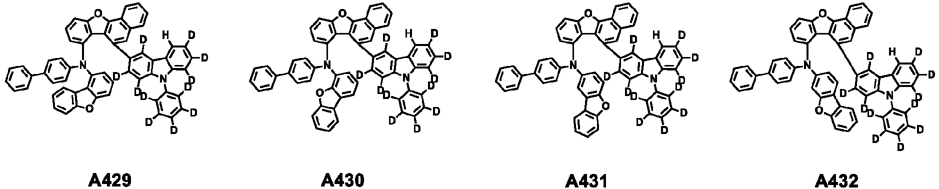

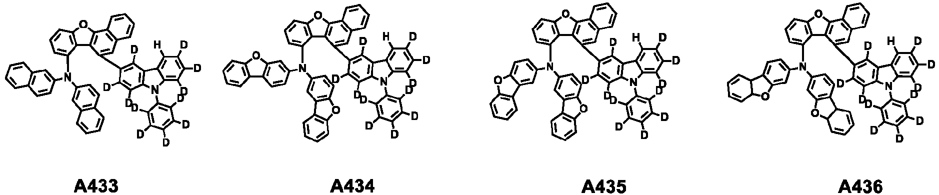

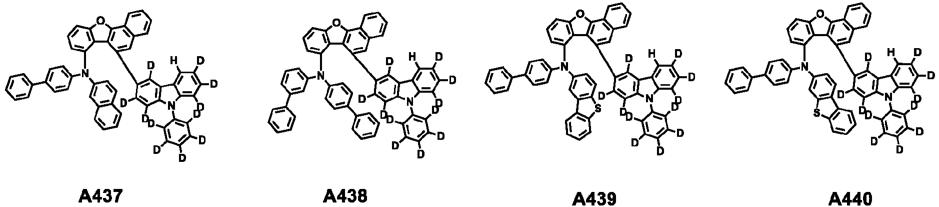

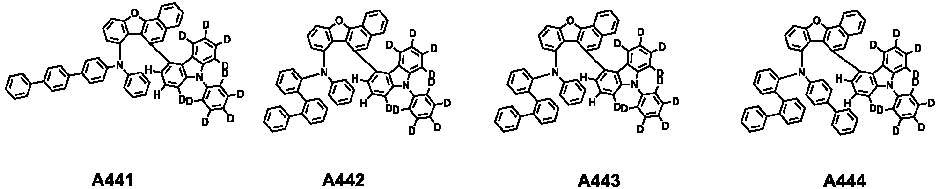

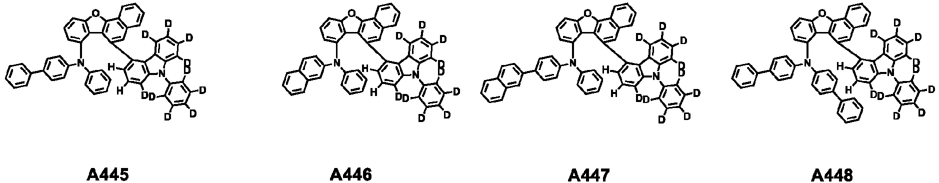

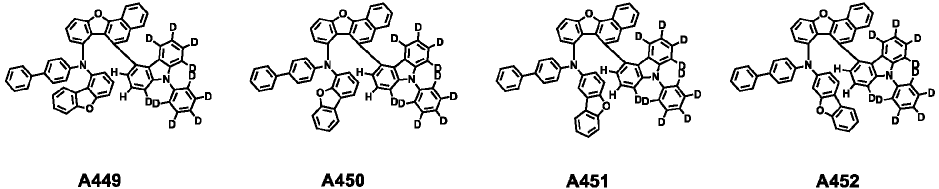

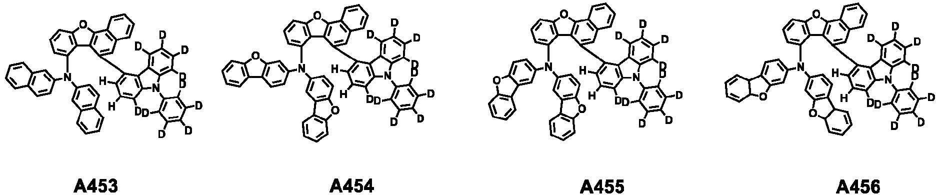

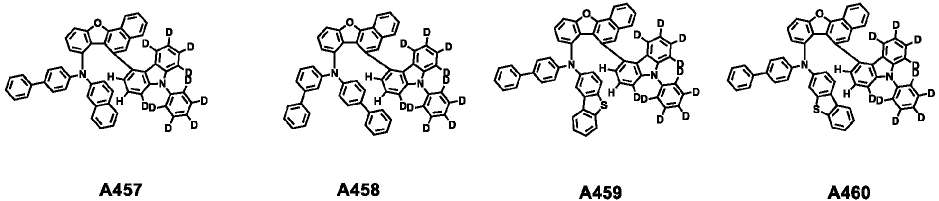

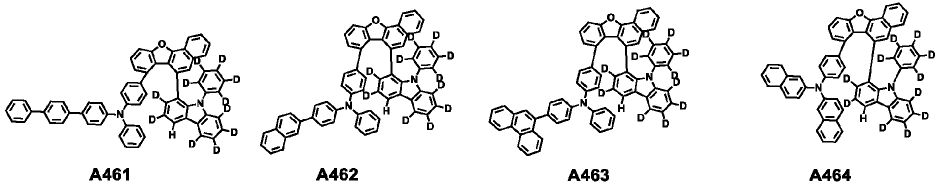

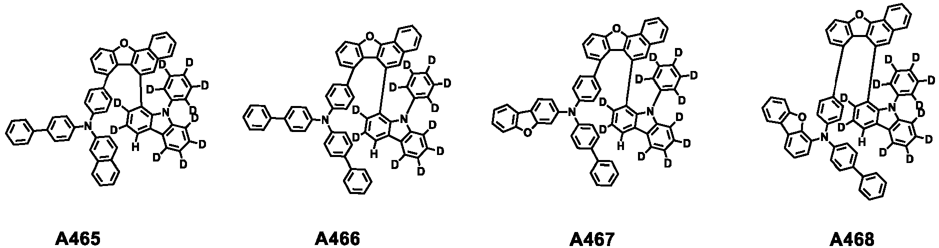

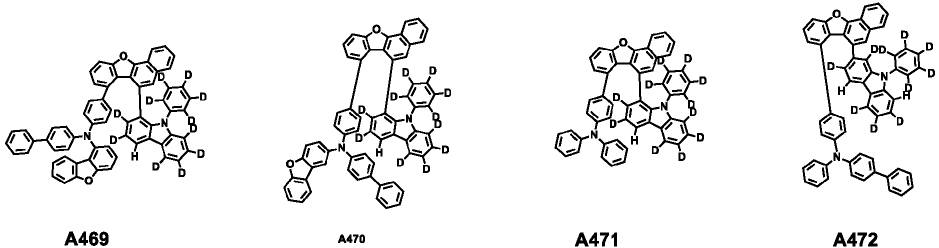

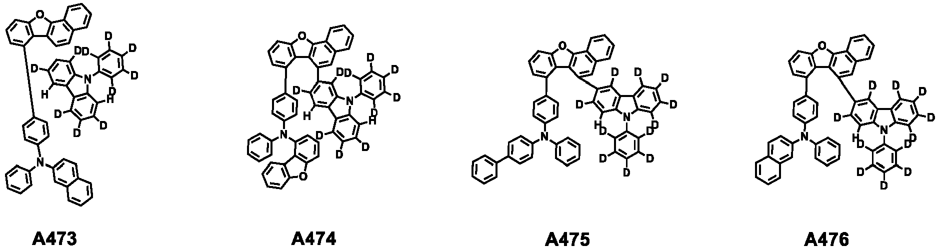

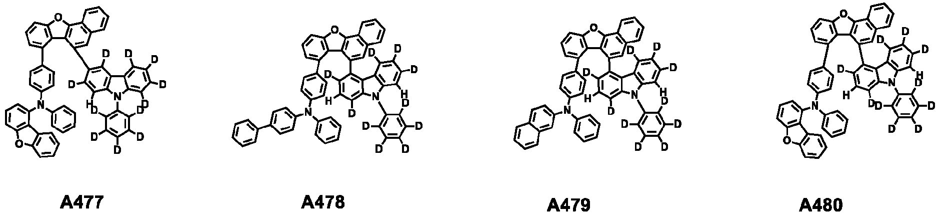

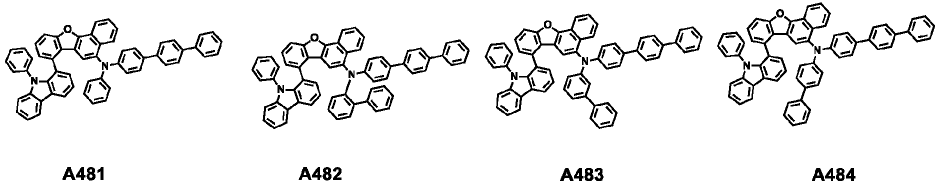

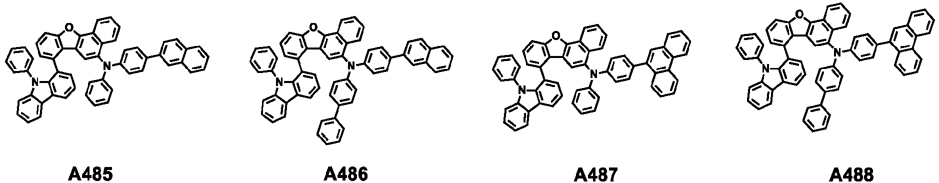

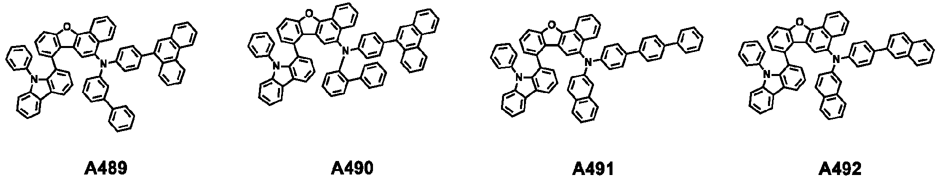

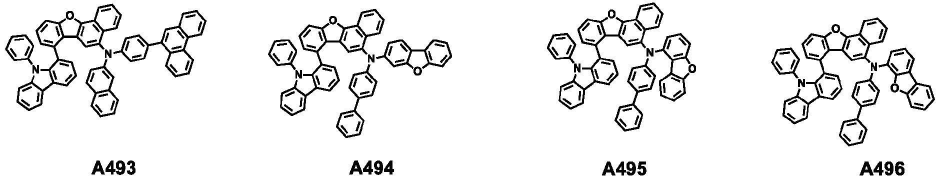

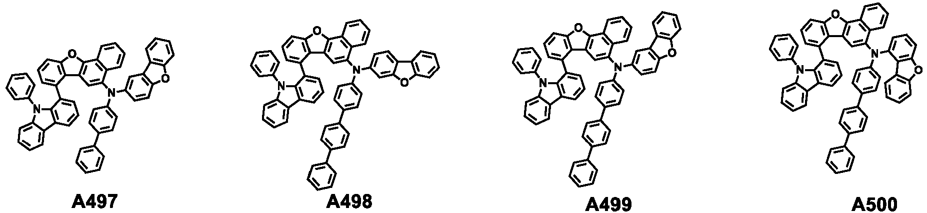

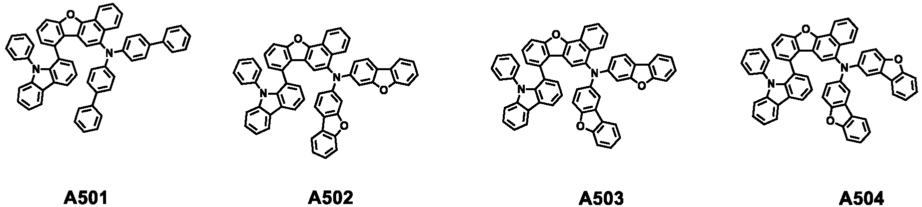

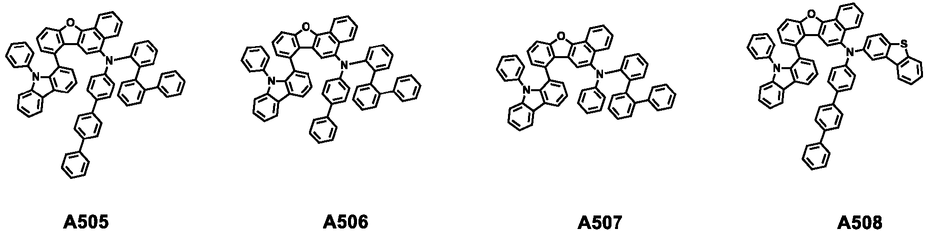

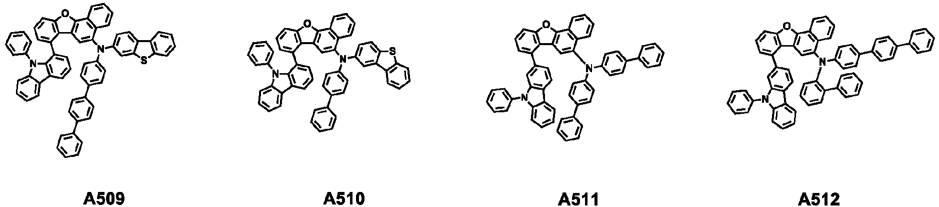

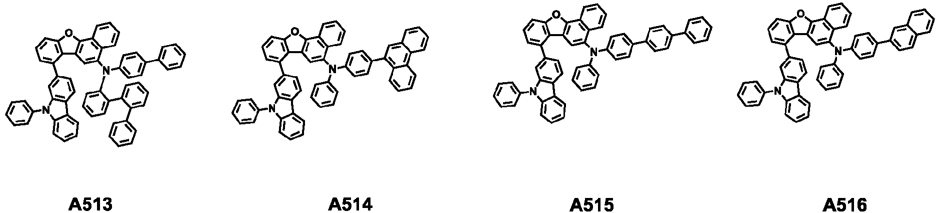

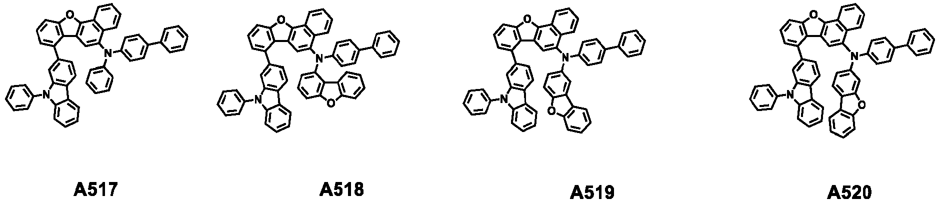

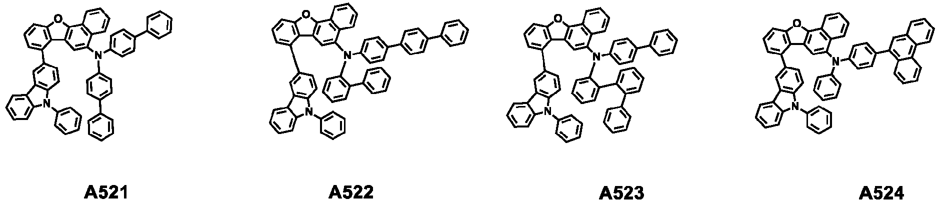

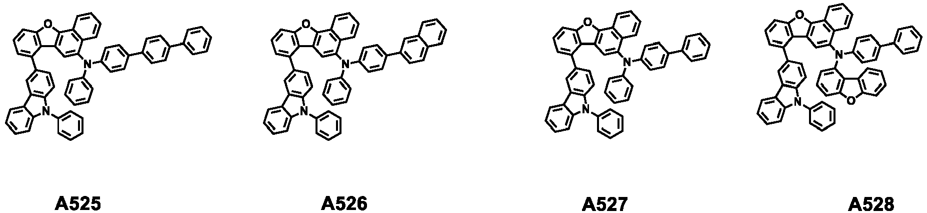

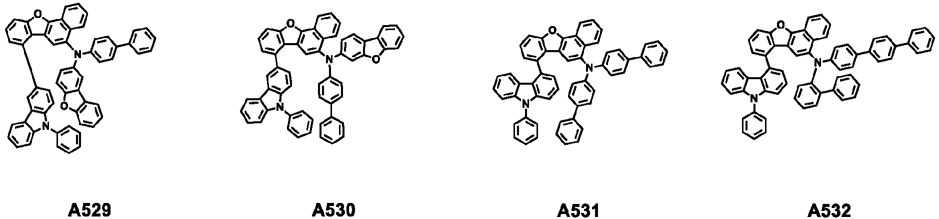

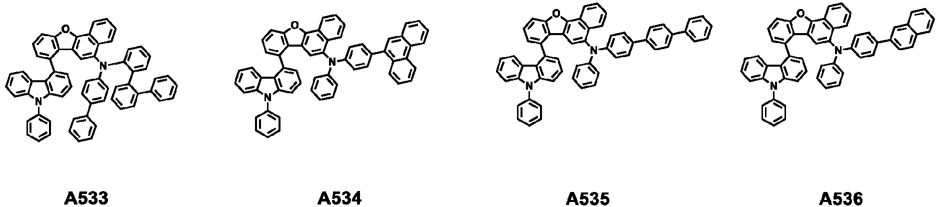

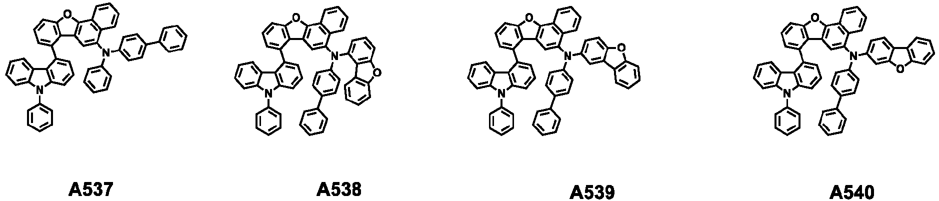

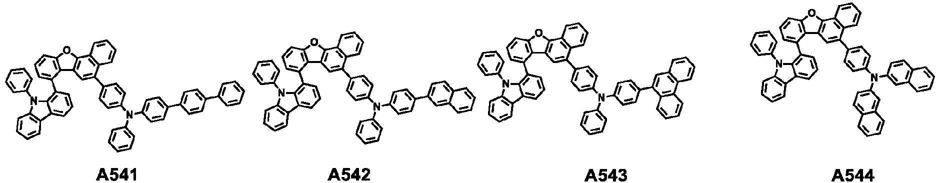

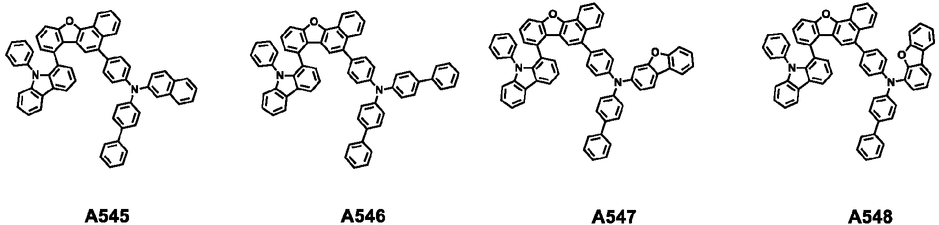

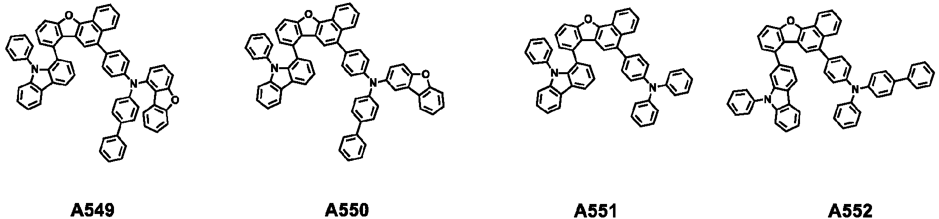

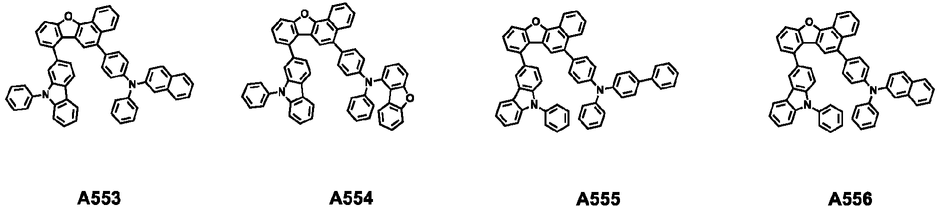

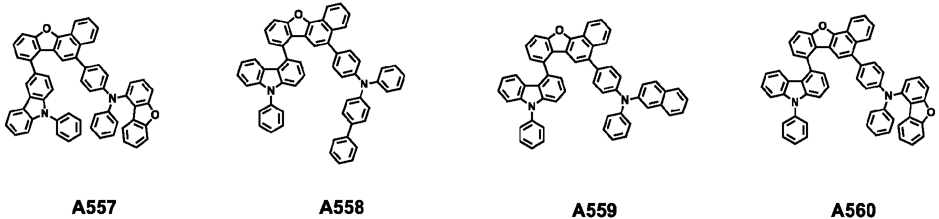

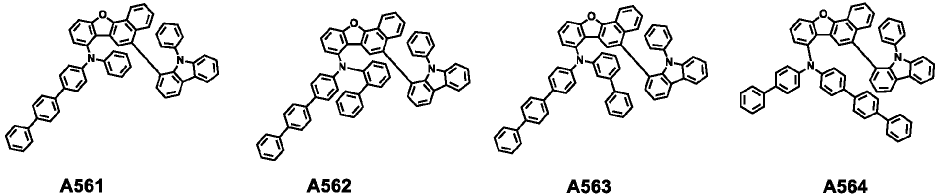

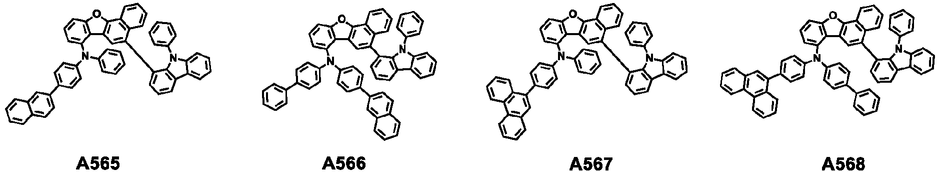

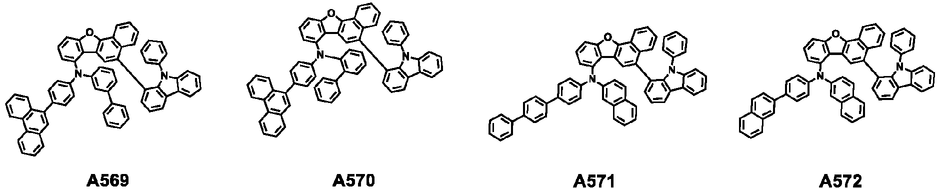

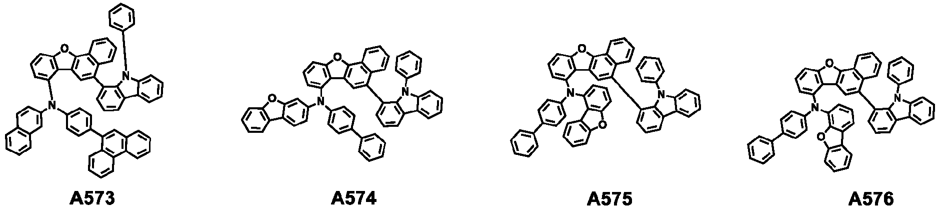

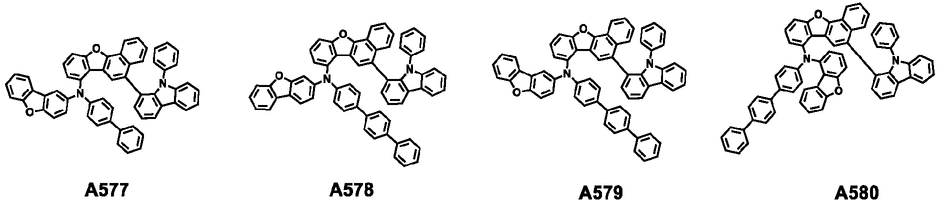

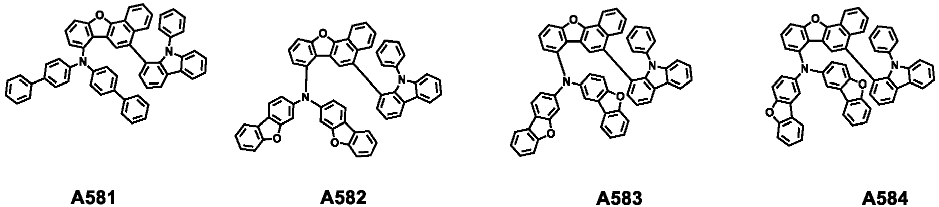

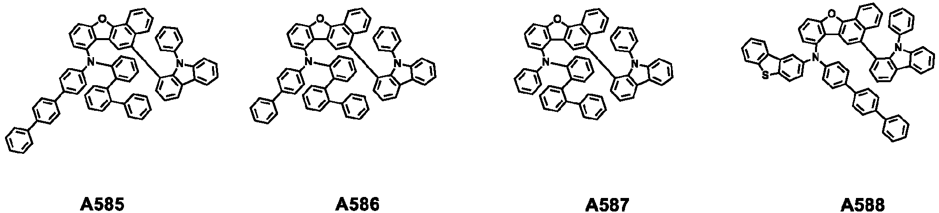

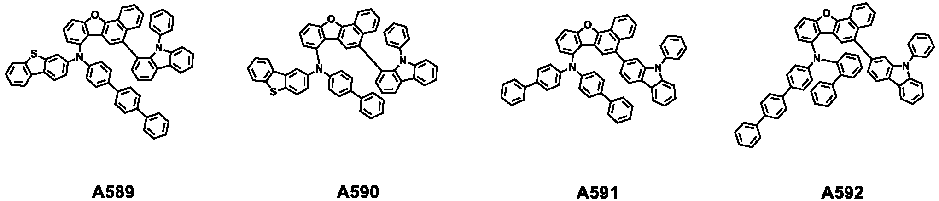

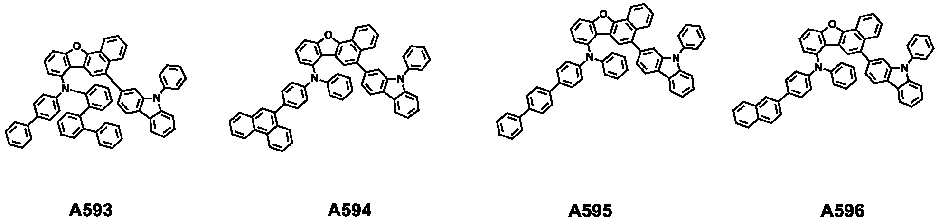

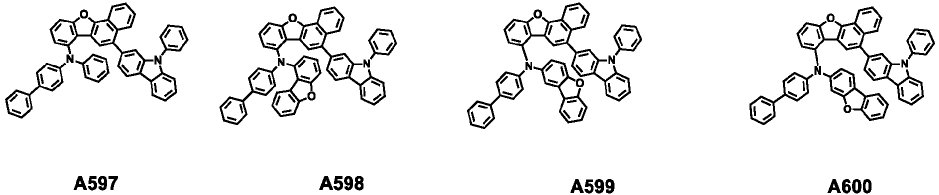

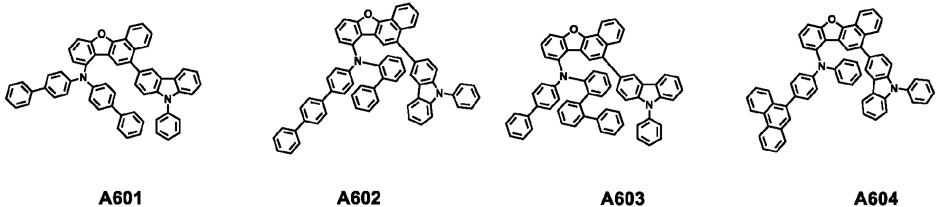

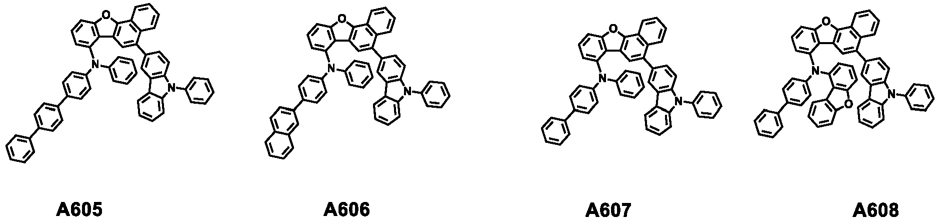

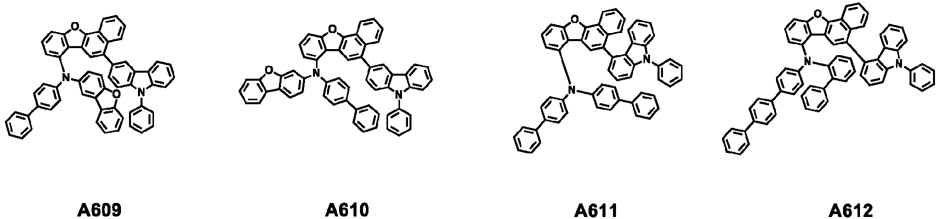

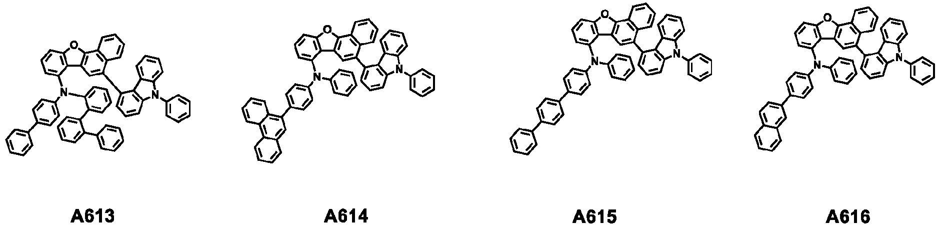

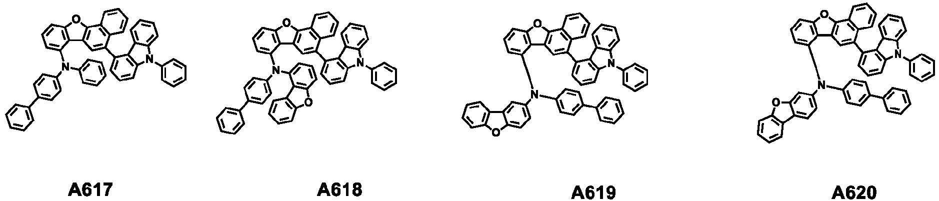

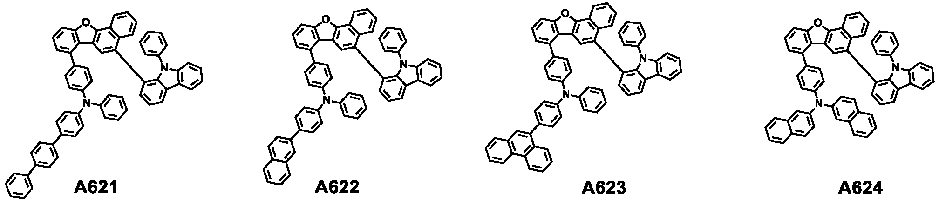

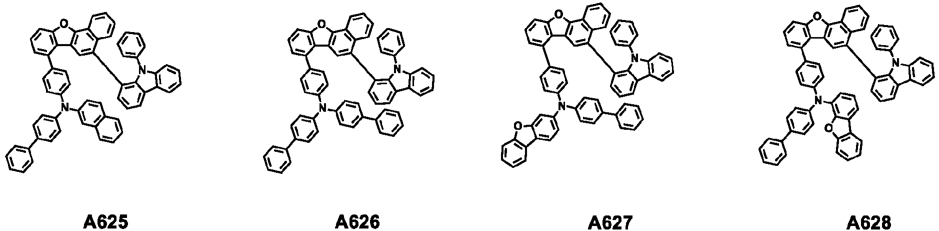

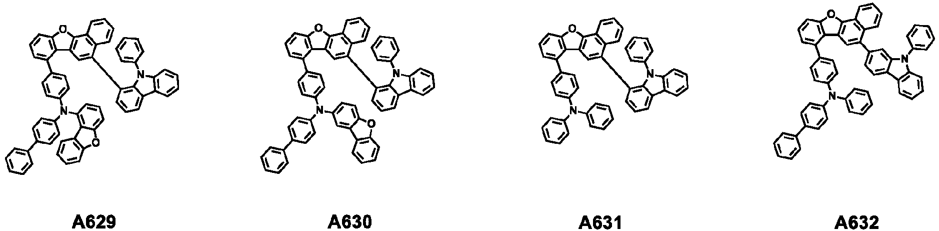

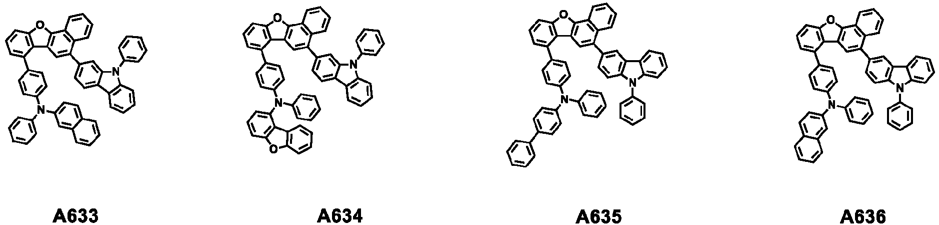

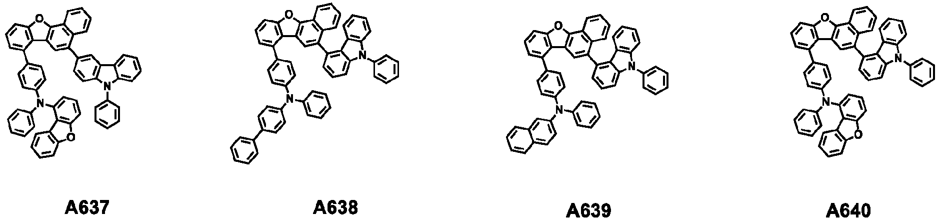

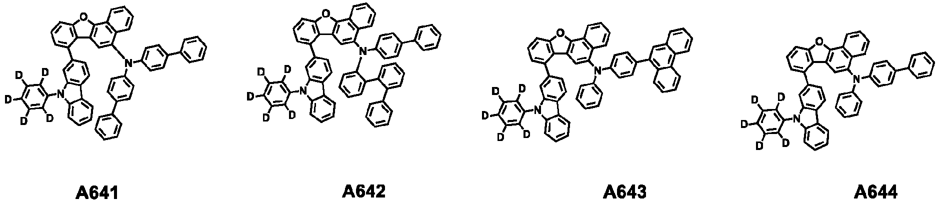

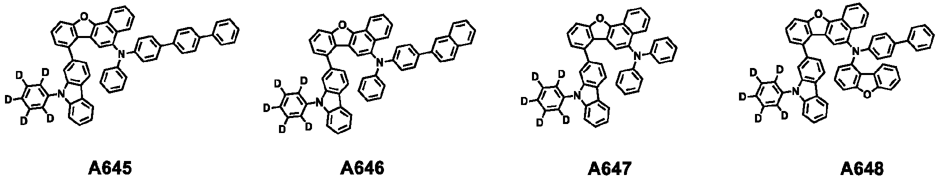

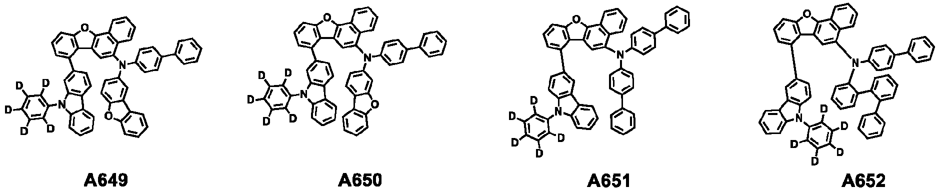

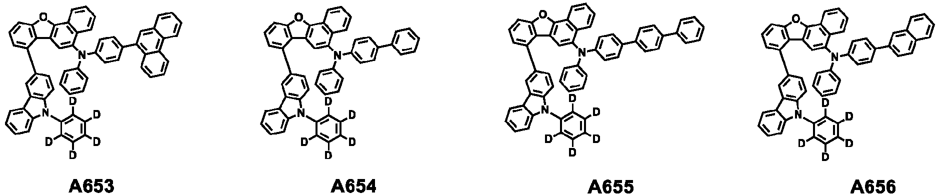

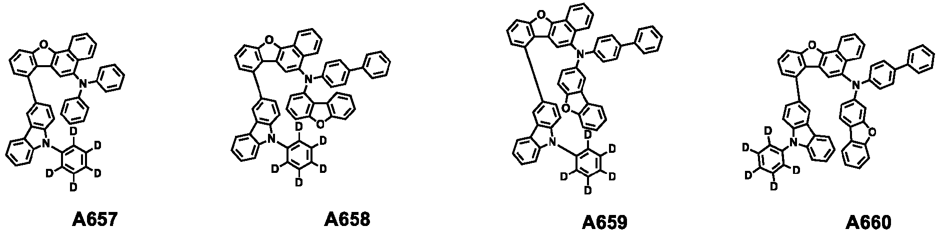

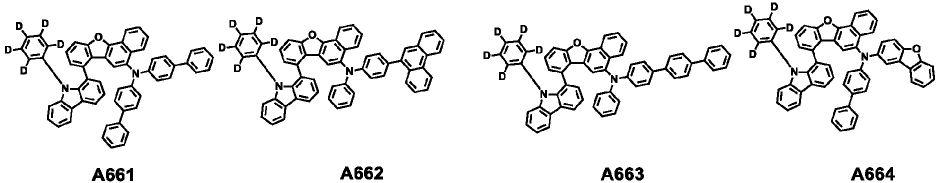

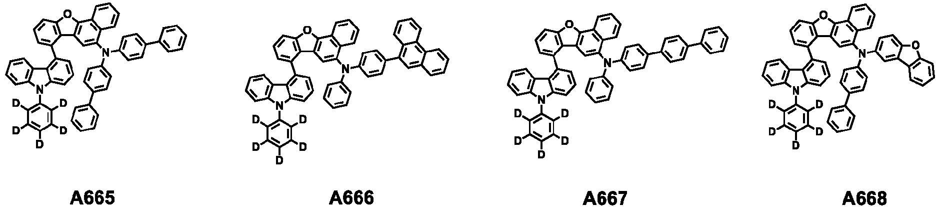

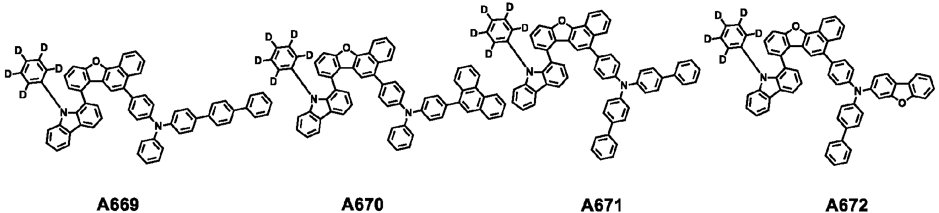

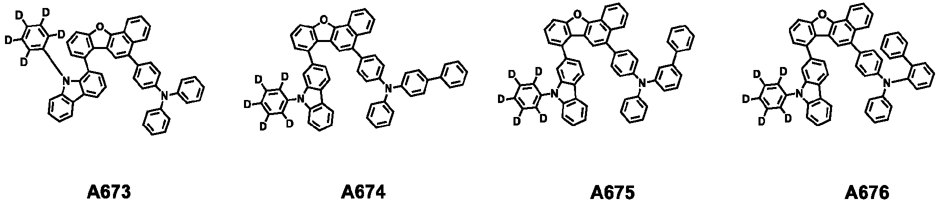

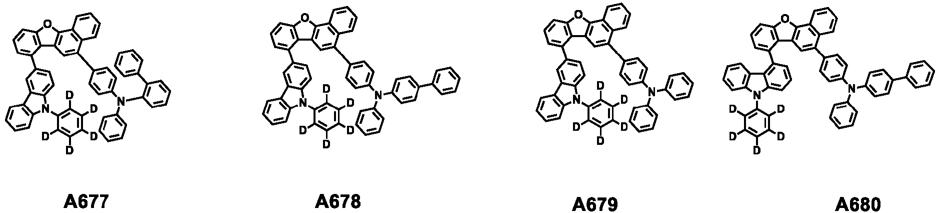

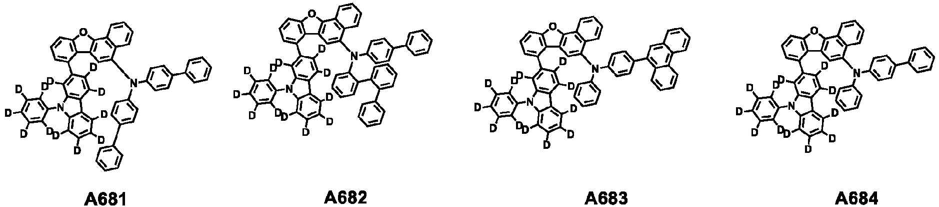

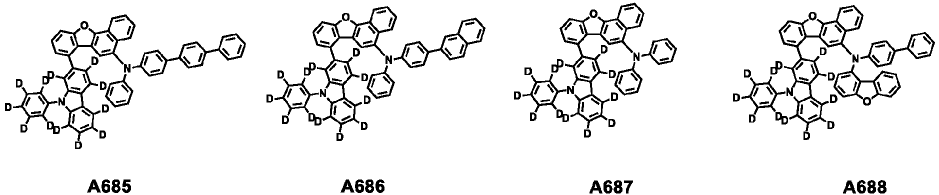

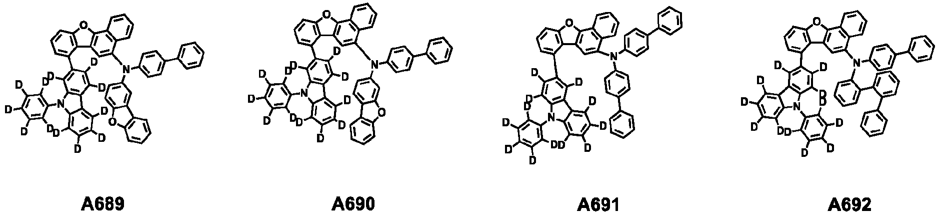

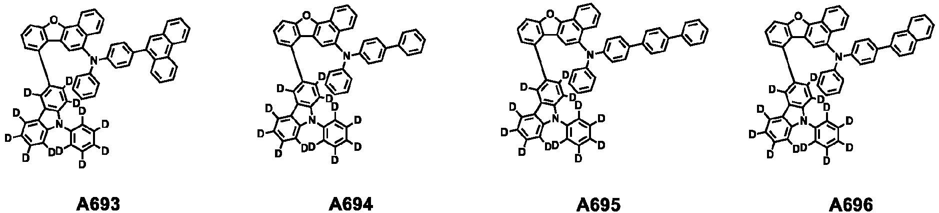

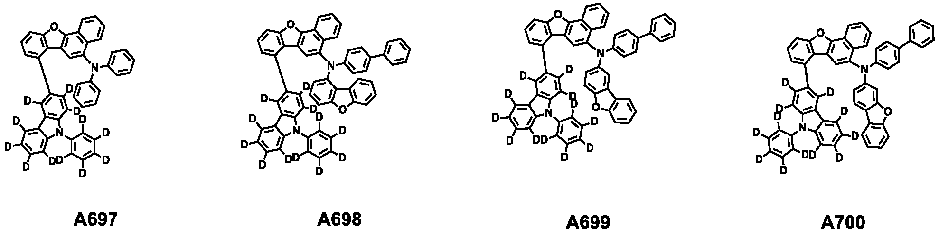

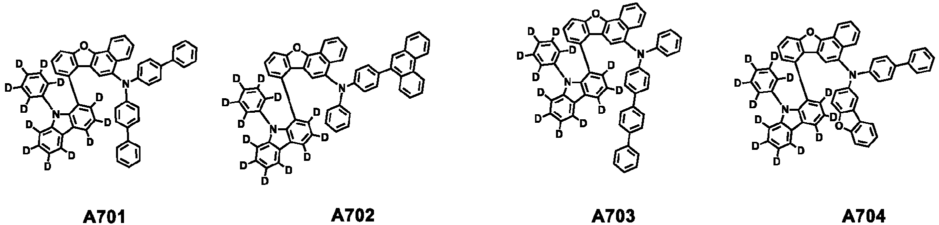

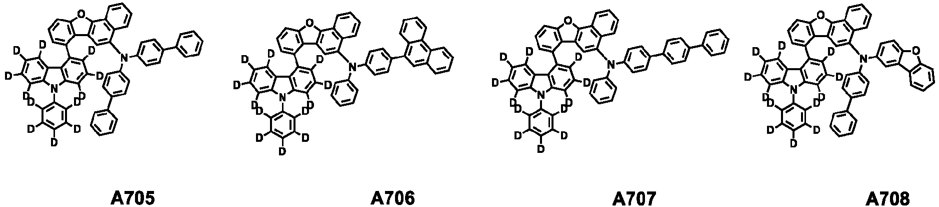

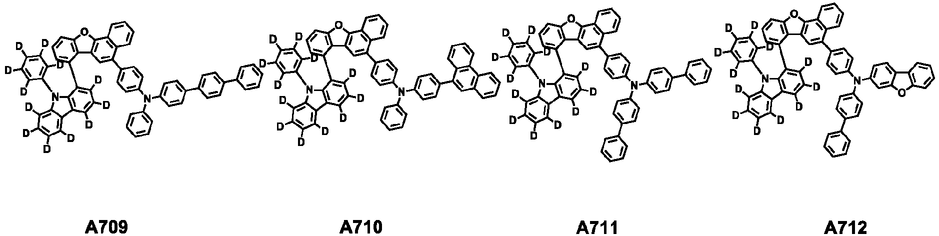

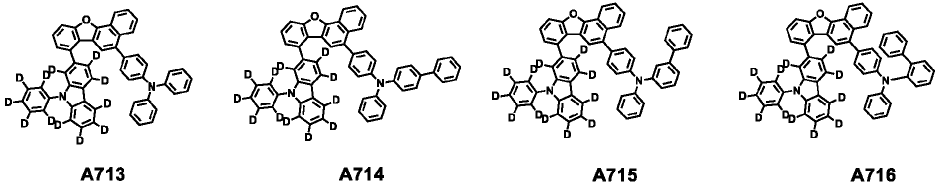

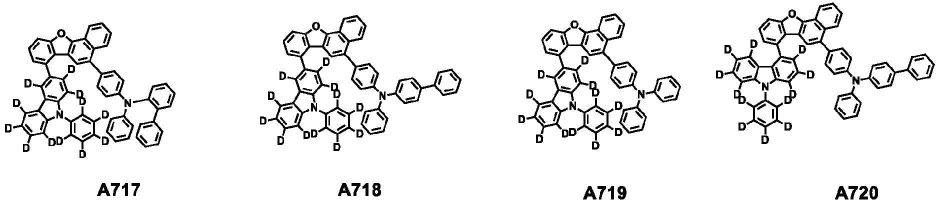

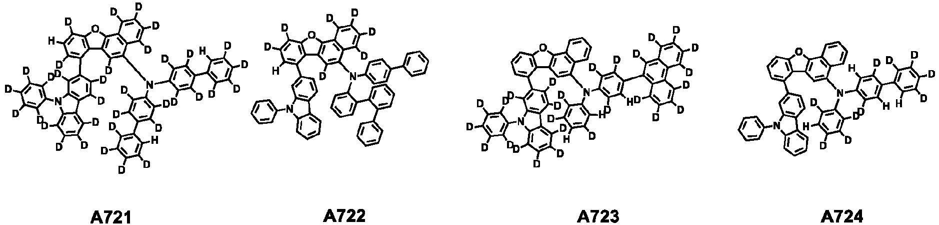

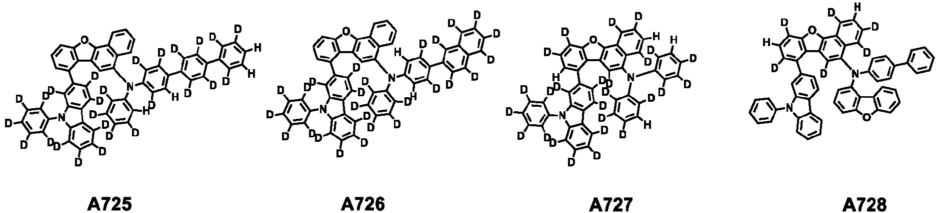

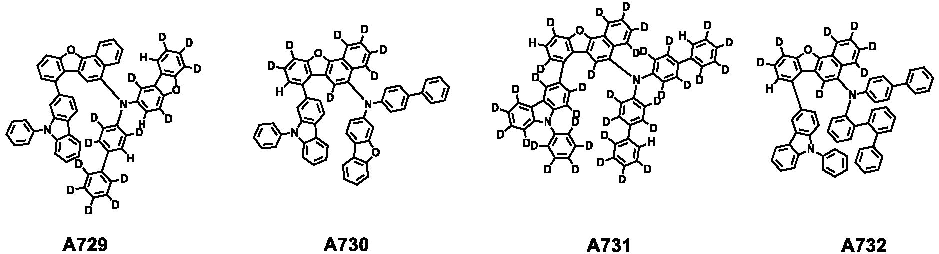

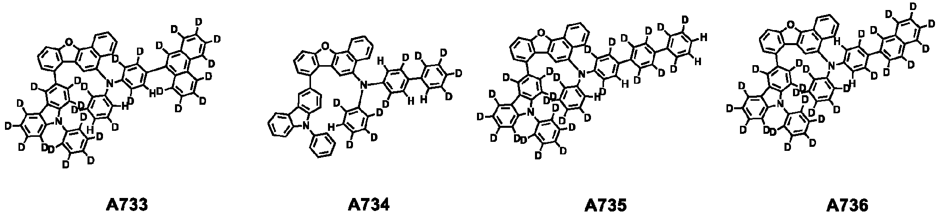

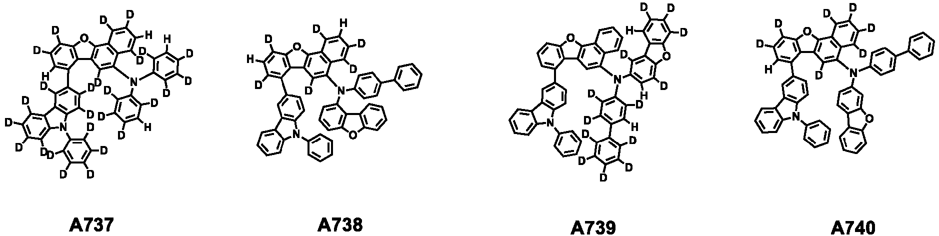

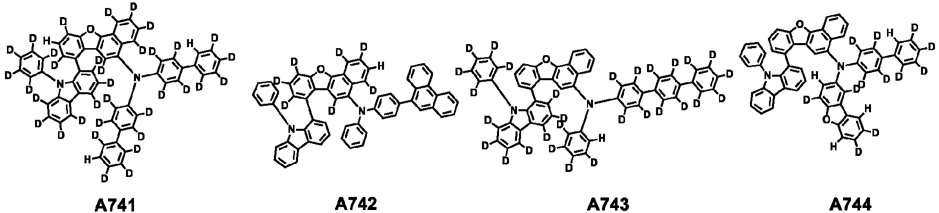

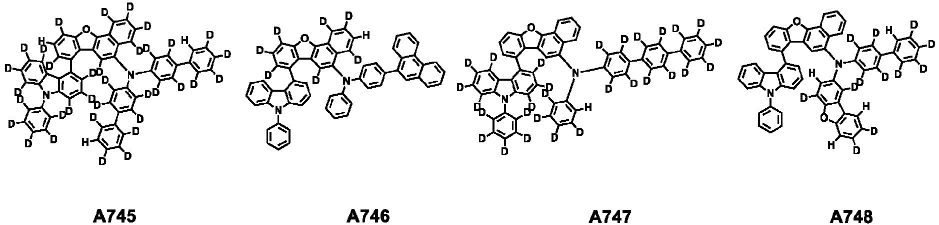

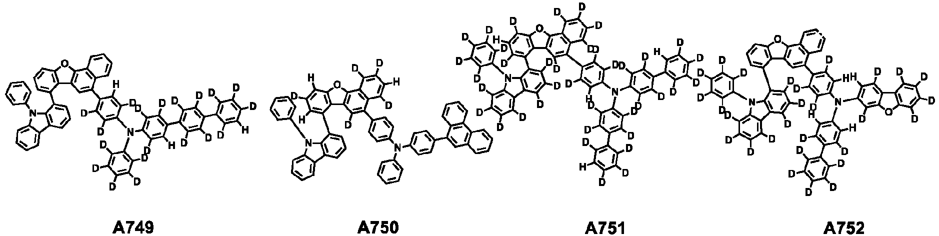

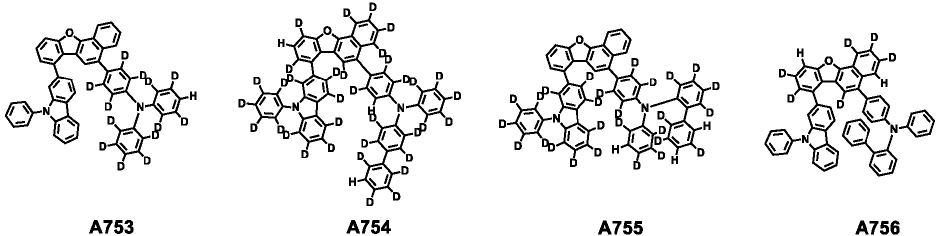

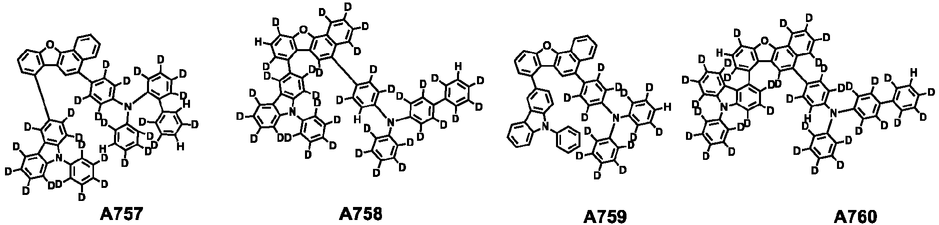

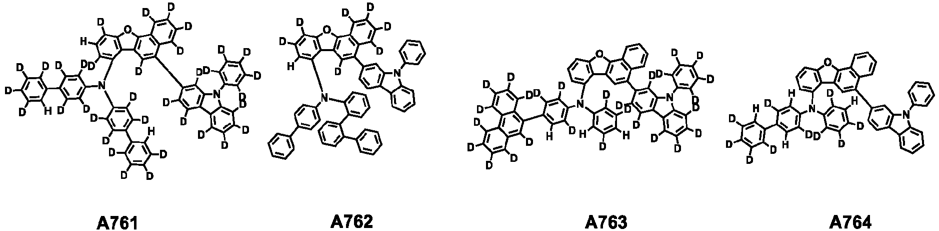

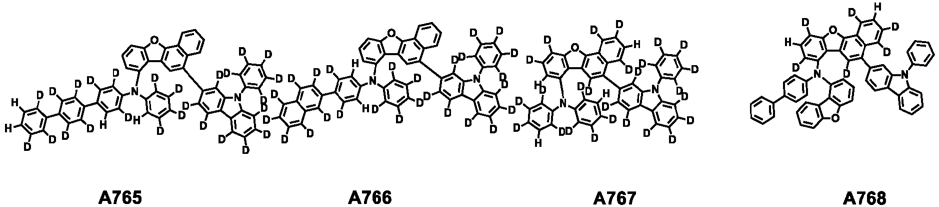

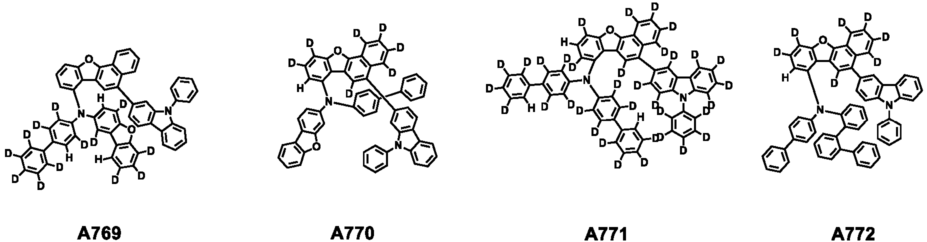

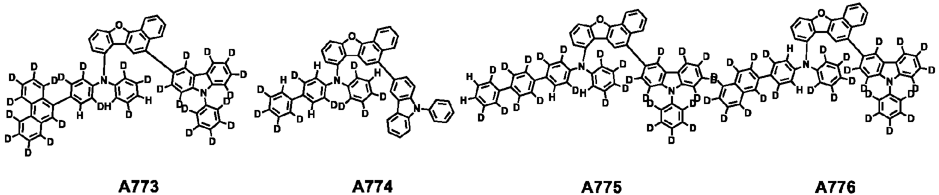

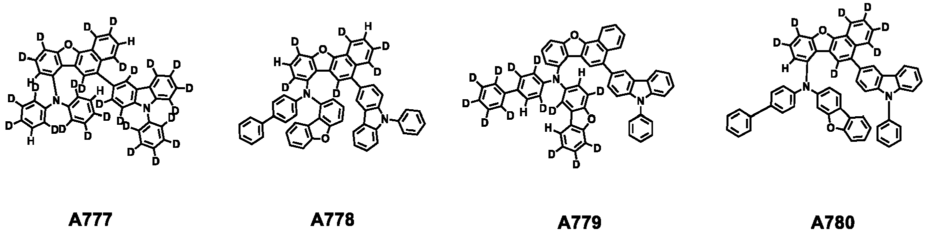

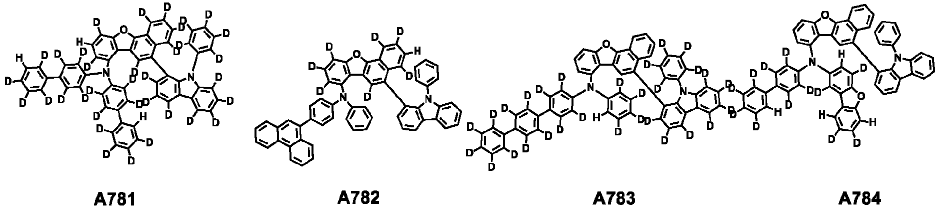

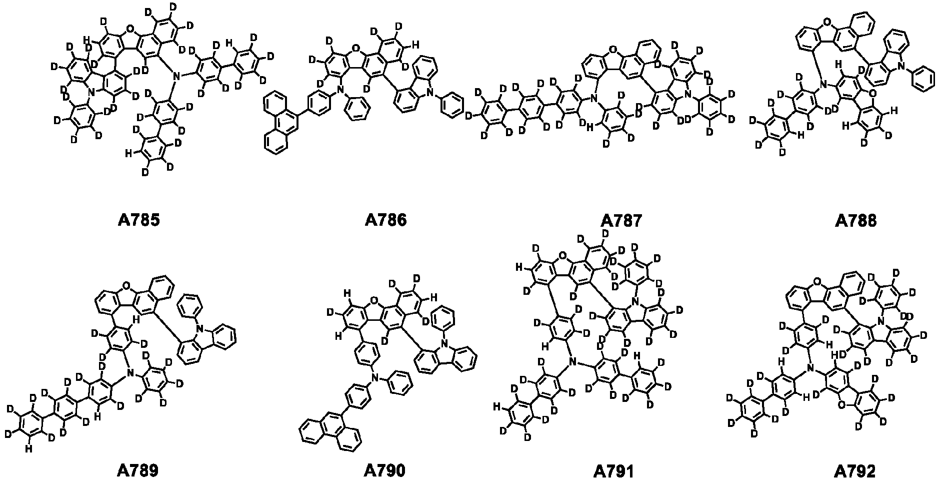

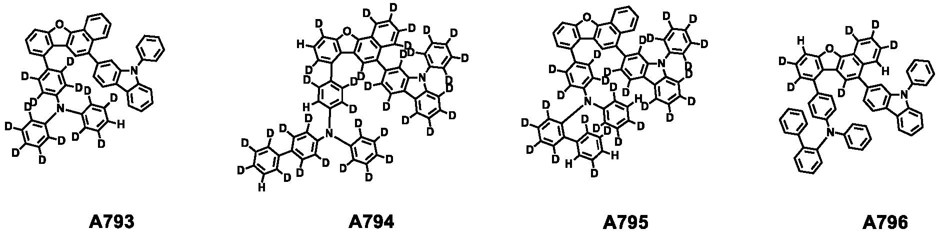

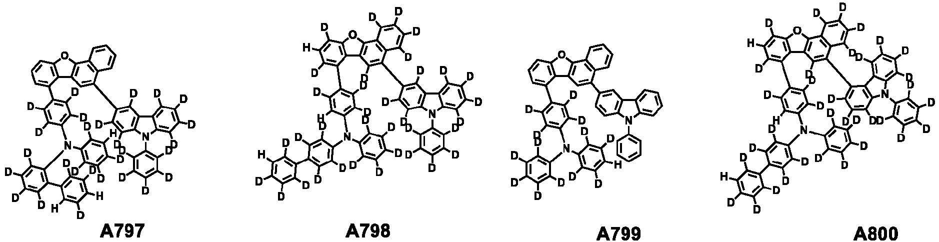

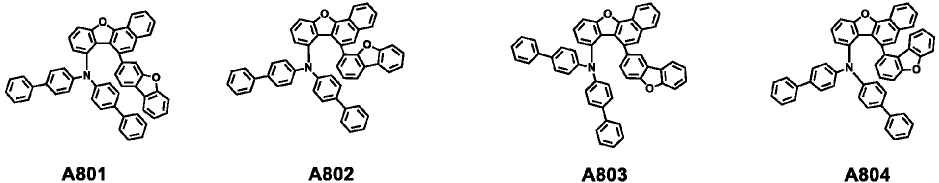

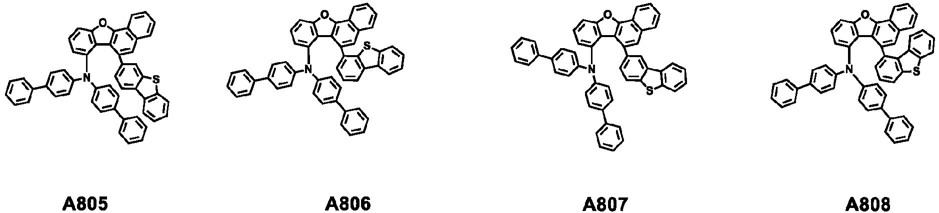

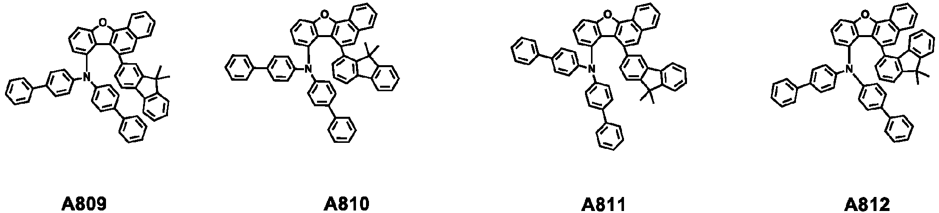

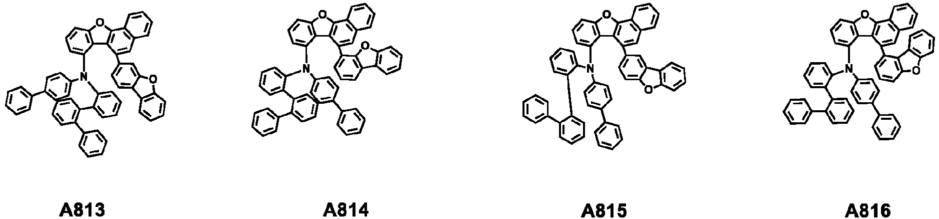

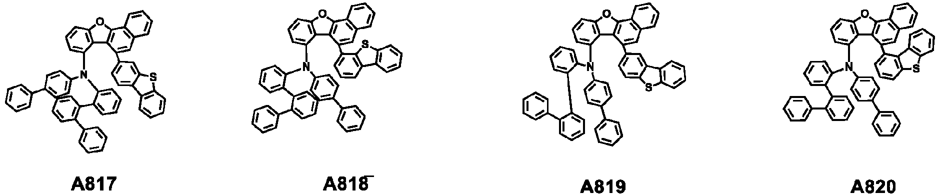

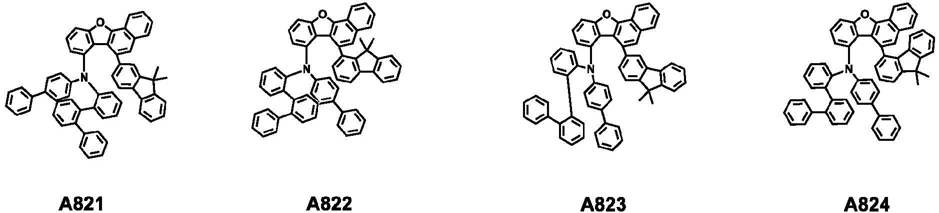

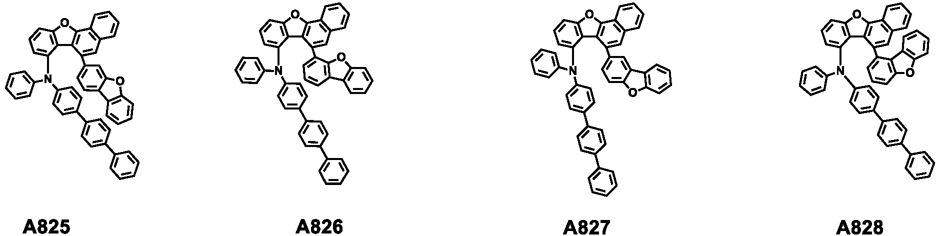

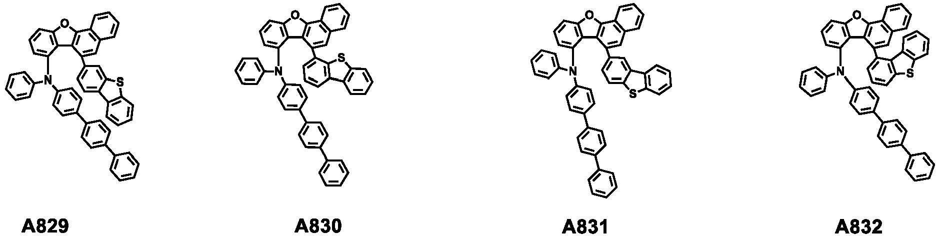

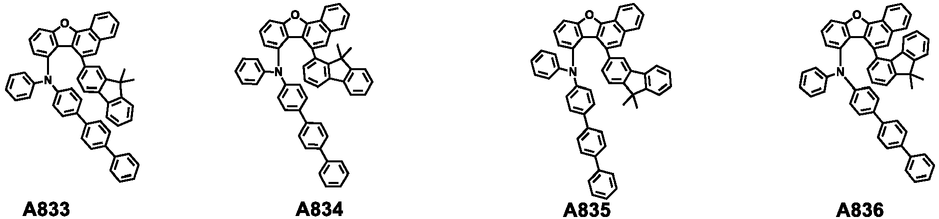

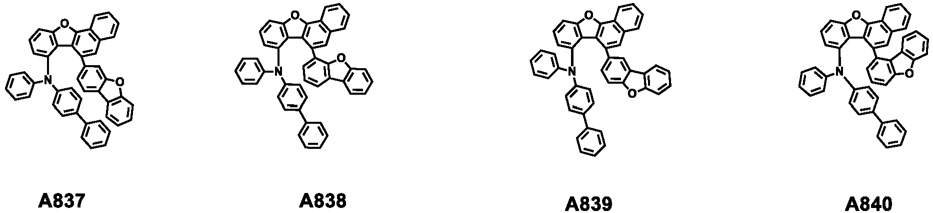

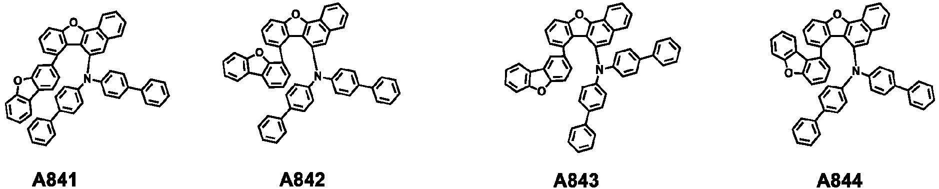

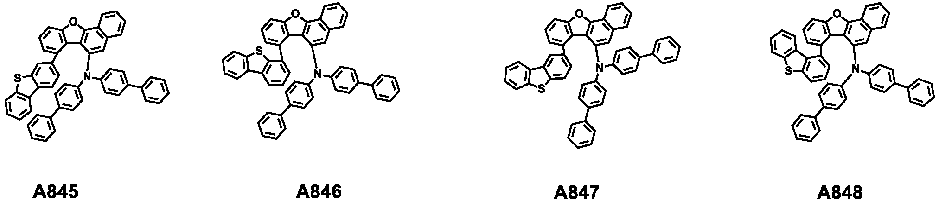

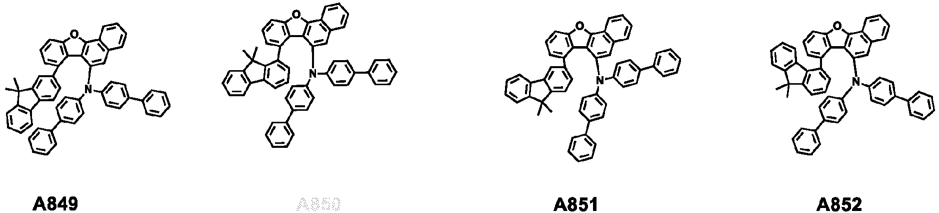

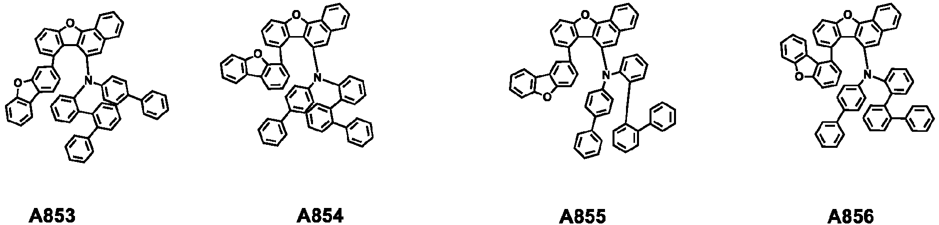

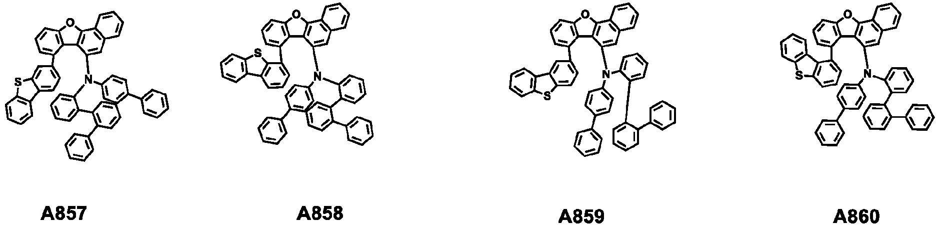

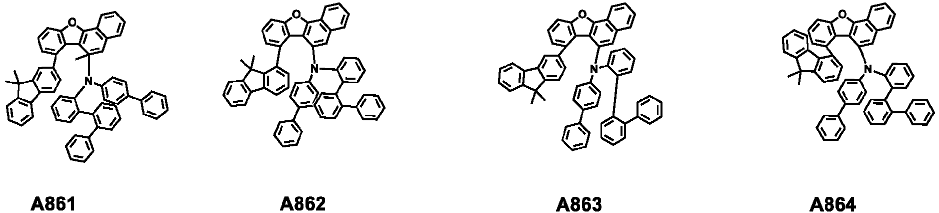

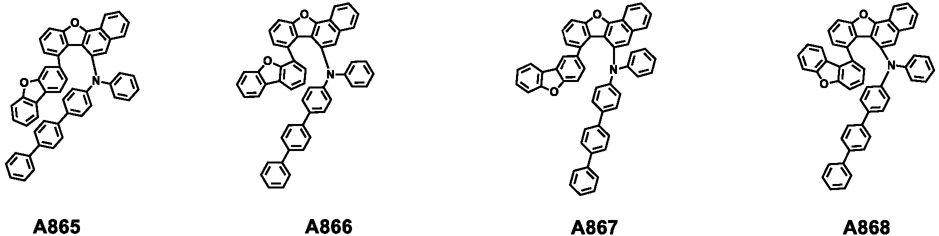

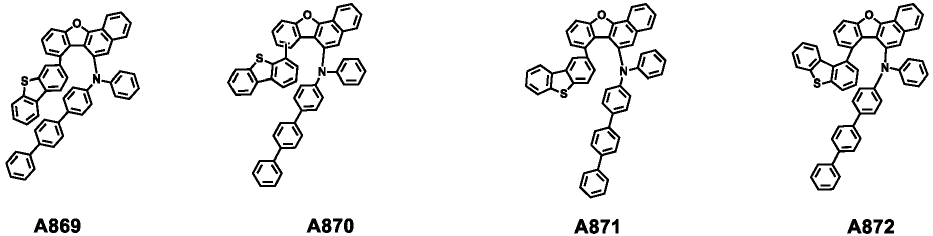

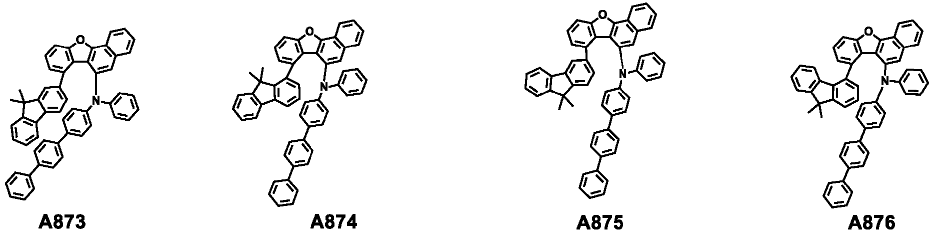

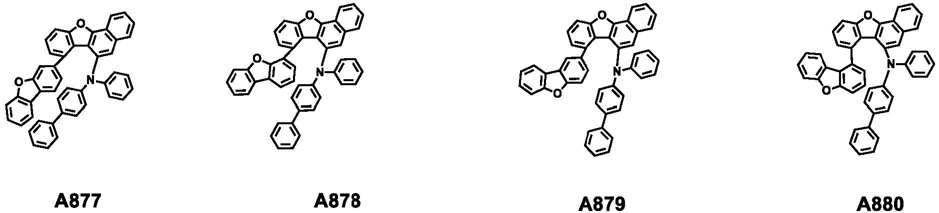

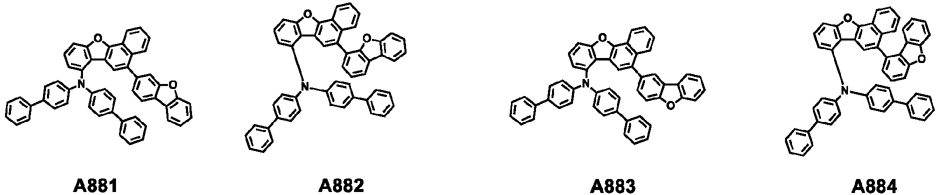

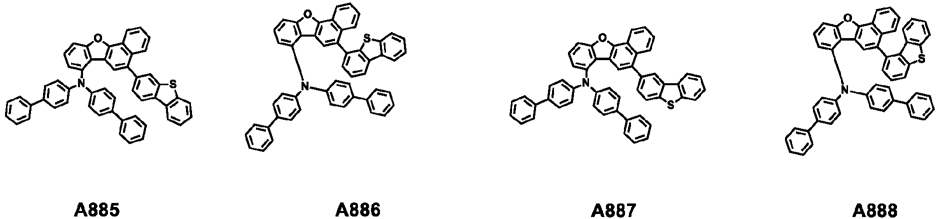

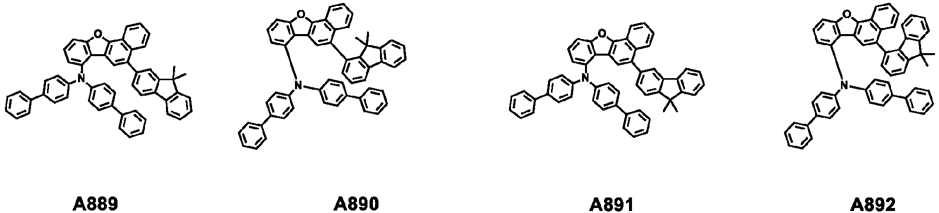

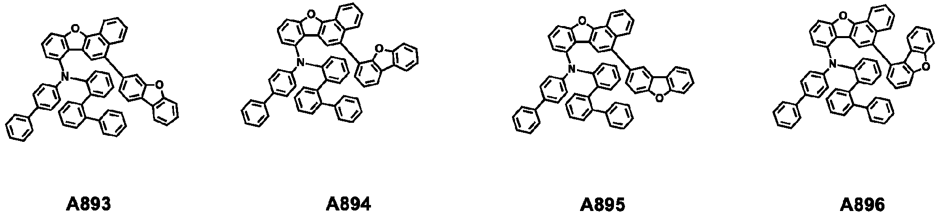

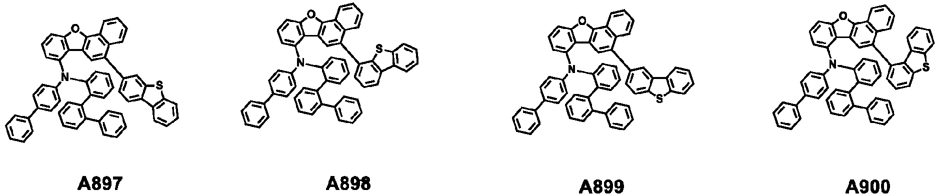

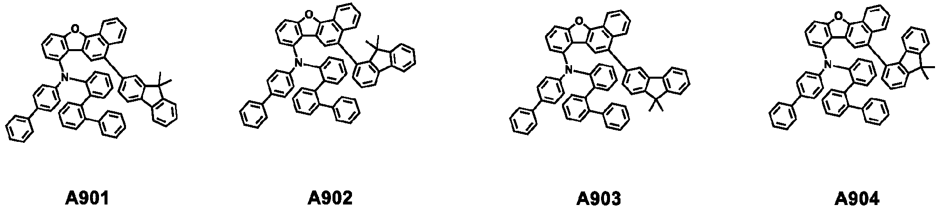

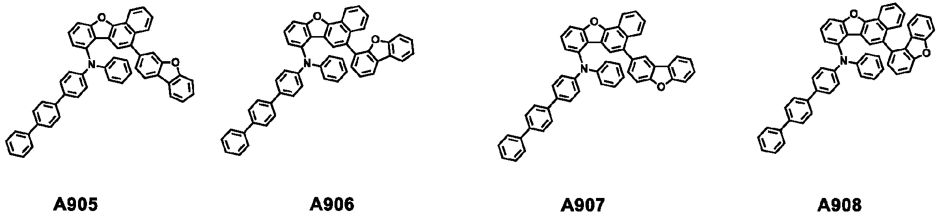

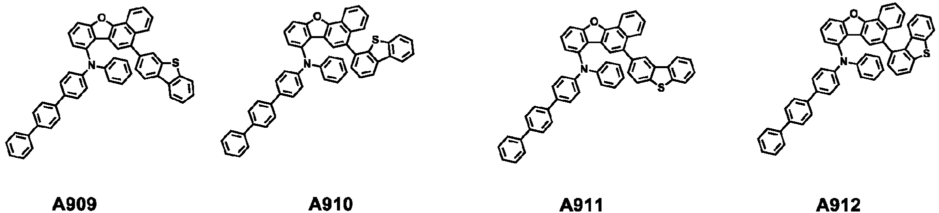

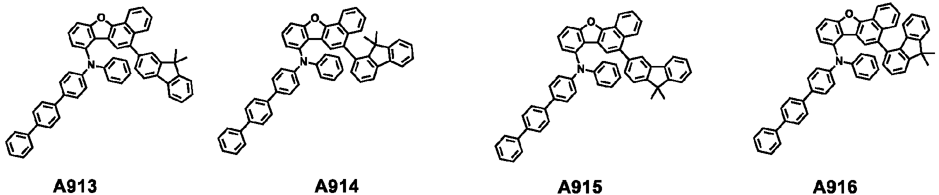

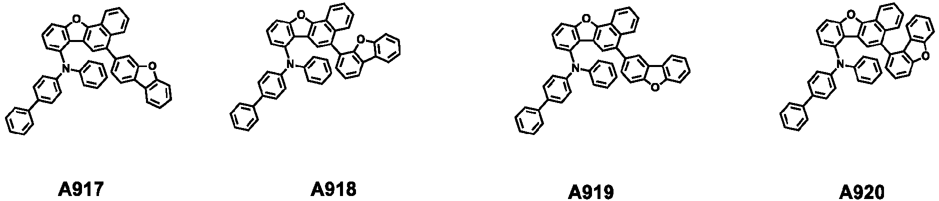

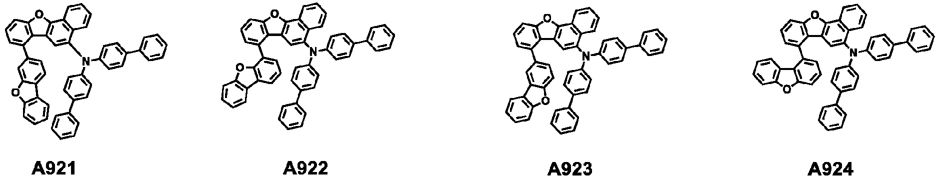

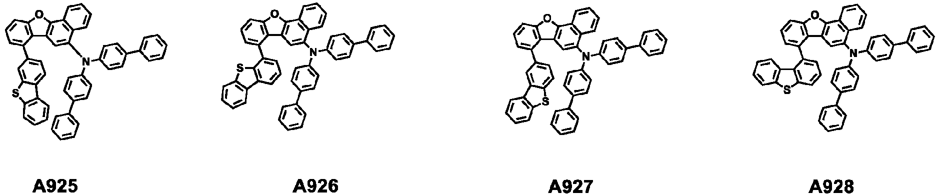

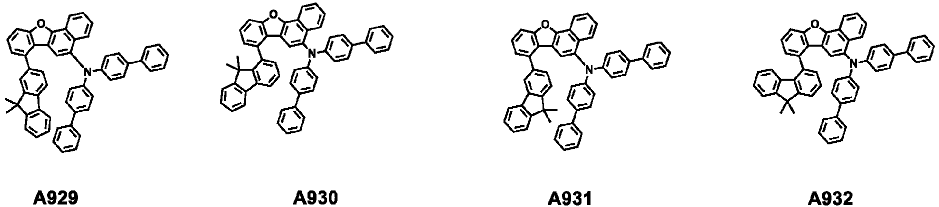

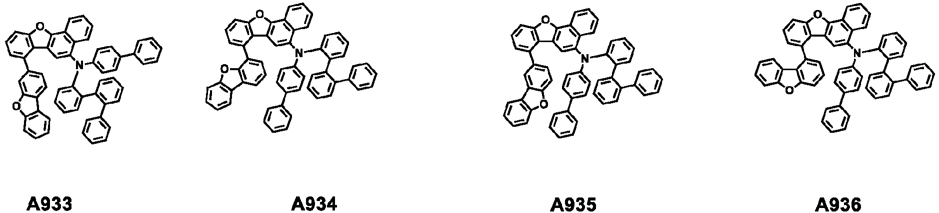

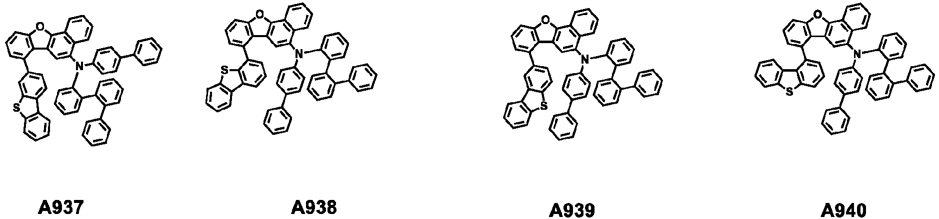

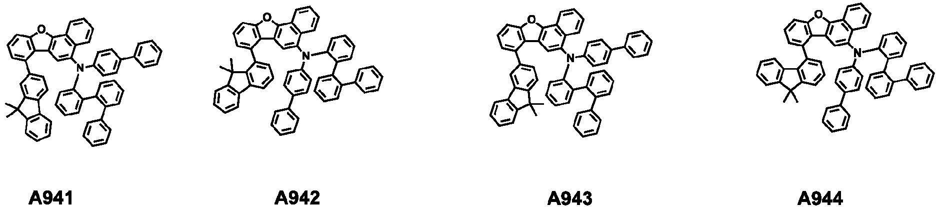

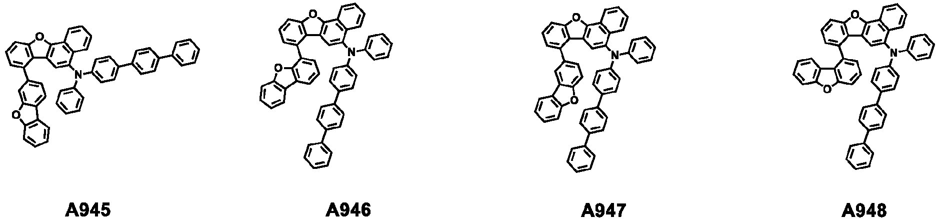

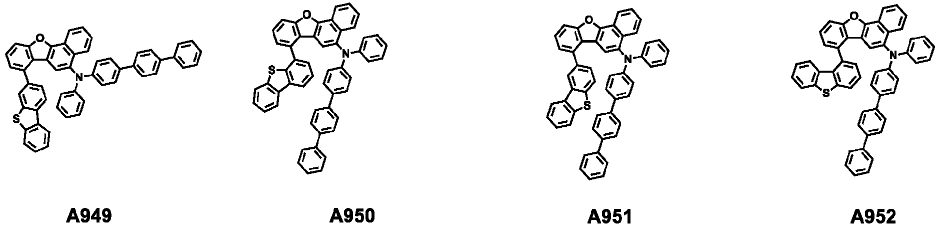

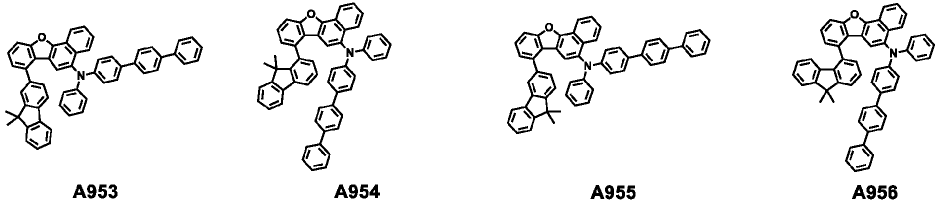

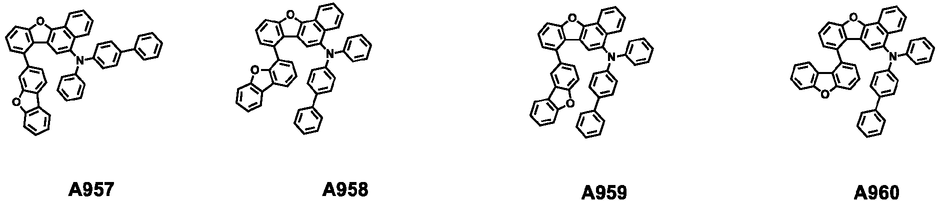

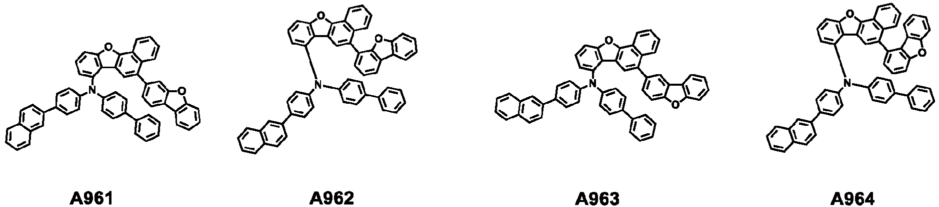

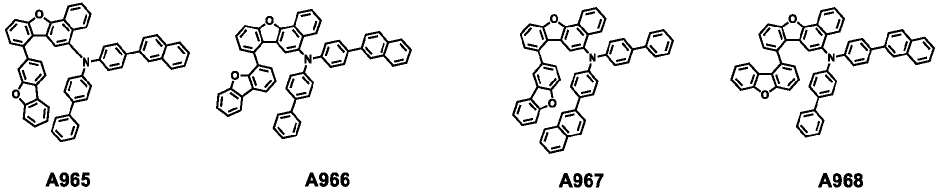

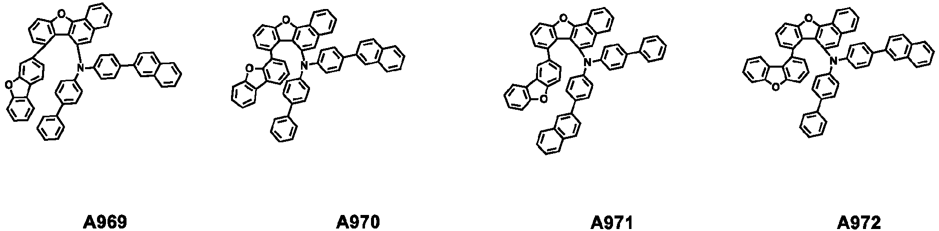

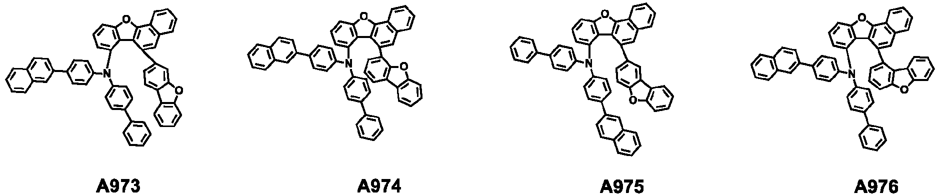

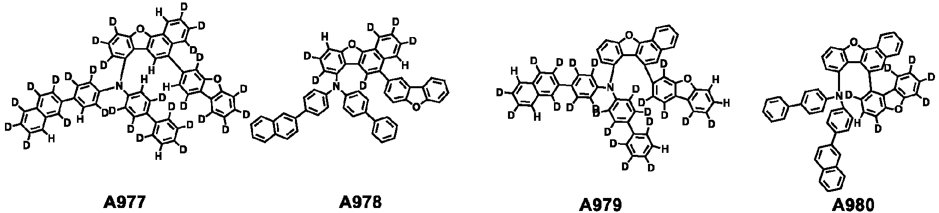

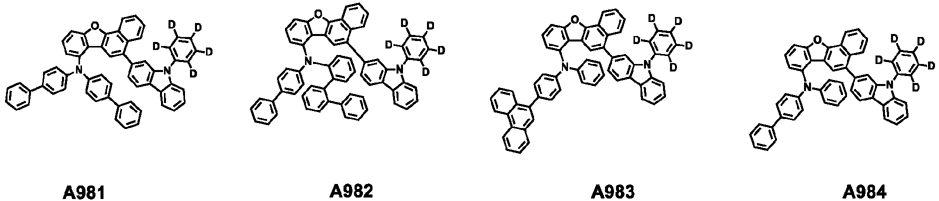

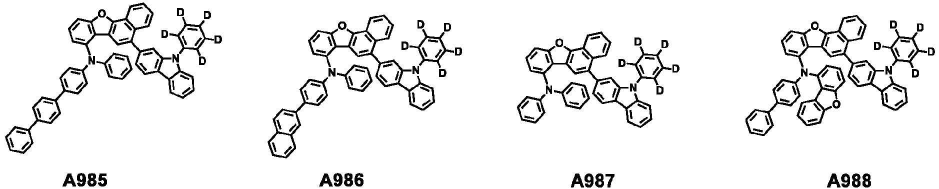

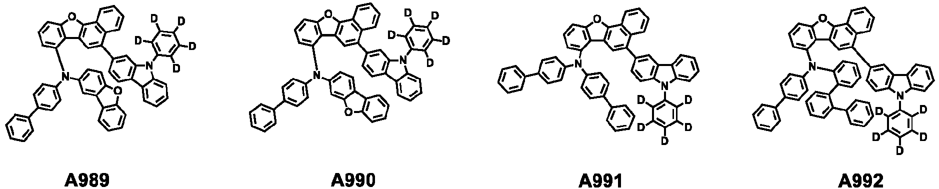

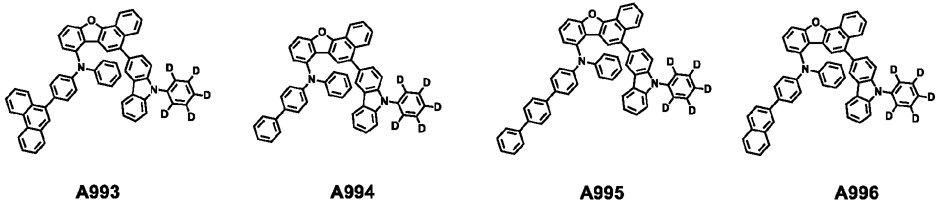

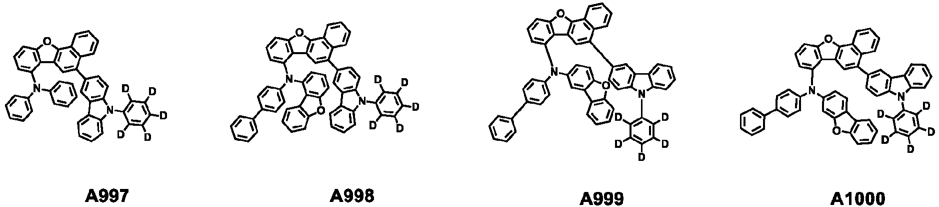

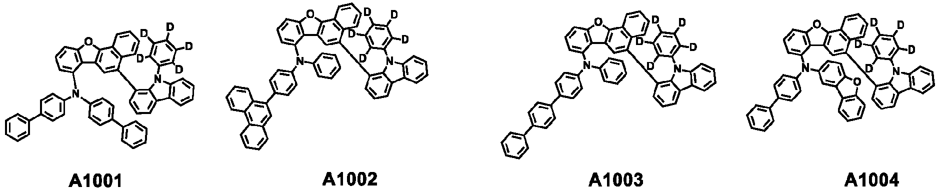

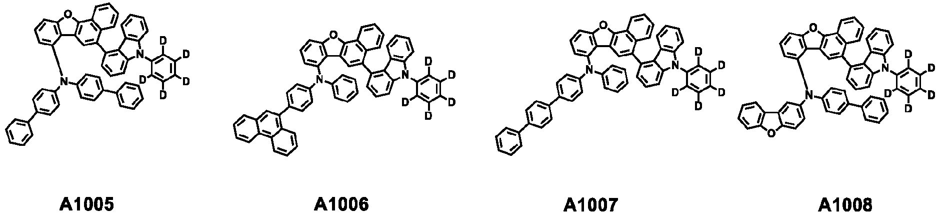

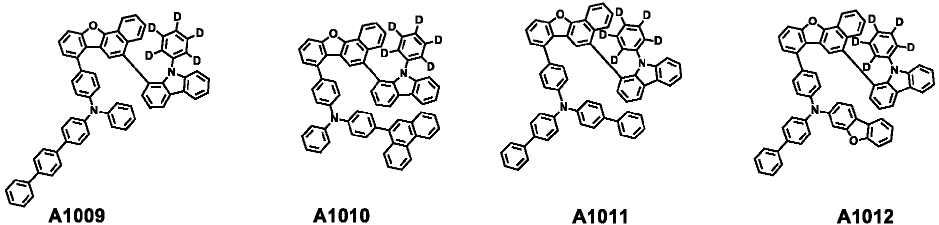

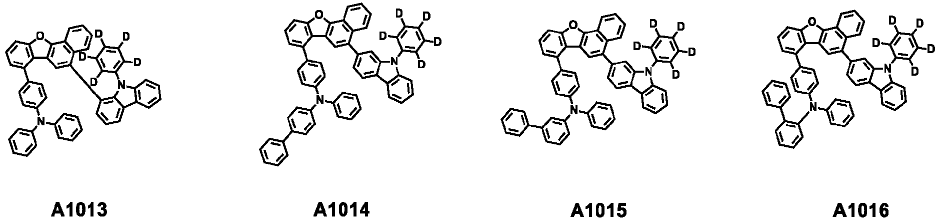

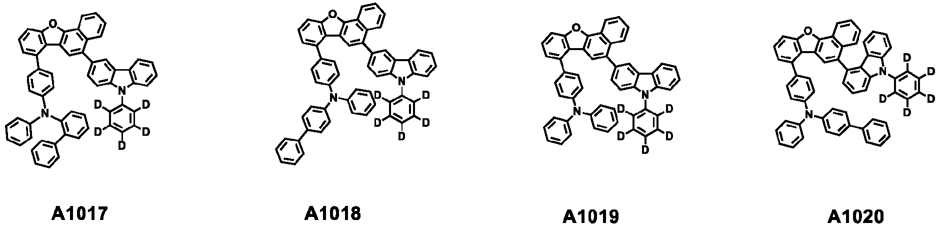

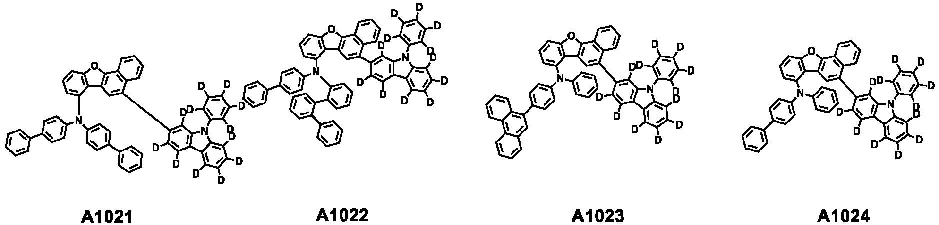

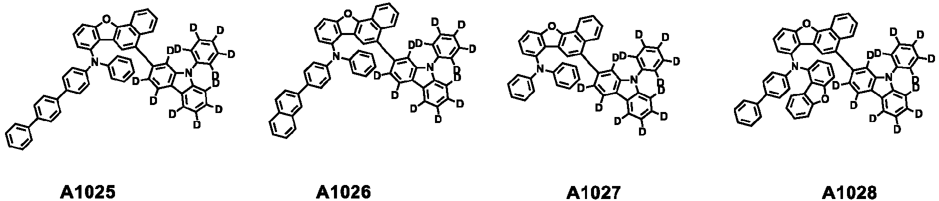

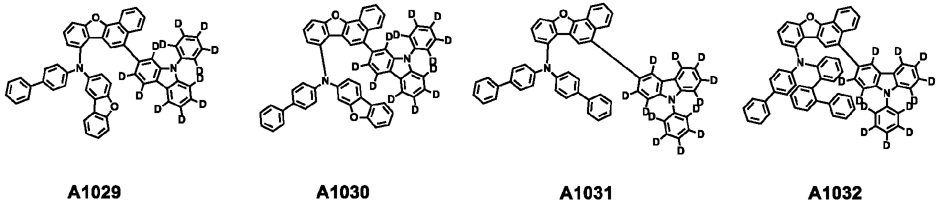

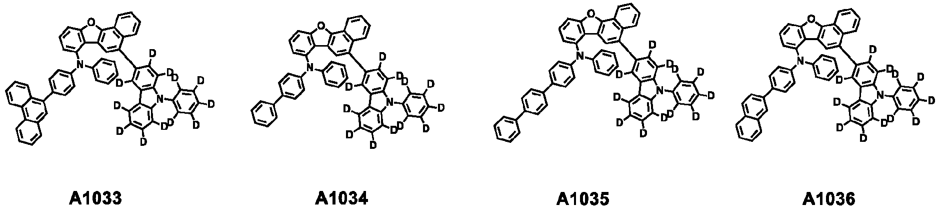

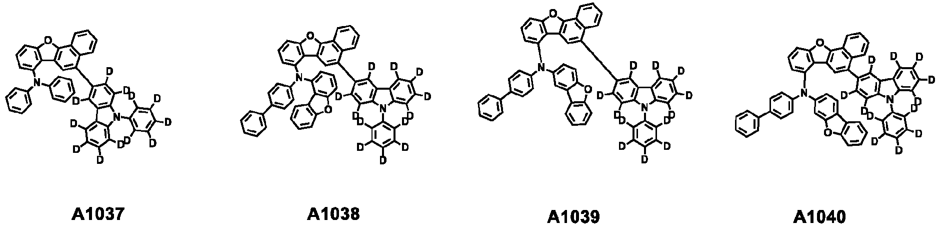

11. The composition of claim 1, wherein Chemical Formula B is represented by any one of the following heterocyclic compounds:

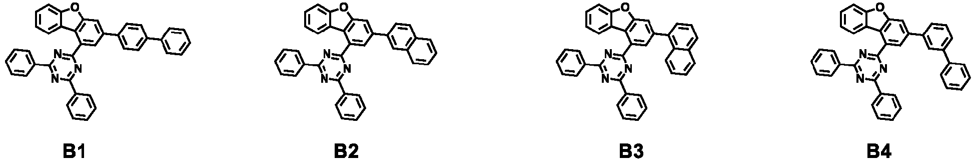

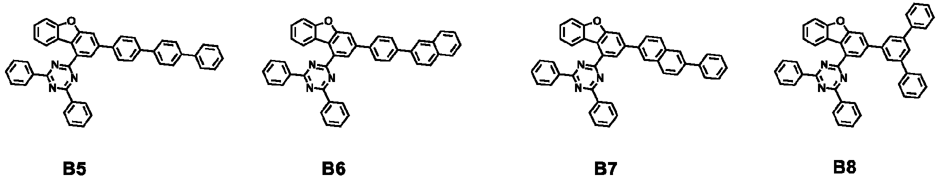

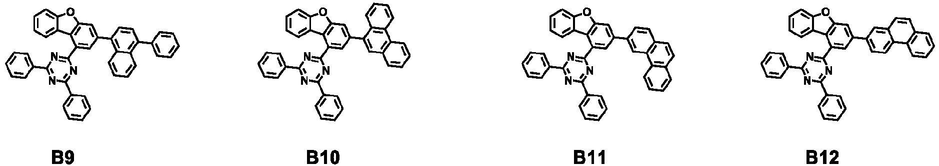

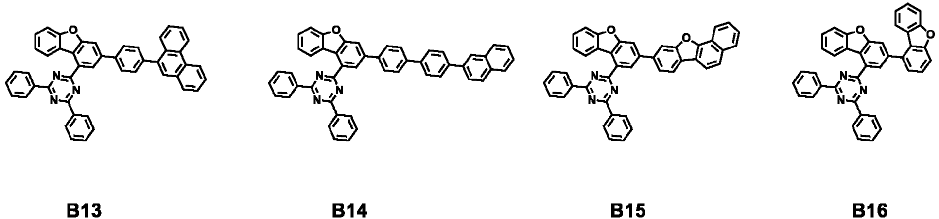

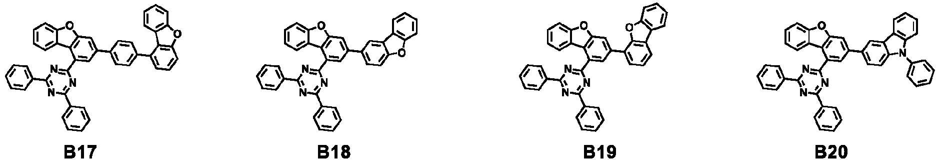

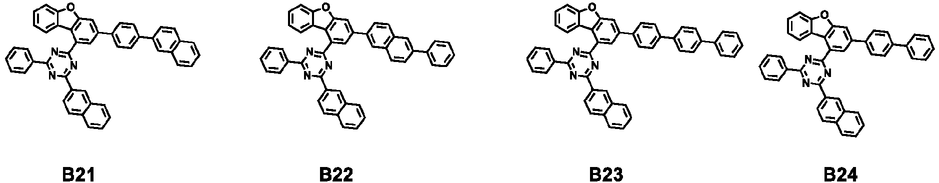

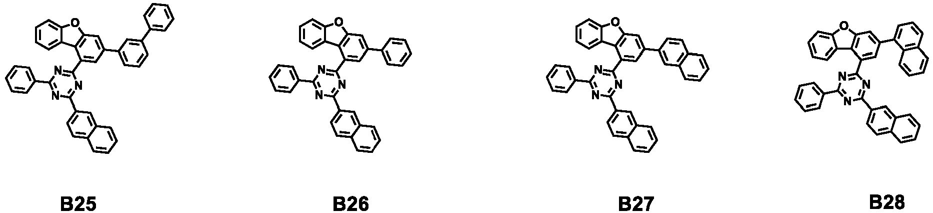

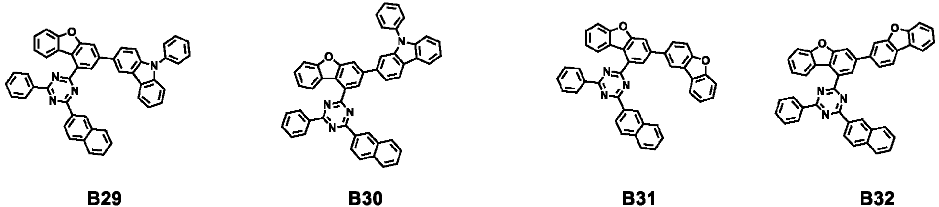

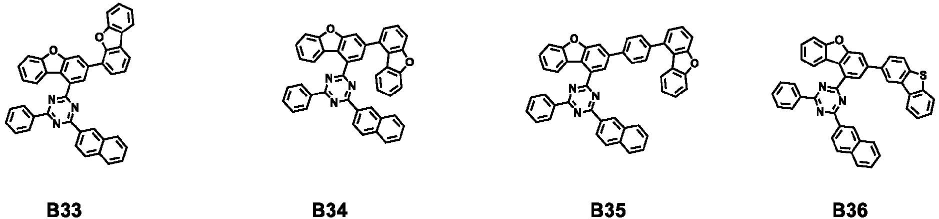

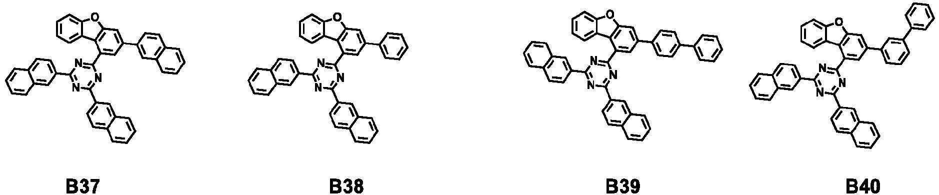

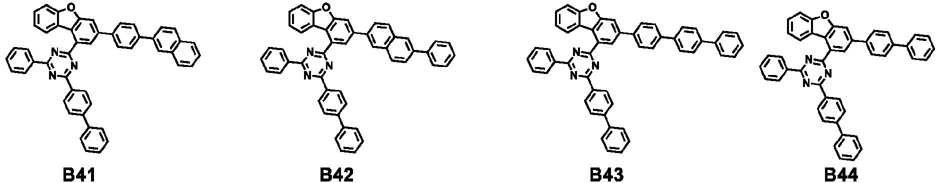

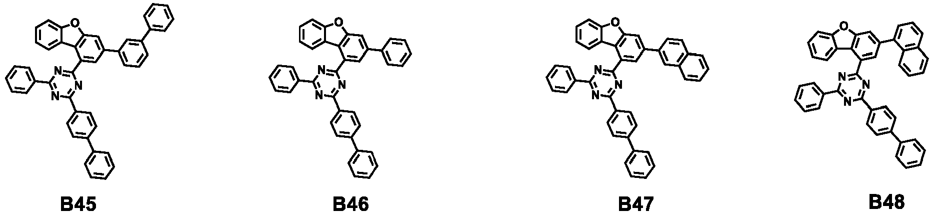

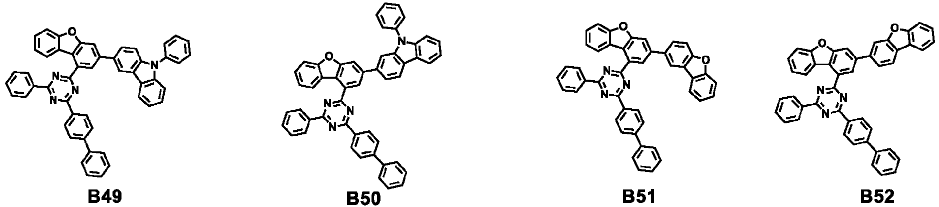

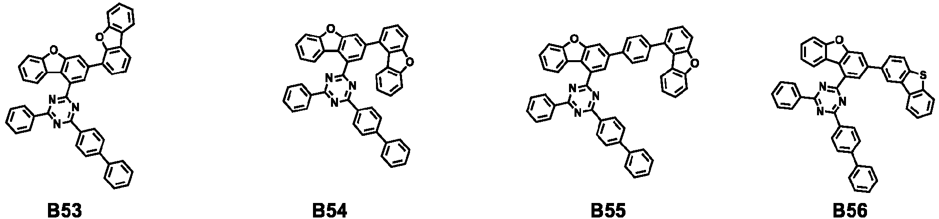

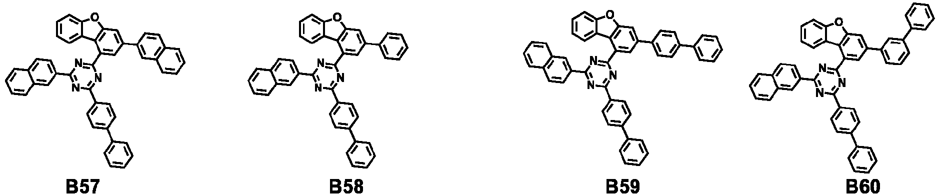

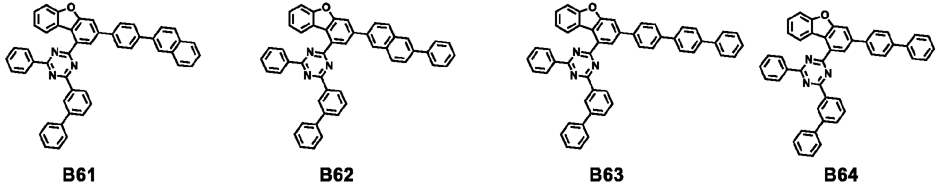

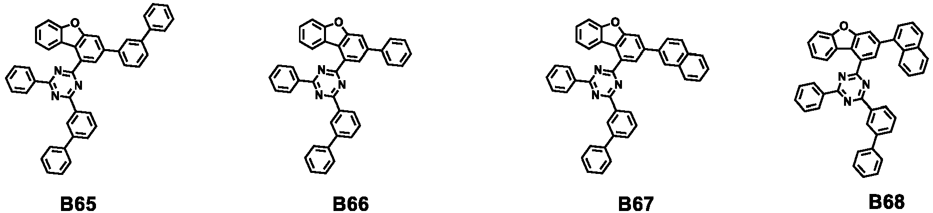

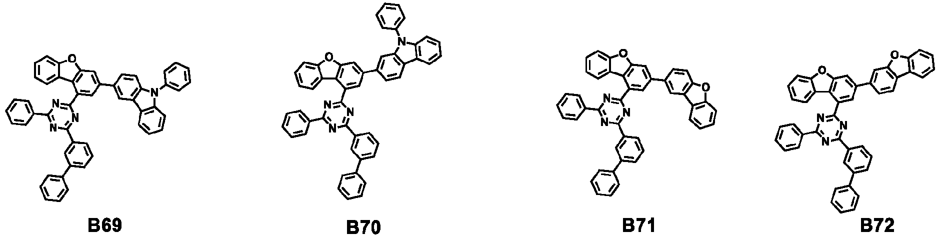

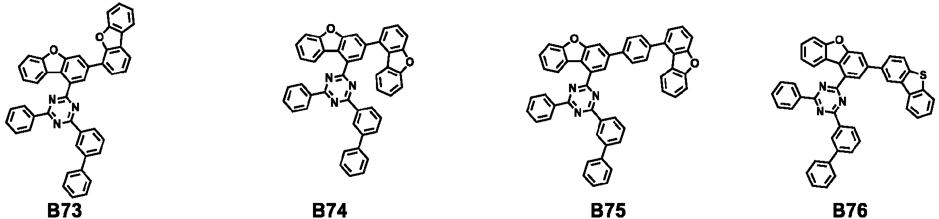

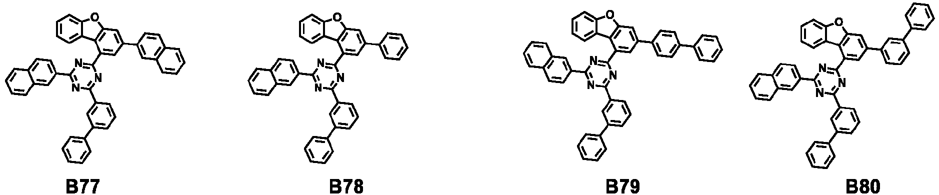

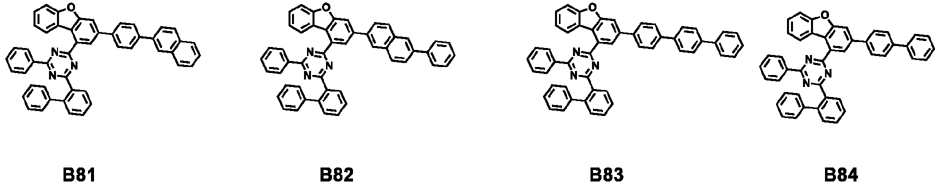

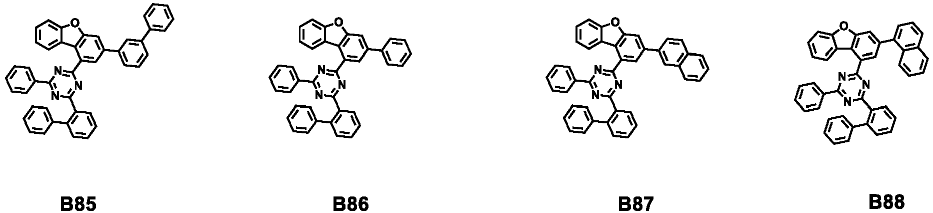

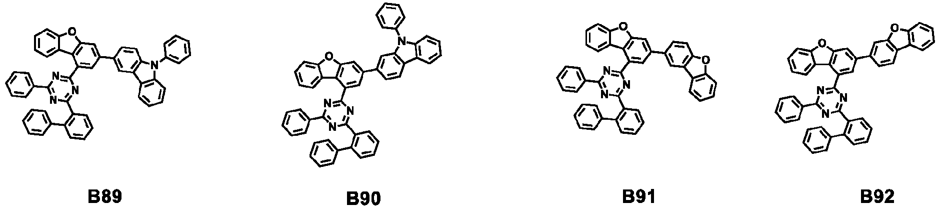

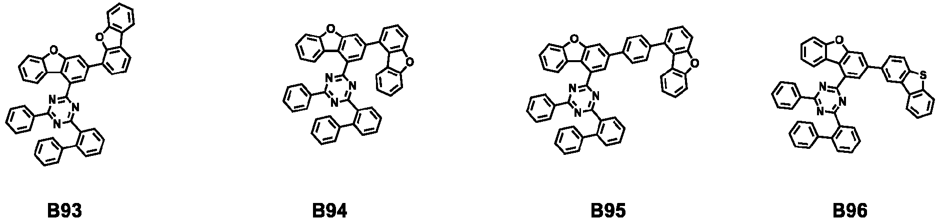

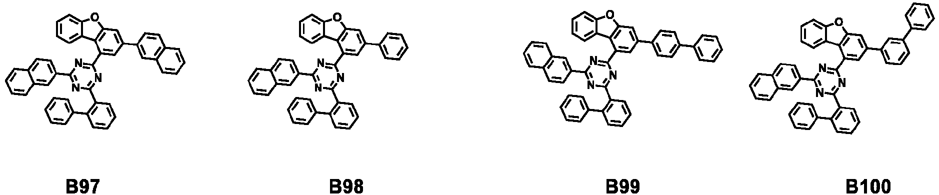

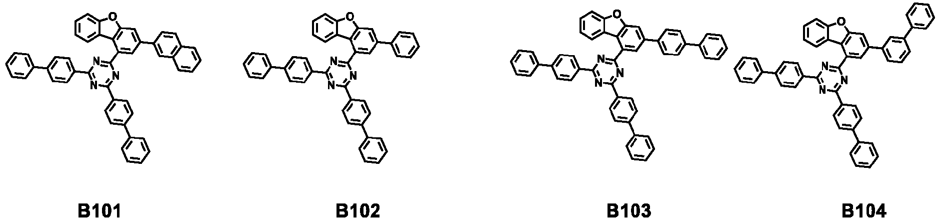

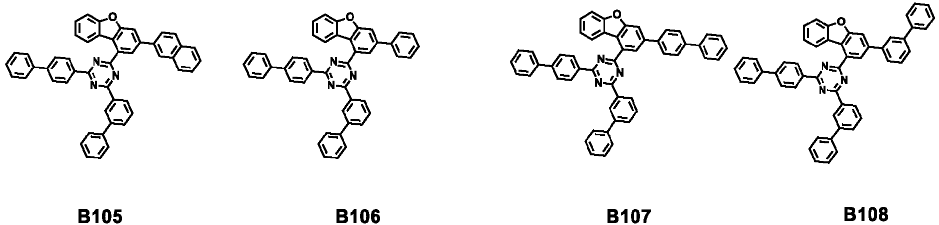

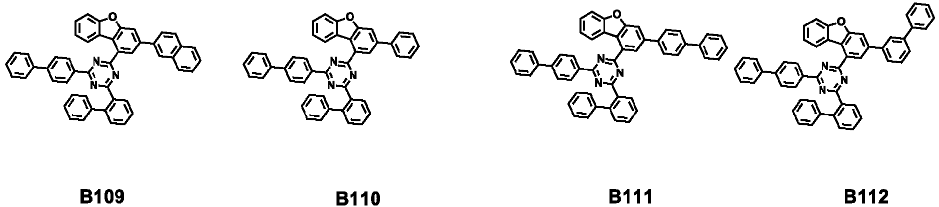

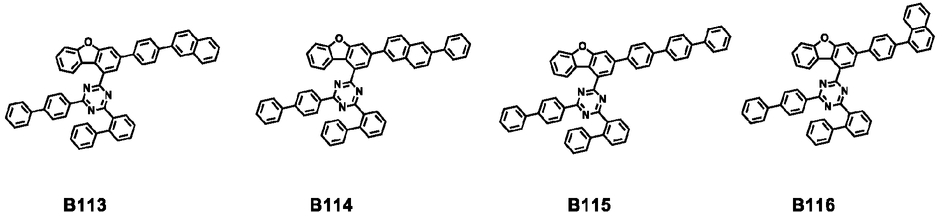

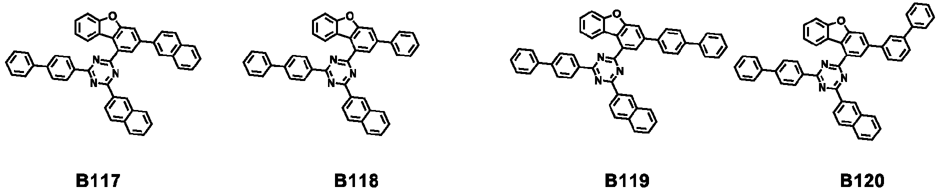

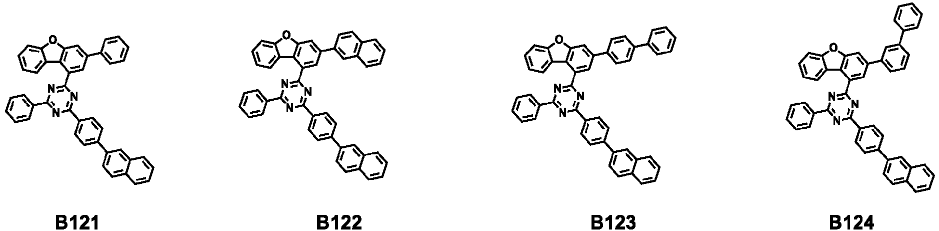

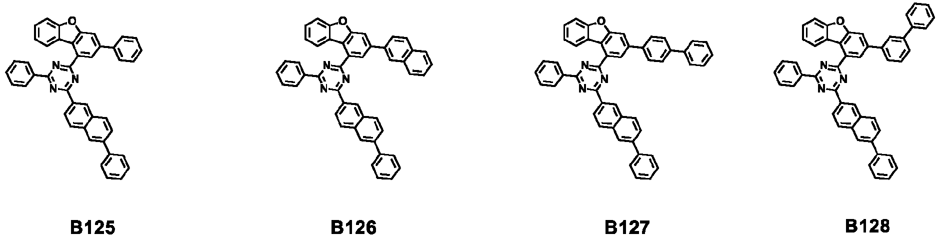

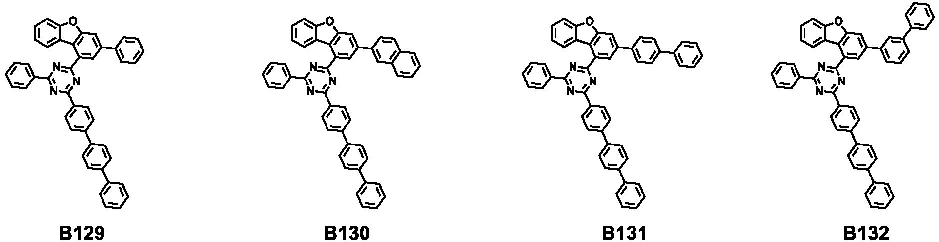

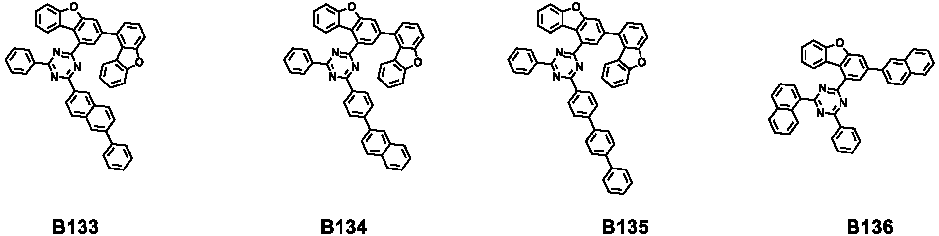

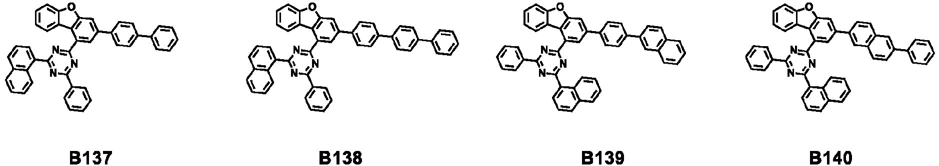

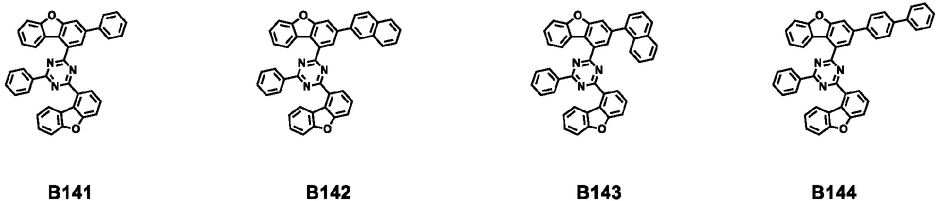

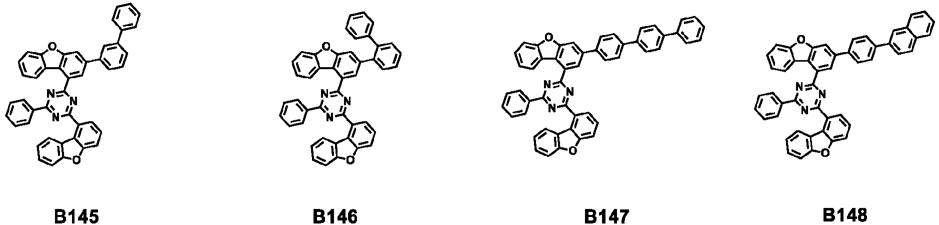

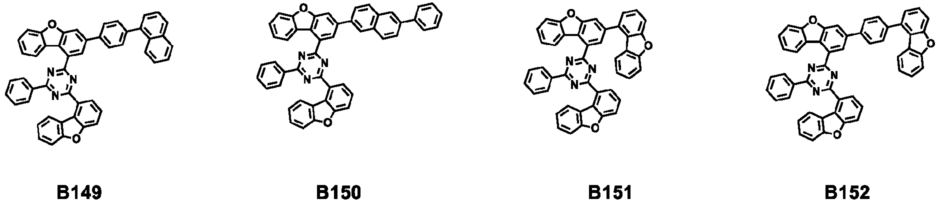

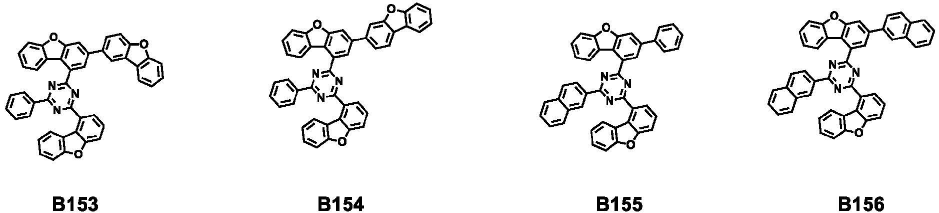

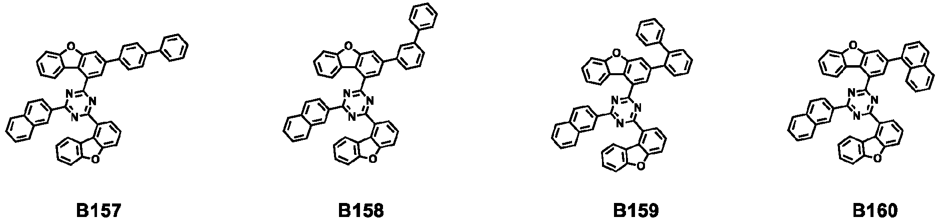

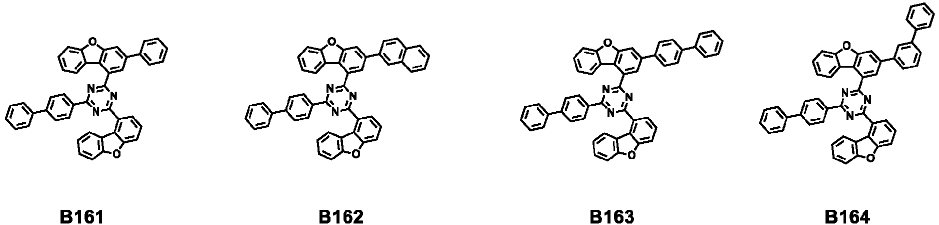

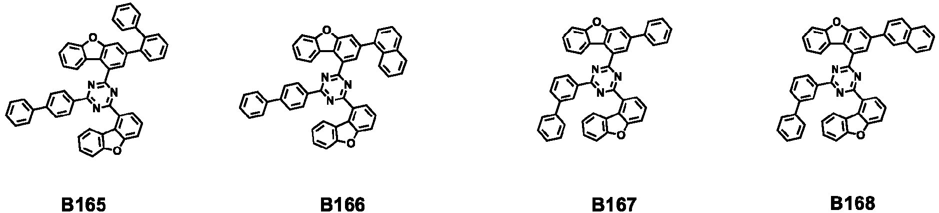

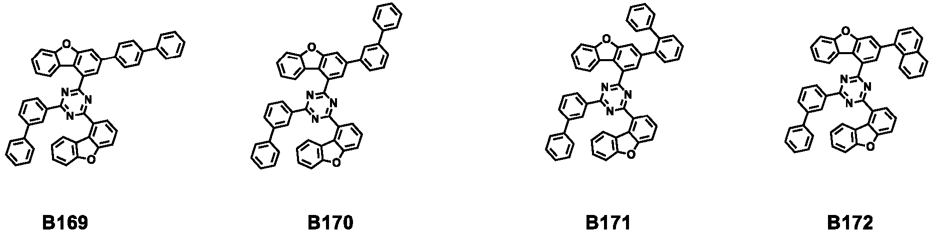

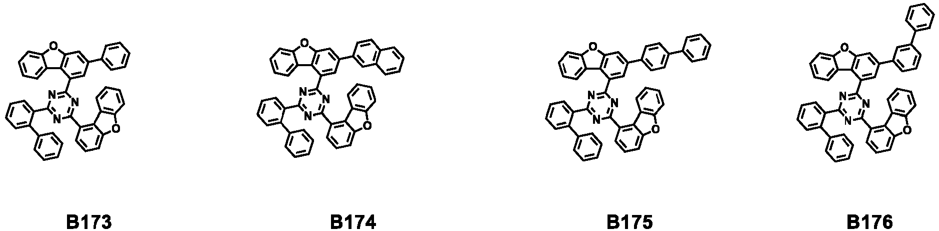

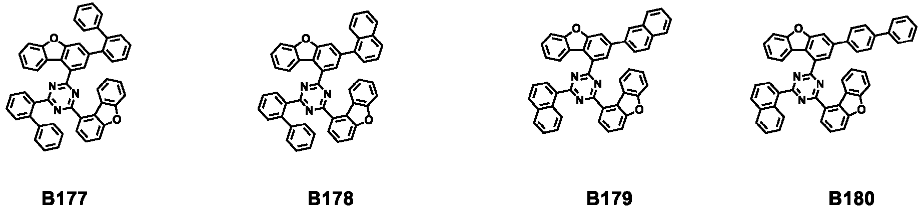

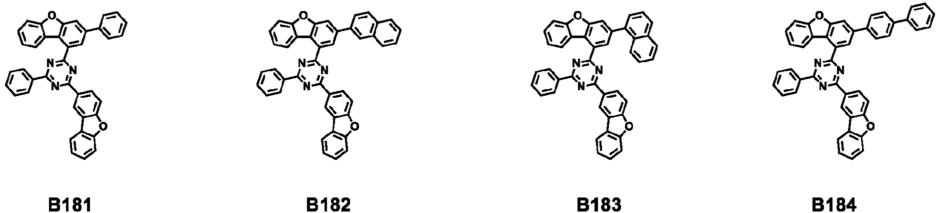

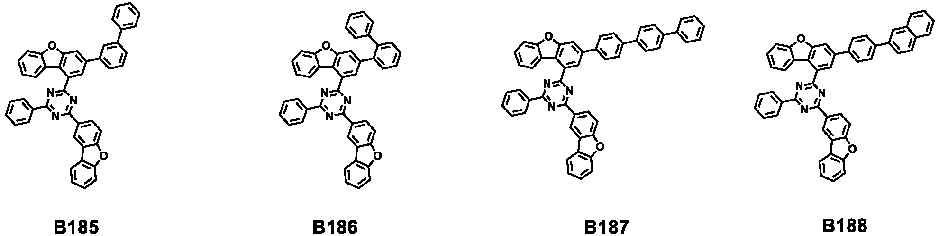

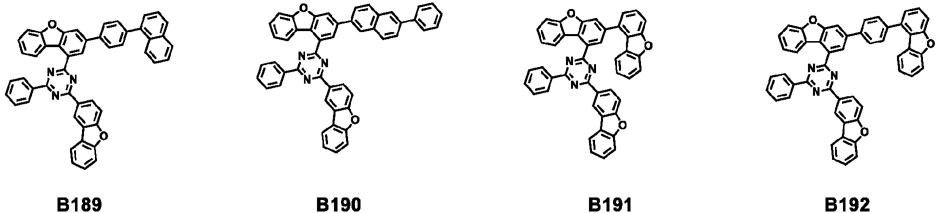

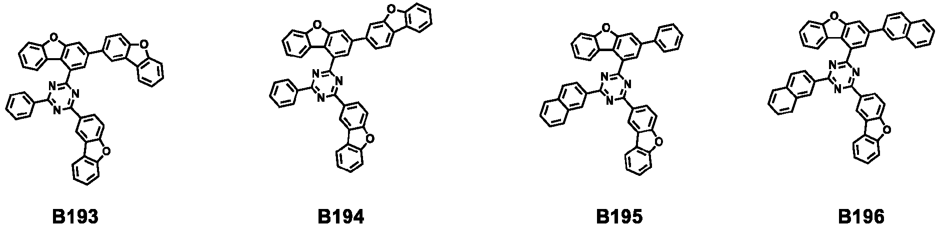

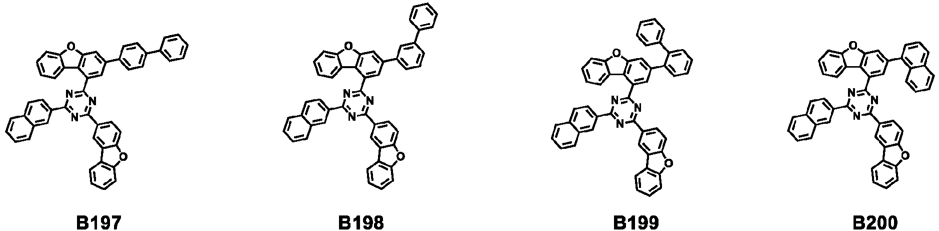

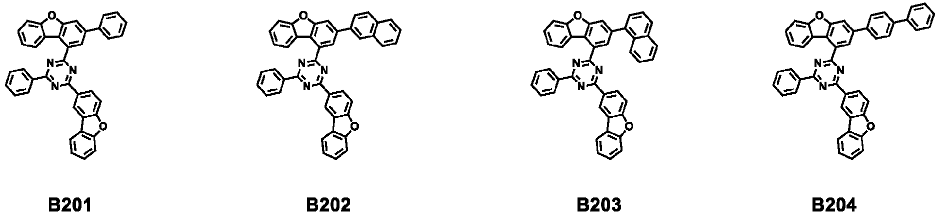

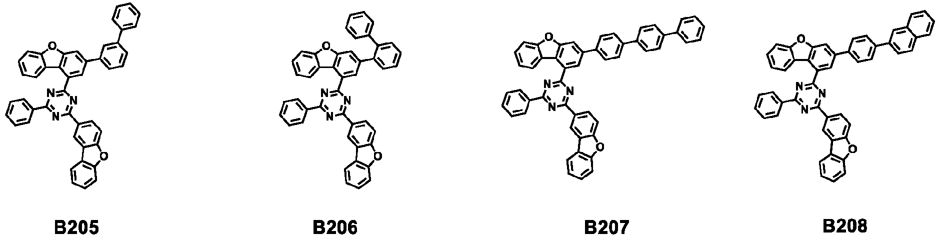

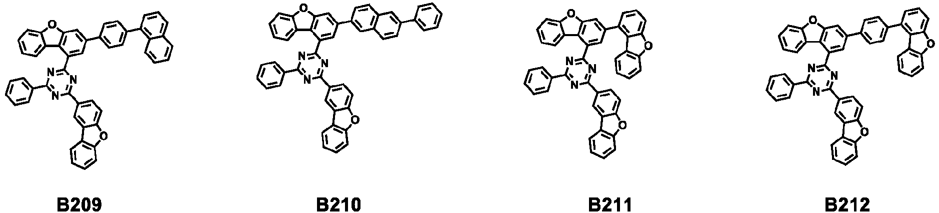

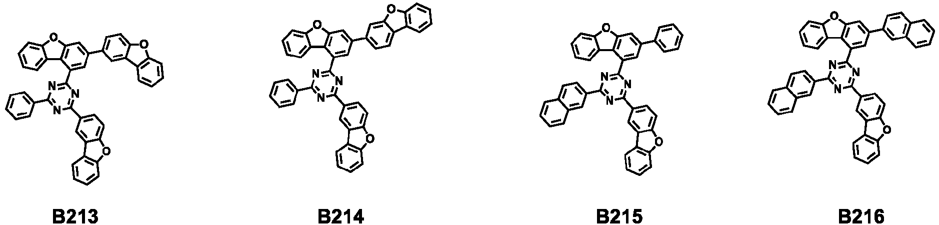

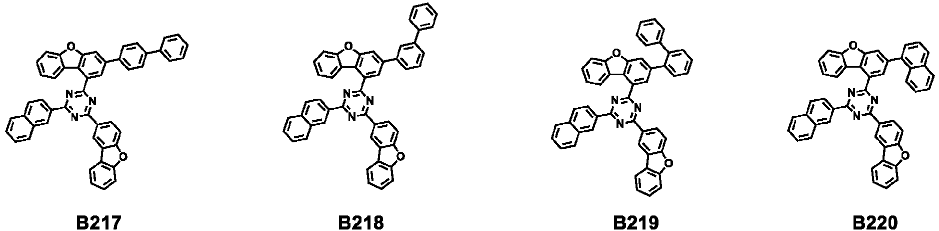

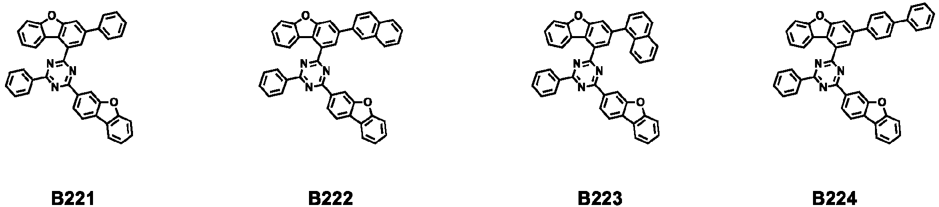

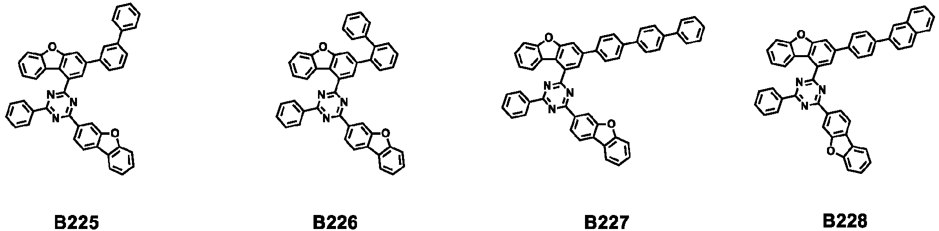

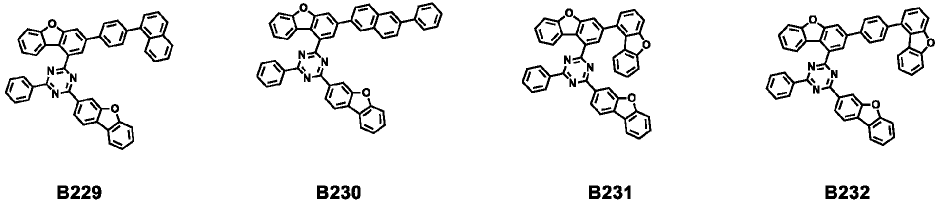

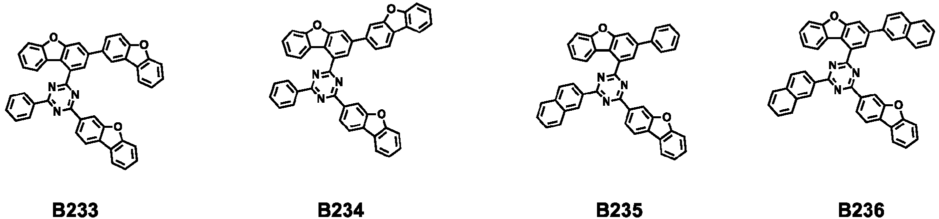

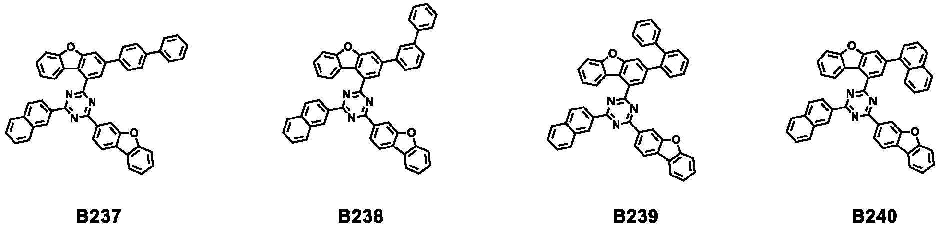

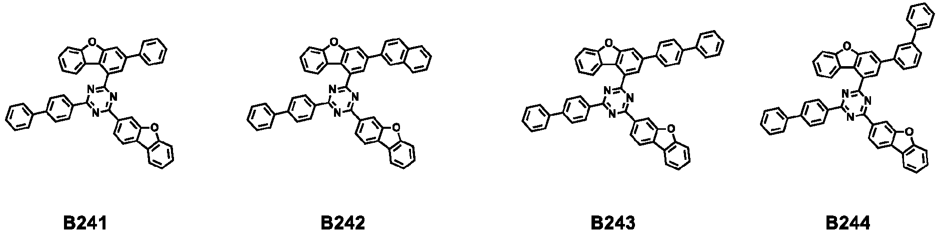

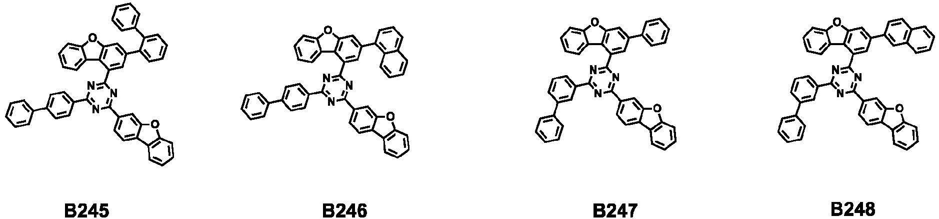

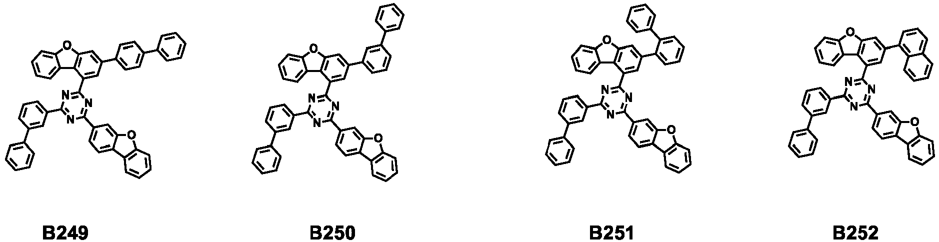

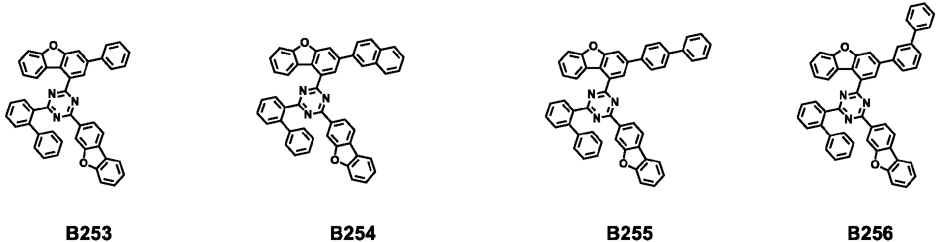

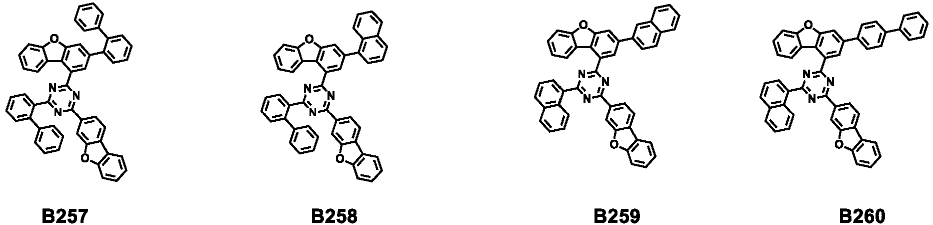

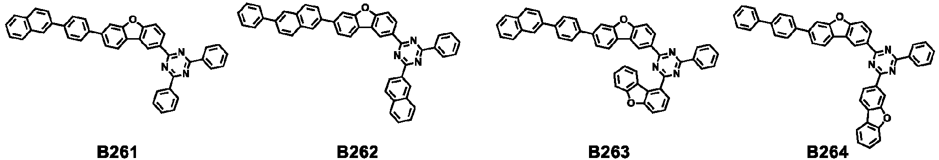

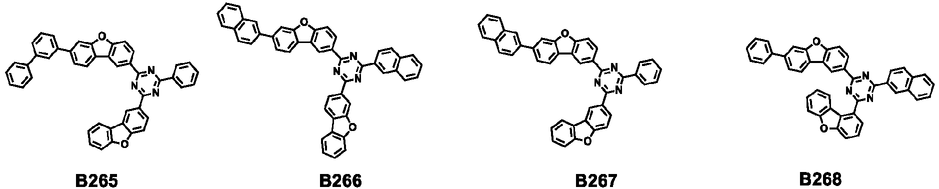

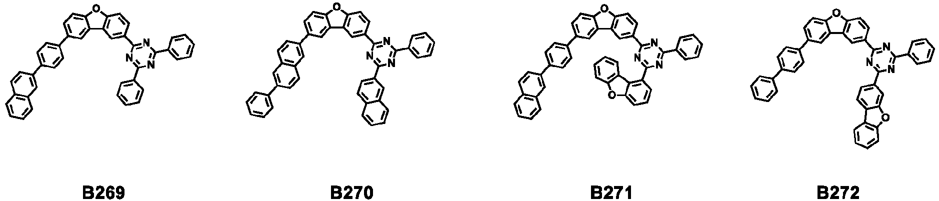

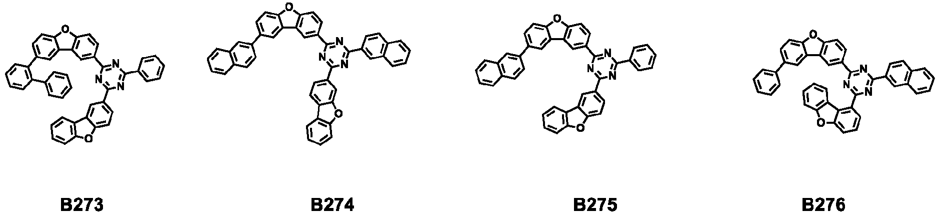

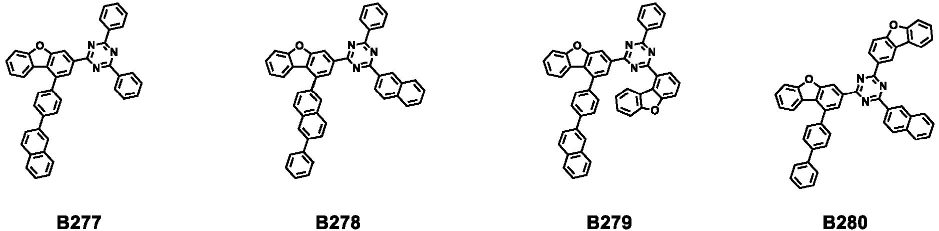

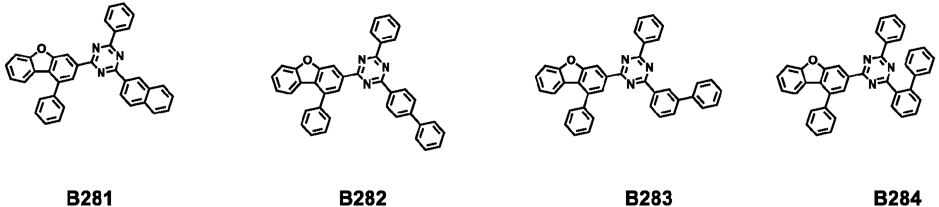

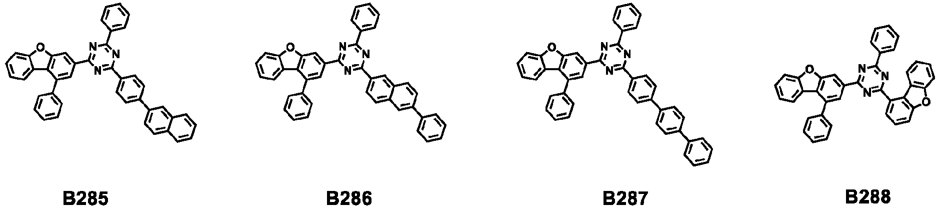

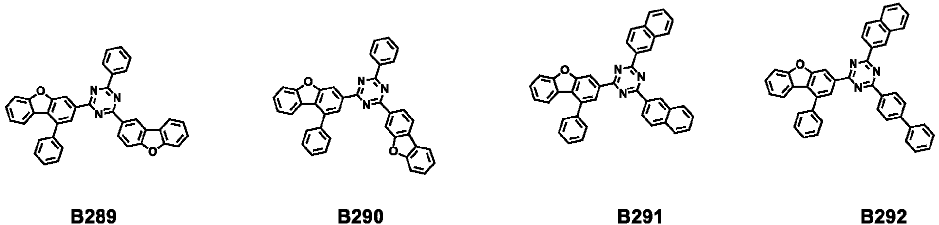

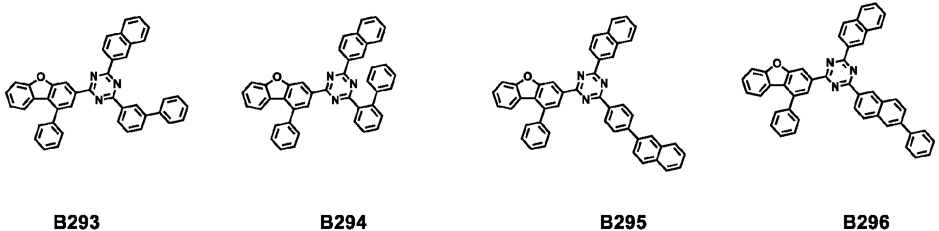

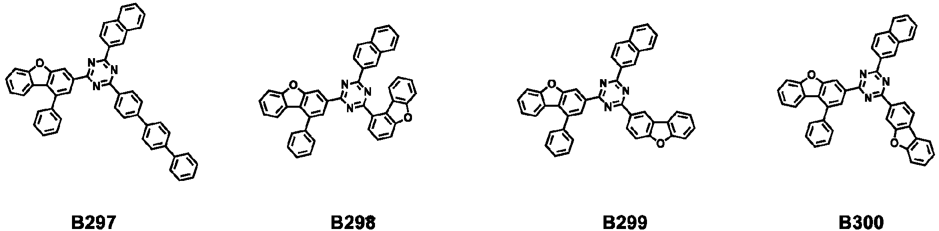

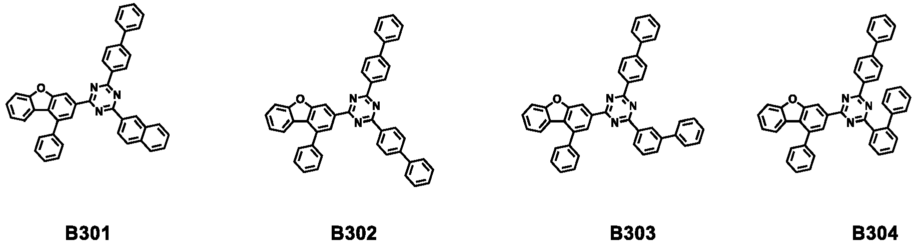

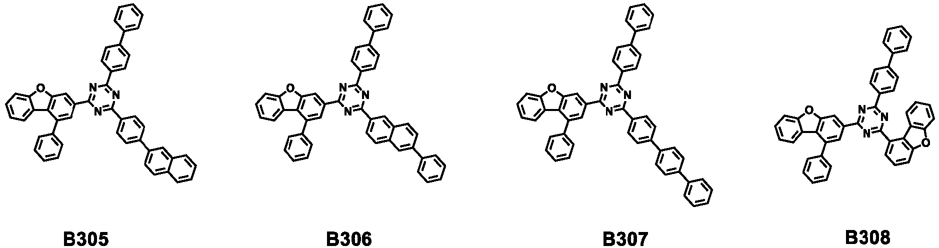

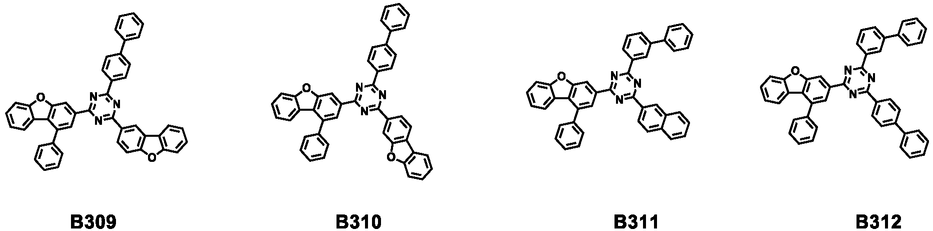

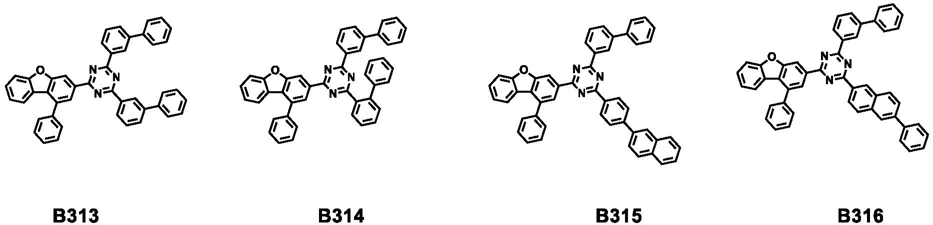

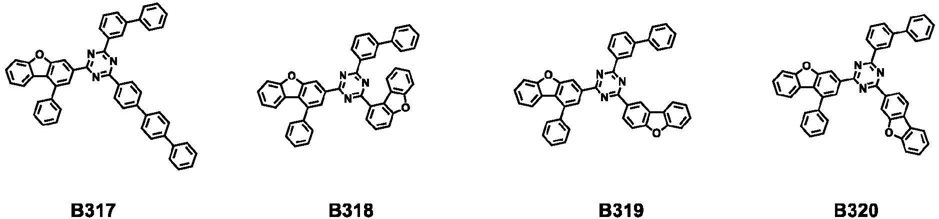

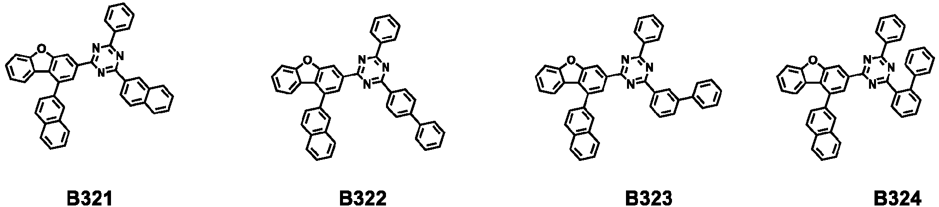

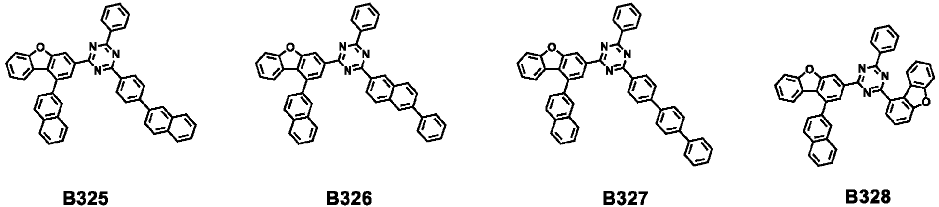

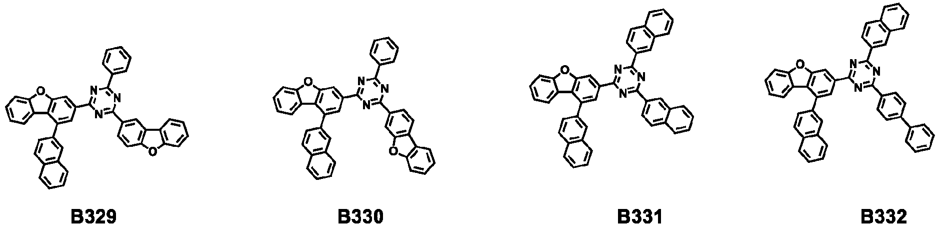

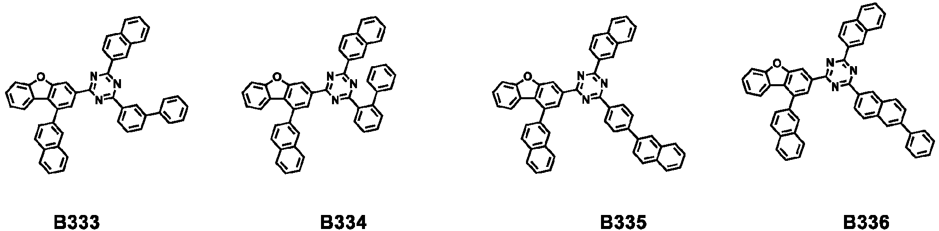

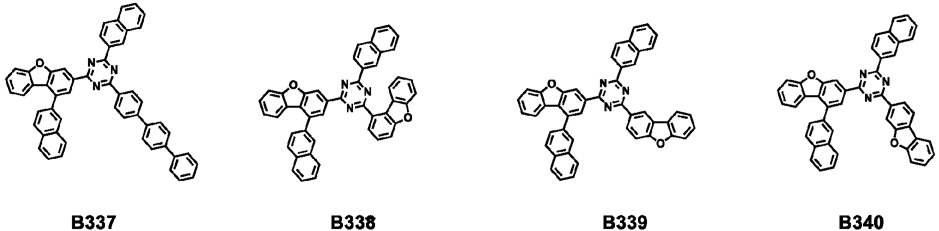

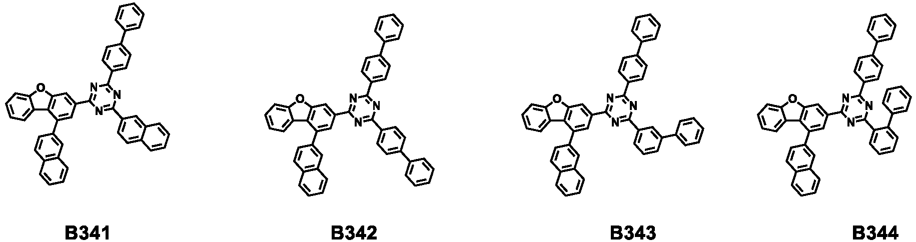

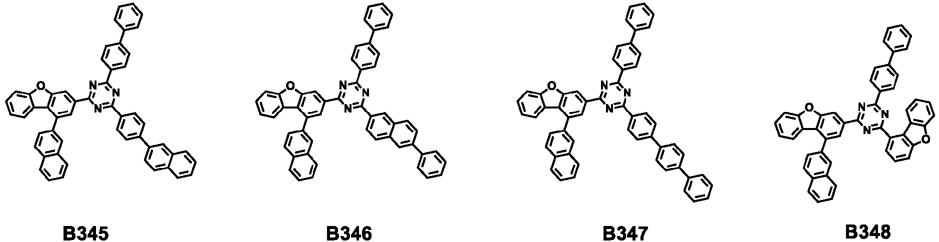

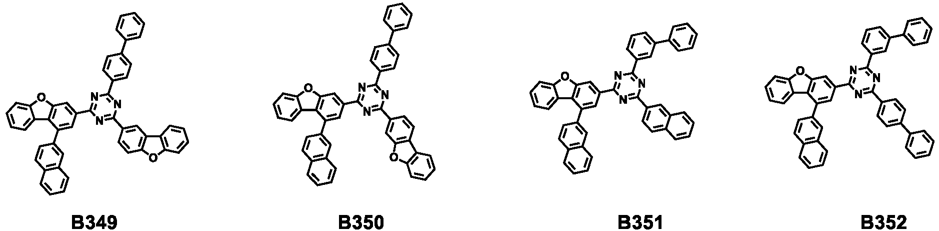

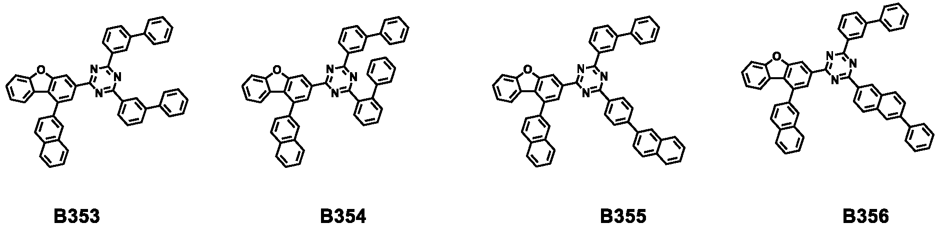

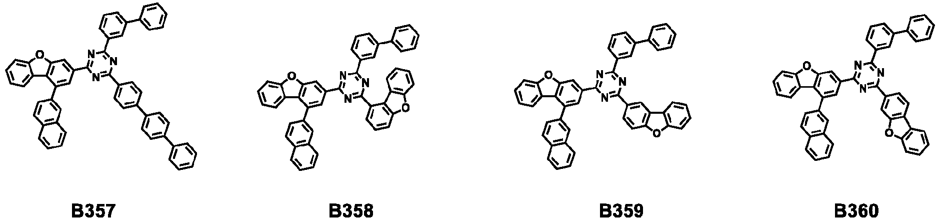

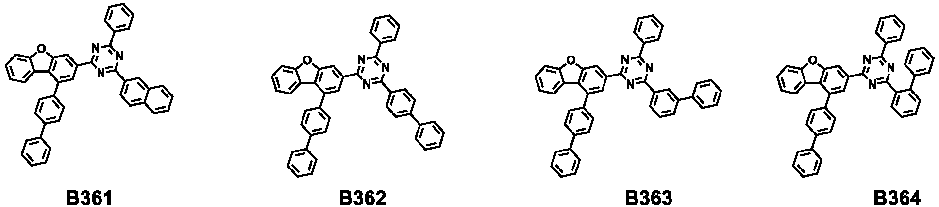

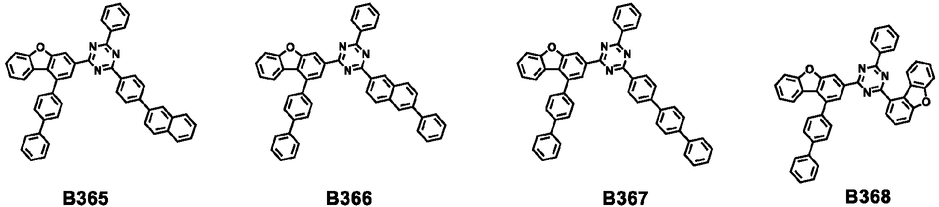

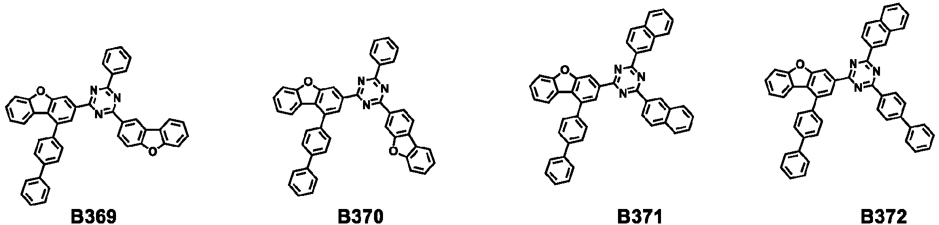

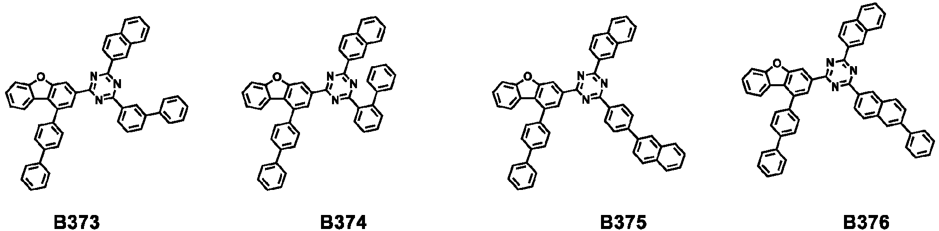

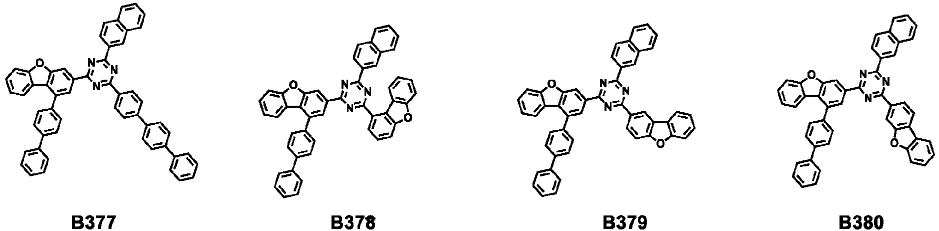

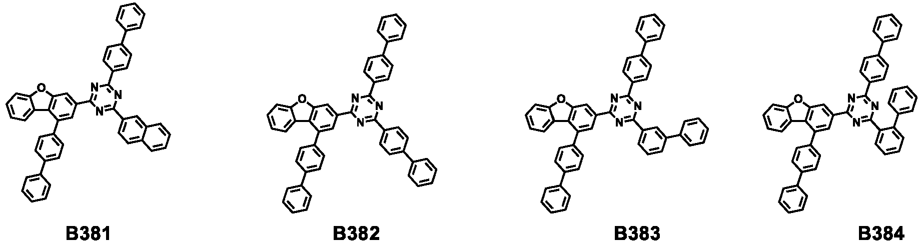

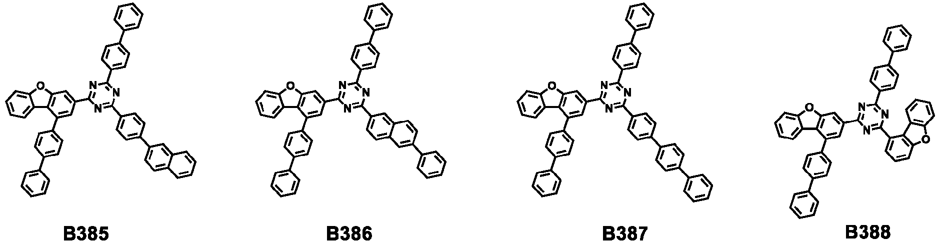

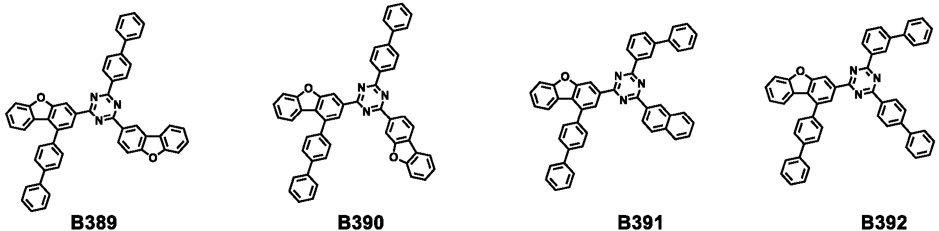

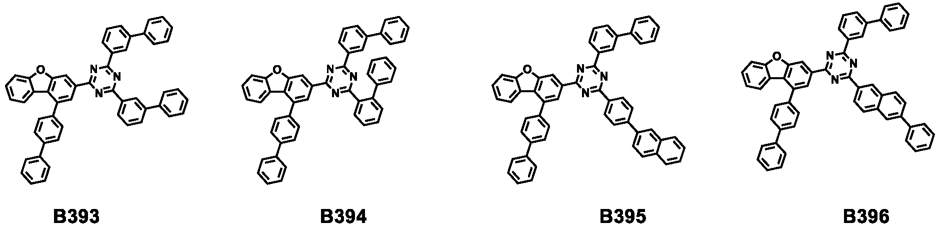

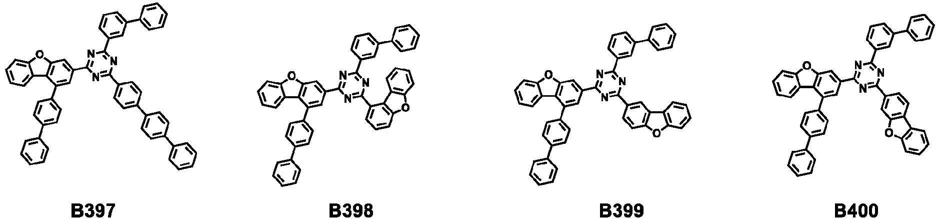

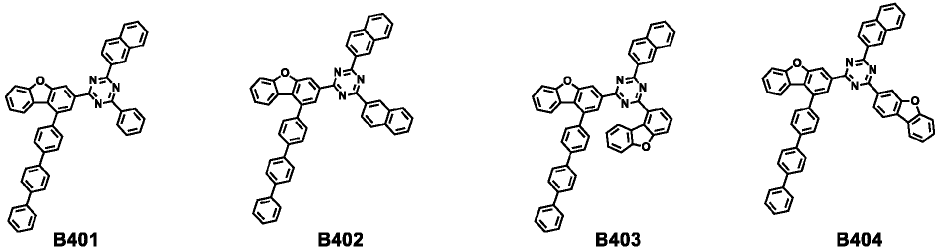

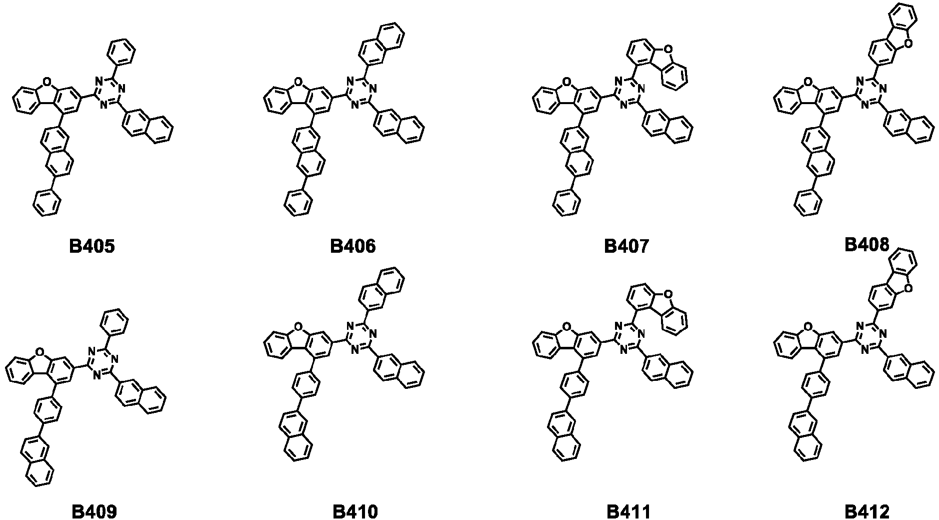

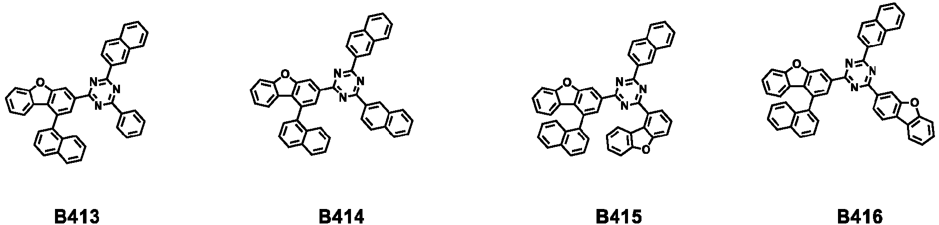

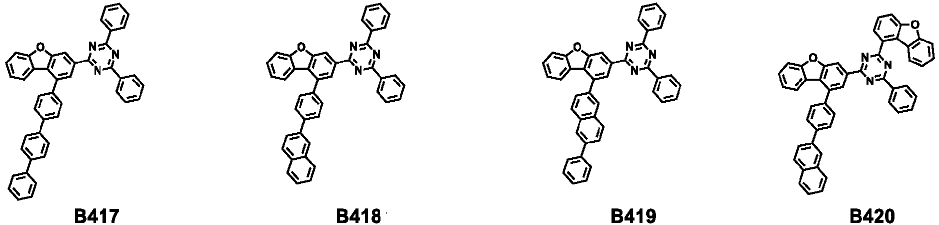

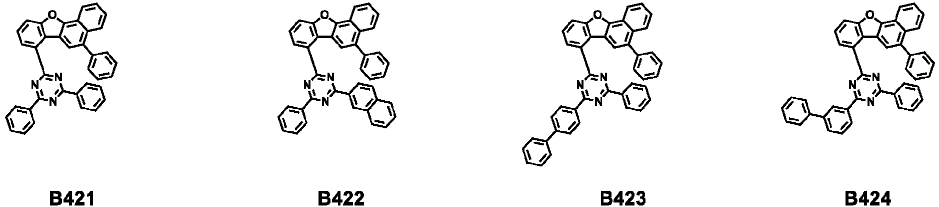

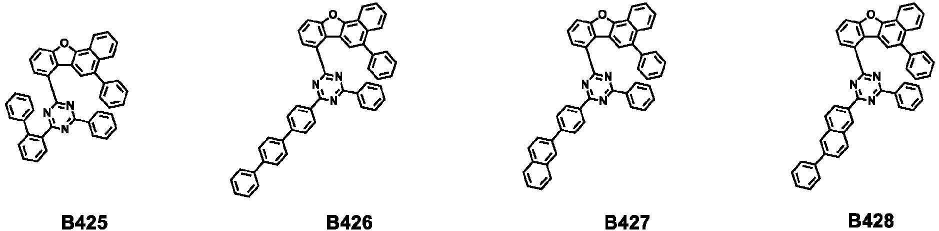

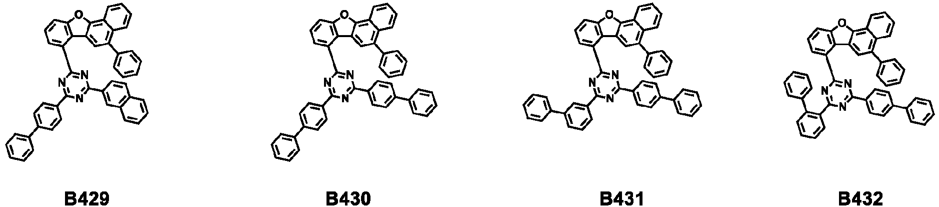

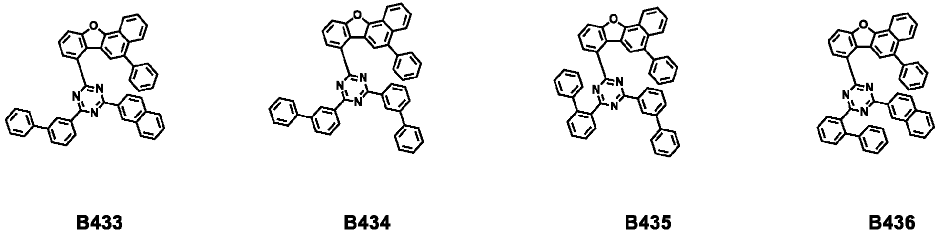

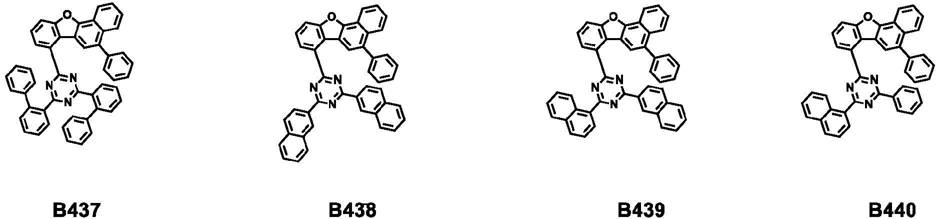

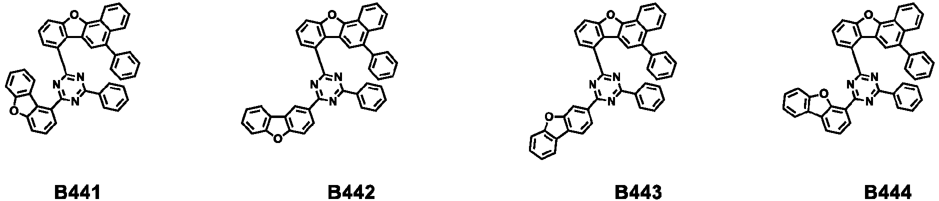

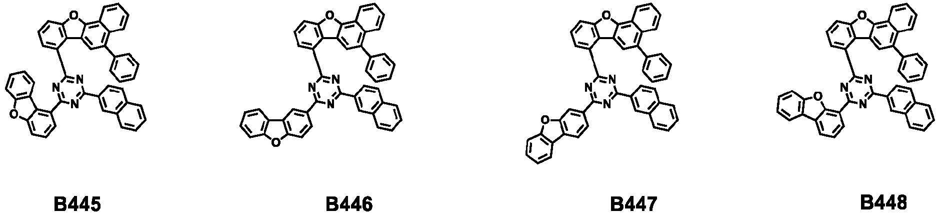

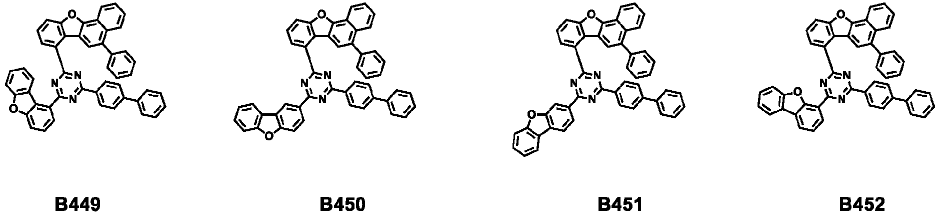

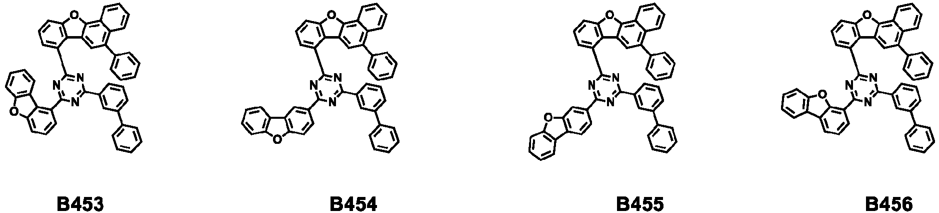

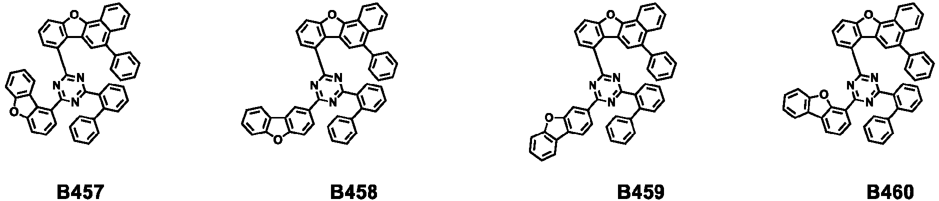

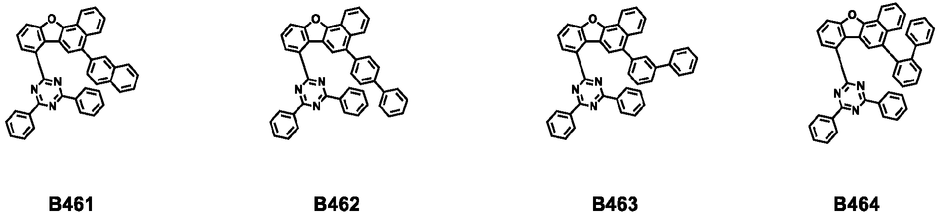

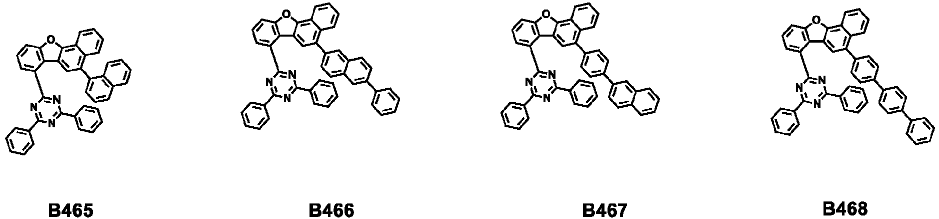

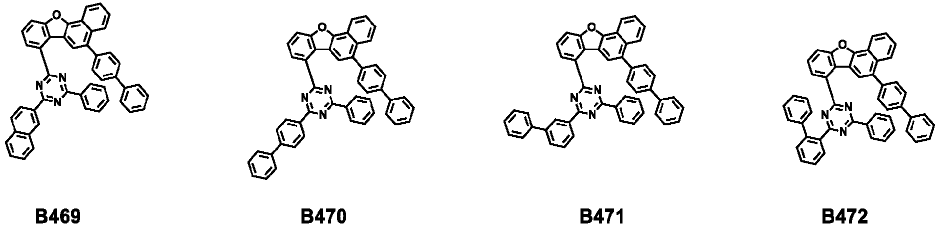

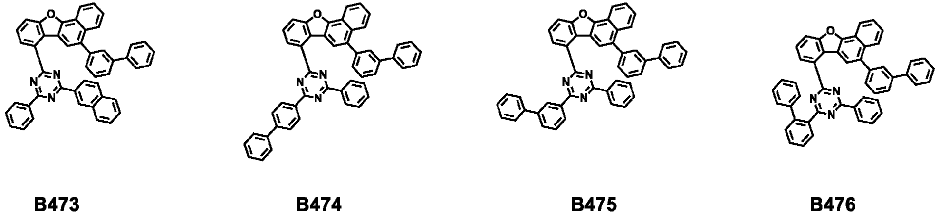

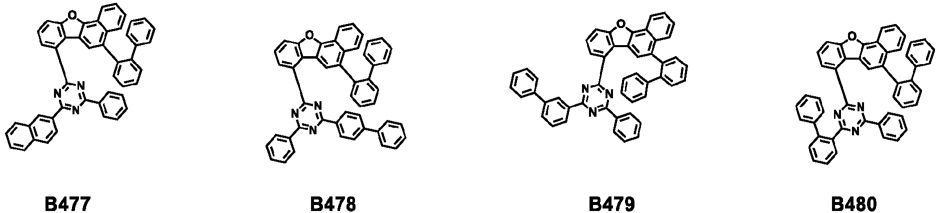

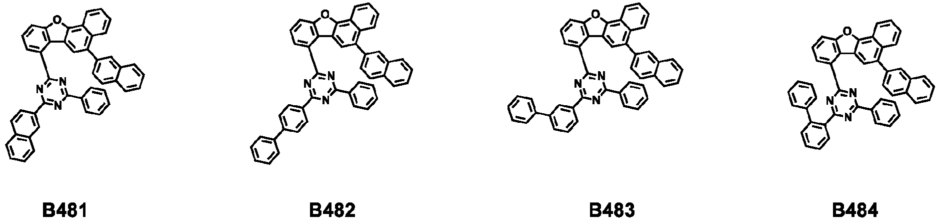

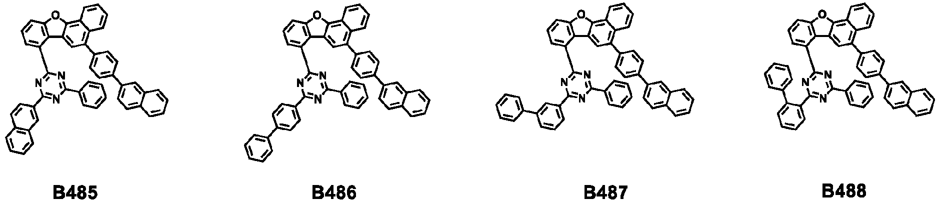

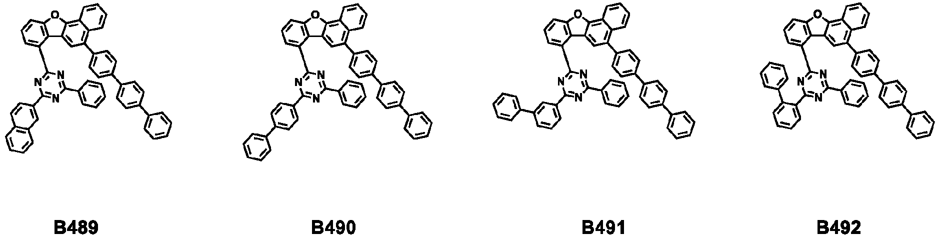

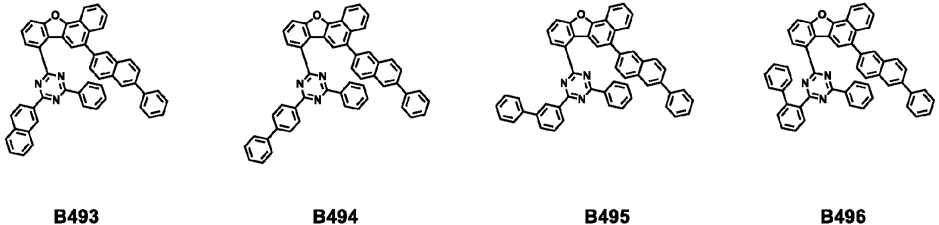

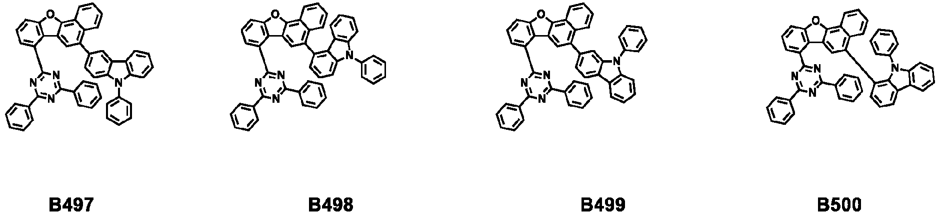

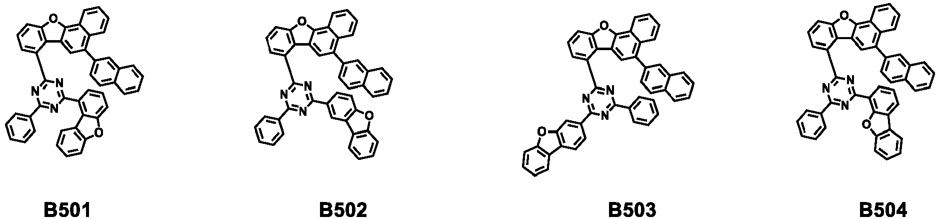

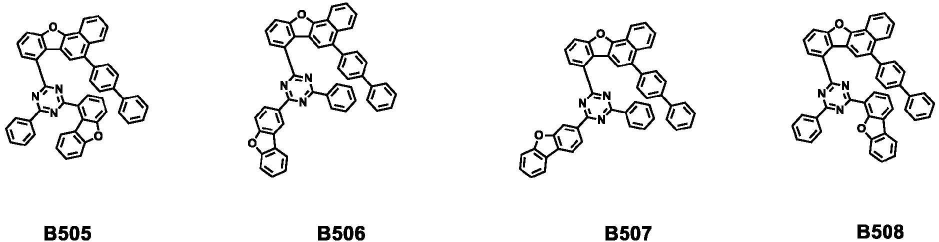

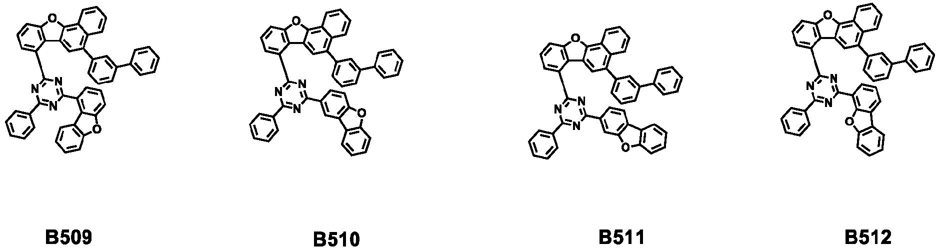

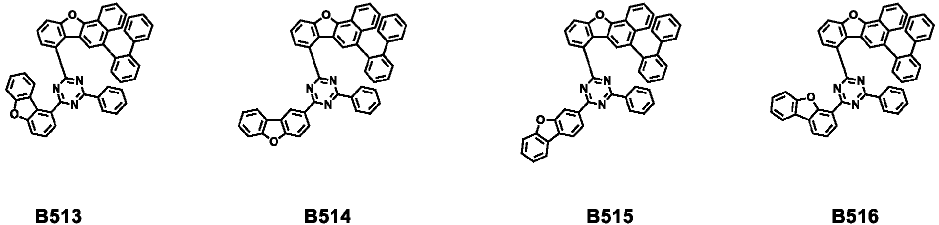

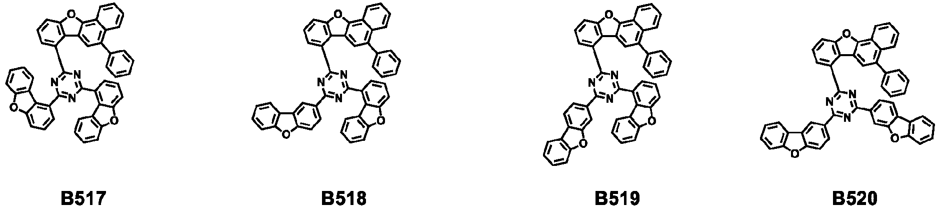

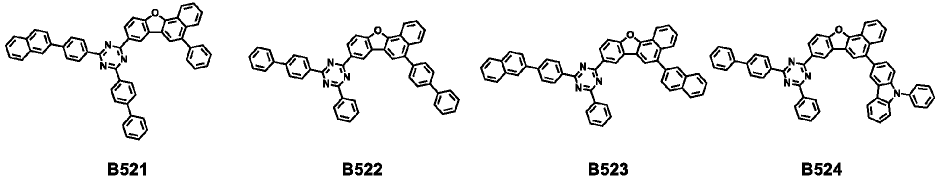

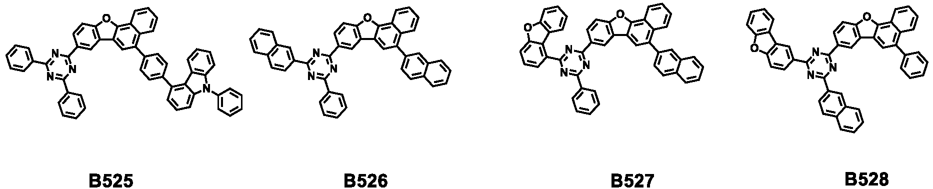

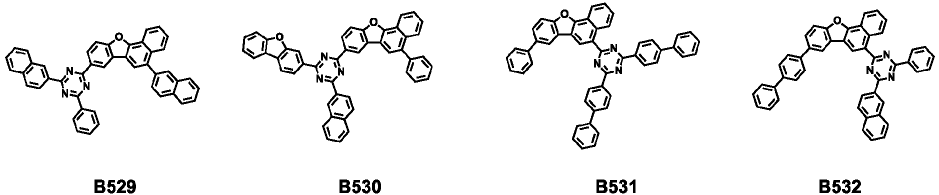

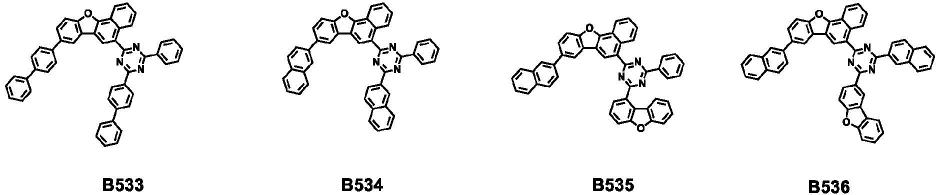

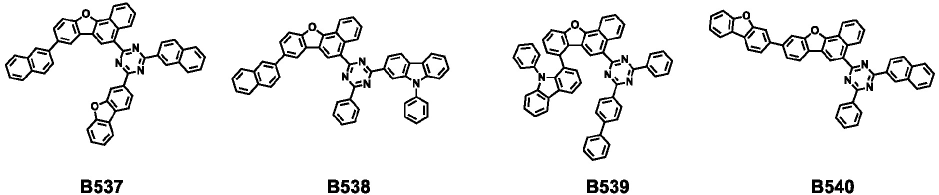

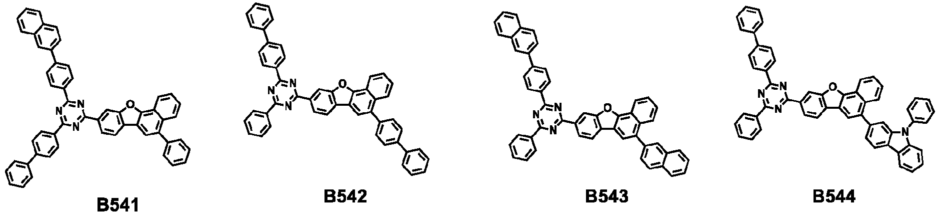

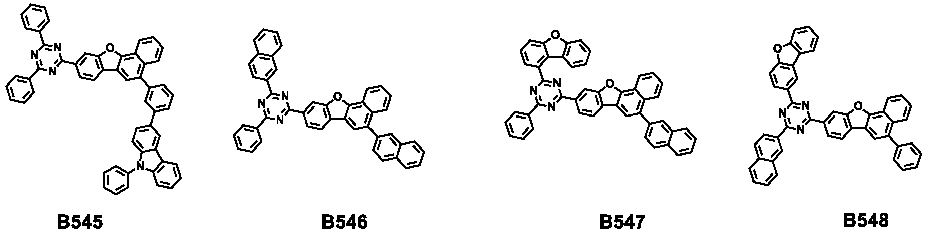

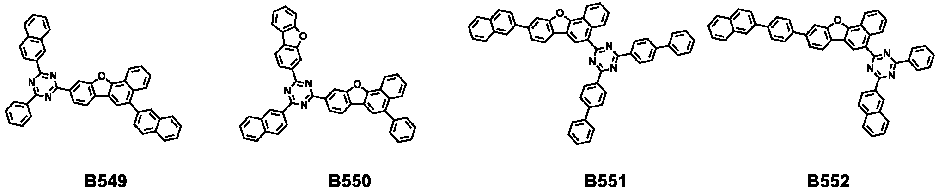

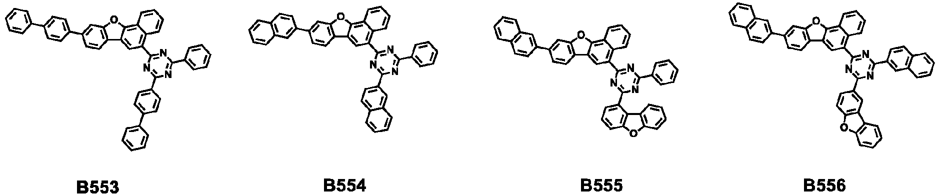

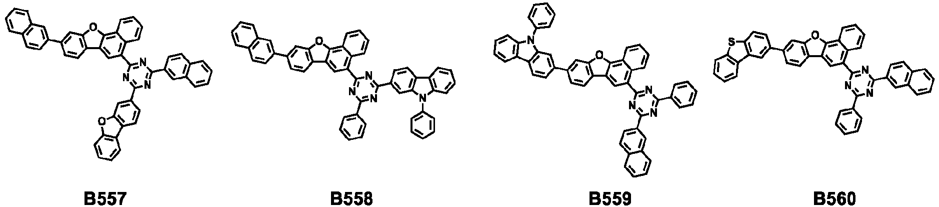

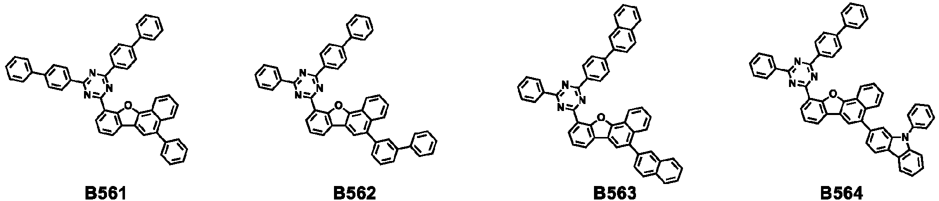

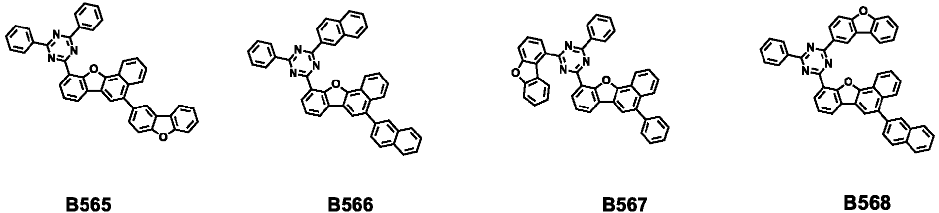

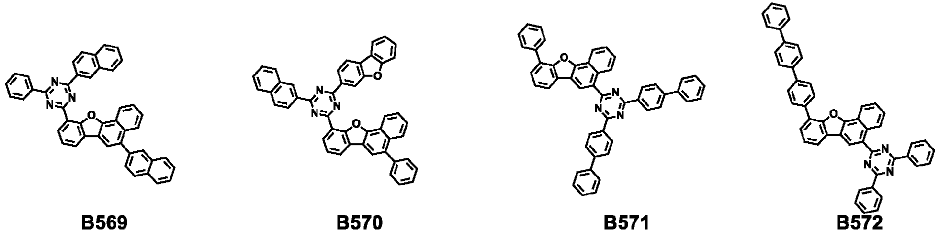

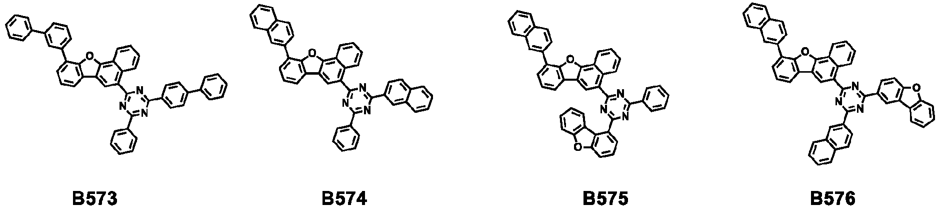

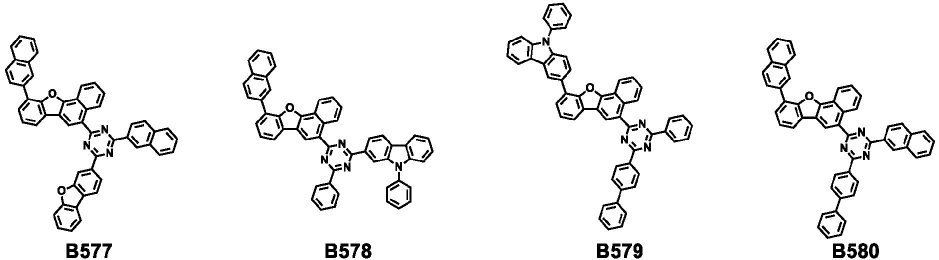

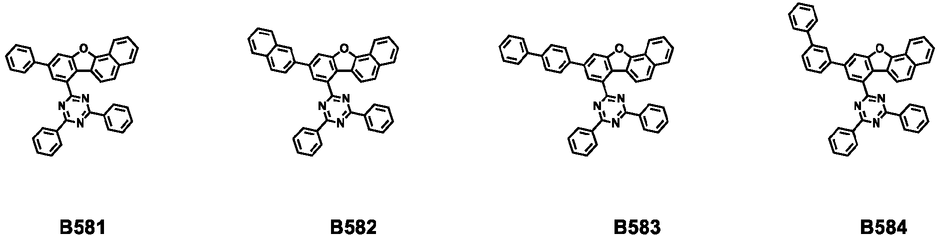

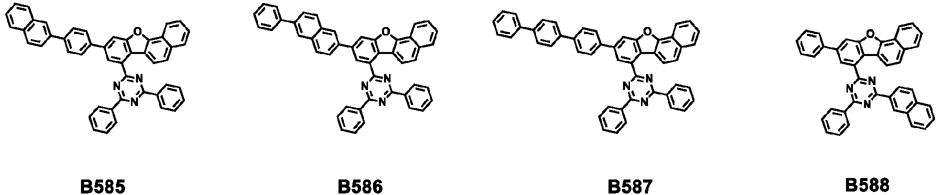

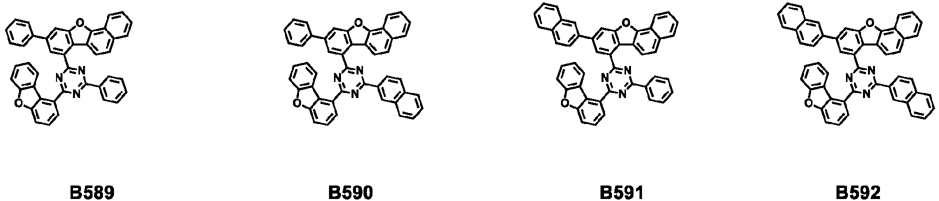

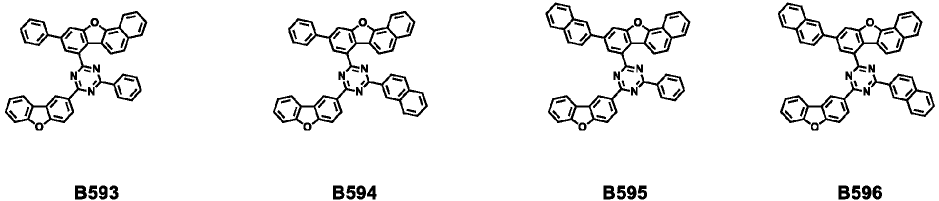

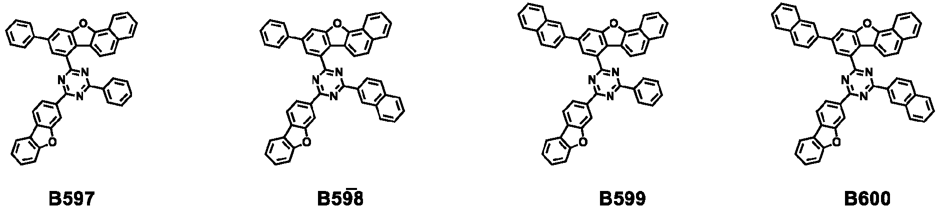

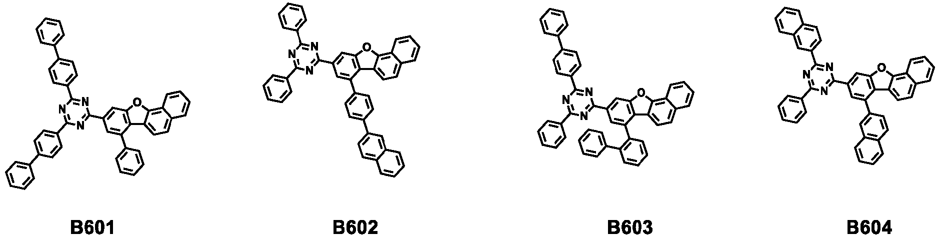

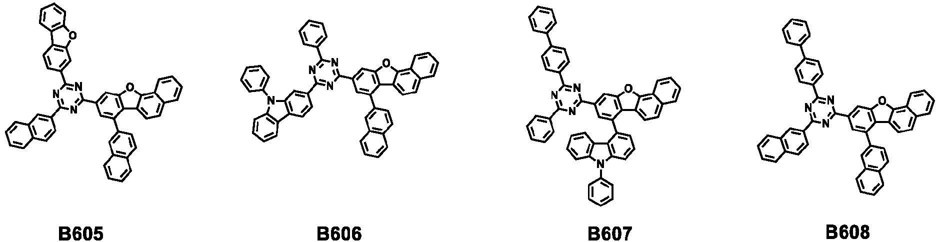

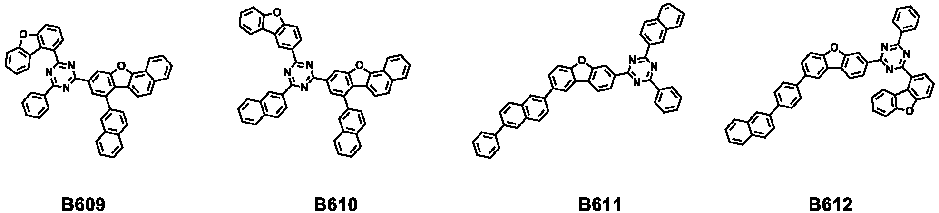

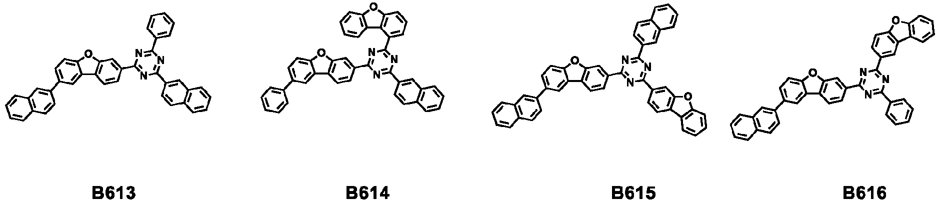

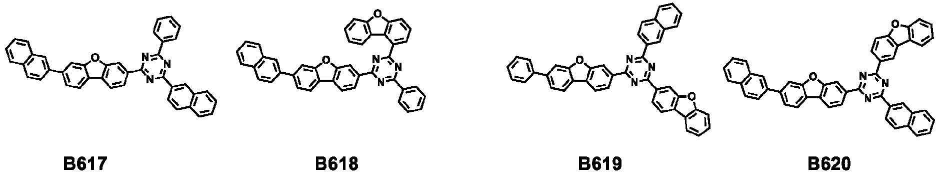

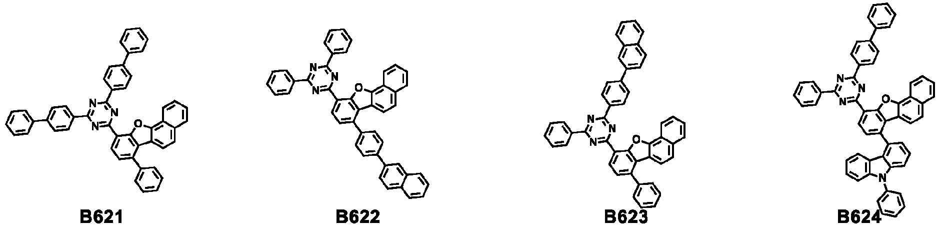

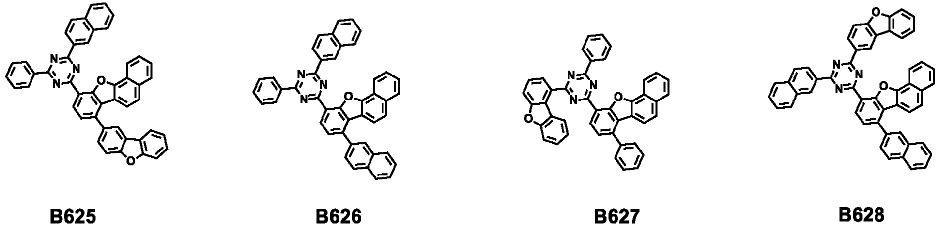

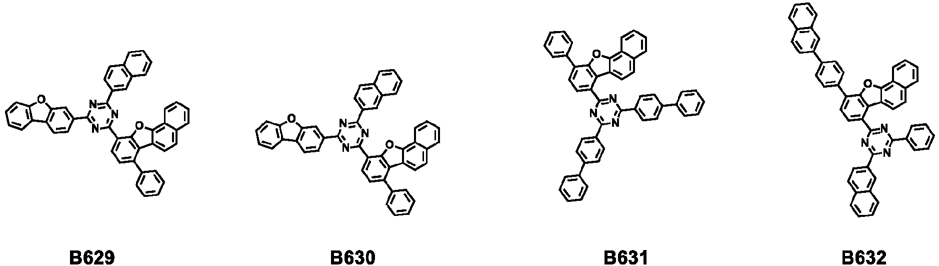

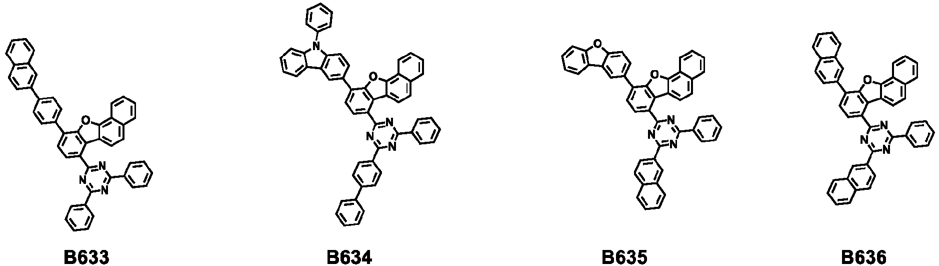

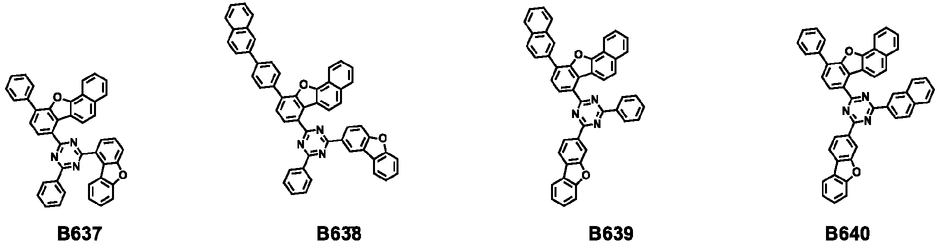

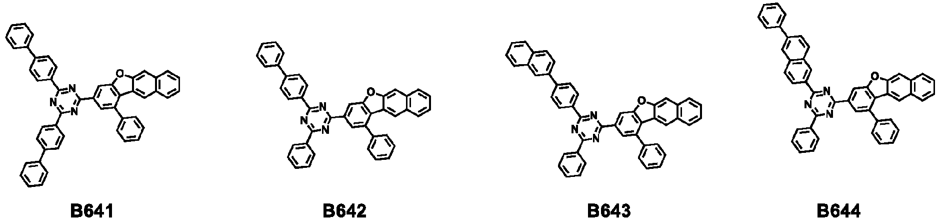

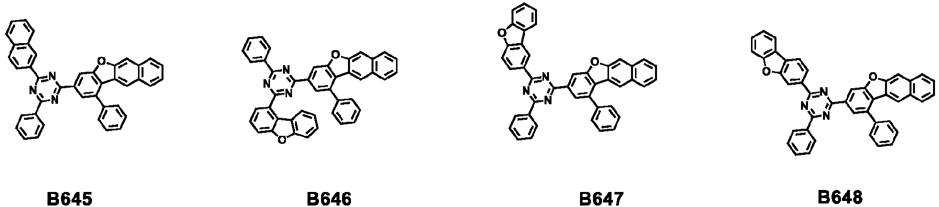

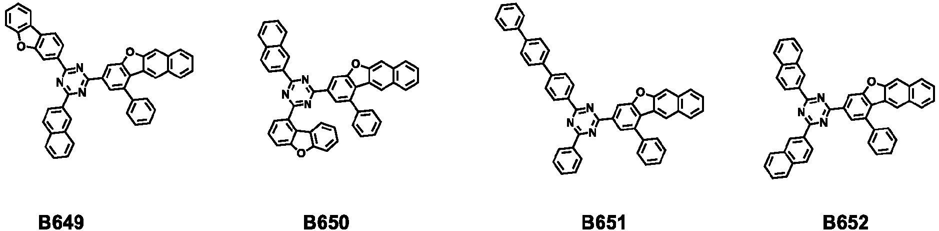

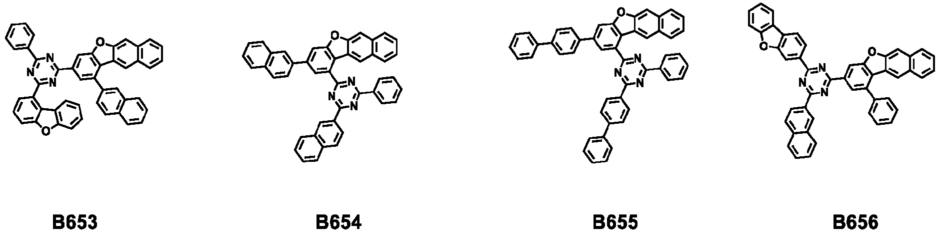

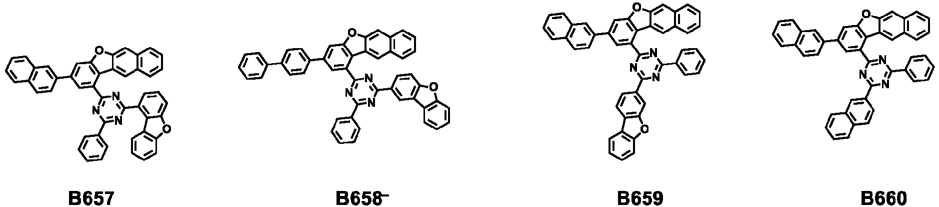

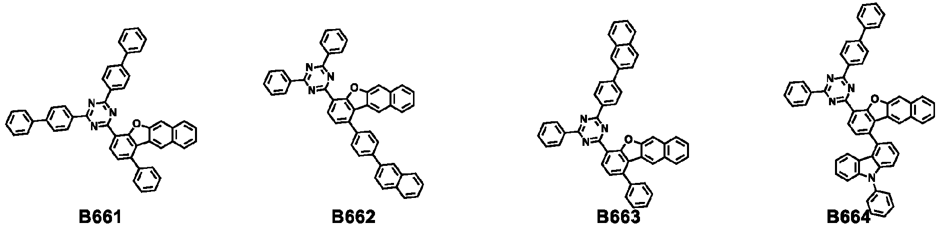

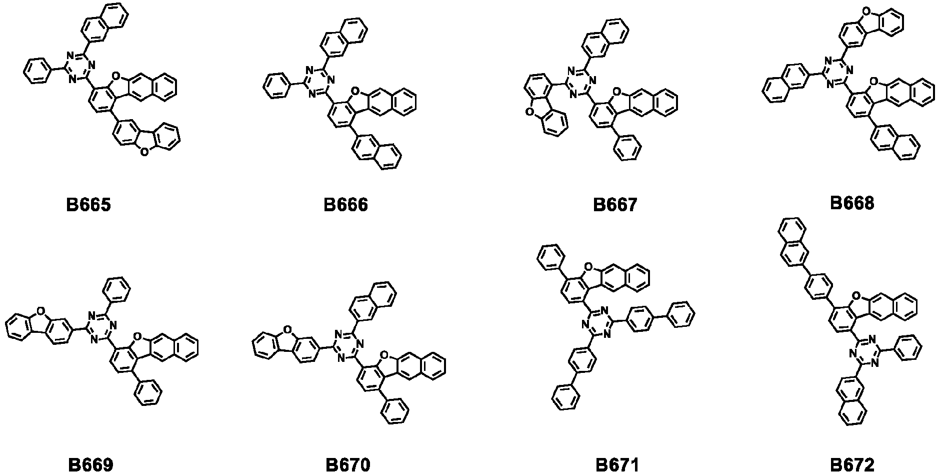

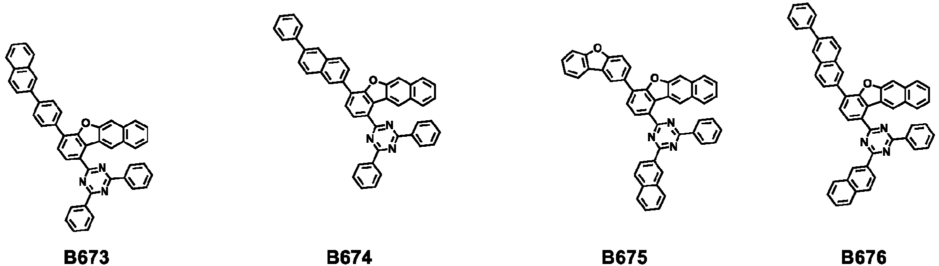

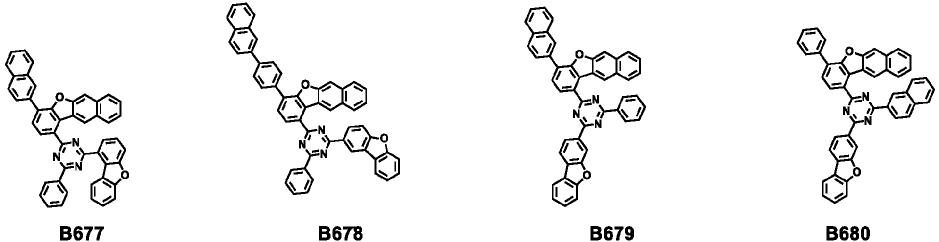

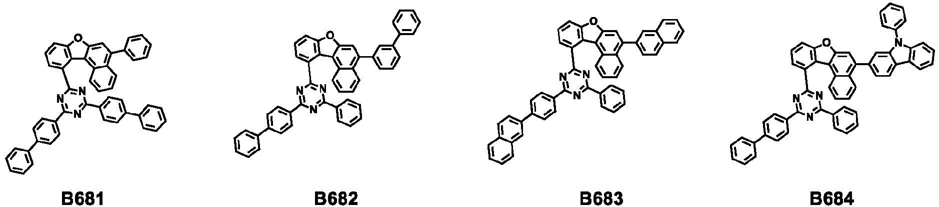

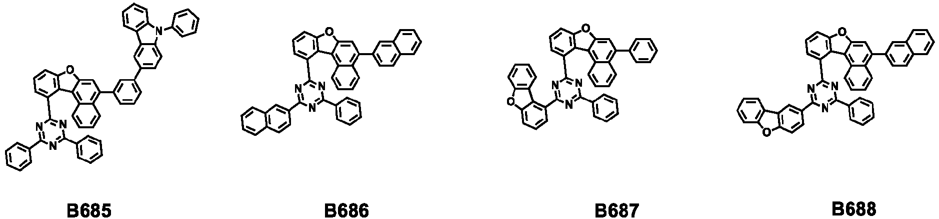

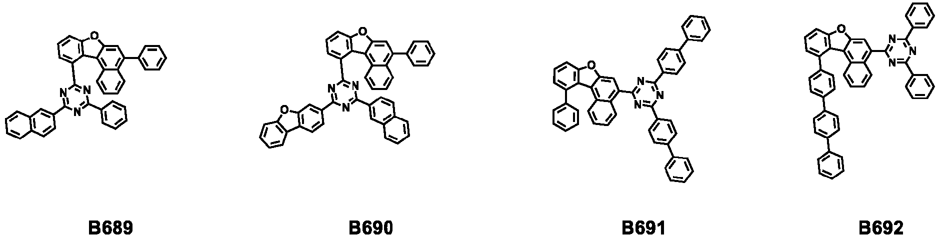

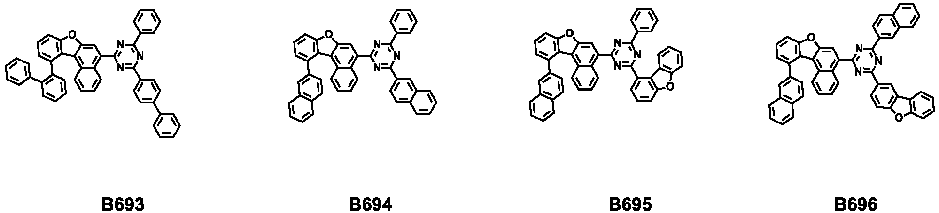

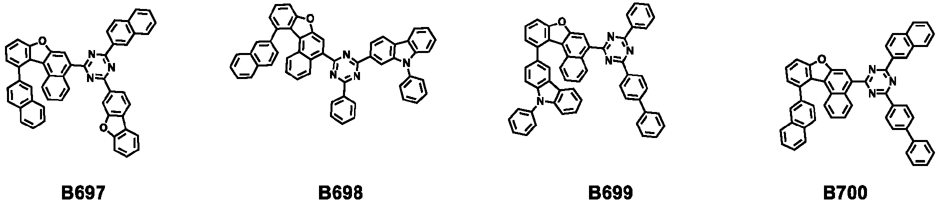

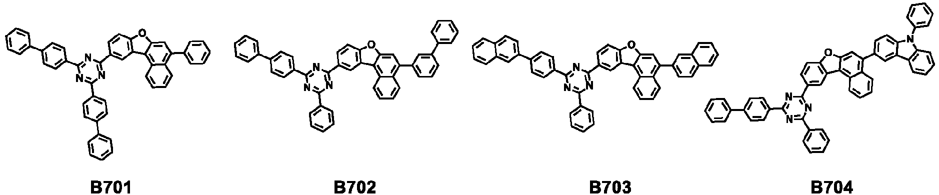

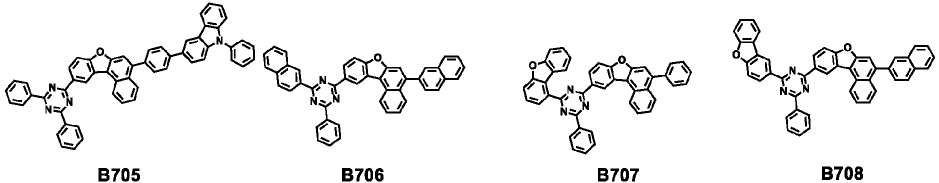

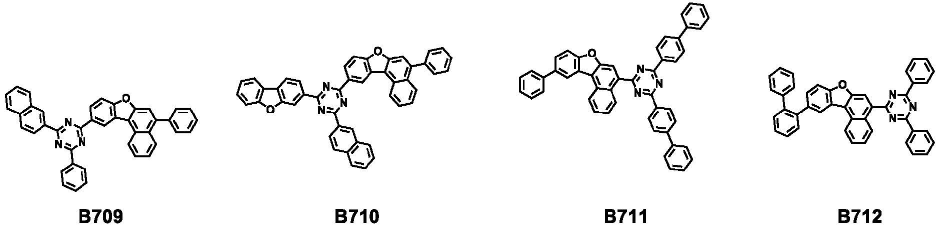

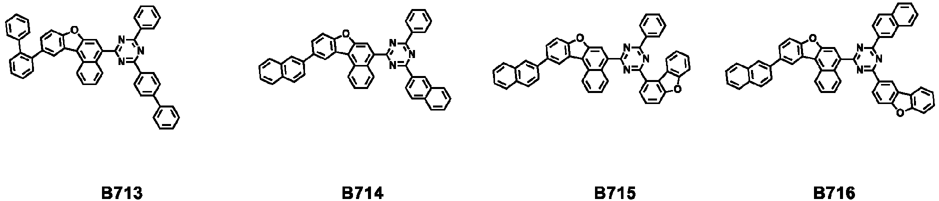

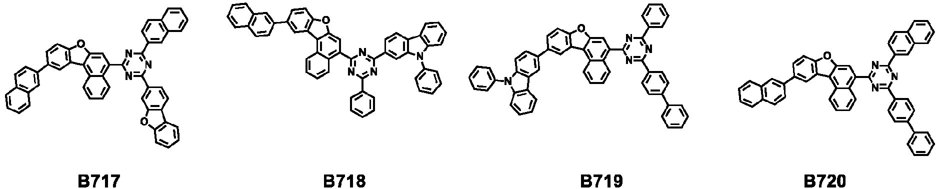

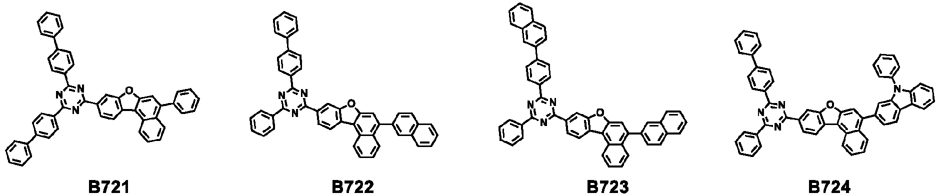

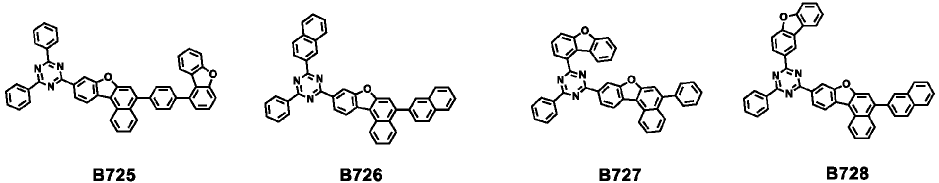

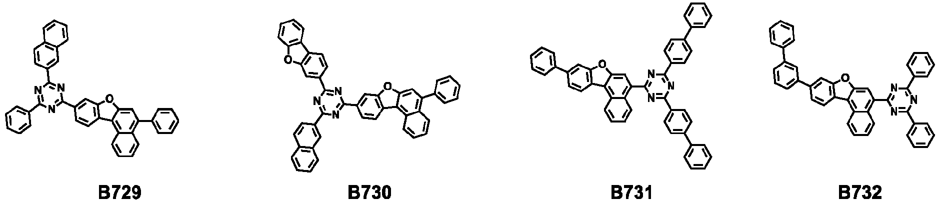

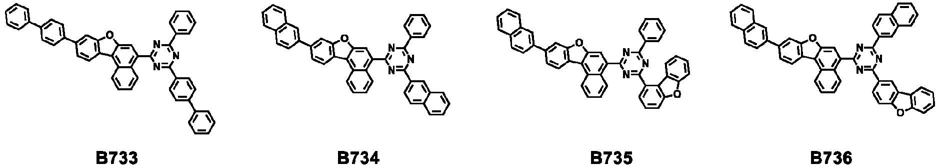

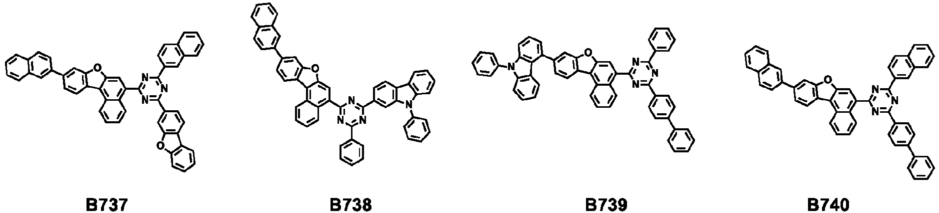

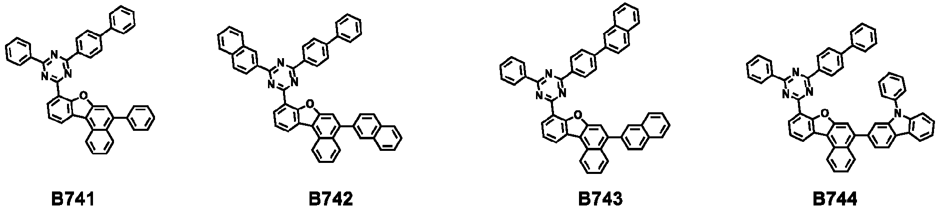

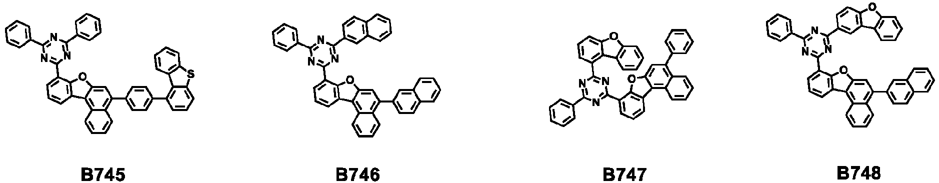

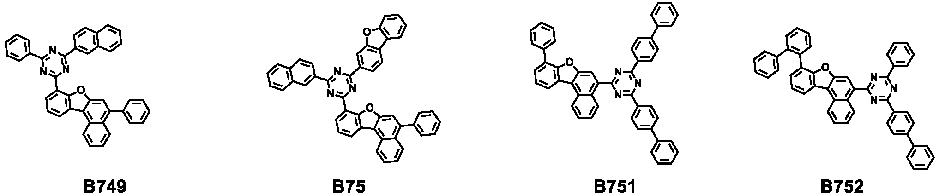

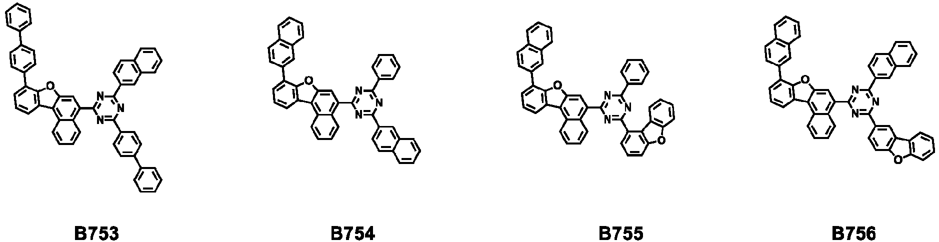

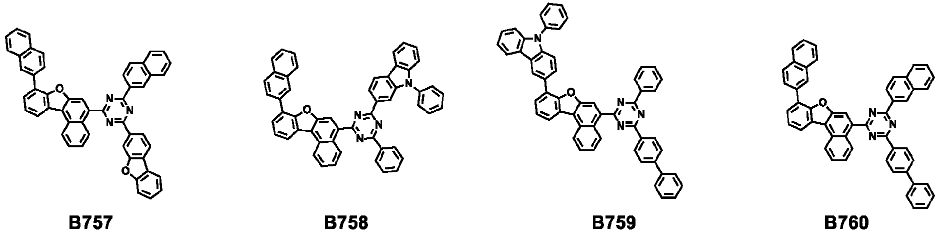

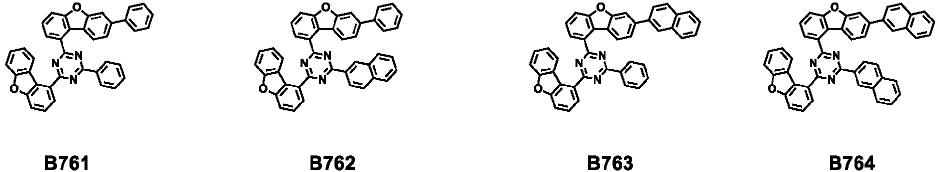

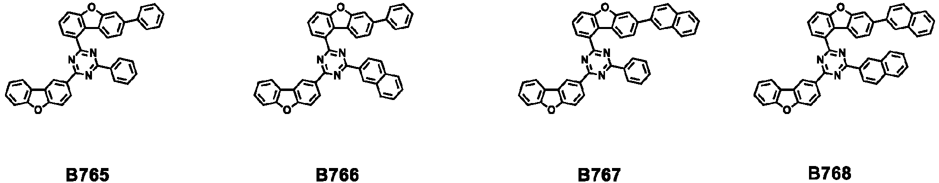

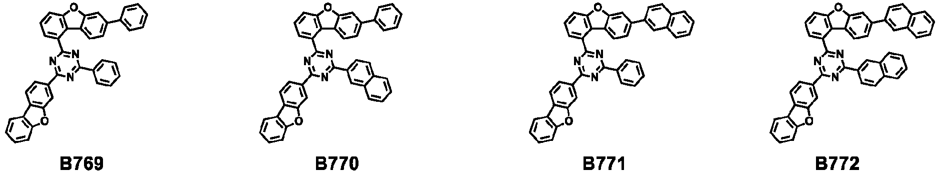

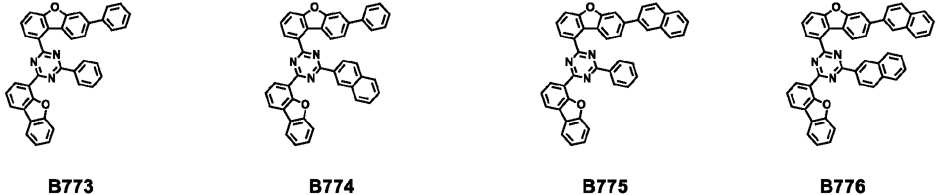

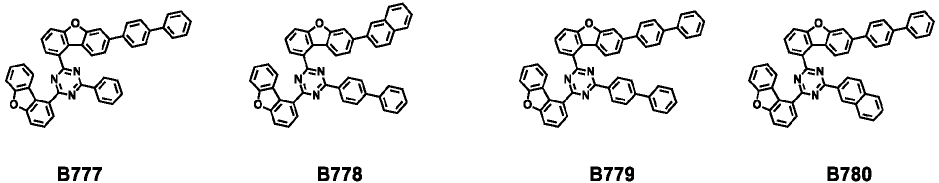

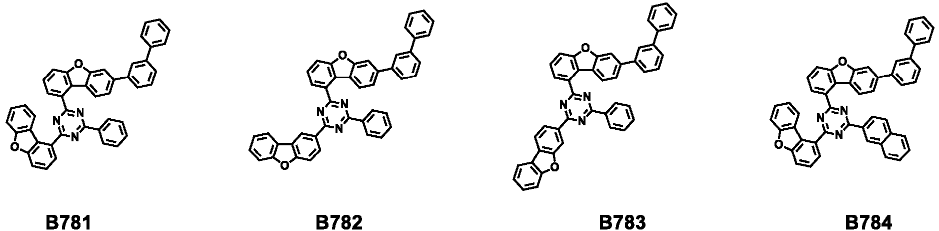

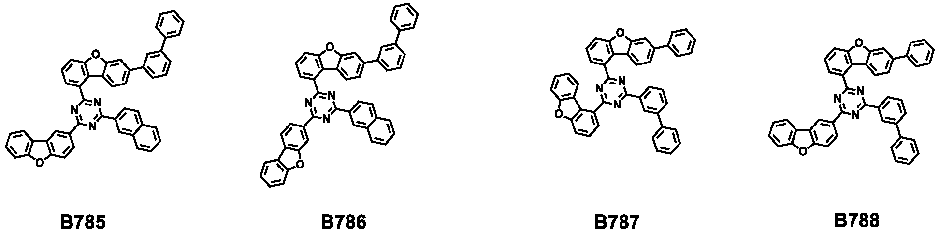

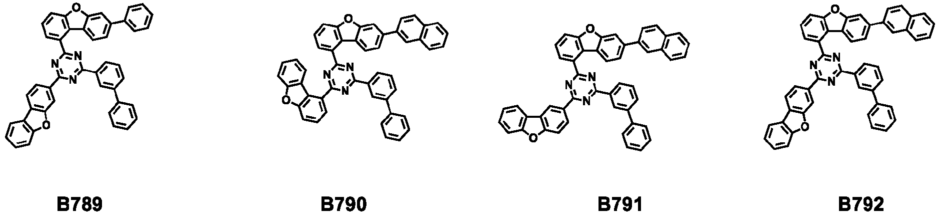

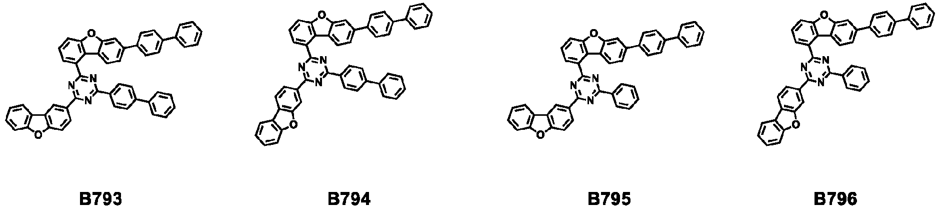

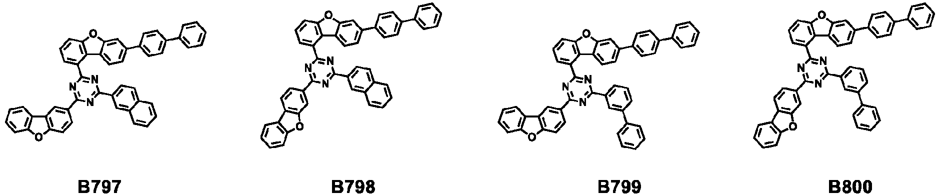

12. The composition of claim 1, wherein a molar ratio of the heterocyclic compound represented by Chemical Formula A to the heterocyclic compound represented by Chemical Formula B is 0.1 to 3 : 0.1 to 2.

13. An organic light emitting device comprising:
a first electrode;
a second electrode provided to face the first electrode; and
an organic material layer having one or more layers provided between the first electrode and the second electrode,
wherein one or more layers of the organic material layer comprise the composition according to any one of claims 1 to 12.

14. The organic light emitting device of claim 13, wherein the organic material layer further comprises a light emitting layer, and the light emitting layer comprises the composition for an organic material layer of an organic light emitting device.

15. The organic light emitting device of claim 13, wherein the organic light emitting device further comprises one or two or more layers selected from the group consisting of a light emitting layer, a hole injection layer, a hole transport layer, a hole transport auxiliary layer, an electron injection layer, an electron transport layer, an electron blocking layer, and a hole blocking layer.
